(19) Europäisches Patentamt
European Patent Office
Office européen des brevets

(11) EP 4 214 778 B1

(12) EUROPEAN PATENT SPECIFICATION

(45) Date of publication and mention of the grant of the patent:
**17.12.2025 Bulletin 2025/51**

(21) Application number: **21785786.1**

(22) Date of filing: **17.09.2021**

(51) International Patent Classification (IPC):
***H10K 50/11*** *(2023.01)*

(52) Cooperative Patent Classification (CPC):
**H10K 50/11; H10K 85/658;** H10K 2101/10; H10K 2101/20; H10K 2101/27

(86) International application number:
**PCT/EP2021/075657**

(87) International publication number:
**WO 2022/058524 (24.03.2022 Gazette 2022/12)**

(54) **ORGANIC ELECTROLUMINESCENT DEVICE EMITTING GREEN LIGHT**
ORGANISCHE ELEKTROLUMINESZENTE VORRICHTUNG
DISPOSITIF ÉLECTROLUMINESCENT ORGANIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority:
**18.09.2020 EP 20197076**
**18.09.2020 EP 20197075**
**18.09.2020 EP 20197074**
**18.09.2020 EP 20197073**
**18.09.2020 EP 20197072**
**18.09.2020 EP 20197071**
**22.09.2020 EP 20197589**
**22.09.2020 EP 20197588**
**23.12.2020 EP 20217041**
**27.04.2021 EP 21170783**
**27.04.2021 EP 21170775**
**27.04.2021 EP 21170776**
**27.04.2021 EP 21170779**
**08.07.2021 EP 21184616**
**08.07.2021 EP 21184619**
**13.07.2021 EP 21185402**
**20.07.2021 EP 21186615**

(43) Date of publication of application:
**26.07.2023 Bulletin 2023/30**

(73) Proprietor: **Samsung Display Co., Ltd.**
**Yongin-si, Gyeonggi-do 17113 (KR)**

(72) Inventors:
- **KLIMES, Kody**
  **76137 Karlsruhe (DE)**
- **FLÜGGE, Harald**
  **76135 Karlsruhe (DE)**
- **CARBALLO, Jaime, Leganés**
  **73430 Aalen (DE)**

(74) Representative: **Jacobi, Markus Alexander**
**Patentanwälte**
**Isenbruck Bösl Hörschler PartG mbB**
**Eastsite One**
**Seckenheimer Landstraße 4**
**68163 Mannheim (DE)**

(56) References cited:
**WO-A1-2019/186717 US-A1- 2020 136 059**
**US-A1- 2020 185 616**

- **JOO CHUL WOONG ET AL: "Development of solution-processable blue/hybrid-white OLEDs based on thermally activated delayed fluorescence", JOURNAL OF INDUSTRIAL AND ENGINEERING CHEMISTRY, vol. 65, 1 September 2018 (2018-09-01), KOREA, pages 35 - 39, XP055772792, ISSN: 1226-086X, DOI: 10.1016/j.jiec.2018.03.030**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

- GRAY VICTOR ET AL: "Photophysical characterization of the 9,10-disubstituted anthracene chromophore and its applications in triplet-triplet annihilation photon upconversion", JOURNAL OF MATERIALS CHEMISTRY C, vol. 3, no. 42, 21 September 2015 (2015-09-21), GB, pages 11111 - 11121, XP055875230, ISSN: 2050-7526, Retrieved from the Internet <URL:https://pubs.rsc.org/en/content/articlepdf/2015/tc/c5tc02626a> [retrieved on 20211221], DOI: 10.1039/C5TC02626A

## Description

The present invention relates to organic electroluminescent devices comprising a light-emitting layer B, which comprises a TADF material $E^B$, a small full width at half maximum (FWHM) emitter $S^B$ emitting green light with a full width at half maximum (FWHM) of less than or equal to 0.25 eV, and a host material $H^B$. Additionally, the organic electroluminescent devices according to the invention comprise an exciton management layer, which is adjacent to the light-emitting layer B, comprising a triplet-triplet-annihilation material. Furthermore, the present invention relates to a method for generating an organic electroluminescent device and to a method for generating green light by means of an organic electroluminescent device according to the present invention.

## Description

Organic electroluminescent devices containing one or more light-emitting layers based on organics such as, e.g. organic light-emitting diodes (OLEDs), light-emitting electrochemical cells (LECs) and light-emitting transistors gain increasing importance. In particular, OLEDs are promising devices for electronic products such as e.g. screens, displays and illumination devices. In contrast to most electroluminescent devices essentially based on inorganics, organic electroluminescent devices based on organics are often rather flexible and producible in particularly thin layers. The OLED-based screens and displays already available today bear either good efficiencies and long lifetimes or good color purity and long lifetimes, but do not combine all three properties, i.e. good efficiency, long lifetime, and good color purity.

The color purity or color point of an OLED is typically provided by CIEx and CIEy coordinates, whereas the color gamut for the next display generation is provided by so-called BT-2020 and DCPI3 values. Generally, in order to achieve these color coordinates, top emitting devices are needed to adjust the color coordinate by changing the cavity. In order to achieve high efficiency in top emitting devices while targeting these color gamut, a narrow emission spectrum in bottom emitting devices is needed.

State-of-the-art phosphorescence emitters exhibit a rather broad emission, which is reflected by a broad emission of phosphorescence-based OLEDs (PHOLEDs) with a full-width-half-maximum (FWHM) of the emission spectrum, which is typically larger than 0.25 eV. The broad emission spectrum of PHOLEDs in bottom devices, leads to high losses in out-coupling efficiency for top emitting device structure while targeting BT-2020 and DCPI3 color gamut.

Additionally, phosphorescence materials are typically based on transition metals, e.g. iridium, which are quite expensive materials within the OLED stack due to their typically low abundance. Thus, transition metal based materials have the most potential for cost reduction of OLEDs. Lowering of the content of transition metals within the OLED stack thus is a key performance indicator for pricing of OLED applications.

The document US 2020/185616 A1 discloses an OLED device comprising multiple complementary luminescent compounds and a host material in the emission layer.

Recently, some fluorescence or thermally-activated-delayed-fluorescence (TADF) emitters have been developed that display a rather narrow emission spectrum, which exhibits an FWHM of the emission spectrum, which is typically smaller than or equal to 0.25 eV, and therefore more suitable to achieve BT-2020 and DCPI3 color gamut. However, such fluorescence and TADF emitters typically suffer from low efficiency due to decreasing efficiencies at higher luminance (i.e. the roll-off behaviour of an OLED) as well as low lifetimes due to for example the excitonpolaron annihilation or exciton-exciton annihilation.

These disadvantages may be overcome to some extend by applying so-called hyper approaches. The latter rely on the use of an energy pump which transfers energy to a fluorescent emitter preferably displaying a narrow emission spectrum as stated above. The energy pump may for example be a TADF material displaying reversedintersystem crossing (RISC) or a transition metal complex displaying efficient intersystem crossing (ISC). However, these approaches still do not provide organic electroluminescent devices combining all of the aforementioned desirable features, namely: good efficiency, long lifetime, and good color purity.

A central element of an organic electroluminescent device for generating light typically is the at least one light-emitting layer placed between an anode and a cathode. When a voltage (and electrical current) is applied to an organic electroluminescent device, holes and electrons are injected from an anode and a cathode, respectively. Typically, a hole transport layer is located between a light-emitting layer and an anode, and an electron transport layer is typically located between a light-emitting layer and a cathode. The different layers are sequentially disposed. Excitons of high energy are then generated by recombination of the holes and the electrons in a light-emitting layer. The decay of such excited states (e.g., singlet states such as S1 and/or triplet states such as T1 to the ground state (S0) desirably leads to the emission of light.

Surprisingly, it has been found that an organic electroluminescent device comprising a light-emitting layer comprising a TADF material $E^B$, a small full width at half maximum (FWHM) emitter $S^B$ emitting green light with a full width at half maximum (FWHM) of less than or equal to 0.25 eV, and a host material $H^B$, and an exciton management layer EXL, which is adjacent to the light-emitting layer, provides an organic electroluminescent device having a long lifetime, a high

quantum yield and exhibiting narrow emission, ideally suitable to achieve the green BT-2020 and DCPI3 color gamut.

Herein, TADF material $E^B$ may transfer excitation energy to the small full width at half maximum (FWHM) emitter $S^B$ which emits light.

The present invention relates to an organic electroluminescent device comprising a light-emitting layer B comprising:

(i) a TADF material $E^B$, which has a lowermost excited singlet state energy level $E(S1^E)$ and a lowermost excited triplet state energy level $E(T1^E)$;
(ii) a small full width at half maximum (FWHM) emitter $S^B$, which has a lowermost excited singlet state energy level $E(S1^S)$ and a lowermost excited triplet state energy level $E(T1^S)$, wherein $S^B$ emits light with an emission maximum between 510 and 550 nm and with a full width at half maximum (FWHM) of less than or equal to 0.25 eV; and
(iii) a host material $H^B$, which has a lowermost excited singlet state energy level $E(S1^H)$ and a lowermost excited triplet state energy level $E(T1^H)$;

wherein the organic electroluminescent comprises an exciton management layer EXL, which is adjacent to the light-emitting layer B, comprising a triplet-triplet-annihilation (TTA) material.

Fulfilling the aforementioned requirements may result in an organic electroluminescent device having a long lifetime, a high quantum yield and exhibiting narrow emission, ideally suitable to achieve the green BT-2020 and DCPI3 color gamut.

It is to be noted that throughout this text, reference will be made to relations between energies of excited states, orbitals, emission maxima and the like of components within the light-emitting layer B of the organic electroluminescent device according to the present invention. It is understood that a relation comprising energies of two specific components will only apply to light-emitting layer B that comprise both of these specific components. Additionally, the fact that a relation applies to the devices according to the present invention does not mean that all devices of the invention have to comprise all components that are referred to in said relation. This general note is applicable to all embodiments of the present invention.

*Device architecture*

The person skilled in the art will notice that the light-emitting layer B will typically be incorporated in an organic electroluminescent device of the present invention. Preferably, such an organic electroluminescent device comprises at least the following layers: at least one light-emitting layer B, at least one anode layer A and at least one cathode layer C.

Preferably, the light-emitting layer B is located between an anode layer A and a cathode layer C. Accordingly, the general set-up is preferably A - B - C. This does of course not exclude the presence of one or more optional further layers. These can be present at each side of A, of B and/or of C.

Preferably, an anode layer A is located on the surface of a substrate. The substrate may be formed by any material or composition of materials. Most frequently, glass slides are used as substrates. Alternatively, thin metal layers (e.g., copper, gold, silver or aluminum films) or plastic films or slides may be used. This may allow a higher degree of flexibility. At least one of both electrodes should be (essentially) transparent in order to allow light emission from the electroluminescent device (e.g., OLED). Usually, an anode layer A is mostly composed of materials allowing to obtain an (essentially) transparent film. Preferably, the anode layer A comprises a large content or even consists of transparent conductive oxides (TCOs).

Such an anode layer A may exemplarily comprise indium tin oxide, aluminum zinc oxide, fluorine tin oxide, indium zinc oxide, PbO, SnO, zirconium oxide, molybdenum oxide, vanadium oxide, wolfram oxide, graphite, doped Si, doped Ge, doped GaAs, doped polyaniline, doped polypyrrol and/or doped polythiophene and mixtures of two or more thereof.

Particularly preferably, an anode layer A (essentially) consists of indium tin oxide (ITO) (e.g., $(InO_3)_{0.9}(SnO_2)_{0.1}$). The roughness of an anode layer A caused by the transparent conductive oxides (TCOs) may be compensated by using a hole injection layer (HIL). Further, a HIL may facilitate the injection of quasi charge carriers (i.e., holes) in that the transport of the quasi charge carriers from the TCO to a hole transport layer (HTL) is facilitated. A hole injection layer (HIL) may comprise poly-3,4-ethylendioxy thiophene (PEDOT), polystyrene sulfonate (PSS), $MoO_2$, $V_2O_5$, CuPC or CuI, in particular a mixture of PEDOT and PSS. A hole injection layer (HIL) may also prevent the diffusion of metals from an anode layer A into a hole transport layer (HTL). A HIL may exemplarily comprise PEDOT:PSS (poly-3,4-ethylendioxy thiophene: polystyrene sulfonate), PEDOT (poly-3,4-ethylendioxy thiophene), mMTDATA (4,4',4"-tris[phenyl(m-tolyl)amino]triphenylamine), Spiro-TAD (2,2',7,7'-tetrakis(n,n-diphenylamino)-9,9'-spirobifluorene), DNTPD (N1,N1'-(biphenyl-4,4'-diyl) bis(N1-phenyl-N4,N4-di-m-tolylbenzene-1,4-diamine), NPB (N,N'-nis-(1-naphthalenyl)-N,N'-bis-phenyl-(1,1'-biphenyl)-4,4'-diamine), NPNPB (N,N'-diphenyl-N,N'-di-[4-(N,N-diphenyl-amino)phenyl]benzidine), MeO-TPD (N,N,N',N'-tetrakis(4-methoxyphenyl)-benzidine), HAT-CN (1,4,5,8,9,11-hexaazatriphenylen-hexacarbonitrile) and/or Spiro-NPD (N,N'-diphenyl-N,N'-bis-(1-naphthyl)-9,9'-spirobifluorene-2,7-diamine).

Adjacent to an anode layer A or a hole injection layer (HIL), typically a hole transport layer (HTL) is located. Herein, any hole transport compound may be used. Exemplarily, electron-rich heteroaromatic compounds such as triarylamines and/or carbazoles may be used as hole transport compound. A HTL may decrease the energy barrier between an anode layer A and a light-emitting layer B (serving as emitting layer (EML)). A hole transport layer (HTL) may also be an electron blocking layer (EBL). Preferably, hole transport compounds bear comparably high energy levels of their triplet states T1. Exemplarily a hole transport layer (HTL) may comprise a star-shaped heterocycle such as tris(4-carbazoyl-9-ylphenyl)amine (TCTA), poly-TPD (poly(4-butylphenyl-diphenyl-amine)), [alpha]-NPD (poly(4-butylphenyl-diphenyl-amine)), TAPC (4,4'-cyclohexyliden-bis[N,N-bis(4-methylphenyl)benzenamine]), 2-TNATA (4,4',4"-tris[2-naphthyl(phenyl)-amino]triphenylamine), Spiro-TAD, DNTPD, NPB, NPNPB, MeO-TPD, HAT-CN and/or TrisPcz (9,9'-diphenyl-6-(9-phenyl-9H-carbazol-3-yl)-9H,9'H-3,3'-bicarbazole). In addition, a HTL may comprise a p-doped layer, which may be composed of an inorganic or organic dopant in an organic hole-transporting matrix. Transition metal oxides such as vanadium oxide, molybdenum oxide or tungsten oxide may exemplarily be used as inorganic dopant. Tetrafluorotetracyanoquinodimethane (F4-TCNQ), copper-pentafluorobenzoate (Cu(I)pFBz) or transition metal complexes may exemplarily be used as organic dopant.

An electron blocking layer (EBL) may exemplarily comprise mCP (1,3-bis(carbazol-9-yl)benzene), TCTA, 2-TNATA, mCBP (3,3-di(9H-carbazol-9-yl)biphenyl), 9-[3-(dibenzofuran-2-yl)phenyl]-9*H*-carbazole, 9-[3-(dibenzofuran-2-yl)phenyl]-9*H*-carbazole, 9-[3-(dibenzothiophen-2-yl)phenyl]-9*H*-carbazole, 9-[3,5-bis(2-dibenzofuranyl)phenyl]-9*H*-carbazole, 9-[3,5-bis(2-dibenzothiophenyl)phenyl]-9*H*-carbazole, tris-Pcz, CzSi (9-(4-tert-butylphenyl)-3,6-bis(triphenylsilyl)-9H-carbazole), and/or DCB (N,N'-dicarbazolyl-1,4-dimethylbenzene).

The composition of the one or more light-emitting layers B has been described above. Any of the one or more light-emitting layers B according to the invention preferably bears a thickness of not more than 1 mm, more preferably of not more than 0.1 mm, even more preferably of not more than 10 μm, even more preferably of not more than 1 μm, and particularly preferably of not more than 0.1 μm.

In an electron transport layer (ETL), any electron transporter may be used. Exemplarily, compounds poor of electrons such as, e.g., benzimidazoles, pyridines, triazoles, oxadiazoles (e.g., 1,3,4-oxadiazole), phosphinoxides and sulfone, may be used. Exemplarily, an electron transporter ETM (i.e. an electron transport material) may also be a star-shaped heterocycle such as 1,3,5-tri(1-phenyl-1H-benzo[d]imidazol-2-yl)phenyl (TPBi). An ETM may exemplarily be NBphen (2,9-bis(naphthalen-2-yl)-4,7-diphenyl-1,10-phenanthroline), Alq3 (Aluminum-tris(8-hydroxyquinoline)), TSPO1 (diphenyl-4-triphenylsilylphenyl-phosphinoxide), BPyTP2 (2,7-di(2,2'-bipyridin-5-yl)triphenyle), Sif87 (dibenzo [b,d]thiophen-2-yltriphenylsilane), Sif88 (dibenzo[b,d]thiophen-2-yl)diphenylsilane), BmPyPhB (1,3-bis[3,5-di(pyridin-3-yl)phenyl]benzene) and/or BTB (4,4'-bis-[2-(4,6-diphenyl-1,3,5-triazinyl)]-1,1'-biphenyl). Optionally, the electron transport layer may be doped with materials such as Liq (8-hydroxyquinolinolatolithium). Optionally, a second electron transport layer may be located between electron transport layer and cathode layer C. An electron transport layer (ETL) may also block holes or a hole-blocking layer (HBL) is introduced.

An HBL may, for example, comprise HBM1:

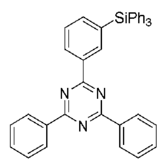,

BCP (2,9-dimethyl-4,7-diphenyl-1,10-phenanthroline = Bathocuproine), BAlq (bis(8-hydroxy-2-methylquinoline)-(4-phenylphenoxy)aluminum), NBphen (2,9-bis(naphthalen-2-yl)-4,7-diphenyl-1,10-phenanthroline), Alq3 (Aluminum-tris(8-hydroxyquinoline)), TSPO1 (diphenyl-4-triphenylsilylphenyl-phosphinoxide), T2T (2,4,6-tris(biphenyl-3-yl)-1,3,5-triazine), T3T (2,4,6-tris(triphenyl-3-yl)-1,3,5-triazine), TST (2,4,6-tris(9,9'-spirobifluorene-2-yl)-1,3,5-triazine), DTST (2,4-diphenyl-6-(3'-triphenylsilylphenyl)-1,3,5-triazine), DTDBF (2,8-bis(4,6-diphenyl-1,3,5-triazinyl)dibenzofurane) and/or TCB/TCP (1,3,5-tris(N-carbazolyl)benzol/ 1,3,5-tris(carbazol)-9-yl) benzene).

Adjacent to an electron transport layer (ETL), a cathode layer C may be located. Exemplarily, a cathode layer C may comprise or may consist of a metal (e.g., Al, Au, Ag, Pt, Cu, Zn, Ni, Fe, Pb, LiF, Ca, Ba, Mg, In, W, or Pd) or a metal alloy. For practical reasons, a cathode layer C may also consist of (essentially) intransparent (non-transparent) metals such as Mg, Ca or Al. Alternatively or additionally, a cathode layer C may also comprise graphite and or carbon nanotubes (CNTs). Alternatively, a cathode layer C may also consist of nanoscale silver wires.

In a preferred embodiment, the organic electroluminescent device comprises at least the following layers:

A) an anode layer A containing at least one component selected from the group consisting of indium tin oxide, indium zinc oxide, PbO, SnO, graphite, doped silicium, doped germanium, doped GaAs, doped polyaniline, doped polypyrrole, doped polythiophene, and mixtures of two or more thereof;

EXL) an exciton management layer EXL according to the present invention as described herein;
B) a light-emitting layer B according to present invention as described herein; and
C) a cathode layer C containing at least one component selected from the group consisting of Al, Au, Ag, Pt, Cu, Zn, Ni, Fe, Pb, In, W, Pd, LiF, Ca, Ba, Mg, and mixtures or alloys of two or more thereof,
wherein the light-emitting layer B is located between the anode layer A and the a cathode layer C.

In a preferred embodiment, the organic electroluminescent device comprises at least the following layers:

A) an anode layer A containing at least one component selected from the group consisting of indium tin oxide, indium zinc oxide, PbO, SnO, graphite, doped silicium, doped germanium, doped GaAs, doped polyaniline, doped polypyrrole, doped polythiophene, and mixtures of two or more thereof;
B) a light-emitting layer B according to present invention as described herein;
EXL) an exciton management layer EXL according to the present invention as described herein; and
C) a cathode layer C containing at least one component selected from the group consisting of Al, Au, Ag, Pt, Cu, Zn, Ni, Fe, Pb, In, W, Pd, LiF, Ca, Ba, Mg, and mixtures or alloys of two or more thereof,
wherein the light-emitting layer B is located between the anode layer A and the a cathode layer C.

In a preferred embodiment, the organic electroluminescent device is an OLED, which comprises the following layer structure:

A) an anode layer A, exemplarily comprising indium tin oxide (ITO);
HTL) a hole transport layer HTL;
EXL) an exciton management layer EXL according to the present invention as described herein;
B) a light-emitting layer B according to present invention as described herein;
ETL) an electron transport layer ETL; and
C) a cathode layer, exemplarily comprising Al, Ca and/or Mg.

Preferably, the order of the layers herein is A - HTL - EXL - B - ETL - C.
In one embodiment, the organic electroluminescent device is an OLED, which comprises the following layer structure:

A) an anode layer A, exemplarily comprising indium tin oxide (ITO);
HTL) a hole transport layer HTL;
B) a light-emitting layer B according to present invention as described herein;
EXL) an exciton management layer EXL according to the present invention as described herein;
ETL) an electron transport layer ETL; and
C) a cathode layer, exemplarily comprising Al, Ca and/or Mg.

Preferably, the order of the layers herein is A - HTL -B - EXL - ETL - C.
In one embodiment, the exciton management layer EXL has a thickness, which is less than 15 nm.
In a preferred embodiment, the exciton management layer EXL has a thickness, which is less than 10 nm.
In a preferred embodiment, the exciton management layer EXL has a thickness, which is equal to or less than 5 nm.
In a preferred embodiment, the exciton management layer EXL has a thickness, which is less than 5 nm.
As known to the person skilled in the art, triplet-triplet annihilation (TTA) materials can be used as host materials $H^B$. The TTA material enables triplet-triplet annihilation. Triplet-triplet annihilation may preferably result in a photon up-conversion. Accordingly, two, three or even more photons may facilitate photon up-conversion from the lowermost excited triplet state ($T1^{TTA}$) to the first excited singlet state $S1^{TTA}$ of the TTA material $H^{TTA}$. In a preferred embodiment, two photons facilitate photon up-conversion from $T1^{TTA}$ to $S1^{TTA}$. Triplet-triplet annihilation may thus be a process that through a number of energy transfer steps, may combine two (or optionally more than two) low frequency photons into one photon of higher frequency.
Optionally, the TTA material may comprise an absorbing moiety, a sensitizer moiety, and an emitting moiety (or annihilator moiety). In this context, an emitting moiety may, for example, be a polycyclic aromatic moiety such as, benzene, biphenyl, triphenyl, triphenylene, naphthalene, anthracene, phenalene, phenanthrene, fluorene, pyrene, chrysene, perylene, azulene. In a preferred embodiment, the polycyclic aromatic moiety comprises an anthracene moiety or a derivative thereof. A sensitizer moiety and an emitting moiety may be located in two different chemical compounds (i.e., separated chemical entities) or may be both moieties embraced by one chemical compound.
According to the present invention, a TTA material is characterized in that it exhibits triplet-triplet annihilation from

the lowermost excited triplet state ($T1^N$) resulting in a triplet-triplet annihilated first excited singlet state $S1^N$, having an energy of up to two times the energy of $T1^N$.

According to the invention, a triplet-triplet annihilation (TTA) material converts energy from its first excited triplet state $T1^N$ to its first excited singlet state $S1^N$ by triplet-triplet annihilation.

In one embodiment of the present invention, a TTA material is characterized in that it exhibits triplet-triplet annihilation from $T1^N$ resulting in $S1^N$, wherein $S1^N$ has an energy of 1.01 to 2fold, 1.1 to 1.9fold, 1.2 to 1.5fold, 1.4 to 1.6fold, or 1.5 to 2fold times the energy of $T1^N$.

As used herein, the terms "TTA material" and "TTA compound" may be understood interchangeably.

Typical "TTA material" can be found in the state of the art related to blue fluorescent OLEDs, as described by Kondakov (Philosophical Transactions of the Royal Society A: Mathematical, Physical and Engineering Sciences, 2015, 373:20140321). Such blue fluorescent OLEDs employ aromatic hydrocarbons such as anthracene derivatives as the main component (host) in the EML.

In a preferred embodiment, the TTA material enables sensitized triplet-triplet annihilation. Optionally, the TTA material may comprise one or more polycyclic aromatic structures. In a preferred embodiment, the TTA material comprises at least one polycyclic aromatic structure and at least one further aromatic residue.

In a preferred embodiment of the invention, the TTA material $H^{TTA}$ is an anthracene derivative.

In one embodiment, the TTA material $H^{TTA}$ is an anthracene derivate of the following formula TTA

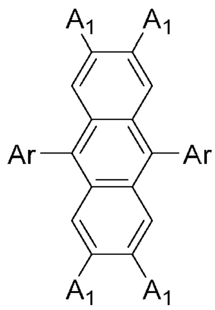
Formula TTA,

wherein

each Ar is independently from each other selected from the group consisting of $C_6$-$C_{60}$-aryl, which is optionally substituted with one or more residues selected from the group consisting of $C_6$-$C_{60}$-aryl, $C_3$-$C_{57}$-heteroaryl, halogen, and $C_1$-$C_{40}$-(hetero)alkyl;
and $C_3$-$C_{57}$-heteroaryl, which is optionally substituted with one or more residues selected from the group consisting of $C_6$-$C_{60}$-aryl, $C_3$-$C_{57}$-heteroaryl, halogen, and $C_1$-$C_{40}$-(hetero)alkyl; and
each $A_1$ is independently from each other selected from the group consisting of consisting of
hydrogen;
deuterium;
$C_6$-$C_{60}$-aryl, which is optionally substituted with one or more residues selected from the group consisting of $C_6$-$C_{60}$-aryl, $C_3$-$C_{57}$-heteroaryl, halogen, and $C_1$-$C_{40}$-(hetero)alkyl; $C_3$-$C_{57}$-heteroaryl, which is optionally substituted with one or more residues selected from the group consisting of $C_6$-$C_{60}$-aryl, $C_3$-$C_{57}$-heteroaryl, halogen, and $C_1$-$C_{40}$-(hetero)alkyl; and
$C_1$-$C_{40}$-(hetero)alkyl, which is optionally substituted with one or more residues selected from the group consisting of $C_6$-$C_{60}$-aryl, $C_3$-$C_{57}$-heteroaryl, halogen, and $C_1$-$C_{40}$-(hetero)alkyl.

In one embodiment, the TTA material $H^{TTA}$ is an anthracene derivate of the following formula TTA, wherein

each Ar is independently from each other selected from the group consisting of $C_6$-$C_{20}$-aryl, which is optionally substituted with one or more residues selected from the group consisting of $C_6$-$C_{20}$-aryl, $C_3$-$C_{20}$-heteroaryl, halogen, and $C_1$-$C_{210}$-(hetero)alkyl;
and $C_3$-$C_{20}$-heteroaryl, which is optionally substituted with one or more residues selected from the group consisting of $C_6$-$C_{20}$-aryl, $C_3$-$C_{20}$-heteroaryl, halogen, and $C_1$-$C_{10}$-(hetero)alkyl; and
each $A_1$ is independently from each other selected from the group consisting of consisting of
hydrogen,
deuterium,
$C_6$-$C_{20}$-aryl, which is optionally substituted with one or more residues selected from the group consisting of $C_6$-$C_{20}$-aryl, $C_3$-$C_{20}$-heteroaryl, halogen, and $C_1$-$C_{10}$-(hetero)alkyl,

$C_3$-$C_{20}$-heteroaryl, which is optionally substituted with one or more residues selected from the group consisting of $C_6$-$C_{20}$-aryl, $C_3$-$C_{20}$-heteroaryl, halogen, and $C_1$-$C_{10}$-(hetero)alkyl; and

$C_1$-$C_{10}$-(hetero)alkyl, which is optionally substituted with one or more residues selected from the group consisting of $C_6$-$C_{60}$-aryl, $C_3$-$C_{57}$-heteroaryl, halogen, and $C_1$-$C_{40}$-(hetero)alkyl.

In one embodiment, $H^{TTA}$ is an anthracene derivate of the following formula TTA, wherein at least one of $A_1$ is hydrogen. In one embodiment, $H^{TTA}$ is an anthracene derivate of the following formula TTA, wherein at least two of $A_1$ are hydrogen. In one embodiment, $H^{TTA}$ is an anthracene derivate of the following formula TTA, wherein at least three of $A_1$ are hydrogen. In one embodiment, $H^{TTA}$ is an anthracene derivate of the following formula TTA, wherein all of $A_1$ are each hydrogen.

In one embodiment, $H^{TTA}$ is an anthracene derivate of the following formula TTA, wherein one of Ar is a residue selected from the group consisting of phenyl, naphthyl, phenanthryl, pyrenyl, triphenylenyl, dibenzoanthracenyl, fluorenyl, benzofluorenyl, anthracenyl, phenanthrenyl, benzonaphtofuranyl, benzonaphtothiopehnyl, dibenzofuranyl, dibenzothiopehnyl,

which may be each optionally substituted with one or more residues selected from the group consisting of $C_6$-$C_{60}$-aryl, $C_3$-$C_{57}$-heteroaryl, halogen, and $C_1$-$C_{40}$-(hetero)alkyl.

In one embodiment, $H^{TTA}$ is an anthracene derivate of the following formula TTA, wherein both Ar are residues each independently from each other selected from the group consisting of phenyl, naphthyl, phenanthryl, pyrenyl, triphenylenyl, dibenzoanthracenyl, fluorenyl, benzofluorenyl, anthracenyl, phenanthrenyl, benzonaphtofuranyl, benzonaphtothiopehnyl, dibenzofuranyl, dibenzothiopehnyl, which may be each optionally substituted with one or more residues selected from the group consisting of $C_6$-$C_{60}$-aryl, $C_3$-$C_{57}$-heteroaryl, halogen, and $C_1$-$C_{40}$-(hetero)alkyl.

In one embodiment, the TTA material $H^{TTA}$ is an anthracene derivate selected from the following:

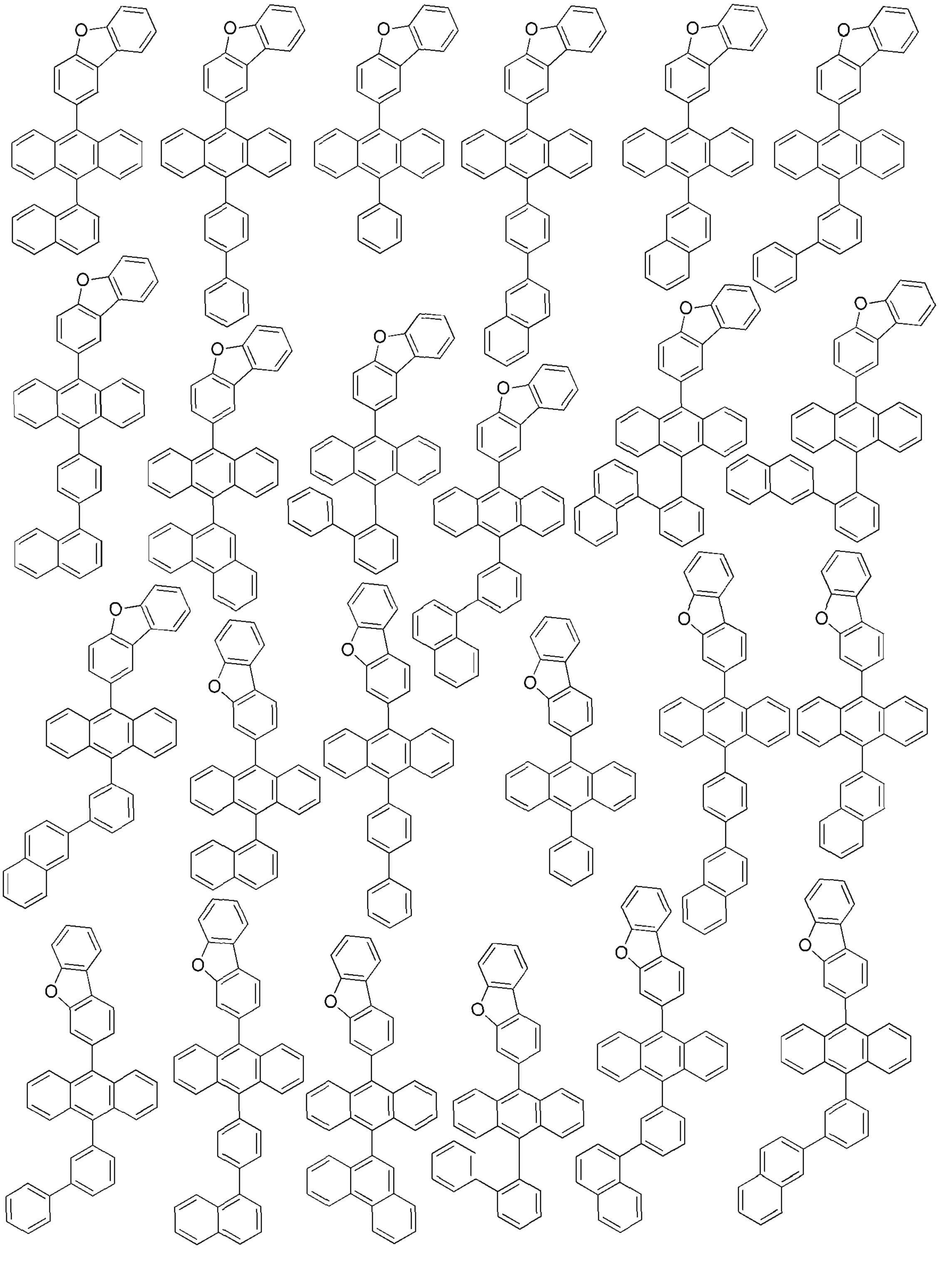

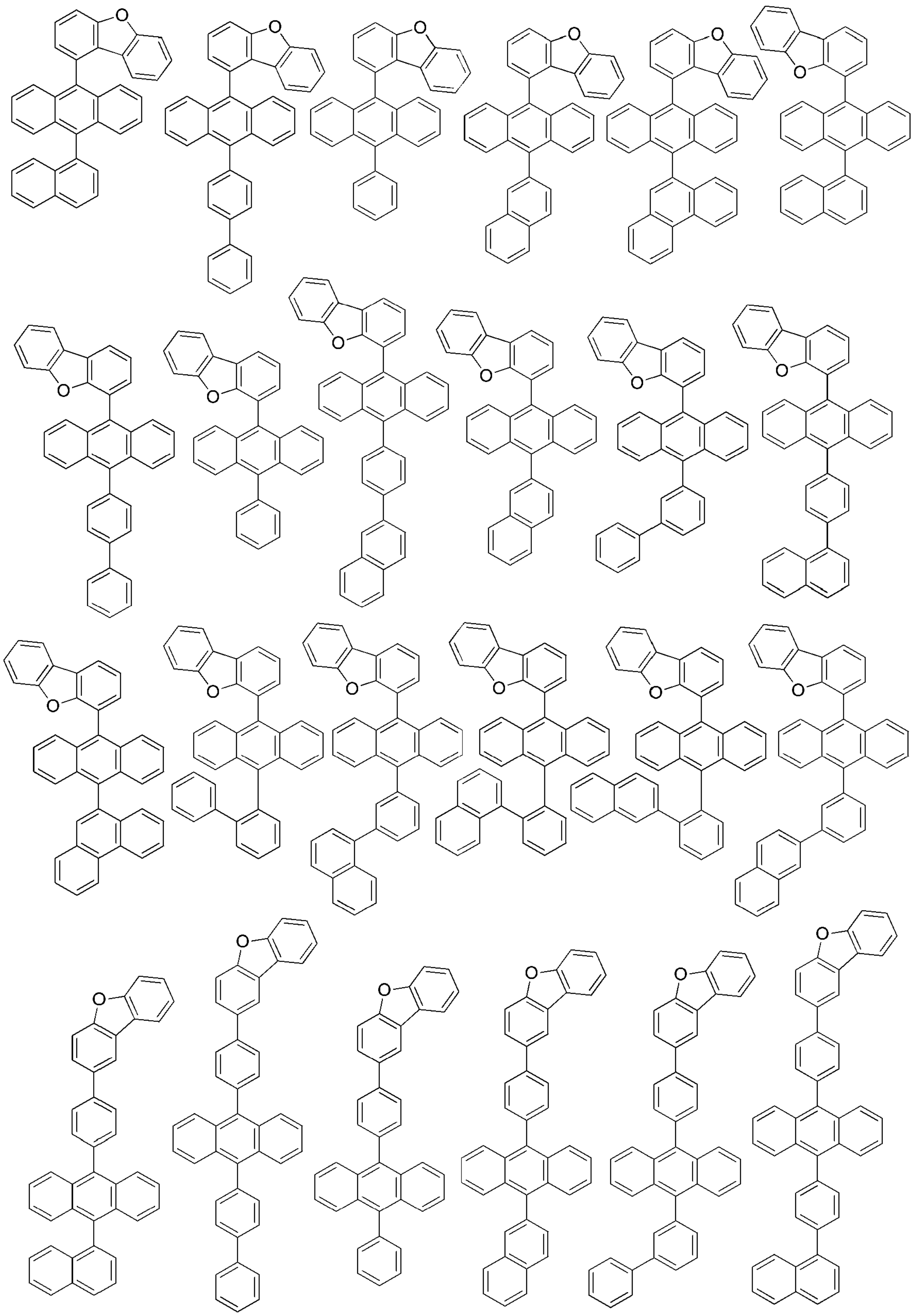

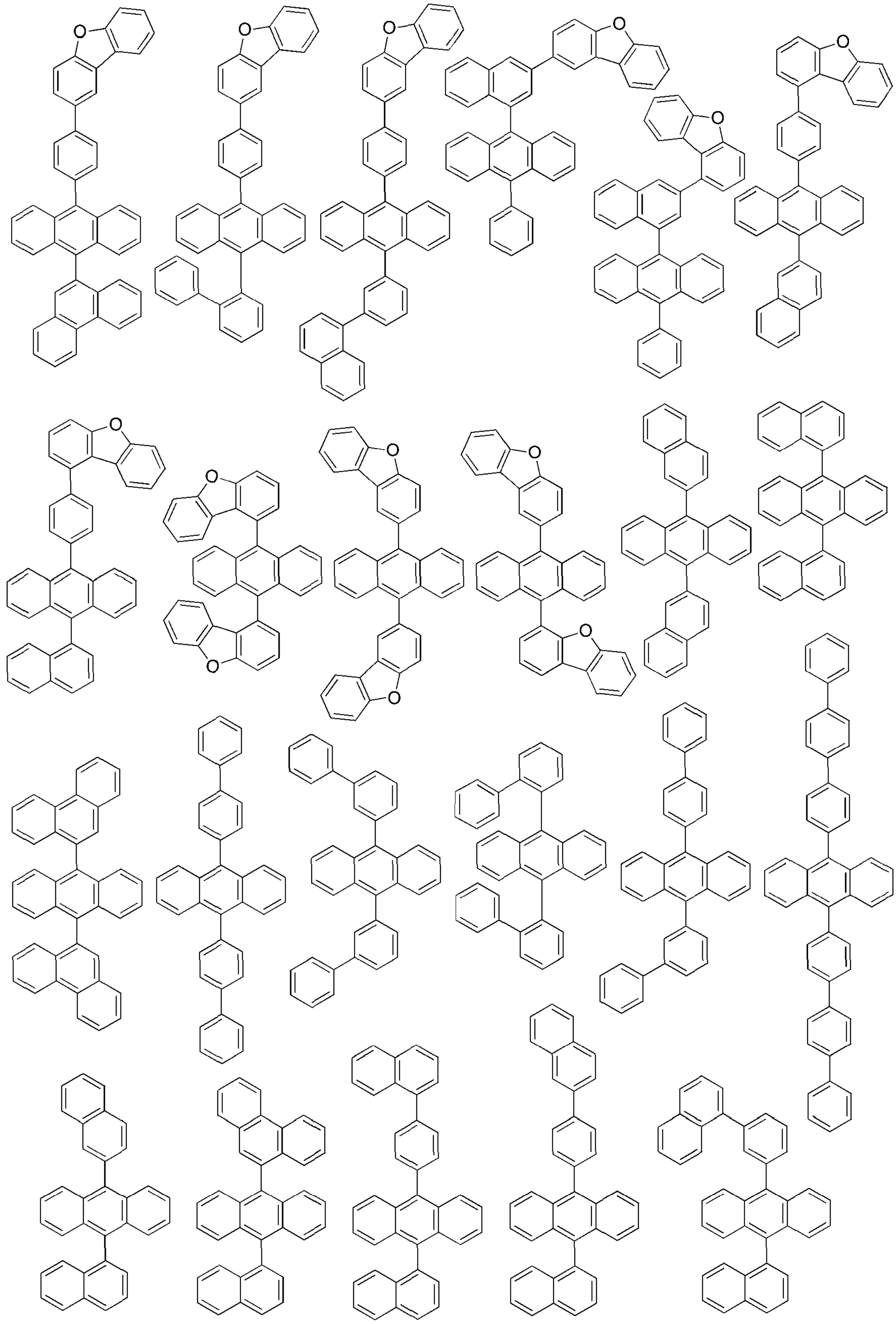

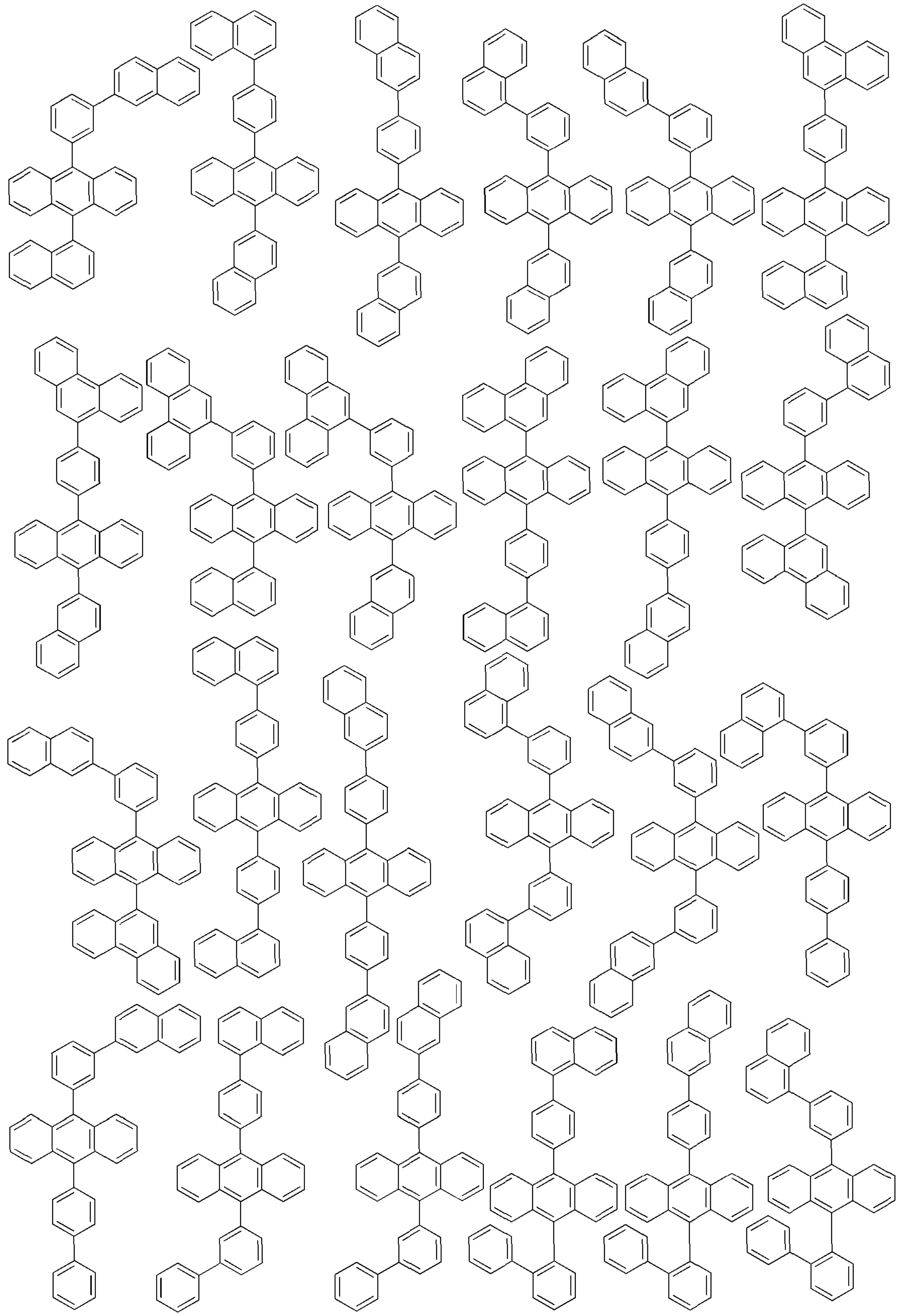

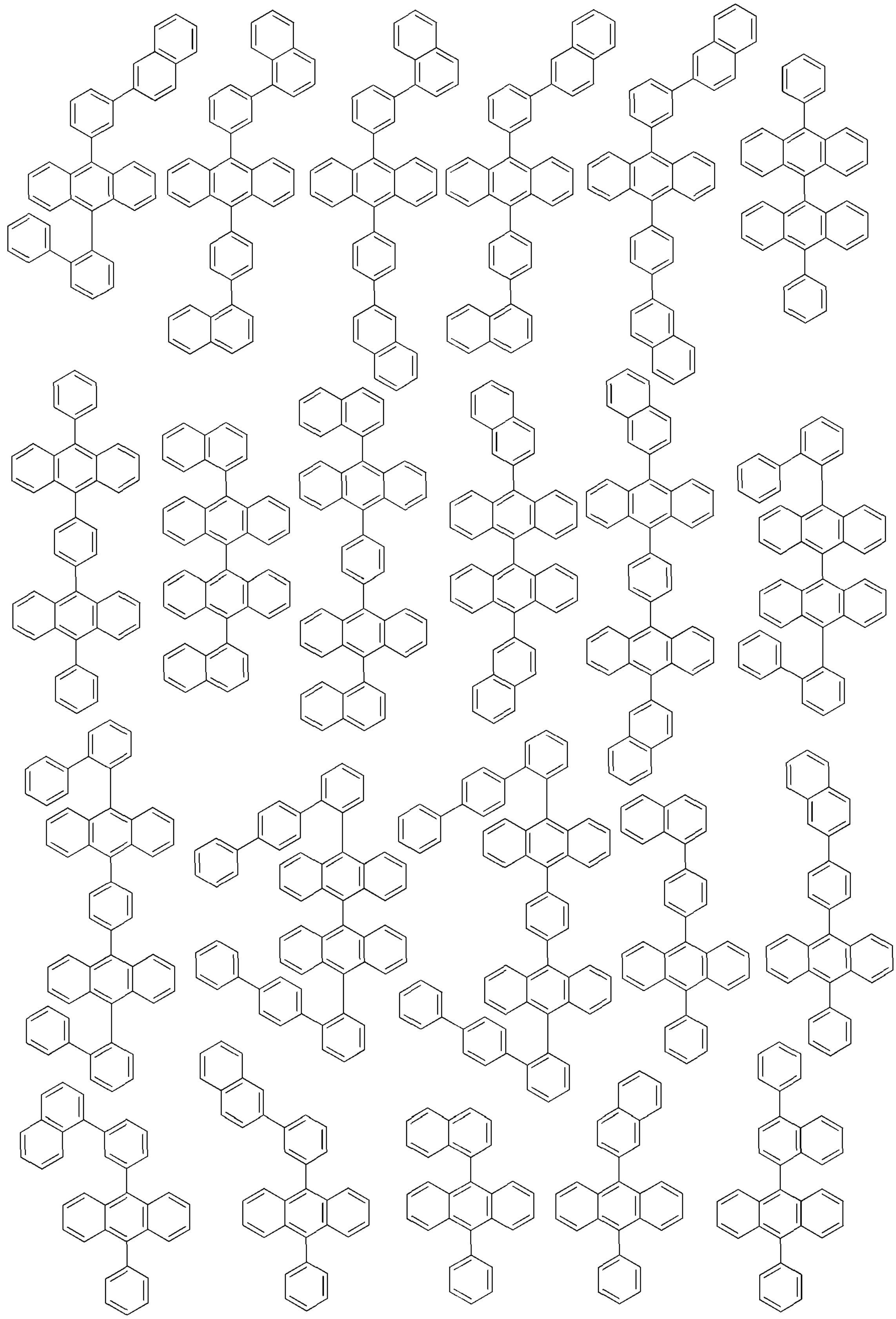

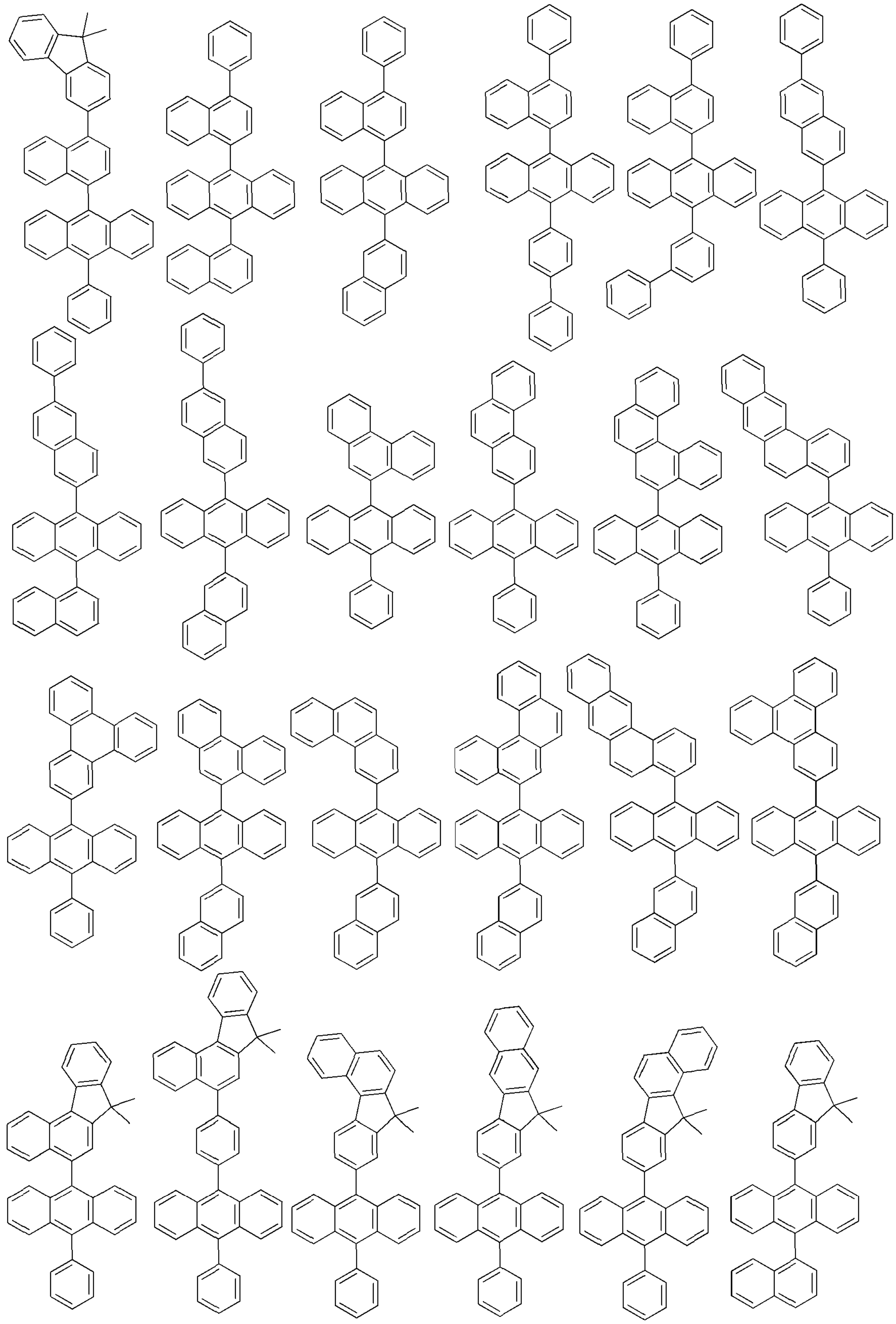

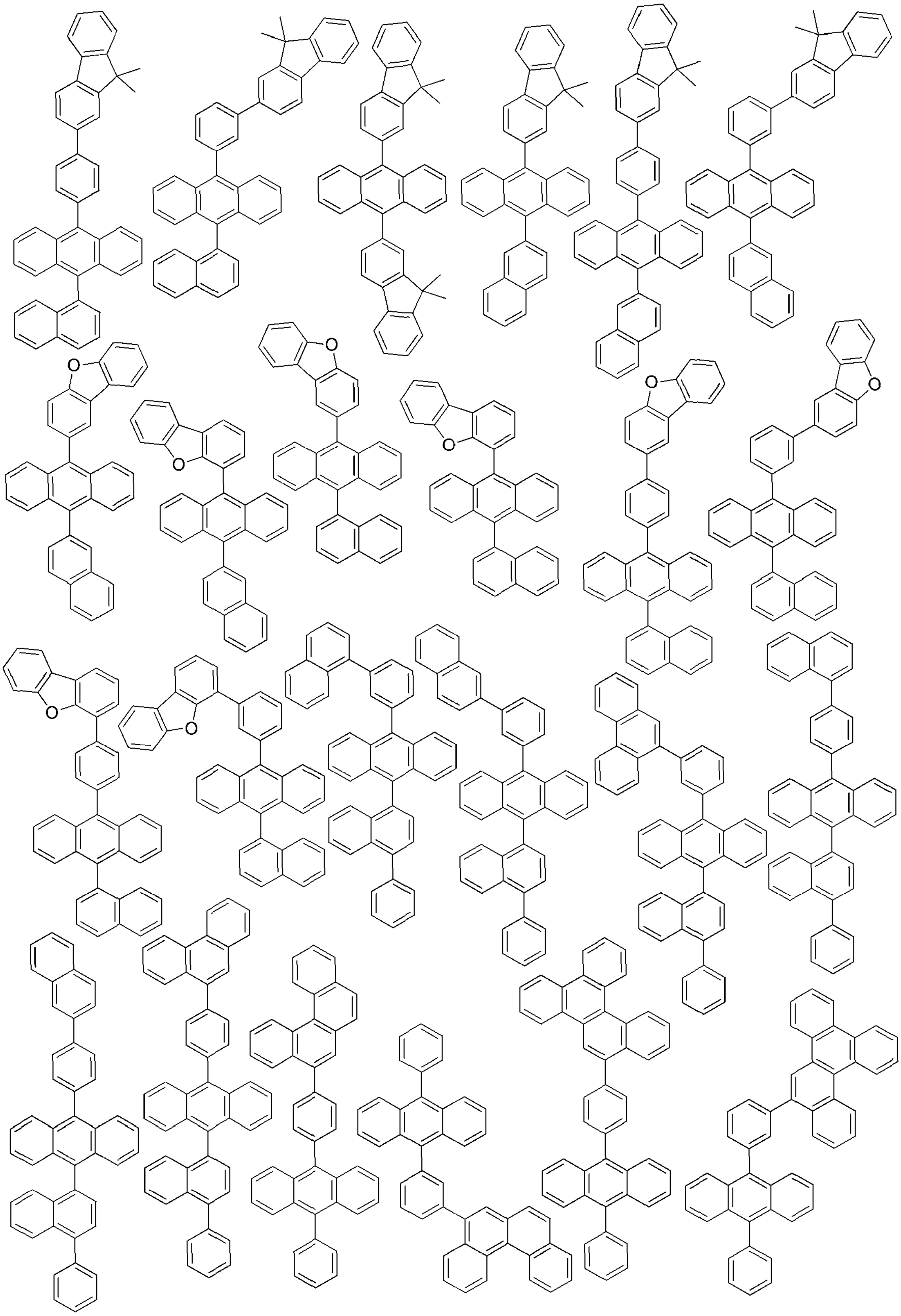

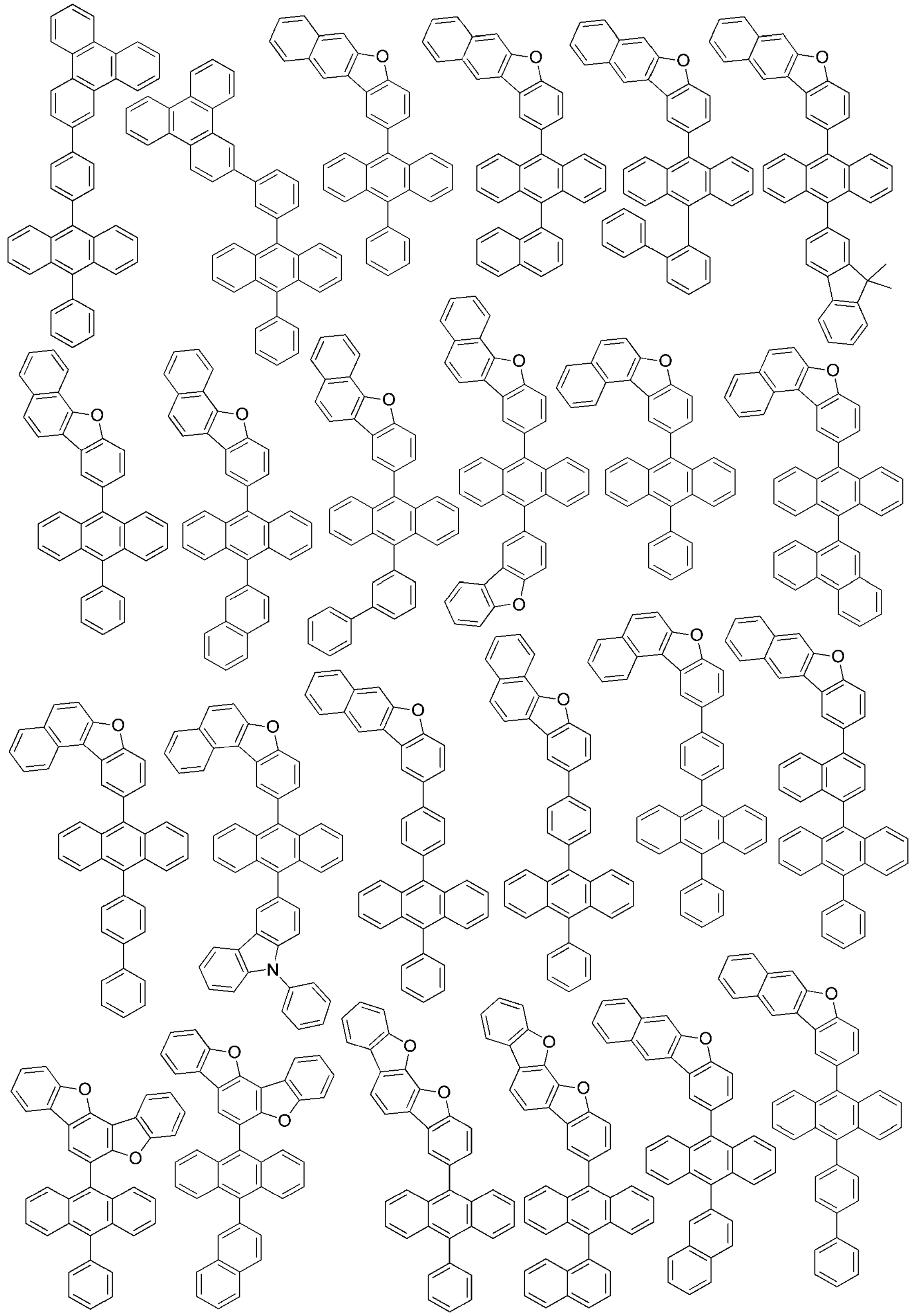

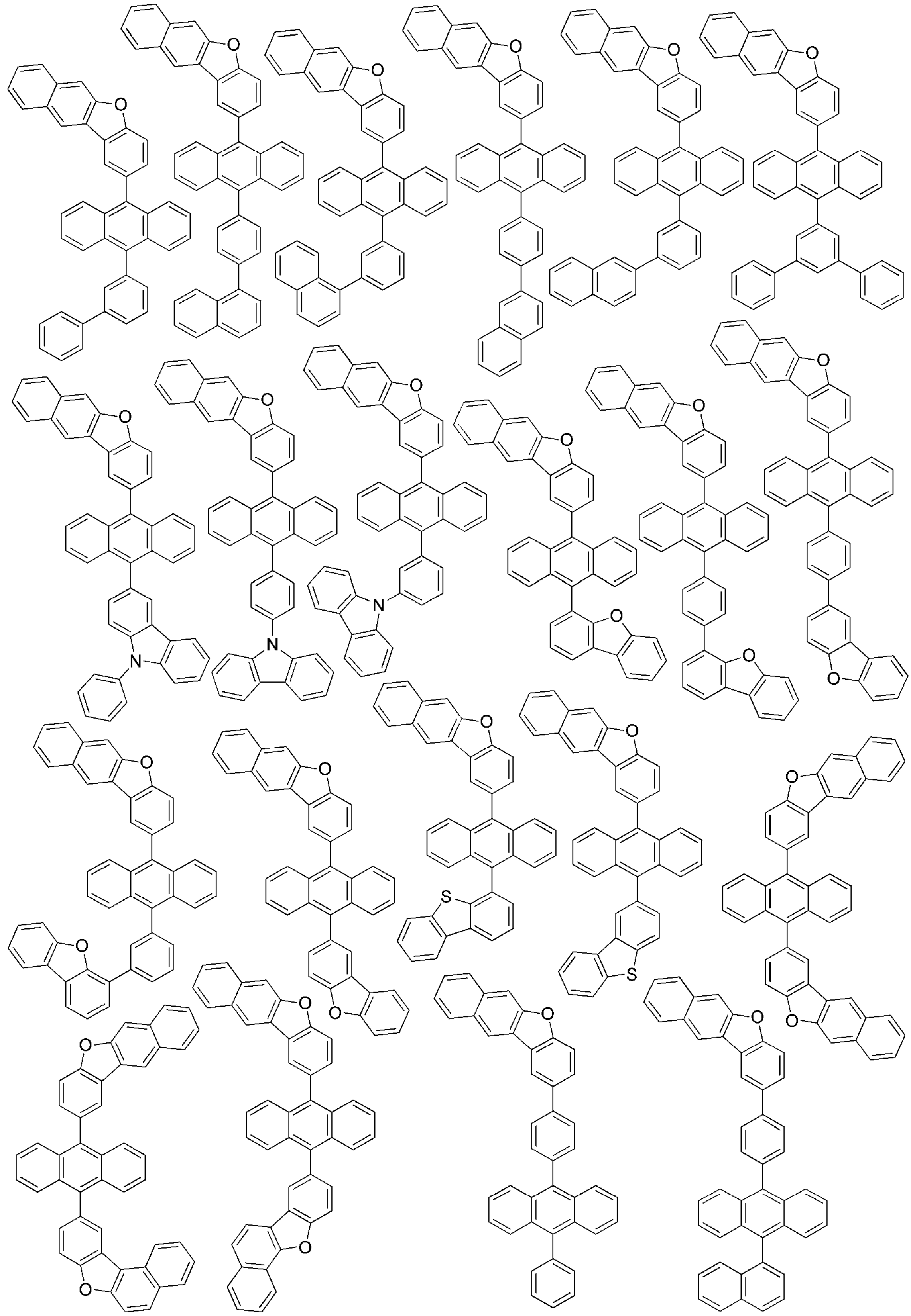

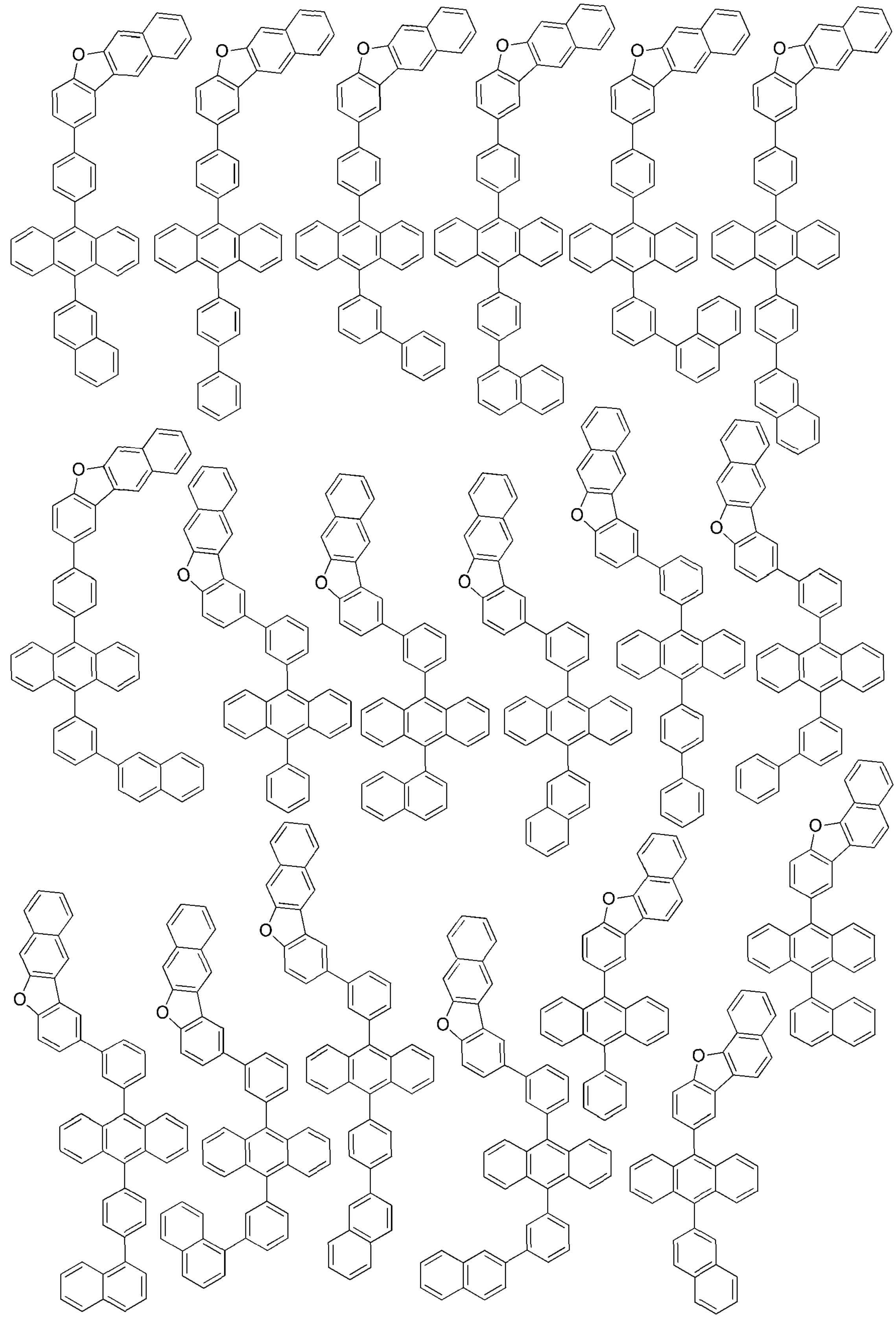

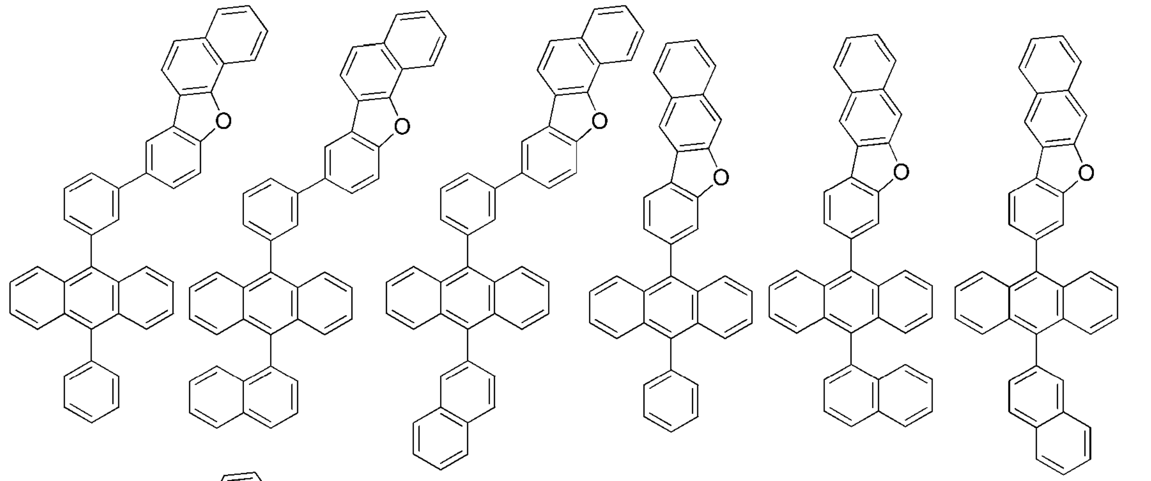

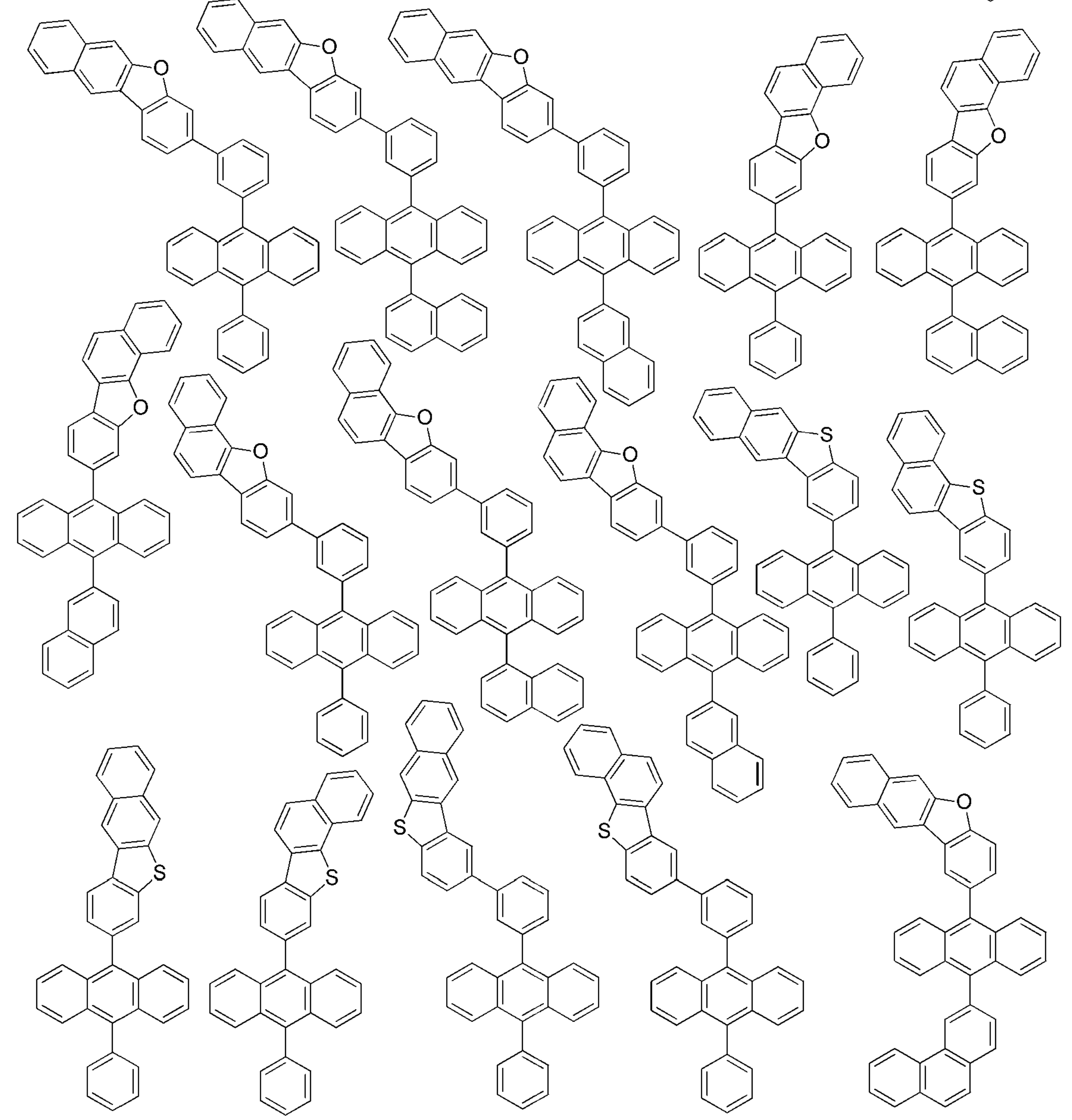

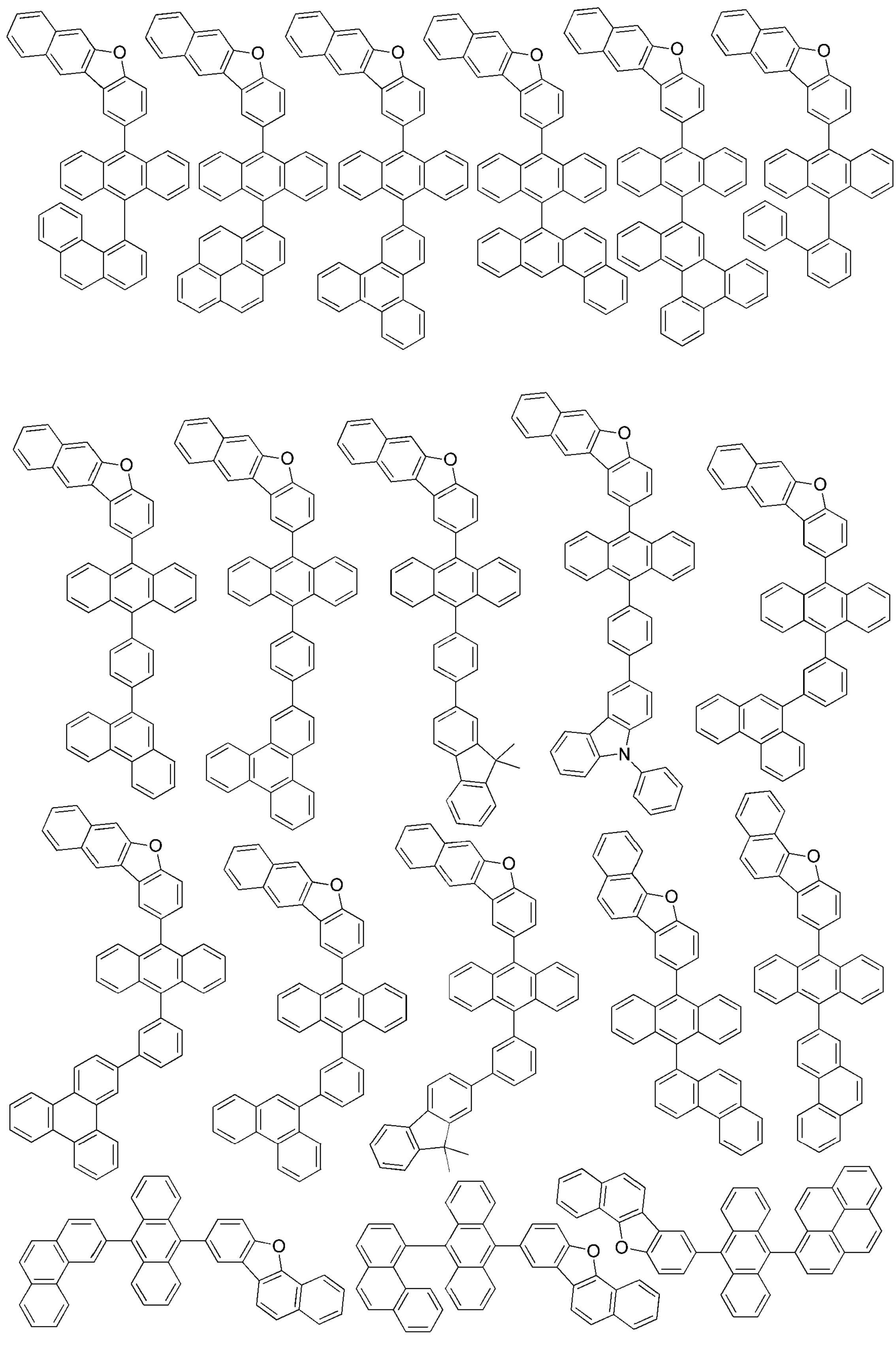

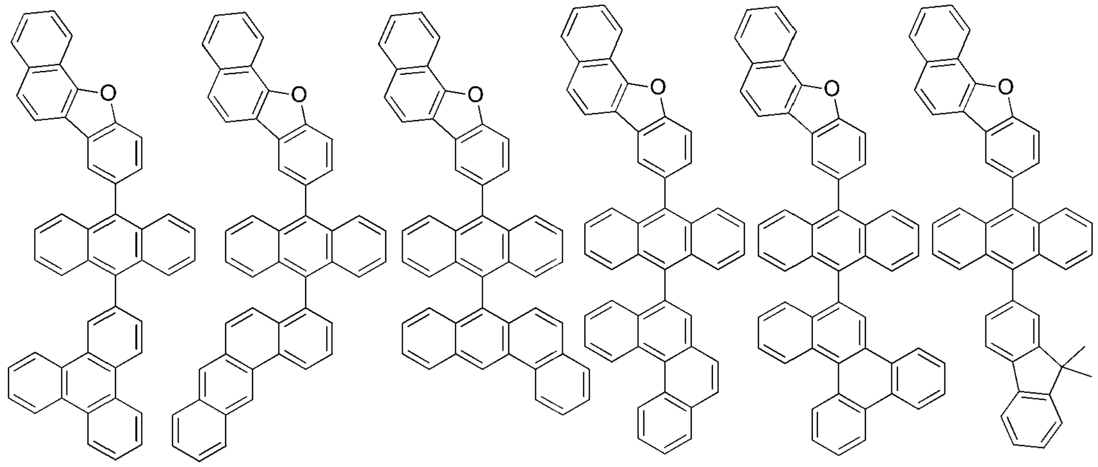

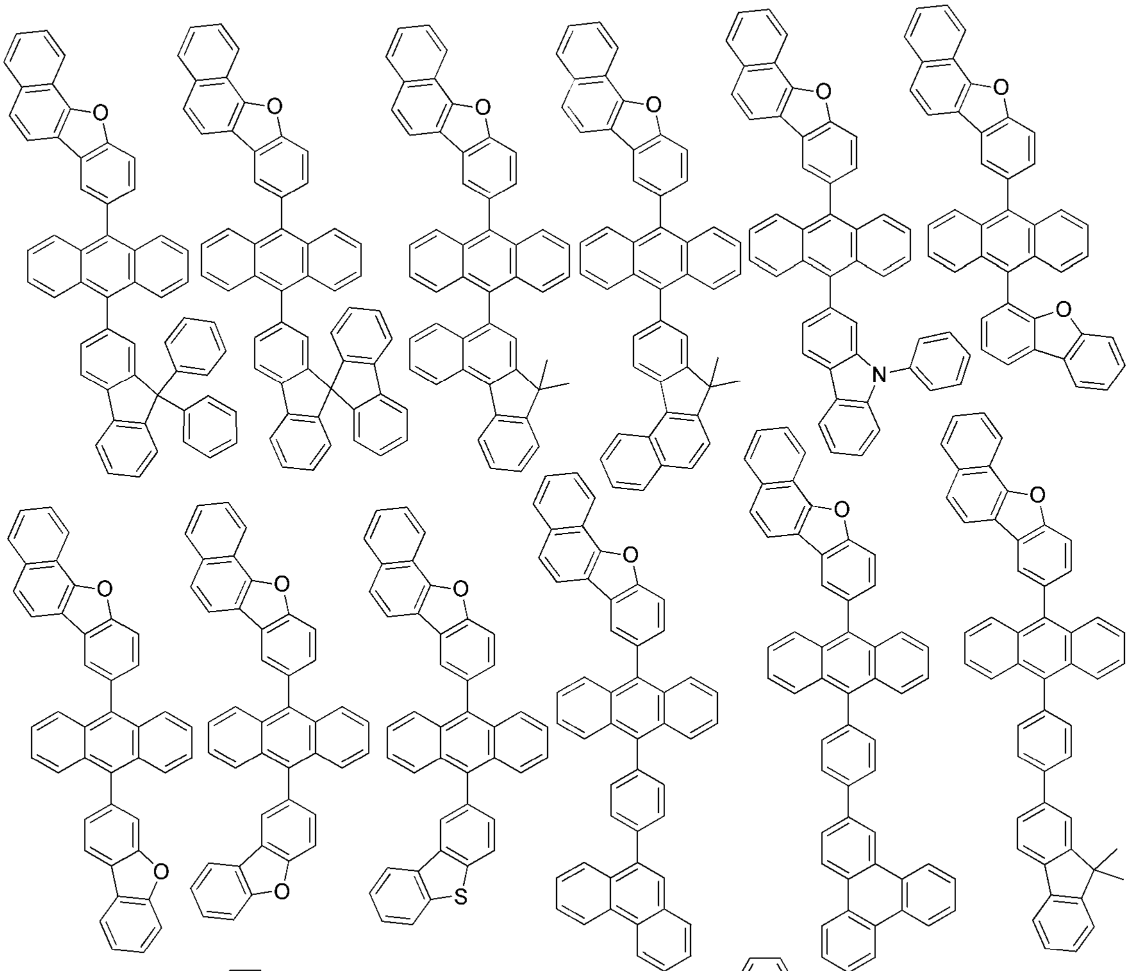

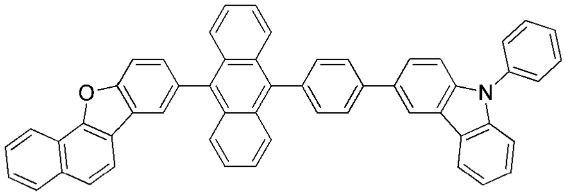

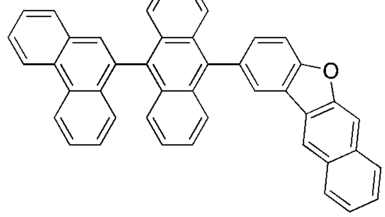

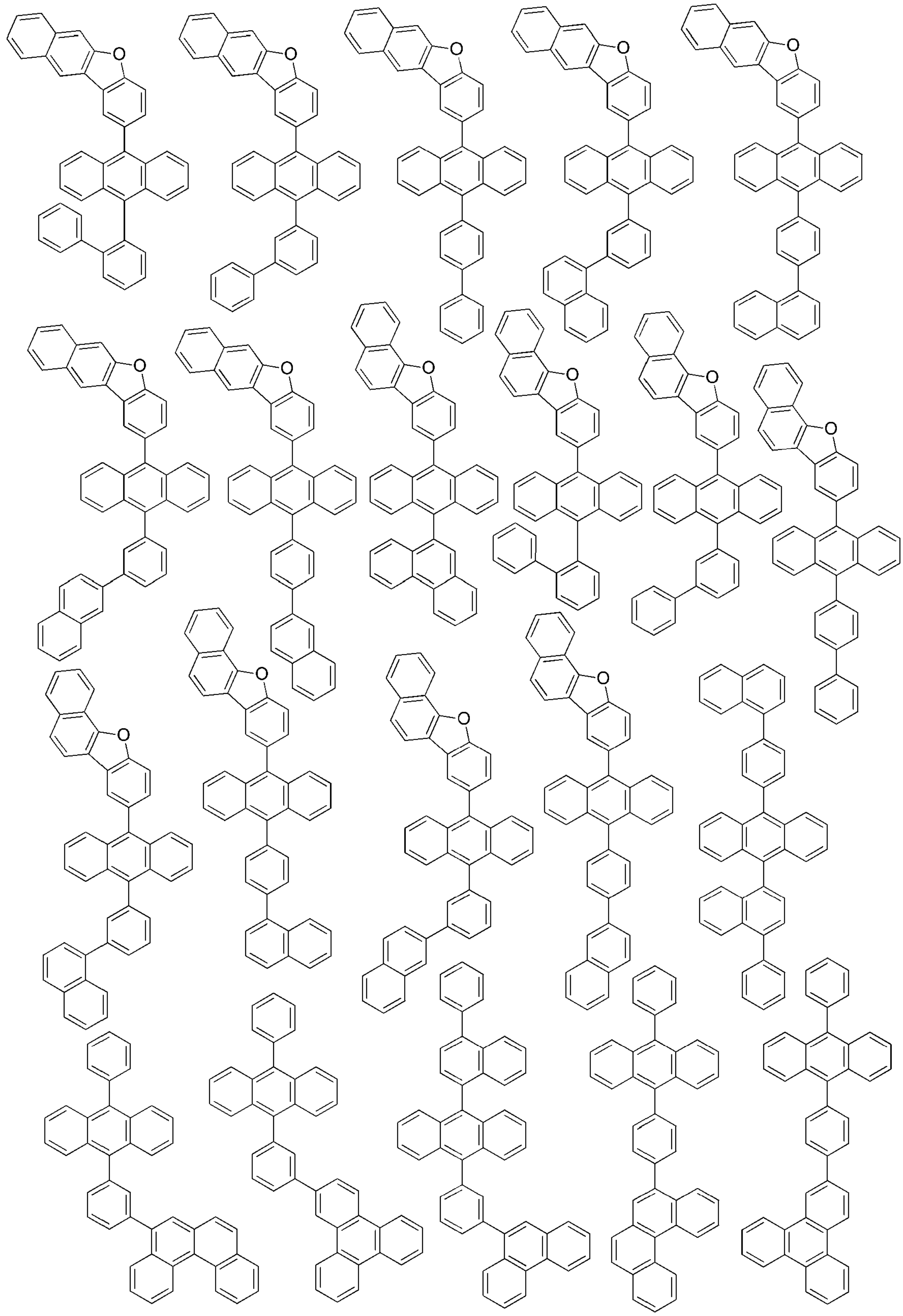

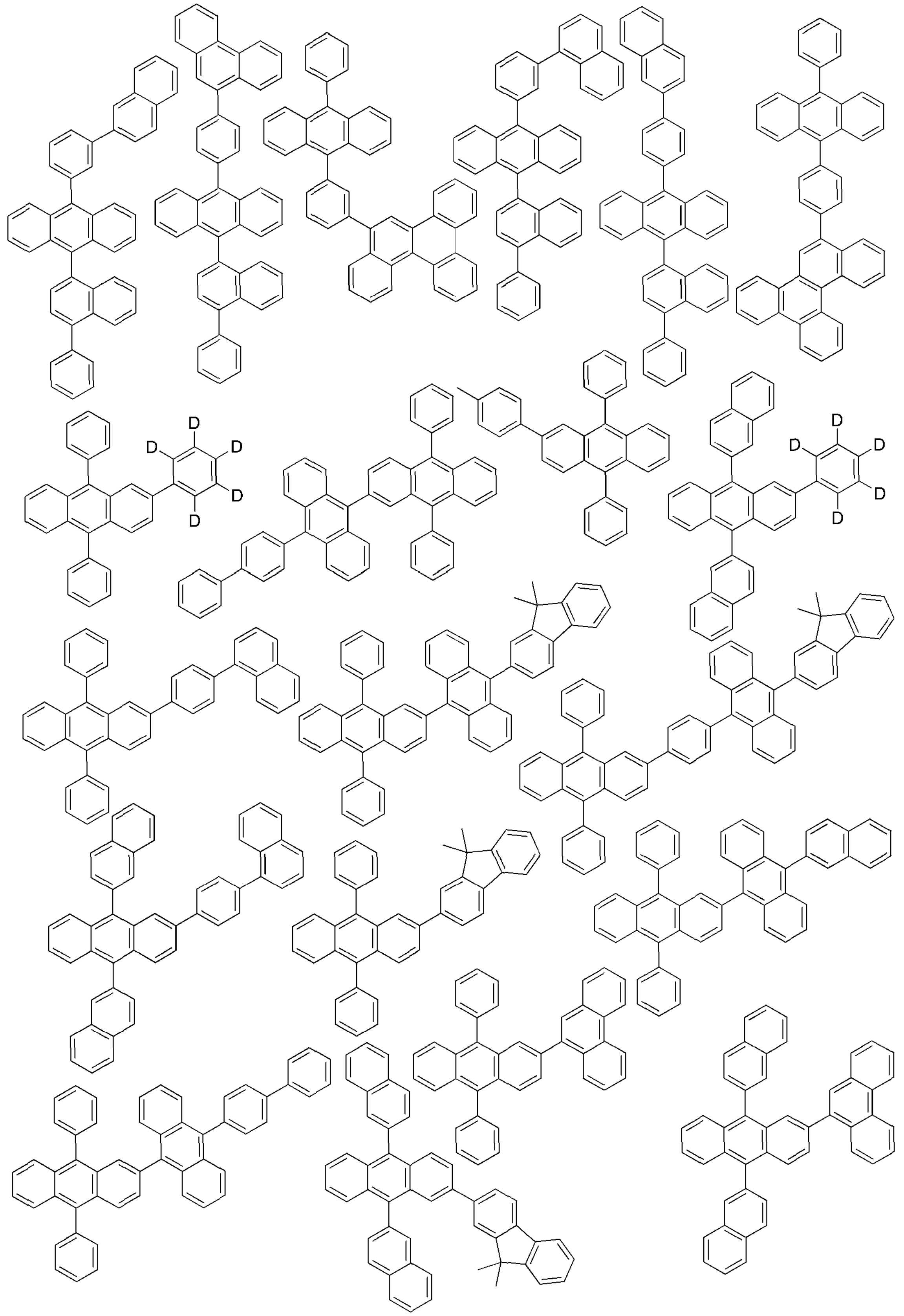

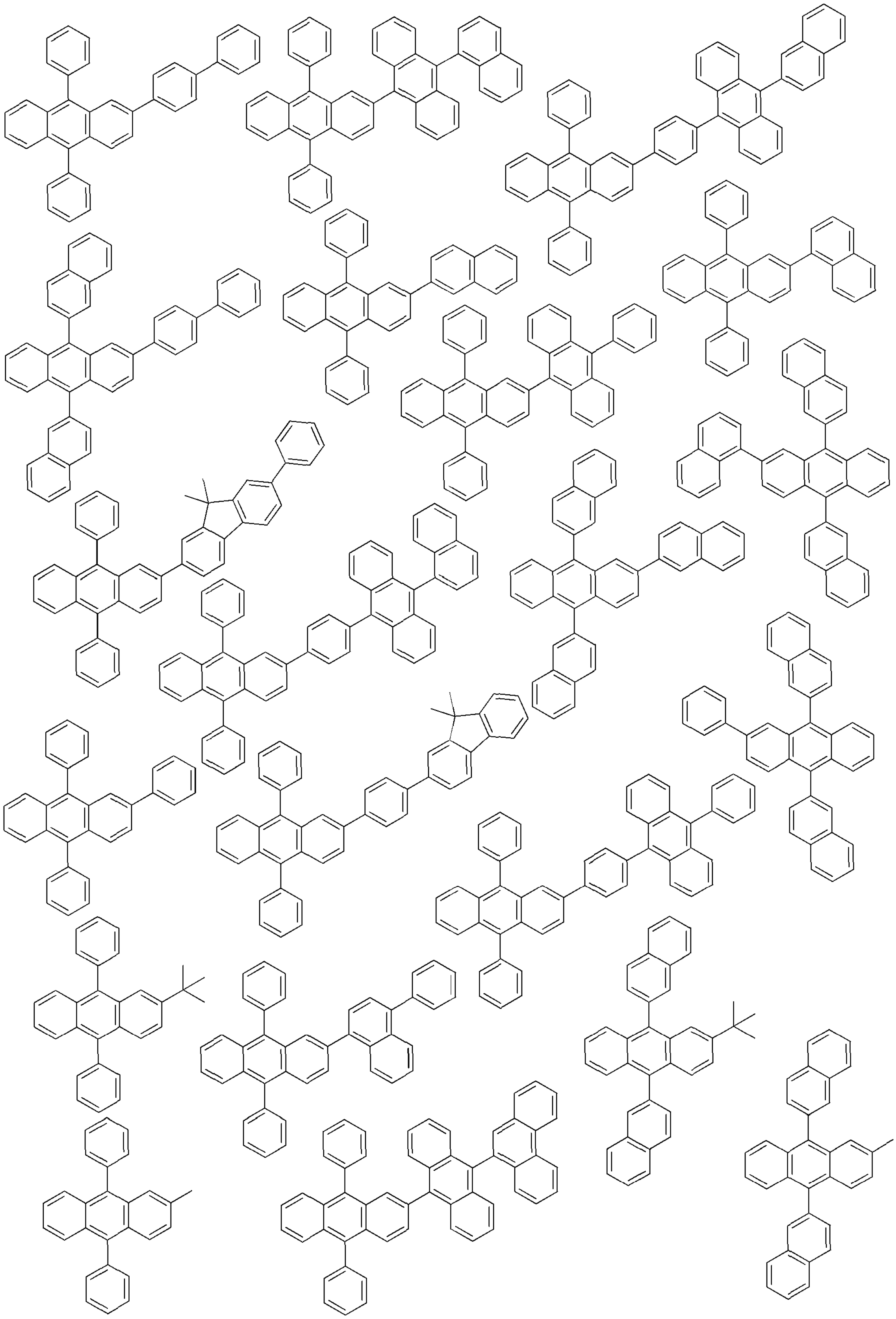

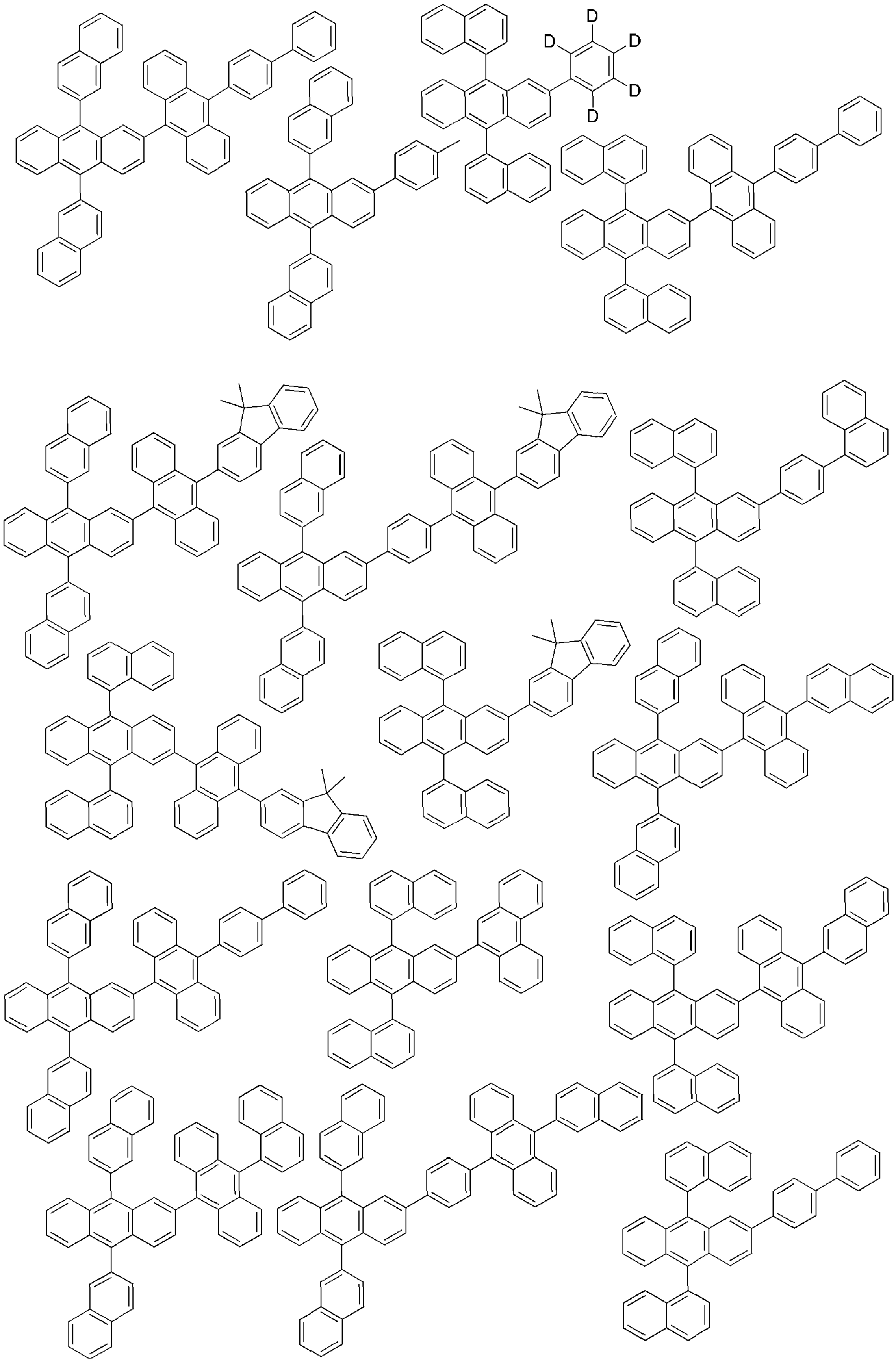

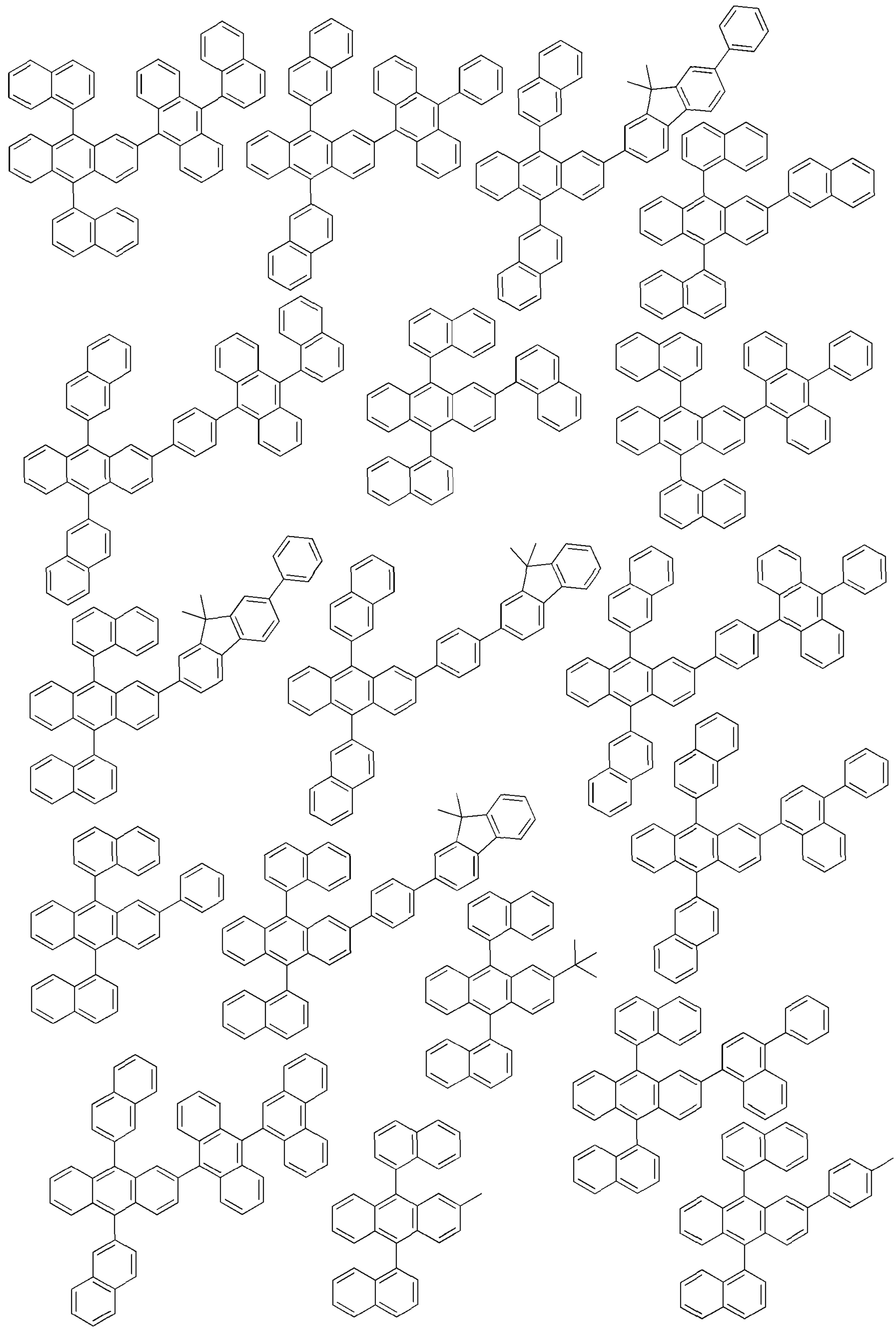

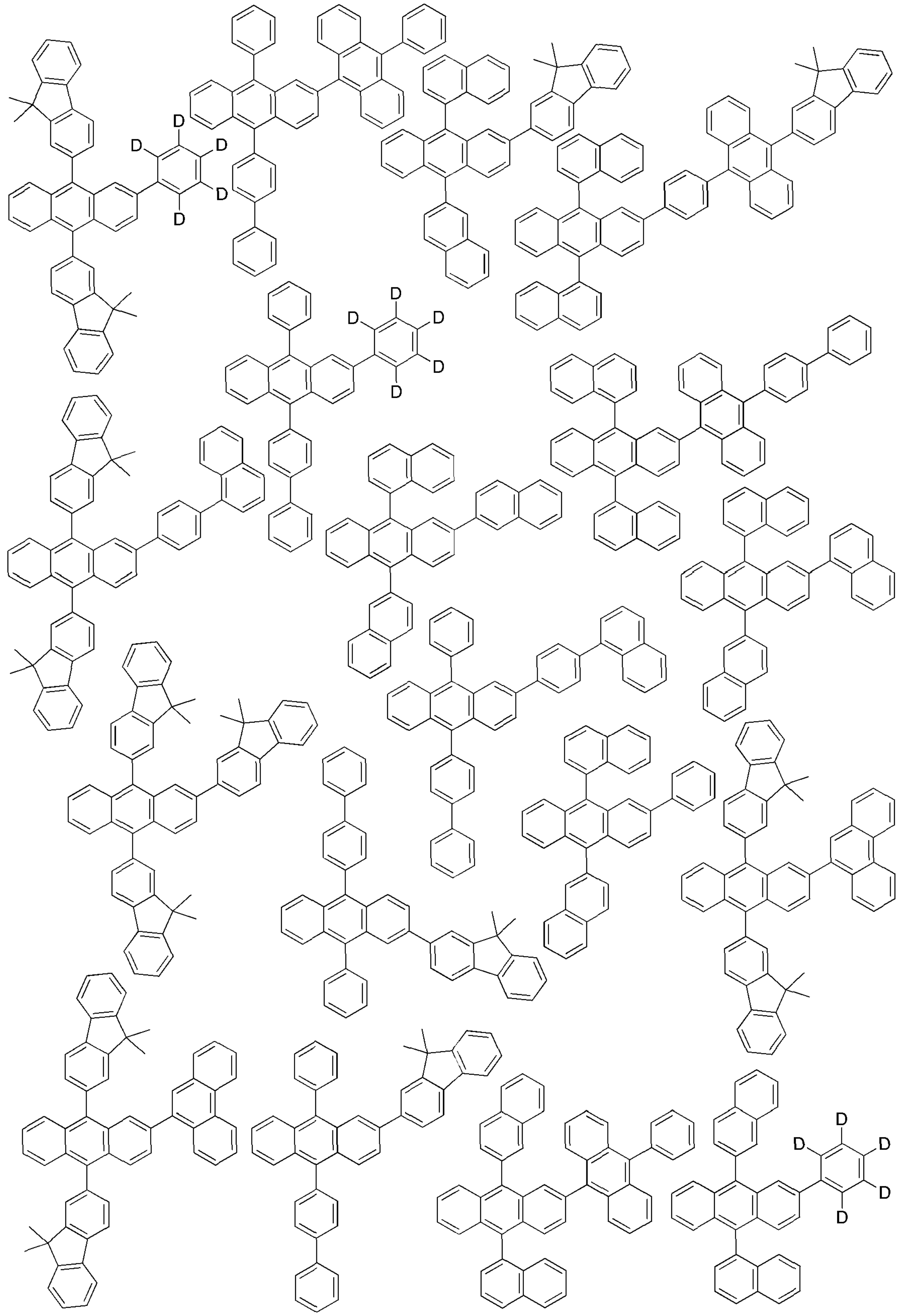

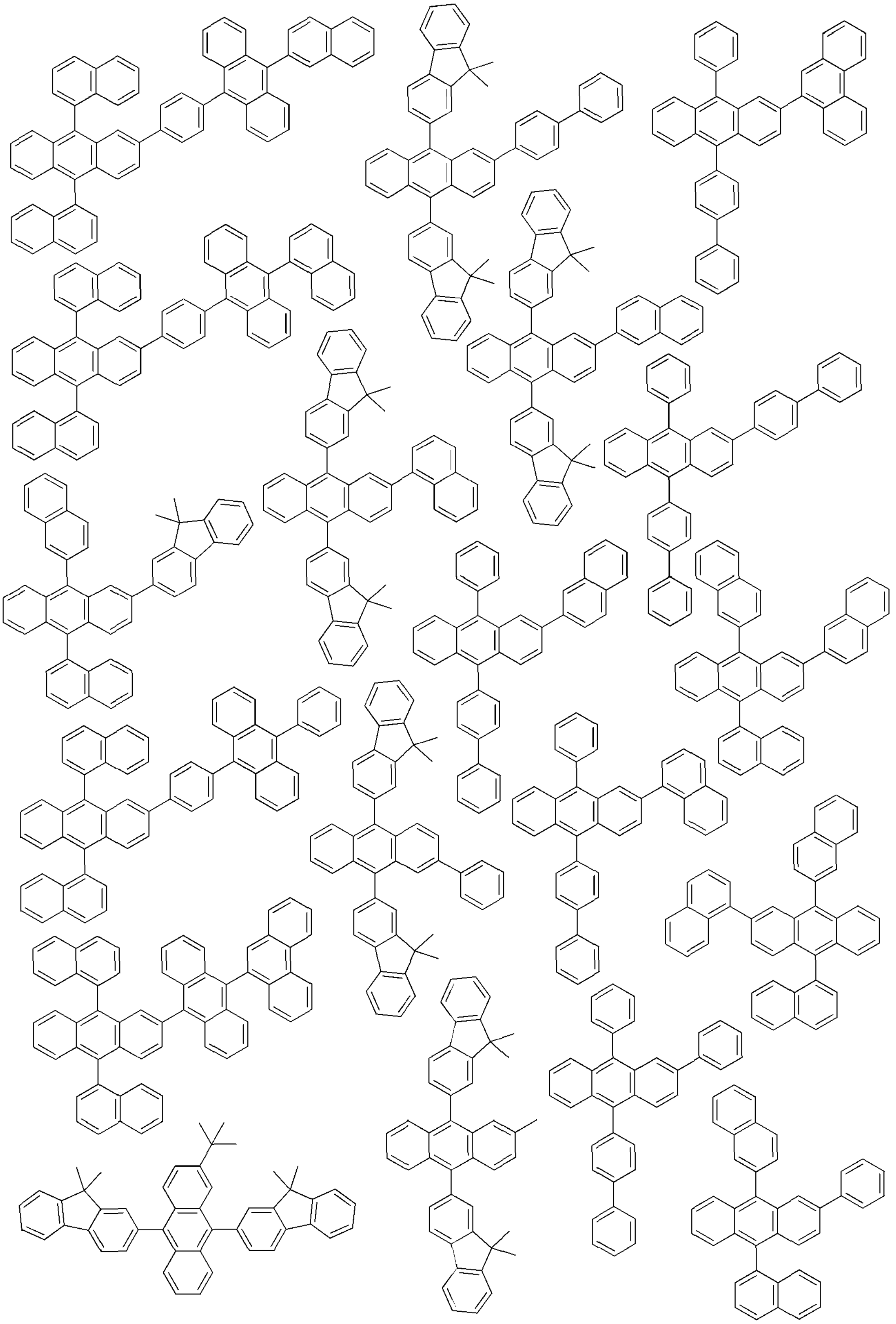

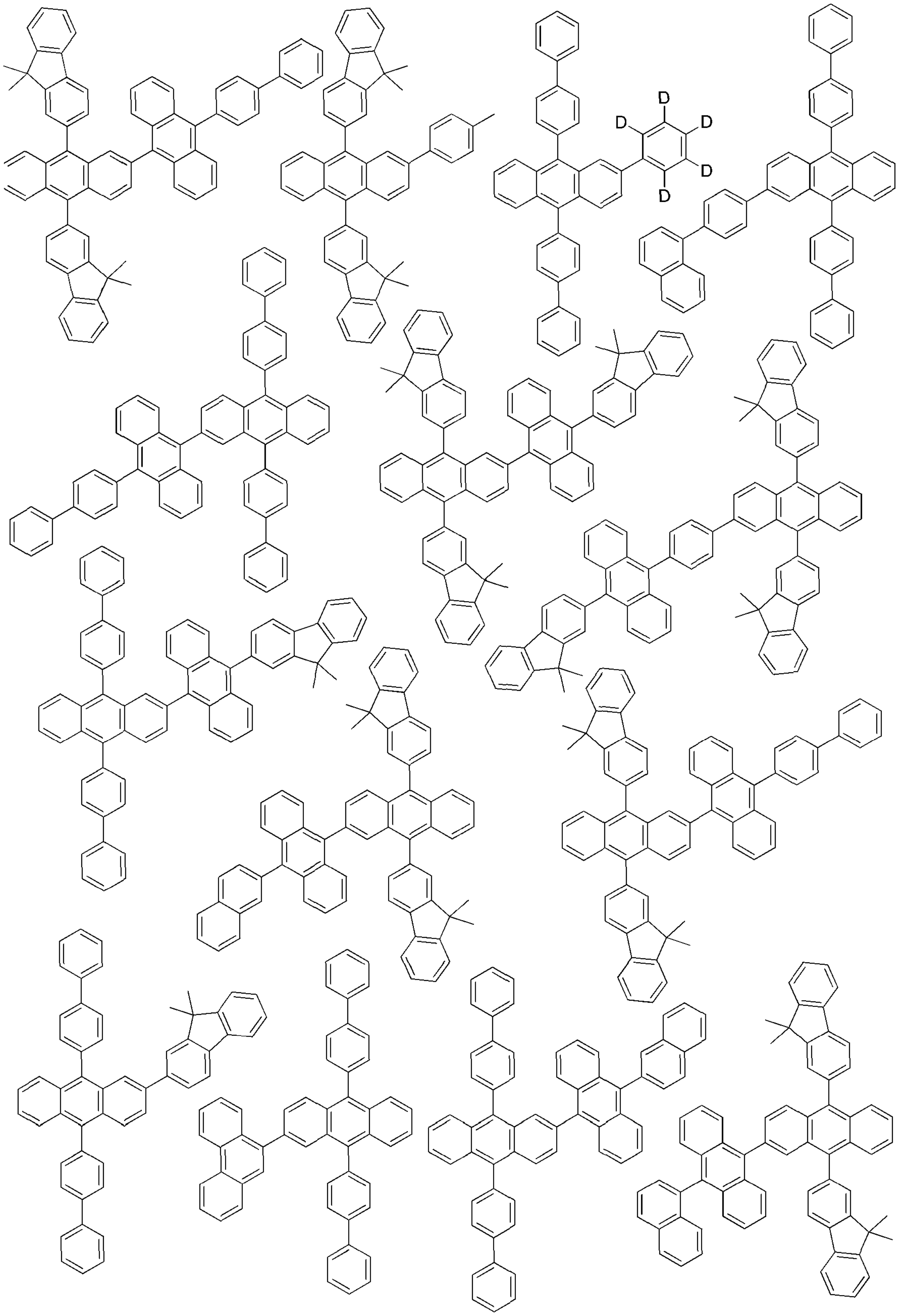

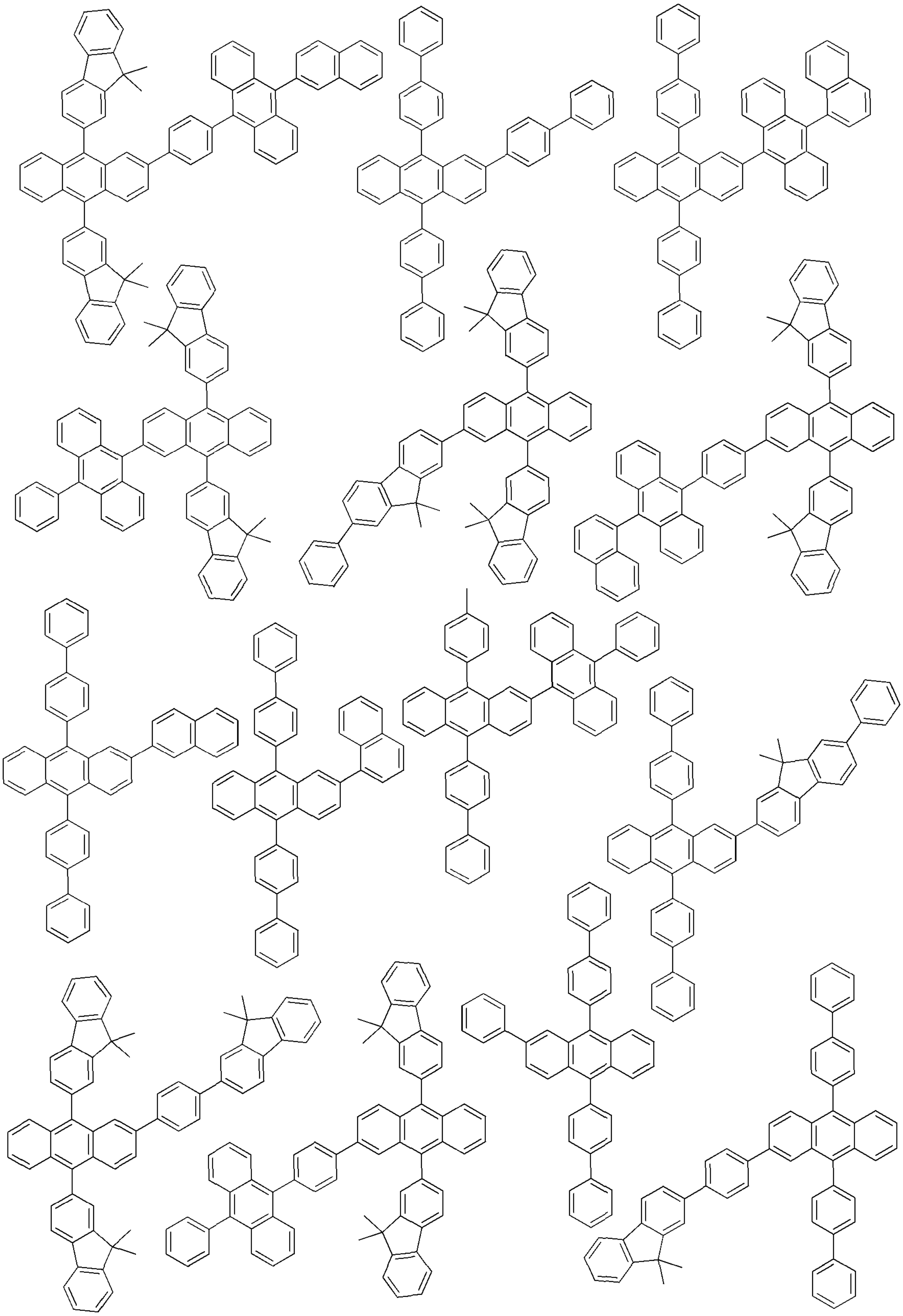

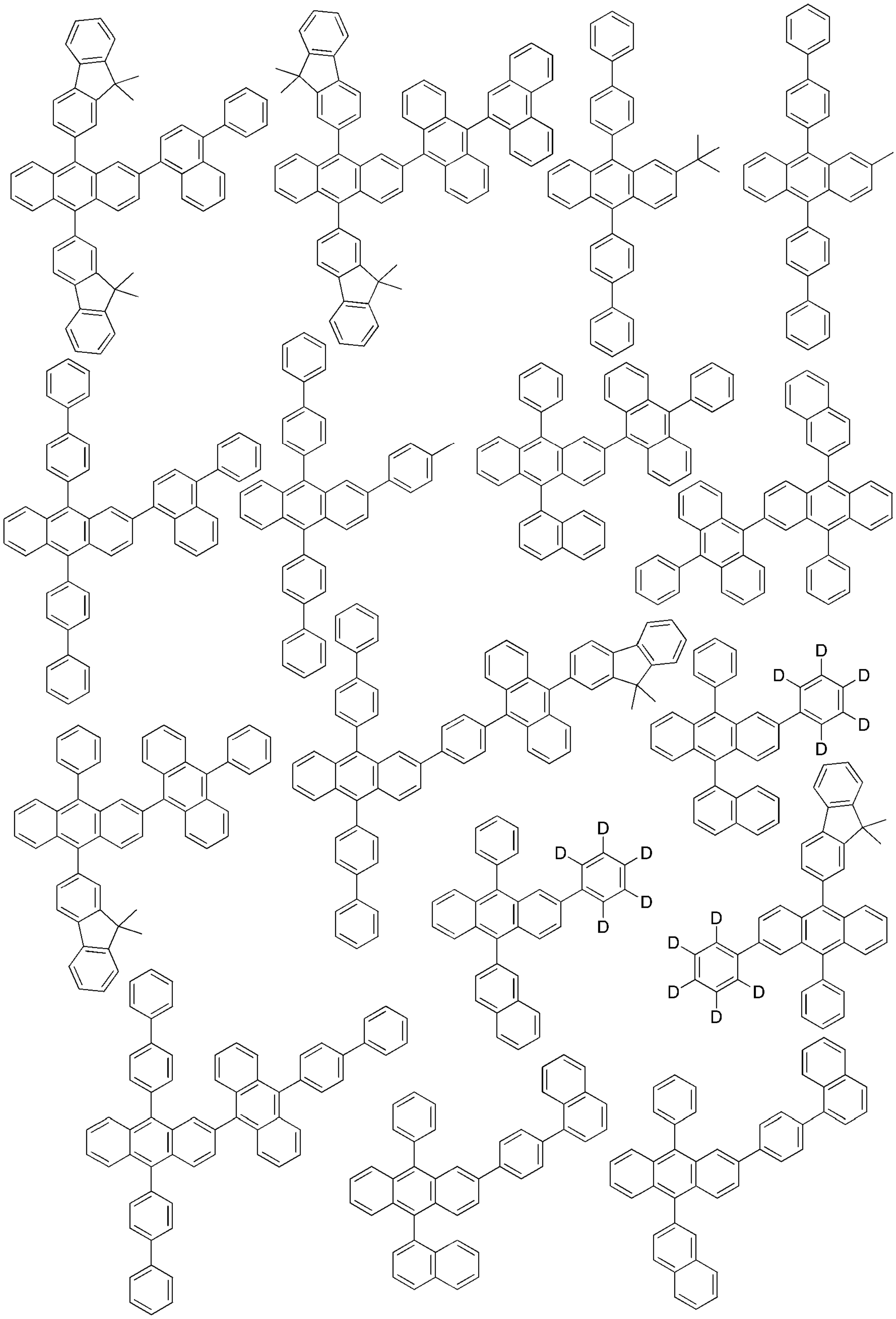

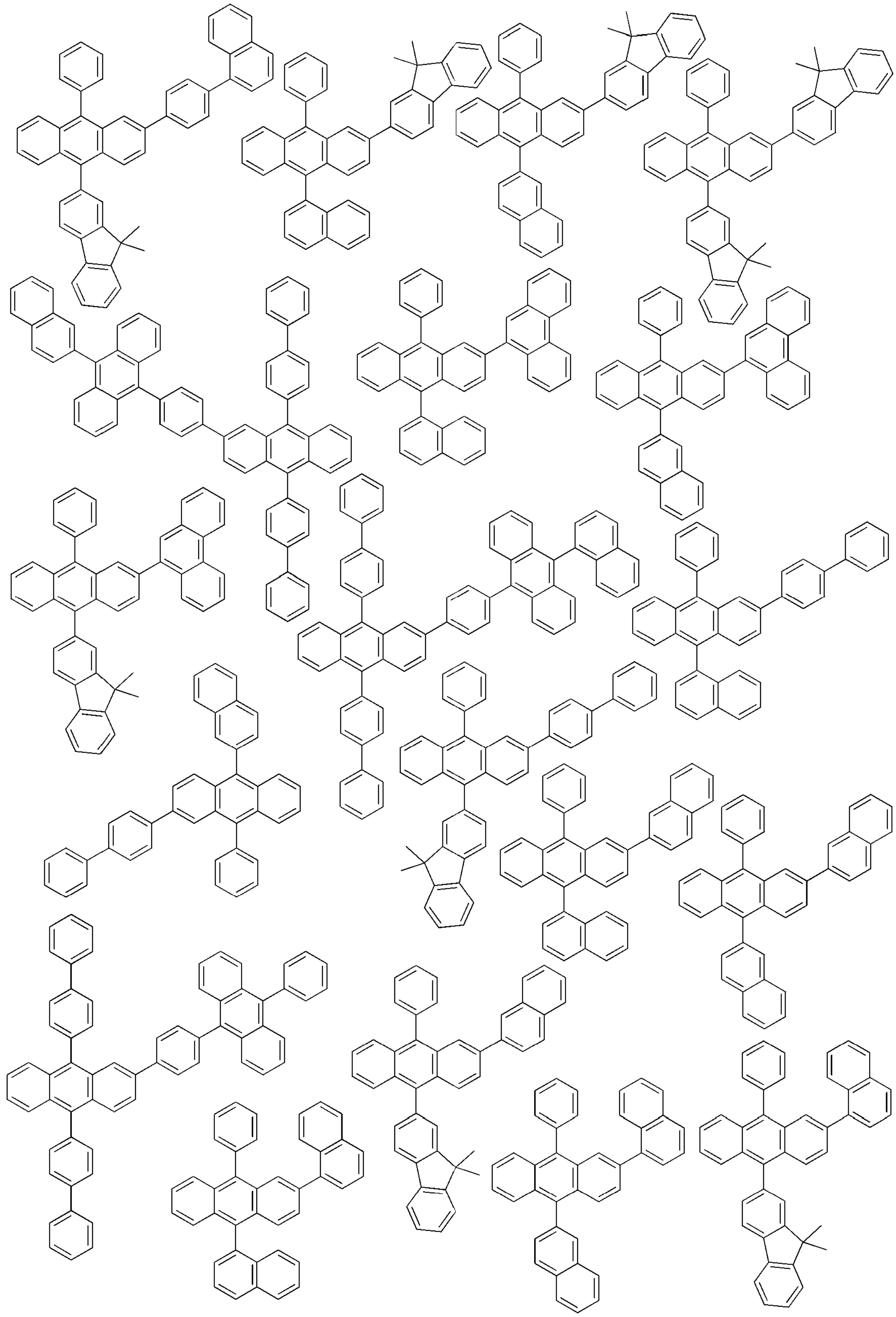

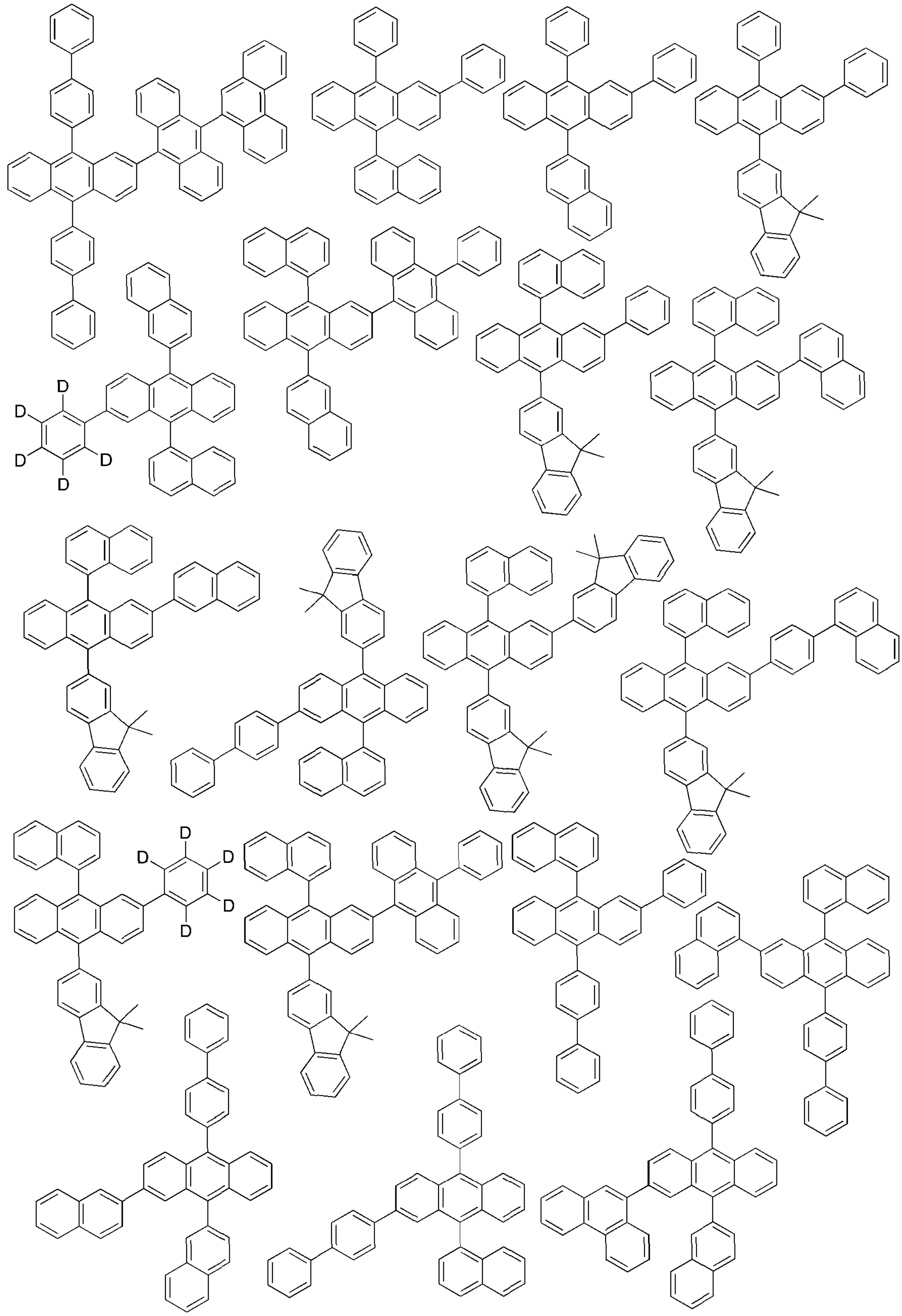

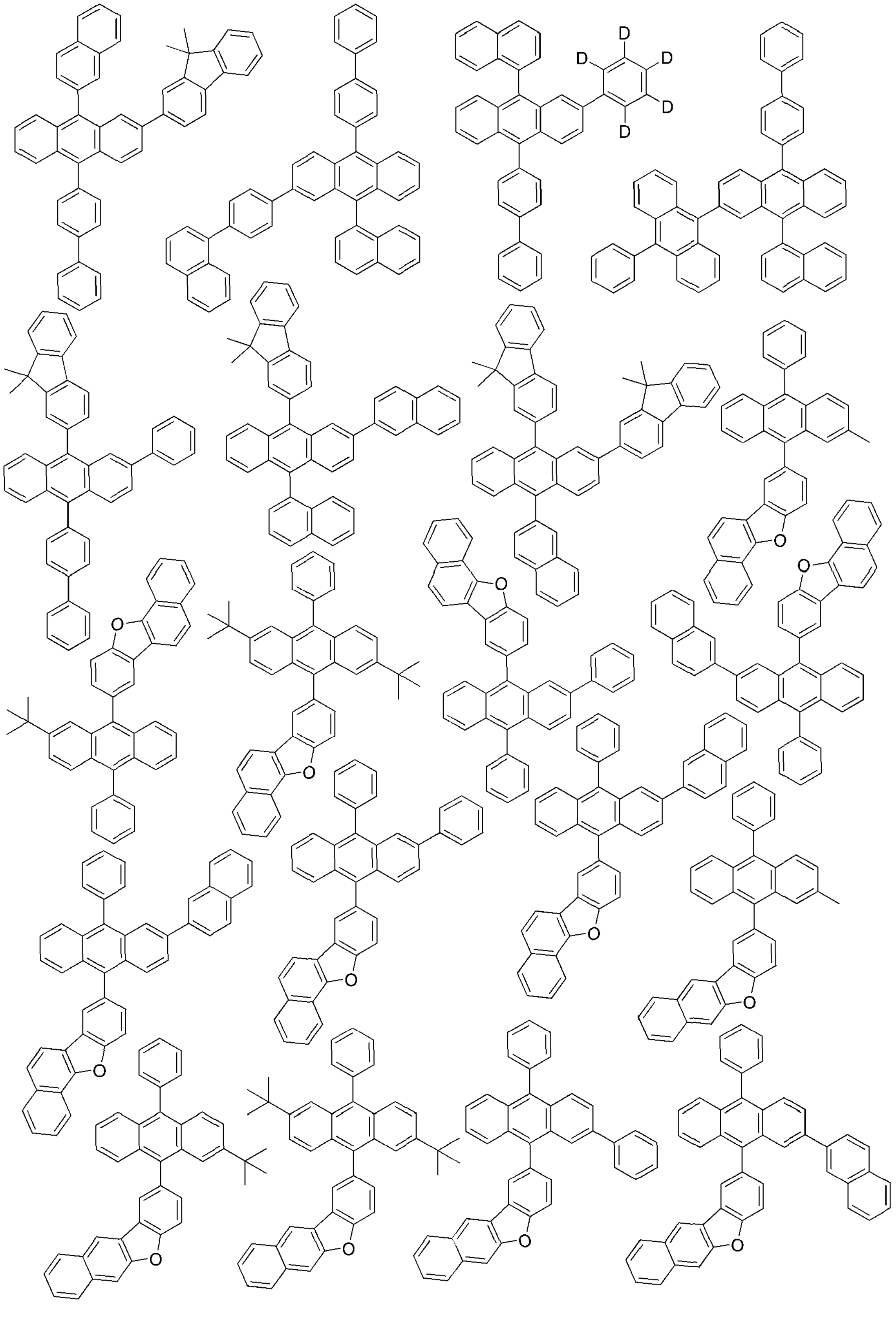

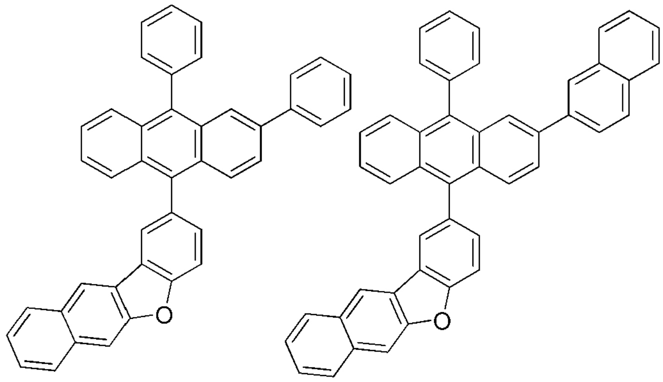

In one embodiment, the exciton management layer EXL comprises a TTA material and an additional emitter.

In a preferred embodiment, the exciton management layer EXL comprises a TTA material and an additional emitter, wherein the additional emitter in the adjacent layer EXL is a small full width at half maximum (FWHM) emitter $S^B$, which emits light with a full width at half maximum (FWHM) of less than or equal to 0.25 eV and with an emission maximum between 510 and 550 nm.

Furthermore, the organic electroluminescent device may optionally comprise one or more protective layers protecting the device from damaging exposure to harmful species in the environment including, exemplarily moisture, vapor and/or gases.

An electroluminescent device (e.g., an OLED) may further, optionally, comprise a protection layer between an electron transport layer (ETL) D and a cathode layer C (which may be designated as electron injection layer (EIL)). This layer may comprise lithium fluoride, caesium fluoride, silver, Liq (8-hydroxyquinolinolatolithium), $Li_2O$, $BaF_2$, MgO and/or NaF.

Unless otherwise specified, any of the layers, including any of the sublayers, of the various embodiments may be deposited by any suitable method. The layers in the context of the present invention, including at least one light-emitting layer B (which may consist of a single (sub)layer or may comprise more than one sublayers) and/or one or more sublayers thereof, may optionally be prepared by means of liquid processing (also designated as "film processing", "fluid processing", "solution processing" or "solvent processing"). This means that the components comprised in the respective layer are applied to the surface of a part of a device in liquid state.

Preferably, the layers in the context of the present invention, including the at least one light-emitting layer B and/or one or more sublayers thereof, may be prepared by means of spin-coating. This method well-known to those skilled in the art allows obtaining thin and (essentially) homogeneous layers and/or sublayers.

Alternatively, the layers in the context of the present invention, including the at least one light-emitting layer B and/or one or more sublayers thereof, may be prepared by other methods based on liquid processing such as, e.g., casting (e.g., dropcasting) and rolling methods, and printing methods (e.g., inkjet printing, gravure printing, blade coating). This may optionally be carried out in an inert atmosphere (e.g., in a nitrogen atmosphere).

In another preferred embodiment, the layers in the context of the present invention, including the at least one light-emitting layer B and/or one or more sublayers thereof, may be prepared by any other method known in the art, including but not limited to vacuum processing methods well-known to those skilled in the art such as, e.g., thermal (co-) evaporation, organic vapor phase deposition (OVPD), and deposition by organic vapor jet printing (OVJP).

One of the purposes of interest of an organic electroluminescent device may be the generation of the organic electroluminescent device via vacuum-deposition.

Accordingly, a further aspect of the present invention to a method for generating an organic electroluminescent device comprising the steps

(i) evaporation of a light-emitting layer B via vacuum-deposition, and
(ii) evaporation of an exciton management layer EXL via vacuum-deposition,

wherein the steps (i) and (ii) are performed subsequent to each other and the order of steps (i) and (ii) can be reversed.

In a preferred embodiment, the organic electroluminescent device is generated, wherein a light-emitting layer B is evaporated via vacuum-deposition and subsequently, an exciton management layer EXL is evaporated via vacuum-deposition. It will be understood that, in this embodiment, the exciton management layer EXL will preferably be deposited via vacuum-deposition on the light-emitting layer B. In other words, the exciton management layer EXL is preferably in direct contact with the light-emitting layer B. Thus, it is directly adjacent.

In a preferred embodiment, the organic electroluminescent device is generated, wherein an exciton management layer EXL is evaporated via vacuum-deposition and subsequently, a light-emitting layer B is evaporated via vacuum-deposition. It will be understood that, in this embodiment, the light-emitting layer B will preferably be deposited via vacuum-deposition on the exciton management layer EXL. In other words, the exciton management layer EXL is preferably in direct contact with the light-emitting layer B. Thus, it is directly adjacent.

When preparing layers, optionally including one or more sublayers thereof, by means of liquid processing, the solutions including the components of the (sub)layers (i.e., with respect to the light-emitting layer B of the present invention one or more TADF material $E^B$, optionally one or more excitation energy transfer components EET-2, one or more small FWHM emitters $S^B$, and optionally one or more host materials $H^B$,) may further comprise a volatile organic solvent. Such volatile organic solvent may optionally be one selected from the group consisting of tetrahydrofuran, dioxane, chlorobenzene, diethylene glycol diethyl ether, 2-(2-ethoxyethoxy)ethanol, gamma-butyrolactone, N-methyl pyrrolidinon, ethoxyethanol, xylene, toluene, anisole, phenetol, acetonitrile, tetrahydrothiophene, benzonitrile, pyridine, trihydrofuran, triarylamine, cyclohexanone, acetone, propylene carbonate, ethyl acetate, benzene and PGMEA (propylen glycol monoethyl ether acetate). Also a combination of two or more solvents may be used. After applied in liquid state, the layer may subsequently be dried and/or hardened by any means of the art, exemplarily at ambient conditions, at increased temperature (e.g., about 50°C or about 60°C) or at diminished pressure.

The organic electroluminescent device as a whole may also form a thin layer of a thickness of not more than 5 mm, not more than 2 mm, not more than 1 mm, not more than 0.5 mm, not more than 0.25 mm, not more than 100 $\mu$m, or not more than 10 $\mu$m.

An organic electroluminescent device (e.g., an OLED) may be small-sized (e.g., having a surface not larger than 5 $mm^2$, or even not larger than 1 $mm^2$), mediumsized (e.g., having a surface in the range of 0.5 to 20 $cm^2$), or a large-sized (e.g., having a surface larger than 20 $cm^2$). An organic electroluminescent device (e.g., an OLED) according to the present invention may optionally be used for generating screens, as large-area illuminating device, as luminescent wallpaper, luminescent window frame or glass, luminescent label, luminescent poser or flexible screen or display. Next to the common uses, an organic electroluminescent device (e.g., an OLED) may exemplarily also be used as luminescent films, "smart packaging" labels, or innovative design elements. Further they are usable for cell detection and examination (e.g., as bio labelling).

*Composition of the light-emitting layer (EML) B*

In the following, when describing the composition of the light-emitting layer B of the organic electroluminescent device according to the present invention in more detail, reference is in some cases made to the content of certain materials in form of percentages. It is to be noted that, unless stated otherwise for specific embodiments, all percentages refer to weight percentages, which has the same meaning as percent by weight or % by weight ((weight/weight), (w/w), wt.%). It is understood that, when for example stating that the content of one or more small FWHM emitters $S^B$ in a specific composition is exemplarily 1%, this is to mean that the total weight of the one or more small FWHM emitters $S^B$ (i.e. of all $S^B$-molecules combined) is 1% by weight, i.e. accounts for 1% of the total weight of the respective light-emitting layer B. It is understood that, whenever the composition of a light-emitting layer B is specified by providing the preferred content of its components in % by weight, the total content of all components adds up to 100% by weight (i.e. the total weight of the respective light-emitting layer B).

The host material $H^B$, the TADF material $E^B$ and the small FWHM emitter $S^B$ may be comprised in the organic electroluminescent device according to the present invention in any amount and any ratio.

In one embodiment, in the organic electroluminescent device according to the present invention, the light-emitting layer B comprises or consists of:

(i) 12-60% by weight of the TADF material $E^B$; and
(ii) 0.0-30% by weight of the excitation energy transfer component EET-2; and
(iii) 0.1-10% by weight of the small FWHM emitter $S^B$; and
(iv) 30-87.9% by weight of host material $H^B$; and optionally
(v) 0-57.9% by weight of one or more solvents; and optionally
(vi) 0-57.8% by weight of material selected from the group of TADF materials, phosphorescence materials, host materials, and small FWHM emitters (which are preferably each different from the components (i) - (iv)).

In one embodiment, in the organic electroluminescent device according to the present invention, the light-emitting layer B comprises or consists of:

(i) 12-60% by weight of the TADF material $E^B$; and
(ii) 0.0-30% by weight of the excitation energy transfer component EET-2; and
(iii) 0.1-10% by weight of the small FWHM emitter $S^B$; and
(iv) 30-87.9% by weight of host material $H^B$; and optionally

(v) 0-57.9% by weight of one or more solvents.

In a preferred embodiment, in the organic electroluminescent device according to the present invention, the light-emitting layer B comprises or consists of:

(i) 12-60% by weight of the TADF material $E^B$; and
(ii) 0.0-30% by weight of the excitation energy transfer component EET-2; and
(iii) 0.1-10% by weight of the small FWHM emitter $S^B$; and
(iv) 30-87.9% by weight host material $H^B$; and optionally
(v) 0-3% by weight of one or more solvents.

In one embodiment, in the organic electroluminescent device according to the present invention, the light-emitting layer B comprises or consists of:

(i) 12-60% by weight of the TADF material $E^B$; and
(ii) 0.1-30% by weight of the excitation energy transfer component EET-2; and
(iii) 0.1-10% by weight of the small FWHM emitter $S^B$; and
(iv) 30-87.8% by weight of host material $H^B$; and optionally
(v) 0-57.8% by weight of one or more solvents.

In a preferred embodiment, in the organic electroluminescent device according to the present invention, the light-emitting layer B comprises or consists of:

(i) 12-60% by weight of the TADF material $E^B$; and
(ii) 0.1-30% by weight of the excitation energy transfer component EET-2; and
(iii) 0.1-10% by weight of the small FWHM emitter $S^B$; and
(iv) 30-87.8% by weight host material $H^B$; and optionally
(v) 0-3% by weight of one or more solvents.

In a preferred embodiment, in the organic electroluminescent device according to the present invention, the light-emitting layer B comprises or consists of:

(i) 15-50% by weight of the TADF material $E^B$; and
(ii) 0.1-15% by weight of the excitation energy transfer component EET-2; and
(iii) 0.1-5% by weight of the small FWHM emitter $S^B$; and
(iv) 30-84.8% by weight host material $H^B$; and optionally
(v) 0-54.8% by weight of one or more solvents.

In a preferred embodiment, in the organic electroluminescent device according to the present invention, the light-emitting layer B comprises or consists of:

(i) 15-50% by weight of the TADF material $E^B$; and
(ii) 0.1-15% by weight of the excitation energy transfer component EET-2; and
(iii) 0.1-5% by weight of the small FWHM emitter $S^B$; and
(iv) 30-84.8% by weight of host material $H^B$; and optionally
(v) 0-3% by weight of one or more solvents.

In a preferred embodiment, in the organic electroluminescent device according to the present invention, the light-emitting layer B comprises or consists of:

(i) 20-50% by weight of the TADF material $E^B$; and
(ii) 0.1-10% by weight of the excitation energy transfer component EET-2; and
(iii) 0.1-3% by weight of the small FWHM emitter $S^B$; and
(iv) 40-79.8% by weight of host material $H^B$; and optionally
(v) 0-39.8% by weight of one or more solvents.

In a preferred embodiment, in the organic electroluminescent device according to the present invention, the light-emitting layer B comprises or consists of:

(i) 20-50% by weight of the TADF material $E^B$; and
(ii) 0.1-10% by weight of the excitation energy transfer component EET-2; and
(iii) 0.1-3% by weight of the small FWHM emitter $S^B$; and
(iv) 40-79.8% by weight of host material $H^B$; and optionally
(v) 0-3% by weight of one or more solvents.

In a preferred embodiment, in the organic electroluminescent device according to the present invention, the light-emitting layer B comprises or consists of:

(i) 20-45% by weight of the TADF material $E^B$; and
(ii) 0.1-5% by weight of the excitation energy transfer component EET-2; and
(iii) 0.1-3% by weight of the small FWHM emitter $S^B$; and
(iv) 40-79.8% by weight of host material $H^B$; and optionally
(v) 0-39.8% by weight of one or more solvents.

In a preferred embodiment, in the organic electroluminescent device according to the present invention, the light-emitting layer B comprises or consists of:

(i) 20-45% by weight of the TADF material $E^B$; and
(ii) 0.1-5% by weight of the excitation energy transfer component EET-2; and
(iii) 0.1-3% by weight of the small FWHM emitter $S^B$; and
(iv) 40-79.8% by weight of host material $H^B$; and optionally
(v) 0-7% by weight of one or more solvents.

In a preferred embodiment, in the organic electroluminescent device according to the present invention, the light-emitting layer B comprises or consists of:

(i) 20-45% by weight of the TADF material $E^B$; and
(ii) 0.1-3% by weight of the excitation energy transfer component EET-2; and
(iii) 0.1-3% by weight of the small FWHM emitters $S^B$; and
(iv) 40-79.8% by weight of host material $H^B$; and optionally
(v) 0-39.8% by weight of one or more solvents.

In a preferred embodiment, in the organic electroluminescent device according to the present invention, the light-emitting layer B comprises or consists of:

(i) 20-45% by weight of the TADF material $E^B$; and
(ii) 0.1-3% by weight of the excitation energy transfer component EET-2; and
(iii) 0.1-3% by weight of the small FWHM emitter $S^B$; and
(iv) 40-79.8% by weight of host material $H^B$; and optionally
(v) 0-9% by weight of one or more solvents.

In a preferred embodiment of the invention, the light-emitting layer B comprises less than or equal to 5% by weight, referred to the total weight of the light-emitting layer B, of the excitation energy transfer component EET-2 (meaning the total content of EET-2 in the respective light-emitting layer B is equal to or less than 5% by weight).

In a preferred embodiment of the invention, the light-emitting layer B comprises less than or equal to 5% by weight, referred to the total weight of the light-emitting layer B, of the excitation energy transfer component EET-2 (meaning the total content of EET-2 in the respective light-emitting layer B is equal to or less than 5% by weight).

In a preferred embodiment of the invention, the light-emitting layer B comprises less than or equal to 3% by weight, referred to the total weight of the light-emitting layer B, of the excitation energy transfer component EET-2 (meaning the total content of EET-2 in the respective light-emitting layer B is equal to or less than 3% by weight).

In one embodiment of the invention, the light-emitting layer B comprises less than or equal to 5% by weight, referred to the total weight of the light-emitting layer B, of the small FWHM emitter $S^B$ (meaning the total content of $S^B$ in the respective light-emitting layer B is equal to or less than 5% by weight).

In a preferred embodiment of the invention, the light-emitting layer B comprises less than or equal to 3% by weight, referred to the total weight of the light-emitting layer B, of the small FWHM emitter $S^B$ (meaning the total content of $S^B$ in the respective light-emitting layer B is equal to or less than 3% by weight).

In one embodiment of the invention, the light-emitting layer B comprises less than or equal to 1% by weight,

referred to the total weight of the light-emitting layer B, of the small FWHM emitter $S^B$ (meaning the total content of $S^B$ in the respective light-emitting layer B is equal to or less than 1% by weight).

In a preferred embodiment of the invention, the light-emitting layer B comprises 15-50% by weight, referred to the total weight of the light-emitting layer B, of the TADF material $E^B$ (meaning the total content of $E^B$ in the respective light-emitting layer B is in the range of 15-50% by weight).

In a preferred embodiment of the invention, the light-emitting layer B comprises 20-50% by weight, referred to the total weight of the light-emitting layer B, of the TADF material $E^B$ (meaning the total content of $E^B$ in the respective light-emitting layer B is in the range of 20-50% by weight).

In a preferred embodiment of the invention, the light-emitting layer B comprises 20-45% by weight, referred to the total weight of the light-emitting layer B, of the TADF material $E^B$ (meaning the total content of $E^B$ in the respective light-emitting layer B is in the range of 20-45% by weight).

*S1-T1-energy relations*

In the context of the present invention:

(i) the TADF material $E^B$ has a lowermost excited singlet state $S1^E$ with an energy level $E(S1^E)$ and a lowermost excited triplet state $T1^E$ with an energy level $E(T1^E)$; and
(ii) the small full width at half maximum (FWHM) emitter $S^B$ has a lowermost excited singlet state $S1^S$ with an energy level $E(S1^S)$ and a lowermost excited triplet state $T1^S$ with an energy level $E(T1^S)$; and
(iii) the host material $H^B$ has a lowermost excited singlet state $S1^H$ with an energy level $E(S1^H)$ and a lowermost excited triplet state $T1^H$ with an energy level $E(T1^H)$; and
(iv) the optional energy transfer component EET-2 has a lowermost excited singlet state $S1^{EET-2}$ with an energy level $E(S1^{EET-2})$ and a lowermost excited triplet state $T1^{EET-2}$ with an energy level $E(T1^{EET-2})$.

In one embodiment of the invention, the relations expressed by the following formulas (7) to (9) apply to materials comprised in the light-emitting layer B:

$$E(S1^H) > E(S1^E) \qquad (7)$$

$$E(S1^H) > E(S1^{EET-2}) \qquad (8)$$

$$E(S1^H) > E(S1^S) \qquad (9).$$

Accordingly, the lowermost excited singlet state $S1^H$ of the host material $H^B$ is preferably higher in energy than the lowermost excited singlet state $S1^E$ of the TADF material $E^B$ (formula 7) and higher in energy than the lowermost excited singlet state $S1^{EET-2}$ of the optional excitation energy transfer component EET-2 (formula 8) and higher in energy than the lowermost excited singlet state $S1^S$ of the small FWHM emitter $S^B$ (formula 9).

In one embodiment, the aforementioned relations expressed by formulas (7) to (9) apply to materials comprised in the light-emitting layer B of the organic electroluminescent device according to the invention.

In one embodiment of the invention, one or both of the relations expressed by the following formulas (10) and (11) apply to materials comprised in the same light-emitting layer B:

$$E(S1^E) > E(S1^S) \qquad (10)$$

$$E(S1^{EET-2}) > E(S1^S) \qquad (11).$$

Accordingly, the lowermost excited singlet state $S1^E$ of the TADF material $E^B$ (formula 10) and/or the lowermost excited singlet state $S1^{EET-2}$ of the optional excitation energy transfer component EET-2 (formula 11) may preferably be higher in energy than the lowermost excited singlet state $S1^S$ of the small FWHM emitter $S^B$.

In one embodiment, one or both of the aforementioned relations expressed by formulas (10) and (11) may apply to materials comprised in the light-emitting layer B of the organic electroluminescent device according to the invention.

In a preferred embodiment of the invention, the relations expressed by the following formulas (7) to (11) apply to materials comprised in the same light-emitting layer B:

$$E(S1^{H}) > E(S1^{E}) \qquad (7)$$

$$E(S1^{H}) > E(S1^{EET-2}) \qquad (8)$$

$$E(S1^{H}) > E(S1^{S}) \qquad (9)$$

$$E(S1^{E}) > E(S1^{S}) \qquad (10)$$

$$E(S1^{EET-2}) > E(S1^{S}) \qquad (11).$$

In one embodiment, the aforementioned relations expressed by formulas (7) to (11) apply to materials comprised in the light-emitting layer B of the organic electroluminescent device according to the invention.

In a preferred embodiment of the invention, the relations expressed by the following formulas (13) and (14) apply to materials comprised in the light-emitting layer B:

$$E(T1^{H}) > E(T1^{E}) \qquad (13)$$

$$E(T1^{E}) \geq E(T1^{EET-2}) \qquad (14).$$

In a preferred embodiment of the invention, the relations expressed by the following formulas (13) and (30) apply to materials comprised in the light-emitting layer B:

$$E(T1^{H}) > E(T1^{E}) \qquad (13)$$

$$E(T1^{E}) > E(S1^{S}) \qquad (30).$$

Accordingly, the lowermost excited triplet state $T1^{H}$ of the host material $H^{B}$ is preferably higher in energy than the lowermost excited triplet state $T1^{E}$ of the TADF material $E^{B}$ (formula 13); Additionally, the lowermost excited triplet state $T1^{E}$ of the TADF material $E^{B}$ is preferably equal in energy to or higher in energy than the lowermost excited triplet state $T1^{EET-2}$ of the optional excitation energy transfer component EET-2 (formula 14).

In one embodiment, the aforementioned relations expressed by formulas (13) and (14) apply to materials comprised in the light-emitting layers B of the organic electroluminescent device according to the invention.

In a preferred embodiment of the invention, the relations expressed by the following formulas (14) to (16) apply to materials comprised in the same light-emitting layer B:

$$E(T1^{E}) \geq E(T1^{EET-2}) \qquad (14)$$

$$E(T1^{EET-2}) > E(S1^{S}) \qquad (15)$$

$$E(T1^{EET-2}) > E(T1^{S}) \qquad (16).$$

Accordingly, the lowermost excited triplet state $T1^{E}$ of the TADF material $E^{B}$ is preferably equal in energy to or higher in energy than the lowermost excited triplet state $T1^{EET-2}$ of the optional excitation energy transfer component EET-2 (formula 14); the lowermost excited triplet state $T1^{EET-2}$ of the optional excitation energy transfer component EET-2 is preferably higher in energy than the lowermost excited singlet state $S1^{S}$ of the small FWHM emitter $S^{B}$ (formula 15); the lowermost excited triplet state $T1^{EET-2}$ of the optional excitation energy transfer component EET-2 is preferably higher in energy than the lowermost excited triplet state $T1^{3}$ of the small FWHM emitter $S^{B}$ (formula 16).

In one embodiment, the aforementioned relations expressed by formulas (14) to (16) apply to materials comprised in the light-emitting layer B of the organic electroluminescent device according to the invention.

In a preferred embodiment of the invention, the relations expressed by the following formulas (7) to (10) and the

following formula (15) apply:

$$E(S1^{H}) > E(S1^{E}) \quad (7)$$

$$E(S1^{H}) > E(S1^{EET\text{-}2}) \quad (8)$$

$$E(S1^{H}) > E(S1^{S}) \quad (9)$$

$$E(S1^{E}) > E(S1^{S}) \quad (10)$$

$$E(T1^{EET\text{-}2}) > E(S1^{S}) \quad (15).$$

In one embodiment, the aforementioned relations expressed by formulas (7) to (10) and formula (15) apply to materials comprised the light-emitting layer B of the organic electroluminescent device according to the invention.

In an alternative embodiment of the invention, the relations expressed by the following formulas (17) and (10) apply to materials comprised in the light-emitting layer B:

$$E(T1^{EET\text{-}2}) > E(T1^{E}) \quad (17)$$

$$E(S1^{E}) > E(S1^{S}) \quad (10).$$

Accordingly, the lowermost excited triplet state $T1^{EET-2}$ of the optional excitation energy transfer component EET-2 may be higher in energy than the lowermost excited triplet state $T1^{E}$ of the TADF material $E^{B}$ (formula 17); and the lowermost excited singlet state $S1^{E}$ of the TADF material $E^{B}$ may be higher in energy the lowermost excited singlet state $S1^{S}$ of the small FWHM emitter $S^{B}$ (formula 10).

In an alternative embodiment, the aforementioned relations expressed by formulas (17) and (10) apply to materials comprised in the light-emitting layer B of the organic electroluminescent device according to the invention.

In a preferred embodiment of the invention, the relations expressed by the following formulas (18), (15), (19), and (20) apply to materials comprised in the light-emitting layer B:

$$E(T1^{H}) > E(T1^{EET\text{-}2}) \quad (18)$$

$$E(T1^{EET\text{-}2}) > E(S1^{S}) \quad (15)$$

$$E(T1^{H}) > E(S1^{E}) \quad (19)$$

$$E(T1^{E}) > E(T1^{EET\text{-}2}) \quad (20).$$

Accordingly, the lowermost excited triplet state $T1^{H}$ the host material $H^{B}$ is preferably higher in energy than the lowermost excited triplet state $T1^{EET-2}$ of the optional excitation energy transfer component EET-2 (formula 18); and the lowermost excited triplet state $T1^{EET-2}$ of the optional excitation energy transfer component EET-2 is preferably higher in energy than the lowermost excited singlet state $S1^{S}$ of the small FWHM emitter $S^{B}$ (formula 15); and the lowermost excited triplet state $T1^{H}$ of the host material $H^{B}$ is preferably higher in energy than the lowermost excited singlet state $S1^{E}$ of the TADF material $E^{B}$ (formula 19); and the lowermost excited triplet state $T1^{E}$ of the TADF material $E^{B}$ is preferably higher in energy than the lowermost excited triplet state $T1^{EET-2}$ of the optional excitation energy transfer component EET-2 (formula 20).

In one embodiment, the aforementioned relations expressed by formulas (18), (15), (19), and (20) apply to materials comprised in the light-emitting layer B of the organic electroluminescent device according to the invention.

In one embodiment of the invention, the lowermost excited triplet state $T1^{EET-2}$ of the optional excitation energy transfer component EET-2 is equal to or higher in energy than the lowermost excited triplet state $T1^{E}$ of the TADF material $E^{B}$:

$$E(T1^{EET-2}) \geq E(T1^{E})$$

and the difference in energy $E(T1^{EET-2})$ - $E(S1^{S})$ of the lowermost excited triplet state $T1^{EET-2}$ of the optional excitation energy transfer component EET-2 and the lowermost excited singlet state $S1^{S}$ of the small FWHM emitter $S^{B}$ is equal to or smaller than 0.3 eV:

$$E(T1^{EET-2}) - E(S1^{S}) \leq 0.3 \text{ eV}.$$

In one embodiment of the invention, the lowermost excited triplet state $T1^{E}$ of the TADF material $E^{B}$ is higher in energy than the lowermost excited triplet state $T1^{EET-2}$ of the optional excitation energy transfer component EET-2:

$$E(T1^{E}) > E(T1^{EET-2})$$

and the difference in energy $E(T1^{E})$ - $E(S1^{S})$ of the lowermost excited triplet state $T1^{E}$ of the TADF material $E^{B}$ and the lowermost excited singlet state $S1^{S}$ of the small FWHM emitter $S^{B}$ is equal to or smaller than 0.3 eV:

$$E(T1^{E}) - E(S1^{S}) \leq 0.3 \text{ eV}.$$

In a preferred embodiment of the invention, the lowermost excited triplet state $T1^{EET-2}$ of the optional excitation energy transfer component EET-2 is equal to or higher in energy than the lowermost excited triplet state $T1^{E}$ of the TADF material $E^{B}$:

$$E(T1^{EET-2}) \geq E(T1^{E})$$

and the difference in energy $E(T1^{EET-2})$ - $E(S1^{S})$ of the lowermost excited triplet state $T1^{EET-2}$ of the optional excitation energy transfer component EET-2 and the lowermost excited singlet state $S1^{S}$ of the small FWHM emitter $S^{B}$ is equal to or smaller than 0.2 eV:

$$E(T1^{EET-2}) - E(S1^{S}) \leq 0.2 \text{ eV}.$$

In a preferred of the invention, the lowermost excited triplet state $T1^{E}$ of the TADF material $E^{B}$ is higher in energy than the lowermost excited triplet state $T1^{EET-2}$ of the optional excitation energy transfer component EET-2:

$$E(T1^{E}) > E(T1^{EET-2})$$

and the difference in energy $E(T1^{E})$ - $E(S1^{S})$ of the lowermost excited triplet state $T1^{E}$ of the TADF material $E^{B}$ and the lowermost excited singlet state $S1^{S}$ of the small FWHM emitter $S^{B}$ is equal to or smaller than 0.2 eV:

$$E(T1^{E}) - E(S1^{S}) \leq 0.2 \text{ eV}.$$

In one embodiment of the invention, the lowermost excited triplet state $T1^{EET-2}$ of the optional excitation energy transfer component EET-2 is equal to or higher in energy than the lowermost excited triplet state $T1^{E}$ of the TADF material $E^{B}$:

$$E(T1^{EET-2}) \geq E(T1^{E})$$

and the difference in energy $E(T1^{EET-2})$ - $E(T1^{S})$ of the lowermost excited triplet state $T1^{EET-2}$ of the optional excitation energy transfer component EET-2 and the lowermost excited triplet state $T1^{S}$ of the small FWHM emitter $S^{B}$ is equal to or smaller than 0.3 eV:

$$E(T1^{EET-2}) - E(T1^{S}) \leq 0.3 \text{ eV}.$$

In one embodiment of the invention, the lowermost excited triplet state $T1^{E}$ of the TADF material $E^{B}$ is higher in

energy than the lowermost excited triplet state $T1^{EET-2}$ of the optional excitation energy transfer component EET-2:

$$E(T1^{E}) > E(T1^{EET-2})$$

and the difference in energy $E(T1^{EET-2}) - E(T1^{S})$ of the lowermost excited triplet state $T1^{EET-2}$ of the optional excitation energy transfer component EET-2 and the lowermost excited triplet state $T1^{S}$ of the small FWHM emitter $S^{B}$ is equal to or smaller than 0.3 eV:

$$E(T1^{E}) - E(T1^{S}) \leq 0.3 \text{ eV}.$$

In one embodiment of the invention, the lowermost excited triplet state $T1^{EET-2}$ of the optional excitation energy transfer component EET-2 is higher in energy than the lowermost excited triplet state $T1^{E}$ of the TADF material $E^{B}$:

$$E(T1^{EET-2}) > E(T1^{E})$$

and and the difference in energy $E(T1^{EET-2}) - E(T1^{S})$ of the lowermost excited triplet state $T1^{EET-2}$ of the optional excitation energy transfer component EET-2 and the lowermost excited triplet state $T1^{S}$ of the small FWHM emitter $S^{B}$ is equal to or smaller than 0.2 eV:

$$E(T1^{EET-2}) - E(T1^{S}) \leq 0.2 \text{ eV}.$$

In one embodiment of the invention, the lowermost excited triplet state $T1^{E}$ of the TADF material $E^{B}$ is higher in energy than the lowermost excited triplet state $T1^{EET-2}$ of the optional excitation energy transfer component EET-2:

$$E(T1^{E}) > E(T1^{EET-2})$$

and and the difference in energy $E(T1^{EET-2}) - E(T1^{S})$ of the lowermost excited triplet state $T1^{EET-2}$ of the optional excitation energy transfer component EET-2 and the lowermost excited triplet state $T1^{S}$ of the small FWHM emitter $S^{B}$ is equal to or smaller than 0.2 eV:

$$E(T1^{EET-2}) - E(T1^{S}) \leq 0.2 \text{ eV}.$$

*HOMO-, LUMO-energy relations*

In the context of the present invention:

(i) the TADF material $E^{B}$ has a highest occupied molecular orbital $HOMO(E^{B})$ with an energy $E^{HOMO}(E^{B})$ and a lowest unoccupied molecular orbital $LUMO(E^{B})$ with an energy $E^{LUMO}(E^{B})$; and
(ii) the small full width at half maximum (FWHM) emitter $S^{B}$ has a highest occupied molecular orbital $HOMO(S^{B})$ with an energy $E^{HOMO}(S^{B})$ and a lowest unoccupied molecular orbital $LUMO(S^{B})$ with an energy $E^{LUMO}(S^{B})$; and
(iii) the host material $H^{B}$ has a highest occupied molecular orbital $HOMO(H^{B})$ with an energy $E^{HOMO}(H^{B})$ and a lowest unoccupied molecular orbital $LUMO(H^{B})$ with an energy $E^{LUMO}(H^{B})$; and
(iv) the optional excitation energy transfer component EET-2 has a highest occupied molecular orbital HOMO(EET-2) with an energy $E^{HOMO}$(EET-2) and a lowest unoccupied molecular orbital LUMO(EET-2) with an energy $E^{LUMO}$ (EET-2.

In a preferred embodiment, the relations expressed by the following formulas (1) to (3) apply to materials comprised in the light-emitting layer B:

$$E^{LUMO}(E^{B}) < E^{LUMO}(H^{B}) \qquad (1)$$

$$E^{LUMO}(E^{B}) < E^{LUMO}(EET\text{-}2) \qquad (2)$$

$$E^{LUMO}(E^B) < E^{LUMO}(S^B) \qquad (3).$$

In a preferred embodiment, the relations expressed by the following formulas (4) to (6) apply to materials comprised in the same light-emitting layer B:

$$E^{HOMO}(EET\text{-}2) \geq E^{HOMO}(H^B) \qquad (4)$$

$$E^{HOMO}(EET\text{-}2) \geq E^{HOMO}(E^B) \qquad (5)$$

$$E^{HOMO}(EET\text{-}2) \geq E^{HOMO}(S^B) \qquad (6).$$

In a preferred embodiment, the relations expressed by the aforementioned formulas (1) to (6) apply to materials comprised in the light-emitting layer B.

In one embodiment of the invention, the highest occupied molecular orbital HOMO($S^B$) of the small full width at half maximum (FWHM) emitter $S^B$ having an energy $E^{HOMO}(S^B)$ is higher in energy than the highest occupied molecular orbital HOMO($H^B$) of the host material $H^B$ having an energy $E^{HOMO}(H^B)$:

$$E^{HOMO}(S^B) > E^{HOMO}(H^B).$$

In one embodiment of the invention, the highest occupied molecular orbital HOMO($S^B$) of the small full width at half maximum (FWHM) emitter $S^B$ having an energy $E^{HOMO}(S^B)$ is higher in energy than the highest occupied molecular orbital HOMO($E^B$) of the TADF material $E^B$ having an energy $E^{HOMO}(E^B)$:

$$E^{HOMO}(S^B) > E^{HOMO}(E^B).$$

In one embodiment of the invention, the highest occupied molecular orbital HOMO(EET-2) of the optional excitation energy transfer component EET-2 having an energy $E^{HOMO}$(EET-2) is higher in energy than the highest occupied molecular orbital HOMO($E^B$) of the TADF material $E^B$ having an energy $E^{HOMO}(E^B)$:

$$E^{HOMO}(EET\text{-}2) > E^{HOMO}(E^B).$$

In one embodiment of the invention, the highest occupied molecular orbital HOMO(EET-2) of the optional excitation energy transfer component EET-2 having an energy $E^{HOMO}$(EET-2) is higher in energy than the highest occupied molecular orbital HOMO($H^B$) of the host material $H^B$ having an energy $E^{HOMO}(H^B)$:

$$E^{HOMO}(EET\text{-}2) > E^{HOMO}(H^B).$$

In one embodiment of the invention, the highest occupied molecular orbital HOMO(EET-2) of the optional excitation energy transfer component EET-2 having an energy $E^{HOMO}$(EET-2) is higher in energy than the highest occupied molecular orbital HOMO($S^B$) of the small full width at half maximum (FWHM) emitter $S^B$ having an energy $E^{HOMO}(S^B)$:

$$E^{HOMO}(EET\text{-}2) > E^{HOMO}(S^B).$$

In one embodiment of the invention, the highest occupied molecular orbital HOMO($E^B$) of the TADF material $E^B$ is equal in energy to or lower in energy than the highest occupied molecular orbital HOMO($S^B$) of the small FWHM emitter $S^B$:

$$E^{HOMO}(E^B) \leq E^{HOMO}(S^B).$$

In one embodiment of the invention, the difference (in energy) between the highest occupied molecular orbital HOMO(EET-2) of the optional excitation energy transfer component EET-2 having an energy $E^{HOMO}$(EET-2) and the highest occupied molecular orbital HOMO($S^B$) of the small full width at half maximum (FWHM) emitter $S^B$ having an energy $E^{HOMO}(S^B)$ is smaller than 0.3 eV:

$$E^{HOMO}(EET\text{-}2) - E^{HOMO}(S^B) < 0.3\ eV.$$

In one embodiment of the invention, the difference (in energy) between the highest occupied molecular orbital HOMO(EET-2) of the optional excitation energy transfer component EET-2 having an energy $E^{HOMO}(EET\text{-}2)$ and the highest occupied molecular orbital HOMO($S^B$) of the small full width at half maximum (FWHM) emitter $S^B$ having an energy $E^{HOMO}(S^B)$ is smaller than 0.2 eV:

$$E^{HOMO}(EET\text{-}2) - E^{HOMO}(S^B) < 0.2\ eV.$$

In one embodiment of the invention, the difference (in energy) between the highest occupied molecular orbital HOMO(EET-2) of the optional excitation energy transfer component EET-2 having an energy $E^{HOMO}(EET\text{-}2)$ and the highest occupied molecular orbital HOMO($S^B$) of the small full width at half maximum (FWHM) emitter $S^B$ having an energy $E^{HOMO}(S^B)$ is larger than 0.0 eV and smaller than 0.8 eV:

$$0.0\ eV < E^{HOMO}(EET\text{-}2) - E^{HOMO}(S^B) < 0.8\ eV.$$

In a preferred embodiment of the invention, the difference in energy between the highest occupied molecular orbital HOMO(EET-2) of the optional excitation energy transfer component EET-2 having an energy $E^{HOMO}(EET\text{-}2)$ and the highest occupied molecular orbital HOMO($S^B$) of the small full width at half maximum (FWHM) emitter $S^B$ having an energy $E^{HOMO}(S^B)$ is larger than 0 eV ($E^{HOMO}(EET\text{-}2) - E^{HOMO}(S^B) > 0$ eV), preferably larger than 0.1 eV ($E^{HOMO}(EET\text{-}2) - E^{HOMO}(S^B) > 0.1$ eV) , more preferably larger than 0.2 eV ($E^{HOMO}(EET\text{-}2) - E^{HOMO}(S^B) > 0.2$ eV), or even larger than 0.3 eV ($E^{HOMO}(EET\text{-}2) - E^{HOMO}(S^B) > 0.3$ eV).

In a preferred embodiment of the invention, the difference in energy between the highest occupied molecular orbital HOMO(EET-2) of the optional excitation energy transfer component EET-2 having an energy $E^{HOMO}(EET\text{-}2)$ and the highest occupied molecular orbital HOMO($E^B$) of the TADF material $E^B$ having an energy $E^{HOMO}(E^B)$ is larger than 0 eV ($E^{HOMO}(EET\text{-}2) - E^{HOMO}(E^B) > 0$ eV), preferably larger than 0.1 eV ($E^{HOMO}(EET\text{-}2) - E^{HOMO}(E^B) > 0.1$ eV), more preferably larger than 0.2 eV ($E^{HOMO}(EET\text{-}2) - E^{HOMO}(E^B) > 0.2$ eV), more preferably larger than 0.3 eV ($E^{HOMO}(EET\text{-}2) - E^{HOMO}(E^B) > 0.3$ eV), even more preferably larger than 0.4 eV ($E^{HOMO}(EET\text{-}2) - E^{HOMO}(E^B) > 0.4$ eV), in particular larger than 0.5 eV ($E^{HOMO}(EET\text{-}2) - E^{HOMO}(E^B) > 0.5$ eV).

In a preferred embodiment of the invention, the difference in energy between the highest occupied molecular orbital HOMO(EET-2) of the optional excitation energy transfer component EET-2 having an energy $E^{HOMO}(EET\text{-}2)$ and the highest occupied molecular orbital HOMO($H^B$) of the host material $H^B$ having an energy $E^{HOMO}(H^B)$ is larger than 0 eV ($E^{HOMO}(EET\text{-}2) - E^{HOMO}(H^B) > 0$ eV), preferably larger than 0.1 eV ($E^{HOMO}(EET\text{-}2) - E^{HOMO}(H^B) > 0.1$ eV), more preferably larger than 0.2 eV ($E^{HOMO}(EET\text{-}2) - E^{HOMO}(H^B) > 0.2$ eV), more preferably larger than 0.3 eV ($E^{HOMO}(EET\text{-}2) - E^{HOMO}(H^B) > 0.3$ eV), even more preferably larger than 0.4 eV ($E^{HOMO}(EET\text{-}2) - E^{HOMO}(H^B) > 0.4$ eV), in particular larger than 0.5 eV ($E^{HOMO}(EET\text{-}2) - E^{HOMO}(H^B) > 0.5$ eV).

In one embodiment of the invention, the difference in energy between the lowest unoccupied molecular orbital LUMO($S^B$) of the small full width at half maximum (FWHM) emitter $S^B$ having an energy $E^{LUMO}(S^B)$ and the lowest unoccupied molecular orbital LUMO($E^B$) of the TADF material having an energy $E^{LUMO}(E^B)$ is larger than 0.0 eV and smaller than 0.3 eV:

$$0.0\ eV < E^{LUMO}(S^B) – E^{LUMO}(E^B) < 0.3\ eV.$$

In a preferred embodiment of the invention, the difference in energy between the lowest unoccupied molecular orbital LUMO($S^B$) of the small FWHM emitter $S^B$ having an energy $E^{LUMO}(S^B)$ and the lowest unoccupied molecular orbital LUMO($E^B$) of the TADF material $E^B$ having an energy $E^{LUMO}(E^B)$ is larger than 0 eV (ELUMO($S^B$) - $E^{LUMO}(E^B) > 0$ eV), preferably larger than 0.1 eV (ELUMO($S^B$) - $E^{LUMO}(E^B) > 0.1$ eV) , more preferably larger than 0.2 eV (ELUMO($S^B$) - $E^{LUMO}(E^B) > 0.2$ eV), particularly preferably larger than 0.3 eV (ELUMO($S^B$) - $E^{LUMO}(E^B) > 0.3$ eV).

In a preferred embodiment of the invention, the difference in energy between the lowest unoccupied molecular orbital LUMO(EET-2) of the optional excitation energy transfer component EET-2 having an energy $E^{LUMO}(EET\text{-}2)$ and the lowest unoccupied molecular orbital LUMO($E^B$) of the TADF material $E^B$ having an energy $E^{LUMO}(E^B)$ is larger than 0 eV ($E^{LUMO}(EET\text{-}2) - E^{LUMO}(E^B) > 0$ eV), preferably larger than 0.1 eV ($E^{LUMO}(EET\text{-}2) - E^{LUMO}(E^B) > 0.1$ eV), more preferably larger than 0.2 eV ($E^{LUMO}(EET\text{-}2) - E^{LUMO}(E^B) > 0.2$ eV), more preferably larger than 0.3 eV ($E^{LUMO}(EET\text{-}2) - E^{LUMO}(E^B) > 0.3$ eV), even more preferably larger than 0.4 eV ($E^{LUMO}(EET\text{-}2) - E^{LUMO}(E^B) > 0.4$ eV), in particular larger than 0.5 eV ($E^{LUMO}(EET\text{-}2) - E^{LUMO}(E^B) > 0.5$ eV).

In a preferred embodiment of the invention, the difference in energy between the lowest unoccupied molecular

orbital LUMO($H^B$) of at least one, preferably each, host material $H^B$ having an energy $E^{LUMO}(H^B)$ and the lowest unoccupied molecular orbital LUMO($E^B$) of the TADF material $E^B$ having an energy $E^{LUMO}(E^B)$ is larger than 0 eV ($E^{LUMO}(H^B) - E^{LUMO}(E^B) > 0$ eV), preferably larger than 0.1 eV ($E^{LUMO}(H^B) - E^{LUMO}(E^B) > 0.1$ eV), more preferably larger than 0.2 eV ($E^{LUMO}(H^B) - E^{LUMO}(E^B) > 0.2$ eV), more preferably larger than 0.3 eV ($E^{LUMO}(H^B) - E^{LUMO}(E^B) > 0.3$ eV), even more preferably larger than 0.4 eV ($E^{LUMO}(H^B) - E^{LUMO}(E^B) > 0.4$ eV), in particular larger than 0.5 eV ($E^{LUMO}(H^B) - E^{LUMO}(E^B) > 0.5$ eV).

*Relations of emission maxima*

In one embodiment of the invention, one or both of the relations expressed by formulas (21) and (22) apply to materials comprised in the light-emitting layer B:

$$|E^{\lambda max}(EET\text{-}2) - E^{\lambda max}(S^B)| < 0.30 \text{ eV} \qquad (21),$$

$$|E^{\lambda max}(E^B) - E^{\lambda max}(S^B)| < 0.30 \text{ eV} \qquad (22),$$

which means: Within the light-emitting layer B, the difference in energy between the energy of the emission maximum $E^{\lambda max}$(EET-2) of the optional excitation energy transfer component EET-2 given in electron volts (eV) and the energy of the emission maximum $E^{\lambda max}(S^B)$ of the small FWHM emitter $S^B$ given in electron volts (eV) is smaller than 0.30 eV (formula 21); and/or: The difference in energy between the energy of the emission maximum $E^{\lambda max}(E^B)$ of the TADF material $E^B$ given in electron volts (eV) and the energy of the emission maximum $E^{\lambda max}(S^B)$ of the small FWHM emitter $S^B$ given in electron volts (eV) is smaller than 0.30 eV (formula 22).

In one embodiment, one or both of the aforementioned relations expressed by formulas (21) and (22) apply to materials comprised the light-emitting layer B of the organic electroluminescent device according to the invention.

In a preferred embodiment of the invention, one or both of the relations expressed by formulas (23) and (24) apply to materials comprised in the light-emitting layer B:

$$|E^{\lambda max}(EET\text{-}2) - E^{\lambda max}(S^B)| < 0.20 \text{ eV} \qquad (23),$$

$$|E^{\lambda max}(E^B) - E^{\lambda max}(S^B)| < 0.20 \text{ eV} \qquad (24),$$

which means: Within the light-emitting layer B, the difference in energy between the energy of the emission maximum $E^{\lambda max}$(EET-2) of the optional excitation energy transfer component EET-2 given in electron volts (eV) and the energy of the emission maximum $E^{\lambda max}(S^B)$ of the small FWHM emitter $S^B$ given in electron volts (eV) is smaller than 0.20 eV (formula 23); and/or: The difference in energy between the energy of the emission maximum $E^{\lambda max}(E^B)$ of the TADF material $E^B$ given in electron volts (eV) and the energy of the emission maximum $E^{\lambda max}(S^B)$ of the small FWHM emitter $S^B$ given in electron volts (eV) is smaller than 0.20 eV (formula 24).

In one embodiment, one or both of the aforementioned relations expressed by formulas (23) and (24) apply to materials comprised in the light-emitting layers B of the organic electroluminescent device according to the invention.

In an even more preferred embodiment of the invention, one or both of the relations expressed by formulas (25) and (26) apply to materials comprised in the light-emitting layer B:

$$|E^{\lambda max}(EET\text{-}2) - E^{\lambda max}(S^B)| < 0.10 \text{ eV} \qquad (25),$$

$$|E^{\lambda max}(E^B) - E^{\lambda max}(S^B)| < 0.10 \text{ eV} \qquad (26),$$

which means: Within the light-emitting layer B, the difference in energy between the energy of the emission maximum $E^{\lambda max}$(EET-2) of the optional excitation energy transfer component EET-2 given in electron volts (eV) and the energy of the emission maximum $E^{\lambda max}(S^B)$ of the small FWHM emitter $S^B$ given in electron volts (eV) is smaller than 0.10 eV (formula 25); and/or: The difference in energy between the energy of the emission maximum $E^{\lambda max}(E^B)$ of the TADF material $E^B$ given in electron volts (eV) and the energy of the emission maximum $E^{\lambda max}(S^B)$ of the small FWHM emitter $S^B$ given in electron volts (eV) is smaller than 0.10 eV (formula 26).

In one embodiment, the aforementioned relations expressed by formulas (25) and (26) apply to materials comprised in the light-emitting layer B of the organic electroluminescent device according to the invention.

In one embodiment of the invention, the relation expressed by formula (27) applies to materials comprised in the light-emitting layer B:

$$E^{\lambda max}(EET\text{-}2) > E^{\lambda max}(S^B) \quad (27),$$

which means that, within the light-emitting layer B, the energy of the emission maximum $E^{\lambda max}$(EET-2) of the optional excitation energy transfer component EET-2 given in electron volts (eV) is larger than the energy of the emission maximum $E^{\lambda max}(S^B)$ of the small FWHM emitter $S^B$ given in electron volts (eV).

In one embodiment of the invention, the relation expressed by formula (28) applies to materials comprised in the light-emitting layer B:

$$E^{\lambda max}(E^B) > E^{\lambda max}(S^B) \qquad (28),$$

which means that, within the light-emitting layer B, the energy of the emission maximum $E^{\lambda max}(E^B)$ of the TADF material $E^B$ given in electron volts (eV) is larger than the energy of the emission maximum $E^{\lambda max}(S^B)$ of the small FWHM emitter $S^B$ given in electron volts (eV).

*Device Colors & Performance*

A further embodiment of the present invention relates to an electroluminescent device (e.g., an OLED), which exhibits an external quantum efficiency at 1000 cd/m$^2$ of more than 10%, more preferably of more than 13%, more preferably of more than 15%, even more preferably of more than 18% or even more than 20% and exhibits an emission maximum between 500 nm and 560 nm.

A further embodiment of the present invention relates to an electroluminescent device (e.g., an OLED), which exhibits an external quantum efficiency at 1000 cd/m$^2$ of more than 10%, more preferably of more than 13%, more preferably of more than 15%, even more preferably of more than 18% or even more than 20% and exhibits an emission maximum between 510 nm and 550 nm.

A further embodiment of the present invention relates to an electroluminescent device (e.g., an OLED) which exhibits an external quantum efficiency at 1000 cd/m$^2$ of more than 10%, more preferably of more than 13%, more preferably of more than 15%, even more preferably of more than 18% or even more than 20% and exhibits an emission maximum between 515 nm and 540 nm.

In a preferred embodiment, the electroluminescent device (e.g., an OLED) exhibits a LT95 value at constant current density $J_0$ = 15 mA/cm$^2$ of more than 100 h, preferably more than 200 h, more preferably more than 300 h, even more preferably more than 400 h, still even more preferably more than 750 h or even more than 1000 h.

A further embodiment of the present invention relates to an electroluminescent device (e.g., an OLED), which emits light at a distinct color point. According to the present invention, the electroluminescent device (e.g., OLED) emits light with a narrow emission band (small full width at half maximum (FWHM)). In a preferred embodiment, the electroluminescent device (e.g., OLED) according to the invention emits light with a FWHM of the main emission peak of below 0.25 eV, more preferably of below 0.20 eV, even more preferably of below 0.15 eV or even below 0.13 eV.A further embodiment of the present invention relates to an electroluminescent device (e.g., an OLED), which emits light with CIEx and CIEy color coordinates close to the CIEx (= 0.170) and CIEy (= 0.797) color coordinates of the primary color green (CIEx = 0.170 and CIEy = 0.797) as defined by ITU-R Recommendation BT.2020 (Rec. 2020) and thus may be suited for the use in Ultra High Definition (UHD) displays, e.g. UHD-TVs. In this context, the term "close to" refers to the ranges of CIEx and CIEy coordinates provided at the end of this paragraph. In commercial applications, typically top-emitting (top-electrode is typically transparent) devices are used, whereas test devices as used throughout the present application represent bottom-emitting devices (bottom-electrode and substrate are transparent). Accordingly, a further aspect of the present invention relates to an electroluminescent device (e.g., an OLED), whose emission exhibits a CIEx color coordinate of between 0.15 and 0.45 preferably between 0.15 and 0.35, more preferably between 0.15 and 0.30 or even more preferably between 0.15 and 0.25 or even between 0.15 and 0.20 and/ or a CIEy color coordinate of between 0.60 and 0.92, preferably between 0.65 and 0.90, more preferably between 0.70 and 0.88 or even more preferably between 0.75 and 0.86 or even between 0.79 and 0.84.

A further embodiment of the present invention relates to an OLED, which emits light with CIEx and CIEy color coordinates close to the CIEx (= 0.265) and CIEy (= 0.65) color coordinates of the primary color green (CIEx = 0.265 and CIEy = 0.65) as defined by DCIP3. In this context, the term "close to" refers to the ranges of CIEx and CIEy coordinates provided at the end of this paragraph. In commercial applications, typically top-emitting (top-electrode is typically transparent) devices are used, whereas test devices as used throughout the present application represent bottom-emitting devices (bottom-electrode and substrate are transparent). Accordingly, a further aspect of the present invention

relates to an OLED, whose bottom emission exhibits a CIEx color coordinate of between 0.2 and 0.45 preferably between 0.2 and 0.35 or more preferably between 0.2 and 0.30 or even more preferably between 0.24 and 0.28 or even between 0.25 and 0.27 and/ or a CIEy color coordinate of between 0.60 and 0.9, preferably between 0.6 and 0.8, more preferably between 0.60 and 0.70 or even more preferably between 0.62 and 0.68 or even between 0.64 and 0.66.

A further embodiment of the present invention relates to an electroluminescent device (e.g., an OLED), which emits light at a distinct color point. According to the present invention, the electroluminescent device (e.g., OLED) emits light with a narrow emission band (small full width at half maximum (FWHM)). In a preferred embodiment, the electroluminescent device (e.g., OLED) according to the invention emits light with a FWHM of the main emission peak of below 0.25 eV, more preferably of below 0.20 eV, even more preferably of below 0.15 eV or even below 0.13 eV.

One of the purposes of interest of an organic electroluminescent device may be the generation of light. Thus, the present invention further relates to a method for generating light of a desired wavelength range, comprising the step of providing an organic electroluminescent device according to any the present invention.

Accordingly, a further aspect of the present invention relates to a method for generating light of a desired wavelength range, comprising the steps of

(i) providing an organic electroluminescent device according to the present invention; and
(ii) applying an electrical current to said organic electroluminescent device.

A further aspect of the present invention relates to a process of making the organic electroluminescent devices by assembling the elements described above. The present invention also relates to a method for generating green light, in particular by using said organic electroluminescent device.

A further aspect of the invention relates to an organic electroluminescent device, wherein the following formula (29) applies to materials comprised in the light-emitting layer B:

$$510\ \text{nm} \leq \lambda_{max}(S^B) \leq 550\ \text{nm} \qquad (29)$$

wherein $\lambda_{max}(S^B)$ is the emission maximum of the small FWHM emitter $S^B$ and is given in nanometers (nm).

A further aspect of the invention relates to a method for generating light, comprising the steps of:

(i) providing an organic electroluminescent device according to the present invention
(ii) applying an electrical current to said organic electroluminescent device.

A further aspect of the invention relates to a method for generating light, comprising the steps of:

(i) providing an organic electroluminescent device according to the present invention
(ii) applying an electrical current to said organic electroluminescent device, wherein the method is for generating light at a wavelength range from 510 nm to 550 nm.

A further aspect of the invention relates to a method for generating light, comprising the steps of:

(i) providing an organic electroluminescent device according to the present invention
(ii) applying an electrical current to said organic electroluminescent device, wherein the method is for generating light at a wavelength range from 515 nm to 540 nm.

A further aspect of the invention relates to a method for generating light, comprising the steps of:

(i) providing an organic electroluminescent device according to the present invention
(ii) applying an electrical current to said organic electroluminescent device, wherein the method is for generating light at a wavelength range from 515 nm to 540 nm.

The skilled artisan understands that, depending on their structure, the TADF material $E^B$ (vide infra) and the excitation energy transfer components EET-2 (vide infra) may be used as emitters in organic electroluminescent devices. However, preferably, in the organic electroluminescent device according to the present invention, the main function of the TADF material $E^B$ and the excitation energy transfer components EET-2 is not the emission of light. In a preferred embodiment, upon applying a voltage (and electrical current), the organic electroluminescent device according to the invention emits light, wherein this emission is mainly (i.e. to an extent of more than 50%, preferably of more than 60%, more preferably of more than 70%, even more preferably of more than 80% or even of more than 90%) attributed to fluorescent

light emitted by the small FWHM emitters $S^B$. In consequence, the organic electroluminescent device according to the present invention preferably also displays a narrow emission, which is expressed by a small FWHM of the main emission peak of below 0.25 eV, more preferably of below 0.20 eV, even more preferably of below 0.15 eV or even below 0.13 eV.

In a preferred embodiment of the invention, the relation expressed by the following formula (32) applies:

$$\frac{\mathrm{FWHM}^{D}}{\mathrm{FWHM}^{SB}} \leq 1.50 \qquad (32),$$

wherein

FWHM$^D$ refers to the full width at half maximum (FWHM) in electron volts (eV) of the main emission peak of the organic electroluminescent device according to the present invention; and

FWHM$^{SB}$ represents the FWHM in electron volts (eV) of the photoluminescence spectrum (fluorescence spectrum, measured at room temperature, i.e. (approximately) 20°C) of a spin coated film of the one or more small FWHM emitters $S^B$ in the one or more host materials $H^B$ used in the light-emitting layer (EML) of the organic electroluminescent device with the FWHM of FWHM$^D$. This is to say that the spin-coated film from which FWHM$^{SB}$ is determined preferably comprises the same small FWHM emitter or emitters $S^B$ in the same weight ratios as the light-emitting layer B of the organic electroluminescent device.

If, for example, the light-emitting layer B comprises two small FWHM emitters $S^B$ with a concentration of 1% by weight each, the spin-coated film preferably also comprises 1% by weight of each of the two small FWHM emitters $S^B$. In this exemplary case, the matrix material of the spin-coated film would amount to 98% by weight of the spin-coated film. This matrix material of the spin-coated film may be selected to reflect the weight-ratio of the host materials $H^B$ comprised in the light-emitting layer B of the organic electroluminescent device. If, in the aforementioned example, the light-emitting layer B comprises a single host material $H^B$, this host material would preferably be the sole matrix material of the spin-coated film. If, however, in the aforementioned example, the light-emitting layer B comprises two host materials $H^B$, one with a content of 60% by weight and the other with a content of 20% by weight (i.e. in a ratio of 3:1), the aforementioned matrix material of the spin-coated film (comprising 1% by weight of each of the two small FWHM emitters $S^B$) would preferably be a 3:1-mixture of the two host materials $H^B$ as present in the EML.

If more than one light-emitting layer B is contained in an organic electroluminescent device according to the present invention, the relation expressed by the aforementioned formula (32) preferably applies to all light-emitting layers B comprised in the device.

In one embodiment, the light-emitting layer B of the organic electroluminescent device according to the present invention, the aforementioned ratio FWHM$^D$:FWHM$^{SB}$ is equal to or smaller than 1.50, preferably 1.40, even more preferably 1.30, still even more preferably 1.20, or even 1.10.

It should be noted that for the selection of fluorescent emitters for the use as small FWHM emitter $S^B$ in the context of the present invention, the FWHM value may be determined as described in a later subchapter of this text (briefly: preferably from a spin-coated film of the respective emitter in poly(methyl methacrylate) PMMA with a concentration of 1-5% by weight, in particular 2% by weight, or from a solution, vide infra). This is to say that the FWHM values of the exemplary small FWHM emitters $S^B$ listed in Table 1S may not be understood as FWHM$^{SB}$ values in the context of equation (32) and the associated preferred embodiments of the present invention.

The examples and claims further illustrate the invention.

*Host material(s) $H^B$*

According to the invention, any of the one or more host materials $H^B$ comprised in any of the one or more light-emitting layers B may be a p-host $H^P$ exhibiting high hole mobility, an n-host $H^N$ exhibiting high electron mobility, or a bipolar host material $H^{BP}$ exhibiting both, high hole mobility and high electron mobility.

An n-host $H^N$ exhibiting high electron mobility in the context of the present invention preferably has a LUMO energy $E^{LUMO}(H^N)$ equal to or smaller than -2.50 eV ($E^{LUMO}(H^N) \leq -2.50$ eV), preferably $E^{LUMO}(H^N) \leq -2.60$ eV, more preferably $E^{LUMO}(H^N) \leq -2.65$ eV, and even more preferably $E^{LUMO}(H^N) \leq -2.70$ eV. The LUMO is the lowest unoccupied molecular orbital. The energy of the LUMO is determined as described in a later subchapter of this text.

A p-host $H^P$ exhibiting high hole mobility in the context of the present invention preferably has a HOMO energy $E^{HOMO}(H^P)$ equal to or higher than -6.30 eV ($E^{HOMO}(H^P) \geq -6.30$ eV), preferably $E^{HOMO}(H^P) \geq -5.90$ eV, more preferably $E^{HOMO}(H^P) \geq -5.70$ eV, even more preferably $E^{HOMO}(H^P) \geq -5.40$ eV. The HOMO is the highest occupied molecular orbital. The energy of the HOMO is determined as described in a later subchapter of this text.

In a preferred embodiment of the invention, in each light-emitting layer B of an organic electroluminescent device according to the present invention, at least one, preferably each, host material $H^B$ is a p-host $H^P$ which has a HOMO energy

$E^{HOMO}(H^P)$ equal to or higher than -6.30 eV ($E^{HOMO}(H^P) \geq -6.30$ eV), preferably $E^{HOMO}(H^P) \geq -5.90$ eV, more preferably $E^{HOMO}(H^P) \geq -5.70$ eV, and even more preferably $E^{HOMO}(H^P) \geq -5.40$ eV. The HOMO is the highest occupied molecular orbital.

In one embodiment of the invention, within each light-emitting layer B, at least one, preferably each p-host $H^P$ comprised in a light-emitting layer B has a HOMO energy $E^{HOMO}(H^P)$ smaller than -5.60 eV.

A bipolar host $H^{BP}$ exhibiting high electron mobility in the context of the present invention preferably has a LUMO energy $E^{LUMO}(H^{BP})$ equal to or smaller than - 2.50 eV ($E^{LUMO}(H^{BP}) \leq -2.50$ eV), preferably $E^{LUMO}(H^{BP}) \leq -2.60$ eV, more preferably $E^{LUMO}(H^{BP}) \leq -2.65$ eV, and even more preferably $E^{LUMO}(H^{BP}) \leq -2.70$ eV. The LUMO is the lowest unoccupied molecular orbital. The energy of the LUMO is determined as described in a later subchapter of this text.

A bipolar host $H^{BP}$ exhibiting high hole mobility in the context of the present invention preferably has a HOMO energy $E^{HOMO}(H^{BP})$ equal to or higher than -6.30 eV ($E^{HOMO}(H^{BP}) \geq -6.30$ eV), preferably $E^{HOMO}(H^{BP}) \geq -5.90$ eV, more preferably $E^{HOMO}(H^{BP}) \geq -5.70$ eV and still even more preferably $E^{HOMO}(H^{BP}) \geq -5.40$ eV. The HOMO is the highest occupied molecular orbital. The energy of the HOMO is determined as described in a later subchapter of this text.

In one embodiment of the invention, a bipolar host material $H^{BP}$, preferably each bipolar host material $H^{BP}$, fulfills both of the following requirements:

(i) it has a LUMO energy $E^{LUMO}(H^{BP})$ equal to or smaller than -2.50 eV ($E^{LUMO}(H^{BP}) \leq -2.50$ eV), preferably $E^{LUMO}(H^{BP}) \leq -2.60$ eV, more preferably $E^{LUMO}(H^{BP}) \leq -2.65$ eV, and even more preferably $E^{LUMO}(H^{BP}) \leq -2.70$ eV; and
(ii) it has a HOMO energy $E^{HOMO}(H^{BP})$ equal to or higher than -6.30 eV ($E^{HOMO}(H^{BP}) \geq -6.30$ eV), preferably $E^{HOMO}(H^{BP}) \geq -5.90$ eV, more preferably $E^{HOMO}(H^{BP}) \geq -5.70$ eV, and still even more preferably $E^{HOMO}(H^{BP}) \geq -5.40$ eV.

The person skilled in the art knows which materials are suitable host materials for use in organic electroluminescent devices such as those of the present invention. See for example: Y. Tao, C. Yang, J. Quin, Chemical Society Reviews 2011, 40, 2943, DOI: 10.1039/C0CS00160K; K.S. Yook, J.Y. Lee, The Chemical Record 2015, 16(1), 159, DOI: 10.1002/tcr.201500221; T. Chatterjee, K.-T. Wong, Advanced Optical Materials 2018, 7(1), 1800565, DOI: 10.1002/adom.201800565; Q. Wang, Q.-S. Tian, Y.-L. Zhang, X. Tang, L.-S. Liao, Journal of Materials Chemistry C 2019, 7, 11329, DOI: 10.1039/C9TC03092A.

Furthermore, for example, US2006006365 (A1), US2006208221 (A1), US2005069729 (A1), EP1205527 (A1), US2009302752 (A1), US20090134784 (A1), US2009302742 (A1), US2010187977 (A1), US2010187977 (A1), US2012068170 (A1), US2012097899 (A1), US2006121308 (A1), US2006121308 (A1), US2009167166 (A1), US2007176147 (A1), US2015322091 (A1), US2011105778 (A1), US2011201778 (A1), US2011121274 (A1), US2009302742 (A1), US2010187977 (A1), US2010244009 (A1), US2009136779 (A1), EP2182040 (A2), US2012202997 (A1), US2019393424 (A1), US2019393425 (A1), US2020168819 (A1), US2020079762 (A1), and US2012292576 (A1) disclose host materials that may be used in organic electroluminescent devices according to the present invention. It is understood that this does not imply that the present invention is limited to organic electroluminescent devices comprising host materials disclosed in the cited references. It is also understood that any host materials used in the state of the art may also be suitable host materials $H^B$ in the context of the present invention.

In a preferred embodiment of the invention, each light-emitting layer B of the organic electroluminescent device according to the invention comprises one or more p-hosts $H^P$. In one embodiment of the invention, each light-emitting layer B of the organic electroluminescent device according to the invention comprises only a single host material $H^B$ and this host material is a p-host $H^P$.

In one embodiment of the invention, each light-emitting layer B of the organic electroluminescent device according to the invention comprises one or more n-hosts $H^N$. In another embodiment of the invention, each light-emitting layer B of the organic electroluminescent device according to the invention comprises only a single host material $H^B$ and this host material is an n-host $H^N$.

In one embodiment of the invention, each light-emitting layer B of the organic electroluminescent device according to the invention comprises one or more bipolar hosts $H^{BP}$. In one embodiment of the invention, each light-emitting layer B of the organic electroluminescent device according to the invention comprises only a single host material $H^B$ and this host material is a bipolar host $H^{BP}$.

In another embodiment of the invention, at least one light-emitting layer B of the organic electroluminescent device according to the invention comprises at least two different host materials $H^B$. In this case, the more than one host materials $H^B$ present in the respective light-emitting layer B may either all be p-hosts $H^P$ or all be n-hosts $H^N$, or all be bipolar hosts $H^{BP}$, but may also be a combination thereof.

It is understood that, if an organic electroluminescent device according to the invention comprises more than one light-emitting layers B, any of them may, independently of the one or more other light-emitting layers B, comprise either one host material $H^B$ or more than one host materials $H^B$ for which the above-mentioned definitions apply. It is further understood that different light-emitting layers B comprised in an organic electroluminescent device according to the invention do not necessarily all comprise the same materials or even the same materials in the same concentrations or

ratios.

It is understood that, if a light-emitting layer B of the organic electroluminescent device according to the invention is composed of more than one sublayers, any of them may, independently of the one or more other sublayers, comprise either one host material $H^B$ or more than one host materials $H^B$ for which the above-mentioned definitions apply. It is further understood that different sublayers of a light-emitting layer B comprised in an organic electroluminescent device according to the invention do not necessarily all comprise the same materials or even the same materials in the same concentrations or ratios.

If comprised in the same light-emitting layer B of the organic electroluminescent device according to the invention, at least one p-host $H^P$ and at least one n-host $H^N$ may optionally form an exciplex. The person skilled in the art knows how to choose pairs of $H^P$ and $H^N$, which form an exciplex and the selection criteria, including HOMO- and/or LUMO-energy level requirements of $H^P$ and $H^N$. This is to say that, in case exciplex formation may be aspired, the highest occupied molecular orbital (HOMO) of the p-host material $H^P$ may be at least 0.20 eV higher in energy than the HOMO of the n-host material $H^N$ and the lowest unoccupied molecular orbital (LUMO) of the p-host material $H^P$ may be at least 0.20 eV higher in energy than the LUMO of the n-host material $H^N$.

In a preferred embodiment of the invention, at least one host material $H^B$ (e.g., $H^P$, $H^N$, and/or $H^{BP}$) is an organic host material, which, in the context of the invention, means that it does not contain any transition metals. In a preferred embodiment of the invention, all host materials $H^B$ ($H^P$, $H^N$, and/or $H^{BP}$) in the electroluminescent device of the present invention are organic host materials, which, in the context of the invention, means that they do not contain any transition metals. Preferably, at least one host material $H^B$, more preferably all host materials $H^B$ ($H^P$, $H^N$ and/or $H^{BP}$) predominantly consist of the elements hydrogen (H), carbon (C), and nitrogen (N), but may for example also comprise oxygen (O), boron (B), silicon (Si), fluorine (F), and bromine (Br).

In one embodiment of the invention, each host material $H^B$ is a p-host $H^P$.

In one embodiment of the organic electroluminescent device according to the present invention, in at least one, preferably each, light-emitting layer B, each host material $H^B$ is a p-host $H^P$.

In a preferred embodiment of the invention, a p-host $H^P$, optionally comprised in any of the one or more light-emitting layers B as a whole (consisting of one (sub)layer or comprising more than one sublayers), comprises or consists of:

- one first chemical moiety, comprising or consisting of a structure according to any of the formulas $H^P$-I, $H^P$-II, $H^P$-III, $H^P$-IV, $H^P$-V, $H^P$-VI, $H^P$-VII, $H^P$-VIII, $H^P$-IX, and $H^P$-X:

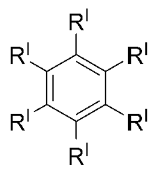

Formula $H^P$-I

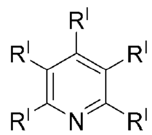

Formula $H^P$-II

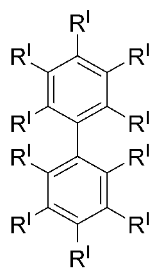

Formula $H^P$-III

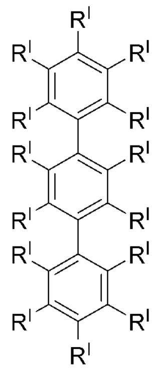

Formula $H^P$-IV

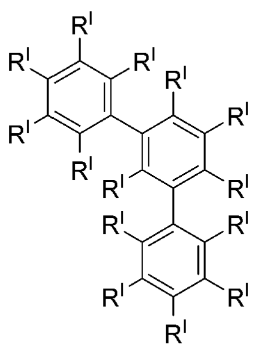

Formula $H^P$-V

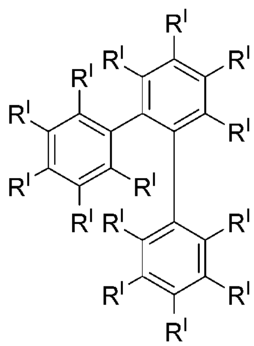

Formula $H^P$-VI

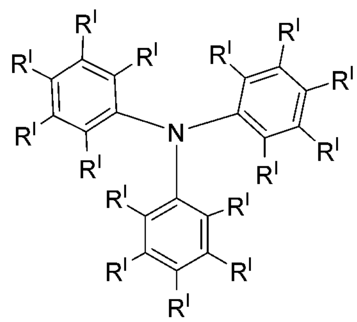

Formula $H^P$-VII

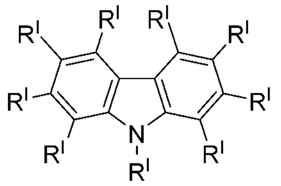
Formula $H^P$-VIII

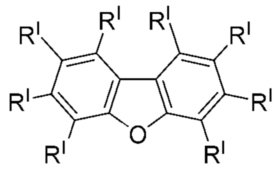
Formula $H^P$-IX

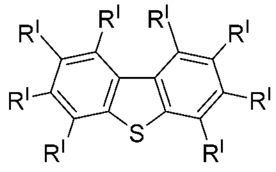
Formula $H^P$-X

and

- one or more second chemical moieties, each comprising or consisting of a structure according to any of formulas $H^P$-XI, $H^P$-XII, $H^P$-XIII, $H^P$-XIV, $H^P$-XV, $H^P$-XVI, $H^P$-XVII, $H^P$-XVIII, and $H^P$-XIX:

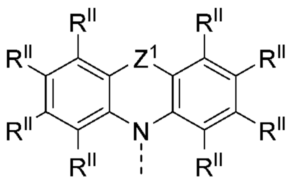
Formula $H^P$-XI

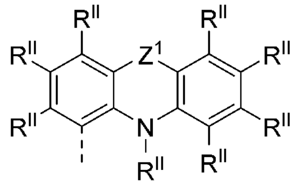
Formula $H^P$-XII

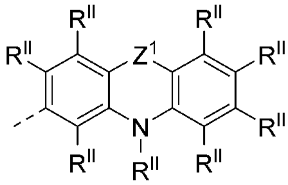
Formula $H^P$-XIII

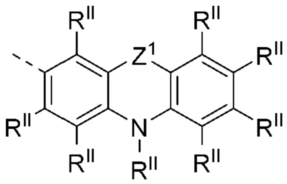
Formula $H^P$-XIV

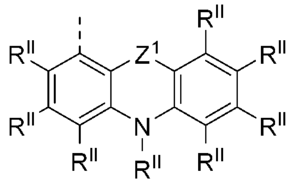
Formula $H^P$-XV

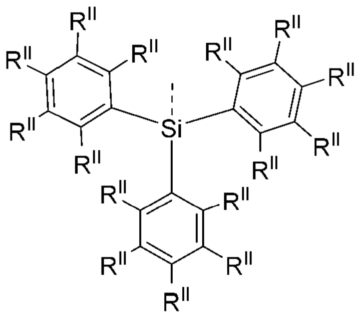
Formula $H^P$-XVI

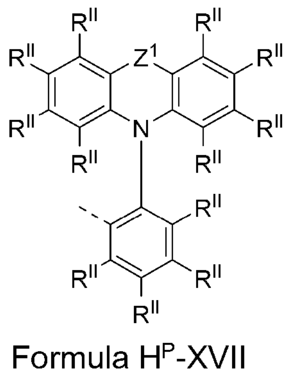
Formula $H^P$-XVII

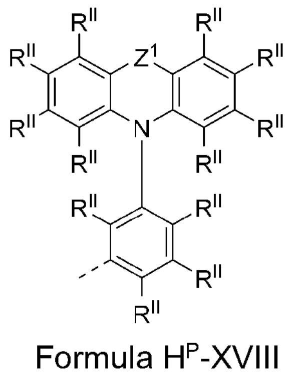
Formula $H^P$-XVIII

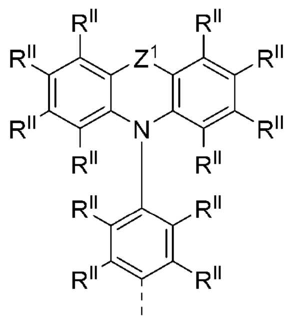
Formula $H^P$-XIX,

wherein each of the one or more second chemical moieties which is present in the p-host material $H^P$ is linked to the first chemical moiety via a single bond which is represented in the formulas above by a dashed line;

wherein

$Z^1$ is at each occurrence independently of each other selected from the group consisting of a direct bond, $C(R^{II})_2$, $C=C(R^{II})_2$, C=O, $C=NR^{II}$, $NR^{II}$, O, $Si(R^{II})_2$, S, S(O) and $S(O)_2$;

$R^I$ is at each occurrence independently of each other a binding site of a single bond linking the first chemical moiety to a second chemical moiety or is selected from the group consisting of: hydrogen, deuterium, Me, $^i$Pr, and $^t$Bu, and Ph, which is optionally substituted with one or more substituents independently of each other selected from the group consisting of: Me, $^i$Pr, $^t$Bu, and Ph;

wherein at least one $R^I$ is a binding site of a single bond linking the first chemical moiety to a second chemical moiety;

$R^{II}$ is at each occurrence independently of each other selected from the group consisting of: hydrogen, deuterium, Me,

iPr, tBu, and

Ph, which is optionally substituted with one or more substituents independently of each other selected from the group consisting of: Me, iPr, tBu, and Ph;

wherein two or more adjacent substituents $R^{II}$ may optionally form a mono- or polycyclic, aliphatic or aromatic or heteroaromatic, carbo- or heterocyclic ring system so that the fused ring system consisting of a structure according to any of formulas $H^P$-XI, $H^P$-XII, $H^P$-XIII, $H^P$-XIV, $H^P$-XV, $H^P$-XVI, $H^P$-XVII, $H^P$-XVIII, and $H^P$-XIX as well as the additional rings optionally formed by adjacent substituents $R^{II}$ comprises in total 8-60 carbon atoms preferably 12-40 carbon atoms, more preferably 14-32 carbon atoms.

In an even more preferred embodiment of the invention, $Z^1$ is at each occurrence a direct bond and adjacent substituents $R^{II}$ do not combine to form an additional ring system.

In a still even more preferred embodiment of the invention, a p-host $H^P$ optionally comprised in the organic electroluminescent device according to the invention is selected from the group consisting of the following structures:

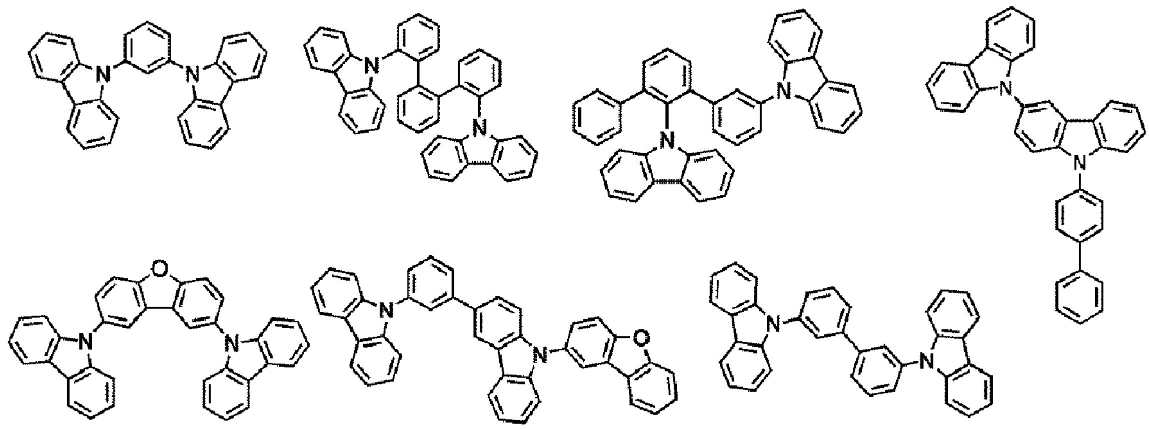

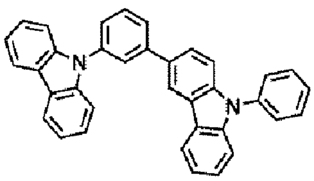

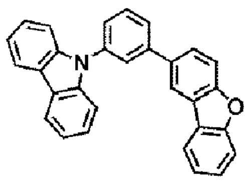

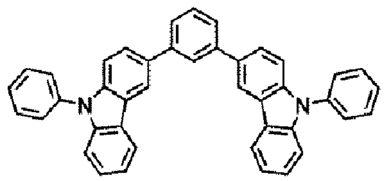

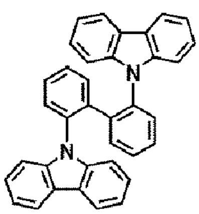

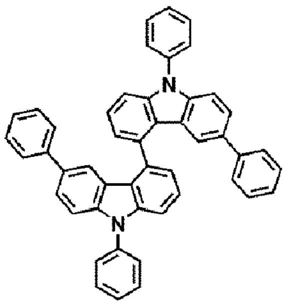

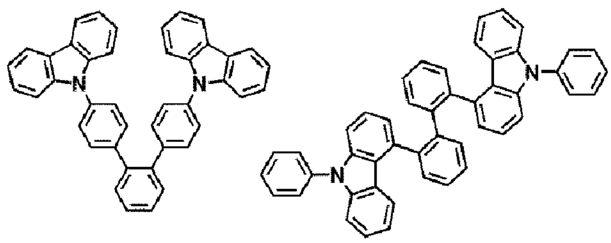

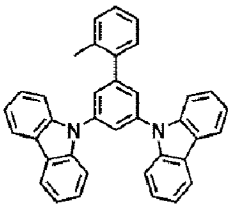

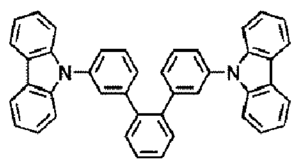

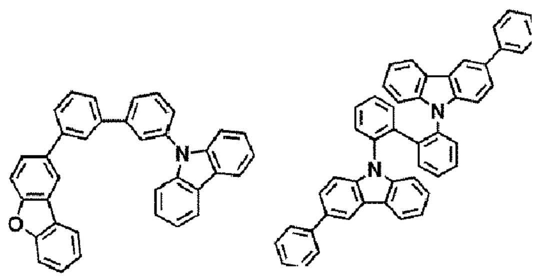

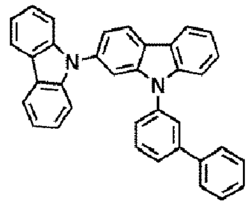 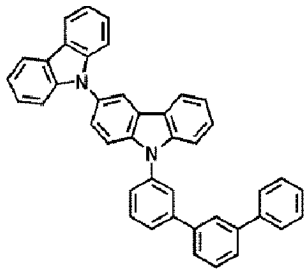 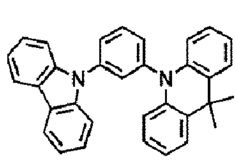 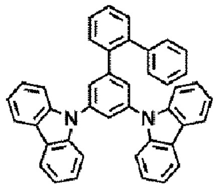

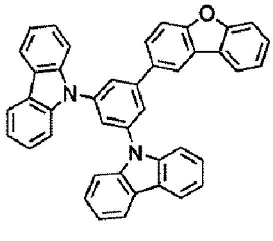 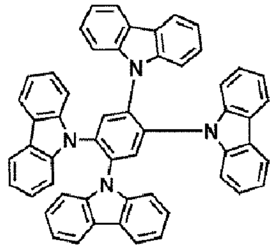 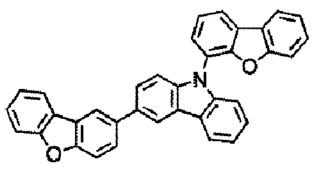 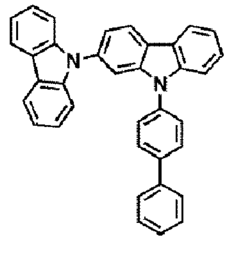

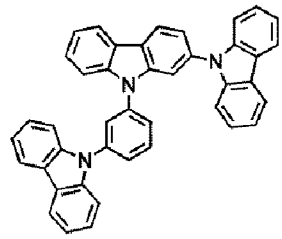 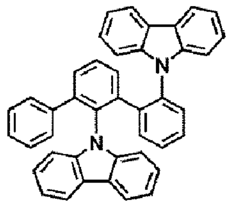 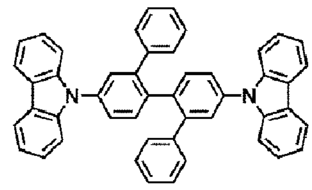 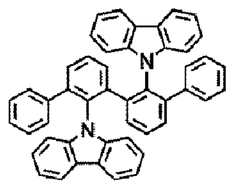

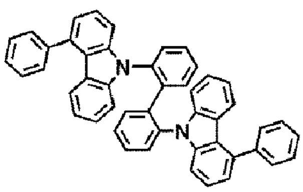 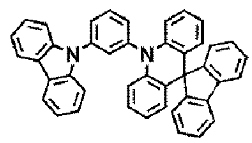 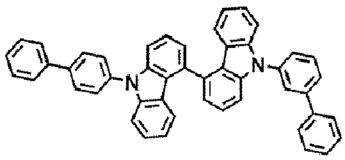

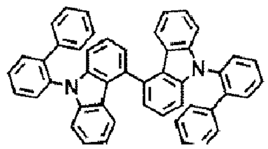 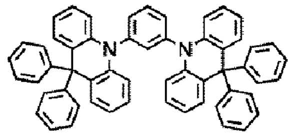 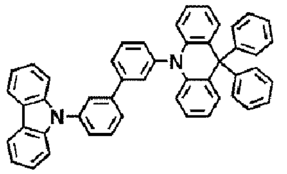

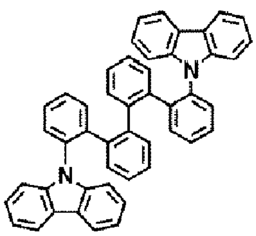 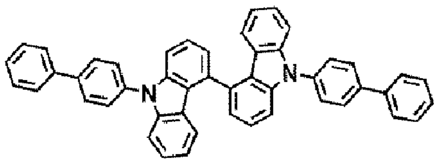 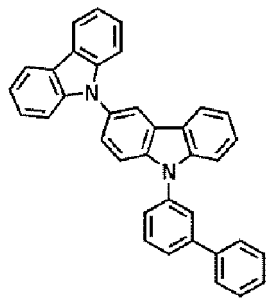

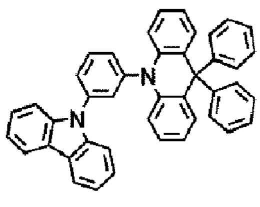
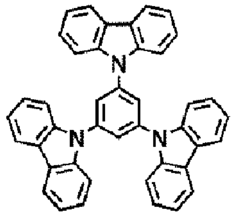
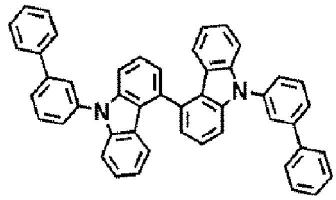

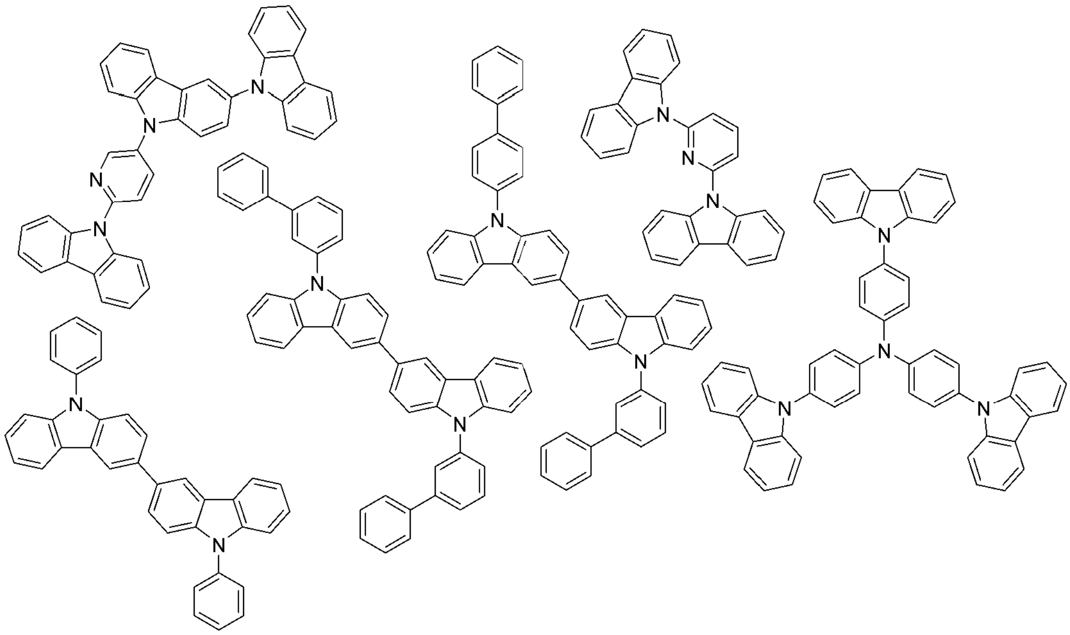

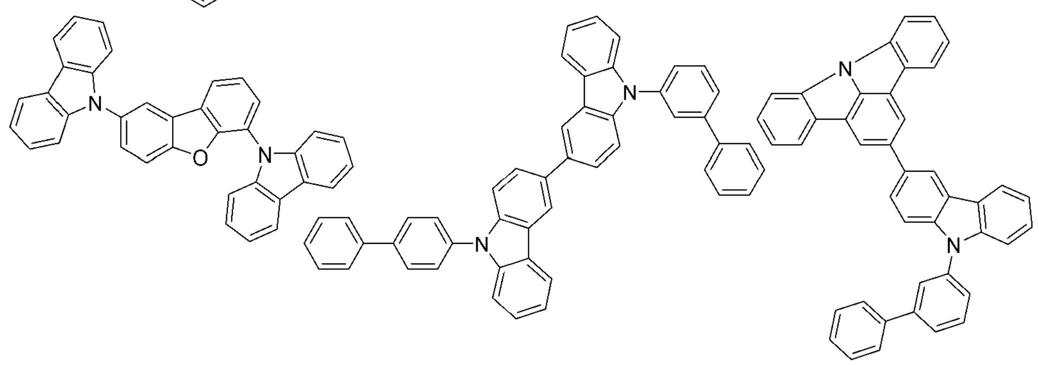

In a preferred embodiment of the invention, an n-host $H^N$ optionally comprised in any of the one or more light-emitting layers B as a whole (consisting of one (sub)layer or comprising more than one sublayers) comprises or consists of a structure according to any of the formulas $H^N$-I, $H^N$-II, and $H^N$-III:

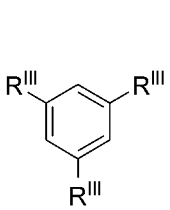
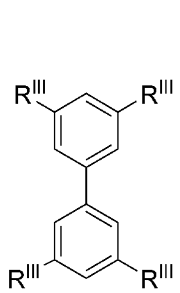
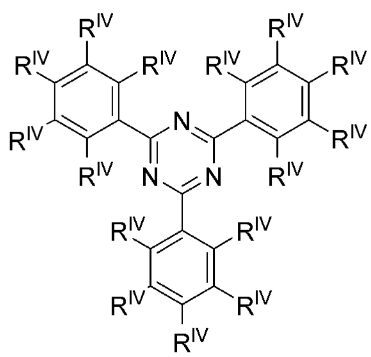

Formula $H^N$-I Formula $H^N$-II Formula $H^N$-III,

wherein $R^{III}$ and $R^{IV}$ are at each occurrence independently of each other selected from the group consisting of: hydrogen, deuterium, Me, $^{i}$Pr, $^{t}$Bu, CN, $CF_3$,

Ph, which is optionally substituted with one or more substituents independently of each other selected from the group consisting of: Me, $^{i}$Pr, $^{t}$Bu, and Ph; and

a structure represented by any of the formulas $H^N$-IV, $H^N$-V, $H^N$-VI, $H^N$-VII, $H^N$-VIII, $H^N$-IX, $H^N$-X, $H^N$-XI, $H^N$-XII, $H^N$-XIII, and $H^N$-XIV:

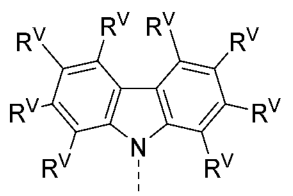

Formula $H^N$-IV

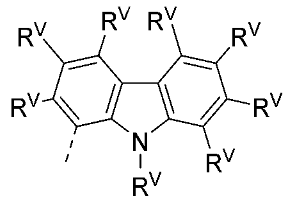

Formula $H^N$-V

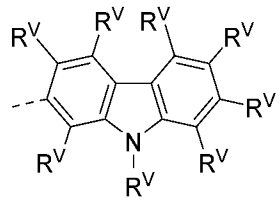

Formula $H^N$-VI

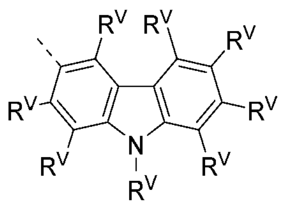

Formula $H^N$-VII

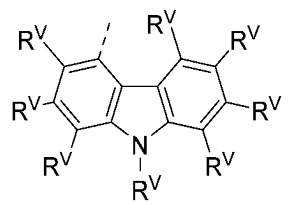

Formula $H^N$-VIII

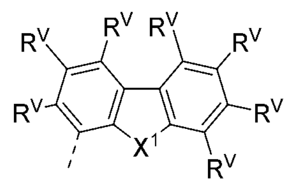

Formula $H^N$-IX

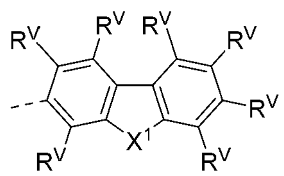

Formula $H^N$-X

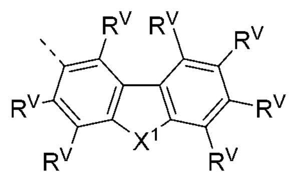

Formula $H^N$-XI

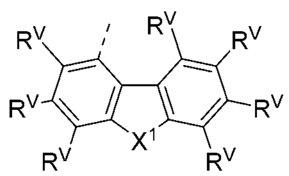

Formula $H^N$-XII

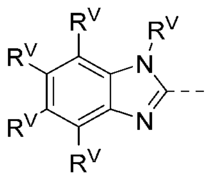

Formula $H^N$-XIII

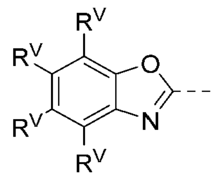

Formula $H^N$-XIV,

wherein

the dashed line indicates the binding site of a single bond connecting the structure according to any of formulas $H^N$-IV, $H^N$-V, $H^N$-VI, $H^N$-VII, $H^N$-VIII, $H^N$-IX, $H^N$-X, $H^N$-XI, $H^N$-XII, $H^N$-XIII, and $H^N$-XIV to a structure according to any of the formulas $H^N$-I, $H^N$-II, and $H^N$-III;

$X^1$ is oxygen (O), sulfur (S) or $C(R^V)_2$;

$R^V$ is at each occurrence independently of each other selected from the group consisting of: hydrogen, deuterium, Me, $^{i}$Pr, $^{t}$Bu, and

Ph, which is optionally substituted with one or more substituents independently of each other selected from the group consisting of: Me, $^{i}$Pr, $^{t}$Bu, and Ph;

wherein two or more adjacent substituents $R^V$ may optionally form a mono- or polycyclic, aliphatic or aromatic or heteroaromatic, carbo- or heterocyclic ring system so that the fused ring system consisting of a structure according to any of formulas $H^N$-IV, $H^N$-V, $H^N$-VI, $H^N$-VII, $H^N$-VIII, $H^N$-IX, $H^N$-X, $H^N$-XI, $H^N$-XII, $H^N$-XIII, and $H^N$-XIV as well as the additional rings optionally formed by adjacent substituents $R^V$ comprises in total 8-60 carbon atoms, preferably 12-40 carbon atoms, more preferably 14-32 carbon atoms; and

wherein in formulas $H^N$-I and $H^N$-II, at least one substituent $R^{III}$ is CN.

In an even more preferred embodiment of the invention, an n-host $H^N$ optionally comprised in the organic electroluminescent device according to the invention is selected from the group consisting of the following structures:

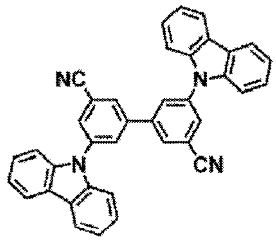
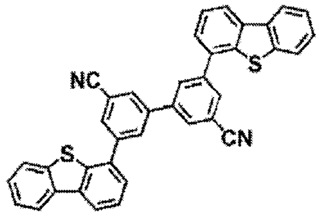
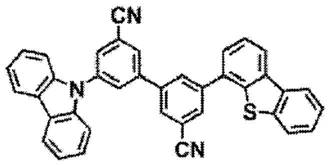

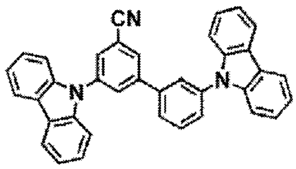
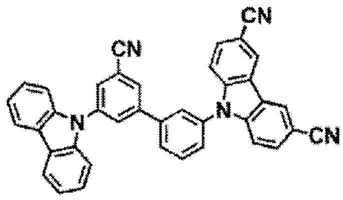
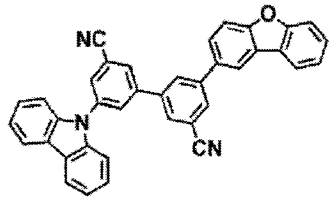

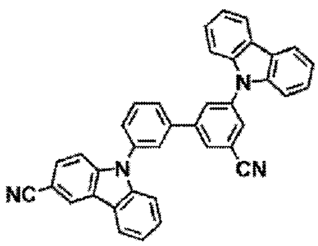
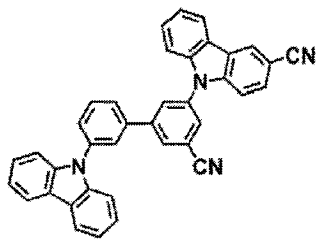

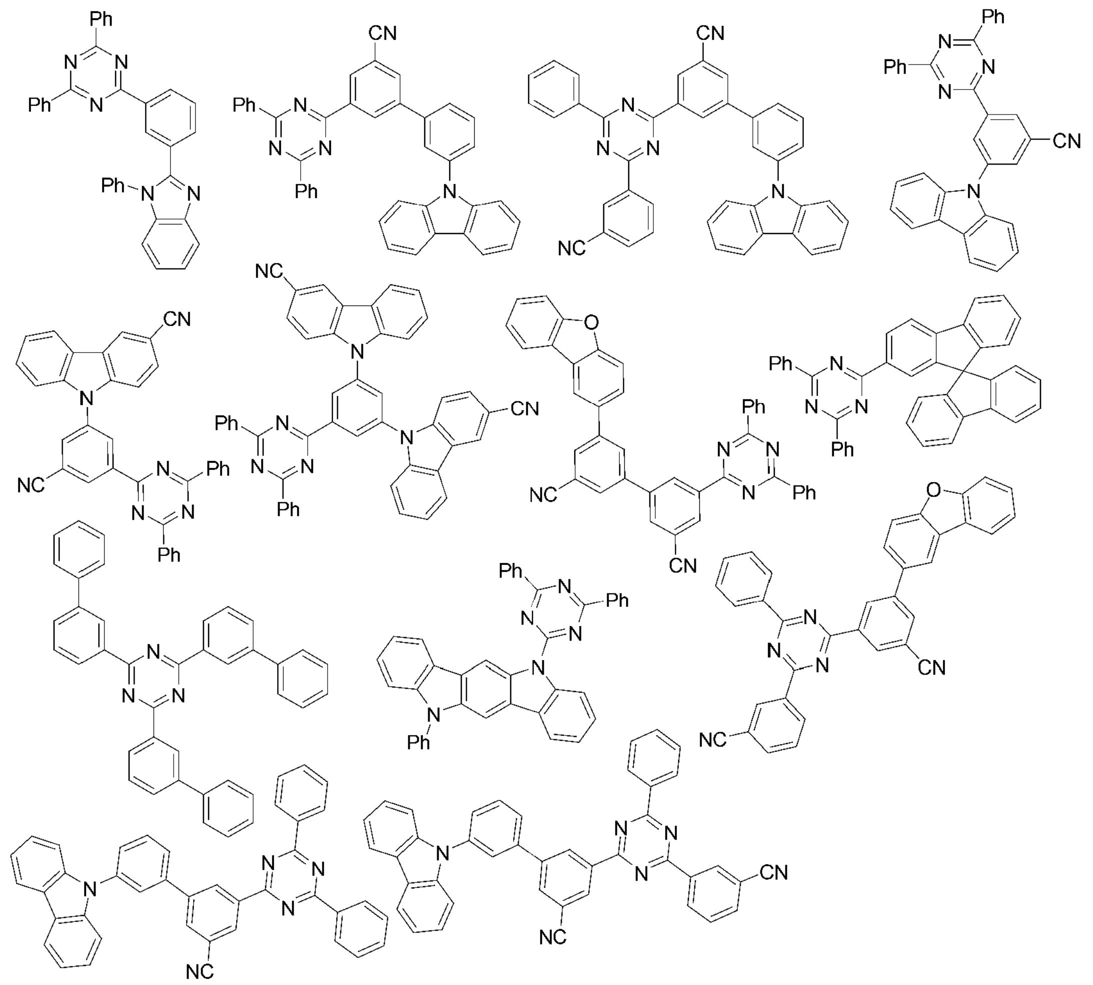

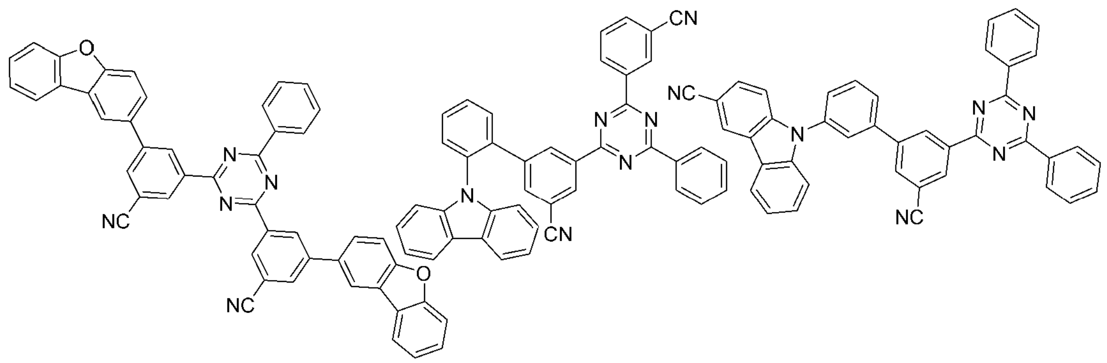

In one embodiment of the invention, no n-host $H^N$ comprised in any light-emitting layer B of the organic electroluminescent device according to the invention contains any phosphine oxide groups and, in particular, no n-host $H^N$ is bis[2-(diphenylphosphino)phenyl] ether oxide (DPEPO).

*Excitation energy transfer components EET-2*

For the light-emitting layer B, the TADF material $E^B$ and the optional excitation energy transfer components EET-2 are preferably selected so that they are able to transfer excitation energy to the small FWHM emitters $S^B$ comprised in the same light-emitting-layer B of the organic electroluminescent device according to the present invention.

To enable this energy transfer, there preferably is spectral overlap between the emission spectrum at room temperature (i.e. (approximately) 20 °C) (e.g. fluorescence spectrum of the TADF material $E^B$ and the absorption spectrum at room temperature (i.e. (approximately) 20 °C) of the small FWHM emitter $S^B$ to which $E^B$ is supposed to transfer energy. Thus, in a preferred embodiment, within the light-emitting layer B, there is spectral overlap between the emission spectrum

at room temperature (i.e. (approximately) 20 °C) of the TADF material $E^B$ and the absorption spectrum of the small FWHM emitter $S^B$. The absorption and emission spectra are recorded as described in a later subchapter of this text.

In a preferred embodiment of the invention, within the light-emitting layer B, the optional excitation energy transfer component EET-2 transfers excitation energy to the small FWHM emitter $S^B$.

To enable this energy transfer, there preferably is spectral overlap between the emission spectrum at room temperature (i.e. (approximately) 20 °C) (e.g. fluorescence spectrum if EET-2 is a TADF material $E^B$ and phosphorescence spectrum if EET-2 is a phosphorescence material $P^B$, vide infra) of the optional excitation energy transfer component EET-2 and the absorption spectrum at room temperature (i.e. (approximately) 20 °C) of the small FWHM emitter $S^B$ to which EET-2 is supposed to transfer energy. Thus, in a preferred embodiment, the light-emitting layer B, there is spectral overlap between the emission spectrum at room temperature (i.e. (approximately) 20 °C) of the optional excitation energy transfer component EET-2 and the absorption spectrum at room temperature (i.e. (approximately) 20 °C) of the small FWHM emitter $S^B$. The absorption and emission spectra are recorded as described in a later subchapter of this text.

In an even more preferred embodiment of the invention, within the light-emitting layer B, the TADF material $E^B$ as well as the optional excitation energy transfer component EET-2 comprised in the light-emitting layer B transfer energy to the small FWHM emitter $S^B$.

In a preferred embodiment of the invention, within the light-emitting layer B, both of the following two conditions are fulfilled:

(i) there is spectral overlap between the emission spectrum at room temperature (i.e. (approximately) 20 °C) of the TADF material $E^B$ and the absorption spectrum at room temperature (i.e. (approximately) 20 °C) of the small FWHM emitter $S^B$; and

(ii) there is spectral overlap between the emission spectrum at room temperature (i.e. (approximately) 20 °C) of the optional excitation energy transfer component EET-2 and the absorption spectrum at room temperature (i.e. (approximately) 20 °C) of the small FWHM emitter $S^B$;

wherein the absorption and emission spectra are recorded as described in a later subchapter of this text.

In a preferred embodiment, the light-emitting layer B, the lowest unoccupied molecular orbital LUMO($E^B$) of the TADF material $E^B$ has an energy $E^{LUMO}(E^B)$ of less than -2.3 eV: $E^{LUMO}(E^B) < -2.3$ eV.

In a preferred embodiment, the light-emitting layer B, the lowest unoccupied molecular orbital LUMO($E^B$) of the TADF material $E^B$ has an energy $E^{LUMO}(E^B)$ of less than -2.6 eV: $E^{LUMO}(E^B) < -2.6$ eV.

In a preferred embodiment, within the light-emitting layer B, the highest occupied molecular orbital HOMO($E^B$) of the TADF material $E^B$ has an energy $E^{HOMO}(E^B)$ higher than -6.3 eV: $E^{HOMO}(E^B) > -6.3$ eV.

In a preferred embodiment, within the light-emitting layer B, the following two conditions are fulfilled:

(i) the lowest unoccupied molecular orbital LUMO($E^B$) of the TADF material $E^B$ has an energy $E^{LUMO}(E^B)$ of less than -2.6 eV: $E^{LUMO}(E^B) < -2.6$ eV ; and

(ii) the highest occupied molecular orbital HOMO($E^B$) of the TADF material $E^B$ has an energy $E^{HOMO}(E^B)$ higher than -6.3 eV: $E^{HOMO}(E^B) > -6.3$ eV.

In one embodiment of the invention, within the light-emitting layer B, the optional excitation energy transfer component EET-2 fulfills at least one, preferably exactly one, of the following two conditions:

(i) it exhibits a $\Delta E_{ST}$ value, which corresponds to the energy difference between $E(S1^{EET-2})$ and $E(T1^{EET-2})$ of less than 0.4 eV, preferably of less than 0.3 eV, more preferably of less than 0.2 eV, even more preferably of less than 0.1 eV, or even of less than 0.05 eV; and/or

(ii) it comprises at least one, preferably exactly one, transition metal with a standard atomic weight of more than 40 (meaning that at least one atom within EET-2 is a (transition) metal with an atomic weight of more than 40, wherein the transition metal may be in any oxidation state).

In a preferred embodiment, within the light-emitting layer B the TADF material $E^B$ exhibits a $\Delta E_{ST}$ value, which corresponds to the energy difference between the lowermost excited singlet state energy level $E(S1^E)$ and the lowermost excited triplet state energy level $E(T1^E)$ of less than 0.4 eV, preferably of less than 0.3 eV, more preferably of less than 0.2 eV, even more preferably of less than 0.1 eV, or even of less than 0.05 eV.

In a preferred embodiment, within the light-emitting layer B the optional excitation energy transfer component EET-2 comprises at least one, preferably exactly one, transition metal with a standard atomic weight of more than 40 (meaning that EET-2 is a (transition) metal with an atomic weight of more than 40, wherein the transition metal may be in any oxidation state).

In a preferred embodiment of the invention, within each light-emitting layer B both of the following two conditions:

(i) the TADF material $E^B$ exhibits a $\Delta E_{ST}$ value, which corresponds to the energy difference between the lowermost excited singlet state energy level $E(S1^E)$ and the lowermost excited triplet state energy level $E(T1^E)$ of less than 0.4 eV, preferably of less than 0.3 eV, more preferably of less than 0.2 eV, even more preferably of less than 0.1 eV, or even of less than 0.05 eV; and
(ii) the optional excitation energy transfer component EET-2 comprises at least one, preferably exactly one, transition metal with a standard atomic weight of more than 40 (meaning that at least one atom within the respective EET-2 is a (transition) metal with an atomic weight of more than 40, wherein the transition metal may be in any oxidation state).

In a preferred embodiment of the invention, in the light-emitting layer B, the optional excitation energy transfer component EET-2 fulfills at least one, preferably exactly one, of the following two conditions:

(i) it exhibits an $\Delta E_{ST}$ value, which corresponds to the energy difference between the lowermost excited singlet state energy level $E(S1^{EET-2})$ and the lowermost excited triplet state energy level $E(T1^{EET-2})$, of less than 0.4 eV, preferably of less than 0.3 eV, more preferably of less than 0.2 eV, even more preferably of less than 0.1 eV, or even of less than 0.05 eV (vide infra); and/or
(ii) it comprises iridium (Ir), palladium (Pd) or platinum (Pt) (meaning that at least one atom within EET-2 is iridium(Ir), palladium (Pd) or platinum (Pt), wherein Ir, Pd and Pt may be in any oxidation state, vide infra).

In a preferred embodiment, within at least one, preferably each, light-emitting layer B at least one, preferably each optional excitation energy transfer component EET-2 comprises iridium (Ir) or platinum (Pt) (meaning that at least one atom within the respective EET-2 is iridium(Ir) or platinum (Pt), wherein Ir and Pt may be in any oxidation state, vide infra).

As stated previously, a light-emitting layer B in the context of the present invention comprises a TADF material $E^B$ and an optional excitation energy transfer component EET-2, wherein these two species are not identical (i.e. they do not have the same chemical formulas). This means that, within each light-emitting layer B of the organic electroluminescent device according to the present invention, the TADF material $E^B$ and the excitation energy transfer components EET-2 may for example be independently of each other selected from the group consisting of TADF-material $E^B$, but in any case, their chemical structures may not be identical. This is to say that within a light-emitting layer B no $E^B$ has the same chemical formula (or structure) as an EET-2.

In a particularly preferred embodiment, the optional excitation energy transfer component EET-2 optionally comprised in the organic electroluminescent device according to the present invention is a phosphorescence material $P^B$ as defined herein.

In a particularly preferred embodiment, the optional excitation energy transfer component EET-2 optionally comprised in the organic electroluminescent device according to the present invention is a TADF material which may have the structural characteristics as defined for the TADF material $E^B$ as defined herein.

It is understood that any preferred features, properties, and embodiments described in the following for a TADF material $E^B$ may also apply to the optional excitation energy transfer component EET-2, if the excitation energy transfer component is selected to be a TADF material.

It is also understood that any preferred features, properties, and embodiments described in the following for a phosphorescence material $P^B$ may also apply to the optional excitation energy transfer component EET-2, if the excitation energy transfer component is selected to be a phosphorescence material $P^B$.

*TADF material(s) $E^B$*

As known to the person skilled in the art, light emission from emitter materials (i.e. emissive dopants), for example in organic light-emitting diodes (OLEDs), may comprise fluorescence from excited singlet states (typically the lowermost excited singlet state S1) and phosphorescence from excited triplet states (typically the lowermost excited triplet state T1).

In the context of the present invention, a fluorescence emitter is capable of emitting light at room temperature (i.e. (approximately) 20 °C) upon electronic excitation (for example in an organic electroluminescent device), wherein the emissive excited state is a singlet state (typically the lowermost excited singlet state S1). Fluorescence emitters usually display prompt (i.e. direct) fluorescence on a timescale of nanoseconds, when the initial electronic excitation (for example by electron hole recombination) affords an excited singlet state of the emitter.

In the context of the present invention, a delayed fluorescence material is a material that is capable of reaching an excited singlet state (typically the lowermost excited singlet state S1) by means of reverse intersystem crossing (RISC; in other words: up intersystem crossing or inverse intersystem crossing) from an excited triplet state (typically from the lowermost excited triplet state T1) and that is furthermore capable of emitting light when returning from the so-reached excited singlet state (typically S1) to its electronic ground state. The fluorescence emission observed after RISC from an

excited triplet state (typically T1) to the emissive excited singlet state (typically S1) occurs on a timescale (typically in the range of microseconds) that is slower than the timescale on which direct (i.e. prompt) fluorescence occurs (typically in the range of nanoseconds) and is thus referred to as delayed fluorescence (DF). When RISC from an excited triplet state (typically from T1) to an excited singlet state (typically to S1), occurs through thermal activation, and if the so populated excited singlet state emits light (delayed fluorescence emission), the process is referred to as thermally activated delayed fluorescence (TADF). Accordingly, a TADF material is a material that is capable of emitting thermally activated delayed fluorescence (TADF) as explained above. It is known to the person skilled in the art that, when the energy difference $\Delta E_{ST}$ between the lowermost excited singlet state energy level E(S1) and the lowermost excited triplet state energy level E(T1) of a fluorescence emitter is reduced, population of the lowermost excited singlet state from the lowermost excited triplet state by means of RISC may occur with high efficiency. Thus, it forms part of the common knowledge of those skilled in the art that a TADF material will typically have a small $\Delta E_{ST}$ value (vide infra).

The occurrence of (thermally activated) delayed fluorescence may for example be analyzed based on the decay curve obtained from time-resolved (i.e. transient) photoluminescence (PL) measurements. PL emission from a TADF material is divided into an emission component from excited singlet states (typically S1) generated by the initial excitation and an emission component from excited states singlet (typically S1) generated via excited triplet states (typically T1) by means of RISC. There is typically a significant difference in time between emission from the singlet excited states (typically S1) formed by the initial excitation and from the singlet excited states (typically S1) reached via RISC from excited triplet states (typically T1).

TADF materials preferably fulfill the following two conditions regarding the full decay dynamics:

(i) the decay dynamics exhibit two time regimes, one typically in the nanosecond (ns) range and the other typically in the microsecond (μs) range; and
(ii) the shapes of the emission spectra in both time regimes coincide;

wherein, the fraction of light emitted in the first decay regime is taken as prompt fluorescence and the fraction emitted in the second decay regime is taken as delayed fluorescence. The PL measurements may be performed using a spin-coated film of the respective emitter (i.e. the assumed TADF material) in poly(methyl methacrylate) (PMMA) with 1-10% by weight, in particular 10% by weight of the respective emitter.

In order to evaluate whether the preferred criterion (i) is fulfilled (i.e. the decay dynamics exhibit two time regimes, one typically in the nanosecond (ns) range and the other typically in the microsecond (μs) range), *TCSPC (Time-correlated single-photon counting*) may typically be used (vide infra) and the *full decay dynamics may* typically be analyzed as stated below. Alternatively, *transient photoluminescence measurements with spectral resolution* may be performed (vide infra).

In order to evaluate whether the preferred criterion (ii) is fulfilled (i.e. the shapes of the emission spectra in both time regimes coincide), *transient photoluminescence measurements with spectral resolution* may typically be performed (vide infra).

Experimental detail on these measurements is provided in a later subchapter of this text.

The ratio of delayed and prompt fluorescence (n- value) may be calculated by the integration of respective photoluminescence decays in time as laid out in a later subchapter of this text.

In the context of the present invention, a TADF material preferably exhibits an n-value (ratio of delayed to prompt fluorescence) larger than 0.05 (n > 0.05), more preferably larger than 0.15 (n > 0.15), more preferably larger than 0.25 (n > 0.25), more preferably larger than 0.35 (n > 0.35), more preferably larger than 0.45 (n > 0.45), more preferably larger than 0.55 (n > 0.55), more preferably larger than 0.65 (n > 0.65), more preferably larger than 0.75 (n > 0.75), more preferably larger than 0.85 (n > 0.85), or even larger than 0.95 (n > 0.95).

According to the invention, a thermally activated delayed fluorescence (TADF) material $E^B$ is characterized by exhibiting a $\Delta E_{ST}$ value, which corresponds to the energy difference between the lowermost excited singlet state energy level $E(S1^E)$ and the lowermost excited triplet state energy level $E(T1^E)$, of less than 0.4 eV, preferably of less than 0.3 eV, more preferably of less than 0.2 eV, even more preferably of less than 0.1 eV, or even of less than 0.05 eV. Thus, $\Delta E_{ST}$ of a TADF material $E^B$ according to the invention may be sufficiently small to allow for thermal repopulation of the lowermost excited singlet state $S1^E$ from the lowermost excited triplet state $T1^E$ (also referred to as up-intersystem crossing or reverse intersystem crossing, RISC) at room temperature (RT, i.e., (approximately) 20°C).

Preferably, in the context of the present invention, TADF materials $E^B$ display both, prompt fluorescence and delayed fluorescence (when the emissive $S1^E$ state is reached via thermally activated RISC from the $T1^E$ state).

It is understood that a small FWHM emitter $S^B$ comprised in a light-emitting layer B of an organic electroluminescent device according to the invention may optionally also have a $\Delta E_{ST}$ value of less than 0.4 eV and exhibit thermally activated delayed fluorescence (TADF). However, for any small FWHM emitter $S^B$ in the context of the invention, this is only an optional feature.

In a preferred embodiment of the invention, there is spectral overlap between the emission spectrum of at least one TADF material $E^B$ and the absorption spectrum of at least one small FWHM emitter $S^B$ (when both spectra are

measured under comparable conditions). In this case, the TADF material $E^B$ may transfer energy to the at least one small FWHM emitter $S^B$.

According to the invention, the TADF material $E^B$ has an emission maximum in the green wavelength range of from 500 nm to 545 nm, preferably 510 nm to 535 nm, typically measured from a spin-coated film with 10% by weight of the TADF material $E^B$ in poly(methyl methacrylate) PMMA at room temperature (i.e., (approximately) 20°C).

In a preferred embodiment of the invention, the emission maximum (peak emission) of a TADF material $E^B$ is at a shorter wavelength than the emission maximum (peak emission) of a small FWHM emitter $S^B$ in the context of the present invention.

In a preferred embodiment of the invention, each TADF material $E^B$ is an organic TADF material, which, in the context of the invention, means that it does not contain any transition metals. Preferably, each TADF material $E^B$ according to the invention predominantly consists of the elements hydrogen (H), carbon (C), and nitrogen (N), but may for example also comprise oxygen (O), boron (B), silicon (Si), fluorine (F), and bromine (Br).

In a preferred embodiment of the invention, each TADF material $E^B$ has a molecular weight equal to or smaller than 800 g/mol.

In one embodiment of the invention, a TADF emitter $E^B$ exhibits a photoluminescence quantum yield (PLQY) equal to or higher than 30%, typically measured from a spin-coated film with 10% by weight of the TADF material $E^B$ in poly(methyl methacrylate) PMMA at room temperature (i.e., (approximately) 20°C).

In a preferred embodiment of the invention, a TADF emitter $E^B$ exhibits a photoluminescence quantum yield (PLQY) equal to or higher than 50%, typically measured from a spin-coated film with 10% by weight of the TADF material $E^B$ in poly(methyl methacrylate) PMMA at room temperature (i.e., (approximately) 20°C).

In an even more preferred embodiment of the invention, a TADF emitter $E^B$ exhibits a photoluminescence quantum yield (PLQY) equal to or higher than 70%, typically measured from a spin-coated film with 10% by weight of the TADF material $E^B$ in poly(methyl methacrylate) PMMA at room temperature (i.e., (approximately) 20°C).

In one embodiment of the invention, a TADF material $E^B$

(i) is characterized by exhibiting a $\Delta E_{ST}$ value, which corresponds to the energy difference between the lowermost excited singlet state energy level $E(S1^E)$ and the lowermost excited triplet state energy level $E(T1^E)$, of less than 0.4 eV; and

(ii) displays a photoluminescence quantum yield (PLQY) of more than 30%.

In one embodiment of the invention, the energy $E^{LUMO}(E^B)$ of the lowest unoccupied molecular orbital $LUMO(E^B)$ of each TADF material $E^B$ is smaller than -2.6 eV.

It is to be noted that, although being typically capable of emitting fluorescence and (thermally activated) delayed fluorescence, a TADF material $E^B$ comprised in the organic electroluminescent device of the invention preferably mainly functions as "energy pump" and not as emitter material. This is to say that a phosphorescence material $P^B$ comprised in a light-emitting layer B preferably mainly transfers excitation energy to one or more small FWHM emitters $S^B$ that in turn serve as the main emitter material(s). The main function of a phosphorescence material $P^B$ in a light-emitting layer B is preferably not the emission of light. However, it may emit light to some extent.

The person skilled in the art knows how to design TADF materials (molecules) $E^B$ according to the invention and the structural features that such molecules typically display. Briefly, to facilitate the reverse intersystem crossing (RISC), $\Delta E_{ST}$ is usually decreased and, in the context of the present invention, $\Delta E_{ST}$ is smaller than 0.4 eV, as stated above. This is oftentimes achieved by designing TADF molecules $E^B$ so that the HOMO and LUMO are spatially largely separated on (electron-) donor and (electron-) acceptor groups, respectively. These groups are usually bulky or connected via spiro-junctions so that they are twisted and the spatial overlap of the HOMO and the LUMO is reduced. However, minimizing the spatial overlap of the HOMO and the LUMO also results in a reduction of the photoluminescence quantum yield (PLQY) of the TADF material, which is unfavorable. Therefore, in practice, these two effects are both taken into account to achieve a reduction of $\Delta E_{ST}$ as well as a high PLQY.

One common approach for the design of TADF materials is to covalently attach one or more (electron-) donor moieties on which the HOMO is distributed and one or more (electron-) acceptor moieties on which the LUMO is distributed to the same bridge, herein referred to as linker group. A TADF material $E^B$ may for example also comprise two or three linker groups which are bonded to the same acceptor moiety and additional donor and acceptor moieties may be bonded to each of these two or three linker groups.

One or more donor moieties and one or more acceptor moieties may also be bonded directly to each other (without the presence of a linker group).

Typical donor moieties are derivatives of diphenyl amine, carbazole, acridine, phenoxazine, and related structures.

Benzene-, biphenyl-, and to some extend also terphenyl-derivatives are common linker groups.

Nitrile groups are very common acceptor moieties in TADF molecules and known examples thereof include:

(i) carbazolyl dicyanobenzene compounds
such as 2CzPN (4,5-di(9*H*-carbazol-9-yl)phthalonitrile), DCzIPN (4,6-di(9*H*-carbazol-9-yl)isophthalonitrile), 4CzPN (3,4,5,6-tetra(9*H*-carbazol-9-yl)phthalonitrile), 4CzIPN (2,4,5,6-Tetra(9*H*-carbazol-9-yl)isophthalonitrile), 4CzTPN (2,4,5,6-tetra(9*H*-carbazol-9-yl)terephthalonitrile), and derivatives thereof;
(ii) carbazolyl cyanopyridine compounds
such as 4CzCNPy (2,3,5,6-tetra(9*H*-carbazol-9-yl)-4-cyanopyridine) and derivatives thereof;
(iii) carbazolyl cyanobiphenyl compounds
such as CNBPCz (4,4',5,5'-tetra(9*H*-carbazol-9-yl)-[1,1'-biphenyl]-2,2'-dicarbonitrile), CzBPCN (4,4',6,6'-tetra(9*H*-carbazol-9-yl)-[1,1'-biphenyl]-3,3'-dicarbonitrile), DDCzIPN (3,3',5,5'-tetra(9*H*-carbazol-9-yl)-[1,1'-biphenyl]-2,2',6,6'-tetracarbonitrile) and derivatives thereof;

wherein in these materials, one or more of the nitrile groups may be replaced my fluorine (F) or trifluoromethyl ($CF_3$) as acceptor moieties.

Nitrogen-heterocycles such as triazine-, pyrimidine-, triazole-, oxadiazole-, thiadiazole-, heptazine-, 1,4-diazatriphenylene-, benzothiazole-, benzoxazole-, quinoxaline-, and diazafluorene-derivatives are also well-known acceptor moieties used for the construction of TADF molecules. Known examples of TADF molecules comprising for example a triazine acceptor include PIC-TRZ (7,7'-(6-([1,1'-biphenyl]-4-yl)-1,3,5-triazine-2,4-diyl)bis(5-phenyl-5,7-dihydroindolo [2,3-b]carbazole)), *m*BFCzTrz (5-(3-(4,6-diphenyl-1,3,5-triazin-2-yl)phenyl)-5*H*-benzofuro[3,2-c]carbazole), and DCzTrz (9,9'-(5-(4,6-diphenyl-1,3,5-triazin-2-yl)-1,3-phenylene)bis(9H-carbazole)).

Another group of TADF materials comprises diaryl ketones such as benzophenone or (heteroaryl)aryl ketones such as 4-benzoylpyridine, 9,10-anthraquinone, 9*H*-xanthen-9-one, and derivatives thereof as acceptor moieties to which the donor moieties (usually carbazolyl substituents) are bonded. Examples of such TADF molecules include BPBCz (bis(4-(9'-phenyl-9*H*,9'*H*-[3,3'-bicarbazol]-9-yl)phenyl)methanone), mDCBP ((3,5-di(9*H*-carbazol-9-yl)phenyl)(pyridin-4-yl)methanone), AQ-DTBu-Cz (2,6-bis(4-(3,6-di-*tert*-butyl-9*H*-carbazol-9-yl)phenyl)anthracene-9,10-dione), and MCz-XT (3-(1,3,6,8-tetramethyl-9*H*-carbazol-9-yl)-9*H*-xanthen-9-one), respectively.

Sulfoxides, in particular diphenyl sulfoxides, are also commonly used as acceptor moieties for the construction of TADF materials and known examples include 4-PC-DPS (9-phenyl-3-(4-(phenylsulfonyl)phenyl)-9*H*-carbazole), DitBu-DPS (9,9'-(sulfonylbis(4,1-phenylene))bis(9*H*-carbazole)), and TXO-PhCz (2-(9-phenyl-9*H*-carbazol-3-yl)-9*H*-thioxanthen-9-one 10,10-dioxide).

Exemplarily, all groups of TADF molecules mentioned above may provide suitable TADF materials $E^B$ for use according to the present invention, given that the specific materials fulfills the aforementioned basic requirement, namely the $\Delta E_{ST}$ value being smaller than 0.4 eV.

The person skilled in the art knows that not only the structures named above, but many more materials may be suitable TADF materials $E^B$ in the context of the present invention. The skilled artisan is familiar with the design principles of such molecules and also knows how to design such molecules with a certain emission color (e.g. blue, green or red emission).

See for example: H. Tanaka, K. Shizu, H. Nakanotani, C. Adachi, Chemistry of Materials 2013, 25(18), 3766, DOI: 10.1021/cm402428a; J. Li, T. Nakagawa, J. MacDonald, Q. Zhang, H. Nomura, H. Miyazaki, C. Adachi, Advanced Materials 2013, 25(24), 3319, DOI: 10.1002/adma.201300575; K. Nasu, T. Nakagawa, H. Nomura, C.-J. Lin, C.-H. Cheng, M.-R. Tseng, T. Yasudaad, C. Adachi, Chemical Communications 2013, 49(88), 10385, DOI: 10.1039/c3cc44179b; Q. Zhang, B. Li1, S. Huang, H. Nomura, H. Tanaka, C. Adachi, Nature Photonics 2014, 8(4), 326, DOI: 10.1038/nphoton.2014.12; B. Wex, B.R. Kaafarani, Journal of Materials Chemistry C 2017, 5, 8622, DOI: 10.1039/c7tc02156a; Y. Im, M. Kim, Y.J. Cho, J.-A. Seo, K.S. Yook, J.Y. Lee, Chemistry of Materials 2017, 29(5), 1946, DOI: 10.1021/acs.chemmater.6b05324; T.-T. Bui, F. Goubard, M. Ibrahim-Ouali, D. Gigmes, F. Dumur, Beilstein Journal of Organic Chemistry 2018, 14, 282, DOI: 10.3762/bjoc.14.18; X. Liang, Z.-L. Tu, Y.-X. Zheng, Chemistry - A European Journal 2019, 25(22), 5623, DOI: 10.1002/chem.201805952.

Furthermore, for example, US2015105564 (A1), US2015048338 (A1), US2015141642 (A1), US2014336379 (A1), US2014138670 (A1), US2012241732 (A1), EP3315581 (A1), EP3483156 (A1), and US2018053901 (A1) disclose TADF materials $E^B$ that may be used in organic electroluminescent devices according to the present invention. It is understood that this does not imply that the present invention is limited to organic electroluminescent devices comprising TADF materials disclosed in the cited references. It is also understood that any TADF materials used in the state of the art may also be suitable TADF materials $E^B$ in the context of the present invention.

In one embodiment of the invention, each TADF material $E^B$ comprises one or more chemical moieties independently of each other selected from the group consisting of CN, $CF_3$, and an optionally substituted 1,3,5-triazinyl group.

In one embodiment of the invention, each TADF material $E^B$ comprises one or more chemical moieties independently of each other selected from the group consisting of CN and an optionally substituted 1,3,5-triazinyl group.

In one embodiment of the invention, each TADF material $E^B$ comprises one or more optionally substituted 1,3,5-triazinyl group.

In one embodiment of the invention, each TADF material $E^B$ comprises one or more chemical moieties independently of each other selected from an amino group, indolyl, carbazolyl, and derivatives thereof, all of which may be optionally substituted, wherein these groups may be bonded to the core structure of the respective TADF molecule via a nitrogen (N) or via a carbon (C) atom, and wherein substituents bonded to these groups may form mono- or polycyclic, aliphatic or aromatic or heteroaromatic, carbo- or heterocyclic ring systems.

In a preferred embodiment of the invention, the at least one, preferably each TADF material $E^B$ comprises

- one or more first chemical moieties, independently of each other selected from an amino group, indolyl, carbazolyl, and derivatives thereof, all of which may be optionally substituted, wherein these groups may be bonded to the core structure of the respective TADF molecule via a nitrogen (N) or via a carbon (C) atom, and wherein substituents bonded to these groups may form mono- or polycyclic, aliphatic or aromatic or heteroaromatic, carbo- or heterocyclic ring systems;
- one or more second chemical moieties, independently of each other selected from the group consisting of CN, $CF_3$, and an optionally substituted 1,3,5-triazinyl group.

In an even more preferred embodiment of the invention, the at least one, preferably each TADF material $E^B$ comprises

- one or more first chemical moieties, independently of each other selected from an amino group, indolyl, carbazolyl, and derivatives thereof, all of which may be optionally substituted, wherein these groups may be bonded to the core structure of the respective TADF molecule via a nitrogen (N) or via a carbon (C) atom, and wherein substituents bonded to these groups may form mono- or polycyclic, aliphatic or aromatic or heteroaromatic, carbo- or heterocyclic ring systems;
- one or more second chemical moieties, independently of each other selected from the group consisting of CN and an optionally substituted 1,3,5-triazinyl group.

In a still even more preferred embodiment of the invention, the at least one, preferably each TADF material $E^B$ comprises

- one or more first chemical moieties, independently of each other selected from an amino group, indolyl, carbazolyl, and derivatives thereof, all of which may be optionally substituted, wherein these groups may be bonded to the core structure of the respective TADF molecule via a nitrogen (N) or via a carbon (C) atom, and wherein substituents bonded to these groups may form mono- or polycyclic, aliphatic or aromatic or heteroaromatic, carbo- or heterocyclic ring systems;
- one or more optionally substituted 1,3,5-triazinyl group.

The person skilled in the art knows that the expression "derivatives thereof" means that the respective parent structure may be optionally substituted or any atom within the respective parent structure may be replaced by an atom of another element for example.

In one embodiment of the invention, each TADF material $E^B$ comprises

- one or more first chemical moieties, each comprising or consisting of a structure according to formula D-I:

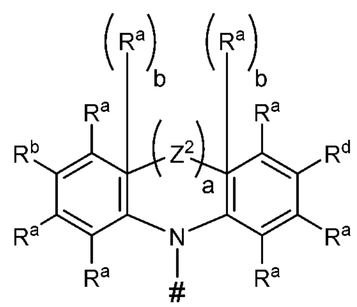

Formula D-I

and

- optionally, one or more second chemical moieties, each independently of each other selected from CN, $CF_3$, and a

structure according to any of formulas A-I, A-II, A-III, and A-IV:

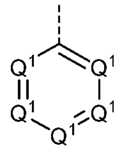 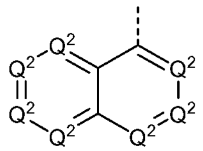 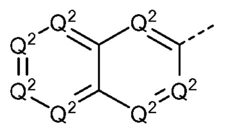 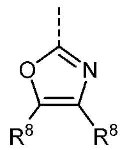 Formula

A-I Formula A-II Formula A-III Formula A-IV

and

- one third chemical moiety comprising or consisting of a structure according to any of formulas L-I, L-II, L-III, L-IV, L-V, L-VI, L-VII, and L-VIII:

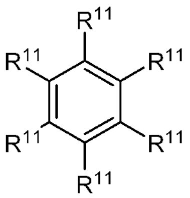

Formula L-I

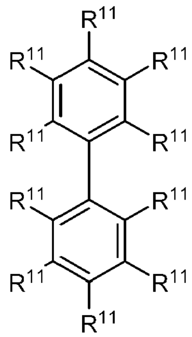

Formula L-II

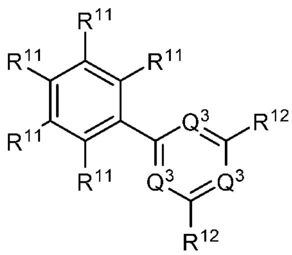

Formula L-III

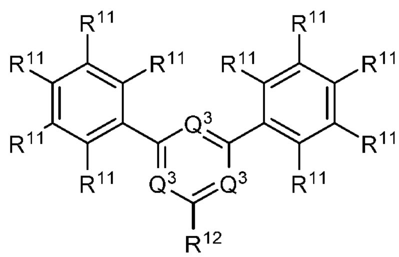

Formula L-IV

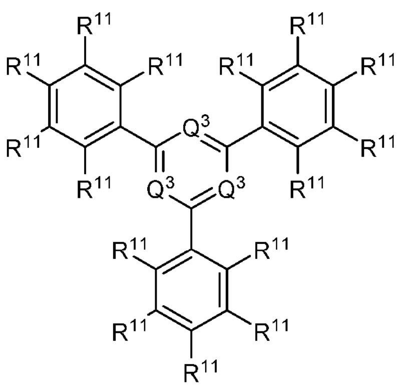

Formula L-V

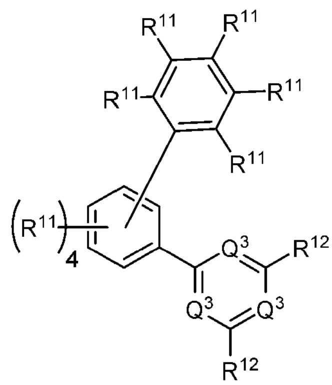

Formula L-VI

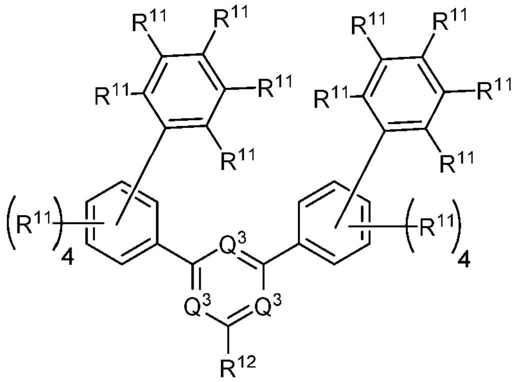

Formula L-VII

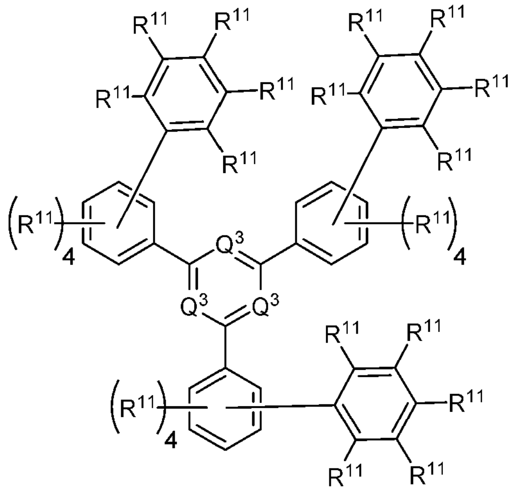

Formula L-VIII,

wherein

the one or more first chemical moieties and the optional one or more second chemical moieties are covalently bonded via a single bond to the third chemical moiety;

wherein in formula D-I:

# represents the binding site of a single bond linking the respective first chemical moiety according to formula D-I to the third chemical moiety;
$Z^2$ is at each occurrence independently of each other selected from the group consisting of a direct bond, $CR^1R^2$, $C=CR^1R^2$, C=O, $C=NR^1$, $NR^1$, O, $SiR^1R^2$, S, S(O) and $S(O)_2$;
$R^a$, $R^b$, $R^d$, $R^1$, and $R^2$ are at each occurrence independently of each other selected from the group consisting of: hydrogen, deuterium, $N(R^3)_2$, $OR^3$, $Si(R^3)_3$, $B(OR^3)_2$, $OSO_2R^3$, $CF_3$, CN, F, Cl, Br, I,
$C_1$-$C_{40}$-alkyl,

which is optionally substituted with one or more substituents $R^3$ and
wherein one or more non-adjacent $CH_2$-groups are optionally substituted by $R^3C=CR^3$, C=C, $Si(R^3)_2$, $Ge(R^3)_2$, $Sn(R^3)_2$, C=O, C=S, C=Se, $C=NR^3$, $P(=O)(R^3)$, SO, $SO_2$, $NR^3$, O, S or $CONR^3$;

$C_1$-$C_{40}$-alkoxy,

which is optionally substituted with one or more substituents $R^3$ and
wherein one or more non-adjacent $CH_2$-groups are optionally substituted by $R^3C=CR^3$, C=C, $Si(R^3)_2$, $Ge(R^3)_2$, $Sn(R^3)_2$, C=O, C=S, C=Se, $C=NR^3$, $P(=O)(R^3)$, SO, $SO_2$, $NR^3$, O, S or $CONR^3$;

$C_1$-$C_{40}$-thioalkoxy,

which is optionally substituted with one or more substituents $R^3$ and
wherein one or more non-adjacent $CH_2$-groups are optionally substituted by $R^3C=CR^3$, C=C, $Si(R^3)_2$, $Ge(R^3)_2$, $Sn(R^3)_2$, C=O, C=S, C=Se, $C=NR^3$, $P(=O)(R^3)$, SO, $SO_2$, $NR^3$, O, S or $CONR^3$;

$C_2$-$C_{40}$-alkenyl,

which is optionally substituted with one or more substituents $R^3$ and
wherein one or more non-adjacent $CH_2$-groups are optionally substituted by $R^3C=CR^3$, C=C, $Si(R^3)_2$, $Ge(R^3)_2$, $Sn(R^3)_2$, C=O, C=S, C=Se, $C=NR^3$, $P(=O)(R^3)$, SO, $SO_2$, $NR^3$, O, S or $CONR^3$;

$C_2$-$C_{40}$-alkynyl,

which is optionally substituted with one or more substituents $R^3$ and
wherein one or more non-adjacent $CH_2$-groups are optionally substituted by $R^3C=CR^3$, $Si(R^3)_2$, $Ge(R^3)_2$, $Sn(R^3)_2$, C=O, C=S, C=Se, $C=NR^3$, $P(=O)(R^3)$, SO, $SO_2$, $NR^3$, O, S or $CONR^3$;

$C_6$-$C_{60}$-aryl,
which is optionally substituted with one or more substituents $R^3$; and
$C_3$-$C_{60}$-heteroaryl,
which is optionally substituted with one or more substituents $R^3$;
$R^3$ is at each occurrence independently of each other selected from the group consisting of: hydrogen, deuterium, $N(R^4)_2$, $OR^4$, $Si(R^4)_3$, $B(OR^4)_2$, $OSO_2R^4$, $CF_3$, CN, F, Br, I,
$C_1$-$C_{40}$-alkyl,

which is optionally substituted with one or more substituents $R^4$ and
wherein one or more non-adjacent $CH_2$-groups are optionally substituted by $R^4C=CR^4$, C≡C, $Si(R^4)_2$, $Ge(R^4)_2$, $Sn(R^4)_2$, C=O, C=S, C=Se, $C=NR^4$, $P(=O)(R^4)$, SO, $SO_2$, $NR^4$, O, S or $CONR^4$;

$C_1$-$C_{40}$-alkoxy,

which is optionally substituted with one or more substituents $R^4$ and
wherein one or more non-adjacent $CH_2$-groups are optionally substituted by $R^4C=CR^4$, C≡C, $Si(R^4)_2$, $Ge(R^4)_2$, $Sn(R^4)_2$, C=O, C=S, C=Se, $C=NR^4$, $P(=O)(R^4)$, SO, $SO_2$, $NR^4$, O, S or $CONR^4$;

$C_1$-$C_{40}$-thioalkoxy,

which is optionally substituted with one or more substituents $R^4$ and
wherein one or more non-adjacent $CH_2$-groups are optionally substituted by $R^4C=CR^4$, C≡C, $Si(R^4)_2$, $Ge(R^4)_2$, $Sn(R^4)_2$, C=O, C=S, C=Se, $C=NR^4$, $P(=O)(R^4)$, SO, $SO_2$, $NR^4$, O, S or $CONR^4$;

$C_2$-$C_{40}$-alkenyl,

which is optionally substituted with one or more substituents $R^4$ and
wherein one or more non-adjacent $CH_2$-groups are optionally substituted by $R^4C=CR^4$, C≡C, $Si(R^4)_2$, $Ge(R^4)_2$, $Sn(R^4)_2$, C=O, C=S, C=Se, $C=NR^4$, $P(=O)(R^4)$, SO, $SO_2$, $NR^4$, O, S or $CONR^4$;

$C_2$-$C_{40}$-alkynyl,

which is optionally substituted with one or more substituents $R^4$ and
wherein one or more non-adjacent $CH_2$-groups are optionally substituted by $R^4C=CR^4$, $Si(R^4)_2$, $Ge(R^4)_2$, $Sn(R^4)_2$, C=O, C=S, C=Se, $C=NR^4$, $P(=O)(R^4)$, SO, $SO_2$, $NR^4$, O, S or $CONR^4$;

$C_6$-$C_{60}$-aryl,
which is optionally substituted with one or more substituents $R^4$; and
$C_3$-$C_{57}$-heteroaryl,
which is optionally substituted with one or more substituents $R^4$;
wherein, optionally, any substituents $R^a$, $R^b$, $R^d$, $R^1$, $R^2$, $R^3$, and $R^4$ independently of each other form a mono- or polycyclic, aliphatic or aromatic or heteroaromatic, carbo- or heterocyclic ring system with one or more adjacent substituents selected from $R^a$, $R^b$, $R^d$, $R^1$, $R^2$, $R^3$, and $R^4$;
$R^4$ is at each occurrence selected from the group consisting of: hydrogen, deuterium, OPh, $CF_3$, CN, F,
$C_1$-$C_5$-alkyl,

wherein one or more hydrogen atoms are optionally, independently of each other substituted by deuterium, CN, $CF_3$, or F;

$C_1$-$C_5$-alkoxy,

wherein one or more hydrogen atoms are optionally, independently of each other substituted by deuterium, CN, $CF_3$, or F;

$C_1$-$C_5$-thioalkoxy,

wherein one or more hydrogen atoms are optionally, independently of each other substituted by deuterium, CN, $CF_3$, or F;

$C_2$-$C_5$-alkenyl,

wherein one or more hydrogen atoms are optionally, independently of each other substituted by deuterium, CN, $CF_3$, or F;

$C_2$-$C_5$-alkynyl,

wherein one or more hydrogen atoms are optionally, independently of each other substituted by deuterium, CN, $CF_3$, or F;

$C_6$-$C_{18}$-aryl,

wherein one or more hydrogen atoms are optionally, independently of each other substituted by deuterium, $C_1$-$C_5$-alkyl, Ph or CN;

$C_3$-$C_{17}$-heteroaryl,

wherein one or more hydrogen atoms are optionally, independently of each other substituted by deuterium, Ph or $C_1$-$C_5$-alkyl;

N( $C_6$-$C_{18}$-aryl$)_2$;
N($C_3$-$C_{17}$-heteroaryl$)_2$, and
N($C_3$-$C_{17}$-heteroaryl)($C_6$-$C_{18}$-aryl);
a is an integer and is 0 or 1;
b is an integer and is at each occurrence 0 or 1, wherein both b are always identical;
wherein both integers b are 0 when integer a is 1 and integer a is 0 when both integers b are 1;
wherein in formulas A-I, A-II, A-III, A-IV:

the dashed line indicates a single bond linking the respective second chemical moiety according to formula A-I, A-II, A-III or A-IV to the third chemical moiety;
$Q^1$ is at each occurrence independently of each other selected from nitrogen (N), $CR^6$, and $CR^7$, with the provision that in formula A-I, two adjacent groups $Q^1$ cannot both be nitrogen (N); wherein, if none of the groups $Q^1$ in formula A-I is nitrogen (N), at least one of the groups $Q^1$ is $CR^7$;
$Q^2$ is at each occurrence independently of each other selected from nitrogen (N), and $CR^6$, with the provisions that in formulas A-II and A-III, at least one group $Q^2$ is nitrogen (N) and that two adjacent groups $Q^2$ cannot both be nitrogen (N);
$R^6$ and $R^8$ are at each occurrence independently of each other selected from the group consisting of: hydrogen, deuterium, $N(R^9)_2$, $OR^9$, $Si(R^9)_3$, $B(OR^9)_2$, $OSO_{2R}{}^9$, $CF_3$, CN, F, Cl, Br, I,
$C_1$-$C_{40}$-alkyl,

which is optionally substituted with one or more substituents $R^9$ and
wherein one or more non-adjacent $CH_2$-groups are optionally substituted by $R^9C{=}CR^9$, C=C, $Si(R^9)_2$, $Ge(R^9)_2$, $Sn(R^9)_2$, C=O, C=S, C=Se, $C{=}NR^9$, $P(=O)(R^9)$, SO, $SO_2$, $NR^9$, O, S or $CONR^9$;

$C_1$-$C_{40}$-alkoxy,

which is optionally substituted with one or more substituents $R^9$ and
wherein one or more non-adjacent $CH_2$-groups are optionally substituted by $R^9C{=}CR^9$, C=C, $Si(R^9)_2$, $Ge(R^9)_2$, $Sn(R^9)_2$, C=O, C=S, C=Se, $C{=}NR^9$, $P(=O)(R^9)$, SO, $SO_2$, $NR^9$, O, S or $CONR^9$;

$C_1$-$C_{40}$-thioalkoxy,

which is optionally substituted with one or more substituents $R^9$ and

wherein one or more non-adjacent $CH_2$-groups are optionally substituted by $R^9C=CR^9$, C≡C, $Si(R^9)_2$, $Ge(R^9)_2$, $Sn(R^9)_2$, C=O, C=S, C=Se, $C=NR^9$, $P(=O)(R^9)$, SO, $SO_2$, $NR^9$, O, S or $CONR^9$;

$C_2$-$C_{40}$-alkenyl,

which is optionally substituted with one or more substituents $R^9$ and
wherein one or more non-adjacent $CH_2$-groups are optionally substituted by $R^9C=CR^9$, C≡C, $Si(R^9)_2$, $Ge(R^9)_2$, $Sn(R^9)_2$, C=O, C=S, C=Se, $C=NR^9$, $P(=O)(R^9)$, SO, $SO_2$, $NR^9$, O, S or $CONR^9$;

$C_2$-$C_{40}$-alkynyl,

which is optionally substituted with one or more substituents $R^9$ and
wherein one or more non-adjacent $CH_2$-groups are optionally substituted by $R^9C=CR^9$, $Si(R^9)_2$, $Ge(R^9)_2$, $Sn(R^9)_2$, C=O, C=S, C=Se, $C=NR^9$, $P(=O)(R^9)$, SO, $SO_2$, $NR^9$, O, S or $CONR^9$;

$C_6$-$C_{60}$-aryl,
which is optionally substituted with one or more substituents $R^9$; and
$C_3$-$C_{60}$-heteroaryl,
which is optionally substituted with one or more substituents $R^9$;
$R^9$ is at each occurrence independently of each other selected from the group consisting of: hydrogen, deuterium, $N(R^{10})_2$, $OR^{10}$, $Si(R^{10})_3$, $B(OR^{10})_2$, $OSO_2R^{10}$, $CF_3$, CN, F, Cl, Br, I,
$C_1$-$C_{40}$-alkyl,

which is optionally substituted with one or more substituents $R^{10}$ and
wherein one or more non-adjacent $CH_2$-groups are optionally substituted by $R^{10}C=CR^{10}$, C≡C, $Si(R^{10})_2$, $Ge(R^{10})_2$, $Sn(R^{10})_2$, C=O, C=S, C=Se, $C=NR^{10}$, $P(=O)(R^{10})$, SO, $SO_2$, $NR^{10}$, O, S or $CONR^{10}$;

$C_1$-$C_{40}$-alkoxy,

which is optionally substituted with one or more substituents $R^{10}$ and
wherein one or more non-adjacent $CH_2$-groups are optionally substituted by $R^{10}C=CR^{10}$, C≡C, $Si(R^{10})_2$, $Ge(R^{10})_2$, $Sn(R^{10})_2$, C=O, C=S, C=Se, $C=NR^{10}$, $P(=O)(R^{10})$, SO, $SO_2$, $NR^{10}$, O, S or $CONR^{10}$;

$C_1$-$C_{40}$-thioalkoxy,

which is optionally substituted with one or more substituents $R^{10}$ and
wherein one or more non-adjacent $CH_2$-groups are optionally substituted by $R^{10}C=CR^{10}$, C≡C, $Si(R^{10})_2$, $Ge(R^{10})_2$, $Sn(R^{10})_2$, C=O, C=S, C=Se, $C=NR^{10}$, $P(=O)(R^{10})$, SO, $SO_2$, $NR^{10}$, O, S or $CONR^{10}$;

$C_2$-$C_{40}$-alkenyl,

which is optionally substituted with one or more substituents $R^{10}$ and
wherein one or more non-adjacent $CH_2$-groups are optionally substituted by $R^{10}C=CR^{10}$, C=C, $Si(R^{10})_2$, $Ge(R^{10})_2$, $Sn(R^{10})_2$, C=O, C=S, C=Se, $C=NR^{10}$, $P(=O)(R^{10})$, SO, $SO_2$, $NR^{10}$, O, S or $CONR^{10}$;

$C_2$-$C_{40}$-alkynyl,

which is optionally substituted with one or more substituents $R^{10}$ and
wherein one or more non-adjacent $CH_2$-groups are optionally substituted by $R^{10}C=CR^{10}$, $Si(R^{10})_2$, $Ge(R^{10})_2$, $Sn(R^{10})_2$, C=O, C=S, C=Se, $C=NR^{10}$, $P(=O)(R^{10})$, SO, $SO_2$, $NR^{10}$, O, S or $CONR^{10}$;

$C_6$-$C_{60}$-aryl,
which is optionally substituted with one or more substituents $R^{10}$; and
$C_3$-$C_{60}$-heteroaryl,
which is optionally substituted with one or more substituents $R^{10}$;
$R^{10}$ is at each occurrence independently of each other selected from the group consisting of: hydrogen, deuterium, OPh, $CF_3$, CN, F,
$C_1$-$C_5$-alkyl,

wherein one or more hydrogen atoms are optionally, independently of each other substituted by deuterium, CN, $CF_3$, or F;

$C_1$-$C_5$-alkoxy,

wherein one or more hydrogen atoms are optionally, independently of each other substituted by deuterium, CN, $CF_3$, or F;

$C_1$-$C_5$-thioalkoxy,

wherein one or more hydrogen atoms are optionally, independently of each other substituted by deuterium, CN, $CF_3$, or F;

$C_2$-$C_5$-alkenyl,

wherein one or more hydrogen atoms are optionally, independently of each other substituted by deuterium, CN, $CF_3$, or F;

$C_2$-$C_5$-alkynyl,

wherein one or more hydrogen atoms are optionally, independently of each other substituted by deuterium, CN, $CF_3$, or F;

$C_6$-$C_{18}$-aryl,

wherein one or more hydrogen atoms are optionally, independently of each other substituted by deuterium, $C_1$-$C_5$-alkyl, Ph or CN;

$C_3$-$C_{17}$-heteroaryl,

wherein one or more hydrogen atoms are optionally, independently of each other substituted by deuterium, Ph or $C_1$-$C_5$-alkyl;

N( $C_6$-$C_{18}$-aryl$)_2$;
N($C_3$-$C_{17}$-heteroaryl$)_2$, and
N($C_3$-$C_{17}$-heteroaryl)($C_6$-$C_{18}$-aryl);
$R^7$ is at each occurrence independently of each other selected from the group consisting of CN, $CF_3$ and a structure according to formula EWG-I:

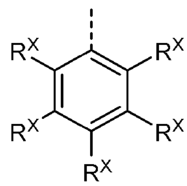

Formula EWG-I,

wherein $R^X$ is defined as $R^6$, with the provision that at least one group $R^X$ in formula EWG-I is CN or $CF_3$;
wherein the two adjacent groups $R^8$ in formula A-IV optionally form an aromatic ring,
which is fused to the structure of formula A-IV, wherein the optionally so formed fused ring system comprises in total 9 to 18 ring atoms;
wherein in formulas L-I, L-II, L-III, L-IV, L-V, L-VI, L-VII, and L-VIII:

$Q^3$ is at each occurrence independently of each other selected from nitrogen (N) and $CR^{12}$, with the provision that at least one $Q^3$ is nitrogen (N);
$R^{11}$ is at each occurrence independently of each other either the binding site of a single bond connecting a first or a second chemical moiety to the third chemical moiety or is independently of each other selected

from the group consisting of: hydrogen, deuterium, F, Cl, Br, I,
$C_1$-$C_5$-alkyl,
wherein one or more hydrogen atoms are optionally substituted by deuterium;
$C_6$-$C_{18}$-aryl,

wherein one or more hydrogen atoms are optionally, independently of each other substituted by deuterium, $C_1$-$C_5$-alkyl groups, $C_6$-$C_{18}$-aryl groups, F, Cl, Br, and I;

$R^{12}$ is defined as $R^6$.

In a preferred embodiment of the invention,

$Z^2$ is at each occurrence independently of each other selected from the group consisting of a direct bond, $CR^1R^2$, $C=CR^1R^2$, C=O, C=NR', $NR^1$, O, $SiR^1R^2$, S, S(O) and $S(O)_2$;
$R^a$, $R^b$, $R^d$, $R^1$, and $R^2$ are at each occurrence independently of each other selected from the group consisting of: hydrogen, deuterium, $N(R^3)_2$, $OR^3$, $Si(R^3)_3$, $CF_3$, CN, F, Cl, Br, I,
$C_1$-$C_{40}$-alkyl,

which is optionally substituted with one or more substituents $R^3$ and wherein one or more non-adjacent $CH_2$-groups are optionally substituted by $R^3C=CR^3$, C≡C, $Si(R^3)_2$, $Ge(R^3)_2$, $Sn(R^3)_2$, C=O, C=S, C=Se, $C=NR^3$, $P(=O)(R^3)$, SO, $SO_2$, $NR^3$, O, S or $CONR^3$;

$C_6$-$C_{60}$-aryl,
which is optionally substituted with one or more substituents $R^3$; and
$C_3$-$C_{60}$-heteroaryl,
which is optionally substituted with one or more substituents $R^3$;
$R^3$ is at each occurrence independently of each other selected from the group consisting of: hydrogen, deuterium, $N(R^4)_2$, $OR^4$, $Si(R^4)_3$, $CF_3$, CN, F, Br, I,
$C_1$-$C_{40}$-alkyl,

which is optionally substituted with one or more substituents $R^4$ and wherein one or more non-adjacent $CH_2$-groups are optionally substituted by $R^4C=CR^4$, C≡C, $Si(R^4)_2$, $Ge(R^4)_2$, $Sn(R^4)_2$, C=O, C=S, C=Se, $C=NR^4$, $P(=O)(R^4)$, SO, $SO_2$, $NR^4$, O, S or $CONR^4$;

$C_6$-$C_{60}$-aryl,
which is optionally substituted with one or more substituents $R^4$; and
$C_3$-$C_{57}$-heteroaryl,
which is optionally substituted with one or more substituents $R^4$;
wherein, optionally, any of the substituents $R^a$, $R^b$, $R^d$, $R^1$, $R^2$, $R^3$, and $R^4$ independently of each other form a mono- or polycyclic, aliphatic or aromatic or heteroaromatic, carbo- or heterocyclic ring system with one or more adjacent substituents selected from $R^a$, $R^b$, $R^d$, $R^1$, $R^2$, $R^3$, and $R^4$;
$R^4$ is at each occurrence independently of each other selected from the group consisting of: hydrogen, deuterium, $CF_3$, CN, F,
$C_1$-$C_5$-alkyl,

wherein one or more hydrogen atoms are optionally, independently of each other substituted by deuterium, CN, $CF_3$, or F;

$C_6$-$C_{18}$-aryl,

wherein one or more hydrogen atoms are optionally, independently of each other substituted by deuterium, $C_1$-$C_5$-alkyl, Ph or CN;

$C_3$-$C_{17}$-heteroaryl,

wherein one or more hydrogen atoms are optionally, independently of each other substituted by deuterium, $C_1$-$C_5$-alkyl or Ph;

$N(C_6-C_{18}-aryl)_2$;
$N(C_3-C_{17}-heteroaryl)_2$, and
$N(C_3-C_{17}-heteroaryl)(C_6-C_{18}-aryl)$;
a is an integer and is 0 or 1;
b is an integer and is at each occurrence 0 or 1, wherein both b are always identical; wherein both integers b are 0 when integer a is 1 and integer a is 0 when both integers b are 1;
$Q^1$ is at each occurrence independently of each other selected from nitrogen (N), $CR^6$, and $CR^7$, with the provision that in formula A-I, two adjacent groups $Q^1$ cannot both be nitrogen (N); wherein, if none of the groups $Q^1$ in formula A-I is nitrogen (N), at least one of the groups $Q^1$ is $CR^7$;
$Q^2$ is at each occurrence independently of each other selected from nitrogen (N), and $CR^6$, with the provision that in formulas A-II and A-III, at least one group $Q^2$ is nitrogen (N) and that two adjacent groups $Q^2$ cannot both be nitrogen (N);
$R^6$ and $R^8$ are at each occurrence independently of each other selected from the group consisting of: hydrogen, deuterium, $N(R^9)_2$, $OR^9$, $Si(R^9)_3$, $CF_3$, CN, F, Cl, Br, I,
$C_1-C_{40}$-alkyl,

which is optionally substituted with one or more substituents $R^9$ and
wherein one or more non-adjacent $CH_2$-groups are optionally substituted by $R^9C=CR^9$, C≡C, $Si(R^9)_2$, $Ge(R^9)_2$, $Sn(R^9)_2$, C=O, C=S, C=Se, $C=NR^9$, $P(=O)(R^9)$, SO, $SO_2$, $NR^9$, O, S or $CONR^9$;

$C_6-C_{60}$-aryl,
which is optionally substituted with one or more substituents $R^9$; and
$C_3-C_{60}$-heteroaryl,
which is optionally substituted with one or more substituents $R^9$;
$R^9$ is at each occurrence independently of each other selected from the group consisting of: hydrogen, deuterium, $N(R^{10})_2$, $OR^{10}$, $Si(R^{10})_3$, $CF_3$, CN, F, Cl, Br, I,
$C_1-C_{40}$-alkyl,

which is optionally substituted with one or more substituents $R^{10}$ and
wherein one or more non-adjacent $CH_2$-groups are optionally substituted by $R^{10}C=CR^{10}$, C≡C, $Si(R^{10})_2$, $Ge(R^{10})_2$, $Sn(R^{10})_2$, C=O, C=S, C=Se, $C=NR^{10}$, $P(=O)(R^{10})$, SO, $SO_2$, $NR^{10}$, O, S or $CONR^{10}$;

$C_6-C_{60}$-aryl,
which is optionally substituted with one or more substituents $R^{10}$; and
$C_3-C_{60}$-heteroaryl,
which is optionally substituted with one or more substituents $R^{10}$;
$R^{10}$ is at each occurrence independently of each other selected from the group consisting of: hydrogen, deuterium, OPh, $CF_3$, CN, F,
$C_1-C_5$-alkyl,

wherein one or more hydrogen atoms are optionally, independently of each other substituted by deuterium, CN, $CF_3$, or F;

$C_6-C_{18}$-aryl,

wherein one or more hydrogen atoms are optionally, independently of each other substituted by deuterium, $C_1-C_5$-alkyl, Ph or CN;

$C_3-C_{17}$-heteroaryl,

wherein one or more hydrogen atoms are optionally, independently of each other substituted by deuterium, $C_1-C_5$-alkyl or Ph;

$N(C_6-C_{18}-aryl)_2$;
$N(C_3-C_{17}-heteroaryl)_2$, and
$N(C_3-C_{17}-heteroaryl)(C_6-C_{18}-aryl)$;
$R^7$ is at each occurrence independently of each other selected from the group consisting of CN, $CF_3$ and a structure according to formula EWG-I:

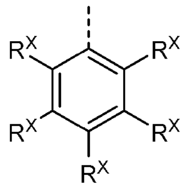

Formula EWG-I,

wherein $R^X$ is defined as $R^6$, with the provision, that at least one group $R^X$ is CN or $CF_3$;
wherein the two adjacent groups $R^8$ in formula A-IV optionally form an aromatic ring, which is fused to the structure of formula A-IV and optionally substituted with one or more substituents $R^{10}$; wherein the optionally so formed fused ring system comprises in total 9 to 18 ring atoms;
$Q^3$ is at each occurrence independently of each other selected from nitrogen (N) and $CR^{12}$, with the provision that at least one $Q^3$ is nitrogen (N);
$R^{11}$ is at each occurrence independently of each other either the binding site of a single bond connecting a first or a second chemical moiety to the third chemical moiety or is independently of each other selected from the group consisting of: hydrogen, deuterium,
$C_1$-$C_5$-alkyl,
wherein one or more hydrogen atoms are optionally substituted by deuterium;
$C_6$-$C_{18}$-aryl,
wherein one or more hydrogen atoms are optionally, independently of each other substituted by deuterium, $C_1$-$C_5$-alkyl groups, and $C_6$-$C_{18}$-aryl groups;
$R^{12}$ is defined as $R^6$;
wherein the maximum number of first and second chemical moieties attached to the third chemical moiety is only limited by the number of available binding sites on the third chemical moiety (in other words: the number of substituents $R^{11}$), with the aforementioned provision, that each TADF material $E^B$ comprises at least one first chemical moiety, at least one second chemical moiety, and exactly one third chemical moiety.

In an even more preferred embodiment of the invention,

$Z^2$ is at each occurrence independently of each other selected from the group consisting of a direct bond, $CR^1R^2$, $C=CR^1R^2$, C=O, $C=NR^1$, $NR^1$, O, $SiR^1R^2$, S, S(O) and $S(O)_2$;
$R^a$, $R^b$, $R^d$, $R^1$, and $R^2$ are at each occurrence independently of each other selected from the group consisting of: hydrogen, deuterium, $N(R^3)_2$, $OR^3$, $Si(R^3)_3$, $CF_3$, CN, F, Cl, Br, I,
$C_1$-$C_5$-alkyl,
which is optionally substituted with one or more substituents $R^3$
$C_6$-$C_{18}$-aryl,
which is optionally substituted with one or more substituents $R^3$; and
$C_3$-$C_{17}$-heteroaryl,
which is optionally substituted with one or more substituents $R^3$;
$R^3$ is at each occurrence independently of each other selected from the group consisting of: hydrogen, deuterium, $N(R^4)_2$, $Si(R^4)_3$, $CF_3$, CN, F,
$C_1$-$C_5$-alkyl,
which is optionally substituted with one or more substituents $R^4$ and
$C_6$-$C_{18}$-aryl,
which is optionally substituted with one or more substituents $R^4$; and
$C_3$-$C_{17}$-heteroaryl,
which is optionally substituted with one or more substituents $R^4$;
wherein, optionally, any of the substituents $R^a$, $R^b$, $R^d$, $R^1$, $R^2$ and $R^3$ independently of each other form a mono- or polycyclic, aliphatic or aromatic, carbo- or heterocyclic ring system with one or more adjacent substituents selected from $R^a$, $R^b$, $R^d$, $R^1$, $R^2$, and $R^3$; wherein the optionally so formed ring system may optionally be substituted with one or more substituents $R^5$;
$R^4$ and $R^5$ are at each occurrence independently of each other selected from the group consisting of: hydrogen, deuterium, $CF_3$, CN, F, Me, $^i$Pr, $^t$Bu, $N(Ph)_2$, and
Ph, wherein one or more hydrogen atoms are optionally, independently of each other substituted by deuterium, Me, $^i$Pr, $^t$Bu, and Ph;

a is an integer and is 0 or 1;

b is an integer and is at each occurrence 0 or 1, wherein both b are always identical; wherein both integers b are 0 when integer a is 1 and integer a is 0 when both integers b are 1;

$Q^1$ is at each occurrence independently of each other selected from nitrogen (N), $CR^6$, and $CR^7$, with the provision that in formula A-I, two adjacent groups $Q^1$ cannot both be nitrogen (N); wherein, if none of the groups $Q^1$ in formula A-I is nitrogen (N), at least one of the groups $Q^1$ is $CR^7$;

$Q^2$ is at each occurrence independently of each other selected from nitrogen (N), and $CR^6$, with the provision that in formulas A-II and A-III, at least one group $Q^2$ is nitrogen (N) and that two adjacent groups $Q^2$ cannot both be nitrogen (N);

$R^6$ and $R^8$ are at each occurrence independently of each other selected from the group consisting of: hydrogen, deuterium, $N(R^9)_2$, $OR^9$, $Si(R^9)_3$, $CF_3$, CN, F,

$C_1$-$C_5$-alkyl,

which is optionally substituted with one or more substituents $R^9$;

$C_6$-$C_{18}$-aryl,

which is optionally substituted with one or more substituents $R^9$; and

$C_3$-$C_{17}$-heteroaryl,

which is optionally substituted with one or more substituents $R^9$;

$R^9$ is at each occurrence independently of each other selected from the group consisting of: hydrogen, deuterium, $N(R^{10})_2$, $OR^{10}$, $Si(R^{10})_3$, $CF_3$, CN, F,

$C_1$-$C_5$-alkyl,

which is optionally substituted with one or more substituents $R^{10}$

$C_6$-$C_{18}$-aryl,

which is optionally substituted with one or more substituents $R^{10}$; and

$C_3$-$C_{17}$-heteroaryl,

which is optionally substituted with one or more substituents $R^{10}$;

$R^{10}$ is at each occurrence independently of each other selected from the group consisting of: hydrogen, deuterium, Me, $^i$Pr, $^t$Bu, $CF_3$, CN, F, $N(Ph)_2$, and

Ph, wherein one or more hydrogen atoms are optionally, independently of each other substituted by deuterium, Me, $^i$Pr, $^t$Bu, Ph, CN, $CF_3$, or F;

$R^7$ is at each occurrence independently of each other selected from the group consisting of CN, $CF_3$ and a structure according to formula EWG-I:

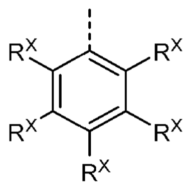

Formula EWG-I,

wherein $R^X$ is defined as $R^6$, with the provision, that at least one group $R^X$ is CN or $CF_3$;

wherein the two adjacent groups $R^8$ in formula A-IV optionally form an aromatic ring, which is fused to the structure of formula A-IV, wherein the optionally so formed fused ring system comprises in total 9 to 18 ring atoms;

$Q^3$ is at each occurrence independently of each other selected from nitrogen (N) and $CR^{12}$, with the provision that at least one $Q^3$ is nitrogen (N);

$R^{11}$ is at each occurrence independently of each other either the binding site of a single bond connecting a first or a second chemical moiety to the third chemical moiety or is independently of each other selected from the group consisting of: hydrogen, deuterium,

$C_1$-$C_5$-alkyl,

wherein one or more hydrogen atoms are optionally substituted by deuterium;

$C_6$-$C_{18}$-aryl,

which is optionally substituted with one or more substituents independently of each other selected from the group consisting of: deuterium, Me, $^i$Pr, $^t$Bu, and Ph;

$R^{12}$ is defined as $R^6$.

In a still even more preferred embodiment of the invention,

$Z^2$ is at each occurrence independently of each other selected from the group consisting of a direct bond, $CR^1R^2$, C=O, $NR^1$, O, $SiR^1R^2$, S, S(O) and $S(O)_2$;
$R^a$, $R^b$, $R^d$, $R^1$, and $R^2$ are at each occurrence independently of each other selected from the group consisting of: hydrogen, deuterium, $N(R^3)_2$, $OR^3$, $Si(R^3)_3$, $CF_3$, CN,
$C_1$-$C_5$-alkyl,
which is optionally substituted with one or more substituents $R^3$
$C_6$-$C_{18}$-aryl,
which is optionally substituted with one or more substituents $R^3$; and
$C_3$-$C_{17}$-heteroaryl,
which is optionally substituted with one or more substituents $R^3$;
$R^3$ is at each occurrence independently of each other selected from the group consisting of: hydrogen, deuterium, $CF_3$, CN, F, Me, $^i$Pr, $^t$Bu, $N(Ph)_2$,
Ph, wherein one or more hydrogen atoms are optionally, independently of each other substituted by deuterium, Me, $^i$Pr, $^t$Bu, and Ph;
wherein, optionally, any of the substituents $R^a$, $R^b$, $R^d$, $R^1$, and $R^2$ independently of each other form a mono- or polycyclic, aliphatic or aromatic or heteroaromatic, carbo- or heterocyclic ring system with one or more adjacent substituents selected from $R^a$, $R^b$, $R^d$, $R^1$, and $R^2$, wherein an optionally so formed fused ring system constructed from the structure according to formula D-1 and the attached rings formed by adjacent substituents comprises in total 13 to 40 ring atoms, preferably 13 to 30 ring atoms, more preferably 16 to 30 ring atoms;
a is an integer and is 0 or 1;
b is an integer and is at each occurrence 0 or 1, wherein both b are always identical; wherein both integers b are 0 when integer a is 1 and integer a is 0 when both integers b are 1;
$Q^1$ is at each occurrence independently of each other selected from nitrogen (N), $CR^6$, and $CR^7$, with the provision that in formula A-I, two adjacent groups $Q^1$ cannot both be nitrogen (N); wherein, if none of the groups $Q^1$ in formula A-I is nitrogen (N), at least one of the groups $Q^1$ is $CR^7$;
$Q^2$ is at each occurrence independently of each other selected from nitrogen (N), and $CR^6$, with the provision that in formulas A-II and A-III, at least one group $Q^2$ is nitrogen (N) and that two adjacent groups $Q^2$ cannot both be nitrogen (N);
$R^6$ and $R^8$ are at each occurrence independently of each other selected from the group consisting of: hydrogen, deuterium, $N(R^9)_2$, $OR^9$, $Si(R^9)_3$, $CF_3$, CN, F, $C_1$-$C_5$-alkyl,
which is optionally substituted with one or more substituents $R^9$;
$C_6$-$C_{18}$-aryl,
which is optionally substituted with one or more substituents $R^9$; and
$C_3$-$C_{17}$-heteroaryl,
which is optionally substituted with one or more substituents $R^9$;
$R^9$ is at each occurrence independently of each other selected from the group consisting of: hydrogen, deuterium, Me, $^i$Pr, $^t$Bu, $CF_3$, CN, F, $N(Ph)_2$, and
Ph, wherein one or more hydrogen atoms are optionally, independently of each other substituted by deuterium, Me, $^i$Pr, $^t$Bu, Ph, CN, $CF_3$, or F.
$R^7$ is at each occurrence independently of each other selected from the group consisting of CN, $CF_3$ and a structure according to formula EWG-I:

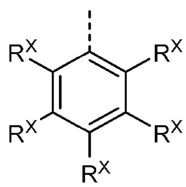

Formula EWG-I,

wherein $R^X$ is defined as $R^6$, with the provision, that at least one group $R^X$ is CN or $CF_3$;
wherein the two adjacent groups $R^8$ in formula A-IV optionally form an aromatic ring, which is fused to the structure of formula A-IV, wherein the optionally so formed fused ring system comprises in total 9 to 18 ring atoms;
$Q^3$ is at each occurrence independently of each other selected from nitrogen (N) and $CR^{12}$, with the provision that at least one $Q^3$ is nitrogen (N);

$R^{11}$ is at each occurrence independently of each other either the binding site of a single bond connecting a first or a second chemical moiety to the third chemical moiety or is independently of each other selected from the group consisting of: hydrogen, deuterium, Me, $^iPr$, $^tBu$, and
Ph, which is optionally substituted with one or more substituents independently of each other selected from the group consisting of: deuterium, Me, $^iPr$, $^tBu$, and Ph;
$R^{12}$ is defined as $R^6$.

In a still even more preferred embodiment of the invention,

$Z^2$ is at each occurrence independently of each other selected from the group consisting of a direct bond, $CR^1R^2$, C=O, $NR^1$, O, $SiR^1R^2$, S, S(O) and $S(O)_2$;
$R^a$, $R^b$, and $R^d$ are at each occurrence independently of each other selected from the group consisting of: hydrogen, deuterium, $N(R^3)_2$, $OR^3$, $Si(R^3)_3$, $CF_3$, CN, Me, $^iPr$, $^tBu$,
Ph, wherein one or more hydrogen atoms are optionally, independently of each other substituted by deuterium, Me, $^iPr$, $^tBu$, and Ph;
carbazolyl, wherein one or more hydrogen atoms are optionally, independently of each other substituted by deuterium, Me, $^iPr$, $^tBu$, and Ph;
triazinyl, wherein one or more hydrogen atoms are optionally, independently of each other substituted by deuterium, Me, $^iPr$, $^tBu$, and Ph;
pyrimidinyl, wherein one or more hydrogen atoms are optionally, independently of each other substituted by deuterium, Me, $^iPr$, $^tBu$, and Ph;
pyridinyl, wherein one or more hydrogen atoms are optionally, independently of each other substituted by deuterium, Me, $^iPr$, $^tBu$, and Ph;
$R^1$ and $R^2$ are at each occurrence independently of each other selected from the group consisting of: hydrogen, deuterium, $N(R^3)_2$, $OR^3$, $Si(R^3)_3$, $CF_3$, CN,
$C_1$-$C_5$-alkyl,
which is optionally substituted with one or more substituents $R^3$
$C_6$-$C_{18}$-aryl,
which is optionally substituted with one or more substituents $R^3$; and
$C_3$-$C_{17}$-heteroaryl,
which is optionally substituted with one or more substituents $R^3$;
$R^3$ is at each occurrence independently of each other selected from the group consisting of: hydrogen, deuterium, $CF_3$, CN, F, Me, $^iPr$, $^tBu$, and
Ph, wherein one or more hydrogen atoms are optionally, independently of each other substituted by deuterium, Me, $^iPr$, $^tBu$, and Ph;
wherein, optionally, any of the substituents $R^a$, $R^b$, $R^d$, $R^1$, and $R^2$ independently of each other form a mono- or polycyclic, aliphatic or aromatic or heteroaromatic, carbo- or heterocyclic ring system with one or more adjacent substituents selected from $R^a$, $R^b$, $R^d$, $R^1$, and $R^2$, wherein an optionally so formed fused ring system constructed from the structure according to formula D1 and the attached rings formed by adjacent substituents comprises in total 13 to 40 ring atoms, preferably 13 to 30 ring atoms, more preferably 16 to 30 ring atoms;
a is an integer and is 0 or 1;
b is an integer and is at each occurrence 0 or 1, wherein both b are always identical; wherein both integers b are 0 when integer a is 1 and integer a is 0 when both integers b are 1;
$Q^1$ is at each occurrence independently of each other selected from nitrogen (N), $CR^6$, and $CR^7$, with the provision that in formula A-I, two adjacent groups $Q^1$ cannot both be nitrogen (N); wherein, if none of the groups $Q^1$ in formula A-I is nitrogen (N), at least one of the groups $Q^1$ is $CR^7$;
$Q^2$ is at each occurrence independently of each other selected from nitrogen (N), and $CR^6$, with the provision that in formulas A-II and A-III, at least one group $Q^2$ is nitrogen (N) and that two adjacent groups $Q^2$ cannot both be nitrogen (N);
$R^6$ and $R^8$ are at each occurrence independently of each other selected from the group consisting of: hydrogen, deuterium, $N(R^9)_2$, $OR^9$, $Si(R^9)_3$, $CF_3$, CN, F,
$C_1$-$C_5$-alkyl,
which is optionally substituted with one or more substituents $R^9$;
$C_6$-$C_{18}$-aryl,
which is optionally substituted with one or more substituents $R^9$; and
$C_3$-$C_{17}$-heteroaryl,
which is optionally substituted with one or more substituents $R^9$;
$R^9$ is at each occurrence independently of each other selected from the group consisting of: hydrogen, deuterium, Me,

$^{i}Pr$, $^{t}Bu$, $CF_3$, CN, F, $N(Ph)_2$, and
Ph, wherein one or more hydrogen atoms are optionally, independently of each other substituted by deuterium, Me, $^{i}Pr$, $^{t}Bu$, Ph, CN, $CF_3$, or F;
$R^7$ is at each occurrence independently of each other selected from the group consisting of CN, $CF_3$ and a structure according to formula EWG-I:

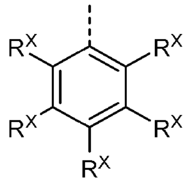

Formula EWG-I,

wherein $R^X$ is defined as $R^6$, with the provision, that at least one group $R^X$ is CN or $CF_3$;
wherein the two adjacent groups $R^8$ in formula A-IV optionally form an aromatic ring, which is fused to the structure of formula A-IV, wherein the optionally so formed fused ring system comprises in total 9 to 18 ring atoms;
$Q^3$ is at each occurrence independently of each other selected from nitrogen (N) and $CR^{12}$, with the provision that at least one $Q^3$ is nitrogen (N);
$R^{11}$ is at each occurrence independently of each other either the binding site of a single bond connecting a first or a second chemical moiety to the third chemical moiety or is independently of each other selected from the group consisting of: hydrogen, deuterium, Me, $^{i}Pr$, $^{t}Bu$, and
Ph, which is optionally substituted with one or more substituents independently of each other selected from the group consisting of: deuterium, Me, $^{i}Pr$, $^{t}Bu$, and Ph;
$R^{12}$ is defined as $R^6$.

In a still even more preferred embodiment of the invention,

$Z^2$ is at each occurrence independently of each other selected from the group consisting of a direct bond, $CR^1R^2$, C=O, $NR^1$, O, $SiR^1R^2$, S, S(O) and $S(O)_2$;
$R^a$, $R^b$, and $R^d$ are at each occurrence independently of each other selected from the group consisting of: hydrogen, deuterium, $N(R^3)_2$, $OR^3$, $Si(R^3)_3$, $CF_3$, CN, Me, $^{i}Pr$, $^{t}Bu$,
Ph, wherein one or more hydrogen atoms are optionally, independently of each other substituted by deuterium, Me, $^{i}Pr$, $^{t}Bu$, and Ph; and
carbazolyl, wherein one or more hydrogen atoms are optionally, independently of each other substituted by deuterium, Me, $^{i}Pr$, $^{t}Bu$, and Ph;
$R^1$ and $R^2$ are at each occurrence independently of each other selected from the group consisting of: hydrogen, deuterium, $OR^3$, $Si(R^3)_3$,
$C_1$-$C_5$-alkyl,
which is optionally substituted with one or more substituents $R^3$
$C_6$-$C_{18}$-aryl,
which is optionally substituted with one or more substituents $R^3$; and
$R^3$ is at each occurrence independently of each other selected from the group consisting of: hydrogen, deuterium, $CF_3$, CN, F, Me, $^{i}Pr$, $^{t}Bu$, and
Ph, wherein one or more hydrogen atoms are optionally, independently of each other substituted by deuterium, Me, $^{i}Pr$, $^{t}Bu$, and Ph;
wherein, optionally, any of the substituents $R^a$, $R^b$, $R^d$, $R^1$, and $R^2$ independently of each other form a mono- or polycyclic, aliphatic or aromatic, carbo- or heterocyclic ring system with one or more substituents selected from $R^a$, $R^b$, $R^d$, $R^1$, and $R^2$, wherein an optionally so formed fused ring system constructed from the structure according to formula D1 and the attached rings formed by adjacent substituents comprises in total 13 to 40 ring atoms, preferably 13 to 30 ring atoms, more preferably 16 to 30 ring atoms;
a is an integer and is 0 or 1;
b is an integer and is at each occurrence 0 or 1, wherein both b are always identical; wherein both integers b are 0 when integer a is 1 and integer a is 0 when both integers b are 1;
$Q^1$ is at each occurrence independently of each other selected from nitrogen (N), $CR^6$, and $CR^7$, with the provision that in formula A-I, two adjacent groups $Q^1$ cannot both be nitrogen (N); wherein, if none of the groups $Q^1$ in formula A-I is nitrogen (N), at least one of the groups $Q^1$ is $CR^7$;

$Q^2$ is at each occurrence independently of each other selected from nitrogen (N), and $CR^6$, with the provision that in formulas A-II and A-III, at least one group $Q^2$ is nitrogen (N) and that two adjacent groups $Q^2$ cannot both be nitrogen (N);

$R^6$ and $R^8$ are at each occurrence independently of each other selected from the group consisting of: hydrogen, deuterium, OPh, $N(Ph)_2$, $Si(Me)_3$, $Si(Ph)_3$, $CF_3$, CN, F, Me, $^i$Pr, $^t$Bu,

Ph, wherein one or more hydrogen atoms are optionally, independently of each other substituted by deuterium, Me, $^i$Pr, $^t$Bu, and Ph;

carbazolyl, wherein one or more hydrogen atoms are optionally, independently of each other substituted by deuterium, Me, $^i$Pr, $^t$Bu, and Ph;

$R^7$ is at each occurrence independently of each other selected from the group consisting of CN, $CF_3$ and a structure according to formula EWG-I:

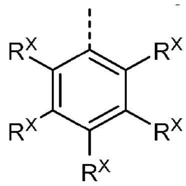

Formula EWG-I,

wherein $R^X$ is defined as $R^6$, with the provision, that at least one group $R^X$ is CN or $CF_3$;

wherein the two adjacent groups $R^8$ in formula A-IV optionally form an aromatic ring, which is fused to the structure of formula A-IV, wherein the optionally so formed fused ring system comprises in total 9 to 18 ring atoms;

$Q^3$ is at each occurrence independently of each other selected from nitrogen (N) and $CR^{12}$, with the provision that at least one $Q^3$ is nitrogen (N);

$R^{11}$ is at each occurrence independently of each other either the binding site of a single bond connecting a first or a second chemical moiety to the third chemical moiety or is independently of each other selected from the group consisting of: hydrogen, deuterium, Me, $^i$Pr, $^t$Bu, and

Ph, which is optionally substituted with one or more substituents independently of each other selected from the group consisting of: deuterium, Me, $^i$Pr, $^t$Bu, and Ph;

$R^{12}$ is defined as $R^6$.

In a still even more preferred embodiment of the invention,

$Z^2$ is at each occurrence independently of each other selected from the group consisting of a direct bond, $CR^1R^2$, C=O, $NR^1$, O, $SiR^1R^2$, S, S(O) and $S(O)_2$;

$R^a$, $R^b$, and $R^d$ are at each occurrence independently of each other selected from the group consisting of: hydrogen, deuterium, $N(Ph)_2$, $Si(Me)_3$, $Si(Ph)_3$, $CF_3$, CN, Me, $^i$Pr, $^t$Bu,

Ph, wherein one or more hydrogen atoms are optionally, independently of each other substituted by deuterium, Me, $^i$Pr, $^t$Bu, and Ph; and

carbazolyl, wherein one or more hydrogen atoms are optionally, independently of each other substituted by deuterium, Me, $^i$Pr, $^t$Bu, and Ph;

$R^1$ and $R^2$ are at each occurrence independently of each other selected from the group consisting of: hydrogen, deuterium, Me, $^i$Pr, $^t$Bu,

Ph, wherein one or more hydrogen atoms are optionally, independently of each other substituted by deuterium, Me, $^i$Pr, $^t$Bu, and Ph;

wherein, optionally, any of the substituents $R^a$, $R^b$, $R^d$, $R^1$, and $R^2$ independently of each other form a mono- or polycyclic, aliphatic or aromatic or heteroaromatic, carbo- or heterocyclic ring system with one or more substituents selected from $R^a$, $R^b$, $R^d$, $R^1$, and $R^2$; wherein an optionally so formed fused ring system constructed from the structure according to formula D1 and the attached rings formed by adjacent substituents comprises in total 13 to 40 ring atoms, preferably 13 to 30 ring atoms, more preferably 16 to 30 ring atoms;

a is an integer and is 0 or 1;

b is an integer and is at each occurrence 0 or 1, wherein both b are always identical;

wherein both integers b are 0 when integer a is 1 and integer a is 0 when both integers b are 1;

$Q^1$ is at each occurrence independently of each other selected from nitrogen (N), $CR^6$, and $CR^7$, with the provision that in formula A-I, two adjacent groups $Q^1$ cannot both be nitrogen (N); wherein, if none of the groups $Q^1$ in formula A-I is nitrogen (N), at least one of the groups $Q^1$ is $CR^7$;

$Q^2$ is at each occurrence independently of each other selected from nitrogen (N), and $CR^6$, with the provision that in formulas A-II and A-III, at least one group $Q^2$ is nitrogen (N) and that two adjacent groups $Q^2$ cannot both be nitrogen (N);

$R^6$ and $R^8$ are at each occurrence independently of each other selected from the group consisting of: hydrogen, deuterium, $N(Ph)_2$, $Si(Me)_3$, $Si(Ph)_3$, Me, $^i$Pr, $^t$Bu,

Ph, wherein one or more hydrogen atoms are optionally, independently of each other substituted by deuterium, Me, $^i$Pr, $^t$Bu, and Ph;

carbazolyl, wherein one or more hydrogen atoms are optionally, independently of each other substituted by deuterium, Me, $^i$Pr, $^t$Bu, and Ph;

$R^7$ is at each occurrence independently of each other selected from the group consisting of CN, $CF_3$ and a structure according to formula EWG-I:

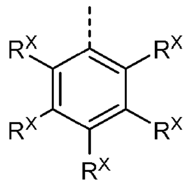

Formula EWG-I,

wherein $R^X$ is defined as $R^6$, but may also be CN or $CF_3$, with the provision, that at least one group $R^X$ is CN or $CF_3$;

wherein the two adjacent groups $R^8$ in formula A-IV optionally form an aromatic ring, which is fused to the structure of formula A-IV, wherein the optionally so formed fused ring system comprises in total 9 to 18 ring atoms;

$Q^3$ is at each occurrence independently of each other selected from nitrogen (N) and $CR^{12}$, with the provision that at least one $Q^3$ is nitrogen (N);

$R^{11}$ is at each occurrence independently of each other either the binding site of a single bond connecting a first or a second chemical moiety to the third chemical moiety or is independently of each other selected from the group consisting of: hydrogen, deuterium, Me, $^i$Pr, $^t$Bu, and

Ph, which is optionally substituted with one or more substituents independently of each other selected from the group consisting of: deuterium, Me, $^i$Pr, $^t$Bu, and Ph;

$R^{12}$ is defined as $R^6$.

In a particularly preferred embodiment of the invention,

$Z^2$ is at each occurrence independently of each other selected from the group consisting of a direct bond, $CR^1R^2$, C=O, $NR^1$, O, $SiR^1R^2$, S, S(O) and $S(O)_2$;

$R^a$, $R^b$, and $R^d$ are at each occurrence independently of each other selected from the group consisting of: hydrogen, deuterium, $CF_3$, CN, Me, $^i$Pr, $^t$Bu, and

Ph, wherein one or more hydrogen atoms are optionally, independently of each other substituted by deuterium, Me, $^i$Pr, $^t$Bu, and Ph;

$R^1$ and $R^2$ are at each occurrence independently of each other selected from the group consisting of: hydrogen, deuterium, Me, $^i$Pr, $^t$Bu, and

Ph, wherein one or more hydrogen atoms are optionally, independently of each other substituted by deuterium, Me, $^i$Pr, $^t$Bu, and Ph;

wherein, optionally, any of the substituents $R^a$, $R^b$, $R^d$, $R^1$, and $R^2$ independently of each other form a mono- or polycyclic, aliphatic or aromatic or heteroaromatic, carbo- or heterocyclic ring system with one or more substituents selected from $R^a$, $R^b$, $R^d$, $R^1$, and $R^2$, wherein an optionally so formed fused ring system constructed from the structure according to formula D1 and the attached rings formed by adjacent substituents comprises in total 13 to 40 ring atoms, preferably 13 to 30 ring atoms, more preferably 16 to 30 ring atoms;

a is an integer and is 0 or 1;

b is an integer and is at each occurrence 0 or 1, wherein both b are always identical;

wherein both integers b are 0 when integer a is 1 and integer a is 0 when both integers b are 1;

$Q^1$ is at each occurrence independently of each other selected from nitrogen (N), $CR^6$, and $CR^7$, with the provision that in formula A-I, two adjacent groups $Q^1$ cannot both be nitrogen (N); wherein, if none of the groups $Q^1$ in formula A-I is nitrogen (N), at least one of the groups $Q^1$ is $CR^7$;

$Q^2$ is at each occurrence independently of each other selected from nitrogen (N), and $CR^6$, with the provision that in formulas A-II and A-III, at least one group $Q^2$ is nitrogen (N) and that two adjacent groups $Q^2$ cannot both be nitrogen

(N);
$R^6$ and $R^8$ are at each occurrence independently of each other selected from the group consisting of: hydrogen, deuterium, $N(Ph)_2$, Me, $^i$Pr, $^t$Bu,
Ph, wherein one or more hydrogen atoms are optionally, independently of each other substituted by deuterium, Me, $^i$Pr, $^t$Bu, and Ph; and
carbazolyl, wherein one or more hydrogen atoms are optionally, independently of each other substituted by deuterium, Me, $^i$Pr, $^t$Bu, and Ph;
$R^7$ is at each occurrence independently of each other selected from the group consisting of CN, $CF_3$ and a structure according to formula EWG-I:

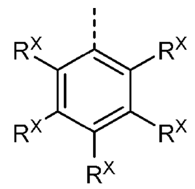

Formula EWG-I,

wherein $R^X$ is defined as $R^6$, but may also be CN or $CF_3$, with the provision, that at least one group $R^X$ is CN or $CF_3$; wherein the two adjacent groups $R^8$ in formula A-IV optionally form an aromatic ring, which is fused to the structure of formula A-IV, wherein the optionally so formed fused ring system comprises in total 9 to 18 ring atoms;
$Q^3$ is at each occurrence independently of each other selected from nitrogen (N) and $CR^{12}$, with the provision that at least one $Q^3$ is nitrogen (N);
$R^{11}$ is at each occurrence independently of each other either the binding site of a single bond connecting a first or a second chemical moiety to the third chemical moiety or is independently of each other selected from the group consisting of: hydrogen, deuterium, Me, $^i$Pr, $^t$Bu, and
Ph, which is optionally substituted with one or more substituents independently of each other selected from the group consisting of: deuterium, Me, $^i$Pr, $^t$Bu, and Ph;
$R^{12}$ is defined as $R^6$.

In a preferred embodiment of the invention, a is always 1 and b is always 0.
In a preferred embodiment of the invention, $Z^2$ is at each occurrence a direct bond.
In a preferred embodiment of the invention, $R^a$ is at each occurrence hydrogen.
In a preferred embodiment of the invention, $R^a$ and $R^d$ are at each occurrence hydrogen.
In a preferred embodiment of the invention, $Q^3$ is at each occurrence nitrogen (N).
In one embodiment of the invention, at least one group $R^X$ in formula EWG-I is CN.
In a preferred embodiment of the invention, exactly one group $R^X$ in formula EWG-I is CN.
In a preferred embodiment of the invention, exactly one group $R^X$ in formula EWG-I is CN and no group $R^X$ in formula EWG-I is $CF_3$.
Examples of first chemical moieties according to the present invention are shown below, which does of course not imply that the present invention is limited to these examples:

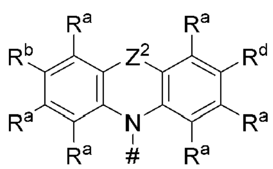
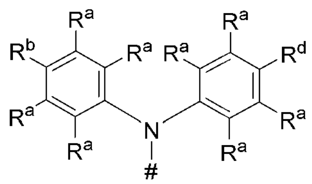
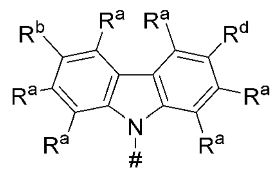

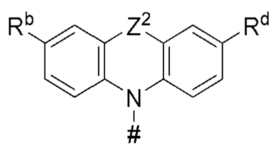
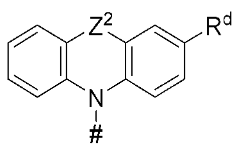
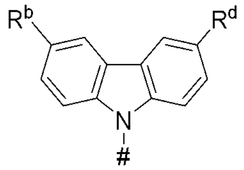
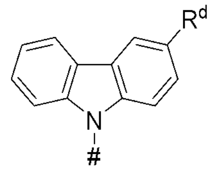

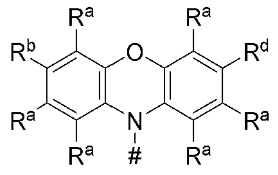 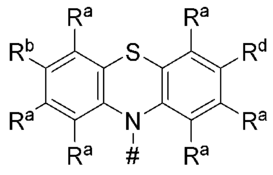 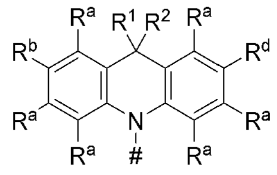 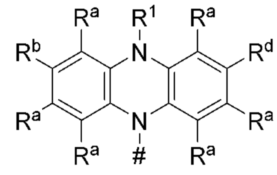

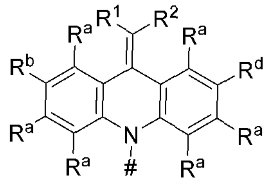 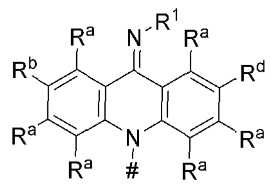 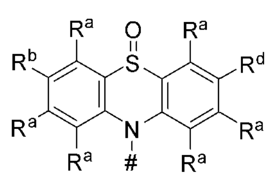 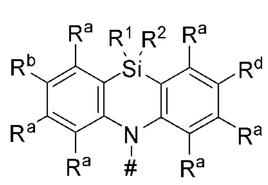

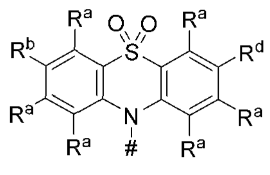 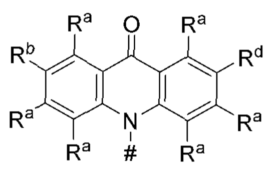 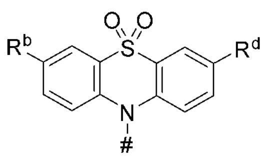 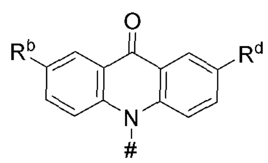

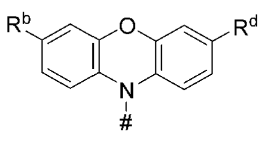 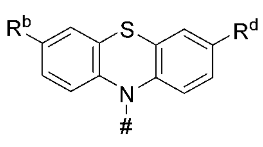 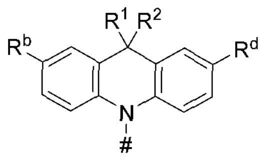 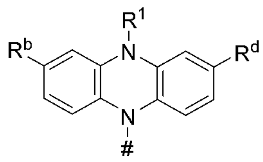

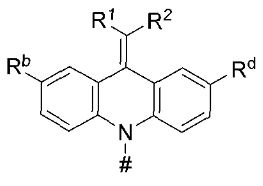 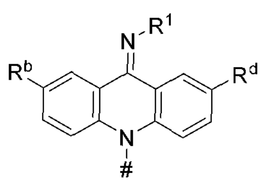 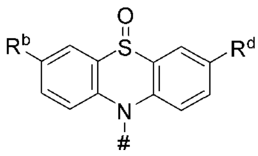 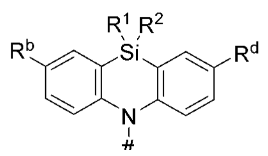

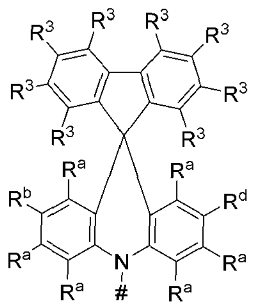 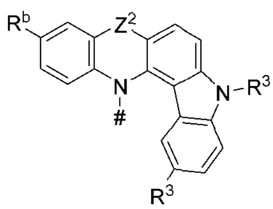 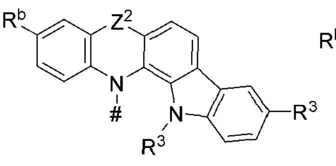 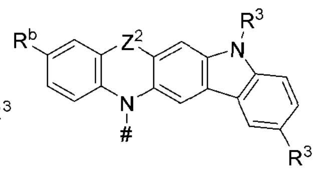

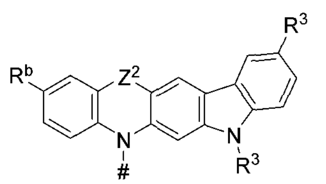 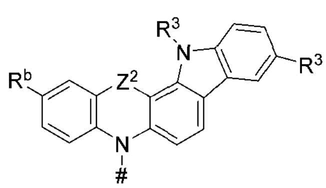 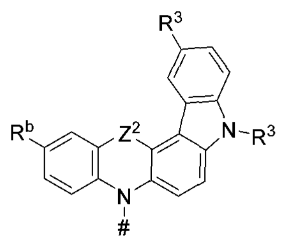

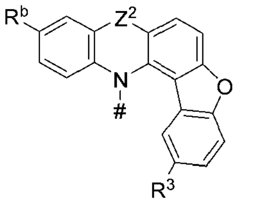
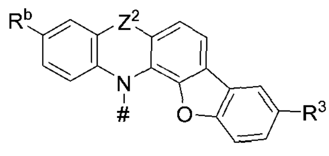
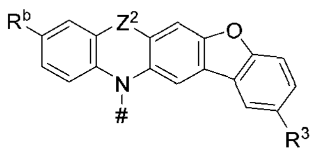

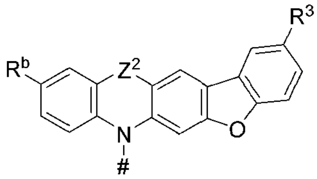
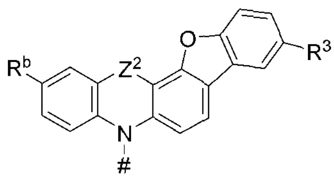
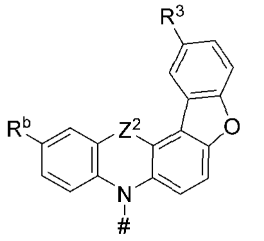

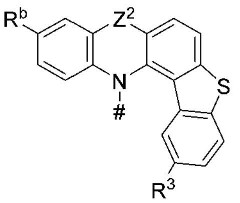
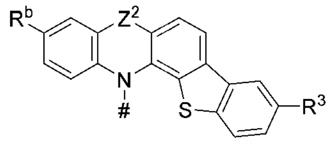
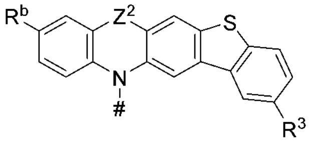

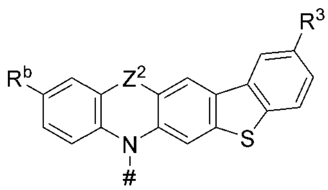
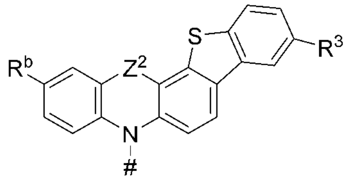
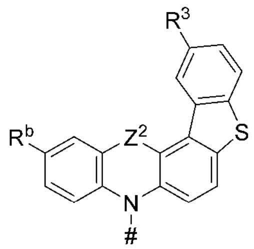

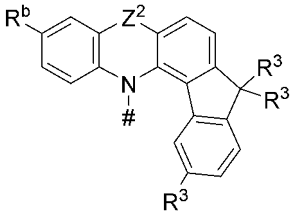
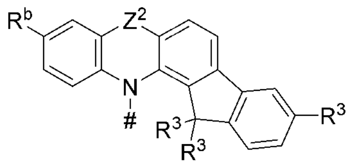
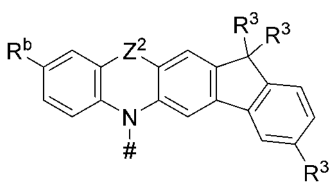

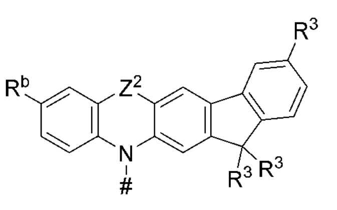
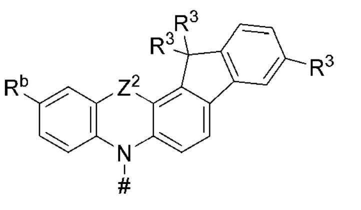
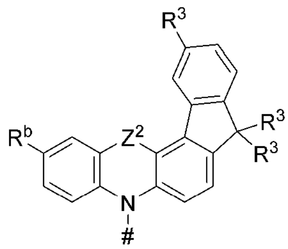

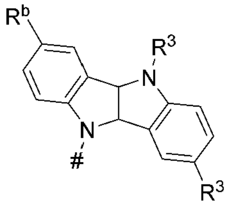
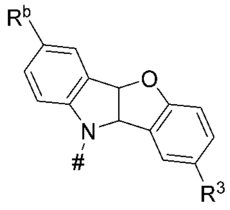
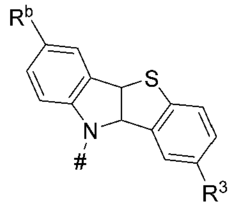
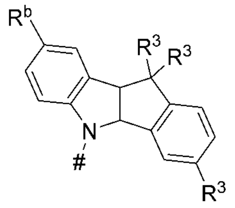

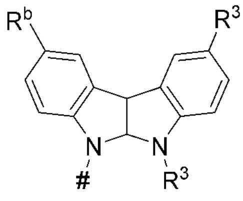 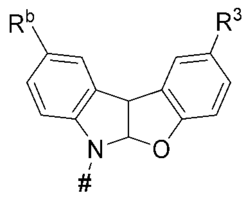 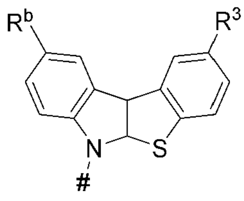 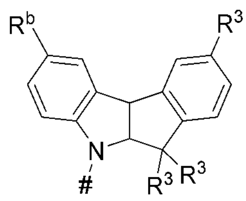 ,

wherein the aforementioned definitions apply.

Examples of second chemical moieties according to the present invention are shown below, which does of course not imply that the present invention is limited to these examples:

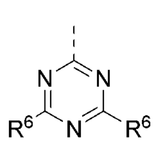 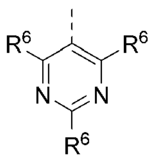 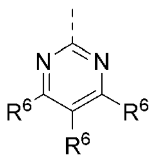 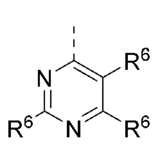 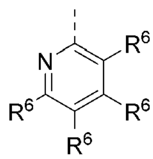 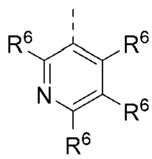

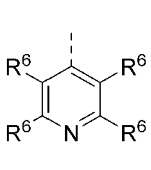 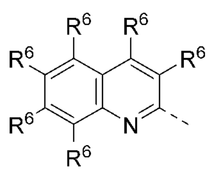 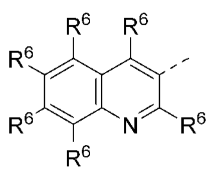 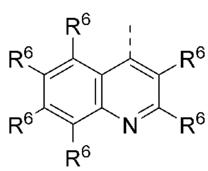

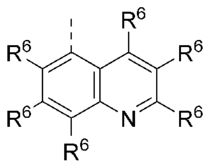 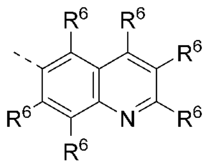 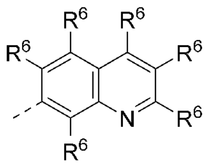 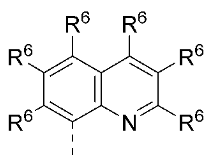

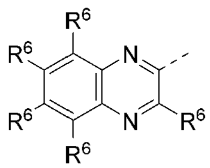 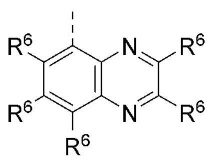 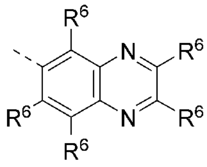 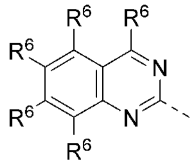

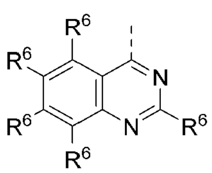 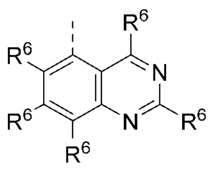 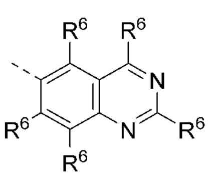 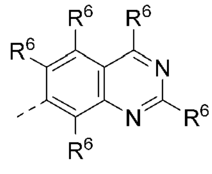

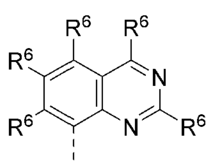 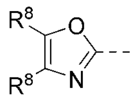 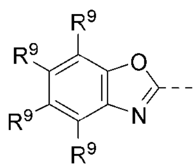 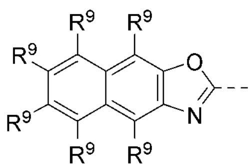 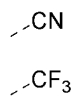

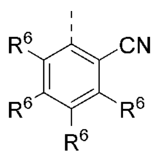 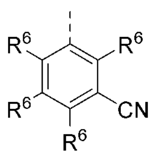 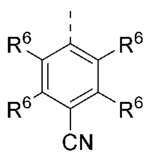 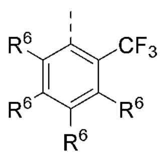 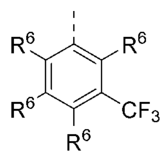 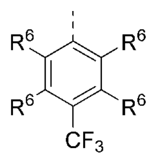

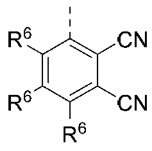 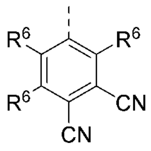 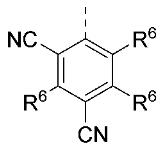 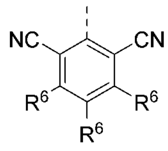 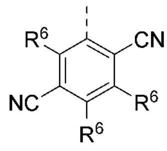 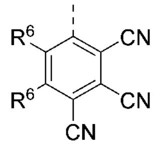

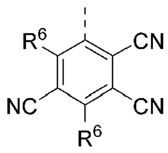 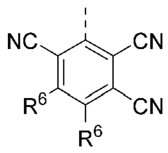 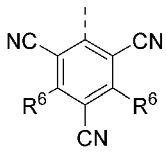 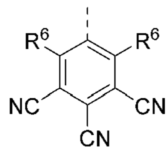 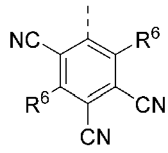 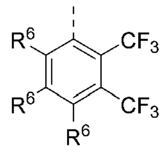

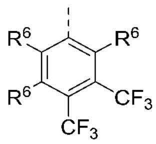 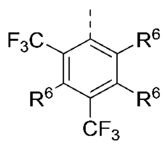 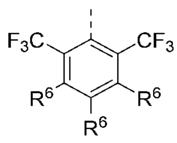 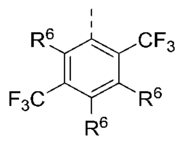 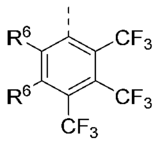 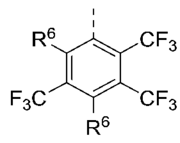

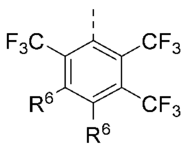 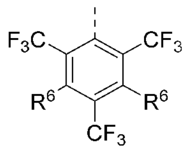 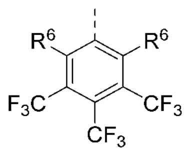 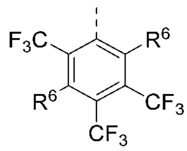 ,

wherein the aforementioned definitions apply.

In a preferred embodiment of the invention, each TADF material $E^B$ has a structure represented by any of formulas $E^B$-I, $E^B$-II, $E^B$-III, $E^B$-IV, $E^B$-V, $E^B$-VI, $E^B$-VII, $E^B$-VIII, and $E^B$-IX, $E^B$-X, and $E^B$-XI:

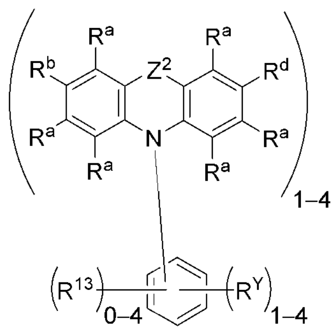

Formula $E^B$-I

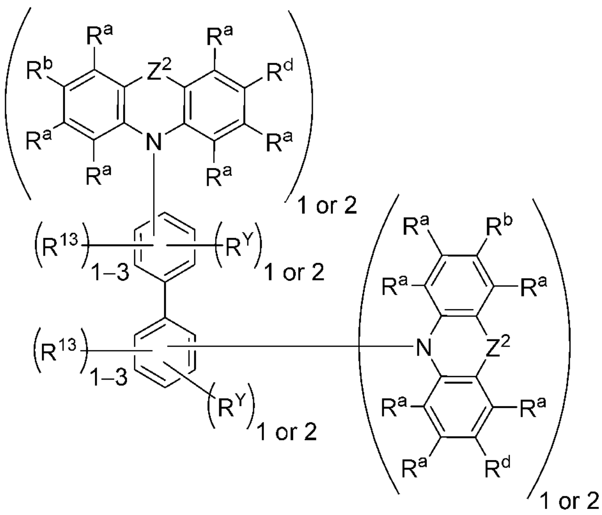

Formula $E^B$-II

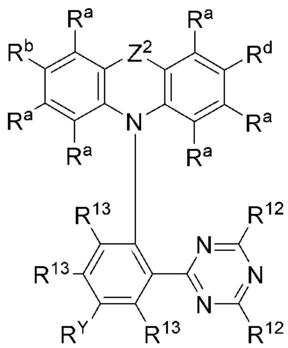

Formula $E^B$-III

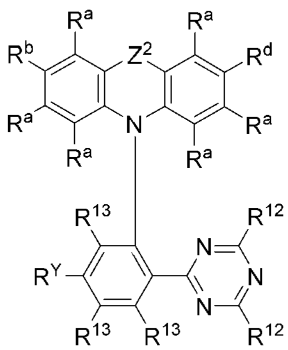

Formula $E^B$-IV

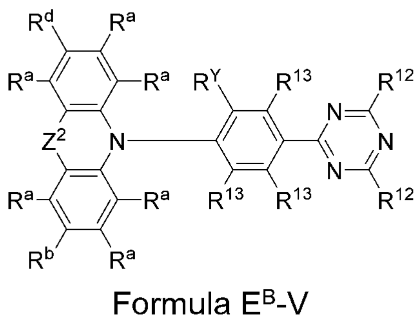

Formula $E^B$-V

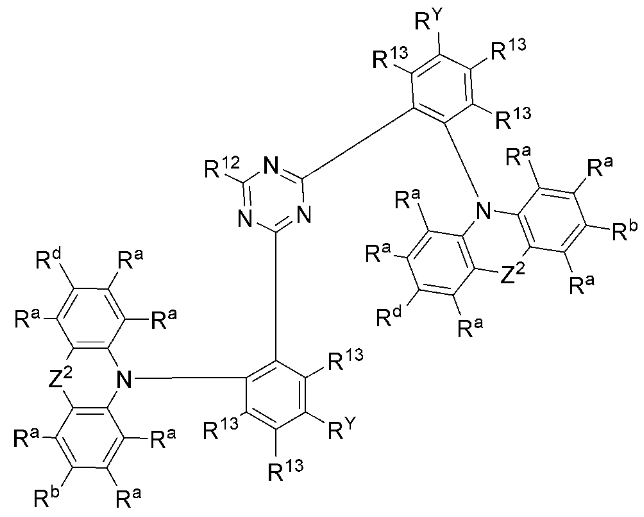

Formula $E^B$-VI

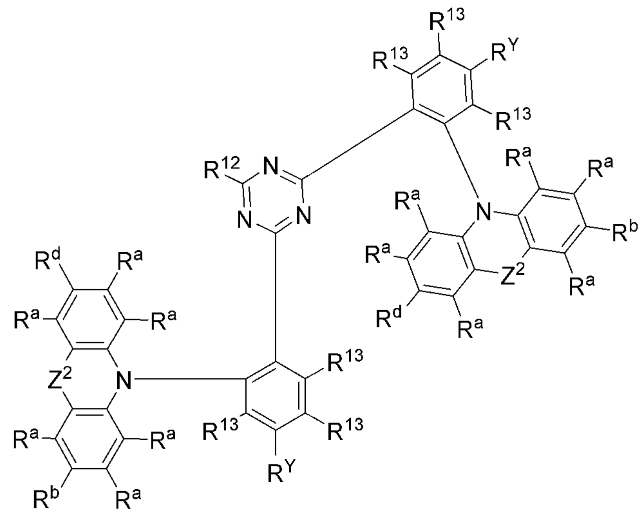

Formula $E^B$-VII

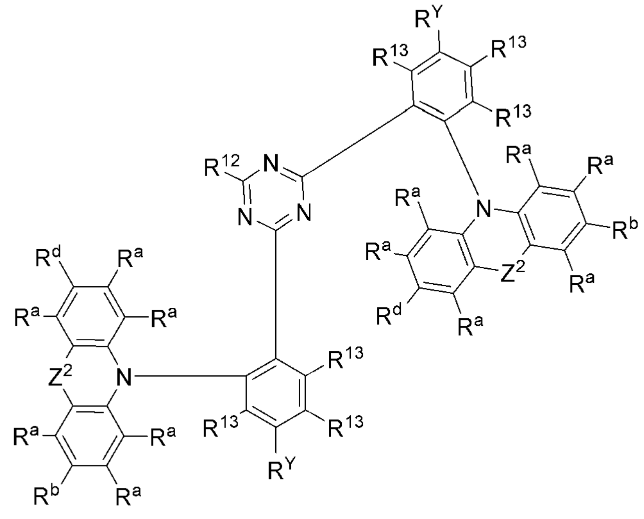

Formula $E^B$-VIII

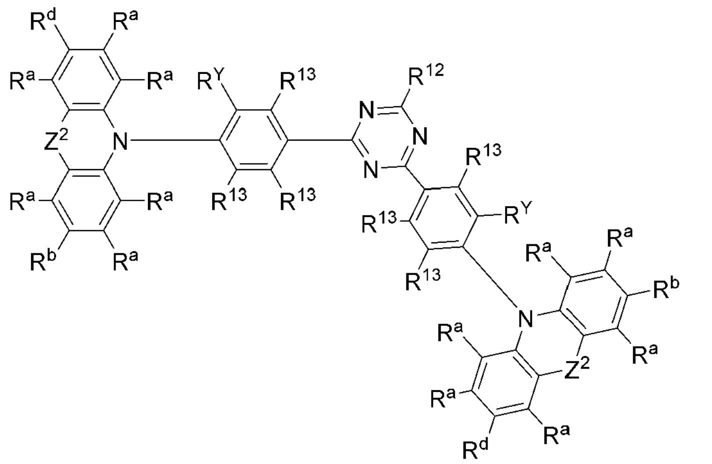

Formula $E^B$-IX,

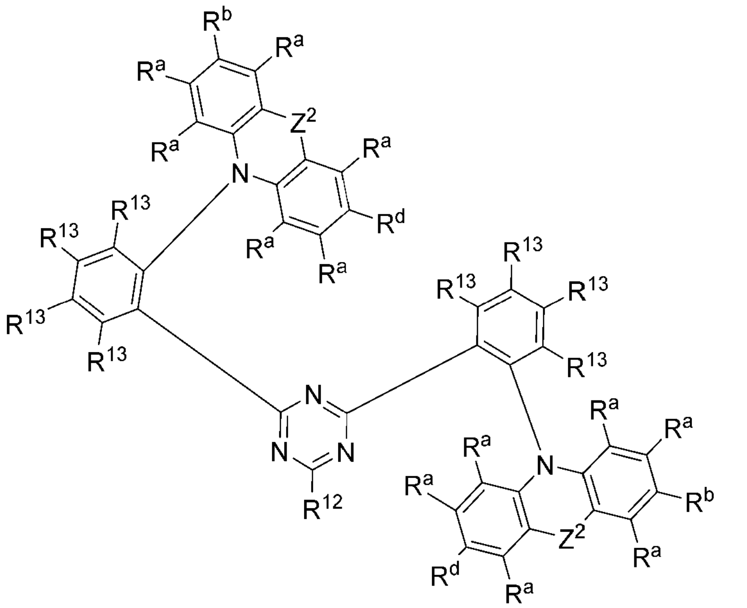

Formula $E^B$-X

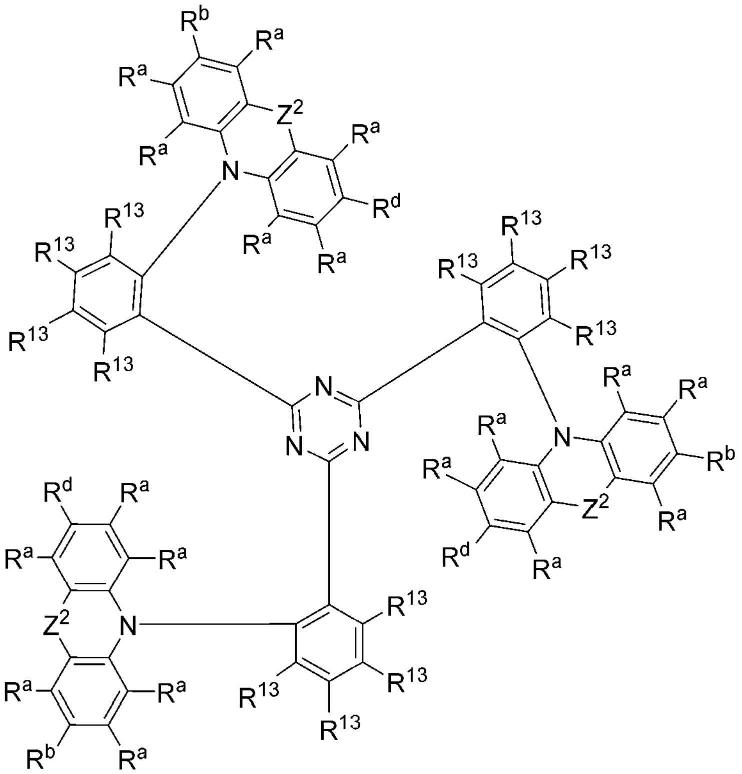

Formula $E^B$-XI

wherein

$R^{13}$ is defined as $R^{11}$ with the provision that $R^{13}$ cannot be a binding site of a single bond connecting a first or a second chemical moiety to the third chemical moiety;

$R^Y$ is selected from CN and $CF_3$ or $R^Y$ comprises or consists of a structure according to formula BN-I:

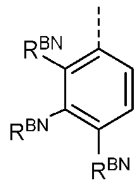

Formula BN-I,

which is bonded to the structure of formula $E^B$-I, $E^B$-II, $E^B$-III, $E^B$-IV, $E^B$-V, $E^B$-VI, $E^B$-VII, $E^B$-VIII or $E^B$-IX via a single bond indicated by the dashed line and wherein exactly one $R^{BN}$ group is CN while the other two $R^{BN}$ groups are both hydrogen (H); and wherein apart from that the above-mentioned definitions apply.

In a preferred embodiment of the invention, $R^{13}$ is at each occurrence hydrogen.

In one embodiment of the invention, $R^Y$ is at each occurrence CN.

In one embodiment of the invention, $R^Y$ is at each occurrence $CF_3$.

In one embodiment of the invention, $R^Y$ is at each occurrence a structure represented by formula BN-I.

In a preferred embodiment of the invention, $R^Y$ is at each occurrence independently of each other selected from CN and a structure represented by formula BN-I.

In a preferred embodiment of the invention, each TADF material $E^B$ has a structure represented by any of formulas $E^B$-I, $E^B$-II, $E^B$-III, $E^B$-IV, $E^B$-V, $E^B$-VI, $E^B$-VII, and $E^B$-X, wherein the aforementioned definitions apply.

In a preferred embodiment of the invention, each TADF material $E^B$ has a structure represented by any of formulas $E^B$-I, $E^B$-II, $E^B$-III, $E^B$-V, and $E^B$-X, wherein the aforementioned definitions apply.

Examples of TADF materials $E^B$ for use in organic electroluminescent devices according to the invention are listed in the following, whereat this does not imply that only the shown examples are suitable TADF materials $E^B$ in the

context of the present invention.

Non-limiting examples of TADF materials $E^B$ according formula $E^B$-I are shown below:

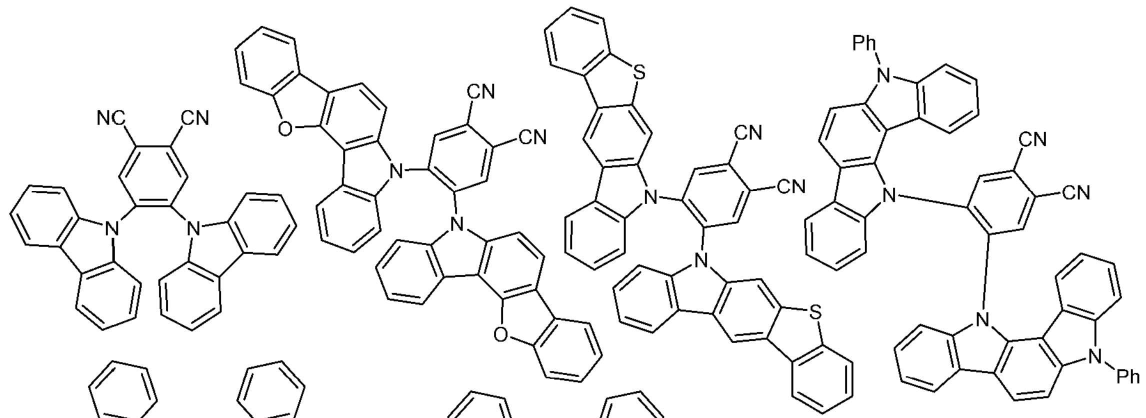

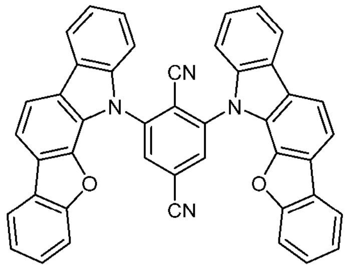

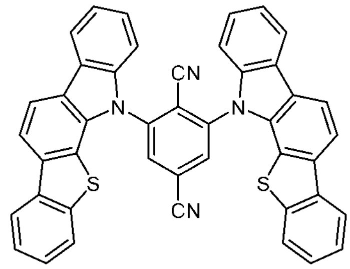

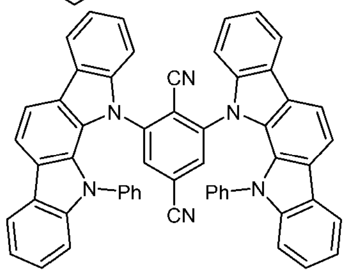

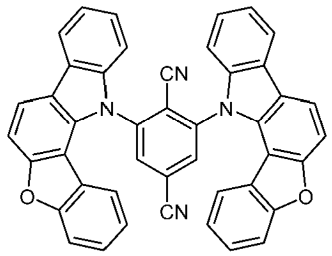

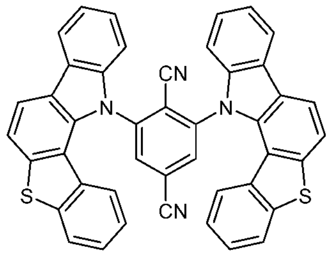

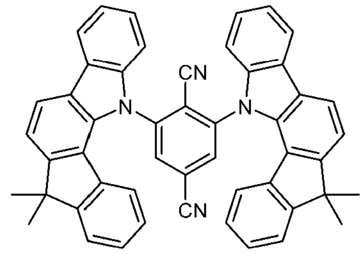

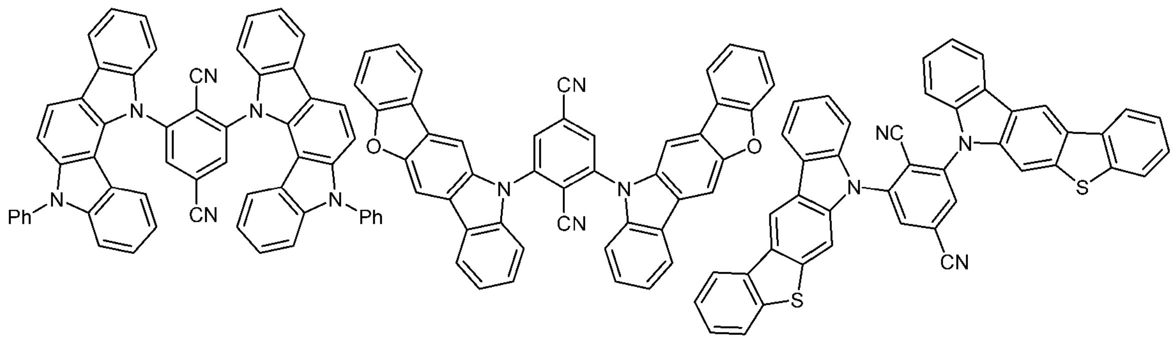

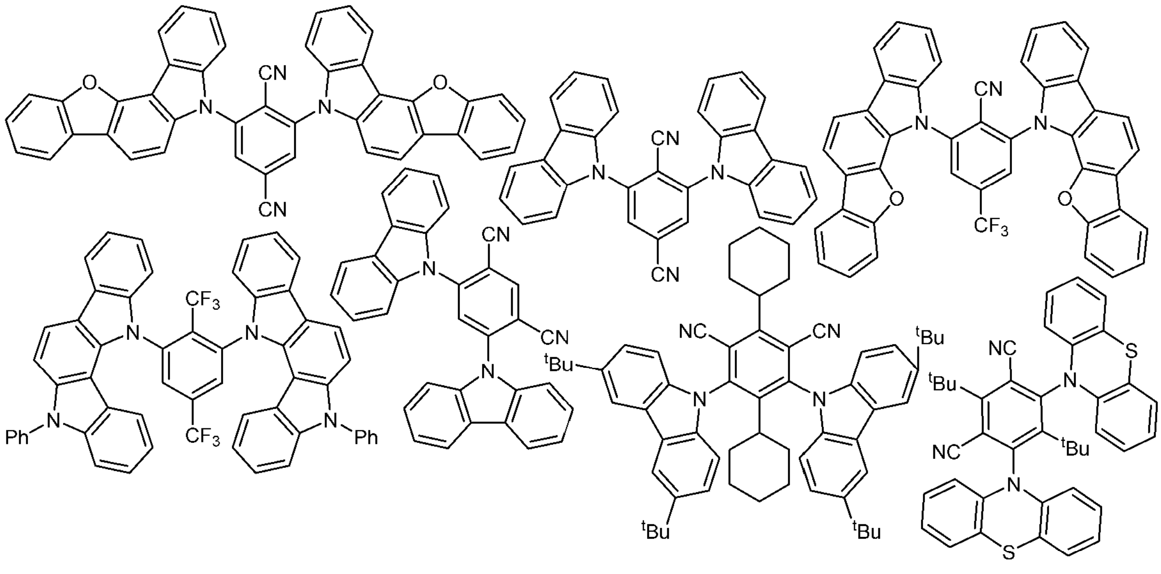

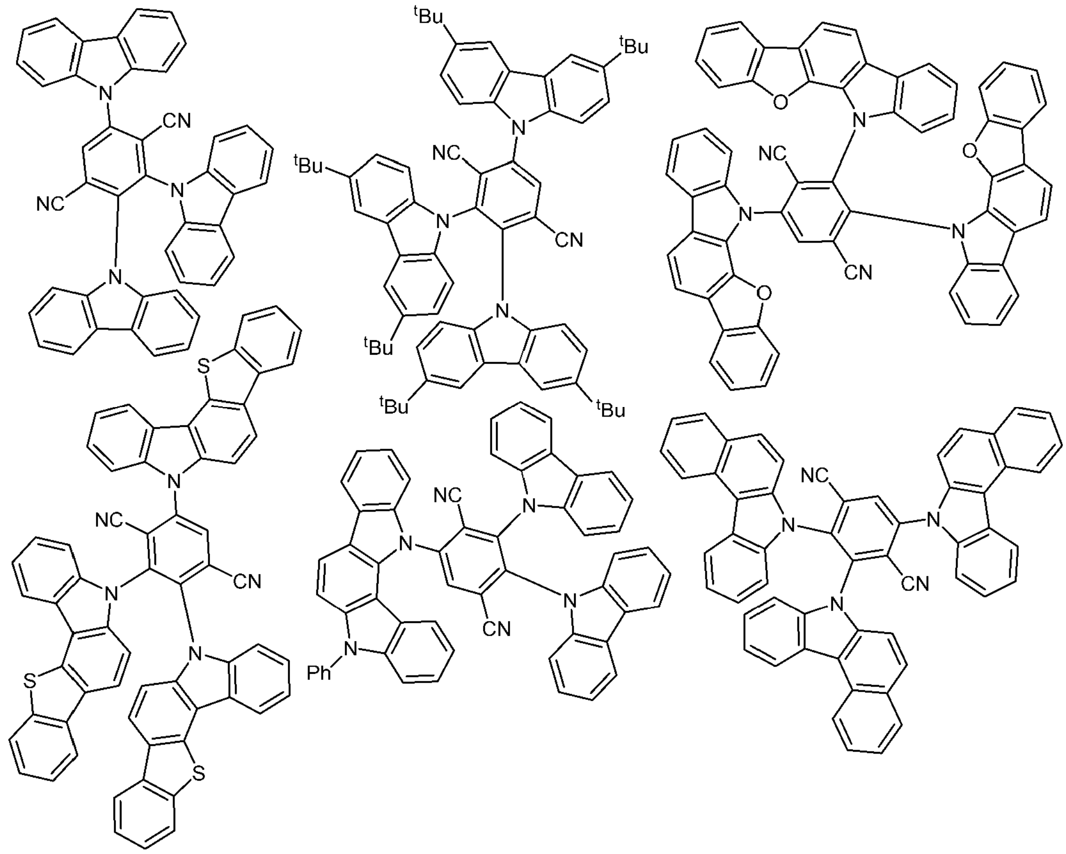

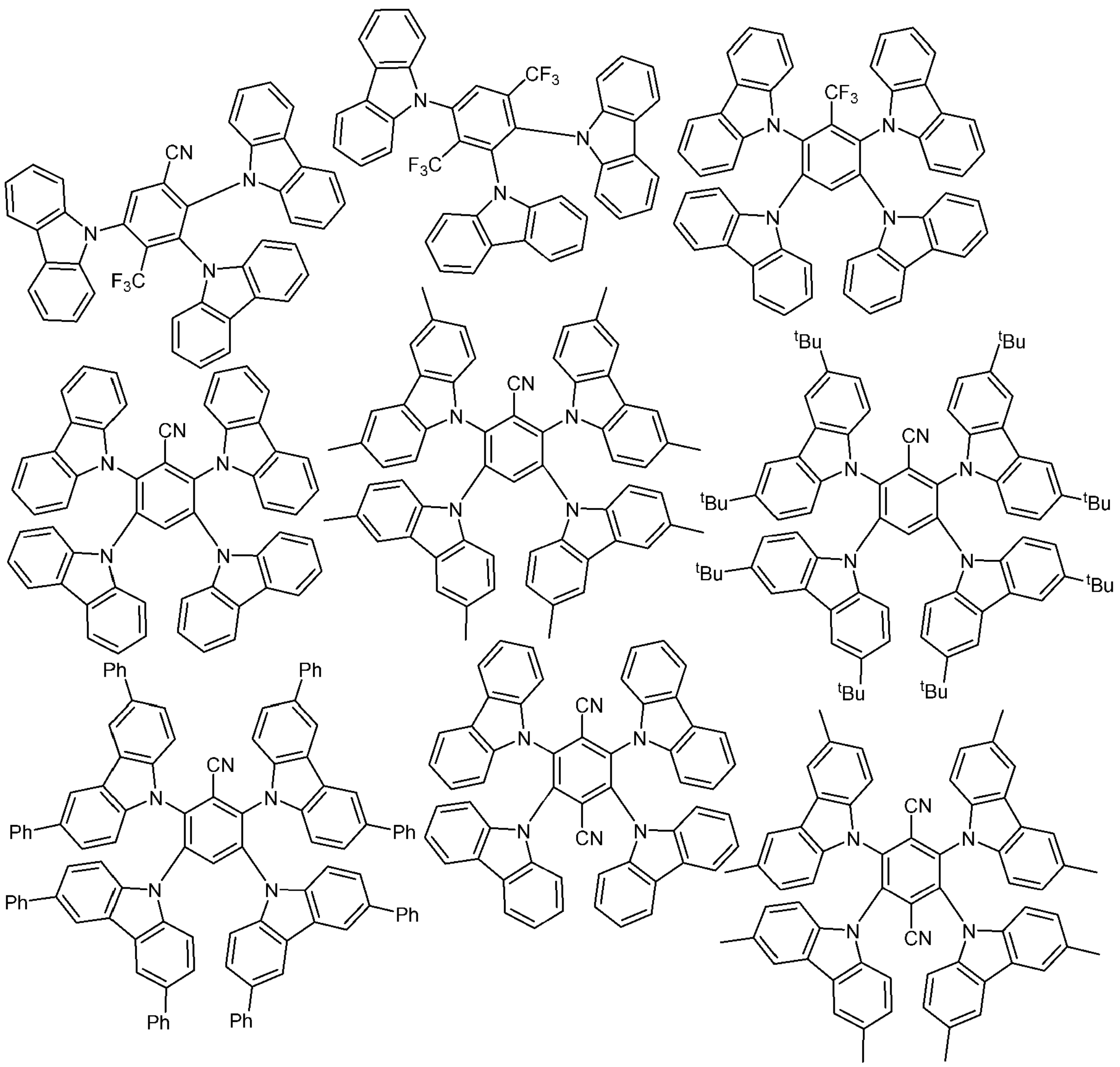

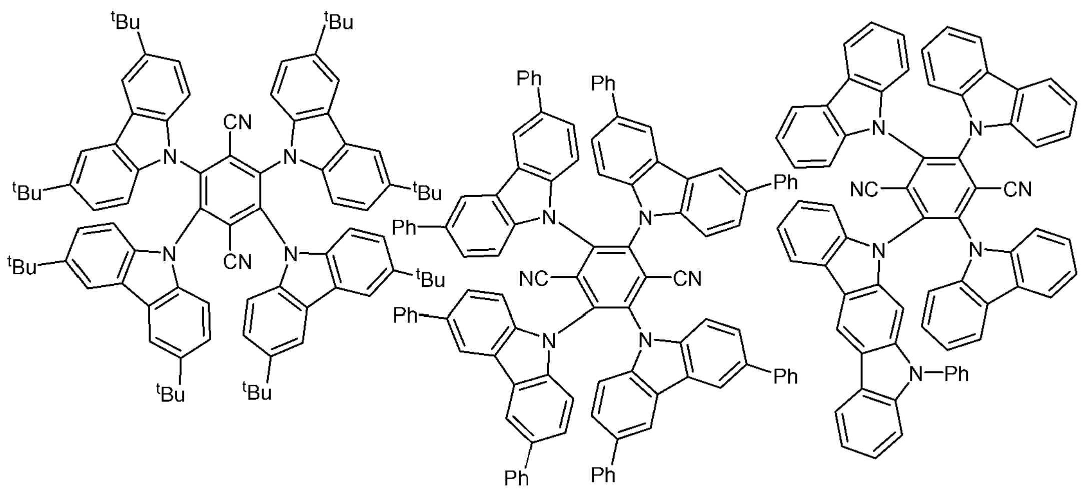

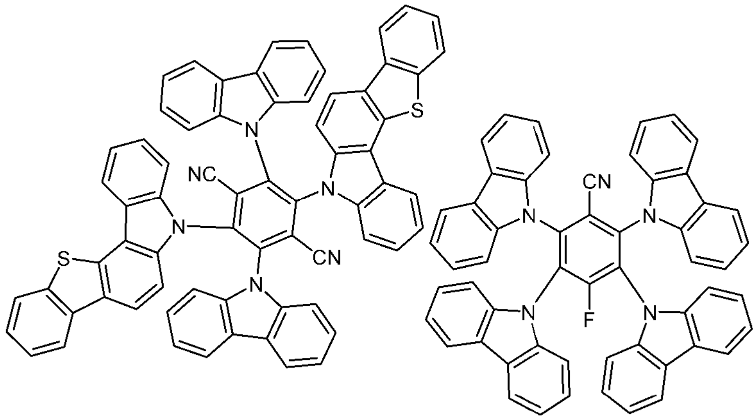

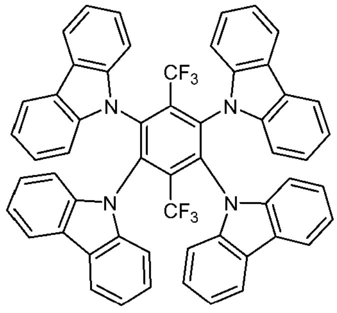

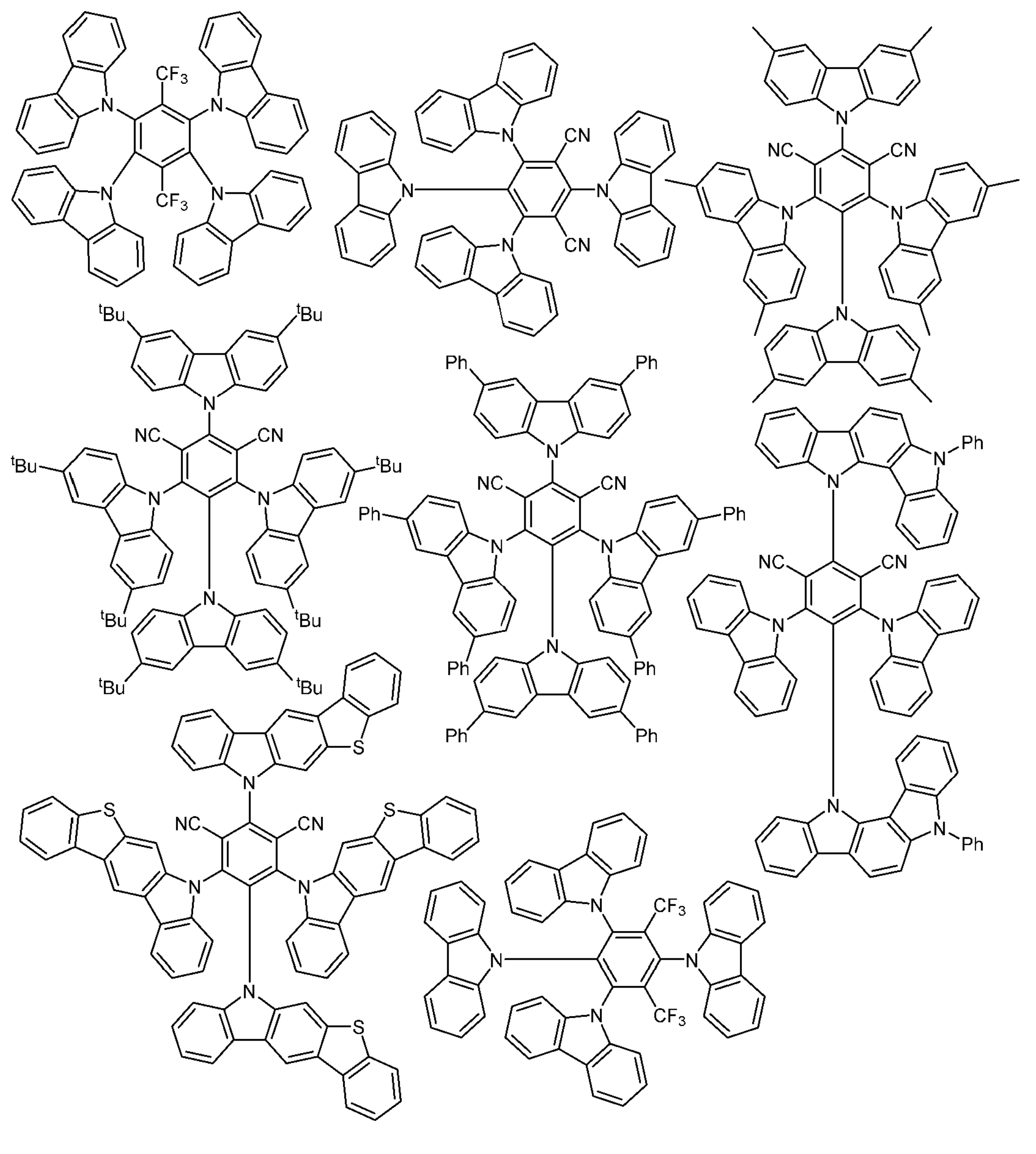

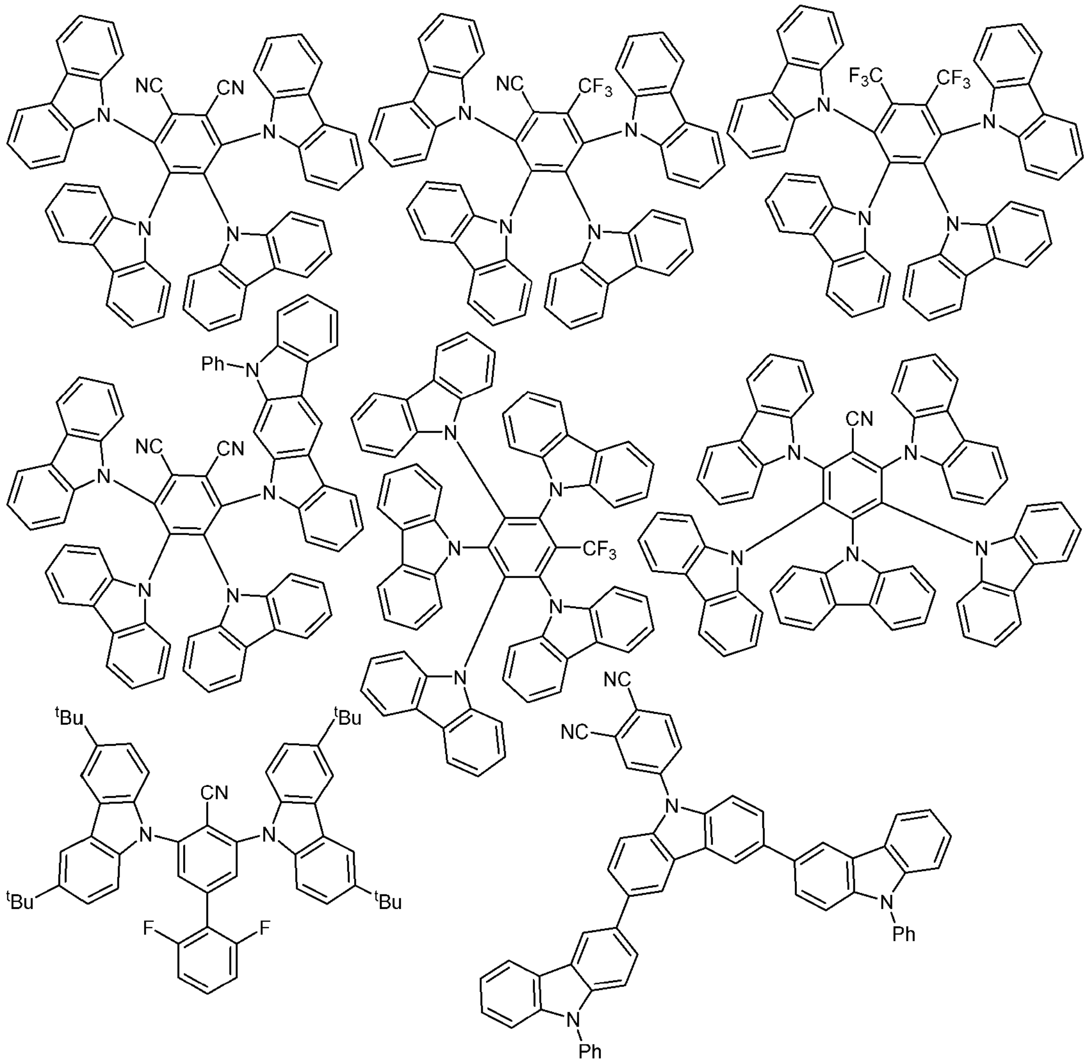

Non-limiting examples of TADF materials $E^B$ according formula $E^B$-II are shown below:

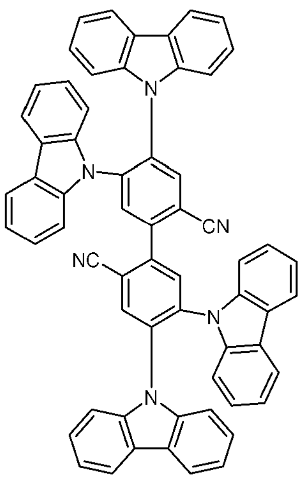

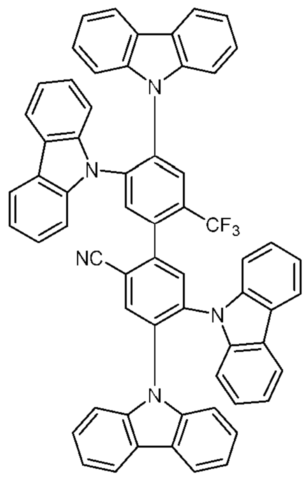

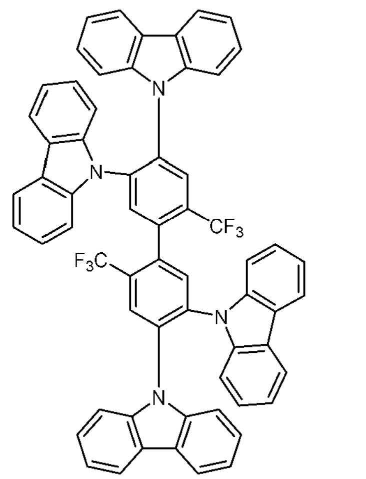

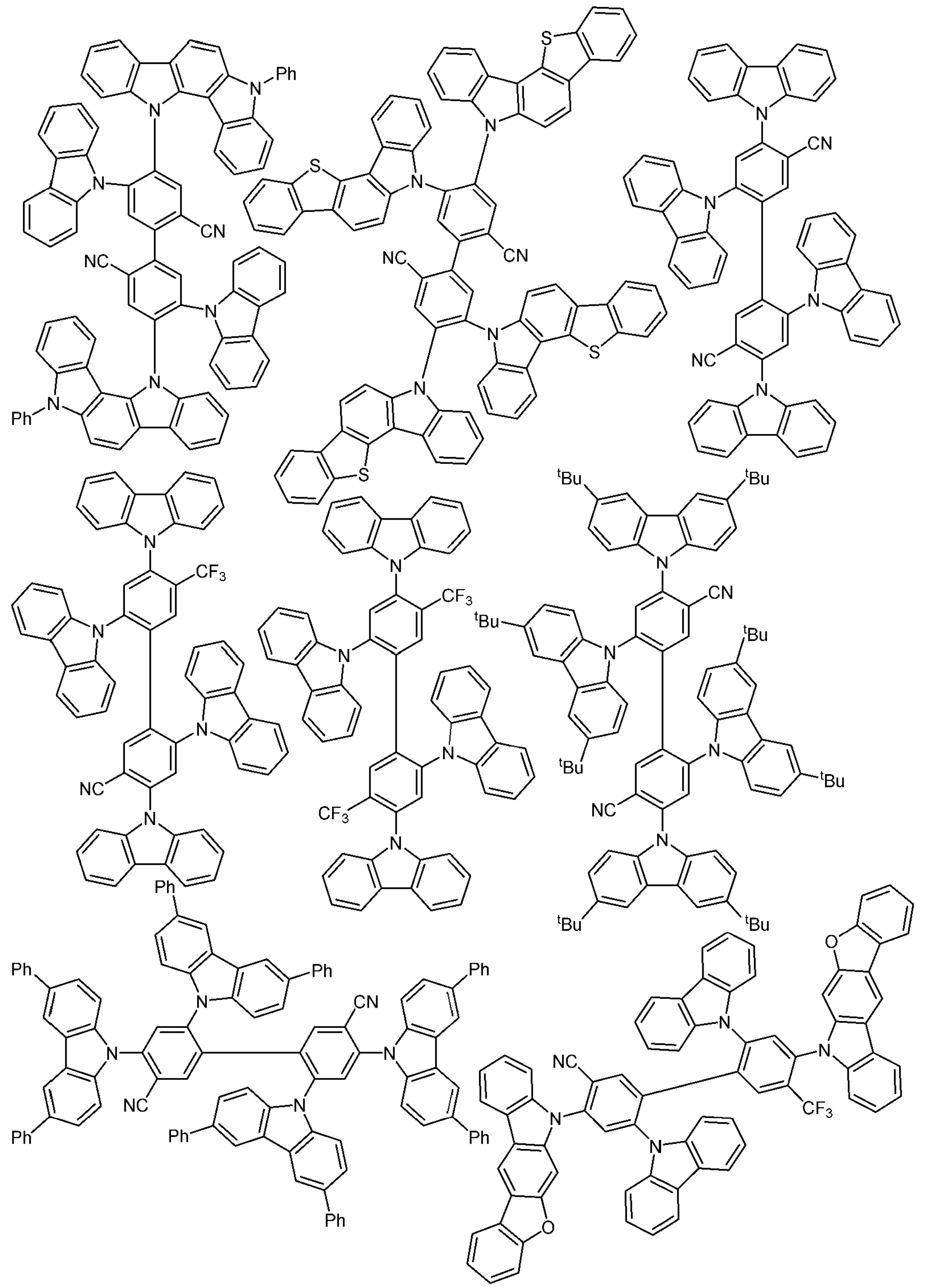

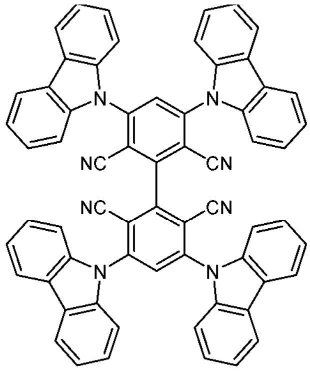

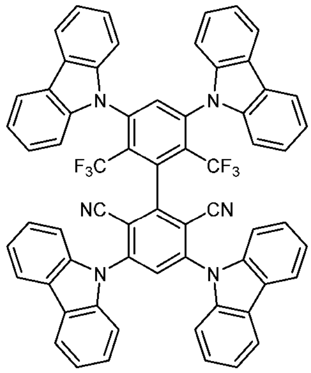

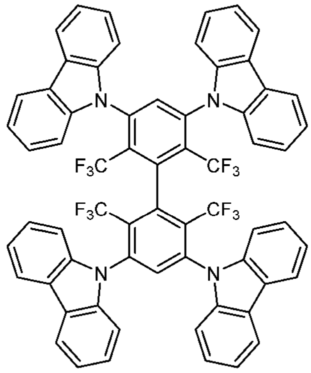

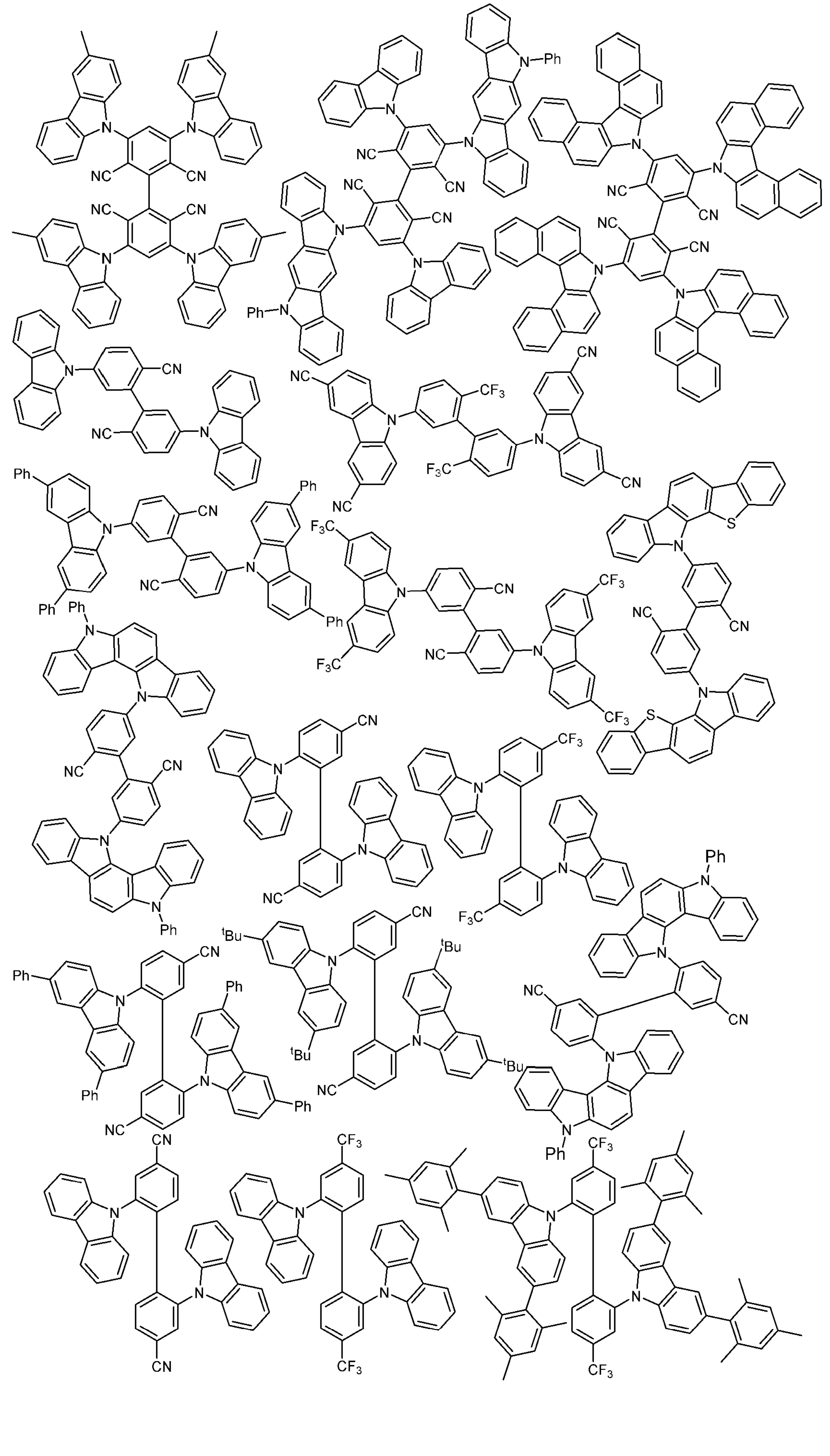

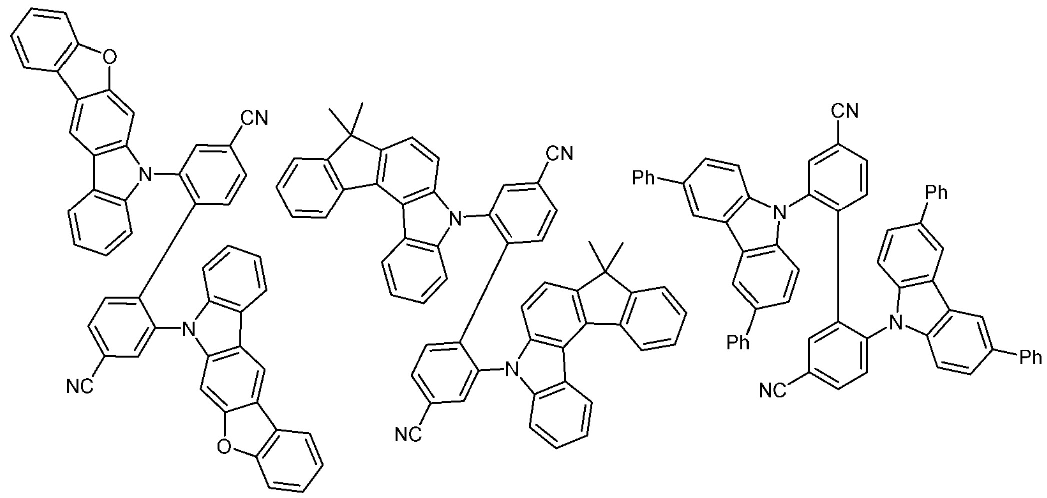

Non-limiting examples of TADF materials $E^B$ according formula $E^B$-III are shown below:

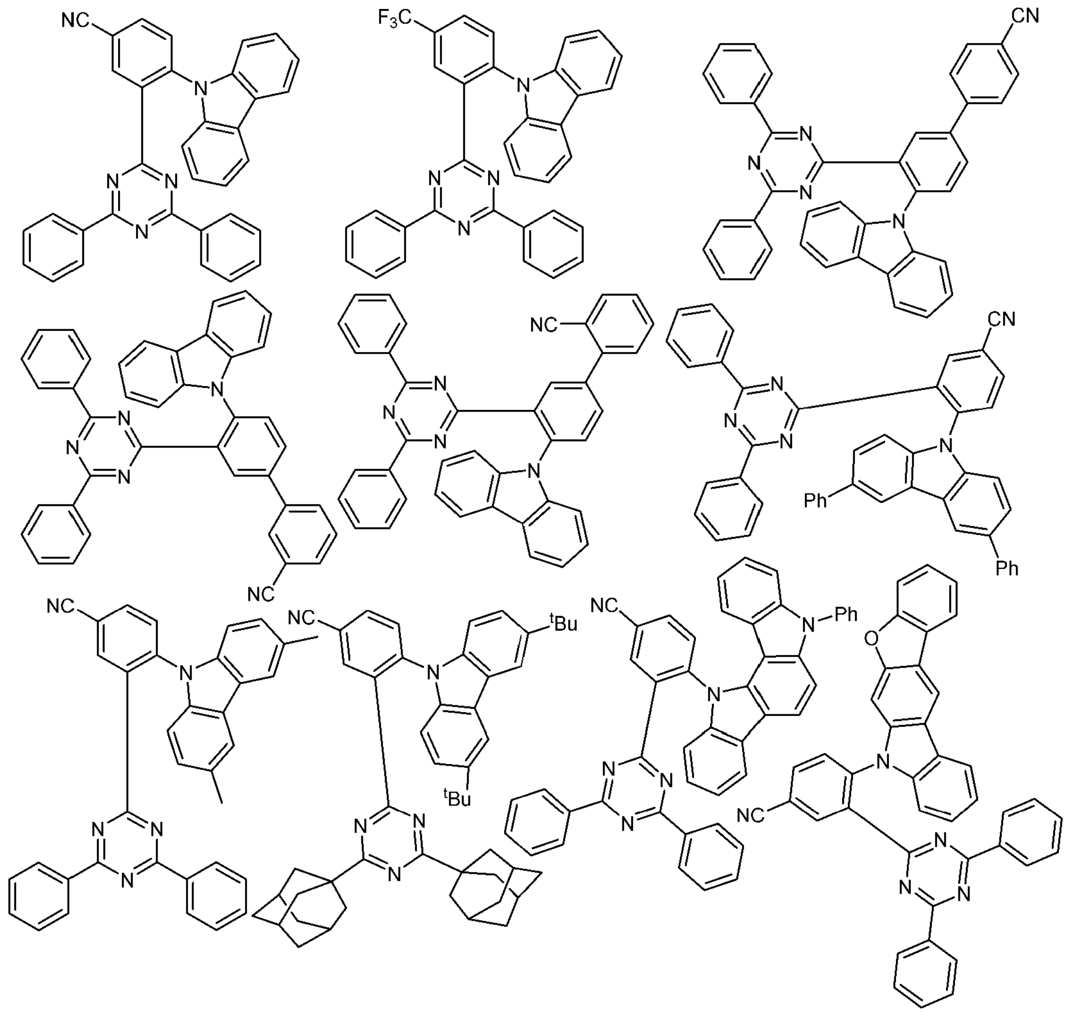

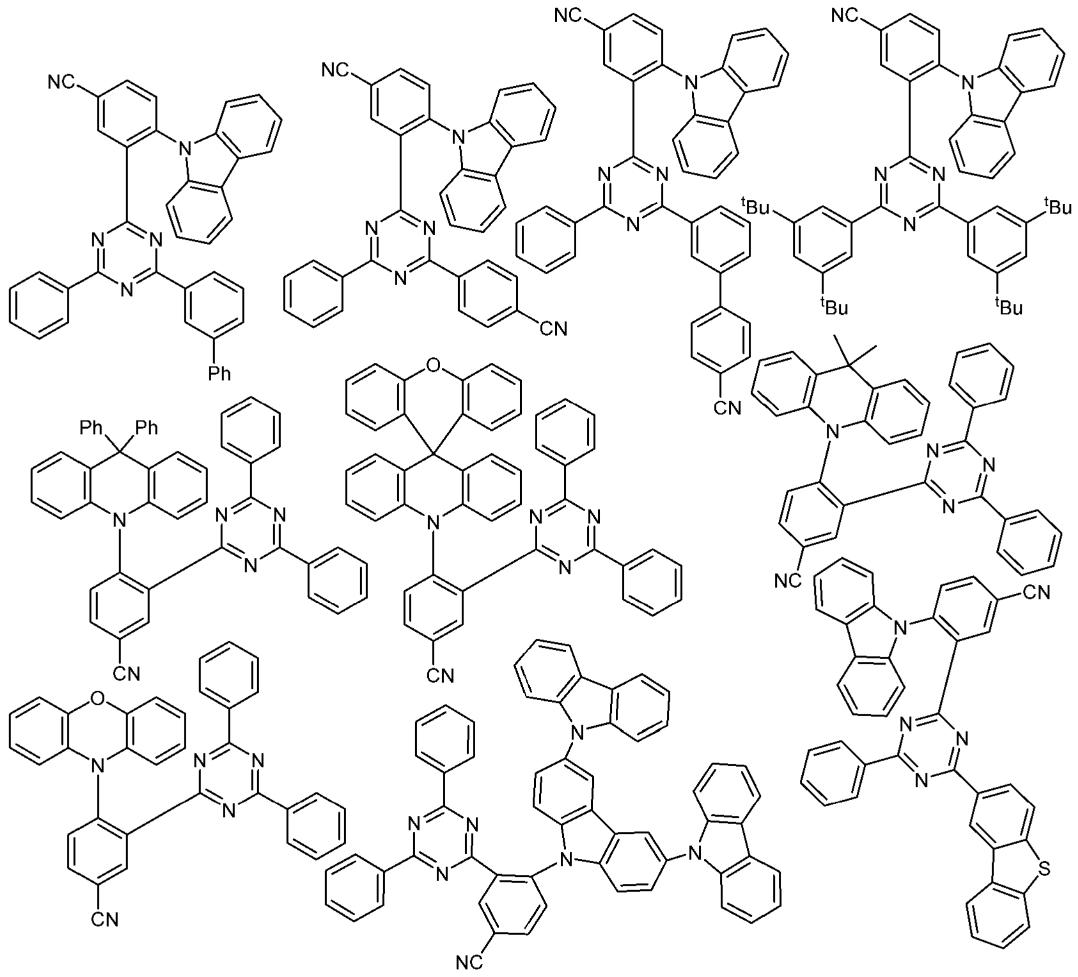

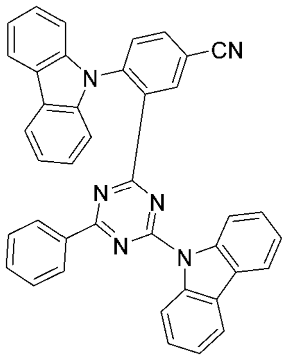

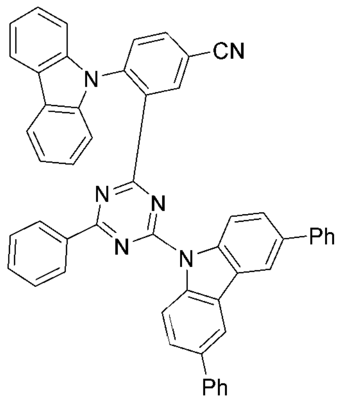

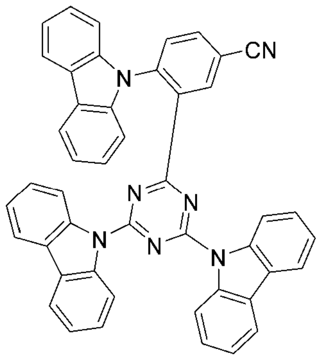

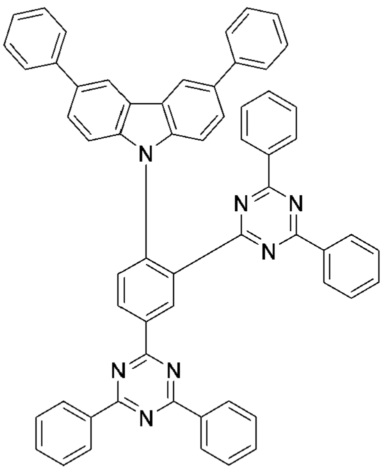
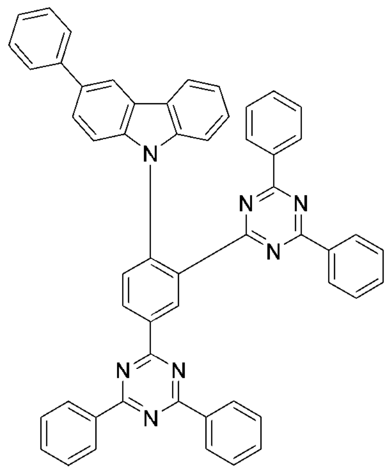
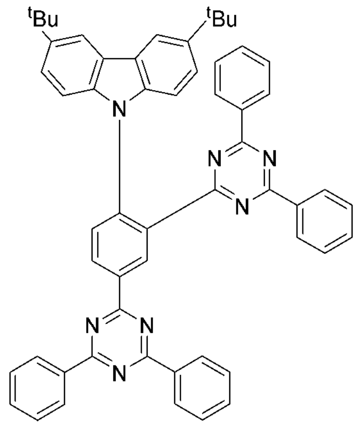

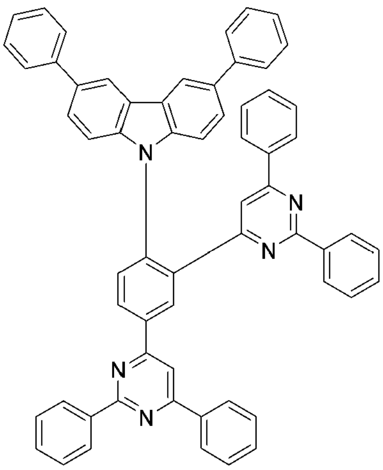
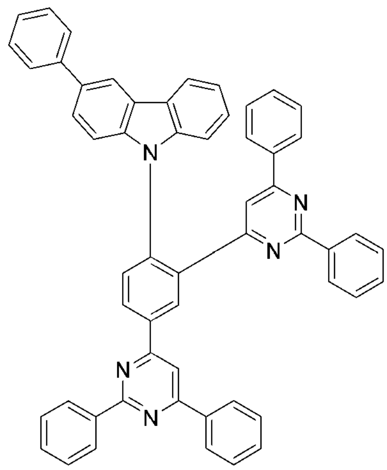
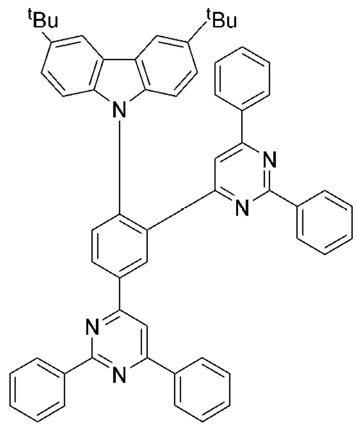

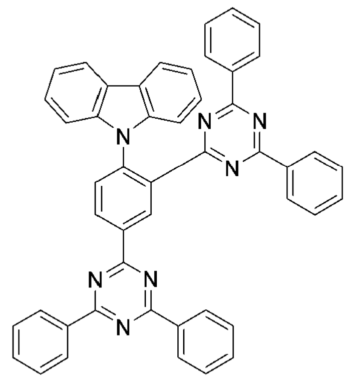
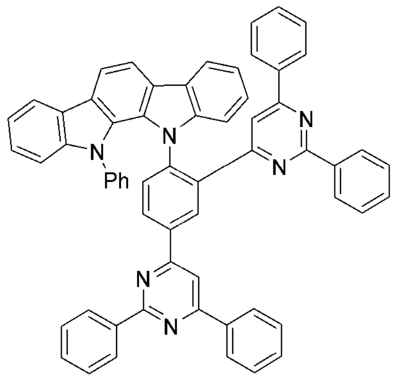
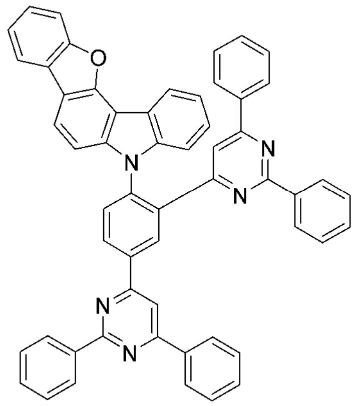

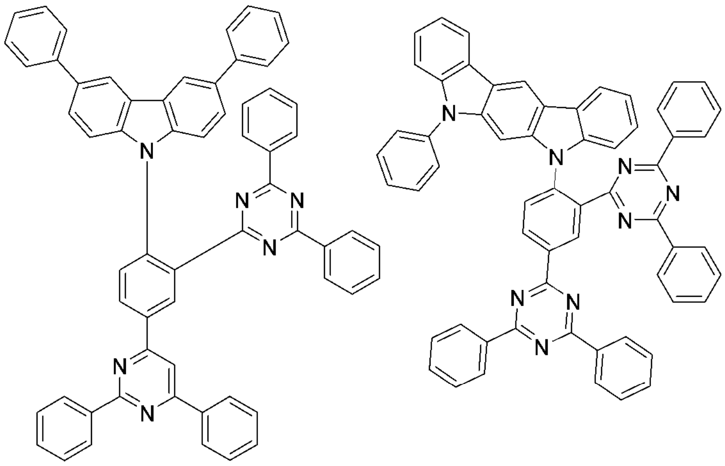
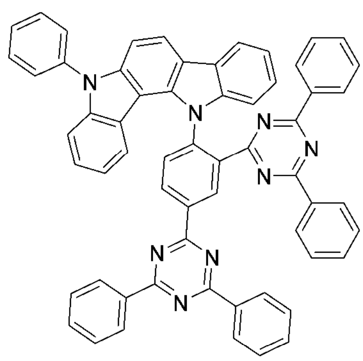

Non-limiting examples of TADF materials $E^B$ according formula $E^B$-IV are shown below:

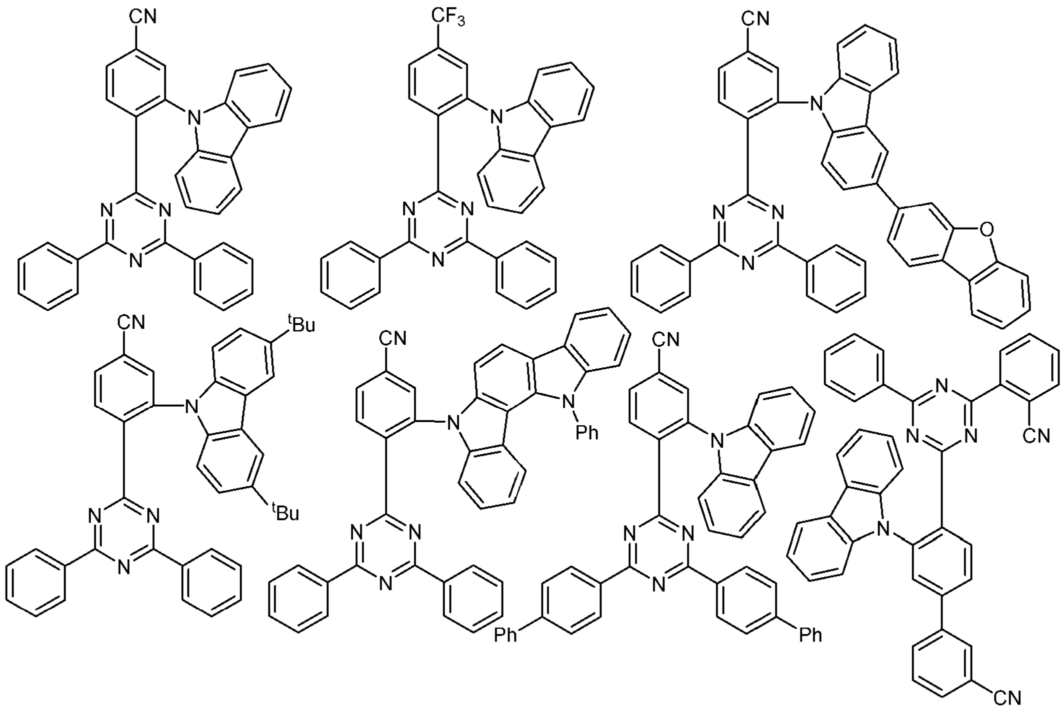

Non-limiting examples of TADF materials $E^B$ according formula $E^B$-V are shown below:

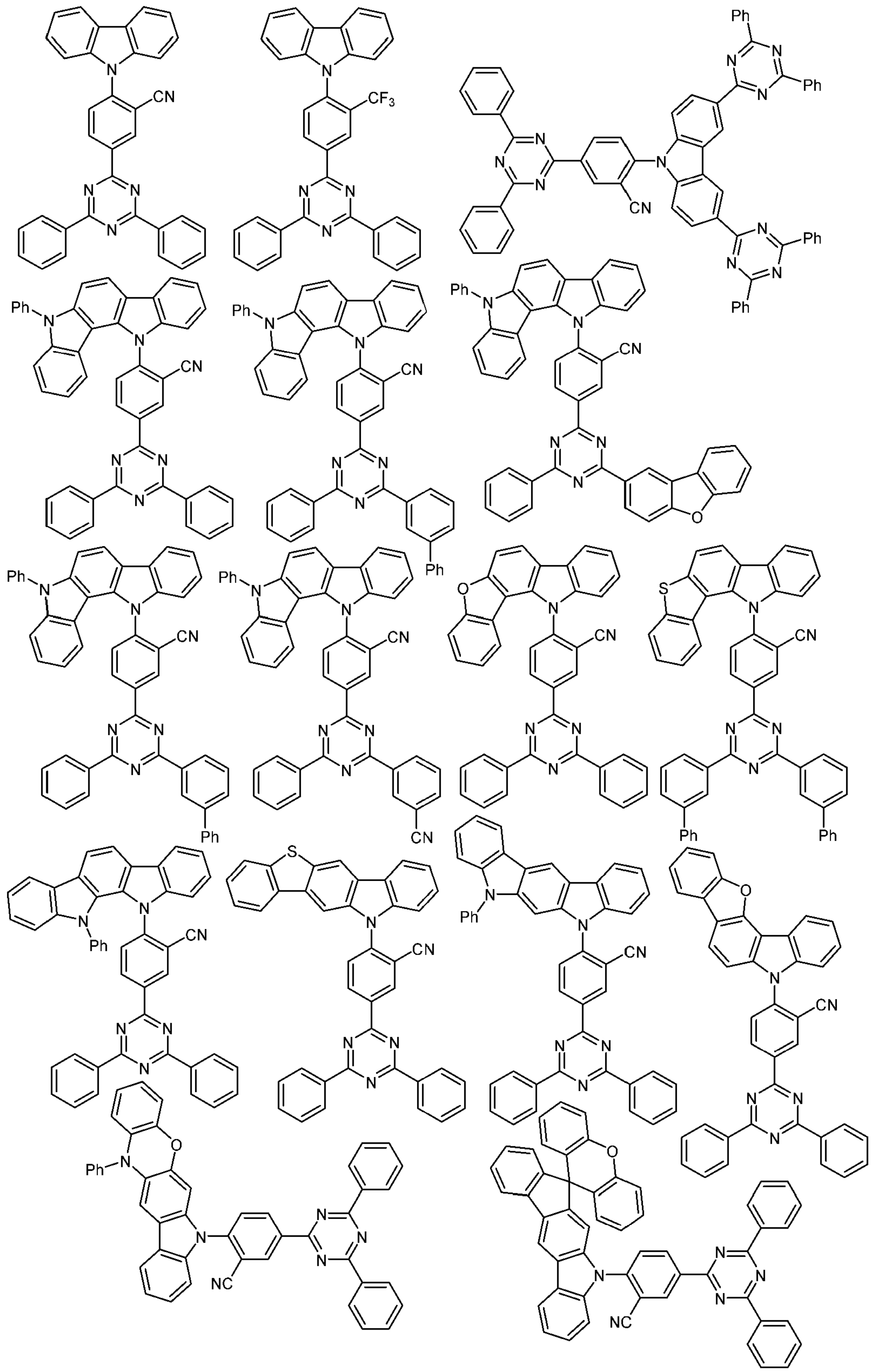

Non-limiting examples of TADF materials $E^B$ according formula $E^B$-VI are shown below:

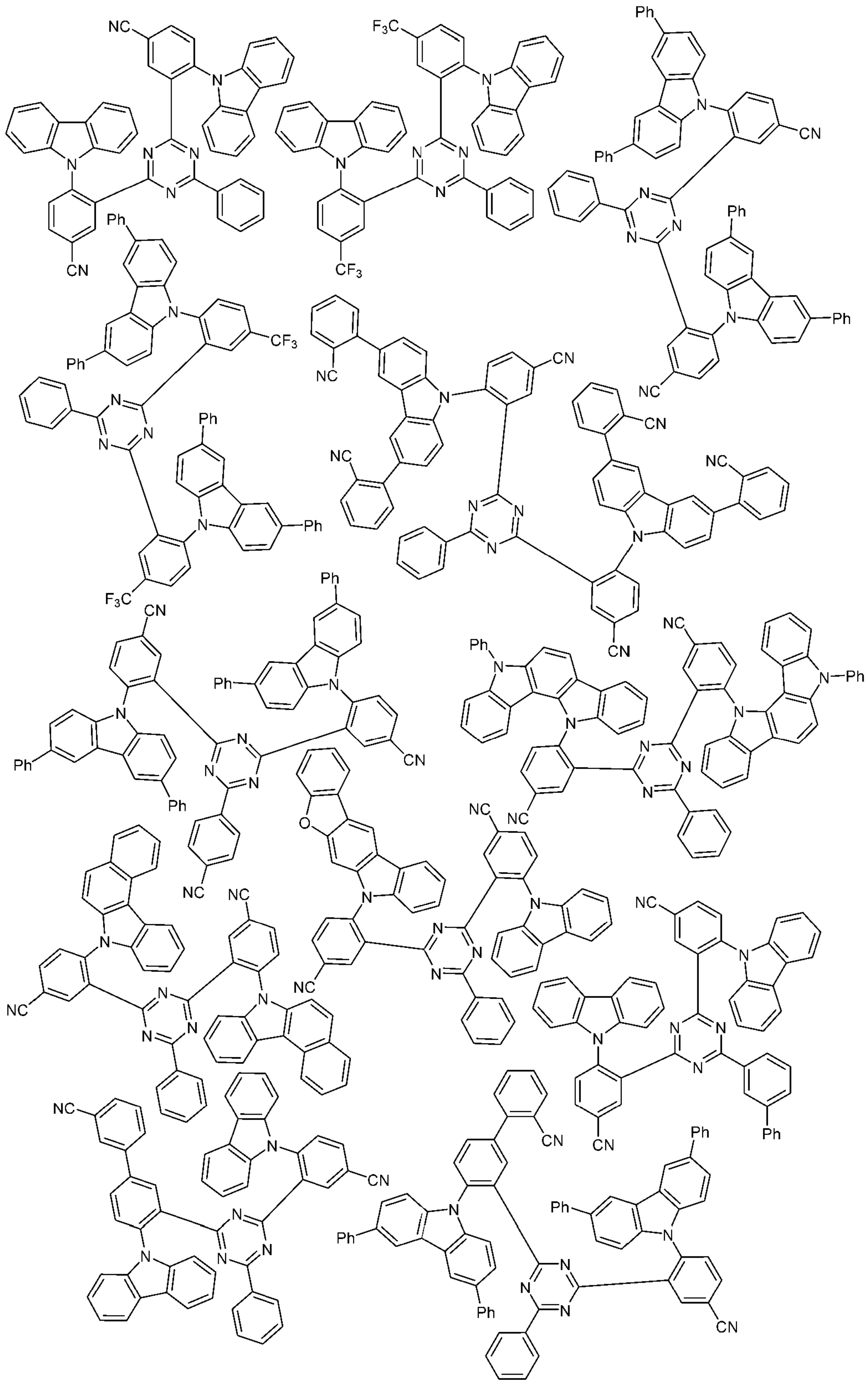

Non-limiting examples of TADF materials $E^B$ according formula $E^B$-VII are shown below:

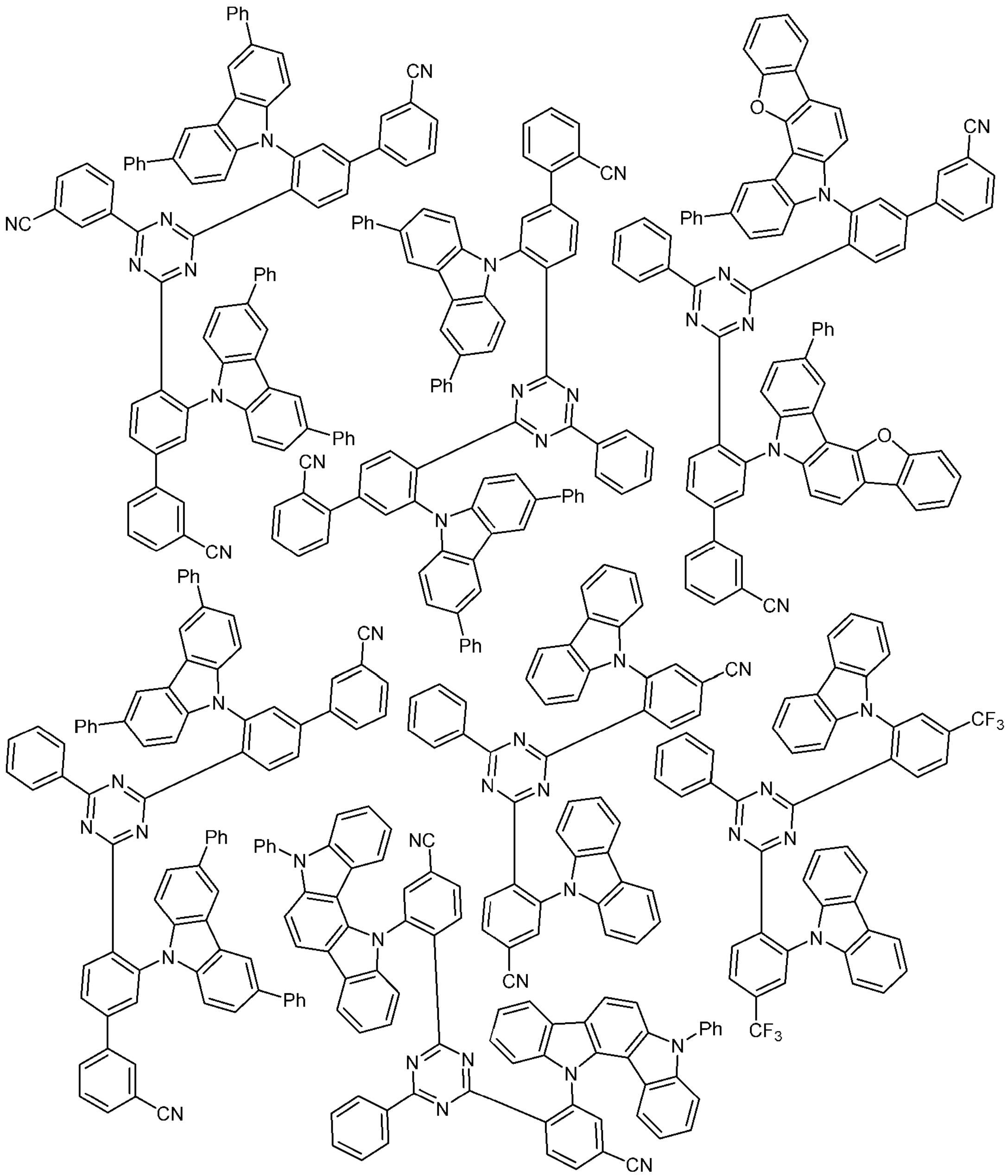

Non-limiting examples of TADF materials $E^B$ according formula $E^B$-VIII are shown below:

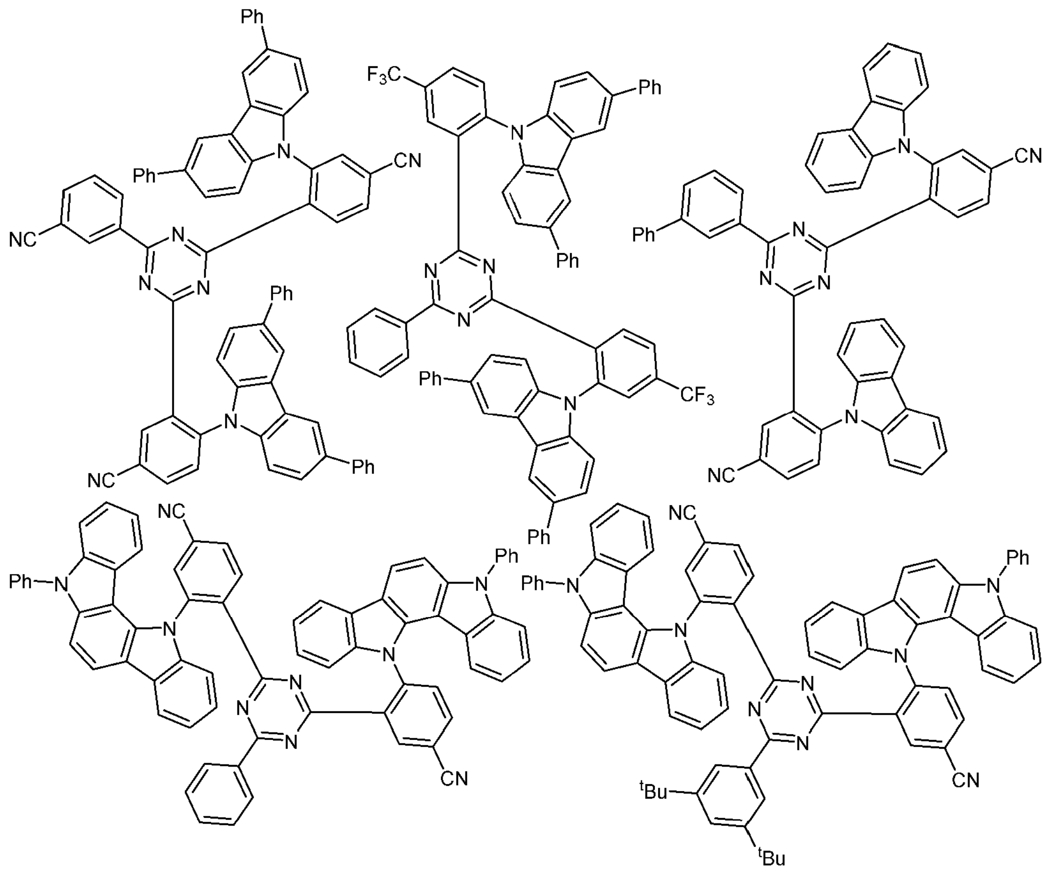

Non-limiting examples of TADF materials $E^B$ according formula $E^B$-IX are shown below:

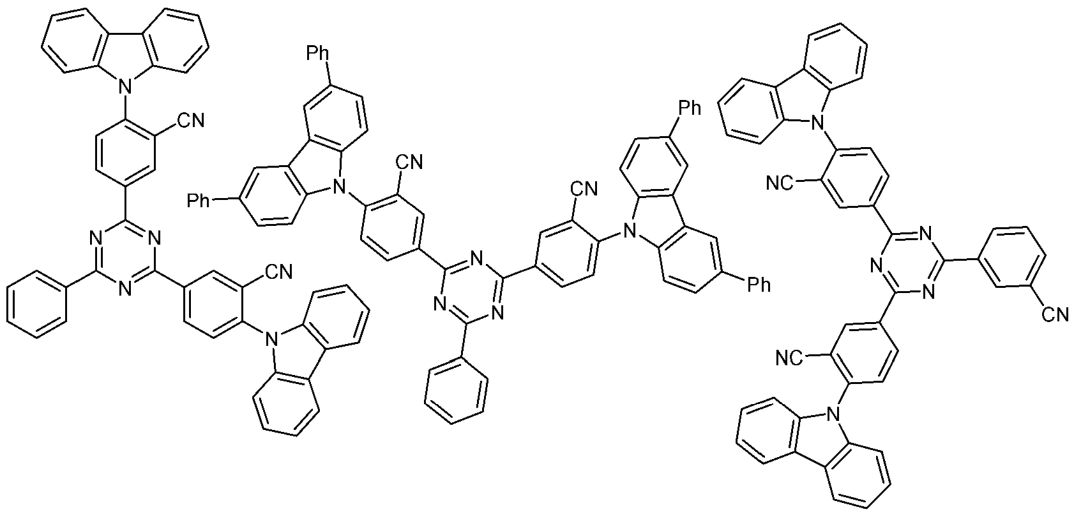

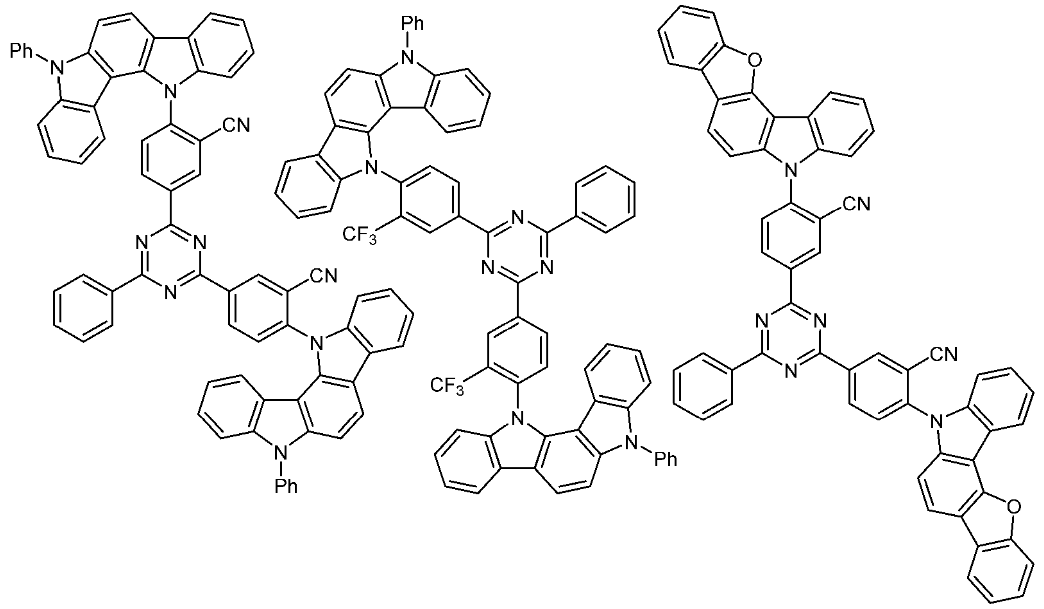

Non-limiting examples of TADF materials $E^B$ according formula $E^B$-X are shown below:

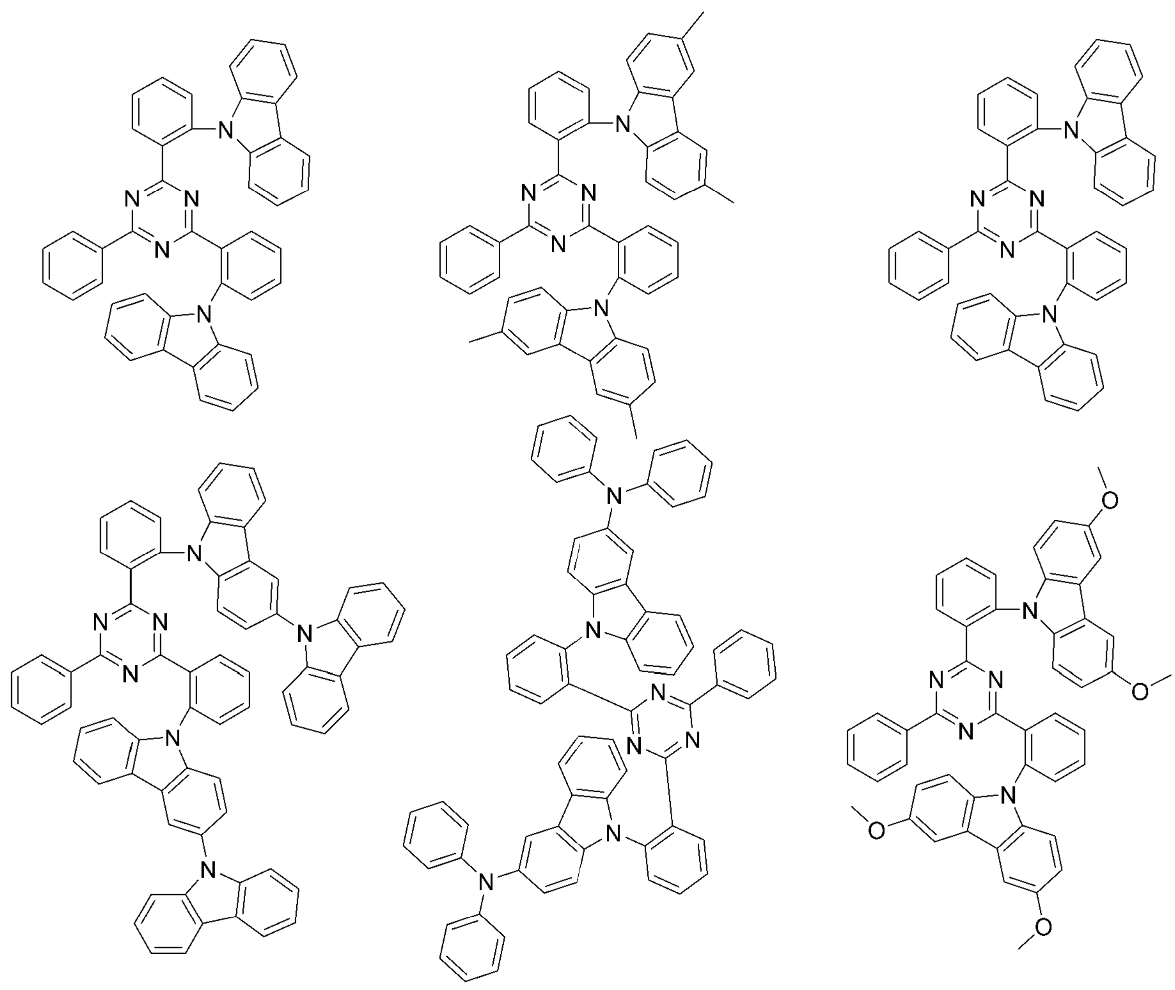

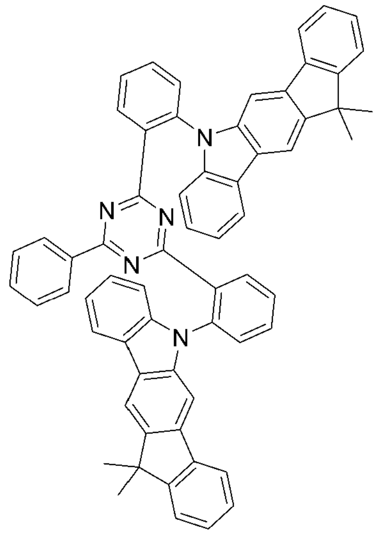

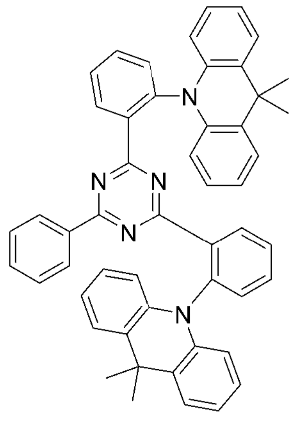

Non-limiting examples of TADF materials $E^B$ according formula $E^B$-XI are shown below:

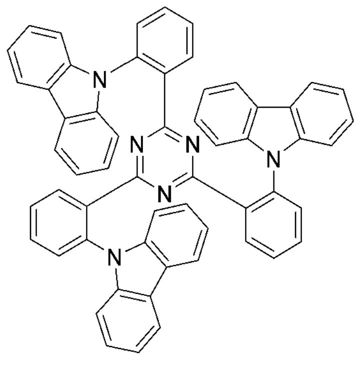

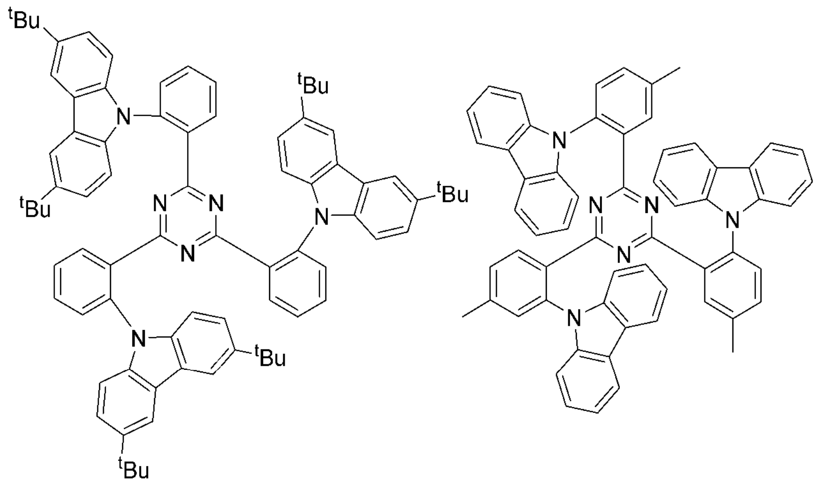

The synthesis of TADF materials $E^B$ can be accomplished via standard reactions and reaction conditions known to the skilled artisan. Typically, in a first step, a coupling reaction, preferably a palladium-catalyzed coupling reaction, may be performed, which is exemplarily shown below for the synthesis of TADF materials $E^B$ according to any of formulas $E^B$-III, $E^B$-IV, and $E^B$-V:

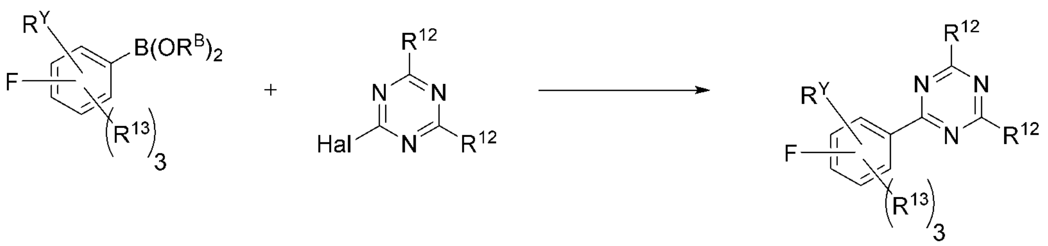

E1 E2 E3

**E1** can be any boronic acid ($R^B$=H) or an equivalent boronic acid ester ($R^B$ = alkyl or aryl), in particular two $R^B$ may form a ring to give e.g. boronic acid pinacol esters. As second reactant **E2** is used, wherein Hal refers to halogen and may be I, Br or Cl, but preferably is Br. Reaction conditions of such palladium-catalyzed coupling reactions are known the person skilled in the art, e.g. from WO 2017/005699, and it is known that the reacting groups of **E1** and **E2** can be interchanged as shown below to optimize the reaction yields:

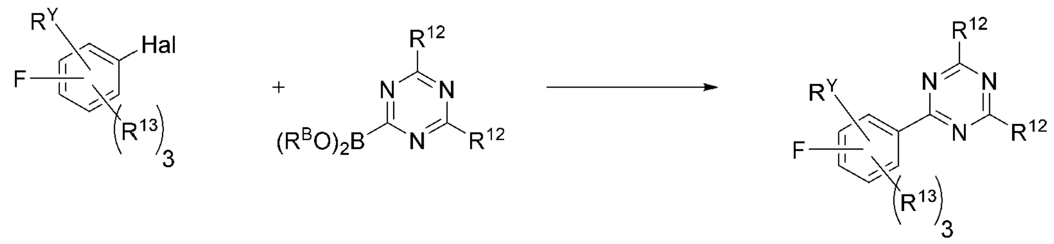

E1 E2 E3

In a second step, the TADF molecules are obtained via the reaction of a nitrogen heterocycle in a nucleophilic aromatic substitution with the aryl halide, preferably aryl fluoride **E3.** Typical conditions include the use of a base, such as tribasic potassium phosphate or sodium hydride, for example, in an aprotic polar solvent, such as dimethyl sulfoxide (DMSO) or N,N-dimethylformamide (DMF), for example.

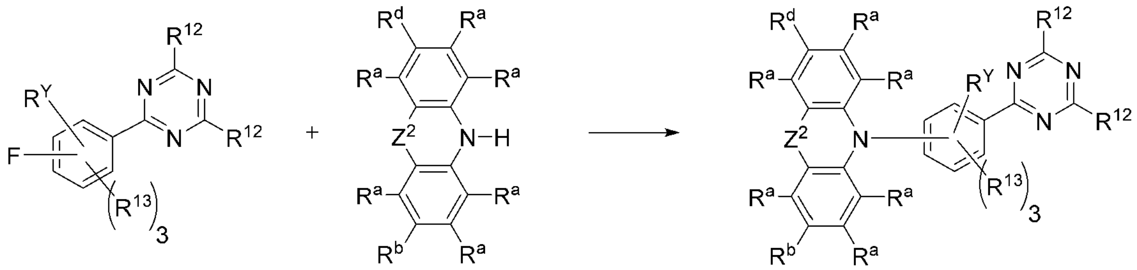

E3 E4

In particular, the donor molecule **E4** may be a 3,6-substituted carbazole (e.g., 3,6-dimethylcarbazole, 3,6-diphenylcarbazole, 3,6-di-*tert*-butylcarbazole), a 2,7-substituted carbazole (e.g., 2,7-dimethylcarbazole, 2,7-diphenylcarbazole, 2,7-di-*tert*-butylcarbazole), a 1,8-substituted carbazole (e.g., 1,8-dimethylcarbazole, 1,8-diphenylcarbazole, 1,8-di-*tert*-butylcarbazole), a 1-substituted carbazole (e.g., 1-methylcarbazole, 1-phenylcarbazole, 1-tert-butylcarbazole), a 2-substituted carbazole (e.g., 2-methylcarbazole, 2-phenylcarbazole, 2-tert-butylcarbazole), or a 3-substituted carbazole (e.g., 3-methylcarbazole, 3-phenylcarbazole, 3-*tert*-butylcarbazole).

Alternatively, a halogen-substituted carbazole, particularly 3-bromocarbazole, can be used as **E4.**

In a subsequent reaction, a boronic acid ester functional group or boronic acid functional group may be exemplarily introduced at the position of the one or more halogen substituents, which was introduced via **E4,** to yield for example the corresponding carbazolyl-boronic acid or ester such as a carbazol-3-yl-boronic acid ester or carbazol-3-yl-boronic acid, e.g., via the reaction with bis(pinacolato)diboron (CAS No. 73183-34-3). Subsequently, one or more substituents $R^a$, $R^b$ or $R^d$ may be introduced in place of the boronic acid ester group or the boronic acid group via a coupling reaction with the corresponding halogenated reactant, e.g. $R^a$-Hal, preferably $R^a$-Cl and $R^a$-Br.

Alternatively, one or more substituents $R^a$, $R^b$ or $R^d$ may be introduced at the position of the one or more halogen substituents, which was introduced via D-H, via the reaction with a boronic acid of the substituent $R^2$ [$R^a$-$B(OH)_2$], $R^b$ [$R^b$-$B(OH)_2$] or $R^d$ [$R^d$-$B(OH)_2$] or a corresponding boronic acid ester.

Further TADF materials $E^B$ may be obtained analogously. A TADF material $E^B$ may also be obtained by any alternative synthesis route suitable for this purpose.

An alternative synthesis route may comprise the introduction of a nitrogen heterocycle via copper- or palladium-catalyzed coupling to an aryl halide or aryl pseudohalide, preferably an aryl bromide, an aryl iodide, aryl triflate or an aryl tosylate.

*Phosphorescence material(s) $P^B$*

The phosphorescence materials $P^B$ in the context of the present invention utilize the intramolecular spin-orbit interaction (heavy atom effect) caused by metal atoms to obtain light emission from triplets (i.e. excited triplet states, typically the lowermost excited triplet state T1). This is to say that a phosphorescence material $P^B$ is capable of emitting phosphorescence at room temperature (i.e. (approximately) 20 °C, which is typically measured from a spin-coated film of the respective $P^B$ in poly(methyl methacrylate) (PMMA) with a concentration of 10% by weight of $P^B$.

It is to be noted that, although being per definition capable of emitting phosphorescence, a phosphorescence

material $P^B$ optionally comprised in the organic electroluminescent device of the invention as optional excitation energy transfer component EET-2 preferably mainly functions as "energy pump" and not as emitter material. This is to say that a phosphorescence material $P^B$ comprised in a light-emitting layer B preferably mainly transfers excitation energy to one or more small FWHM emitters $S^B$ that in turn serve as the main emitter material(s). The main function of a phosphorescence material $P^B$ in a light-emitting layer B is preferably not the emission of light. However, it may emit light to some extent.

Generally, it is understood, that all phosphorescent complexes that are used in organic electroluminescent devices in the state of the art may also be used in an organic electroluminescent device according to the present invention.

It is common knowledge to those skilled in the art that phosphorescence materials $P^B$ used in organic electroluminescent devices are oftentimes complexes of Ir, Pd, Pt, Au, Os, Eu, Ru, Re, Ag and Cu, in the context of this invention preferably of Ir, Pt, and Pd, more preferably of Ir and Pt. The skilled artisan knows which materials are suitable as phosphorescence materials in organic electroluminescent devices and how to synthesize them. Furthermore, the skilled artisan is familiar with the design principles of phosphorescent complexes for use in organic electroluminescent devices and knows how to tune the emission of the complexes by means of structural variations.

See for example: C.-L. Ho, H. Li, W.-Y. Wong, Journal of Organometallic Chemistry 2014, 751, 261, DOI: 10.1016/j.jorganchem.2013.09.035; T. Fleetham, G. Li, J. Li, Advanced Science News 2017, 29, 1601861, DOI: 10.1002/adma.201601861; A.R.B.M. Yusoff, A.J. Huckaba, M.K. Nazeeruddin, Topics in Current Chemistry (Z) 2017, 375:39, 1, DOI: 10.1007/s41061-017-0126-7; T.-Y. Li, J. Wuc, Z.-G. Wua, Y.-X. Zheng, J.-L. Zuo, Y. Pan, Coordination Chemistry Reviews 2018, 374, 55, DOI: 10.1016/j.ccr.2018.06.014.

For example, US2020274081 (A1), US20010019782 (A1), US20020034656 (A1), US20030138657 (A1), US2005123791 (A1), US20060065890 (A1), US20060134462 (A1), US20070034863 (A1), US20070111026 (A1), US2007034863 (A1), US2007138437 (A1), US20080020237 (A1), US20080297033 (A1), US2008210930 (A1), US20090115322 (A1), US2009104472 (A1), US20100244004 (A1), US2010105902 (A1), US20110057559 (A1), US2011215710 (A1), US2012292601 (A1), US2013165653 (A1), US20140246656 (A1), US20030068526 (A1), US20050123788 (A1), US2005260449 (A1), US20060127696 (A1), US20060202194 (A1), US20070087321 (A1), US20070190359 (A1), US2007104979 (A1), US2007224450 (A1), US20080233410 (A1), US200805851 (A1), US20090039776 (A1), US20090179555 (A1), US20100090591 (A1), US20100295032 (A1), US20030072964 (A1), US20050244673 (A1), US20060008670 (A1), US20060134459 (A1), US20060251923 (A1), US20070103060 (A1), US20070231600 (A1), US2007104980 (A1), US2007278936 (A1), US20080261076 (A1), US2008161567 (A1), US20090108737 (A1), US2009085476 (A1), US20100148663 (A1), US2010102716 (A1), US2010270916 (A1), US20110204333 (A1), US2011285275 (A1), US2013033172 (A1), US2013334521 (A1), US2014103305 (A1), US2003068536 (A1), US2003085646 (A1), US2006228581 (A1), US2006197077 (A1), US2011114922 (A1), US2011114922 (A1), US2003054198 (A1), and EP2730583 (A1) disclose phosphorescence materials that may be used as phosphorescence materials $P^B$ in the context of the present invention. It is understood that this does not imply that the present invention is limited to organic electroluminescent devices comprising a phosphorescence materials described in one of the named references.

As laid out in US2020274081 (A1), examples of phosphorescent complexes for use in organic electroluminescent devices such as those of the present invention include the complexes shown below. Again, it is understood that the present invention is not limited to these examples.

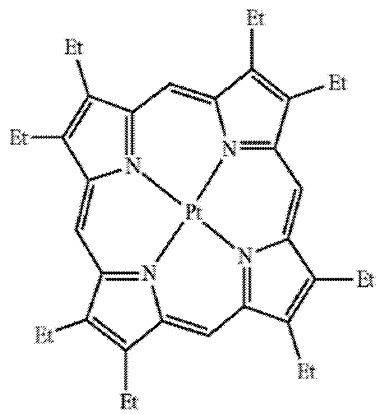

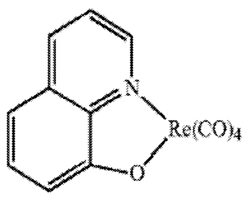

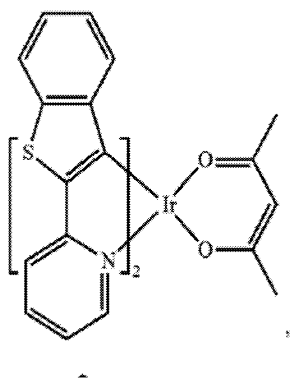

,

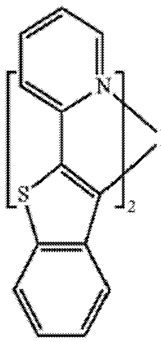,

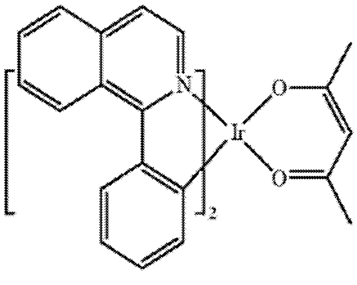,

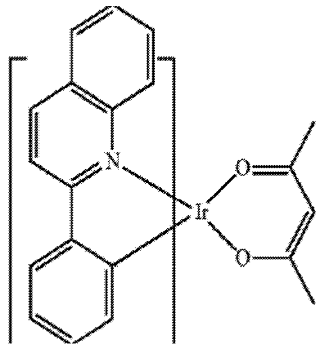

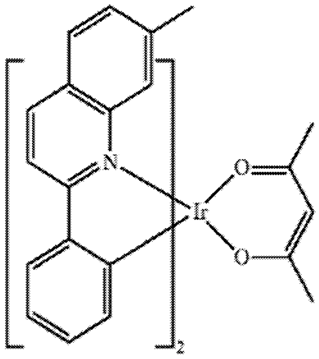,

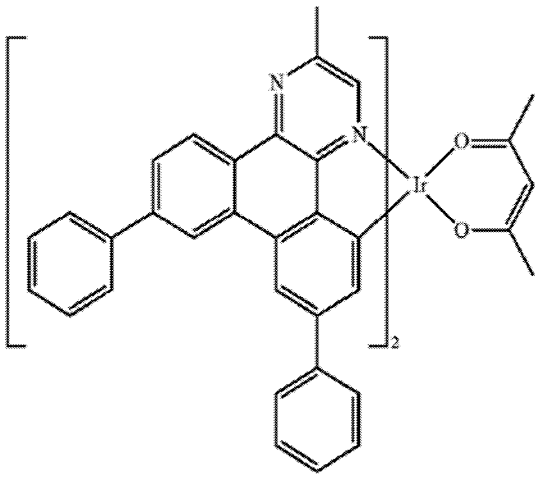,

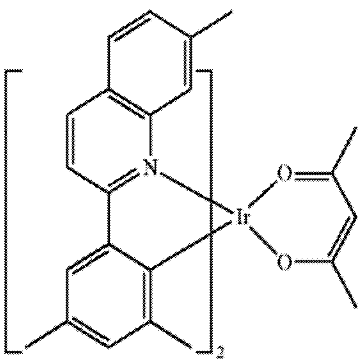

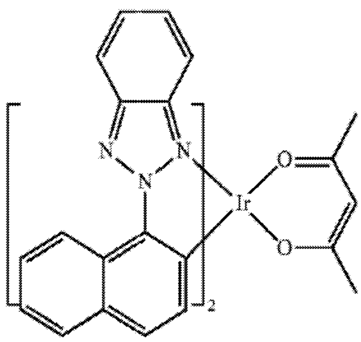

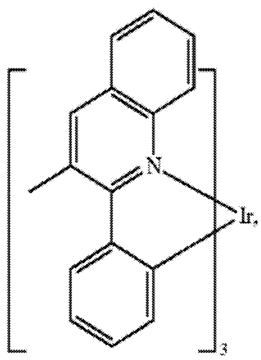

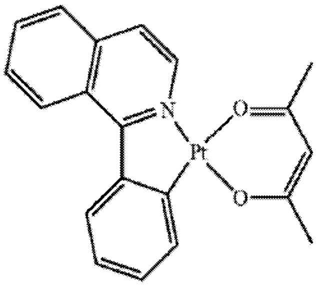

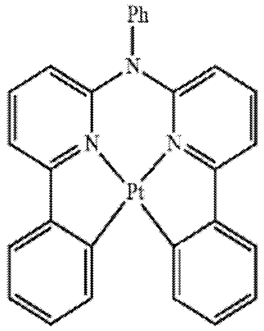

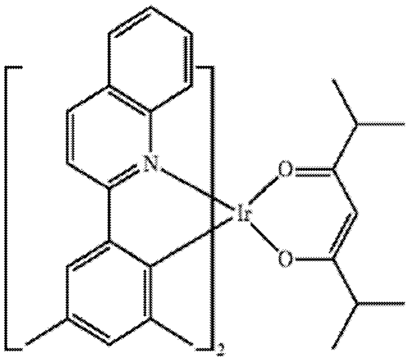

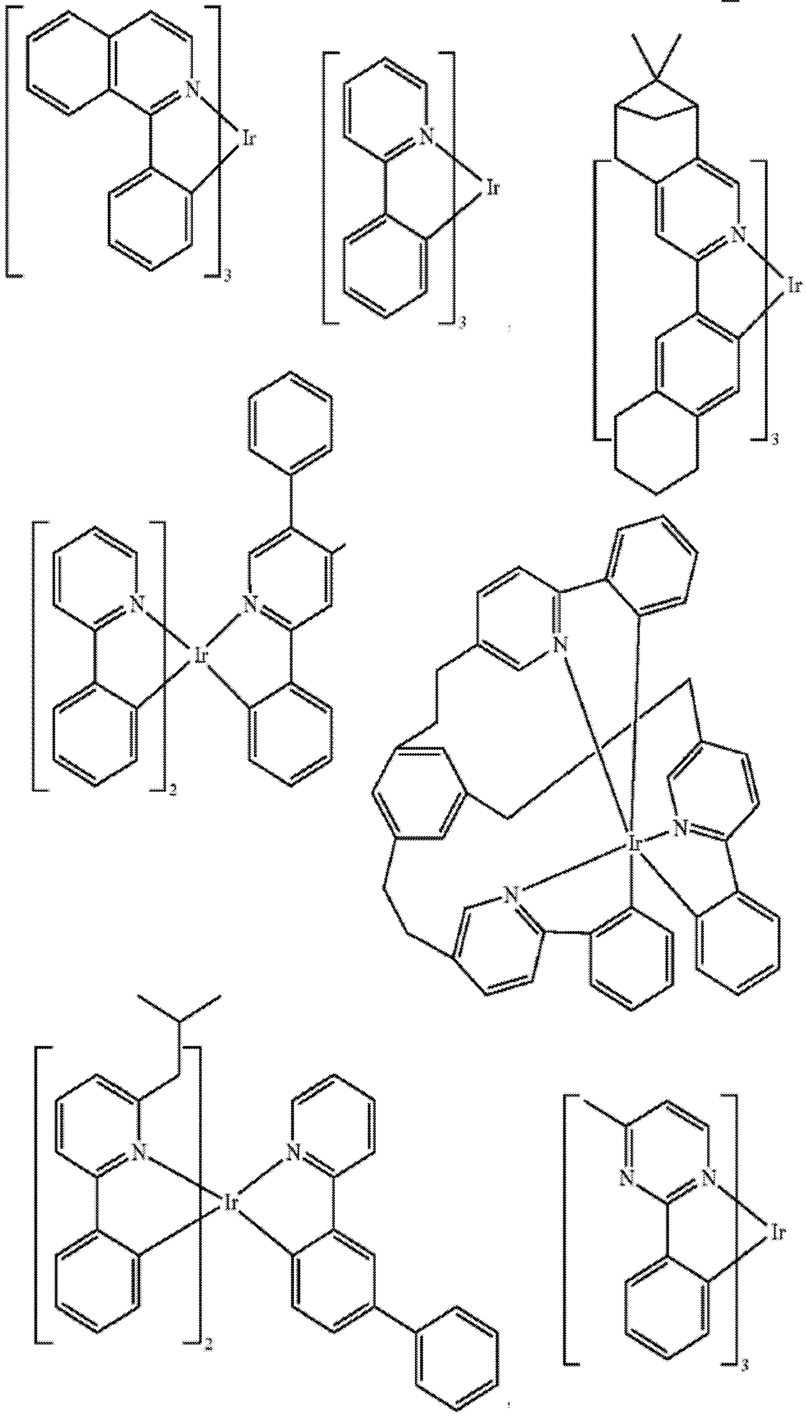

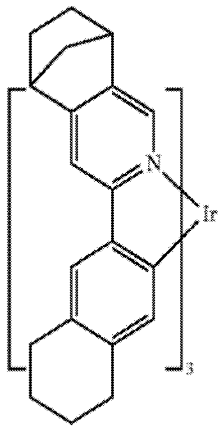

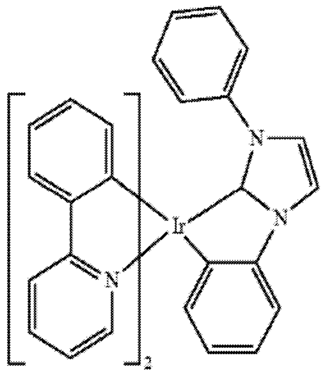

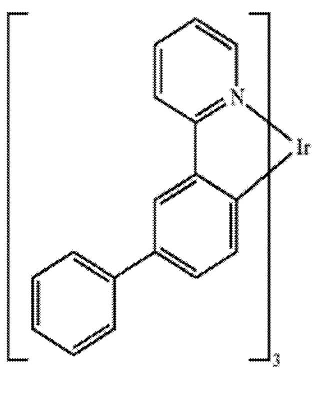

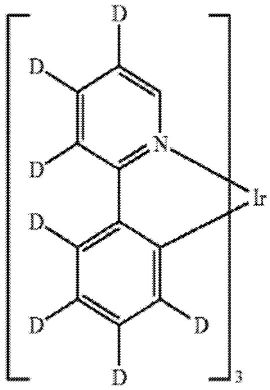
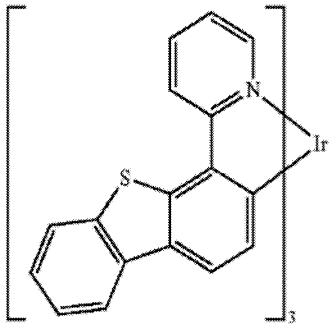
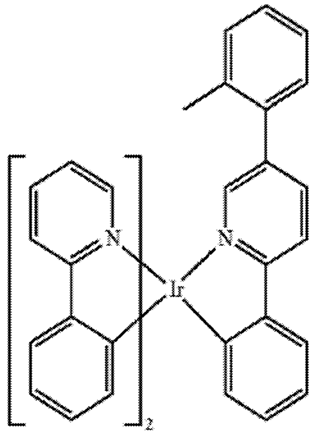
,

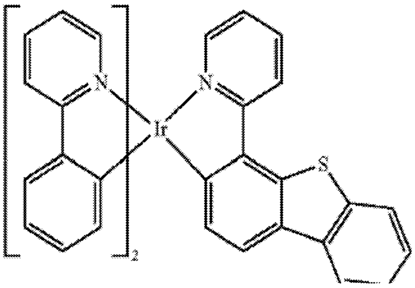
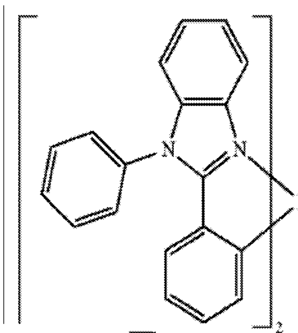
,
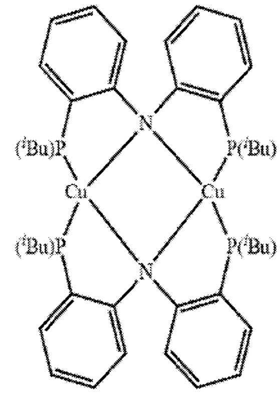
,

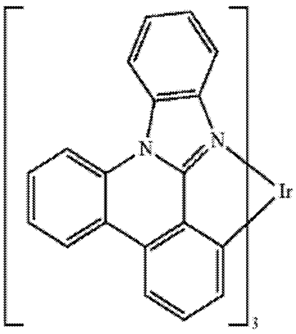
,
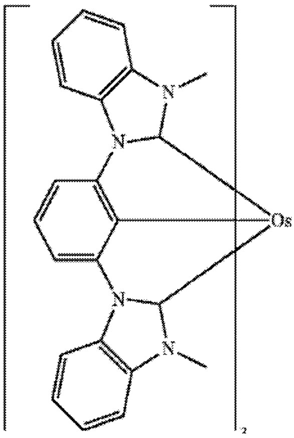
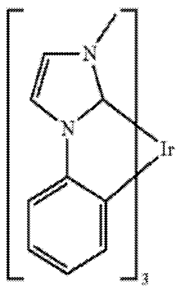
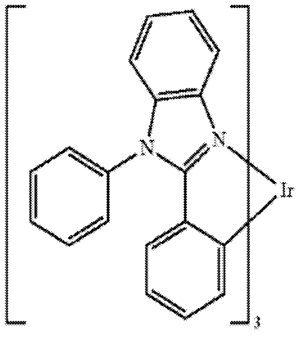
,

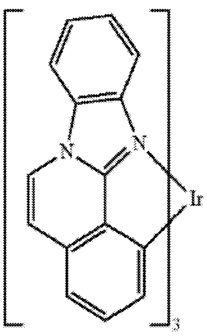
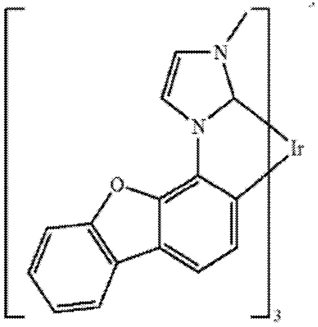
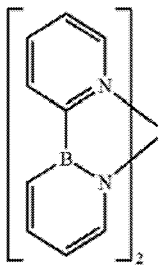
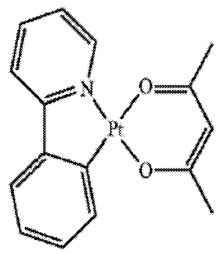
,

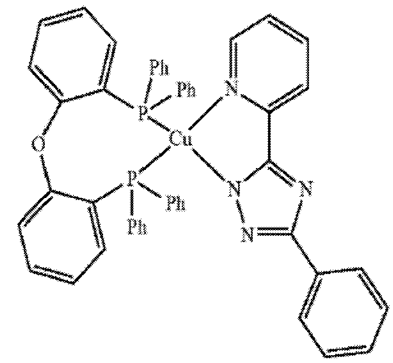

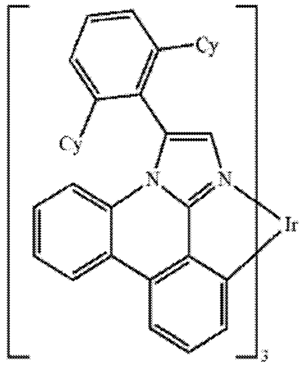

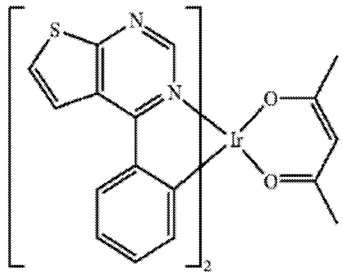

,

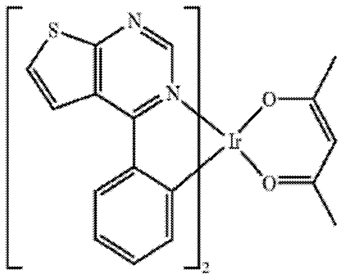

,

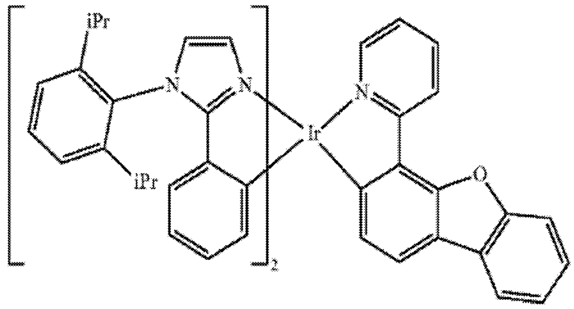

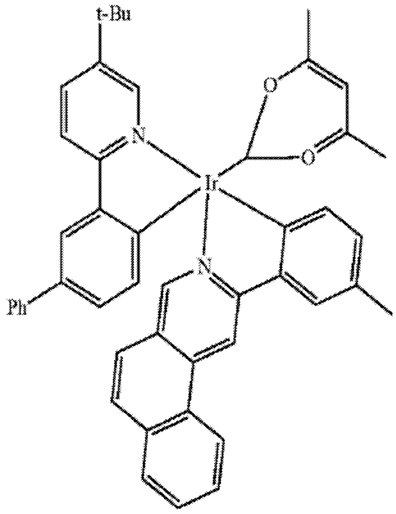

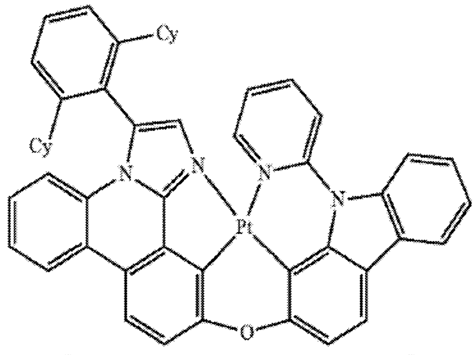

,

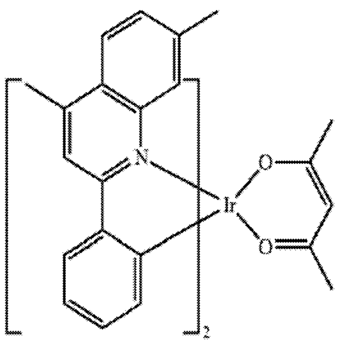

,

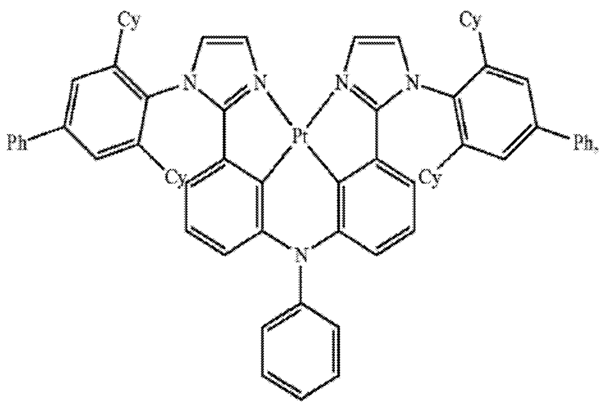

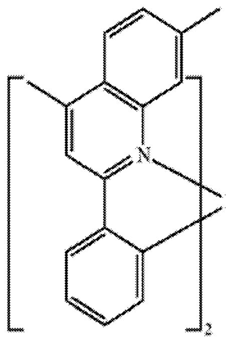

,

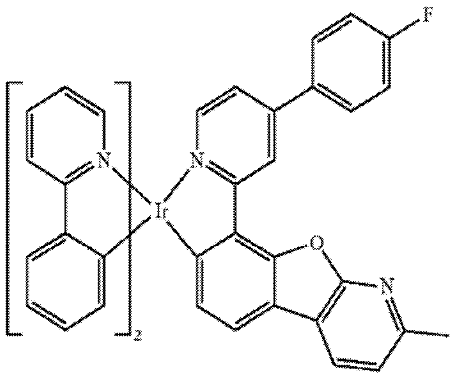

,

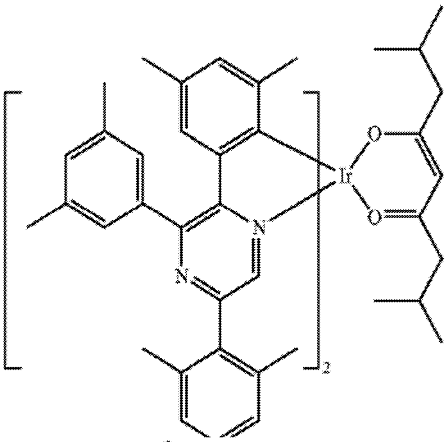

,

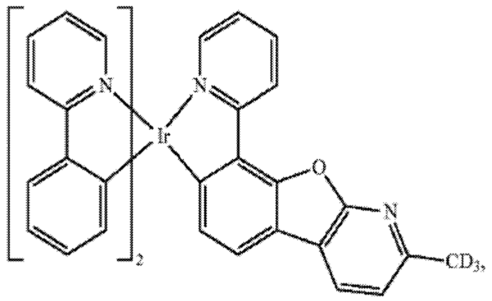

,

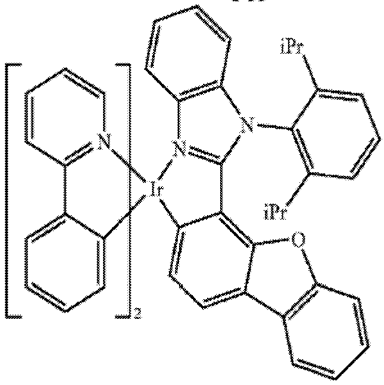

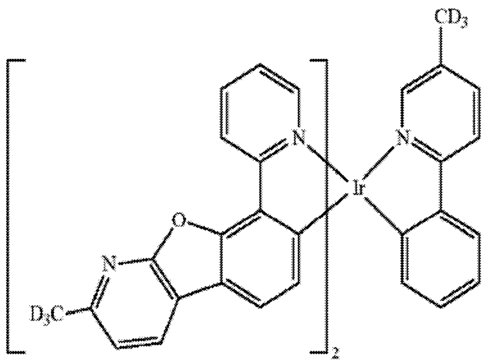

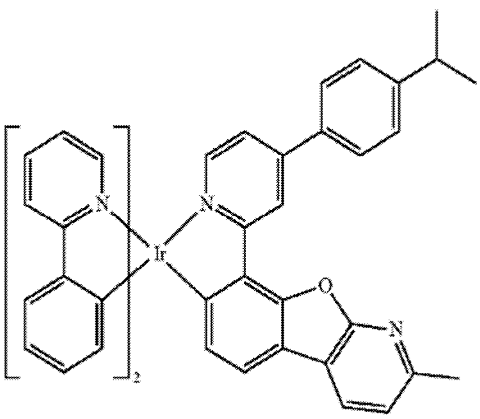

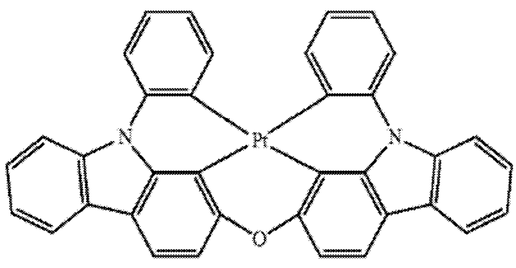

,

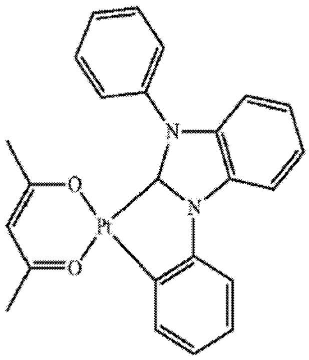

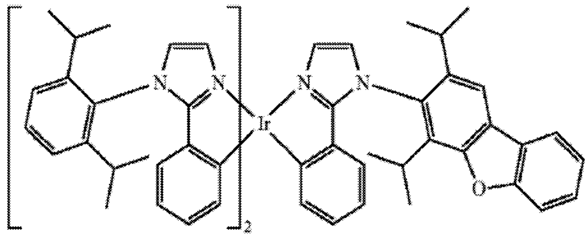

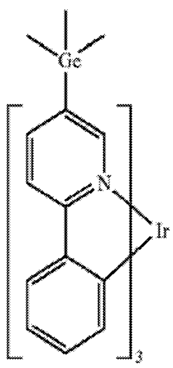
,

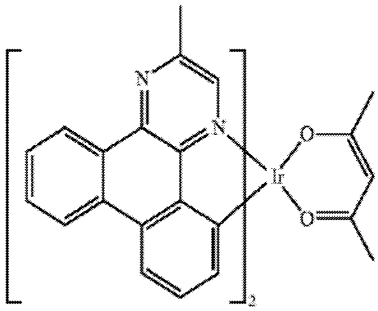
,

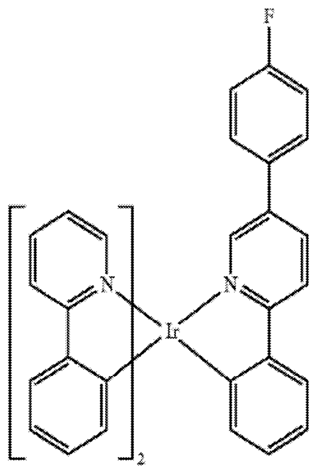
,

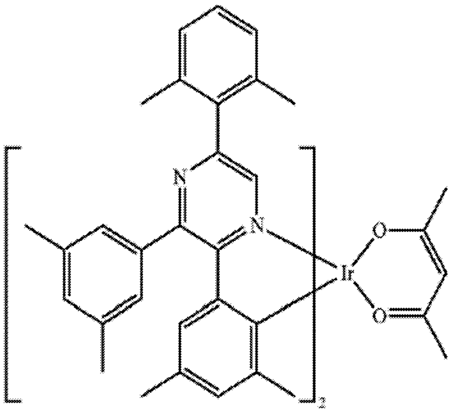
,

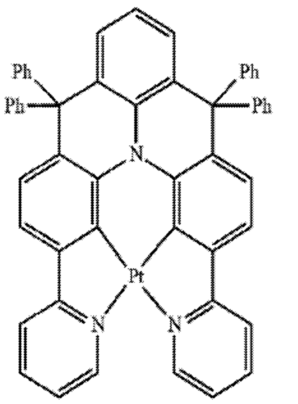
,

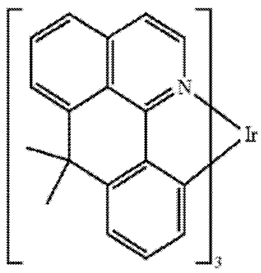

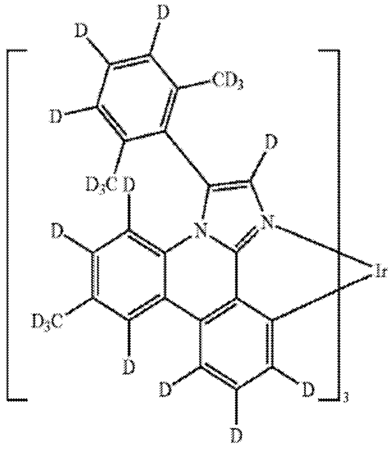

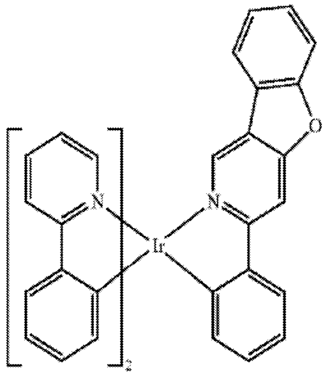
,

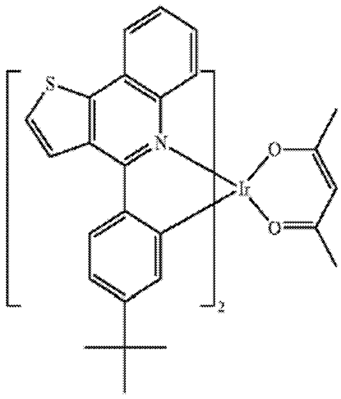
,

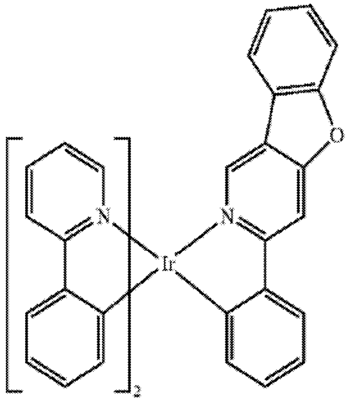
,
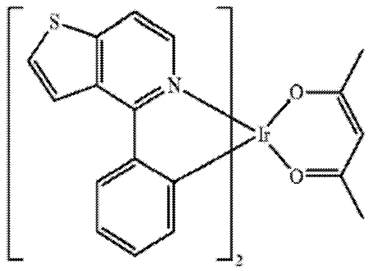
,
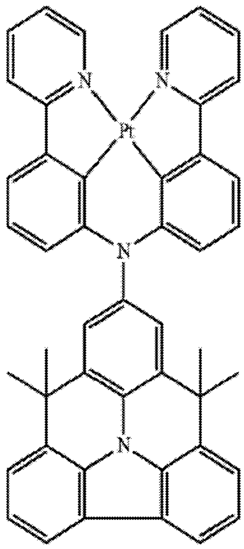
,
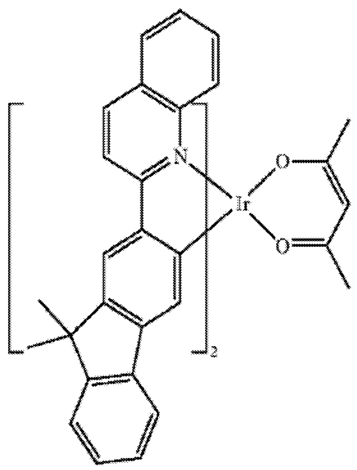
,
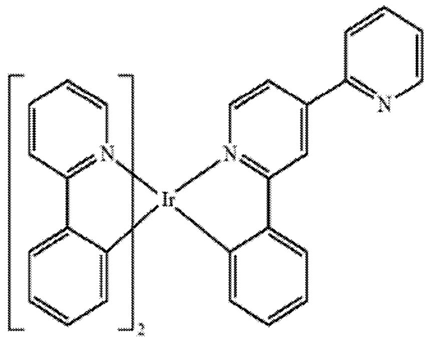
,
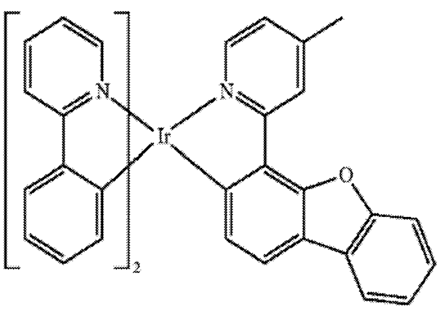
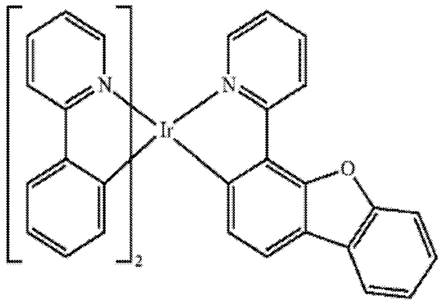

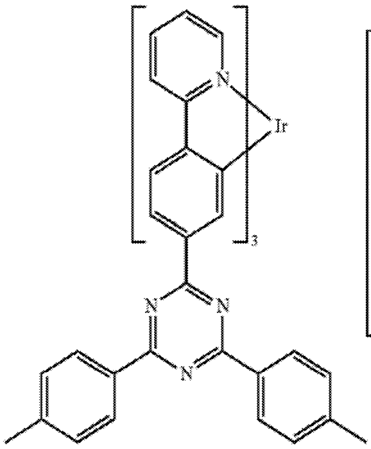 ,

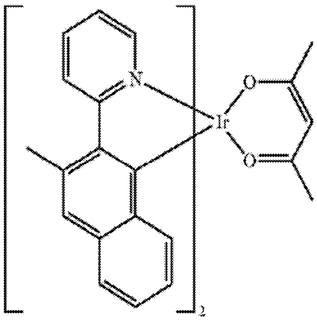 ,

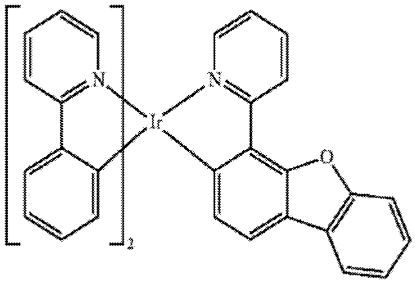

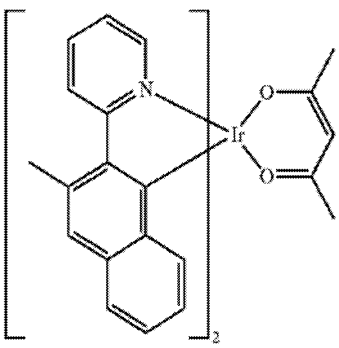 ,

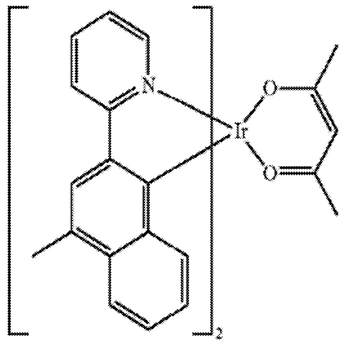 ,

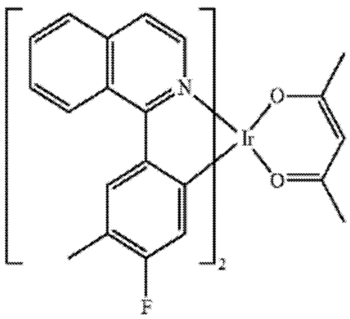 ,

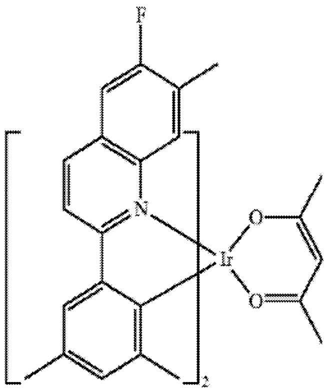 ,

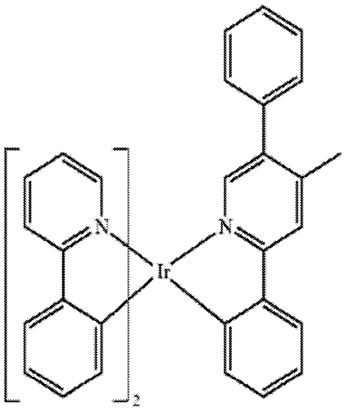

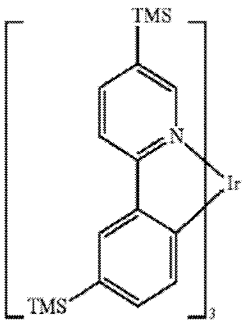 ,

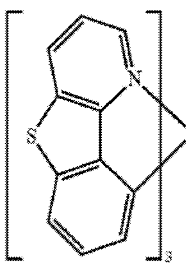 ,

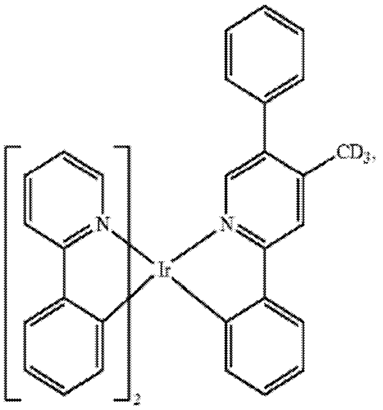

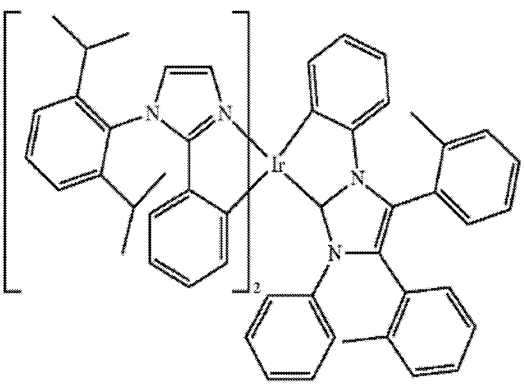

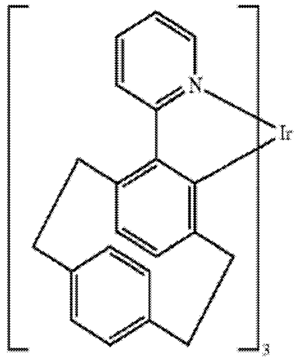
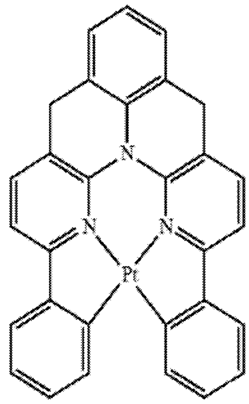
,
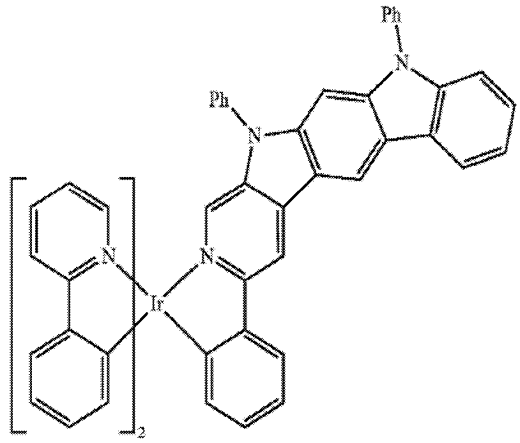

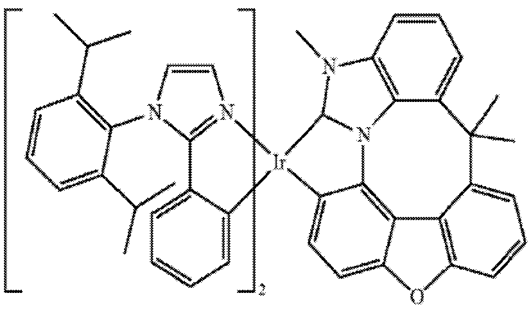
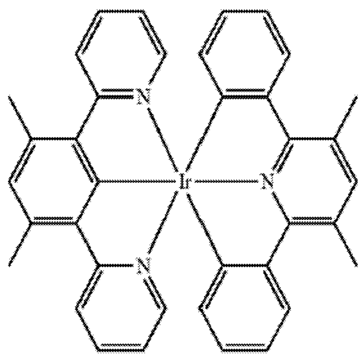
,

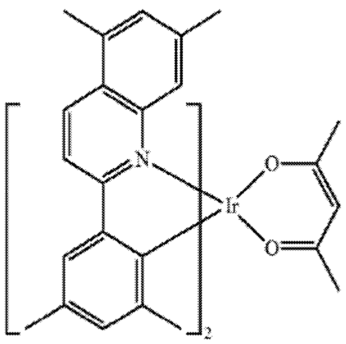
,
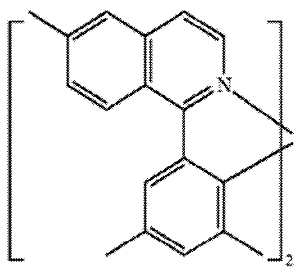
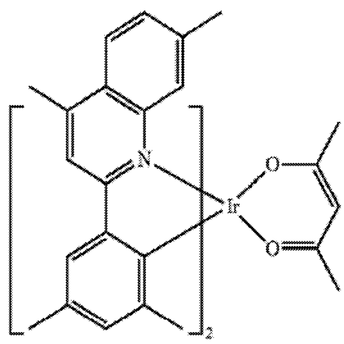
,

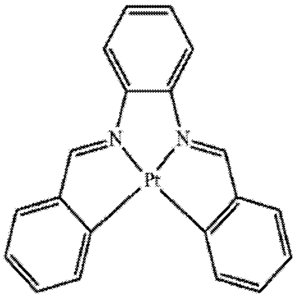,
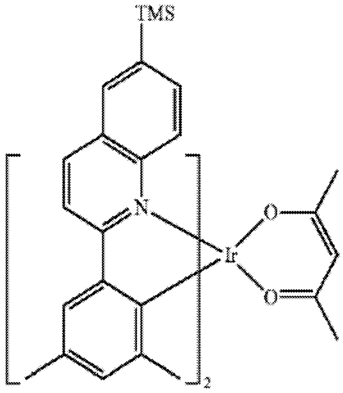
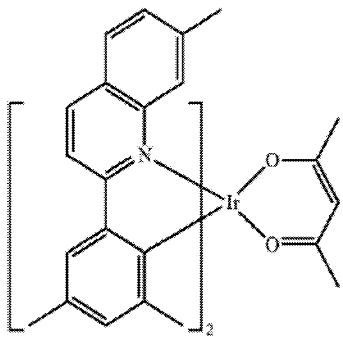
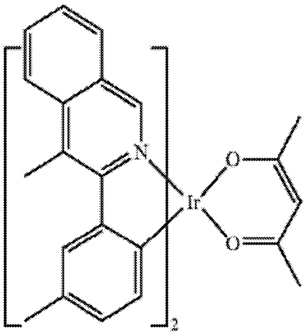,
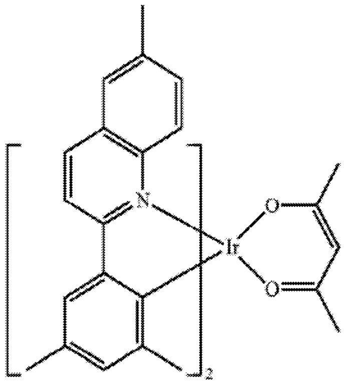,
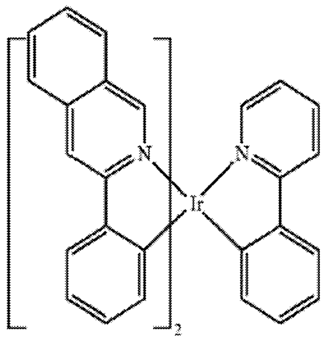,
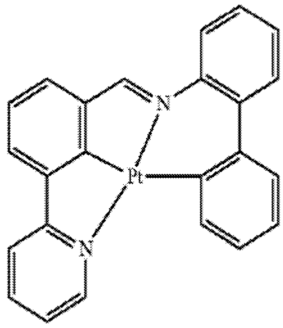,
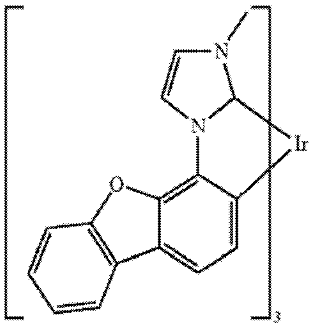
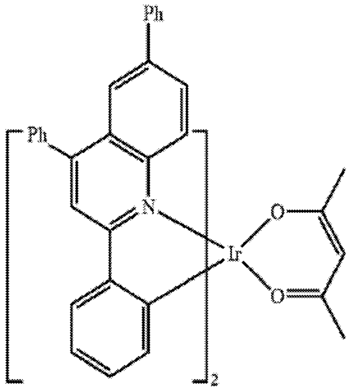,
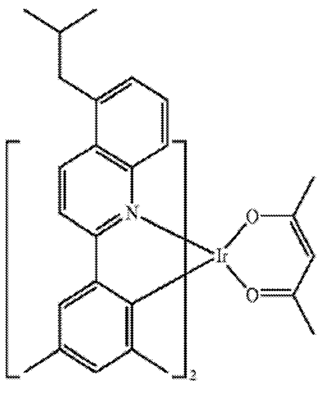,
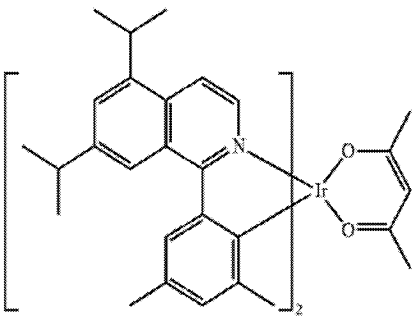,
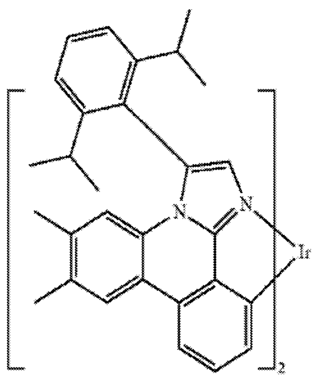

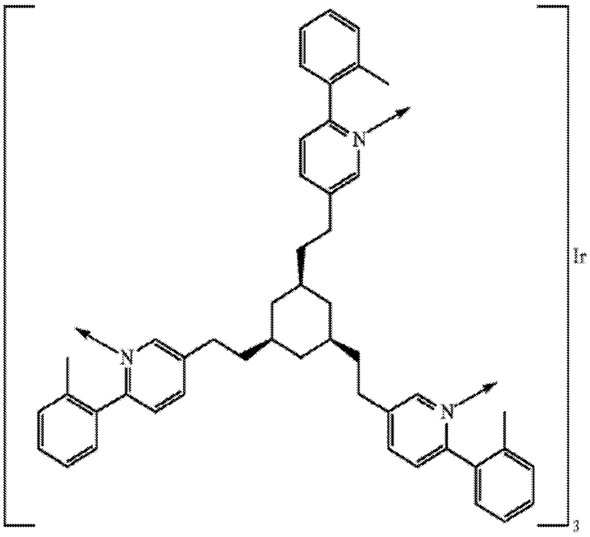,

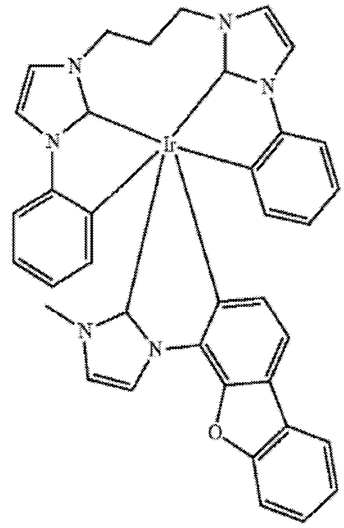

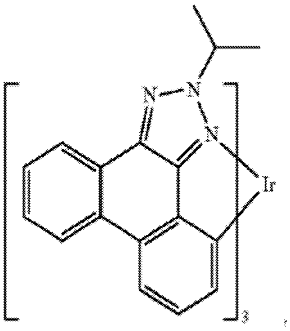,

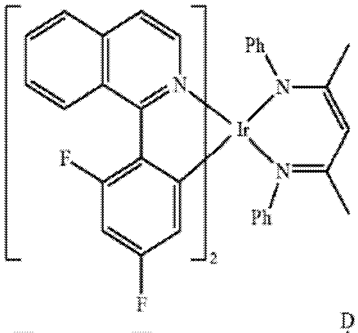

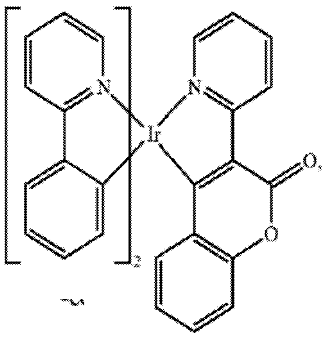

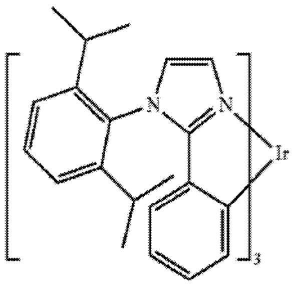

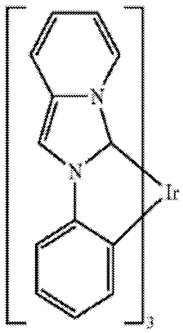

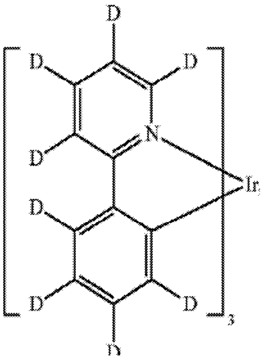

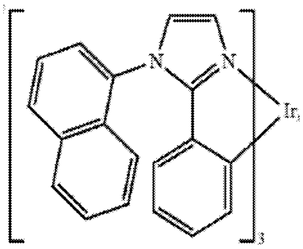

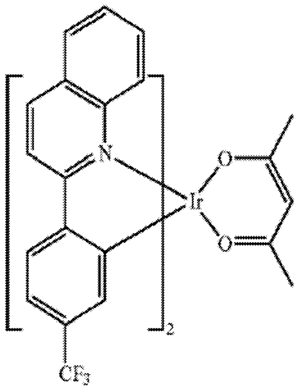

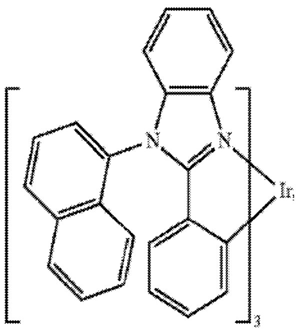

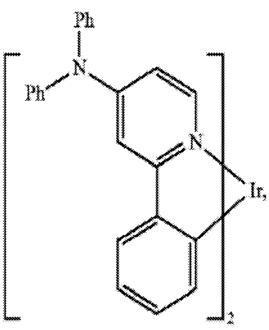

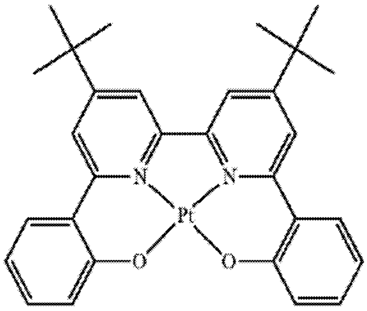 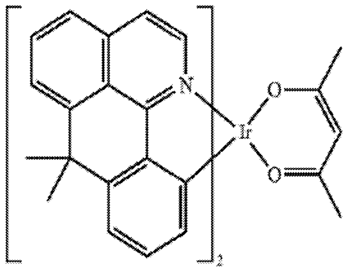 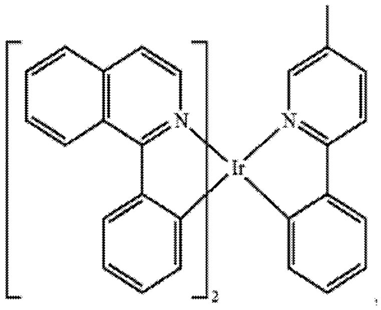

As stated above, the skilled artisan will realize that any phosphorescent complexes used in the state of the art may be suitable as phosphorescence materials $P^B$ in the context of the present invention.

In one embodiment of the invention, each phosphorescence material $P^B$ comprised in a light-emitting layer B comprises Iridium (Ir).

In one embodiment of the invention, at least one phosphorescence material $P^B$, preferably each phosphorescence material $P^B$ comprised in a light-emitting layer B, is an organometallic complex comprising either iridium (Ir) or platinum (Pt).

In one embodiment of the invention, the at least one phosphorescence material $P^B$, preferably each phosphorescence material $P^B$, comprised in a light-emitting layer B is an organometallic complex comprising iridium (Ir).

In one embodiment of the invention, the at least one phosphorescence material $P^B$, preferably each phosphorescence material $P^B$, comprised in a light-emitting layer B is an organometallic complex comprising platinum (Pt).

Non-limiting examples of phosphorescence materials $P^B$ also include compounds represented by the following general formula $P^B$-I,

Formula $P^B$-I.

In formula $P^B$-I, M is selected from the group consisting of Ir, Pt, Pd, Au, Eu, Ru, Re, Ag and Cu;

n is an integer of 1 to 3; and
$X^2$ and $Y^1$ together form at each occurrence independently from each other a bidentate monoanionic ligand.

In one embodiment of the invention, each phosphorescence materials $P^B$ comprised in a light-emitting layer B comprises or consists of a structure according to formula $P^B$-I,

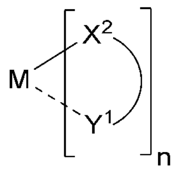

Formula $P^B$-I,

wherein, M is selected from the group consisting of Ir, Pt, Pd, Au, Eu, Ru, Re, Ag and Cu;
n is an integer of 1 to 3; and
$X^2$ and $Y^1$ together form at each occurrence independently from each other a bidentate monoanionic ligand.

Examples of the compounds represented by the formula $P^B$-I include compounds represented by the following general formula $P^B$-II or general formula $P^B$-III:

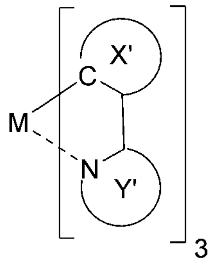

Formula $P^B$-II

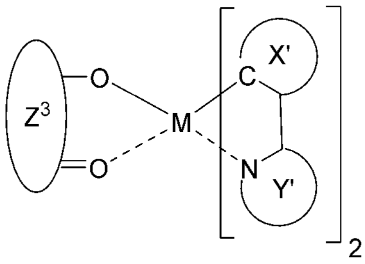

Formula $P^B$-III.

In formulas $P^B$-II and $P^B$-III, X' is an aromatic ring which is carbon(C)-bonded to M and Y' is a ring, which is nitrogen(N)-coordinated to M to form a ring.

X' and Y' are bonded, and X' and Y' may form a new ring. In formula $P^B$-III, $Z^3$ is a bidentate ligand having two oxygens(O). In the formulas $P^B$-II and $P^B$-III, M is preferably Ir from the viewpoint of high efficiency and long lifetime.

In the formulas $P^B$-II and $P^B$-III, the aromatic ring X' is for example a $C_6$-$C_{30}$-aryl, preferably a $C_6$-$C_{16}$-aryl, even more preferably a $C_6$-$C_{12}$-aryl, and particularly preferably a $C_6$-$C_{10}$-aryl, wherein X' at each occurrence is optionally substituted with one or more substituents $R^E$.

In the formulas $P^B$-II and $P^B$-III, Y' is for example a $C_2$-$C_{30}$-heteroaryl, preferably a $C_2$-$C_{25}$-heteroaryl, more preferably a $C_2$-$C_{20}$-heteroaryl, even more preferably a $C_2$-$C_{15}$-heteroaryl, and particularly preferably a $C_2$-$C_{10}$-heteroaryl, wherein Y' at each occurrence is optionally substituted with one or more substituents $R^E$. Furthermore, Y' may be, for example, a $C_1$-$C_5$-heteroaryl, which is optionally substituted with one or more substituents $R^E$.

In the formulas $P^B$-II and $P^B$-III, the bidentate ligand having two oxygens(O) $Z^3$ is for example a $C_2$-$C_{30}$-bidentate ligand having two oxygens, a $C_2$-$C_{25}$-bidentate ligand having two oxygens, more preferably a $C_2$-$C_{20}$-bidentate ligand having two oxygens, even more preferably a $C_2$-$C_{15}$-bidentate ligand having two oxygens, and particularly preferably a $C_2$-$C_{10}$-bidentate ligand having two oxygens, wherein $Z^3$ at each occurrence is optionally substituted with one or more substituents $R^E$. Furthermore, $Z^3$ may be, for example, a $C_2$-$C_5$- bidentate ligand having two oxygens, which is optionally substituted with one or more substituents $R^E$.

$R^E$ is at each occurrence independently from another selected from the group consisting of hydrogen, deuterium, $N(R^{5E})_2$, $OR^{5E}$,

$SR^{5E}$, $Si(R^{5E})_3$, $CF_3$, CN, halogen,

$C_1$-$C_{40}$-alkyl, which is optionally substituted with one or more substituents $R^{5E}$ and wherein one or more non-adjacent $CH_2$-groups are optionally substituted by $R^{5E}C=CR^{5E}$, C≡C, $Si(R^{5E})_2$, $Ge(R^{5E})_2$, $Sn(R^{5E})_2$, C=O, C=S, C=Se, $C=NR^{5E}$, $P(=O)(R^{5E})$, SO, $SO_2$, $NR^{5E}$, O, S or $CONR^{5E}$;

$C_1$-$C_{40}$-thioalkoxy, which is optionally substituted with one or more substituents $R^{5E}$ and wherein one or more non-adjacent $CH_2$-groups are optionally substituted by $R^{5E}C=CR^{5E}$, C≡C, $Si(R^{5E})_2$, $Ge(R^{5E})_2$, $Sn(R^{5E})_2$, C=O, C=S, C=Se, $C=NR^{5E}$, $P(=O)(R^{5E})$, SO, $SO_2$, $NR^{5E}$, O, S or $CONR^{5E}$;

$C_6$-$C_{60}$-aryl, which is optionally substituted with one or more substituents $R^{5E}$; and

$C_3$-$C_{57}$-heteroaryl, which is optionally substituted with one or more substituents $R^{5E}$.

$R^{5E}$ is at each occurrence independently from another selected from the group consisting of hydrogen, deuterium, $N(R^{6E})_2$, $OR^{6E}$, $SR^{6E}$, $Si(R^{6E})_3$, $CF_3$, CN, F,

$C_1$-$C_{40}$-alkyl, which is optionally substituted with one or more substituents $R^{6E}$ and wherein one or more non-adjacent $CH_2$-groups are optionally substituted by $R^{6E}C=CR^{6E}$, C≡C, $Si(R^{6E})_2$, $Ge(R^{6E})_2$, $Sn(R^{6E})_2$, C=O, C=S, C=Se, $C=NR^{6E}$, $P(=O)(R^{6E})$, SO, $SO_2$, $NR^{6E}$, O, S or $CONR^{6E}$;

$C_6$-$C_{60}$-aryl, which is optionally substituted with one or more substituents $R^{6E}$; and

$C_3$-$C_{57}$-heteroaryl, which is optionally substituted with one or more substituents $R^{6E}$.

$R^{6E}$ is at each occurrence independently from another selected from the group consisting of hydrogen, deuterium, OPh, $CF_3$, CN, F,

$C_1$-$C_5$-alkyl, wherein one or more hydrogen atoms are optionally, independently from each other substituted by deuterium, CN, $CF_3$, or F;

$C_1$-$C_5$-alkoxy,

wherein one or more hydrogen atoms are optionally, independently from each other substituted by deuterium, CN, $CF_3$, or F;

$C_1$-$C_5$-thioalkoxy,
wherein one or more hydrogen atoms are optionally, independently from each other substituted by deuterium, CN, $CF_3$, or F;
$C_6$-$C_{18}$-aryl, which is optionally substituted with one or more $C_1$-$C_5$-alkyl substituents;
$C_3$-$C_{17}$-heteroaryl,
which is optionally substituted with one or more $C_1$-$C_5$-alkyl substituents;
$N(C_6$-$C_{18}$-aryl$)_2$;
$N(C_3$-$C_{17}$-heteroaryl$)_2$, and
$N(C_3$-$C_{17}$-heteroaryl$)(C_6$-$C_{18}$-aryl$)$.

The substituents $R^E$, $R^{5E}$, or $R^{6E}$ independently from each other optionally may form a mono- or polycyclic, aliphatic, aromatic, heteroaromatic ring system with one or more substituents $R^E$, $R^{5E}$, $R^{6E}$, and/or with X', Y' and $Z^3$.

Non-limiting examples of the compound represented by formula $P^B$-II include $Ir(ppy)_3$, $Ir(ppy)_2(acac)$, $Ir(mppy)_3$, $Ir(PPy)_2$(m-bppy), and BtpIr(acac), $Ir(btp)_2(acac)$, Ir(2-phq$)_3$, Hex-Ir(phq$)_3$, $Ir(fbi)_2(acac)$, fac-Tris(2-(3-p-xylyl)phenyl) pyridine iridium(III), Eu(dbm$)_3$(Phen), $Ir(piq)_3$, $Ir(piq)_2(acac)$, $Ir(Fiq)_2(acac)$, $Ir(FIq)_2(acac)$, Ru(dtb-bpy$)_3$.2(PF6), Ir(2-phq$)_3$, $Ir(BT)_2(acac)$, $Ir(DMP)_3$, $Ir(Mpq)_3$, $Ir(phq)_2$tpy, fac-Ir(ppy$)_2$Pc, Ir(dp)$PQ_2$, Ir(Dpm)(Piq$)_2$, Hex-Ir(piq$)_2$(acac), Hex-Ir(piq$)_3$, $Ir(dmpq)_3$, $Ir(dmpq)_2(acac)$, FPQIrpic and the like.

Other non-limiting examples of the compound represented by formula $P^B$-II include compounds represented by the following formulas $P^B$-II-1 to $P^B$-II-11. In the structural formula, "Me" represents a methyl group.

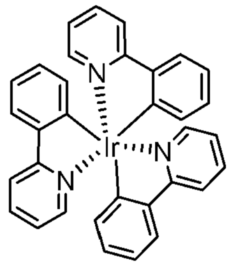

$P^B$-II-1

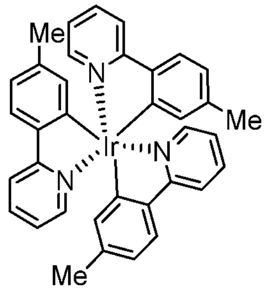

$P^B$-II-2

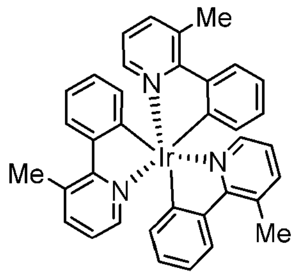

$P^B$-II-3

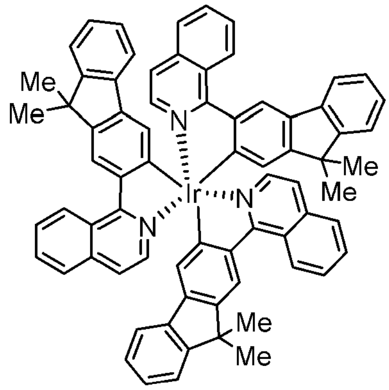

$P^B$-II-4

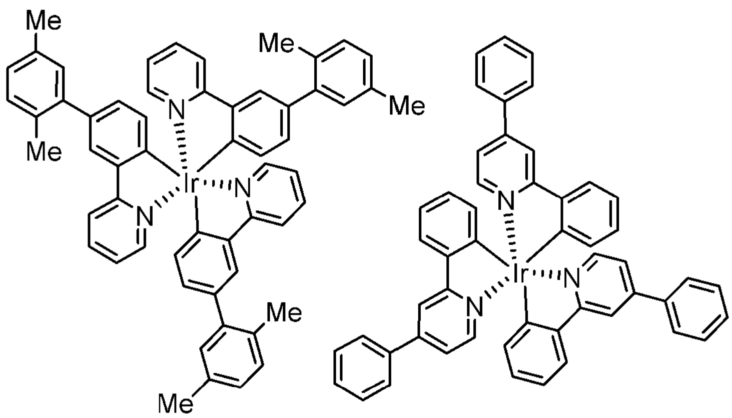

$P^B$-II-5

$P^B$-II-6

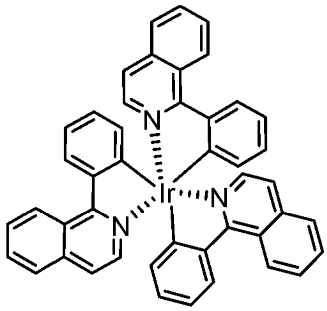

$P^B$-II-7

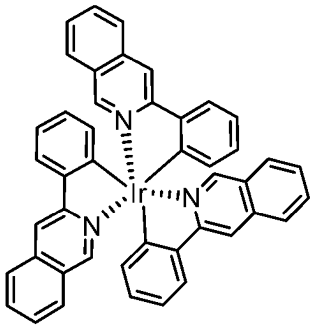

$P^B$-II-8

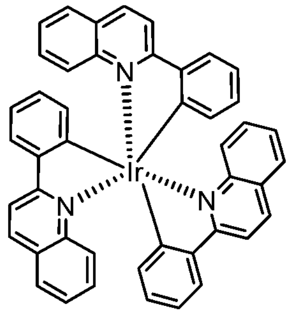

$P^B$-II-9

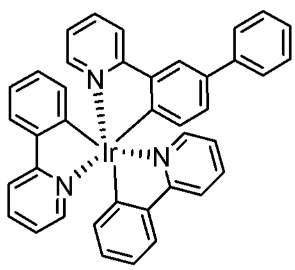

$P^B$-II-10

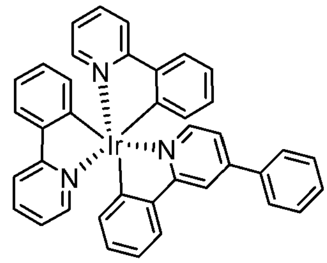

$P^B$-II-11

Other non-limiting examples of the compound represented by the formula $P^B$-III include compounds represented by the following formulas $P^B$-III-1 to $P^B$-III-6. In the structural formula, "Me" represents a methyl group.

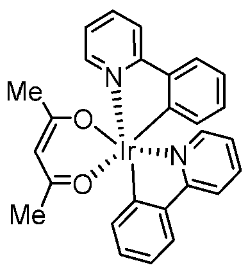

$P^B$-III-1

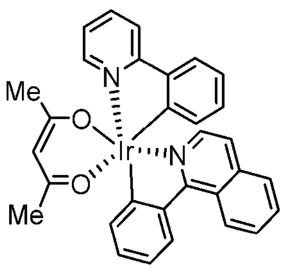

$P^B$-III-2

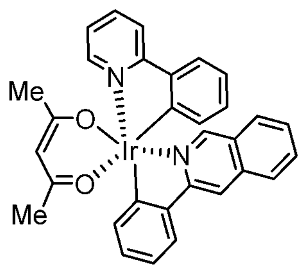

$P^B$-III-3

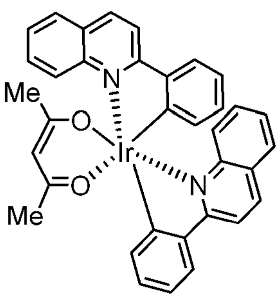

$P^B$-III-4

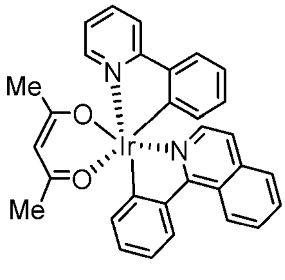

$P^B$-III-5

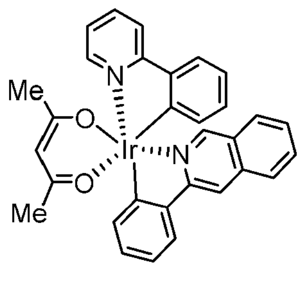

$P^B$-III-6

Furthermore, the iridium complexes described in US2003017361 (A1), US2004262576 (A1), WO2010027583 (A1), US2019245153 (A1), US2013119354 (A1), US2019233451 (A1), may be used. From the viewpoint of high efficiency in phosphorescence materials, $Ir(ppy)_3$ and Hex-$Ir(ppy)_3$ are often used for green light emission.

*Exciplexes*

It has been stated that TADF materials are capable of converting excited triplet states (preferably T1) to excited singlet states (preferably S1) by means of reverse intersystem crossing (RISC). It has also been stated that this typically requires a small $\Delta E_{ST}$ value, which is smaller than 0.4 eV for TADF materials $E^B$ by definition. As also stated, this is oftentimes achieved by designing TADF molecules $E^B$ so that the HOMO and LUMO are spatially largely separated on (electron-) donor and (electron-) acceptor groups, respectively. However, another strategy to arrive at species that have small $\Delta E_{ST}$ values is the formation of exciplexes. As known to the skilled artisan an exciplex is an excited state charge transfer complex formed between a donor molecule and an acceptor molecule (i.e. an excited state donor-acceptor complexes). The person skilled in the art further understands that the spatial separation between the HOMO (on the donor molecule) and the LUMO (on the acceptor molecule) in exciplexes typically results in them having rather small $\Delta E_{ST}$ values and being oftentimes capable of converting excited triplet states (preferably T1) to excited singlet states (preferably S1) by means of reverse intersystem crossing (RISC).

Indeed, as known to the person skilled in the art, a TADF material may not just be a material that is on its own capable of RISC from an excited triplet state to an excited singlet state with subsequent emission of TADF as laid out above. It is known to those skilled in the art that a TADF material may in fact also be an exciplex that is formed from two kinds of materials, preferably from two host materials $H^B$, more preferably from a p-host material $H^P$ and an n-host material $H^N$ (vide infra), whereat it is understood that the host materials $H^B$ (typically $H^P$ and $H^N$) may themselves be TADF materials.

The person skilled in the art understands that any materials that are comprised in the same layer, in particular in the same EML, but also materials that are in adjacent layers and get in close proximity at the interface between these adjacent layers, may together form an exciplex. The person skilled in the art knows how to choose pairs of materials, in particular pairs of a p-host $H^P$ and an n-host $H^N$, which form an exciplex and the selection criteria for the two components of said pair of materials, including HOMO- and/or LUMO-energy level requirements. This is to say that, in case exciplex formation may be aspired, the highest occupied molecular orbital (HOMO) of the one component, e.g. the p-host material $H^P$, may be at least 0.20 eV higher in energy than the HOMO of the other component, e.g. the n-host material $H^N$, and the lowest unoccupied molecular orbital (LUMO) of the one component, e.g. the p-host material $H^P$, may be at least 0.20 eV higher in energy than the LUMO of the other component, e.g. the n-host material $H^N$.

It belongs to the common knowledge of those skilled in the art that, if present in an EML of an organic electroluminescent device, in particular an OLED, an exciplex may have the function of an emitter material and emit light when a voltage and electrical current are applied to said device. As also commonly known from the state of the art, an exciplex may also be non-emissive and may for example transfer excitation energy to an emitter material, if comprised in an EML of an organic electroluminescent device.

Non-limiting examples of host materials $H^B$ that may together form an exciplex are listed below, wherein the donor molecule (i.e. the p-host $H^P$) may be selected from the following structures:

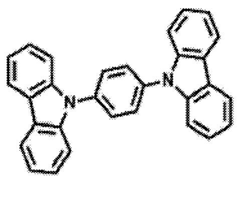
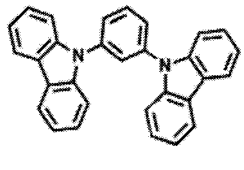
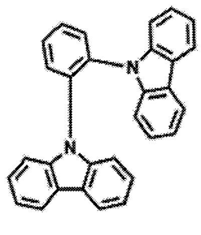

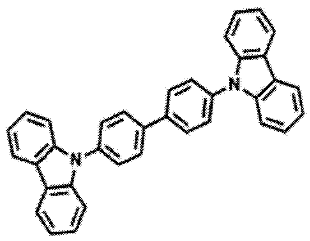
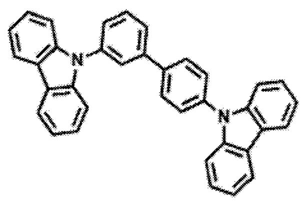
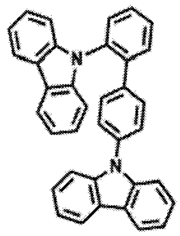

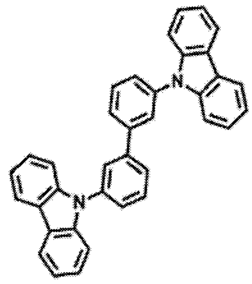 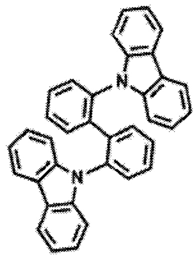 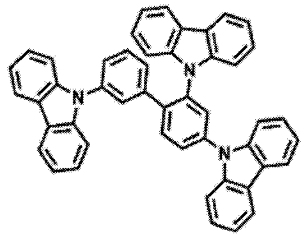

and wherein the acceptor molecule (i.e. the n-host $H^N$) may be selected from the following structures:

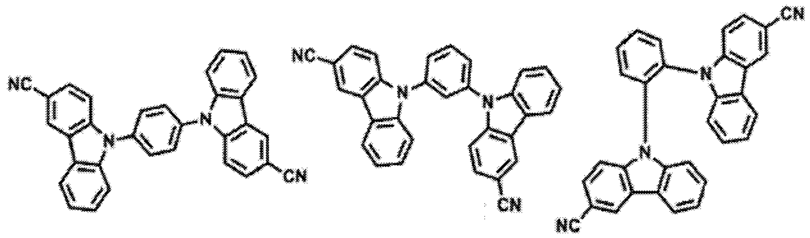

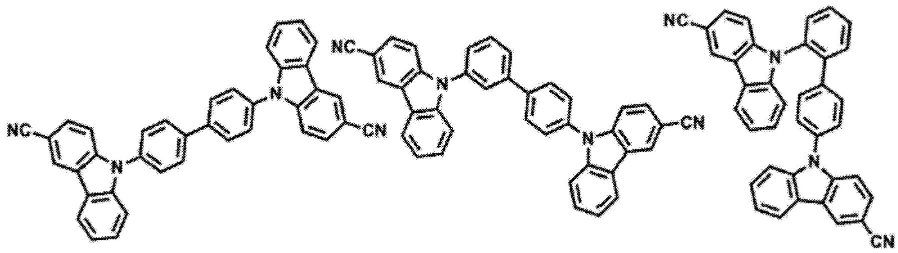

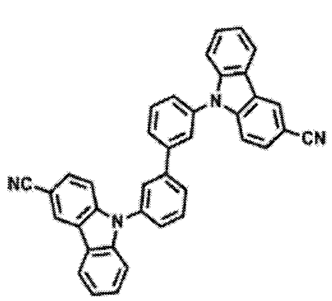 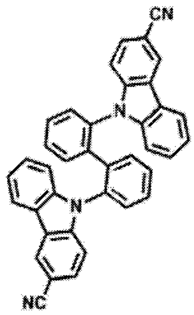 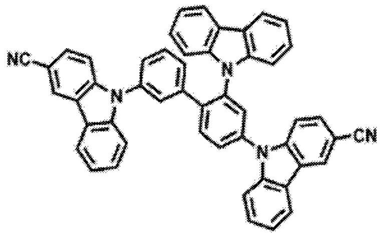

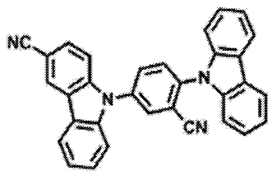 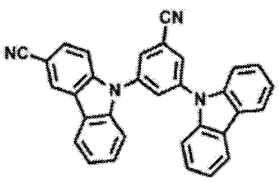 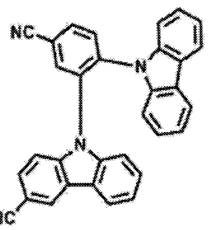

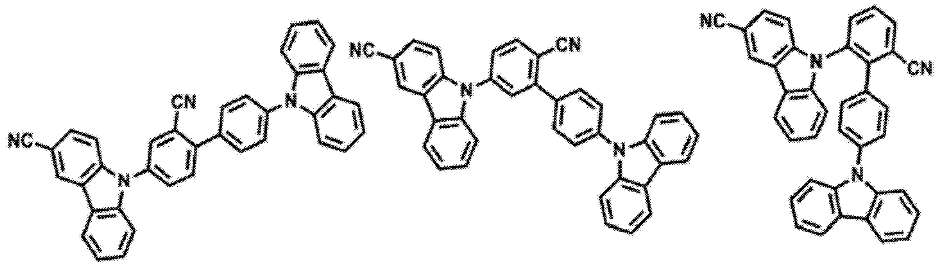

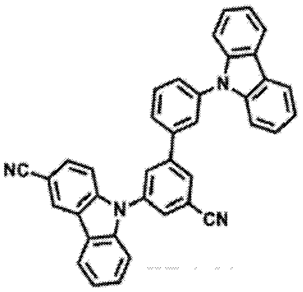

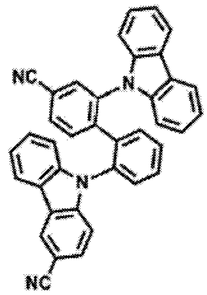

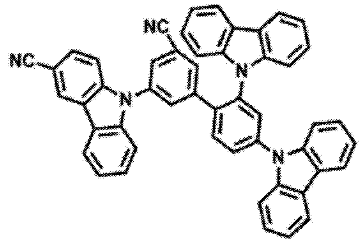

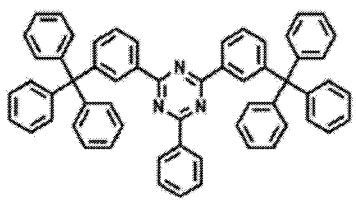

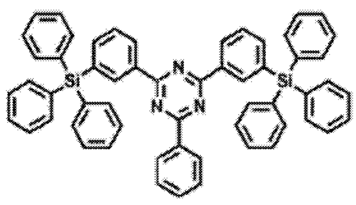

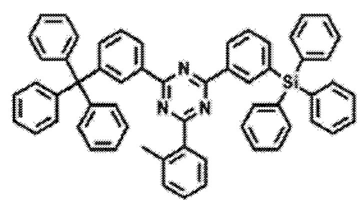

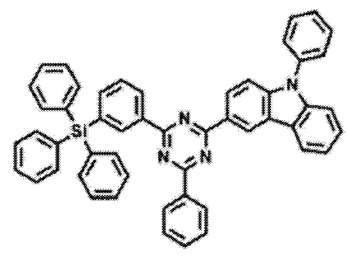

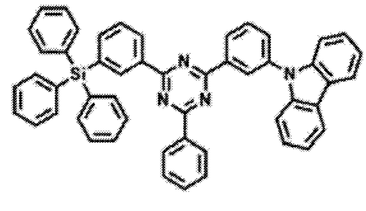

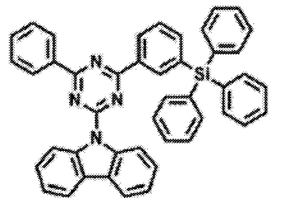

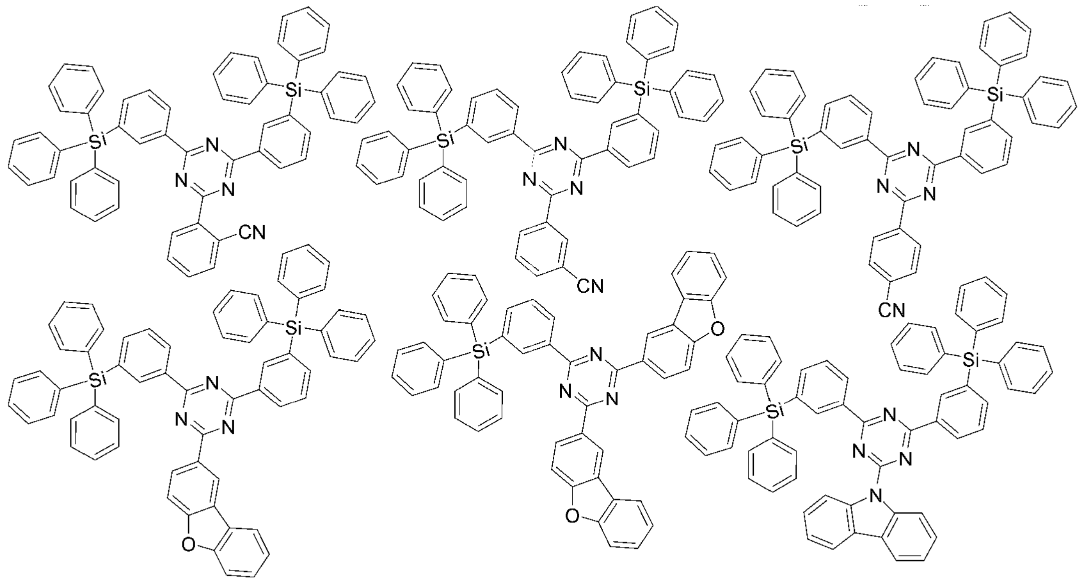

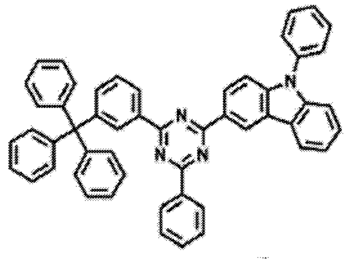
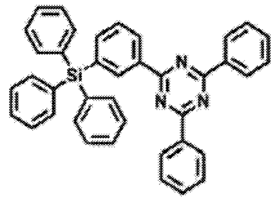
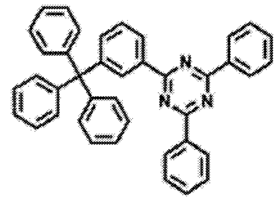

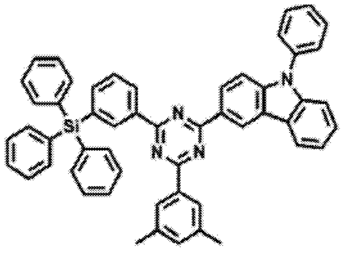
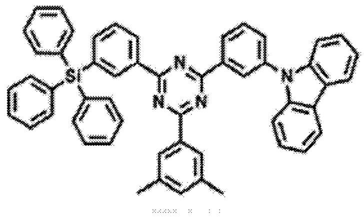
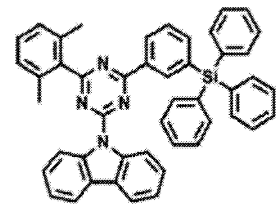

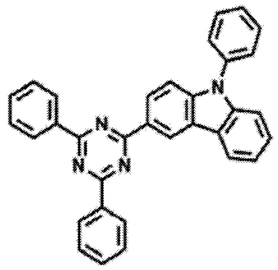
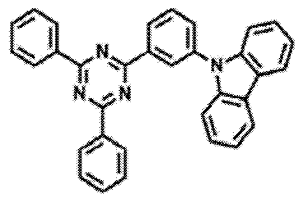
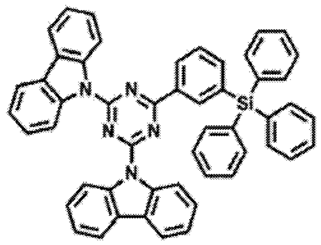

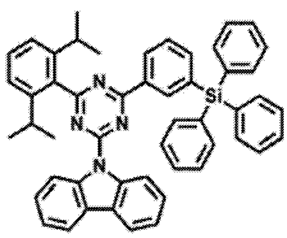
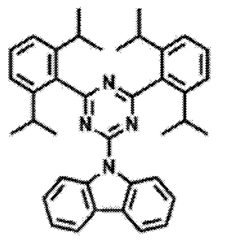
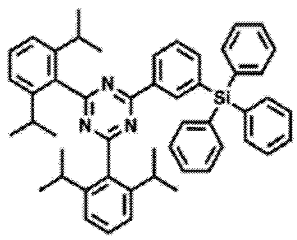

It is understood that exciplexes may be formed from any materials comprised in a light-emitting layer B in the context of the present invention, for example from different excitation energy transfer components ($E^B$ and/or EET-2) as well as from an excitation energy transfer component ($E^B$ and/or EET-2) and a small FWHM emitter $S^B$ or from a host material $H^B$ and an excitation energy transfer component $E^B$ or EET2 or a small FWHM emitter $S^B$. Preferably however, they are formed from different host materials $H^B$ as stated above. It is also understood that an exciplex may also be formed and not serve as excitation energy transfer component itself.

*Small FWHM emitter(s) $S^B$*

A small full width at half maximum (FWHM) emitter $S^B$ in the context of the present invention is any emitter that has an emission spectrum, which exhibits an FWHM of less than or equal to 0.25 eV (≤ 0.25 eV), typically measured from a spin-coated film with 1 to 5% by weight, in particular with 2% by weight of emitter in poly(methyl methacrylate) PMMA at room temperature (i.e., (approximately) 20°C). Alternatively, emission spectra of small FWHM emitters $S^B$ may be measured in a solution, typically with 0.001-0.2 mg/mL of the emitter $S^B$ in dichloromethane or toluene at room temperature (i.e., (approximately) 20°C).

In a preferred embodiment of the invention, a small FWHM emitter $S^B$ is any emitter that has an emission spectrum, which exhibits an FWHM of ≤ 0.24 eV, more preferably of ≤ 0.23 eV, even more preferably of ≤ 0.22 eV, of ≤ 0.21 eV or of ≤ 0.20 eV, measured from a spin-coated film with 1 to 5% by weight, in particular with 2% by weight of emitter $S^B$ in PMMA at room temperature (i.e., (approximately) 20°C). Alternatively, emission spectra of small FWHM emitters $S^B$ may be measured in a solution, typically with 0.001-0.2 mg/mL of the emitter $S^B$ in dichloromethane or toluene at room

temperature (i.e., (approximately) 20°C). In other embodiments of the present invention, each small FWHM emitter $S^B$ exhibits an FWHM of ≤ 0.19 eV, of ≤ 0.18 eV, of ≤ 0.17 eV, of ≤ 0.16 eV, of ≤ 0.15 eV, of ≤ 0.14 eV, of ≤ 0.13 eV, of ≤ 0.12 eV, or of ≤ 0.11 eV.

In one embodiment of the invention, each small FWHM emitter $S^B$ emits light with an emission maximum in the wavelength range of from 510 nm to 550 nm, measured (with 1 to 5% by weight, in particular with 2% by weight of the emitter $S^B$) in PMMA at room temperature.

In one embodiment of the invention, each small FWHM emitter $S^B$ emits light with an emission maximum in the wavelength range of from 510 nm to 550 nm , measured with 0.001-0.2 mg/mL of the emitter $S^B$ in dichloromethane or toluene at room temperature (i.e., (approximately) 20°C).

It is understood that a TADF material $E^B$ comprised in a light-emitting layer B of an organic electroluminescent device according to the invention may optionally also be an emitter with an emission spectrum which exhibits an FWHM of less than or equal to 0.25 eV (≤ 0.25 eV). Optionally, a TADF material $E^B$ comprised in a light-emitting layer B of an organic electroluminescent device according to the invention may also exhibit an emission maximum within the wavelength ranges specified above (namely: 510 nm to 550 nm).

In one embodiment of the invention, the relation expressed by the following formula (29) applies:

$$510\ \text{nm} \leq \lambda_{max}(S^B) \leq 550\ \text{nm} \qquad (29),$$

wherein $\lambda_{max}(S^B)$ refers to the emission maximum of a small FWHM emitter $S^B$ in the context of the present invention.

In one embodiment, the aforementioned relation expressed by formula (29) applies to materials comprised the light-emitting layers B of the organic electroluminescent device according to the invention.

In a preferred embodiment of the invention, the small FWHM emitter $S^B$ is an organic emitter, which, in the context of the invention, means that it does not contain any transition metals. Preferably, the small FWHM emitter $S^B$ according to the invention predominantly consists of the elements hydrogen (H), carbon (C), nitrogen (N), and boron (B), but may for example also comprise oxygen (O), silicon (Si), fluorine (F), and bromine (Br).

In a preferred embodiment of the invention, the small FWHM emitter $S^B$ is a fluorescent emitter, which in the context of the present invention means that, upon electronic excitation (for example in an optoelectronic device according to the invention), the emitter is capable of emitting light at room temperature, wherein the emissive excited state is a singlet state.

In one embodiment of the invention, a small FWHM emitter $S^B$ exhibits a photoluminescence quantum yield (PLQY) equal to or higher than 50%, measured (with 1 to 5% by weight, in particular with 2% by weight of the emitter $S^B$) in PMMA at room temperature.

In a preferred embodiment of the invention, a small FWHM emitter $S^B$ exhibits a photoluminescence quantum yield (PLQY) equal to or higher than 60%, measured (with 1 to 5% by weight, in particular with 2% by weight of the emitter $S^B$) in PMMA at room temperature.

In an even more preferred embodiment of the invention, a small FWHM emitter $S^B$ exhibits a photoluminescence quantum yield (PLQY) equal to or higher than 70%, measured (with 1 to 5% by weight, in particular with 2% by weight of the emitter $S^B$) in PMMA at room temperature.

In a still even more preferred embodiment of the invention, a small FWHM emitter $S^B$ exhibits a photoluminescence quantum yield (PLQY) equal to or higher than 80%, measured (with 1 to 5% by weight, in particular with 2% by weight of the emitter $S^B$) in PMMA at room temperature.

In a particularly preferred embodiment of the invention, a small FWHM emitter $S^B$ exhibits a photoluminescence quantum yield (PLQY) equal to or higher than 90%, measured (with 1 to 5% by weight, in particular with 2% by weight of the emitter $S^B$) in PMMA at room temperature.

In one embodiment of the invention, a small FWHM emitter $S^B$ exhibits a photoluminescence quantum yield (PLQY) equal to or higher than 50%, measured with 0.001-0.2 mg/mL of the emitter $S^B$ in dichloromethane or toluene at room temperature (i.e., (approximately) 20°C).

In a preferred embodiment of the invention, a small FWHM emitter $S^B$ exhibits a photoluminescence quantum yield (PLQY) equal to or higher than 60%, measured with 0.001-0.2 mg/mL of the emitter $S^B$ in dichloromethane or toluene at room temperature (i.e., (approximately) 20°C).

In an even more preferred embodiment of the invention, a small FWHM emitter $S^B$ exhibits a photoluminescence quantum yield (PLQY) equal to or higher than 70%, measured with 0.001-0.2 mg/mL of the emitter $S^B$ in dichloromethane or toluene at room temperature (i.e., (approximately) 20°C).

In a still even more preferred embodiment of the invention, a small FWHM emitter $S^B$ exhibits a photoluminescence quantum yield (PLQY) equal to or higher than 80%, measured with 0.001-0.2 mg/mL of the emitter $S^B$ in dichloromethane or toluene at room temperature (i.e., (approximately) 20°C).

In a particularly preferred embodiment of the invention, a small FWHM emitter $S^B$ exhibits a photoluminescence

quantum yield (PLQY) equal to or higher than 90%, measured with 0.001-0.2 mg/mL of the emitter $S^B$ in dichloromethane or toluene at room temperature (i.e., (approximately) 20°C).

The person skilled in the art knows how to design small FWHM emitters $S^B$ which fulfill the above-mentioned requirements or preferred features.

Another class of molecules suitable to provide small FWHM emitters $S^B$ in the context of the invention are *near-range-charge-transfer* (NRCT) emitters.

Typical NRCT emitters are described in the literature to show a delayed component in the time-resolved photoluminescence spectrum and exhibit a near-range HOMO-LUMO separation. See for example: T. Hatakeyama, K. Shiren, K. Nakajima, S. Nomura, S. Nakatsuka, K. Kinoshita, J. Ni, Y. Ono, and T. Ikuta, Advanced Materials 2016, 28(14), 2777, DOI: 10.1002/adma.201505491.

Typical NRCT emitters only show one emission band in the emission spectrum, wherein typical fluorescence emitters display several distinct emission bands due to vibrational progression.

The skilled artisan knows how to design and synthesize NRCT emitters that may be suitable as small FWHM emitters $S^B$ in the context of the present invention. For example, the emitters disclosed in EP3109253 (A1) may be used as small FWHM emitters $S^B$ in the context of the present invention.

Furthermore, for example, US2014058099 (A1), US2009295275 (A1), US2012319052 (A1), EP2182040 (A2), US2018069182 (A1), US2019393419 (A1), US2020006671 (A1), US2020098991 (A1), US2020176684 (A1), US2020161552 (A1), US2020227639 (A1), US2020185635 (A1), EP3686206 (A1), EP3686206 (A1), WO2020217229 (A1), WO2020208051 (A1), and US2020328351 (A1) disclose emitter materials that may be suitable as small FWHM emitters $S^B$ for use according to the present invention.

A group of emitters that may be used as small FWHM emitters $S^B$ in the context of the present invention are the boron (B)-containing emitters comprising or consisting of a structure according to the following formula DABNA-I:

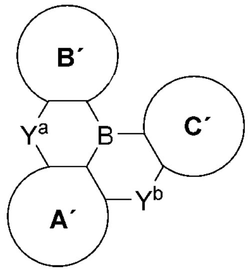

DABNA-I,

wherein

each of ring A', ring B', and ring C' independently of each other represents an aromatic or heteroaromatic ring, each comprising 5 to 24 ring atoms, out of which, in case of a heteroaromatic ring, 1 to 3 ring atoms are heteroatoms independently of each other selected from N, O, S, and Se; wherein
one or more hydrogen atoms in each of the aromatic or heteroaromatic rings A', B', and C' are optionally and independently of each other substituted by a substituent $R^{DABNA-1}$, which is at each occurrence independently of each other selected from the group consisting of: deuterium, $N(R^{DABNA-2})_2$, $OR^{DABNA-2}$, $SR^{DABNA-2}$, $Si(R^{DABNA-2})_3$, $B(OR^{DABNA-2})_2$, $OSO_2R^{DABNA-2}$, $CF_3$, CN, halogen (F, Cl, Br, I),
$C_1$-$C_{40}$-alkyl,

which is optionally substituted with one or more substituents $R^{DABNA-2}$ and
wherein one or more non-adjacent $CH_2$-groups are optionally substituted by $R^{DABNA-2}C{=}CR^{DABNA-2}$, C≡C, $Si(R^{DABNA-2})_2$, $Ge(R^{DABNA-2})_2$, $Sn(R^{DABNA-2})_2$, C=O, C=S, C=Se, $C{=}NR^{DABNA-2}$, $P(=O)(R^{DABNA-2})$, SO, $SO_2$, $NR^{DABNA-2}$, O, S or $CONR^{DABNA-2}$;

$C_1$-$C_{40}$-alkoxy,

which is optionally substituted with one or more substituents $R^{DABNA-2}$ and
wherein one or more non-adjacent $CH_2$-groups are optionally substituted by $R^{DABNA-2}C{=}CR^{DABNA-2}$, C≡C, $Si(R^{DABNA-2})_2$, $Ge(R^{DABNA-2})_2$, $Sn(R^{DABNA-2})_2$, C=O, C=S, C=Se, $C{=}NR^{DABNA-2}$, $P(=O)(R^{DABNA-2})$, SO, $SO_2$, $NR^{DABNA-2}$, O, S or $CONR^{DABNA-2}$;

$C_1$-$C_{40}$-thioalkoxy,

which is optionally substituted with one or more substituents $R^{DABNA-2}$ and
wherein one or more non-adjacent $CH_2$-groups are optionally substituted by $R^{DABNA-2}C=CR^{DABNA-2}$, C≡C, $Si(R^{DABNA-2})_2$, $Ge(R^{DABNA-2})_2$, $Sn(R^{DABNA-2})_2$, C=O, C=S, C=Se, $C=NR^{DABNA-2}$, $P(=O)(R^{DABNA-2})$, SO, $SO_2$, $NR^{DABNA-2}$, O, S or $CONR^{DABNA-2}$;

$C_2$-$C_{40}$-alkenyl,

which is optionally substituted with one or more substituents $R^{DABNA-2}$ and
wherein one or more non-adjacent $CH_2$-groups are optionally substituted by $R^{DABNA-2}C=CR^{DABNA-2}$, C≡C, $Si(R^{DABNA-2})_2$, $Ge(R^{DABNA-2})_2$, $Sn(R^{DABNA-2})_2$, C=O, C=S, C=Se, $C=NR^{DABNA-2}$, $P(=O)(R^{DABNA-2})$, SO, $SO_2$, $NR^{DABNA-2}$, O, S or $CONR^{DABNA-2}$;

$C_2$-$C_{40}$-alkynyl,

which is optionally substituted with one or more substituents $R^{DABNA-2}$ and
wherein one or more non-adjacent $CH_2$-groups are optionally substituted by $R^{DABNA-2}C=CR^{DABNA-2}$, $Si(R^{DABNA-2})_2$, $Ge(R^{DABNA-2})_2$, $Sn(R^{DABNA-2})_2$, C=O, C=S, C=Se, $C=NR^{DABNA-2}$, $P(=O)(R^{DABNA-2})$, SO, $SO_2$, $NR^{DABNA-2}$, O, S or $CONR^{DABNA-2}$;

$C_6$-$C_{60}$-aryl,
which is optionally substituted with one or more substituents $R^{DABNA-2}$;
$C_3$-$C_{57}$-heteroaryl,
which is optionally substituted with one or more substituents $R^{DABNA-2}$;
and aliphatic, cyclic amines comprising 4 to 18 carbon atoms and 1 to 3 nitrogen atoms;
$R^{DABNA-2}$ is at each occurrence independently of each other selected from the group consisting of: hydrogen, deuterium, $N(R^{DABNA-6})_2$, $OR^{DABNA-6}$, $SR^{DABNA-6}$, $Si(R^{DABNA-6})_3$, $B(OR^{DABNA-6})_2$, $OSO_2R^{DABNA-6}$, $CF_3$, CN, halogen (F, Cl, Br, I),
$C_1$-$C_5$-alkyl,

which is optionally substituted with one or more substituents $R^{DABNA-6}$ and
wherein one or more non-adjacent $CH_2$-groups are optionally substituted by $R^{DABNA-6}C=CR^{DABNA-6}$, C≡C, $Si(R^{DABNA-6})_2$, $Ge(R^{DABNA-6})_2$, $Sn(R^{DABNA-6})_2$, C=O, C=S, C=Se, $C=NR^{DABNA-6}$, $P(=O)(R^{DABNA-6})$, SO, $SO_2$, $NR^{DABNA-6}$, O, S or $CONR^{DABNA-6}$;

$C_1$-$C_5$-alkoxy,

which is optionally substituted with one or more substituents $R^{DABNA-6}$ and
wherein one or more non-adjacent $CH_2$-groups are optionally substituted by $R^{DABNA-6}C=CR^{DABNA-6}$, C≡C, $Si(R^{DABNA-6})_2$, $Ge(R^{DABNA-6})_2$, $Sn(R^{DABNA-6})_2$, C=O, C=S, C=Se, $C=NR^{DABNA-6}$, $P(=O)(R^{DABNA-6})$, SO, $SO_2$, $NR^{DABNA-6}$, O, S or $CONR^{DABNA-6}$;

$C_1$-$C_5$-thioalkoxy,

which is optionally substituted with one or more substituents $R^{DABNA-6}$ and
wherein one or more non-adjacent $CH_2$-groups are optionally substituted by $R^{DABNA-6}C=CR^{DABNA-6}$, C≡C, $Si(R^{DABNA-6})_2$, $Ge(R^{DABNA-6})_2$, $Sn(R^{DABNA-6})_2$, C=O, C=S, C=Se, $C=NR^{DABNA-6}$, $P(=O)(R^{DABNA-6})$, SO, $SO_2$, $NR^{DABNA-6}$, O, S or $CONR^{DABNA-6}$;

$C_2$-$C_5$-alkenyl,

which is optionally substituted with one or more substituents $R^{DABNA-6}$ and
wherein one or more non-adjacent $CH_2$-groups are optionally substituted by $R^{DABNA-6}C=CR^{DABNA-6}$, C≡C, $Si(R^{DABNA-6})_2$, $Ge(R^{DABNA-6})_2$, $Sn(R^{DABNA-6})_2$, C=O, C=S, C=Se, $C=NR^{DABNA-6}$, $P(=O)(R^{DABNA-6})$, SO, $SO_2$, $NR^{DABNA-6}$, O, S or $CONR^{DABNA-6}$;

$C_2$-$C_5$-alkynyl,

which is optionally substituted with one or more substituents $R^{DABNA-6}$ and

wherein one or more non-adjacent $CH_2$-groups are optionally substituted by $R^{DABNA-6}C=CR^{DABNA-6}$, $Si(R^{DABNA-6})_2$, $Ge(R^{DABNA-6})_2$, $Sn(R^{DABNA-6})_2$, C=O, C=S, C=Se, $C=NR^{DABNA-6}$, $P(=O)(R^{DABNA-6})$, SO, $SO_2$, $NR^{DABNA-6}$, O, S or $CONR^{DABNA-6}$;

$C_6$-$C_{18}$-aryl,
which is optionally substituted with one or more substituents $R^{DABNA-6}$;
$C_3$-$C_{17}$-heteroaryl,
which is optionally substituted with one or more substituents $R^{DABNA-6}$;
and aliphatic, cyclic amines comprising 4 to 18 carbon atoms and 1 to 3 nitrogen atoms;
wherein two or more adjacent substituents selected from $R^{DABNA-1}$ and $R^{DABNA-2}$ optionally form a mono- or polycyclic, aliphatic or aromatic or heteroaromatic, carbocyclic or heterocyclic ring system which is fused to the adjacent ring A', B' or C', wherein the optionally so formed fused ring system (i.e. the respective ring A', B' or C' and the additional ring(s) that are optionally fused to it) comprises in total 8 to 30 ring atoms;
$Y^a$ and $Y^b$ are independently of each other selected from a direct (single) bond, $NR^{DABNA-3}$, O, S, $C(R^{DABNA-3})_2$, $Si(R^{DABNA-3})_2$, $BR^{DABNA-3}$, and Se;
$R^{DABNA-3}$ is at each occurrence independently of each other selected from the group consisting of: hydrogen, deuterium, $N(R^{DABNA-4})_2$, $OR^{DABNA-4}$, $SR^{DABNA-4}$, $Si(R^{DABNA-4})_3$, $B(OR^{DABNA-4})_2$, $OSO_2R^{DABNA-4}$, $CF_3$, CN, halogen (F, Cl, Br, I),
$C_1$-$C_{40}$-alkyl,

which is optionally substituted with one or more substituents $R^{DABNA-4}$ and
wherein one or more non-adjacent $CH_2$-groups are optionally substituted by $R^{DABNA-4}C=CR^{DABNA-4}$, C≡C, $Si(R^{DABNA-4})_2$, $Ge(R^{DABNA-4})_2$, $Sn(R^{DABNA-4})_2$, C=O, C=S, C=Se, $C=NR^{DABNA-4}$, $P(=O)(R^{DABNA-4})$, SO, $SO_2$, $NR^{DABNA-4}$, O, S or $CONR^{DABNA-4}$;

$C_1$-$C_{40}$-alkoxy,

which is optionally substituted with one or more substituents $R^{DABNA-4}$ and
wherein one or more non-adjacent $CH_2$-groups are optionally substituted by $R^{DABNA-4}C=CR^{DABNA-4}$, C≡C, $Si(R^{DABNA-4})_2$, $Ge(R^{DABNA-4})_2$, $Sn(R^{DABNA-4})_2$, C=O, C=S, C=Se, $C=NR^{DABNA-4}$, $P(=O)(R^{DABNA-4})$, SO, $SO_2$, $NR^{DABNA-4}$, O, S or $CONR^{DABNA-4}$;

$C_1$-$C_{40}$-thioalkoxy,

which is optionally substituted with one or more substituents $R^{DABNA-4}$ and
wherein one or more non-adjacent $CH_2$-groups are optionally substituted by $R^{DABNA-4}C=CR^{DABNA-4}$, C≡C, $SI(R^{DABNA-4})2$, $Ge(R^{DABNA-4})2$, $Sn(R^{DABNA-4})2$, C=O, C=S, C=Se, $C=NR^{DABNA-4}$, $P(=O)(R^{DABNA-4})$, SO, $SO_2$, $NR^{DABNA-4}$, O, S or $CONR^{DABNA-4}$;

$C_2$-$C_{40}$-alkenyl,

which is optionally substituted with one or more substituents $R^{DABNA-4}$ and
wherein one or more non-adjacent $CH_2$-groups are optionally substituted by $R^{DABNA-4}C=CR^{DABNA-4}$, C≡C, $SI(R^{DABNA-4})_2$, $Ge(R^{DABNA-4})_2$, $Sn(R^{DABNA-4})_2$, C=O, C=S, C=Se, $C=NR^{DABNA-4}$, $P(=O)(R^{DABNA-4})$, SO, $SO_2$, $NR^{DABNA-4}$, O, S or $CONR^{DABNA-4}$;

$C_2$-$C_{40}$-alkynyl,

which is optionally substituted with one or more substituents $R^{DABNA-4}$ and
wherein one or more non-adjacent $CH_2$-groups are optionally substituted by $R^{DABNA-4}C=CR^{DABNA-4}$, $Si(R^{DABNA-4})_2$, $Ge(R^{DABNA-4})_2$, $Sn(R^{DABNA-4})_2$, C=O, C=S, C=Se, $C=NR^{DABNA-4}$, $P(=O)(R^{DABNA-4})$, SO, $SO_2$, $NR^{DABNA-4}$, O, S or $CONR^{DABNA-4}$;

$C_6$-$C_{60}$-aryl,
which is optionally substituted with one or more substituents $R^{DABNA-4}$;
$C_3$-$C_{57}$-heteroaryl,
which is optionally substituted with one or more substituents $R^{DABNA-4}$;

and aliphatic, cyclic amines comprising 4 to 18 carbon atoms and 1 to 3 nitrogen atoms;
$R^{DABNA-4}$ is at each occurrence independently of each other selected from the group consisting of: hydrogen, deuterium, $N(R^{DABNA-5})_2$, $OR^{DABNA-5}$ $SR^{DABNA-5}$, $Si(R^{DABNA-5})_3$, $B(OR^{DABNA-5})_2$, $OSO_2R^{DABNA-5}$, $CF_3$, CN, halogen (F, Cl, Br, I),
$C_1$-$C_{40}$-alkyl,

which is optionally substituted with one or more substituents $R^{DABNA-5}$ and
wherein one or more non-adjacent $CH_2$-groups are optionally substituted by $R^{DABNA-5}C$=$CR^{DABNA-5}$, C≡C, $SI(R^{DABNA-5})_2$, $Ge(R^{DABNA-5})2$, $Sn(R^{DABNA-5})2$, C=O, C=S, C=Se, C=$NR^{DABNA-5}$, P(=O)($R^{DABNA-5}$), SO, $SO_2$, $NR^{DABNA-5}$, O, S or $CONR^{DABNA-5}$;

$C_1$-$C_{40}$-alkoxy,

which is optionally substituted with one or more substituents $R^{DABNA-5}$ and
wherein one or more non-adjacent $CH_2$-groups are optionally substituted by $R^{DABNA-5}C$=$CR^{DABNA-5}$, C≡C, $Si(R^{DABNA-5})_2$, $Ge(R^{DABNA-5})_2$, $Sn(R^{DABNA-5})_2$, C=O, C=S, C=Se, C=$NR^{DABNA-5}$, P(=O)($R^{DABNA-5}$), SO, $SO_2$, $NR^{DABNA-5}$, O, S or $CONR^{DABNA-5}$;

$C_1$-$C_{40}$-thioalkoxy,

which is optionally substituted with one or more substituents $R^{DABNA-5}$ and
wherein one or more non-adjacent $CH_2$-groups are optionally substituted by $R^{DABNA-5}C$=$CR^{DABNA-5}$, C≡C, $Si(R^{DABNA-5})_2$, $Ge(R^{DABNA-5})_2$, $Sn(R^{DABNA-5})_2$, C=O, C=S, C=Se, C=$NR^{DABNA-5}$, P(=O)($R^{DABNA-5}$), SO, $SO_2$, $NR^{DABNA-5}$, O, S or $CONR^{DABNA-5}$;

$C_2$-$C_{40}$-alkenyl,

which is optionally substituted with one or more substituents $R^{DABNA-5}$ and
wherein one or more non-adjacent $CH_2$-groups are optionally substituted by $R^{DABNA-5}C$=$CR^{DABNA-5}$, C≡C, $Si(R^{DABNA-5})_2$, $Ge(R^{DABNA-5})_2$, $Sn(R^{DABNA-5})_2$, C=O, C=S, C=Se, C=$NR^{DABNA-5}$, P(=O)($R^{DABNA-5}$), SO, $SO_2$, $NR^{DABNA-5}$, O, S or $CONR^{DABNA-5}$;

$C_2$-$C_{40}$-alkynyl,

which is optionally substituted with one or more substituents $R^{DABNA-5}$ and
wherein one or more non-adjacent $CH_2$-groups are optionally substituted by $R^{DABNA-5}C$=$CR^{DABNA-5}$, $Si(R^{DABNA-5})_2$, $Ge(R^{DABNA-5})_2$, $Sn(R^{DABNA-5})_2$, C=O, C=S, C=Se, C=$NR^{DABNA-5}$, P(=O)($R^{DABNA-5}$), SO, $SO_2$, $NR^{DABNA-5}$, O, S or $CONR^{DABNA-5}$;

$C_6$-$C_{60}$-aryl,
which is optionally substituted with one or more substituents $R^{DABNA-5}$;
$C_3$-$C_{57}$-heteroaryl,
which is optionally substituted with one or more substituents $R^{DABNA-5}$;
and aliphatic, cyclic amines comprising 4 to 18 carbon atoms and 1 to 3 nitrogen atoms;
$R^{DABNA-5}$ is at each occurrence independently of each other selected from the group consisting of: hydrogen, deuterium, $N(R^{DABNA-6})_2$, $OR^{DABNA-6}$, $SR^{DABNA-6}$, $Si(R^{DABNA-6})_3$, $B(OR^{DABNA-6})_2$, $OSO_2R^{DABNA-6}$, $CF_3$, CN, halogen (F, Cl, Br, I),
$C_1$-$C_5$-alkyl,

which is optionally substituted with one or more substituents $R^{DABNA-6}$ and
wherein one or more non-adjacent $CH_2$-groups are optionally substituted by $R^{DABNA-6}C$=$CR^{DABNA-6}$, C≡C, $Si(R^{DABNA-6})_2$, $Ge(R^{DABNA-6})_2$, $Sn(R^{DABNA-6})_2$, C=O, C=S, C=Se, C=$NR^{DABNA-6}$, P(=O)($R^{DABNA-6}$), SO, $SO_2$, $NR^{DABNA-6}$, O, S or $CONR^{DABNA-6}$;

$C_1$-$C_5$-alkoxy,

which is optionally substituted with one or more substituents $R^{DABNA-6}$ and
wherein one or more non-adjacent $CH_2$-groups are optionally substituted by $R^{DABNA-6}C$=$CR^{DABNA-6}$, C≡C,

$Si(R^{DABNA-6})_2$, $Ge(R^{DABNA-6})_2$, $Sn(R^{DABNA-6})_2$, C=O, C=S, C=Se, $C=NR^{DABNA-6}$, $P(=O)(R^{DABNA-6})$, SO, $SO_2$, $NR^{DABNA-6}$, O, S or $CONR^{DABNA-6}$;

$C_1$-$C_5$-thioalkoxy,

which is optionally substituted with one or more substituents $R^{DABNA-6}$ and
wherein one or more non-adjacent $CH_2$-groups are optionally substituted by $R^{DABNA-6}C=CR^{DABNA-6}$, C≡C, $Si(R^{DABNA-6})_2$, $Ge(R^{DABNA-6})_2$, $Sn(R^{DABNA-6})_2$, C=O, C=S, C=Se, $C=NR^{DABNA-6}$, $P(=O)(R^{DABNA-6})$, SO, $SO_2$, $NR^{DABNA-6}$, O, S or $CONR^{DABNA-6}$;

$C_2$-$C_5$-alkenyl,

which is optionally substituted with one or more substituents $R^{DABNA-6}$ and
wherein one or more non-adjacent $CH_2$-groups are optionally substituted by $R^{DABNA-6}C=CR^{DABNA-6}$, C≡C, $Si(R^{DABNA-6})_2$, $Ge(R^{DABNA-6})_2$, $Sn(R^{DABNA-6})_2$, C=O, C=S, C=Se, $C=NR^{DABNA-6}$, $P(=O)(R^{DABNA-6})$, SO, $SO_2$, $NR^{DABNA-6}$, O, S or $CONR^{DABNA-6}$;

$C_2$-$C_5$-alkynyl,

which is optionally substituted with one or more substituents $R^{DABNA-6}$ and
wherein one or more non-adjacent $CH_2$-groups are optionally substituted by $R^{DABNA-6}C=CR^{DABNA-6}$, $Si(R^{DABNA-6})_2$, $Ge(R^{DABNA-6})_2$, $Sn(R^{DABNA-6})_2$, C=O, C=S, C=Se, $C=NR^{DABNA-6}$, $P(=O)(R^{DABNA-6})$, SO, $SO_2$, $NR^{DABNA-6}$, O, S or $CONR^{DABNA-6}$;

$C_6$-$C_{18}$-aryl,
which is optionally substituted with one or more substituents $R^{DABNA-6}$;
$C_3$-$C_{17}$-heteroaryl,
which is optionally substituted with one or more substituents $R^{DABNA-6}$;
and aliphatic, cyclic amines comprising 4 to 18 carbon atoms and 1 to 3 nitrogen atoms;
wherein two or more adjacent substituents selected from $R^{DABNA-3}$, $R^{DABNA-4}$, and $R^{DABNA-5}$ optionally form a mono- or polycyclic, aliphatic or aromatic or heteroaromatic, carbocyclic or heterocyclic ring system with each other, wherein the optionally so formed ring system comprises in total 8 to 30 ring atoms;
$R^{DABNA-6}$ is at each occurrence independently of each other selected from the group consisting of: hydrogen, deuterium, OPh (Ph = phenyl), SPh, $CF_3$, CN, F, $Si(C_1\text{-}C_5\text{-alkyl})_3$, $Si(Ph)_3$,
$C_1$-$C_5$-alkyl,
wherein optionally one or more hydrogen atoms are independently substituted by deuterium, Ph, CN, $CF_3$, or F;
$C_1$-$C_5$-alkoxy,
wherein optionally one or more hydrogen atoms are independently substituted by deuterium, CN, $CF_3$, or F;
$C_1$-$C_5$-thioalkoxy,
wherein optionally one or more hydrogen atoms are independently substituted by deuterium, CN, $CF_3$, or F;
$C_2$-$C_5$-alkenyl,
wherein optionally one or more hydrogen atoms are independently substituted by deuterium, CN, $CF_3$, or F;
$C_2$-$C_5$-alkynyl,
wherein optionally one or more hydrogen atoms are independently substituted by deuterium, CN, $CF_3$, or F;
$C_6$-$C_{18}$-aryl,
wherein optionally one or more hydrogen atoms are independently substituted by deuterium, CN, $CF_3$, F, $C_1$-$C_5$-alkyl, $SiMe_3$, $SiPh_3$ or $C_6$-$C_{18}$-aryl substituents;
$C_3$-$C_{17}$-heteroaryl,
wherein optionally one or more hydrogen atoms are independently substituted by deuterium, CN, $CF_3$, F, $C_1$-$C_5$-alkyl, $SiMe_3$, $SiPh_3$ or $C_6$-$C_{18}$-aryl substituents;
$N(C_6\text{-}C_{18}\text{-aryl})_2$,
$N(C_3\text{-}C_{17}\text{-heteroaryl})_2$; and
$N(C_3\text{-}C_{17}\text{-heteroaryl})(C_6\text{-}C_{18}\text{-aryl})$;
wherein in case, one of $Y^a$ and $Y^b$ is or both of of $Y^a$ and $Y^b$ are $NR^{DABNA-3}$, $C(R^{DABNA-3})_2$, $Si(R^{DABNA-3})_2$, or $BR^{DABNA-3}$ the one or the two substituents $R^{DABNA-3}$ may optionally and independently of each other bond to one or both of the adjacent rings A' and B' (for $Y^a$ = $NR^{DABNA-3}$, $C(R^{DABNA-3})_2$, $Si(R^{DABNA-3})_2$, or $BR^{DABNA-3}$) or A' and C' (for $Y^b$ = $NR^{DABNA-3}$, $C(R^{DABNA-3})_2$, $Si(R^{DABNA-3})_2$, or $BR^{DABNA-3}$) via a direct (single) bond or via a connecting atom or atom group being in each case independently selected from $NR^{DABNA-1}$, O, S, $C(R^{DABNA-1})_2$, $Si(R^{DABNA-1})_2$, $BR^{DABNA-1}$,

and Se;

and wherein optionally, two or more, preferably two, structures of formula DABNA-I are conjugated with each other, preferably fused to each other by sharing at least one, more preferably exactly one, bond;

wherein optionally two or more, preferably two, structures of formula DABNA-I are present in the emitter and share at least one, preferably exactly one, aromatic or heteroaromatic ring (i.e. this ring may be part of both structures of formula DABNA-I) which preferably is any of the rings A', B', and C' of formula DABNA-I, but may also be any aromatic or heteroaromatic substituent selected from $R^{DABNA-1}$, $R^{DABNA-2}$, $R^{DABNA-3}$, $R^{DABNA-4}$, $R^{DABNA-5}$, and $R^{DABNA-6}$, in particular $R^{DABNA-3}$, or any aromatic or heteroaromatic ring formed by two or more adjacent substituents as stated above, wherein the shared ring may constitute the same or different moieties of the two or more structures of formula DABNA-I that share the ring (i.e. the shared ring may for example be ring C' of both structures of formula DABNA-I optionally comprised in the emitter or the shared ring may for example be ring B' of one and ring C' of the other structure of formula DABNA-I optionally comprised in the emitter); and

wherein optionally at least one of $R^{DABNA-1}$, $R^{DABNA-2}$, $R^{DABNA-3}$, $R^{DABNA-4}$, $R^{DABNA-5}$; and $R^{DABNA-6}$ is replaced by a bond to a further chemical entity of formula DABNA-I and/or wherein optionally at least one hydrogen atom of any of $R^{DABNA-1}$, $R^{DABNA-2}$, $R^{DABNA-3}$, $R^{DABNA-4}$, $R^{DABNA-5}$, and $R^{DABNA-6}$ is replaced by a bond to a further chemical entity of formula DABNA-I.

In one embodiment of the invention, in at least one, preferably each, light-emitting layer B, at least one of the one or more small FWHM emitters $S^B$ comprises a structure according to formula DABNA-I.

In one embodiment of the invention, in at least one, preferably each, light-emitting layer B, each small FWHM emitter $S^B$ comprises a structure according to formula DABNA-I.

In one embodiment of the invention, in at least one, preferably each, light-emitting layer B, at least one of the one or more small FWHM emitters $S^B$ consists of a structure according to formula DABNA-I.

In one embodiment of the invention, in at least one, preferably each, light-emitting layer B, each small FWHM emitter $S^B$ consists of a structure according to formula DABNA-I.

In a preferred embodiment of the invention, in which in at least one, preferably each, light-emitting layer B, at least one, preferably each, of the one or more small FWHM emitters $S^B$ comprises or consists of a structure according to formula DABNA-I, A', B', and C' are all aromatic rings with 6 ring atoms each (i.e. they are all benzene rings).

In one embodiment of the invention, in which in at least one, preferably each, light-emitting layer B, at least one, preferably each, of the one or more small FWHM emitters $S^B$ comprises or consists of a structure according to formula DABNA-I, $Y^a$ and $Y^b$ are independently of each other selected from $NR^{DABNA-3}$, O, S, $C(R^{DABNA-3})_2$, and $Si(R^{DABNA-3})_2$.

In a preferred embodiment of the invention, in which in at least one, preferably each, light-emitting layer B, at least one, preferably each, of the one or more small FWHM emitters $S^B$ comprises or consists of a structure according to formula DABNA-I, $Y^a$ and $Y^b$ are independently of each other selected from $NR^{DABNA-3}$, O, and S.

In an even more preferred embodiment of the invention, in which in at least one, preferably each, light-emitting layer B, at least one, preferably each, of the one or more small FWHM emitters $S^B$ comprises or consists of a structure according to formula DABNA-I, $Y^a$ and $Y^b$ are independently of each other selected from $NR^{DABNA-3}$, and O.

In a particularly preferred embodiment of the invention, in which in at least one, preferably each, light-emitting layer B, at least one, preferably each, of the one or more small FWHM emitters $S^B$ comprises or consists of a structure according to formula DABNA-I, $Y^a$ and $Y^b$ are both $NR^{DABNA-3}$.

In a particularly preferred embodiment of the invention, in which in at least one, preferably each, light-emitting layer B, at least one, preferably each, of the one or more small FWHM emitters $S^B$ comprises or consists of a structure according to formula DABNA-I, $Y^a$ and $Y^b$ are identical and are both $NR^{DABNA-3}$.

In one embodiment of the invention, in which in at least one, preferably each, light-emitting layer B, at least one, preferably each, of the one or more small FWHM emitters $S^B$ comprises or consists of a structure according to formula DABNA-I, $R^{DABNA-1}$, is at each occurrence independently of each other selected from the group consisting of: hydrogen, deuterium, $N(R^{DABNA-2})_2$, $OR^{DABNA-2}$, $SR^{DABNA-2}$, $Si(R^{DABNA-2})_3$, $CF_3$, CN, F,

$C_1$-$C_5$-alkyl,
which is optionally substituted with one or more substituents $R^{DABNA-2}$;
$C_1$-$C_5$-alkoxy,
which is optionally substituted with one or more substituents $R^{DABNA-2}$;
$C_1$-$C_5$-thioalkoxy,
which is optionally substituted with one or more substituents $R^{DABNA-2}$;
$C_6$-$C_{18}$-aryl,
which is optionally substituted with one or more substituents $R^{DABNA-2}$;
$C_3$-$C_{17}$-heteroaryl,
which is optionally substituted with one or more substituents $R^{DABNA-2}$;

$R^{DABNA-2}$ is at each occurrence independently of each other selected from the group consisting of: hydrogen, deuterium, $N(R^{DABNA-6})_2$, $OR^{DABNA-6}$, $SR^{DABNA-6}$, $Si(R^{DABNA-6})_3$, $CF_3$, CN, F,
$C_1$-$C_5$-alkyl,
which is optionally substituted with one or more substituents $R^{DABNA-6}$;
$C_6$-$C_{18}$-aryl,
which is optionally substituted with one or more substituents $R^{DABNA-6}$;
$C_3$-$C_{17}$-heteroaryl,
which is optionally substituted with one or more substituents $R^{DABNA-6}$;
wherein two or more adjacent substituents selected from $R^{DABNA-1}$ and $R^{DABNA-2}$ optionally form a mono- or polycyclic, aliphatic or aromatic or heteroaromatic, carbocyclic or heterocyclic ring system which is fused to the adjacent ring A', B' or C', wherein the optionally so formed fused ring system (i.e. the respective ring A', B' or C' and the additional ring(s) that are optionally fused to it) comprises in total 8 to 30 ring atoms.

In one embodiment of the invention, in which in at least one, preferably each, light-emitting layer B, at least one, preferably each, of the one or more small FWHM emitters $S^B$ comprises or consists of a structure according to formula DABNA-I, $R^{DABNA-1}$, is at each occurrence independently of each other selected from the group consisting of: hydrogen, deuterium, $N(R^{DABNA-2})_2$, $OR^{DABNA-2}$, $SR^{DABNA-2}$, $Si(R^{DABNA-2})_3$,

$C_1$-$C_5$-alkyl,
which is optionally substituted with one or more substituents $R^{DABNA-2}$;
$C_6$-$C_{18}$-aryl,
which is optionally substituted with one or more substituents $R^{DABNA-2}$;
$C_3$-$C_{17}$-heteroaryl,
which is optionally substituted with one or more substituents $R^{DABNA-2}$;
$R^{DABNA-2}$ is at each occurrence independently of each other selected from the group consisting of: hydrogen, deuterium, $N(R^{DABNA-6})_2$, $OR^{DABNA-6}$, $SR^{DABNA-6}$, $Si(R^{DABNA-6})_3$, $CF_3$, CN, F,
$C_1$-$C_5$-alkyl,
which is optionally substituted with one or more substituents $R^{DABNA-6}$;
$C_6$-$C_{18}$-aryl,
which is optionally substituted with one or more substituents $R^{DABNA-6}$;
$C_3$-$C_{17}$-heteroaryl,
which is optionally substituted with one or more substituents $R^{DABNA-6}$;
wherein two or more adjacent substituents selected from $R^{DABNA-1}$ and $R^{DABNA-2}$ optionally form a mono- or polycyclic, aliphatic or aromatic or heteroaromatic, carbocyclic or heterocyclic ring system which is fused to the adjacent ring A', B' or C', wherein the optionally so formed fused ring system (i.e. the respective ring A', B' or C' and the additional ring(s) that are optionally fused to it) comprises in total 8 to 30 ring atoms.

In one embodiment of the invention, in which in at least one, preferably each, light-emitting layer B, at least one, preferably each, of the one or more small FWHM emitters $S^B$ comprises or consists of a structure according to formula DABNA-I, $R^{DABNA-1}$, is at each occurrence independently of each other selected from the group consisting of: hydrogen, deuterium, $N(R^{DABNA-2})_2$, $OR^{DABNA-2}$, $SR^{DABNA-2}$

$C_1$-$C_5$-alkyl,
which is optionally substituted with one or more substituents $R^{DABNA-2}$;
$C_6$-$C_{18}$-aryl,
which is optionally substituted with one or more substituents $R^{DABNA-2}$;
$C_3$-$C_{17}$-heteroaryl,
which is optionally substituted with one or more substituents $R^{DABNA-2}$;
$R^{DABNA-2}$ is at each occurrence independently of each other selected from the group consisting of: hydrogen, deuterium, $N(Ph)_2$, OPh, CN, Me, $^{i}Pr$, $^{t}Bu$, $Si(Me)_3$,
Ph,
which is optionally substituted with one or more substituents $R^{DABNA-6}$;
$C_3$-$C_{17}$-heteroaryl,
which is optionally substituted with one or more substituents $R^{DABNA-6}$;
wherein two or more adjacent $R^{DABNA-1}$ form a mono- or polycyclic, aliphatic or aromatic or heteroaromatic, carbocyclic or heterocyclic ring system which is fused to the adjacent ring A', B' or C', wherein the optionally so formed fused ring system (i.e. the respective ring A', B' or C' and the additional ring(s) that are optionally fused to it) comprises in total 8 to 30 ring atoms.

In one embodiment of the invention, in which in at least one, preferably each, light-emitting layer B, at least one, preferably each, of the one or more small FWHM emitters $S^B$ comprises or consists of a structure according to formula DABNA-I, $R^{DABNA-1}$, is at each occurrence independently of each other selected from the group consisting of: hydrogen, deuterium, $N(Ph)_2$, OPh, Me, $^iPr$, $^tBu$, $Si(Me)_3$,

Ph,

wherein one or more hydrogen atoms are optionally, independently from each other substituted by deuterium, Me, $^iPr$, $^tBu$, Ph, or CN;

$C_3$-$C_{17}$-heteroaryl,

wherein one or more hydrogen atoms are optionally, independently from each other substituted by deuterium, Me, $^iPr$, $^tBu$, Ph, or CN;

wherein two or more adjacent substituents $R^{DABNA-1}$ optionally form a mono- or polycyclic, aliphatic or aromatic or heteroaromatic, carbocyclic or heterocyclic ring system which is fused to the adjacent ring A', B' or C', wherein the optionally so formed fused ring system (i.e. the respective ring A', B' or C' and the additional ring(s) that are optionally fused to it) comprises in total 8 to 30 ring atoms.

In one embodiment of the invention, in which in at least one, preferably each, light-emitting layer B, at least one, preferably each, of the one or more small FWHM emitters $S^B$ comprises or consists of a structure according to formula DABNA-I, $R^{DABNA-1}$, is at each occurrence independently of each other selected from the group consisting of: hydrogen, deuterium, $N(Ph)_2$, Me, $^iPr$, $^tBu$,

Ph,

wherein one or more hydrogen atoms are optionally, independently from each other substituted by deuterium, Me, $^iPr$, $^tBu$, Ph or CN;

carbazolyl,

wherein one or more hydrogen atoms are optionally, independently from each other substituted by deuterium, Me, $^iPr$, $^tBu$, Ph or CN;

triazinyl,

wherein one or more hydrogen atoms are optionally, independently from each other substituted by deuterium, Me, $^iPr$, $^tBu$, or Ph;

pyrimidinyl,

wherein one or more hydrogen atoms are optionally, independently from each other substituted by deuterium, Me, $^iPr$, $^tBu$, or Ph;

pyridinyl,

wherein one or more hydrogen atoms are optionally, independently from each other substituted by deuterium, Me, $^iPr$, $^tBu$, or Ph;

wherein two or more adjacent substituents $R^{DABNA-1}$ optionally form a mono- or polycyclic, aliphatic or aromatic or heteroaromatic, carbocyclic or heterocyclic ring system which is fused to the adjacent ring A', B' or C', wherein the optionally so formed fused ring system (i.e. the respective ring A', B' or C' and the additional ring(s) that are optionally fused to it) comprises in total 8 to 30 ring atoms.

In one embodiment of the invention, in which in at least one, preferably each, light-emitting layer B, at least one, preferably each, of the one or more small FWHM emitters $S^B$ comprises or consists of a structure according to formula DABNA-I, adjacent substituents selected from $R^{DABNA-1}$ and $R^{DABNA-2}$ do not form a mono- or polycyclic, aliphatic or

aromatic or heteroaromatic, carbocyclic or heterocyclic ring system which is fused to the adjacent ring A', B' or C'.

In one embodiment of the invention, in which in at least one, preferably each, light-emitting layer B, at least one, preferably each, of the one or more small FWHM emitters $S^B$ comprises or consists of a structure according to formula DABNA-I, $R^{DABNA-3}$ is at each occurrence independently of each other selected from the group consisting of: hydrogen, deuterium,

$C_1$-$C_4$-alkyl,
which is optionally substituted with one or more substituents $R^{DABNA-4}$;
$C_6$-$C_{18}$-aryl,
which is optionally substituted with one or more substituents $R^{DABNA-4}$;
$C_3$-$C_{17}$-heteroaryl,
which is optionally substituted with one or more substituents $R^{DABNA-4}$;
$R^{DABNA-4}$ is at each occurrence independently of each other selected from the group consisting of: hydrogen, deuterium, $N(R^{DABNA-5})_2$, $OR^{DABNA-5}$, $SR^{DABNA-5}$, $Si(C_1$-$C_5$-alkyl$)_3$, $CF_3$, CN, F,
$C_1$-$C_5$-alkyl,
which is optionally substituted with one or more substituents $R^{DABNA-5}$;
$C_6$-$C_{18}$-aryl,
which is optionally substituted with one or more substituents $R^{DABNA-5}$;
$C_3$-$C_{17}$-heteroaryl,
which is optionally substituted with one or more substituents $R^{DABNA-5}$;
$R^{DABNA-5}$ is at each occurrence independently of each other selected from the group consisting of: hydrogen, deuterium, $N(Ph)_2$, OPh, $Si(Me)_3$, $CF_3$, CN, F,
$C_1$-$C_5$-alkyl,

wherein one or more hydrogen atoms are optionally, independently from each other substituted by deuterium;

$C_6$-$C_{18}$-aryl,

wherein one or more hydrogen atoms are optionally, independently from each other substituted by deuterium, Me, $^{i}$Pr, $^{t}$Bu, Ph, or CN;

$C_3$-$C_{17}$-heteroaryl,

wherein one or more hydrogen atoms are optionally, independently from each other substituted by deuterium, Me, $^{i}$Pr, $^{t}$Bu, Ph, or CN;

wherein two or more adjacent substituents selected from $R^{DABNA-3}$, $R^{DABNA-4}$, and $R^{DABNA-5}$ optionally form a mono- or polycyclic, aliphatic or aromatic or heteroaromatic, carbocyclic or heterocyclic ring system with each other, wherein the optionally so formed ring system comprises in total 8 to 30 ring atoms.

In one embodiment of the invention, in which in at least one, preferably each, light-emitting layer B, at least one, preferably each, of the one or more small FWHM emitters $S^B$ comprises or consists of a structure according to formula DABNA-I, $R^{DABNA-3}$ is at each occurrence independently of each other selected from the group consisting of: hydrogen, deuterium,

$C_1$-$C_4$-alkyl,
which is optionally substituted with one or more substituents $R^{DABNA-4}$;
$C_6$-$C_{18}$-aryl,
which is optionally substituted with one or more substituents $R^{DABNA-4}$;
$C_3$-$C_{17}$-heteroaryl,
which is optionally substituted with one or more substituents $R^{DABNA-4}$;
$R^{DABNA-4}$ is at each occurrence independently of each other selected from the group consisting of: hydrogen, deuterium, $N(Ph)_2$, OPh, $Si(Me)_3$, $CF_3$, CN, F,
$C_1$-$C_5$-alkyl,

wherein one or more hydrogen atoms are optionally, independently from each other substituted by deuterium;

$C_6$-$C_{18}$-aryl,

wherein one or more hydrogen atoms are optionally, independently from each other substituted by deuterium, Me, $^i$Pr, $^t$Bu, Ph, or CN;

$C_3$-$C_{17}$-heteroaryl,

wherein one or more hydrogen atoms are optionally, independently from each other substituted by deuterium, Me, $^i$Pr, $^t$Bu, Ph, or CN;

wherein two or more adjacent substituents selected from $R^{DABNA-3}$ and $R^{DABNA-4}$ do not form a mono- or polycyclic, aliphatic or aromatic or heteroaromatic, carbocyclic or heterocyclic ring system with each other.

In one embodiment of the invention, in which in at least one, preferably each, light-emitting layer B, at least one, preferably each, of the one or more small FWHM emitters $S^B$ comprises or consists of a structure according to formula DABNA-I, $R^{DABNA-3}$ is at each occurrence independently of each other selected from the group consisting of: hydrogen, deuterium,

$C_1$-$C_4$-alkyl,
which is optionally substituted with one or more substituents $R^{DABNA-4}$;
$C_6$-$C_{18}$-aryl,
which is optionally substituted with one or more substituents $R^{DABNA-4}$;
$C_3$-$C_{17}$-heteroaryl,
which is optionally substituted with one or more substituents $R^{DABNA-4}$;
$R^{DABNA-4}$ is at each occurrence independently of each other selected from the group consisting of: hydrogen, deuterium, CN, F,
$C_1$-$C_5$-alkyl,

wherein one or more hydrogen atoms are optionally, independently from each other substituted by deuterium;

$C_6$-$C_{18}$-aryl,

wherein one or more hydrogen atoms are optionally, independently from each other substituted by deuterium, Me, $^i$Pr, $^t$Bu, Ph, or CN;

$C_3$-$C_{17}$-heteroaryl,

wherein one or more hydrogen atoms are optionally, independently from each other substituted by deuterium, Me, $^i$Pr, $^t$Bu, Ph, or CN;

wherein two or more adjacent substituents selected from $R^{DABNA-3}$ and $R^{DABNA-4}$ do not form a mono- or polycyclic, aliphatic or aromatic or heteroaromatic, carbocyclic or heterocyclic ring system with each other.

In one embodiment of the invention, in which in at least one, preferably each, light-emitting layer B, at least one, preferably each, of the one or more small FWHM emitters $S^B$ comprises or consists of a structure according to formula DABNA-I, $R^{DABNA-3}$ is at each occurrence independently of each other selected from the group consisting of: hydrogen, deuterium, Me, $^i$Pr, $^t$Bu,

$C_6$-$C_{18}$-aryl,
wherein one or more hydrogen atoms are optionally, independently from each other substituted by deuterium, Me, $^i$Pr, $^t$Bu, Ph, or CN;
wherein two or more adjacent substituents selected from $R^{DABNA-3}$ do not form a mono- or polycyclic, aliphatic or aromatic or heteroaromatic, carbocyclic or heterocyclic ring system with each other.

In one embodiment of the invention, in which in at least one, preferably each, light-emitting layer B, at least one, preferably each, of the one or more small FWHM emitters $S^B$ comprises or consists of a structure according to formula DABNA-I, $R^{DABNA-3}$ is at each occurrence independently of each other selected from the group consisting of: hydrogen,

deuterium, Me, $^{i}Pr$, $^{t}Bu$, and

Ph,
wherein one or more hydrogen atoms are optionally, independently from each other substituted by deuterium, Me, $^{i}Pr$, $^{t}Bu$, Ph, or CN;
wherein two or more adjacent substituents selected from $R^{DABNA-3}$ do not form a mono- or polycyclic, aliphatic or aromatic or heteroaromatic, carbocyclic or heterocyclic ring system with each other.

In one embodiment of the invention, in which in at least one, preferably each, light-emitting layer B, at least one, preferably each, of the one or more small FWHM emitters $S^B$ comprises or consists of a structure according to formula DABNA-I, $R^{DABNA-6}$ is at each occurrence independently of each other selected from the group consisting of: hydrogen, deuterium, OPh (Ph = phenyl), SPh, $CF_3$, CN, F, $Si(C_1\text{-}C_5\text{-alkyl})_3$, $Si(Ph)_3$,

$C_1$-$C_5$-alkyl,

wherein optionally one or more hydrogen atoms are independently substituted by deuterium, Ph, CN, $CF_3$, or F;

$C_6$-$C_{18}$-aryl,

wherein optionally one or more hydrogen atoms are independently substituted by deuterium, CN, $CF_3$, F, $C_1$-$C_5$-alkyl, $SiMe_3$, $SiPh_3$ or $C_6$-$C_{18}$-aryl substituents;

$C_3$-$C_{17}$-heteroaryl,

wherein optionally one or more hydrogen atoms are independently substituted by deuterium, CN, $CF_3$, F, $C_1$-$C_5$-alkyl, $SiMe_3$, $SiPh_3$ or $C_6$-$C_{18}$-aryl substituents;

$N(C_6\text{-}C_{18}\text{-aryl})_2$,
$N(C_3\text{-}C_{17}\text{-heteroaryl})_2$; and
$N(C_3\text{-}C_{17}\text{-heteroaryl})(C_6\text{-}C_{18}\text{-aryl})$.

In one embodiment of the invention, in which in at least one, preferably each, light-emitting layer B, at least one, preferably each, of the one or more small FWHM emitters $S^B$ comprises or consists of a structure according to formula DABNA-I, $R^{DABNA-6}$ is at each occurrence independently of each other selected from the group consisting of: hydrogen, deuterium, $N(Ph)_2$, OPh (Ph = phenyl), SPh, $CF_3$, CN, F, $Si(Me)_3$, $Si(Ph)_3$,

$C_1$-$C_5$-alkyl,

wherein optionally one or more hydrogen atoms are independently substituted by deuterium, Ph, CN, $CF_3$, or F;

$C_6$-$C_{18}$-aryl,

wherein optionally one or more hydrogen atoms are independently substituted by deuterium, CN, $CF_3$, F, Me, $^{i}Pr$, $^{t}Bu$, $SiMe_3$, $SiPh_3$ or Ph;

$C_3$-$C_{17}$-heteroaryl,

wherein optionally one or more hydrogen atoms are independently substituted by deuterium, CN, $CF_3$, F, , Me, $^{i}Pr$, $^{t}Bu$, $SiMe_3$, $SiPh_3$ or Ph.

In one embodiment of the invention, in which in at least one, preferably each, light-emitting layer B, at least one, preferably each, of the one or more small FWHM emitters $S^B$ comprises or consists of a structure according to formula DABNA-I, $R^{DABNA-6}$ is at each occurrence independently of each other selected from the group consisting of: hydrogen, deuterium, $N(Ph)_2$, CN, F, Me, $^{i}Pr$, $^{t}Bu$,

Ph,

wherein optionally one or more hydrogen atoms are independently substituted by deuterium, CN, Me, $^{i}$Pr, $^{t}$Bu, or Ph;

$C_3$-$C_{17}$-heteroaryl,

wherein optionally one or more hydrogen atoms are independently substituted by deuterium, CN, Me, $^{i}$Pr, $^{t}$Bu, or Ph.

In one embodiment of the invention, in which in at least one, preferably each, light-emitting layer B, at least one, preferably each, of the one or more small FWHM emitters $S^B$ comprises or consists of a structure according to formula DABNA-I, $R^{DABNA-6}$ is at each occurrence independently of each other selected from the group consisting of: hydrogen, deuterium, Me, $^{i}$Pr, $^{t}$Bu,

Ph,

wherein optionally one or more hydrogen atoms are independently substituted by deuterium, Me, $^{i}$Pr, $^{t}$Bu, or Ph.

In one embodiment of the invention, in which in at least one, preferably each, light-emitting layer B, at least one, preferably each, of the one or more small FWHM emitters $S^B$ comprises or consists of a structure according to formula DABNA-I, when $Y^a$ and/or $Y^b$ is/are $NR^{DABNA-3}$, $C(R^{DABNA-3})_2$, $Si(R^{DABNA-3})_2$, or $BR^{DABNA-3}$, the one or the two substituents $R^{DABNA-3}$ do not bond to one or both of the adjacent rings A' and B' (for $Y^a$ = $NR^{DABNA-3}$, $C(R^{DABNA-3})_2$, $Si(R^{DABNA-3})_2$, or $BR^{DABNA-3}$) or A' and C' (for $Y^b$ = $NR^{DABNA-3}$, $C(R^{DABNA-3})_2$, $Si(R^{DABNA-3})_2$, or $BR^{DABNA-3}$).

In one embodiment, small FWHM emitters $S^B$ in the context of the present invention may optionally also be multimers (e.g. dimers) of the aforementioned formula DABNA-I, which means that their structure comprises more than one subunits, each of which has a structure according to formula DABNA-I. In this case, the skilled artisan will understand that the two or more subunits according to formula DABNA-I may for example be conjugated, preferably fused to each other (i.e. sharing at least one bond, wherein the respective substituents attached to the atoms forming that bond may no longer be present). The two or more subunits may also share at least one, preferably exactly one, aromatic or heteroaromatic ring. This means that, for example, a small FWHM emitter $S^B$ may comprise two or more subunits each having a structure of formula DABNA-I, wherein these two subunits share one aromatic or heteroaromatic ring (i.e. the respective ring is part of both subunits). As a result, the respective multimeric (e.g., dimeric) emitter $S^B$ may not contain two whole subunits according to formula DABNA-I as the shared ring is only present once. Nevertheless, the skilled artisan will understand that herein, such an emitter is still considered a multimer (for example a dimer if two subunits having a structure of formula DABNA-I are comprised) of formula DABNA-I. The same holds true for multimers sharing more than one ring. It is preferred that the multimers are dimers comprising two subunits, each having a structure of formula DABNA-I.

In one embodiment of the invention, in at least one, preferably each, light-emitting layer B, at least one, preferably each small FWHM emitter $S^B$, is a dimer of formula DABNA-I as described above, which means that the emitter comprises two subunits, each having a structure according to formula DABNA-I.

In one embodiment of the invention, in at least one, preferably each, light-emitting layer B, at least one, preferably each, of the one or more small FWHM emitters $S^B$ comprises or consists of two or more, preferably of exactly two, structures according to formula DABNA-I (i.e. subunits),

wherein these subunits share at least one, preferably exactly one, aromatic or heteroaromatic ring (i.e. this ring may be part of both structures of formula DABNA-I) and wherein the shared ring(s) may be any of the rings A', B', and C' of formula DABNA-I, but may also be any aromatic or heteroaromatic substituent selected from $R^{DABNA-1}$, $R^{DABNA-2}$, $R^{DABNA-3}$, $R^{DABNA-4}$, $R^{DABNA-5}$, and $R^{DABNA-6}$, in particular $R^{DABNA-3}$, or any aromatic or heteroaromatic ring formed by two or more adjacent substituents as stated above, wherein the shared ring may constitute the same or different moieties of the two or more structures of formula DABNA-I that share the ring (i.e. the shared ring may for example be ring C' of both structures of formula DABNA-I optionally comprised in the emitter or the shared ring may for example be ring B' of one and ring C' of the other structure of formula DABNA-I optionally comprised in the emitter).

In one embodiment of the invention, in at least one, preferably each, light-emitting layer B, at least one, preferably each, of the one or more small FWHM emitters $S^B$ comprises or consists of two or more, preferably of exactly two, structures according to formula DABNA-I (i.e. subunits),

wherein at least **one** of $R^{DABNA-1}$ , $R^{DABNA-2}$, $R^{DABNA-3}$, $R^{DABNA-4}$ , $R^{DABNA-5}$, and $R^{DABNA-6}$ is replaced by a bond to a further chemical entity of formula DABNA-I and/or wherein at least **one** hydrogen atom of any of $R^{DABNA-1}$, $R^{DABNA-2}$, $R^{DABNA-3}$, $R^{DABNA-4}$, $R^{DABNA-5}$, and $R^{DABNA-6}$ is replaced by a bond to a further chemical entity of formula DABNA-I.

Non-limiting examples of emitters comprising or consisting of a structure according to formula DABNA-I that may be used as small FWHM emitters $S^B$ according to the present invention are listed below.

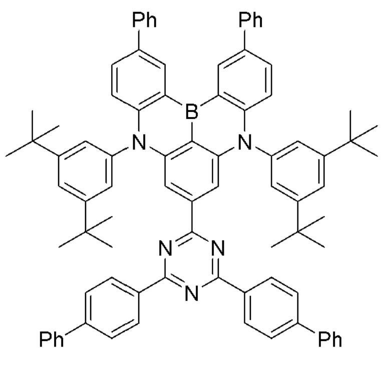

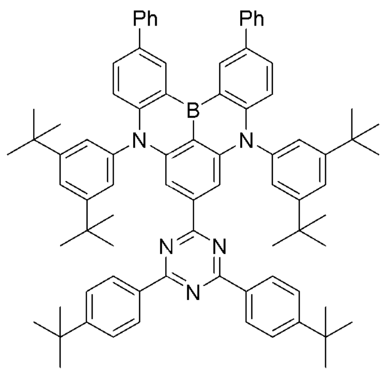

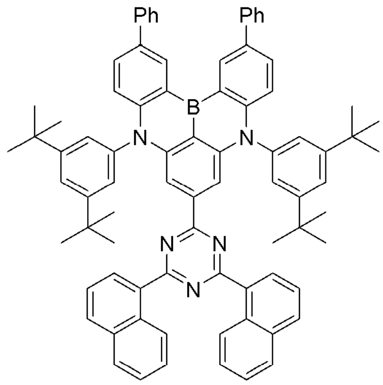

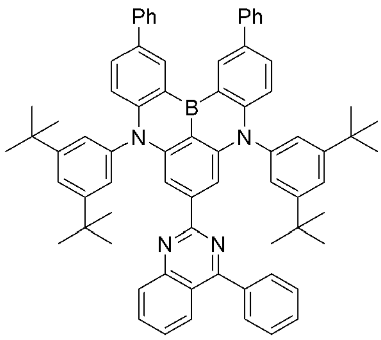

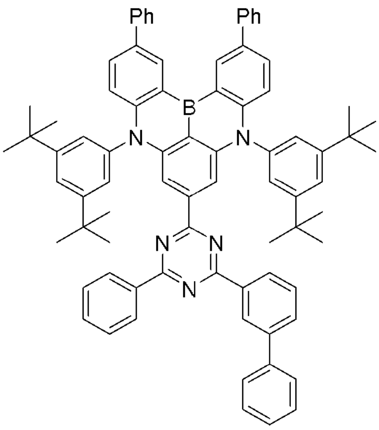

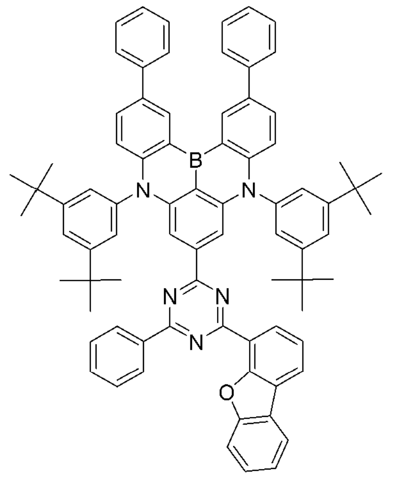

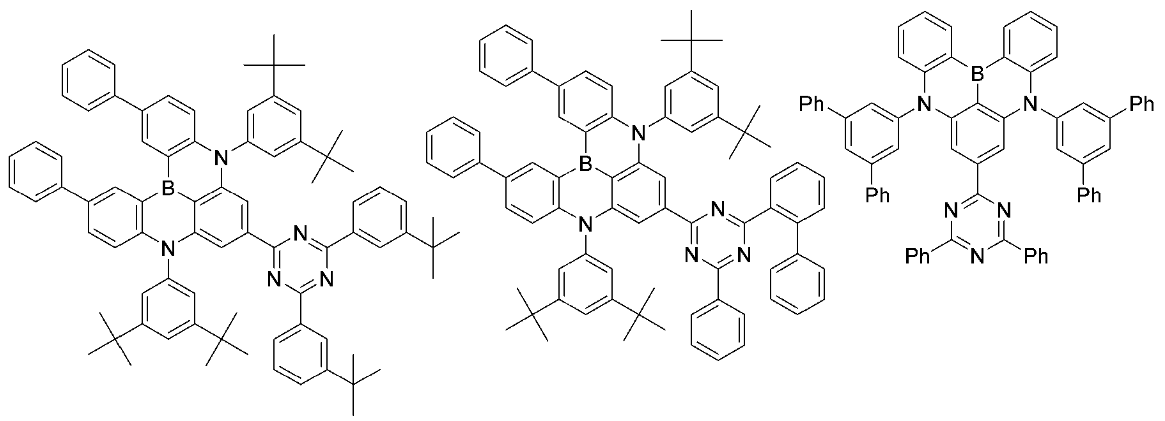

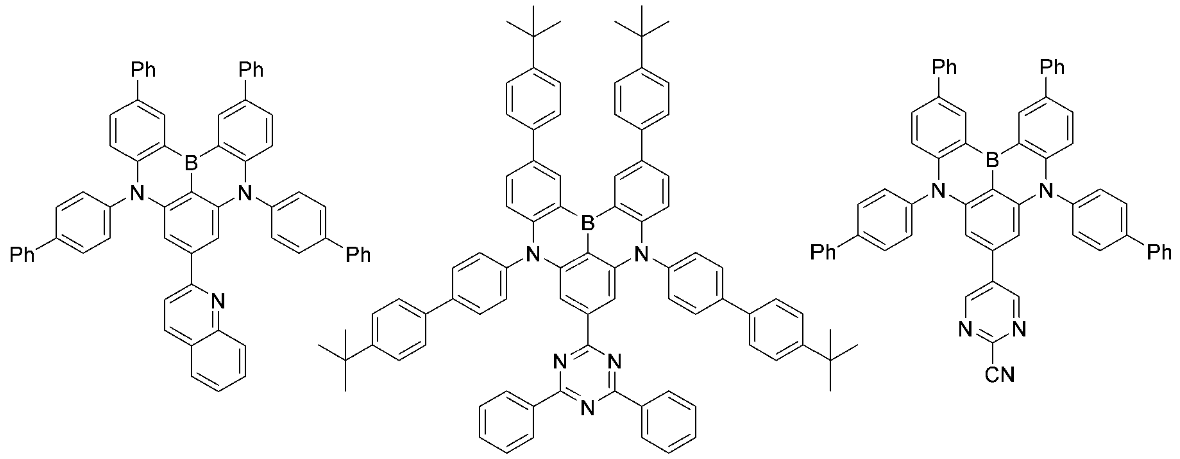

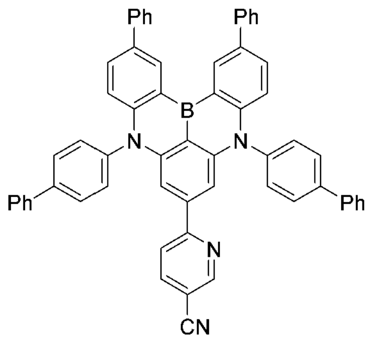

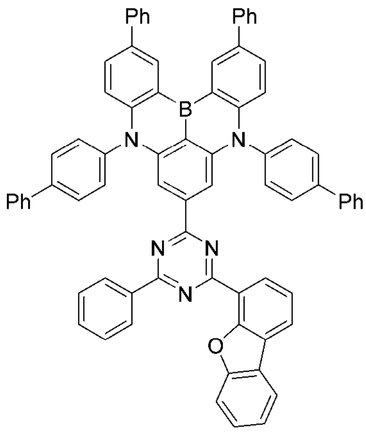

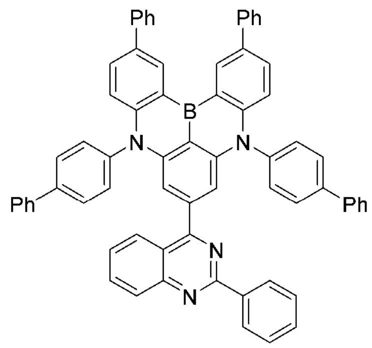

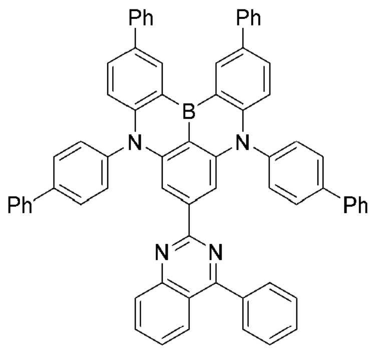

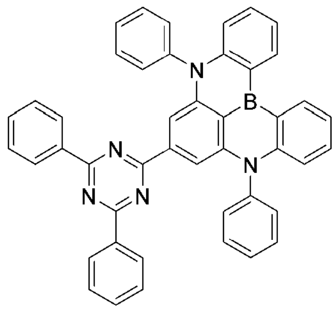

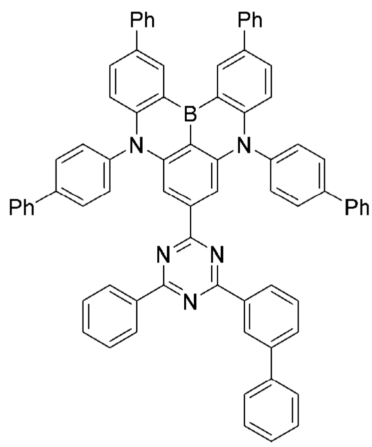

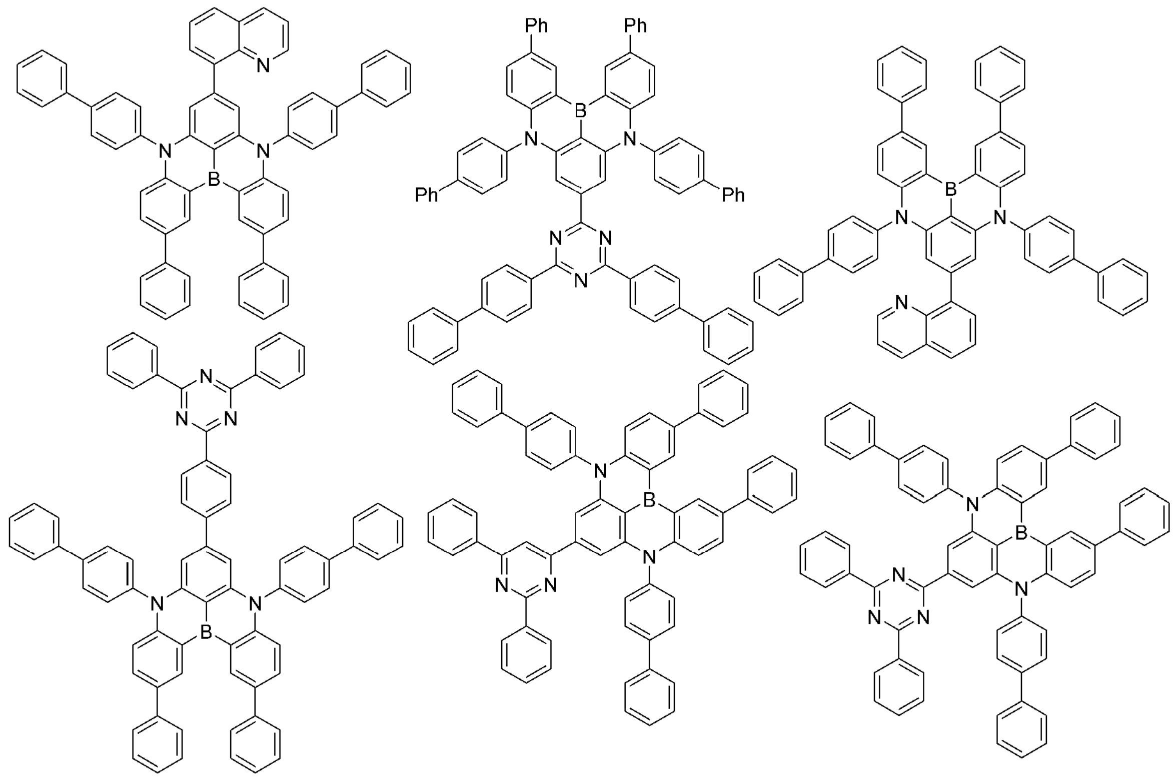

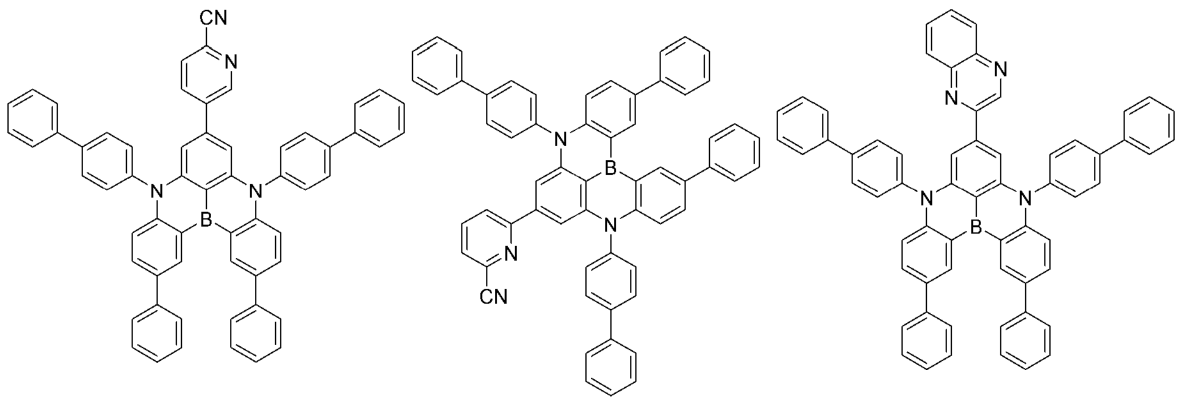

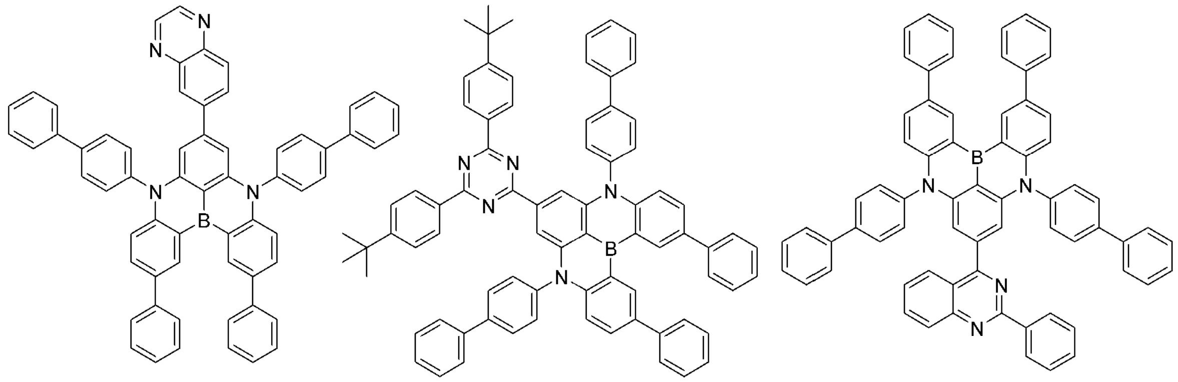

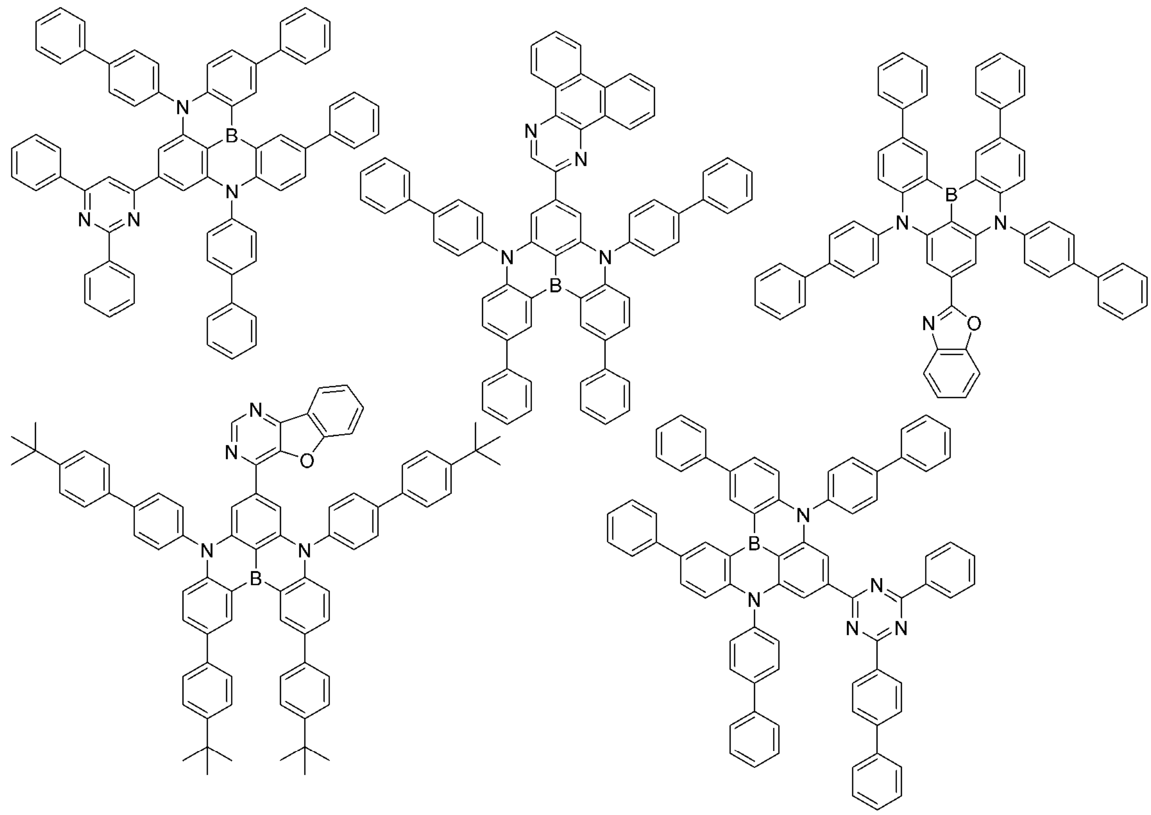

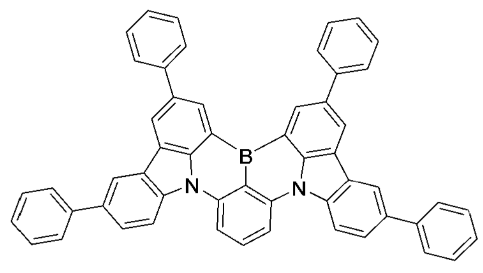

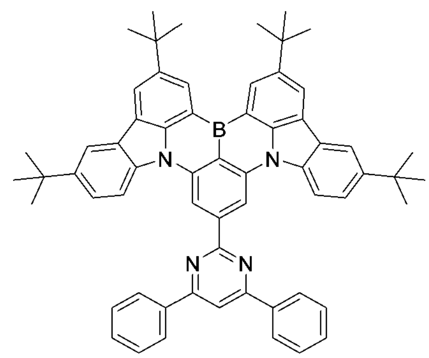

A group of emitters that may be used as small FWHM emitter $S^B$ in the context of the present invention are emitters comprising or consisting of a structure according to the following formula BNE-1:

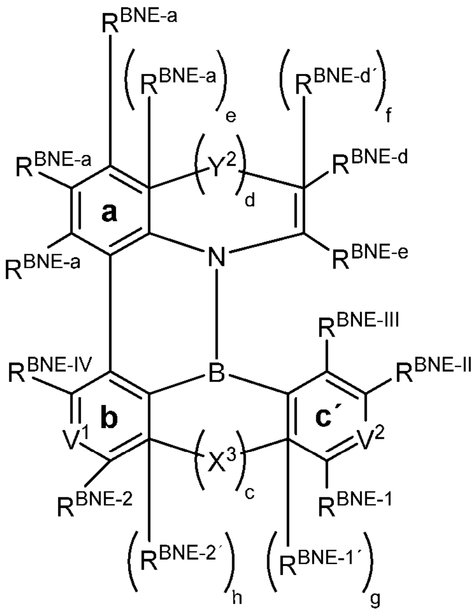

Formula BNE-1,

wherein,

c and d are both integers and independently of each other selected from 0 and 1;

e and f are both integers and selected from 0 and 1, wherein e and f are (always) identical (i.e. both 0 or both 1);

g and h are both integers and selected from 0 and 1, wherein g and h are (always) identical (i.e. both 0 or both 1);

if d is 0, e and f are both 1, and if d is 1, e and f are both 0;

if c is 0, g and h are both 1, and if c is 1, g and h are both 0;

$V^1$ is selected from nitrogen (N) and $CR^{BNE-V}$;

$V^2$ is selected from nitrogen (N) and $CR^{BNE-I}$;

$X^3$ is selected from the group consisting of a direct bond, $CR^{BNE-3}R^{BNE-4}$, $C=CR^{BNE-3}R^{BNE-4}$, C=O, $C=NR^{BNE-3}$, $NR^{BNE-3}$, O, $SiR^{BNE-3}R^{BNE-4}$, S, S(O) and $S(O)_2$;

$Y^2$ is selected from the group consisting of a direct bond, $CR^{BNE-3'}R^{BNE-4'}$, $C=CR^{BNE-3'}R^{BNE-4'}$, C=O, $C=NR^{BNE-3'}$, $NR^{BNE-3'}$, 0, $SiR^{BNE-3'}R^{BNE-4'}$, S, S(O) and $S(O)_2$;

$R^{BNE-1}$, $R^{BNE-2}$, $R^{BNE-1'}$, $R^{BNE-2'}$, $R^{BNE-3}$, $R^{BNE-4}$, $R^{BNE-3'}$, $R^{BNE-4'}$,$R^{BNE-I}$, $R^{BNE-II}$, $R^{BNE-III}$, $R^{BNE-IV}$, and $R^{BNE-V}$ are each independently of each other selected from the group consisting of: hydrogen, deuterium, $N(R^{BNE-5})_2$, $OR^{BNE-5}$, $Si(R^{BNE-5})_3$, $B(OR^{BNE-5})_2$, $B(R^{BNE-5})_2$, $OSO_2R^{BNE-5}$, $CF_3$, CN, F, Cl, Br, I,

$C_1$-$C_{40}$-alkyl,

which is optionally substituted with one or more substituents $R^{BNE-5}$ and
wherein one or more non-adjacent $CH_2$-groups are optionally substituted by $R^{BNE-5}C=CR^{BNE-5}$, C≡C $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S or $CONR^{BNE-5}$;

$C_1$-$C_{40}$-alkoxy,

which is optionally substituted with one or more substituents $R^{BNE-5}$ and

wherein one or more non-adjacent $CH_2$-groups are optionally substituted by $R^{BNE-5}C=CR^{BNE-5}$, C≡C $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S or $CONR^{BNE-5}$;

$C_1$-$C_{40}$-thioalkoxy,

which is optionally substituted with one or more substituents $R^{BNE-5}$ and
wherein one or more non-adjacent $CH_2$-groups are optionally substituted by $R^{BNE-5}C=CR^{BNE-5}$, C≡C, $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S or $CONR^{BNE-5}$;

$C_2$-$C_{40}$-alkenyl,

which is optionally substituted with one or more substituents $R^{BNE-5}$ and
wherein one or more non-adjacent $CH_2$-groups are optionally substituted by $R^{BNE-5}C=CR^{BNE-5}$, C≡C, $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S or $CONR^{BNE-5}$;

$C_2$-$C_{40}$-alkynyl,

which is optionally substituted with one or more substituents $R^{BNE-5}$ and
wherein one or more non-adjacent $CH_2$-groups are optionally substituted by $R^{BNE-5}C=CR^{BNE-5}$, $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S or $CONR^{BNE-5}$;

$C_6$-$C_{60}$-aryl,
which is optionally substituted with one or more substituents $R^{BNE-5}$; and

$C_2$-$C_{57}$-heteroaryl,
which is optionally substituted with one or more substituents $R^{BNE-5}$;

$R^{BNE-d}$, $R^{BNE-d'}$, and $R^{BNE-e}$ are independently of each other selected from the group consisting of: hydrogen, deuterium, $N(R^{BNE-5})_2$, $OR^{BNE-5}$, $Si(R^{BNE-5})_3$, $B(OR^{BNE-5})_2$, $B(R^{BNE-5})_2$, $OSO_2R^{BNE-5}$, $CF_3$, CN, F, Cl, Br, I,

$C_1$-$C_{40}$-alkyl,

which is optionally substituted with one or more substituents $R^{BNE-a}$ and
wherein one or more non-adjacent $CH_2$-groups are optionally substituted by $R^{BNE-5}C=CR^{BNE-5}$, C≡C, $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S or $CONR^{BNE-5}$;

$C_1$-$C_{40}$-alkoxy,

which is optionally substituted with one or more substituents $R^{BNE-a}$ and
wherein one or more non-adjacent $CH_2$-groups are optionally substituted by $R^{BNE-5}C=CR^{BNE-5}$, C≡C, $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S or $CONR^{BNE-5}$;

$C_1$-$C_{40}$-thioalkoxy,

which is optionally substituted with one or more substituents $R^{BNE-a}$ and
wherein one or more non-adjacent $CH_2$-groups are optionally substituted by $R^{BNE-5}C=CR^{BNE-5}$, C≡C, $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S or $CONR^{BNE-5}$;

$C_2$-$C_{40}$-alkenyl,

which is optionally substituted with one or more substituents $R^{BNE-a}$ and

wherein one or more non-adjacent $CH_2$-groups are optionally substituted by $R^{BNE-5}C=CR^{BNE-5}$, C≡C $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S or $CONR^{BNE-5}$;

$C_2$-$C_{40}$-alkynyl,

which is optionally substituted with one or more substituents $R^{BNE-a}$ and
wherein one or more non-adjacent $CH_2$-groups are optionally substituted by $R^{BNE-}C=CR^{BNE-5}$, $Si(R^{BNE-5})2$, $Ge(R^{BNE-5})2$, $Sn(R^{BNE-5})2$, C=O, C=S, C=Se, $C=NR^{BNE-5}$, $P(=O)(R^{BNE}{-5})$, SO, $SO_2$, $NR^{BNE-5}$, O, S or $CONR^{BNE-5}$;

$C_6$-$C_{60}$-aryl,
which is optionally substituted with one or more substituents $R^{BNE-a}$; and

$C_2$-$C_{57}$-heteroaryl,
which is optionally substituted with one or more substituents $R^{BNE-a}$;

$R^{BNE-a}$ is at each occurrence independently of each other selected from the group consisting of: hydrogen, deuterium, $N(R^{BNE-5})2$, $OR^{BNE-5}$, $Si(R^{BNE-5})3$, $B(OR^{BNE-5})2$, $B(R^{BNE-5})_2$, $OSO_2R^{BNE-5}$ $CF_{.3}$, CN, F, Cl, Br, I,

C1-C40-alkyl,

which is optionally substituted with one or more substituents $R^{BNE-5}$ and
wherein one or more non-adjacent $CH_2$-groups are optionally substituted by $R^{BNE-5}C=C^{RBNE-5}$, C≡C $Si(R^{BNE-5})_2$, $Ge(R^{BNE-5})_2$, $Sn(R^{BNE-5})2$, C=O, C=S, C=Se, $C=NR^{BNE-5}$, $P(=O)(R^{BNE-5})$, SO, $SO_2$, $NR^{BNE-5}$, O, S or $CONR^{BNE-5}$;

$C_1$-$C_{40}$-alkoxy,

which is optionally substituted with one or more substituents $R^{BNE-5}$ and
wherein one or more non-adjacent $CH_2$-groups are optionally substituted by $R^{BNE-5}C=C^{RBNE-5}$, C≡C $Si(R^{BNE-5})_2$, $Ge(R^{BNE-5})2$, $Sn(R^{BNE-5})2$, C=O, C=S, C=Se, $C=NR^{BNE-5}$, $P(=O)(R^{BNE-5})$, SO, $SO_2$, $NR^{BNE-5}$, O, S or $CONR^{BNE-5}$;

$C_1$-$C_{40}$-thioalkoxy,

which is optionally substituted with one or more substituents $R^{BNE-5}$ and
wherein one or more non-adjacent $CH_2$-groups are optionally substituted by $R^{BNE-5}C=CR^{BNE-5}$, C≡C $Si(R^{BNE-5})_2$, $Ge(R^{BNE-5})2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S or $CONR^{BNE-5}$;

$C_2$-$C_{40}$-alkenyl,

which is optionally substituted with one or more substituents $R^{BNE-5}$ and
wherein one or more non-adjacent $CH_2$-groups are optionally substituted by $R^{BNE-5}C=C^{RBNE-5}$, C≡C, $Si(R^{BNE-5})_2$ , $Ge(RBNE^{-5})_2$, $Sn(R^{BNE-5})_2$ , C=O, C=S, C=Se, $C=NR^{BNE-5}$, $P(=O)(R^{BNE-5})$, SO, $SO_2$, $NR^{BNE-5}$, O, S or $CONR^{BNE-5}$;

$C_2$-$C_{40}$-alkynyl,

which is optionally substituted with one or more substituents $R^{BNE-5}$ and
wherein one or more non-adjacent $CH_2$-groups are optionally substituted by $R^{BNE-}C=CR^{BNE-5}$, $Si(R^{BNE-5})2$, $Ge(R^{BNE-5})2$, $Sn(R^{BNE-5})2$, C=O, C=S, C=Se, $C=NR^{BNE-5}$, $P(=O)(R^{BNE-5})$, SO, $SO_2$, $NR^{BNE-5}$, O, S or $CONR^{BNE-5}$;

$C_6$-$C_{60}$-aryl,
which is optionally substituted with one or more substituents $R^{BNE-5}$; and

$C_2$-$C_{57}$-heteroaryl,
which is optionally substituted with one or more substituents $R^{BNE-5}$;

$R^{BNE-5}$ is at each occurrence independently of each other selected from the group consisting of: hydrogen, deuterium, N($R^{BNE-6}$)2, O$R^{BNE-6}$, Si($R^{BNE-6}$)3, B(O$R^{BNE-6}$)2, B($R^{BNE-6}$)$_2$, $OSO_2R^{BNE-6}$, $CF_3$, CN, F, Cl, Br, **I,**

$C_1$-$C_{40}$-alkyl,

which is optionally substituted with one or more substituents $R^{BNE-6}$ and
wherein one or more non-adjacent $CH_2$-groups are optionally substituted by $R^{BNE-6}$C=C$^{RBNE-6}$, C≡C, Si($R^{BNE-6}$)$_2$, Ge($R^{BNE-6}$)$_2$, Sn($^{RBNE-6}$)$_2$, C=O, C=S, C=Se, C=N$R^{BNE-6}$, P(=O)($R^{BNE-6}$), SO, $SO_2$, N$R^{BNE-6}$, O, S or CON$R^{BNE-6}$;

$C_1$-$C_{40}$-alkoxy,

which is optionally substituted with one or more substituents $R^{BNE-6}$ and
wherein one or more non-adjacent $CH_2$-groups are optionally substituted by $R^{BNE-6}$C=C$^{RBNE-6}$, C≡C, Si($R^{BNE-6}$)$_2$, Ge($R^{BNE-6}$)$_2$, Sn($^{RBNE-6}$)$_2$, C=O, C=S, C=Se, C=N$R^{BNE-6}$, P(=O)($R^{BNE-6}$), SO, $SO_2$, N$R^{BNE-6}$, O, S or CON$R^{BNE-6}$;

$C_1$-$C_{40}$-thioalkoxy,

which is optionally substituted with one or more substituents $R^{BNE-6}$ and
wherein one or more non-adjacent $CH_2$-groups are optionally substituted by $R^{BNE-6}$C=C$^{RBNE-6}$, C≡C, Si($R^{BNE-6}$)$_2$, Ge($R^{BNE-6}$)$_2$, Sn($^{RBNE-6}$)$_2$, C=O, C=S, C=Se, C=N$R^{BNE-6}$, P(=O)($R^{BNE-6}$), SO, $SO_2$, N$R^{BNE-6}$, O, S or CON$R^{BNE-6}$;

$C_2$-$C_{40}$-alkenyl,

which is optionally substituted with one or more substituents $R^{BNE-6}$ and
wherein one or more non-adjacent $CH_2$-groups are optionally substituted by $R^{BNE-6}$C=C$^{RBNE-6}$, C≡C, Si($R^{BNE-6}$)$_2$, Ge($R^{BNE-6}$)$_2$, Sn($^{RBNE-6}$)$_2$, C=O, C=S, C=Se, C=N$R^{BNE-6}$, P(=O)($R^{BNE-6}$), SO, $SO_2$, N$R^{BNE-6}$, O, S or CON$R^{BNE-6}$;

$C_2$-$C_{40}$-alkynyl,

which is optionally substituted with one or more substituents $R^{BNE-6}$ and
wherein one or more non-adjacent $CH_2$-groups are optionally substituted by $R^{BNE-6}$C=C$^{RBNE-6}$, Si($R^{BNE-6}$)$_2$, Ge($R^{BNE-6}$)2, Sn($R^{BNE-6}$)2, C=O, C=S, C=Se, C=N$R^{BNE-6}$, P(=O)($R^{BNE-6}$), SO, $SO_2$, N$R^{BNE-6}$, O, S or CON-$R^{BNE-6}$

$C_6$-$C_{60}$-aryl,
which is optionally substituted with one or more substituents $R^{BNE-6}$; and

$C_2$-$C_{57}$-heteroaryl,
which is optionally substituted with one or more substituents $R^{BNE-6}$;

$R^{BNE-6}$ is at each occurrence independently from another selected from the group consisting of: hydrogen, deuterium, OPh, $CF._3$, CN, F,

$C_1$-$C_5$-alkyl,

wherein one or more hydrogen atoms are optionally, independently of each other substituted by deuterium, CN, $CF._3$, Ph or F;

$C_1$-$C_5$-alkoxy,

wherein one or more hydrogen atoms are optionally, independently of each

other substituted by deuterium, CN, $CF_{.3}$, or F;

$C_1$-$C_5$-thioalkoxy,

wherein one or more hydrogen atoms are optionally, independently of each other substituted by deuterium, CN, $CF_{.3}$, or F;

$C_2$-$C_5$-alkenyl,

wherein one or more hydrogen atoms are optionally, independently of each other substituted by deuterium, CN, $CF_{.3}$, or F;

$C_2$-$C_5$-alkynyl,

wherein one or more hydrogen atoms are optionally, independently of each other substituted by deuterium, CN, $CF_{.3}$, or F;

$C_6$-$C_{18}$-aryl,
which is optionally substituted with one or more $C_1$-$C_5$-alkyl substituents;

$C_2$-$C_{17}$-heteroaryl,
which is optionally substituted with one or more $C_1$-$C_5$-alkyl substituents;

$N(C_6$-$C_{18}$-aryl$)_2$;

$N(C_2$-$C_{17}$-heteroaryl$)_2$, and

$N(C_2$-$C_{17}$-heteroaryl$)(C_6$-$C_{18}$-aryl);

wherein $R^{BNE-III}$ and $R^{BNE-e}$ optionally combine to form a direct single bond; and wherein two or more of substituents $R^{BNE-a}$, $R^{BNE-d}$ $R^{BNE-d'}$, $R^{BNE-e}$, $R^{BNE-3'}$, RBNE-4' $R^{BNE-5}$ optionally form a mono- or polycyclic, aliphatic or aromatic or heteroaromatic, carbo- or heterocyclic ring system with each other;

wherein two or more of the substituents $R^{BNE-1}$, $R^{BNE-2}$, $R^{BNE-1'}$, $R^{BNE-2'}$ , $R^{BNE-3}$, $R^{BNE-4}$, $R^{BNE-5}$, $R^{BNE-1}$, $R^{BNE-II,}$ $R^{BNE-III,}$ $R^{BNE-IV,}$ $R^{BNE-V}$ optionally form a mono- or polycyclic, aliphatic or aromatic or heteroaromatic, carbo- or heterocyclic ring system with each other;

wherein optionally two or more, preferably two, structures of formula BNE-1 are conjugated with each other, preferably fused to each other by sharing at least one, more preferably exactly one, bond;

wherein optionally two or more, preferably two, structures of formula BNE-1 are present in the emitter and share at least one, preferably exactly one, aromatic or heteroaromatic ring (i.e. this ring may be part of both structures of formula BNE-1) which preferably is any of the rings a, b, and c' of formula BNE-1, but may also be any aromatic or heteroaromatic substituent selected from $R^{BNE-1}$, $R^{BNE-2}$, $R^{BNE-1'}$ $R^{BNE-2'}$, $R^{BNE-3}$, $R^{BNE-4}$, $R^{BNE-3'}$, $R^{BNE-4'}$, $R^{BNE-5}$, $R^{BNE-6}$, $R^{BNE-I}$ , $R^{BNE-II}$, $R^{BNE-III}$ , $R^{BNE-IV,}$ $R^{BNE-V}$, $R^{BNE-a}$, $R^{BNE-e}$, $R^{BNE-d}$, and $R^{BNE-d'}$, or any aromatic or heteroaromatic ring formed by two or more substituents as stated above, wherein the shared ring may constitute the same or different moieties of the two or more structures of formula BNE-1 that share the ring (i.e. the shared ring may for example be ring c' of both structures of formula BNE-1 optionally comprised in the emitter or the shared ring may for example be ring b of one and ring c' of the other structure of formula BNE-1 optionally comprised in the emitter); and

wherein optionally at least one of $R^{BNE-1}$, $R^{BNE-2}$, $R^{BNE-1'}$, $R^{BNE-2'}$, $R^{BNE-3}$, $R^{BNE-4}$, $R^{BNE-5}$, $R^{BNE-3'}$ , $R^{BNE-4'}$, $R^{BNE-6}$, $R^{BNE-I}$, $R^{BNE-II}$, $R^{BNE-III}$, $R^{BNE-IV,}$ $R^{BNE-V}$, $R^{BNE-a}$, $R^{BNE-e}$, $R^{BNE-d}$, or $R^{BNE-d'}$ is replaced by a bond to a further chemical entity of formula BNE-1 and/or wherein optionally at least one hydrogen atom of any of $R^{BNE-1}$, $R^{BNE-2}$, $R^{BNE-1'}$, $R^{BNE-2'}$ , $R^{BNE-3}$, $R^{BNE-4}$, $R^{BNE-5}$, $R^{BNE-3'}$, $R^{BNE-4'}$, $R^{BNE-6}$, $R^{BNE-I}$, $R^{BNE-II}$, $R^{BNE-III}$ , $R^{BNE-IV}$, $R^{BNE-V}$, $R^{BNE-a}$, $R^{BNE-e}$, $R^{BNE-d}$, or $R^{BNE-d'}$ is replaced by a bond to a further chemical entity of formula BNE-1.

In one embodiment of the invention, in the light-emitting layer B, the small FWHM emitters $S^B$ comprises a

structure according to formula BNE-1.

In one embodiment of the invention, the one small FWHM emitters $S^B$ comprises or consists of a structure according to formula BNE-1, $V^1$ is $CR^{BNE-V}$ and $V^2$ is $CR^{BNE-I}$.

In one embodiment of the invention, the small FWHM emitter $S^B$ comprises or consists of a structure according to formula BNE-1, $V^1$ and $V^2$ are both nitrogen (N).

In one embodiment of the invention, the small FWHM emitter $S^B$ comprises or consists of a structure according to formula BNE-1, $V^1$ is nitrogen (N) and $V^2$ is $CR^{BNE-I}$.

In one embodiment of the invention, the small FWHM emitter $S^B$ comprises or consists of a structure according to formula BNE-1, $V^1$ is $CR^{BNE-V}$ and $V^2$ is nitrogen (N).

In one embodiment of the invention, the small FWHM emitter $S^B$ comprises or consists of a structure according to formula BNE-1, c and d are both 0.

In one embodiment of the invention, the small FWHM emitter $S^B$ comprises or consists of a structure according to formula BNE-1, c is 0 and d is 1.

In one embodiment of the invention, the small FWHM emitter $S^B$ comprises or consists of a structure according to formula BNE-1, c is 1 and d is 0.

In one embodiment of the invention, the small FWHM emitter $S^B$ comprises or consists of a structure according to formula BNE-1, c and d are both 1.

In one embodiment of the invention, the small FWHM emitter $S^B$ comprises or consists of a structure according to formula BNE-1,

$X^3$ is selected from the group consisting of a direct bond, $CR^{BNE-3}R^{BNE-4}$, C=O, $NR^{BNE-3}$, O, S, $SiR^{BNE-3}R^{BNE-4}$; and
$Y^2$ is selected from the group consisting of a direct bond, $CR^{BNE-3'}R^{BNE-4'}$, C=O, $NR^{BNE-3'}$, O, S, $SiR^{BNE-3'}R^{BNE-4'}$.

In one embodiment of the invention, the small FWHM emitter $S^B$ comprises or consists of a structure according to formula BNE-1,

$X^3$ is selected from the group consisting of a direct bond, $CR^{BNE-3}R^{BNE-4}$, $NR^{BNE-3}$, O, S, $SiR^{BNE-3}R^{BNE-4}$; and
$Y^2$ is selected from the group consisting of a direct bond, $CR^{BNE-3'}R^{BNE-4'}$, $NR^{BNE-3'}$, O, S, $SiR^{BNE-3'}R^{BNE-4'}$.

In one embodiment of the invention, in which in at least one, preferably each, light-emitting layer B, at least one, preferably each, of the one or more small FWHM emitters $S^B$ comprises or consists of a structure according to formula BNE-1,

$X^3$ is selected from the group consisting of a direct bond, $CR^{BNE-3}R^{BNE-4}$, $NR^{BNE-3}$, O, S, $SiR^{BNE-3}R^{BNE-4}$; and
$Y^2$ is a direct bond.

In one embodiment of the invention, the small FWHM emitter $S^B$ comprises or consists of a structure according to formula BNE-1,

$X^3$ is a direct bond or $NR^{BNE-3}$; and
$Y^2$ is a direct bond.

In one embodiment of the invention, the small FWHM emitter $S^B$ comprises or consists of a structure according to formula BNE-1,

$X^3$ is $NR^{BNE-3}$; and
$Y^2$ is a direct bond.

In one embodiment of the invention, the small FWHM emitter $S^B$ comprises or consists of a structure according to formula BNE-1,

$R^{BNE-1}$, $R^{BNE-2}$, $R^{BNE-1'}$, $R^{BNE-2'}$, $R^{BNE-3}$, $R^{BNE-4}$, $R^{BNE-3'}$, $R^{BNE-4'}$, $R^{BNE-I}$, $R^{BNE-II}$, $R^{BNE-III}$ $R^{BNE-IV}$, and $R^{BNE-V}$ are each independently of each other selected from the group consisting of: hydrogen, deuterium, $N(R^{BNE-5})2$, $OR^{BNE-5}$, $Si(R^{BNE-5})3$, $B(OR^{BNE-5})2$, $B(R^{BNE-5})_2$, $OSO_2R^{BNE-5}$ $CF_3$, CN, F, Cl, Br, **I,**
$C_1$-$C_{40}$-alkyl,

which is optionally substituted with one or more substituents $R^{BNE-5}$ and
wherein one or more non-adjacent $CH_2$-groups are optionally substituted by $R^{BNE-5}C=CR^{BNE-5}$, C≡C $Si(R^{BNE-5})_2$,

$Ge(R^{BNE-5})2$, $Sn(R^{BNE-5})2$, C=O, C=S, C=Se, $C=NR^{BNE-5}$, $P(=O)(R^{BNE-5})$, SO, $SO_2$, $NR^{BNE-5}$, O, S or $CONR^{BNE-5}$;

$C_1$-$C_{40}$-alkoxy,

which is optionally substituted with one or more substituents $R^{BNE-5}$ and wherein one or more non-adjacent $CH_2$-groups are optionally substituted by $R^{BNE-5}C=C^{RBNE-5}$, C≡C $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S or $CONR^{BNE-5}$;

$C_1$-$C_{40}$-thioalkoxy,

which is optionally substituted with one or more substituents $R^{BNE-5}$ and wherein one or more non-adjacent $CH_2$-groups are optionally substituted by $R^{BNE-5}C=C^{RBNE-5}$, C≡C $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S or $CONR^{BNE-5}$;

$C_2$-$C_{40}$-alkenyl,

which is optionally substituted with one or more substituents $R^{BNE-5}$ and wherein one or more non-adjacent $CH_2$-groups are optionally substituted by $R^{BNE-5}C=CR^{BNE-5}$, C≡C $Si(R^{BNE-5})_2$, $Ge(R^{BNE-5})2$, $Sn(R^{BNE-5})2$, C=O, C=S, C=Se, $C=NR^{BNE-5}$, $P(=O)(R^{BNE-5})$, SO, $SO_2$, $NR^{BNE-5}$, O, S or $CONR^{BNE-5}$;

$C_2$-$C_{40}$-alkynyl,

which is optionally substituted with one or more substituents $R^{BNE-5}$ and wherein one or more non-adjacent $CH_2$-groups are optionally substituted by $R^{BNE-5}C=CR^{BNE-5}$, $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE\text{-}5})$, SO, SO2, $NR^{BNE-5}$, O, S or $CONR^{BNE-5}$;

$C_6$-$C_{60}$-aryl,
which is optionally substituted with one or more substituents $R^{BNE-5}$; and
$C_2$-$C_{57}$-heteroaryl,
which is optionally substituted with one or more substituents $R^{BNE-5}$;
$R^{BNE-d}$, $R^{BNE-d'}$, and $R^{BNE-e}$ are independently of each other selected from the group consisting of: hydrogen, deuterium, $CF_{\cdot 3}$, CN, F, Cl, Br, I,
C1-C40-alkyl,

which is optionally substituted with one or more substituents $R^{BNE-a}$ and wherein one or more non-adjacent $CH_2$-groups are optionally substituted by $R^{BNE-5}C=CR^{BNE-5}$, C≡C $Si(R^{BNE-5})_2$, $Ge(R^{BNE-5})2$, $Sn(R^{BNE-5})2$, C=O, C=S, C=Se, $C=NR^{BNE-5}$, $P(=O)(R^{BNE-5})$, SO, $SO_2$, $NR^{BNE-5}$, O, S or $CONR^{BNE-5}$;

$C_6$-$C_{60}$-aryl,
which is optionally substituted with one or more substituents $R^{BNE-a}$; and
$C_2$-$C_{57}$-heteroaryl,
which is optionally substituted with one or more substituents $R^{BNE-a}$;
$R^{BNE-a}$ is at each occurrence independently of each other selected from the group consisting of: hydrogen, deuterium, $N(R^{BNE-5})2$, $OR^{BNE-5}$, $Si(R^{BNE-5})3$, $B(OR^{BNE-5})2$, $B(R^{BNE-5})_2$, $OSO_2R^{BNE-5}$ $CF_3$, CN, F, Cl, Br, **I,**
$C_1$-$C_{40}$-alkyl,

which is optionally substituted with one or more substituents $R^{BNE-5}$ and wherein one or more non-adjacent $CH_2$-groups are optionally substituted by $R^{BNE-5}C=C^{RBNE-5}$, C≡C $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S or $CONR^{BNE-5}$;

$C_1$-$C_{40}$-alkoxy,

which is optionally substituted with one or more substituents $R^{BNE-5}$ and wherein one or more non-adjacent $CH_2$-groups are optionally substituted by $R^{BNE-5}C=C^{RBNE-5}$, C≡C, $Si(R^{BNE-5})_2$ , $Ge(R^{BNE-5})_2$, $Sn(R^{BNE-5})_2$ , C=O, C=S, C=Se, $C=NR^{BNE-5}$, $P(=O)(R^{BNE-5})$, SO, $SO_2$, $NR^{BNE-5}$, O, S or $CONR^{BNE-5}$;

$C_1$-$C_{40}$-thioalkoxy,

which is optionally substituted with one or more substituents $R^{BNE-5}$ and wherein one or more non-adjacent $CH_2$-groups are optionally substituted by $R^{BNE-5}C=C^{RBNE-5}$, C≡C $Si(R^{BNE-5})_2$, $Ge(R^{BNE-5})2$, $Sn(R^{BNE-5})2$, C=O, C=S, C=Se, $C=NR^{BNE-5}$, $P(=O)(R^{BNE-5})$, SO, $SO_2$, $NR^{BNE-5}$, O, S or $CONR^{BNE-5}$;

$C_2$-$C_{40}$-alkenyl,

which is optionally substituted with one or more substituents $R^{BNE-5}$ and wherein one or more non-adjacent $CH_2$-groups are optionally substituted by $R^{BNE-5}C=C^{RBNE-5}$, C≡C $Si(R^{BNE-5})_2$, $Ge(R^{BNE-5})2$, $Sn(R^{BNE-5})2$, C=O, C=S, C=Se, $C=NR^{BNE-5}$, $P(=O)(R^{BNE-5})$, SO, $SO_2$, $NR^{BNE-5}$, O, S or $CONR^{BNE-5}$;

$C_2$-$C_{40}$-alkynyl,

which is optionally substituted with one or more substituents $R^{BNE-5}$ and wherein one or more non-adjacent $CH_2$-groups are optionally substituted by $R^{BNE-}C=CR^{BNE-5}$, $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S or $CONR^{BNE-5}$;

$C_6$-$C_{60}$-aryl,
which is optionally substituted with one or more substituents $R^{BNE-5}$; and
$C_2$-$C_{57}$-heteroaryl,
which is optionally substituted with one or more substituents $R^{BNE-5}$;
$R^{BNE-5}$ is at each occurrence independently of each other selected from the group consisting of: hydrogen, deuterium, $N(R^{BNE-6})2$, $OR^{BNE-6}$, $Si(R^{BNE-6})_3$, $B(OR^{BNE-6})2$, $B(R^{BNE-6})_2$, $OSO_2R^{BNE-6}$, $CF_3$, CN, F, Cl, Br, **I,**
$C_1$-$C_{40}$-alkyl,

which is optionally substituted with one or more substituents $R^{BNE-6}$ and wherein one or more non-adjacent $CH_2$-groups are optionally substituted by $R^{BNE-6}C=CR^{BNE-6}$, C≡C, $Si(R^{BNE-6})_2$, $Ge(R^{BNE-6})_2$, $Sn(R^{BNE-6})_2$ , C=O, C=S, C=Se, $C=NR^{BNE-6}$, $P(=O)(R^{BNE-6})$, SO, $SO_2$, $NR^{BNE-6}$, O, S or $CONR^{BNE-6}$;

$C_1$-$C_{40}$-alkoxy,

which is optionally substituted with one or more substituents $R^{BNE-6}$ and wherein one or more non-adjacent $CH_2$-groups are optionally substituted by $R^{BNE-6}C=CR^{BNE-6}$, C≡C, $Si(R^{BNE-6})_2$, $Ge(R^{BNE-6})_2$, $Sn(R^{BNE-6})_2$ , C=O, C=S, C=Se, $C=NR^{BNE-6}$, $P(=O)(R^{BNE-6})$, SO, $SO_2$, $NR^{BNE-6}$, O, S or $CONR^{BNE-6}$;

$C_1$-$C_{40}$-thioalkoxy,

which is optionally substituted with one or more substituents $R^{BNE-6}$ and wherein one or more non-adjacent $CH_2$-groups are optionally substituted by $R^{BNE-6}C=C^{RBNE-6}$, C≡C, $Si(R^{BNE-6})_2$ , $Ge(R^{BNE-6})_2$, $Sn(R^{BNE-6})_2$, C=O, C=S, C=Se, $C=NR^{BNE-6}$, $P(=O)(R^{BNE-6})$, SO, $SO_2$, $NR^{BNE-6}$, O, S or $CONR^{BNE-6}$;

$C_2$-$C_{40}$-alkenyl,

which is optionally substituted with one or more substituents $R^{BNE-6}$ and wherein one or more non-adjacent $CH_2$-groups are optionally substituted by $R^{BNE-6}C=C^{RBNE-6}$, C≡C, $Si(R^{BNE-6})_2$, $Ge(R^{BNE-6})_2$, $Sn(R^{BNE-6})_2$ , C=O, C=S, C=Se, $C=NR^{BNE-6}$, $P(=O)(R^{BNE-6})$, SO, $SO_2$, $NR^{BNE-6}$,

O, S or CONR$^{BNE-6}$;

$C_2$-$C_{40}$-alkynyl,

which is optionally substituted with one or more substituents $R^{BNE-6}$ and wherein one or more non-adjacent $CH_2$-groups are optionally substituted by $R^{BNE-6}C=CR^{BNE-6}$, $Si(R^{BNE-6})_2$, Ge($R^{BNE-6}$)2, Sn($R^{BNE-6}$)2, C=O, C=S, C=Se, C=NR$^{BNE-6}$, P(=O)($R^{BNE-6}$), SO, $SO_2$, NR$^{BNE-6}$, O, S or CON-R$^{BNE-6}$;

$C_6$-$C_{60}$-aryl,
which is optionally substituted with one or more substituents $R^{BNE-6}$; and
$C_2$-$C_{57}$-heteroaryl,
which is optionally substituted with one or more substituents $R^{BNE-6}$;
$R^{BNE-6}$ is at each occurrence independently from another selected from the group consisting of: hydrogen, deuterium, OPh, $CF_{.3}$, CN, F,
$C_1$-$C_5$-alkyl,

wherein one or more hydrogen atoms are optionally, independently from each other substituted by deuterium, CN, $CF_{.3}$, Ph or F;

$C_1$-$C_5$-alkoxy,

wherein one or more hydrogen atoms are optionally, independently from each other substituted by deuterium, CN, $CF_{.3}$, or F;

$C_1$-$C_5$-thioalkoxy,

wherein one or more hydrogen atoms are optionally, independently from each other substituted by deuterium, CN, $CF_{.3}$, or F;

$C_2$-$C_5$-alkenyl,

wherein one or more hydrogen atoms are optionally, independently from each other substituted by deuterium, CN, $CF_{.3}$, or F;

$C_2$-$C_5$-alkynyl,

wherein one or more hydrogen atoms are optionally, independently from each other substituted by deuterium, CN, $CF_{.3}$, or F;

$C_6$-$C_{18}$-aryl,
which is optionally substituted with one or more $C_1$-$C_5$-alkyl substituents;
$C_2$-$C_{17}$-heteroaryl,
which is optionally substituted with one or more $C_1$-$C_5$-alkyl substituents;
N($C_6$-$C_{18}$-aryl)$_2$;
N($C_2$-$C_{17}$-heteroaryl)$_2$, and
N($C_2$-$C_{17}$-heteroaryl)($C_6$-$C_{18}$-aryl);
wherein $R^{BNE-III}$ and $R^{BNE-e}$ optionally combine to form a direct single bond; and
wherein two or more of substituents $R^{BNE-a}$, $R^{BNE-d}$, $R^{BNE-d'}$ , $R^{BNE-e}$, $R^{BNE-3'}$, $R^{BNE-4'}$ $R^{BNE-5}$ optionally form a mono- or polycyclic, aliphatic or aromatic or heteroaromatic, carbo- or heterocyclic ring system with each other;
wherein two or more of the substituents $R^{BNE-1}$, $R^{BNE-2}$ $R^{BNE-1'}$, $R^{BNE-2'}$ , $R^{BNE-3}$, $R^{BNE-4}$, $R^{BNE-5}$, $R^{BNE-1}$, $R^{BNE-II}$, $R^{BNE-III}$, $R^{BNE-IV}$, $R^{BNE-V}$ optionally form a mono- or polycyclic, aliphatic or aromatic or heteroaromatic, carbo- or heterocyclic ring system with each other;
wherein optionally two or more, preferably two, structures of formula BNE-1 are conjugated with each other, preferably fused to each other by sharing at least one, more preferably exactly one, bond;
wherein optionally two or more, preferably two, structures of formula BNE-1 are present in the emitter and share at least one, preferably exactly one, aromatic or heteroaromatic ring (i.e. this ring may be part of both structures of formula BNE-1) which preferably is any of the rings a, b, and c' of formula BNE-1, but may also be any aromatic or

heteroaromatic substituent selected from $R^{BNE-1}$, $R^{BNE-2}$, $R^{BNE-1'}$, $R^{BNE-2'}$, $R^{BNE-3}$, $R^{BNE-4}$, $R^{BNE-3'}$, $R^{BNE-4'}$, $R^{BNE-5}$, $R^{BNE-6}$, $R^{BNE-I}$ , $R^{BNE-II}$, $R^{BNE-III}$ , $R^{BNE-IV}$, $R^{BNE-V}$, $R^{BNE-a}$, $R^{BNE-e}$, $R^{BNE-d}$, and $R^{BNE-d'}$, or any aromatic or heteroaromatic ring formed by two or more substituents as stated above; wherein the shared ring may constitute the same or different moieties of the two or more structures of formula BNE-1 that share the ring (i.e. the shared ring may for example be ring c' of both structures of formula BNE-1 optionally comprised in the emitter or the shared ring may for example be ring b of one and ring c' of the other structure of formula BNE-1 optionally comprised in the emitter); and

wherein optionally at least one of $R^{BNE-1}$, $R^{BNE-2}$, $R^{BNE-1'}$, $R^{BNE-2'}$, $R^{BNE-3}$, $R^{BNE-4}$, $R^{BNE-5}$, $R^{BNE-3'}$ , $R^{BNE-4'}$, $R^{BNE-6}$, $R^{BNE-I}$ , $R^{BNE-II}$, $R^{BNE-III}$, $R^{BNE-IV}$, $R^{BNE-V}$, $R^{BNE-a}$, $R^{BNE-e}$, $R^{BNE-d}$, or $R^{BNE-d'}$ is replaced by a bond to a further chemical entity of formula BNE-1 and/or wherein optionally at least one hydrogen atom of any of $R^{BNE-1}$, $R^{BNE-2}$, $R^{BNE-1'}$, $R^{BNE-2'}$ , $R^{BNE-3}$, $R^{BNE-4}$, $R^{BNE-5}$, $R^{BNE-3'}$, $R^{BNE-4'}$, $R^{BNE-6}$, $R^{BNE-I}$, $R^{BNE-II}$, $R^{BNE-III}$, $R^{BNE-IV}$, $R^{BNE-V}$, $R^{BNE-a}$, $R^{BNE-e}$, $R^{BNE-d}$, or $R^{BNE-d'}$ is replaced by a bond to a further chemical entity of formula BNE-1.

In one embodiment of the invention, the small FWHM emitter $S^B$ comprises or consists of a structure according to formula BNE-1,

$R^{BNE-1}$, $R^{BNE-2}$, $R^{BNE-1'}$, $R^{BNE-2'}$ , $R^{BNE-3}$, $R^{BNE-4}$, $R^{BNE-3'}$, $R^{BNE-4'}$ , $R^{BNE-I}$, $R^{BNE-II}$, $R^{BNE-III}$, $R^{BNE-IV}$, and $R^{BNE-V}$ are each independently of each other selected from the group consisting of: hydrogen, deuterium, $N(R^{BNE-5})2$, $OR^{BNE-5}$, $Si(R^{BNE-5})3$, $B(R^{BNE-5})_2$, $CF_{.3}$, CN, F, Cl, Br, I,
$C_1$-$C_{18}$-alkyl,

which is optionally substituted with one or more substituents $R^{BNE-5}$ and
wherein one or more non-adjacent $CH_2$-groups are optionally substituted by $R^{BNE-5}C=CR^{BNE-5}$, C≡C $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S or $CONR^{BNE-5}$;

$C_6$-$C_{30}$-aryl,
which is optionally substituted with one or more substituents $R^{BNE-5}$; and
$C_2$-$C_{29}$-heteroaryl,
which is optionally substituted with one or more substituents $R^{BNE-5}$;
$R^{BNE-d}$, $R^{BNE-d'}$, and $R^{BNE-e}$ are independently of each other selected from the group consisting of: hydrogen, deuterium, $CF_3$, CN, F, Cl, Br, I,
$C_1$-$C_{18}$-alkyl,

which is optionally substituted with one or more substituents $R^{BNE-a}$ and
wherein one or more non-adjacent $CH_2$-groups are optionally substituted by $R^{BNE-5}C=CR^{BNE-5}$, C≡C $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S or $CONR^{BNE-5}$;

$C_6$-$C_{30}$-aryl,
which is optionally substituted with one or more substituents $R^{BNE-a}$; and
$C_2$-$C_{29}$-heteroaryl,
which is optionally substituted with one or more substituents $R^{BNE-a}$;
$R^{BNE-a}$ is at each occurrence independently of each other selected from the group consisting of: hydrogen, deuterium, $N(R^{BNE-5})_2$, $OR^{BNE-5}$, $Si(R^{BNE-5})_3$, $B(R^{BNE-5})_2$, $CF_3$, CN, F, Cl, Br, I,
$C_1$-$C_{18}$-alkyl,

which is optionally substituted with one or more substituents $R^{BNE-5}$ and
wherein one or more non-adjacent $CH_2$-groups are optionally substituted by $R^{BNE-5}C=CR^{BNE-5}$, C≡C $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S or $CONR^{BNE-5}$;

$C_6$-$C_{30}$-aryl,
which is optionally substituted with one or more substituents $R^{BNE-5}$; and
$C_2$-$C_{29}$-heteroaryl,
which is optionally substituted with one or more substituents $R^{BNE-5}$;
$R^{BNE-5}$ is at each occurrence independently from another selected from the group consisting of: hydrogen, deuterium, OPh, $CF_3$, CN, F,

$C_1$-$C_5$-alkyl,

wherein one or more hydrogen atoms are optionally, independently from each other substituted by deuterium, CN, $CF_3$, or F;

$C_1$-$C_5$-alkoxy,

wherein one or more hydrogen atoms are optionally, independently from each other substituted by deuterium, CN, $CF_3$, or F;

$C_1$-$C_5$-thioalkoxy,

wherein one or more hydrogen atoms are optionally, independently from each other substituted by deuterium, CN, $CF_3$, or F;

$C_2$-$C_5$-alkenyl,

wherein one or more hydrogen atoms are optionally, independently from each other substituted by deuterium, CN, $CF_3$, or F;

$C_2$-$C_5$-alkynyl,

wherein one or more hydrogen atoms are optionally, independently from each other substituted by deuterium, CN, $CF_3$, or F;

$C_6$-$C_{18}$-aryl,
which is optionally substituted with one or more $C_1$-$C_5$-alkyl substituents;
$C_2$-$C_{17}$-heteroaryl,
which is optionally substituted with one or more $C_1$-$C_5$-alkyl substituents;
$N(C_6\text{-}C_{18}\text{-aryl})_2$;
$N(C_2\text{-}C_{17}\text{-heteroaryl})_2$, and
$N(C_2\text{-}C_{17}\text{-heteroaryl})(C_6\text{-}C_{18}\text{-aryl})$;
wherein $R^{BNE-III}$ and $R^{BNE-e}$ optionally combine to form a direct single bond; and
wherein two or more of substituents $R^{BNE-a}$, $R^{BNE-d}$, $R^{BNE-d'}$, $R^{BNE-e}$, $R^{BNE-3'}$, $R^{BNE-4'}$, $R^{BNE-5}$ optionally form a mono- or polycyclic, aliphatic or aromatic or heteroaromatic, carbo- or heterocyclic ring system with each other;
wherein two or more of the substituents $R^{BNE-1}$, $R^{BNE-2}$, $R^{BNE-1'}$, $R^{BNE-2'}$, $R^{BNE-3}$, $R^{BNE-4}$, $R^{BNE-5}$, $R^{BNE-1}$, $R^{BNE-II}$, $R^{BNE-III}$, $R^{BNE-IV}$, $R^{BNE-V}$ optionally form a mono- or polycyclic, aliphatic or aromatic or heteroaromatic, carbo- or heterocyclic ring system with each other;
wherein optionally two or more, preferably two, structures of formula BNE-1 are conjugated with each other, preferably fused to each other by sharing at least one, more preferably exactly one, bond;
wherein optionally two or more, preferably two, structures of formula BNE-1 are present in the emitter and share at least one, preferably exactly one, aromatic or heteroaromatic ring (i.e. this ring may be part of both structures of formula BNE-1) which preferably is any of the rings a, b, and c' of formula BNE-1, but may also be any aromatic or heteroaromatic substituent selected from $R^{BNE-1}$, $R^{BNE-2}$, $R^{BNE-1'}$, $R^{BNE-2'}$, $R^{BNE-3}$, $R^{BNE-4}$, $R^{BNE-3'}$, $R^{BNE-4'}$, $R^{BNE-5}$, $R^{BNE-6}$, $R^{BNE-I}$, $R^{BNE-II}$, $R^{BNE-III}$, $R^{BNE-IV}$, $R^{BNE-V}$, $R^{BNE-a}$, $R^{BNE-e}$, $R^{BNE-d}$, and $R^{BNE-d'}$, or any aromatic or heteroaromatic ring formed by two or more substituents as stated above; wherein the shared ring may constitute the same or different moieties of the two or more structures of formula BNE-1 that share the ring (i.e. the shared ring may for example be ring c' of both structures of formula BNE-1 optionally comprised in the emitter or the shared ring may for example be ring b of one and ring c' of the other structure of formula BNE-1 optionally comprised in the emitter); and
wherein optionally at least one of $R^{BNE-1}$, $R^{BNE-2}$, $R^{BNE-1'}$, $R^{BNE-2'}$, $R^{BNE-3}$, $R^{BNE-4}$, $R^{BNE-5}$, $R^{BNE-3'}$, $R^{BNE-4'}$, $R^{BNE-6}$, $R^{BNE-I}$, $R^{BNE-II}$, $R^{BNE-III}$, $R^{BNE-IV}$, $R^{BNE-V}$, $R^{BNE-a}$, $R^{BNE-e}$, $R^{BNE-d}$, or $R^{BNE-d'}$ is replaced by a bond to a further chemical entity of formula BNE-1 and/or wherein optionally at least one hydrogen atom of any of $R^{BNE-1}$, $R^{BNE-2}$, $R^{BNE-1'}$, $R^{BNE-2'}$, $R^{BNE-3}$, $R^{BNE-4}$, $R^{BNE-5}$, $R^{BNE-3'}$, $R^{BNE-4'}$, $R^{BNE-6}$, $R^{BNE-I}$, $R^{BNE-II}$, $R^{BNE-III}$, $R^{BNE-IV}$, $R^{BNE-V}$, $R^{BNE-a}$, $R^{BNE-e}$, $R^{BNE-d}$, or $R^{BNE-d'}$ is replaced by a bond to a further chemical entity of formula BNE-1.

In one embodiment of the invention, the small FWHM emitter $S^B$ comprises or consists of a structure according to formula BNE-1,

$R^{BNE-1}$, $R^{BNE-2}$, $R^{BNE-1'}$, $R^{BNE-2'}$, $R^{BNE-3}$, $R^{BNE-4}$, $R^{BNE-3'}$, $R^{BNE-4'}$, $R^{BNE-I}$, $R^{BNE-II}$, $R^{BNE-III}$, $R^{BNE-IV}$, and $R^{BNE-V}$ are each independently of each other selected from the group consisting of: hydrogen, deuterium, $N(R^{BNE-5})_2$, $OR^{BNE-5}$, $Si(R^{BNE-5})_3$, $B(R^{BNE-5})_2$, $CF_3$, CN, F,
$C_1$-$C_5$-alkyl,
which is optionally substituted with one or more substituents $R^{BNE-5}$;
$C_6$-$C_{18}$-aryl,
which is optionally substituted with one or more substituents $R^{BNE-5}$; and
$C_2$-$C_{17}$-heteroaryl,
which is optionally substituted with one or more substituents $R^{BNE-5}$;
$R^{BNE-d}$, $R^{BNE-d'}$, and $R^{BNE-e}$ are independently of each other selected from the group consisting of: hydrogen, deuterium, $CF_3$, CN, F,
$C_1$-$C_5$-alkyl,
which is optionally substituted with one or more substituents $R^{BNE-a}$;
$C_6$-$C_{18}$-aryl,
which is optionally substituted with one or more substituents $R^{BNE-a}$; and
$C_2$-$C_{17}$-heteroaryl,
which is optionally substituted with one or more substituents $R^{BNE-a}$;
$R^{BNE-a}$ is at each occurrence independently of each other selected from the group consisting of: hydrogen, deuterium, $N(R^{BNE-5})_2$, $OR^{BNE-5}$, $Si(R^{BNE-5})_3$, $B(R^{BNE-5})_2$, $CF_3$, CN, F,
$C_1$-$C_5$-alkyl,
which is optionally substituted with one or more substituents $R^{BNE-5}$;
$C_6$-$C_{18}$-aryl,
which is optionally substituted with one or more substituents $R^{BNE-5}$; and
$C_2$-$C_{17}$-heteroaryl,
which is optionally substituted with one or more substituents $R^{BNE-5}$;
$R^{BNE-5}$ is at each occurrence independently from another selected from the group consisting of: hydrogen, deuterium, OPh, $CF_3$, CN, F,
$C_1$-$C_5$-alkyl,

wherein one or more hydrogen atoms are optionally, independently from each other substituted by deuterium, CN, $CF_3$, or F;

$C_1$-$C_5$-alkoxy,

wherein one or more hydrogen atoms are optionally, independently from each other substituted by deuterium, CN, $CF_3$, or F;

$C_6$-$C_{18}$-aryl,
which is optionally substituted with one or more $C_1$-$C_5$-alkyl substituents;
$C_2$-$C_{17}$-heteroaryl,
which is optionally substituted with one or more $C_1$-$C_5$-alkyl substituents;
$N(C_6$-$C_{18}$-aryl$)_2$;
$N(C_2$-$C_{17}$-heteroaryl$)_2$, and
$N(C_2$-$C_{17}$-heteroaryl$)(C_6$-$C_{18}$-aryl$)$;
wherein $R^{BNE-III}$ and $R^{BNE-e}$ optionally combine to form a direct single bond; and
wherein two or more of substituents $R^{BNE-a}$, $R^{BNE-d}$, $R^{BNE-d'}$, $R^{BNE-e}$, $R^{BNE-3'}$, $R^{BNE-4'}$, $R^{BNE-5}$ optionally form a mono- or polycyclic, aliphatic or aromatic or heteroaromatic, carbo- or heterocyclic ring system with each other;
wherein two or more of the substituents $R^{BNE-1}$, $R^{BNE-2}$, $R^{BNE-1'}$, $R^{BNE-2'}$, $R^{BNE-3}$, $R^{BNE-4}$, $R^{BNE-5}$, $R^{BNE-1}$, $R^{BNE-II}$, $R^{BNE-III}$, $R^{BNE-IV}$, $R^{BNE-V}$ optionally form a mono- or polycyclic, aliphatic or aromatic or heteroaromatic, carbo- or heterocyclic ring system with each other;
wherein optionally two or more, preferably two, structures of formula BNE-1 are conjugated with each other, preferably fused to each other by sharing at least one, more preferably exactly one, bond;
wherein optionally two or more, preferably two, structures of formula BNE-1 are present in the emitter and share at least one, preferably exactly one, aromatic or heteroaromatic ring (i.e. this ring may be part of both structures of formula BNE-1) which preferably is any of the rings a, b, and c' of formula BNE-1, but may also be any aromatic or heteroaromatic substituent selected from $R^{BNE-1}$, $R^{BNE-2}$, $R^{BNE-1'}$, $R^{BNE-2'}$, $R^{BNE-3}$, $R^{BNE-4}$, $R^{BNE-3'}$, $R^{BNE-4'}$, $R^{BNE-5}$, $R^{BNE-6}$, $R^{BNE-I}$, $R^{BNE-II}$, $R^{BNE-III}$, $R^{BNE-IV}$, $R^{BNE-V}$, $R^{BNE-a}$, $R^{BNE-e}$, $R^{BNE-d}$, and $R^{BNE-d'}$, or any aromatic or heteroaromatic ring formed by two or more substituents as stated above; wherein the shared ring may constitute the same or

different moieties of the two or more structures of formula BNE-1 that share the ring (i.e. the shared ring may for example be ring c' of both structures of formula BNE-1 optionally comprised in the emitter or the shared ring may for example be ring b of one and ring c' of the other structure of formula BNE-1 optionally comprised in the emitter); and wherein optionally at least one of $R^{BNE-1}$, $R^{BNE-2}$, $R^{BNE-1'}$, $R^{BNE-2'}$, $R^{BNE-3}$, $R^{BNE-4}$, $R^{BNE-5}$, $R^{BNE-3'}$, $R^{BNE-4'}$, $R^{BNE-6}$, $R^{BNE-I}$, $R^{BNE-II}$, $R^{BNE-III}$, $R^{BNE-IV}$, $R^{BNE-V}$, $R^{BNE-a}$, $R^{BNE-e}$, $R^{BNE-d}$, or $R^{BNE-d'}$ is replaced by a bond to a further chemical entity of formula BNE-1 and/or wherein optionally at least one hydrogen atom of any of $R^{BNE-1}$, $R^{BNE-2}$, $R^{BNE-1'}$, $R^{BNE-2'}$, $R^{BNE-3}$, $R^{BNE-4}$, $R^{BNE-5}$, $R^{BNE-3'}$, $R^{BNE-4'}$, $R^{BNE-6}$, $R^{BNE-I}$, $R^{BNE-II}$, $R^{BNE-III}$, $R^{BNE-IV}$, $R^{BNE-V}$, $R^{BNE-a}$, $R^{BNE-e}$, $R^{BNE-d}$, or $R^{BNE-d'}$ is replaced by a bond to a further chemical entity of formula BNE-1.

In one embodiment of the invention, the small FWHM emitter $S^B$ comprises or consists of a structure according to formula BNE-1,

$R^{BNE-1}$, $R^{BNE-2}$, $R^{BNE-1'}$, $R^{BNE-2'}$, $R^{BNE-3}$, $R^{BNE-4}$, $R^{BNE-3'}$, $R^{BNE-4'}$, $R^{BNE-I}$, $R^{BNE-II}$, $R^{BNE-III}$, $R^{BNE-IV}$, and $R^{BNE-V}$ are each independently of each other selected from the group consisting of: hydrogen, deuterium, $N(R^{BNE-5})_2$, $OR^{BNE-5}$, $Si(R^{BNE-5})_3$, $B(R^{BNE-5})_2$, $CF_3$, CN, F,
$C_1$-$C_5$-alkyl,
which is optionally substituted with one or more substituents $R^{BNE-5}$;
$C_6$-$C_{18}$-aryl,
which is optionally substituted with one or more substituents $R^{BNE-5}$; and
$C_2$-$C_{17}$-heteroaryl,
which is optionally substituted with one or more substituents $R^{BNE-5}$;
$R^{BNE-d}$, $R^{BNE-d'}$, and $R^{BNE-e}$ are independently of each other selected from the group consisting of: hydrogen, deuterium,
$C_1$-$C_5$-alkyl,
which is optionally substituted with one or more substituents $R^{BNE-a}$;
$C_6$-$C_{18}$-aryl,
which is optionally substituted with one or more substituents $R^{BNE-a}$; and
$C_2$-$C_{17}$-heteroaryl,
which is optionally substituted with one or more substituents $R^{BNE-a}$;
$R^{BNE-a}$ is at each occurrence independently of each other selected from the group consisting of: hydrogen, deuterium, $N(R^{BNE-5})_2$, $OR^{BNE-5}$, $Si(R^{BNE-5})_3$, $B(R^{BNE-5})_2$, $CF_3$, CN, F,
$C_1$-$C_5$-alkyl,
which is optionally substituted with one or more substituents $R^{BNE-5}$;
$C_6$-$C_{18}$-aryl,
which is optionally substituted with one or more substituents $R^{BNE-5}$; and
$C_2$-$C_{17}$-heteroaryl,
which is optionally substituted with one or more substituents $R^{BNE-5}$;
$R^{BNE-5}$ is at each occurrence independently from another selected from the group consisting of: hydrogen, deuterium, OPh, $CF_3$, CN, F,
$C_1$-$C_5$-alkyl,

wherein one or more hydrogen atoms are optionally, independently from each other substituted by deuterium, CN, $CF_3$, or F;

$C_6$-$C_{18}$-aryl,
which is optionally substituted with one or more $C_1$-$C_5$-alkyl substituents;
$C_2$-$C_{17}$-heteroaryl,
which is optionally substituted with one or more $C_1$-$C_5$-alkyl substituents;
$N(C_6$-$C_{18}$-aryl$)_2$;
$N(C_2$-$C_{17}$-heteroaryl$)_2$, and
$N(C_2$-$C_{17}$-heteroaryl$)(C_6$-$C_{18}$-aryl$)$;
wherein $R^{BNE-III}$ and $R^{BNE-e}$ optionally combine to form a direct single bond; and
wherein two or more of substituents $R^{BNE-a}$, $R^{BNE-d}$, $R^{BNE-d'}$, $R^{BNE-e}$, $R^{BNE-3'}$, $R^{BNE-4'}$, $R^{BNE-5}$ optionally form a mono- or polycyclic, aliphatic or aromatic or heteroaromatic, carbo- or heterocyclic ring system with each other;
wherein two or more of the substituents $R^{BNE-1}$, $R^{BNE-2}$, $R^{BNE-1'}$, $R^{BNE-2'}$, $R^{BNE-3}$, $R^{BNE-4}$, $R^{BNE-5}$, $R^{BNE-I}$, $R^{BNE-II}$, $R^{BNE-III}$, $R^{BNE-IV}$, $R^{BNE-V}$ optionally form a mono- or polycyclic, aliphatic or aromatic or heteroaromatic, carbo- or heterocyclic ring system with each other;
wherein optionally two or more, preferably two, structures of formula BNE-1 are conjugated with each other, preferably

fused to each other by sharing at least one, more preferably exactly one, bond;
wherein optionally two or more, preferably two, structures of formula BNE-1 are present in the emitter and share at least one, preferably exactly one, aromatic or heteroaromatic ring (i.e. this ring may be part of both structures of formula BNE-1) which preferably is any of the rings a, b, and c' of formula BNE-1, but may also be any aromatic or heteroaromatic substituent selected from $R^{BNE-1}$, $R^{BNE-2}$, $R^{BNE-1'}$, $R^{BNE-2'}$, $R^{BNE-3}$, $R^{BNE-4}$, $R^{BNE-3'}$, $R^{BNE-4'}$, $R^{BNE-5}$, $R^{BNE-6}$, $R^{BNE-I}$, $R^{BNE-II}$, $R^{BNE-III}$, $R^{BNE-IV}$, $R^{BNE-V}$, $R^{BNE-a}$, $R^{BNE-e}$, $R^{BNE-d}$, and $R^{BNE-d'}$, or any aromatic or heteroaromatic ring formed by two or more substituents as stated above; wherein the shared ring may constitute the same or different moieties of the two or more structures of formula BNE-1 that share the ring (i.e. the shared ring may for example be ring c' of both structures of formula BNE-1 optionally comprised in the emitter or the shared ring may for example be ring b of one and ring c' of the other structure of formula BNE-1 optionally comprised in the emitter); and
wherein optionally at least one of $R^{BNE-1}$, $R^{BNE-2}$, $R^{BNE-1'}$, $R^{BNE-2'}$, $R^{BNE-3}$, $R^{BNE-4}$, $R^{BNE-5}$, $R^{BNE-3'}$, $R^{BNE-4'}$, $R^{BNE-6}$, $R^{BNE-I}$, $R^{BNE-II}$, $R^{BNE-III}$, $R^{BNE-IV}$, $R^{BNE-V}$, $R^{BNE-a}$, $R^{BNE-e}$, $R^{BNE-d}$, or $R^{BNE-d'}$ is replaced by a bond to a further chemical entity of formula BNE-1 and/or wherein optionally at least one hydrogen atom of any of $R^{BNE-1}$, $R^{BNE-2}$, $R^{BNE-1'}$, $R^{BNE-2'}$, $R^{BNE-3}$, $R^{BNE-4}$, $R^{BNE-5}$, $R^{BNE-3'}$, $R^{BNE-4'}$, $R^{BNE-6}$, $R^{BNE-I}$, $R^{BNE-II}$, $R^{BNE-III}$, $R^{BNE-IV}$, $R^{BNE-V}$, $R^{BNE-a}$, $R^{BNE-e}$, $R^{BNE-d}$, or $R^{BNE-d'}$ is replaced by a bond to a further chemical entity of formula BNE-1.

In one embodiment of the invention, the small FWHM emitter $S^B$ comprises or consists of a structure according to formula BNE-1, $R^{BNE-III}$ and $R^{BNE-e}$ combine to form a direct single bond.

In one embodiment of the invention, the small FWHM emitter $S^B$ comprises or consists of a structure according to formula BNE-1, $R^{BNE-III}$ and $R^{BNE-e}$ do not combine to form a direct single bond.

In one embodiment, fluorescent emitters suitable as small FWHM emitters $S^B$ in the context of the present invention may optionally also be multimers (e.g. dimers) of the aforementioned formula BNE-1, which means that their structure comprises more than one subunits, each of which has a structure according to formula BNE-1. In this case, the skilled artisan will understand that the two or more subunits according to formula BNE-1 may for example be conjugated, preferably fused to each other (i.e. sharing at least one bond, wherein the respective substituents attached to the atoms forming that bond may no longer be present). The two or more subunits may also share at least one, preferably exactly one, aromatic or heteroaromatic ring. This means that, for example, a small FWHM emitter $S^B$ may comprise two or more subunits each having a structure of formula BNE-1, wherein these two subunits share one aromatic or heteroaromatic ring (i.e. the respective ring is part of both subunits). As a result, the respective multimeric (e.g., dimeric) emitter $S^B$ may not contain two whole subunits according to formula BNE-1 as the shared ring is only present once. Nevertheless, the skilled artisan will understand that herein, such an emitter is still considered a multimer (for example a dimer if two subunits having a structure of formula BNE-1 are comprised) of formula BNE-1. The same holds true for multimers sharing more than one ring. It is preferred that the multimers are dimers comprising two subunits, each having a structure of formula BNE-1.

In one embodiment of the invention, the small FWHM emitter $S^B$ is a dimer of formula BNE-1 as described above, which means that the emitter comprises two subunits, each having a structure according to formula BNE-1.

In one embodiment of the invention, the small FWHM emitter $S^B$ is a dimer of formula BNE-1 as described above, which means that the emitter comprises two subunits, each having a structure according to formula BNE-1 (i.e. subunits), wherein these two subunits are conjugated, preferably fused to each other by sharing at least one, more preferably exactly one, bond.

In one embodiment of the invention, the small FWHM emitter $S^B$ is a dimer of formula BNE-1 as described above, which means that the emitter comprises two subunits, each having a structure according to formula BNE-1 (i.e. subunits), wherein these two subunits share at least one, preferably exactly one, aromatic or heteroaromatic ring (i.e. this ring is part of both structures of formula BNE-1) which preferably is any of the rings a, b, and c' of formula BNE-1, but may also be any aromatic or heteroaromatic substituent selected from $R^{BNE-1}$, $R^{BNE-2}$, $R^{BNE-1'}$, $R^{BNE-2'}$, $R^{BNE-3}$, $R^{BNE-4}$, $R^{BNE-3'}$, $R^{BNE-4'}$, , $R^{BNE-5}$, $R^{BNE-6}$, $R^{BNE-I}$, $R^{BNE-II}$, $R^{BNE-III}$, $R^{BNE-IV}$, $R^{BNE-V}$, $R^{BNE-a}$, $R^{BNE-e}$, $R^{BNE-d}$, and $R^{BNE-d'}$, or any aromatic or heteroaromatic ring formed by two or more substituents as stated above; wherein the shared ring may constitute the same or different moieties of the two or more structures of formula BNE-1 that share the ring (i.e. the shared ring may for example be ring c' of both structures of formula BNE-1 optionally comprised in the emitter or the shared ring may for example be ring b of one and ring c' of the other structure of formula BNE-1 optionally comprised in the emitter).

In one embodiment of the invention, the small FWHM emitter $S^B$ is a dimer of formula BNE-1 as described above, which means that the emitter comprises two subunits, each having a structure according to formula BNE-1 (i.e. subunits), wherein at least one of $R^{BNE-1}$, $R^{BNE-2}$, $R^{BNE-1'}$, $R^{BNE-2'}$, $R^{BNE-3}$, $R^{BNE-4}$, $R^{BNE-5}$, $R^{BNE-3'}$, $R^{BNE-4'}$, $R^{BNE-6}$, $R^{BNE-I}$, $R^{BNE-II}$, $R^{BNE-III}$, $R^{BNE-IV}$, $R^{BNE-V}$, $R^{BNE-a}$, $R^{BNE-e}$, $R^{BNE-d}$, or $R^{BNE-d'}$ is replaced by a bond to a further chemical entity of formula BNE-1 and/or wherein optionally at least one hydrogen atom of any of $R^{BNE-1}$, $R^{BNE-2}$, $R^{BNE-1'}$, $R^{BNE-2'}$, $R^{BNE-3}$, $R^{BNE-4}$, $R^{BNE-5}$, $R^{BNE-3'}$, $R^{BNE-4'}$, $R^{BNE-6}$, $R^{BNE-I}$, $R^{BNE-II}$, $R^{BNE-III}$, $R^{BNE-IV}$, $R^{BNE-V}$, $R^{BNE-a}$, $R^{BNE-e}$, $R^{BNE-d}$, or $R^{BNE-d'}$ is replaced by a bond to a further chemical entity of formula BNE-1.

Non-limiting examples of fluorescent emitters comprising or consisting of a structure according to the aforementioned formula BNE-1 that may be used as small FWHM emitters in the context of the present invention are shown

below:
invention are shown below:

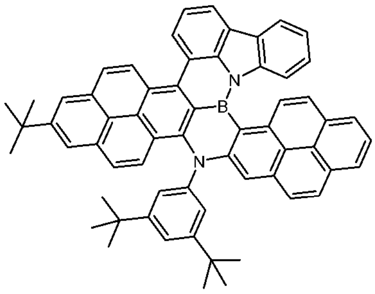
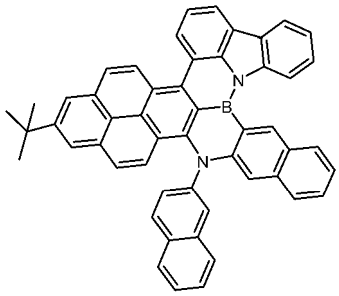
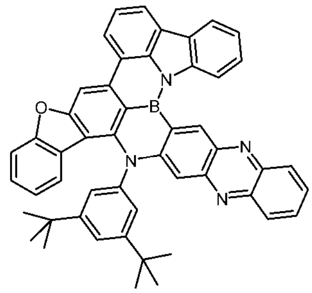
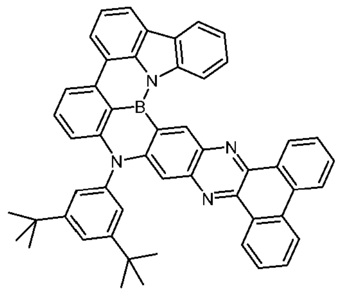
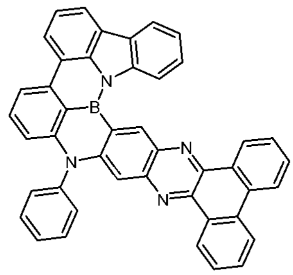
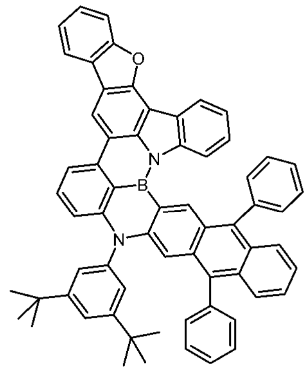
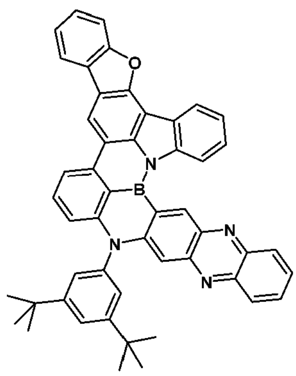
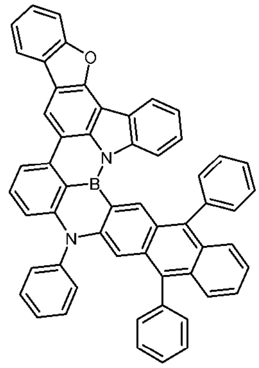
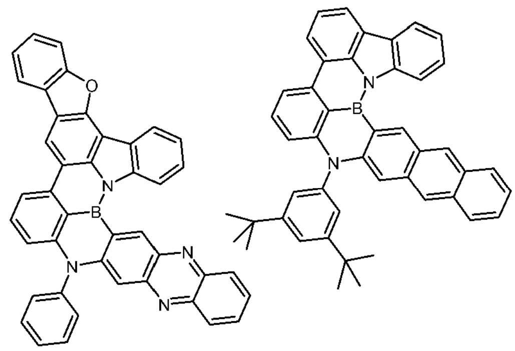
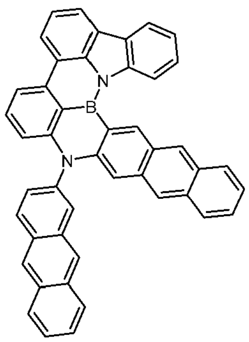
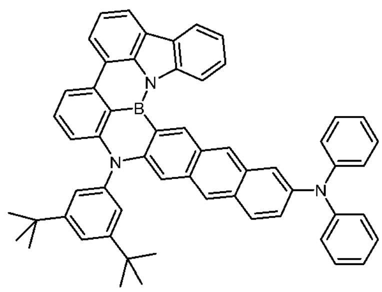
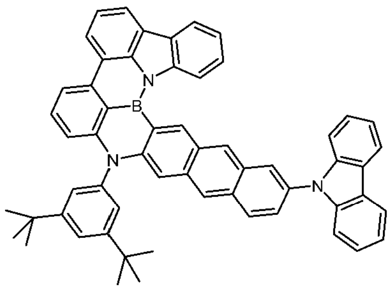

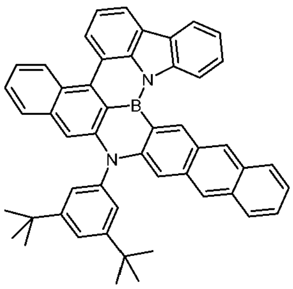

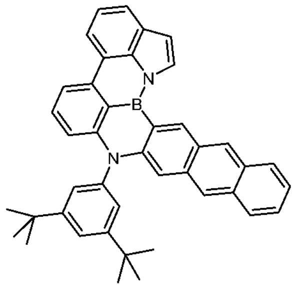

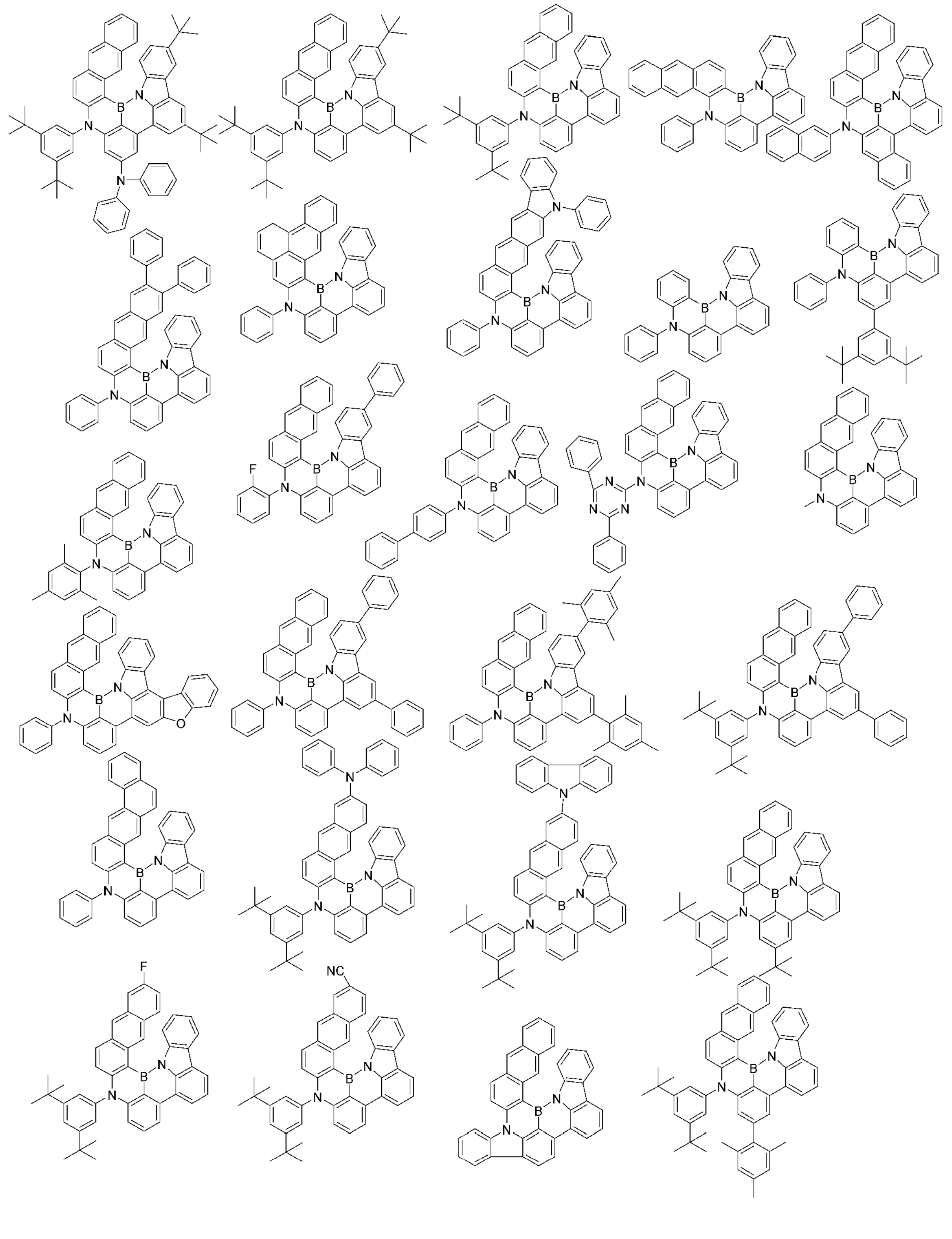

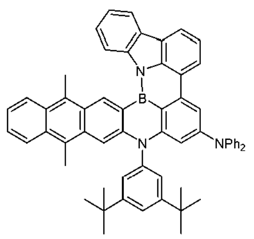

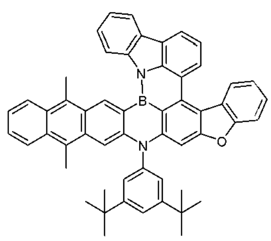

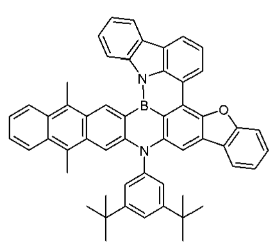

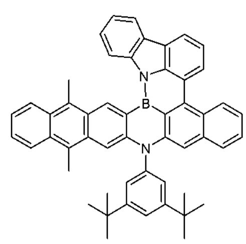

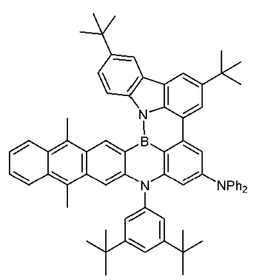
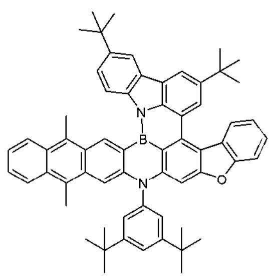
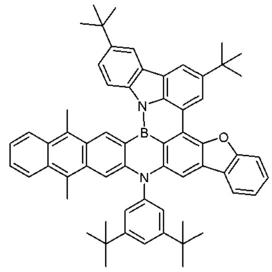
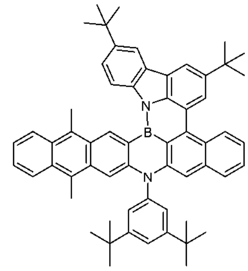

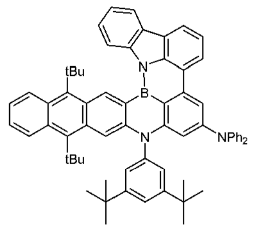
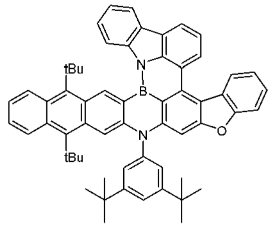
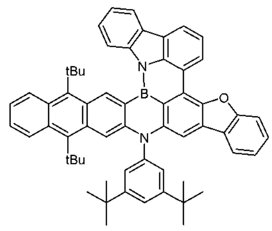
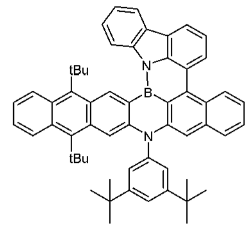

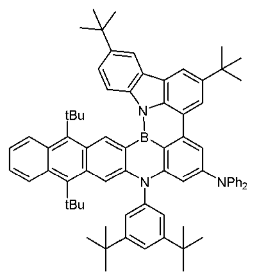
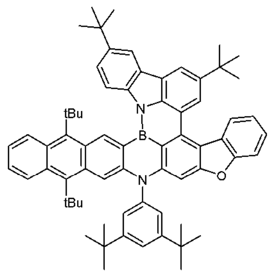
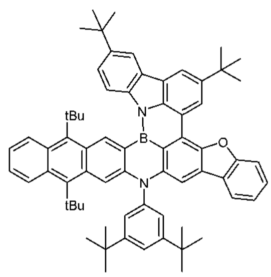
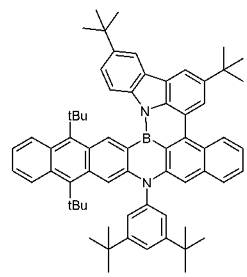

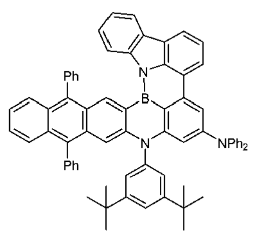
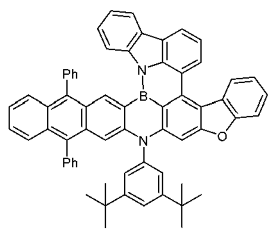
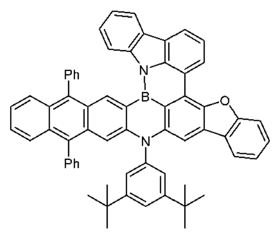
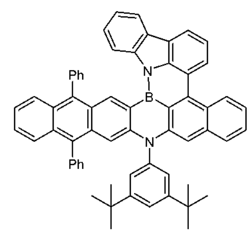

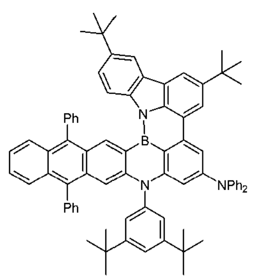
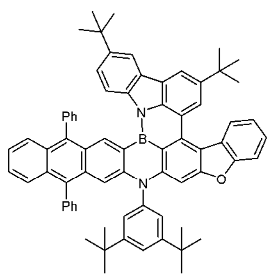
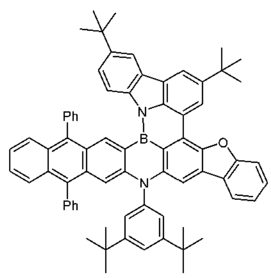
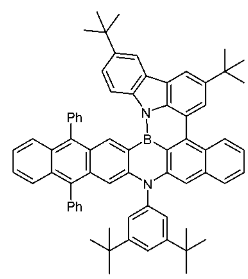

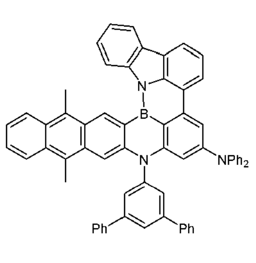
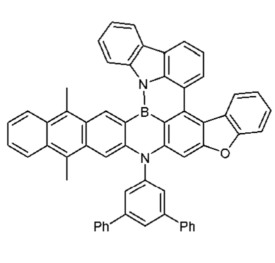
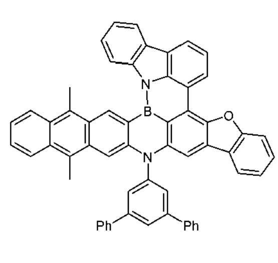
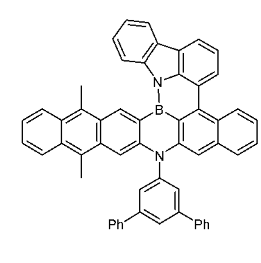

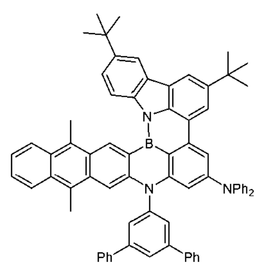
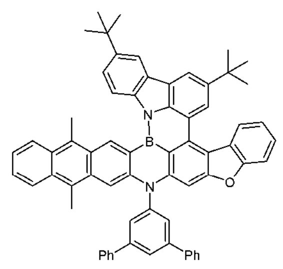
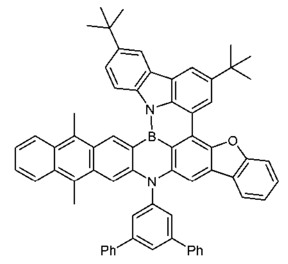
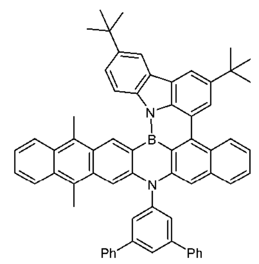
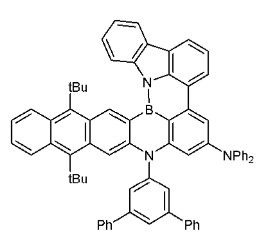
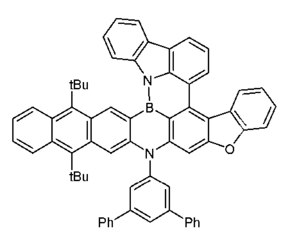
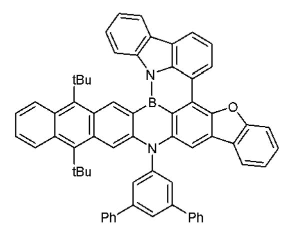
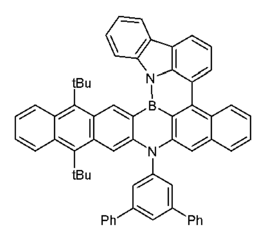
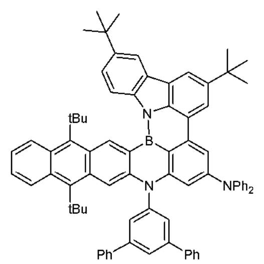
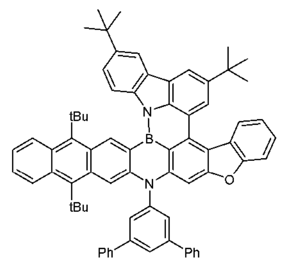
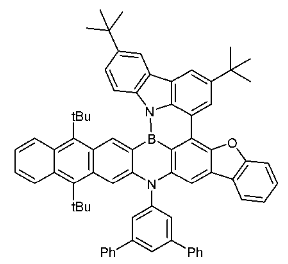
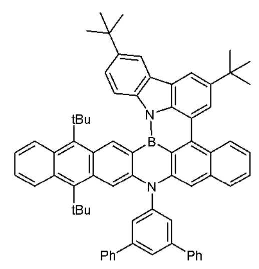
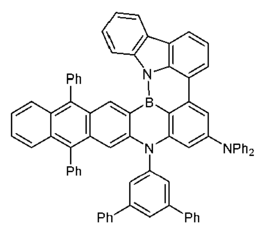
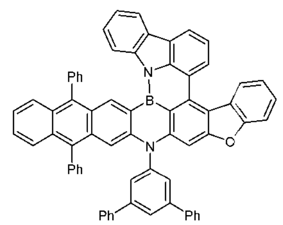
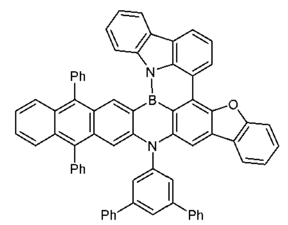
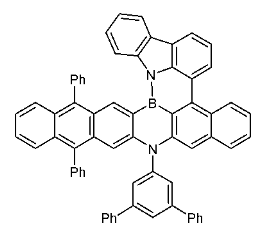
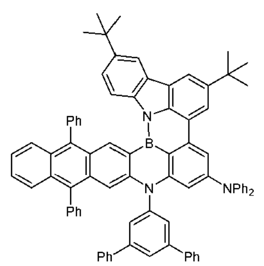
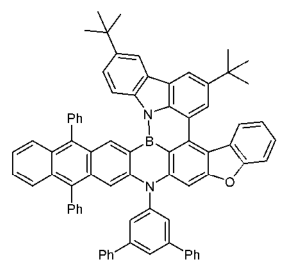
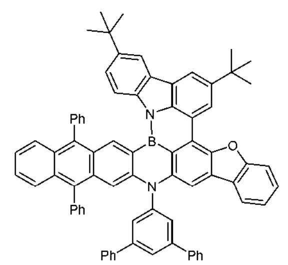
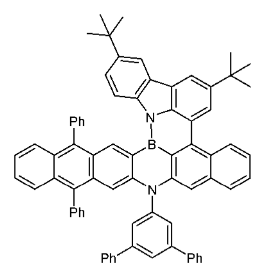
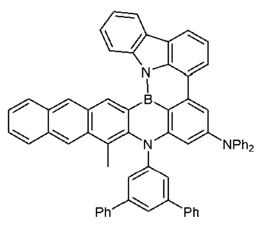
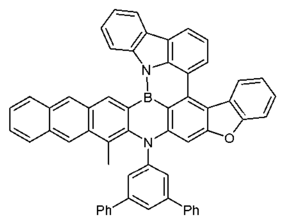
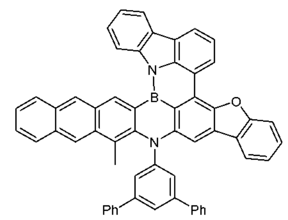
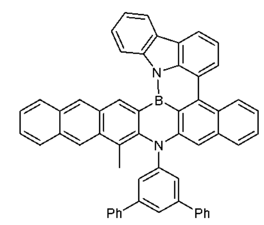

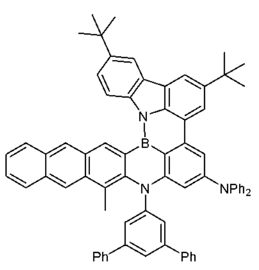 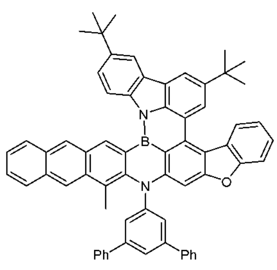 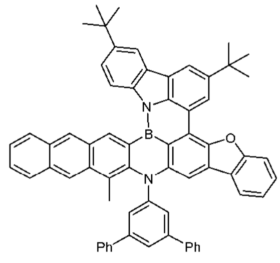 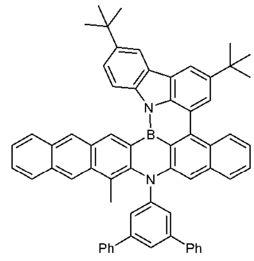

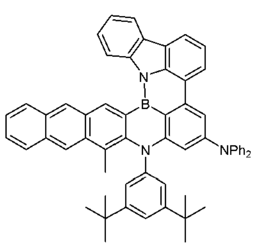 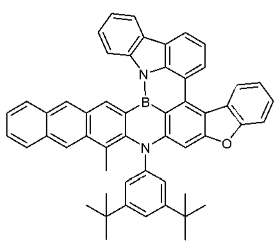 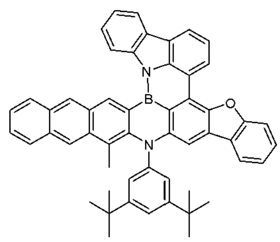 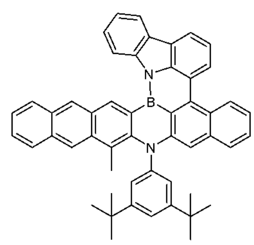

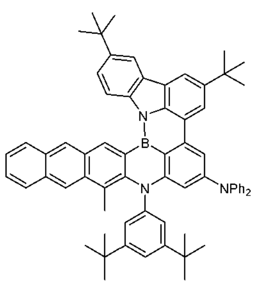 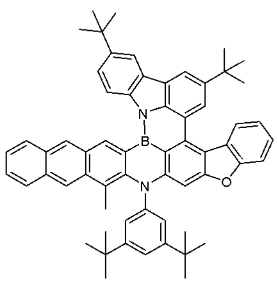 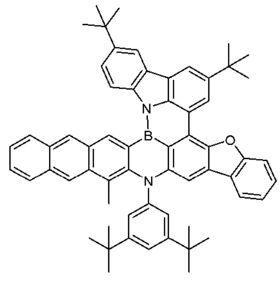 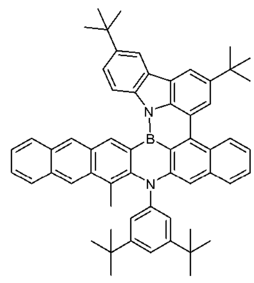

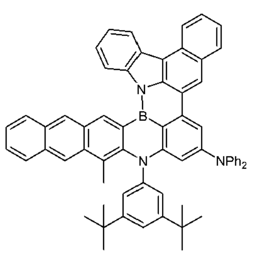 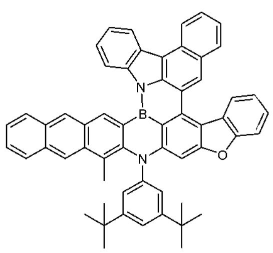 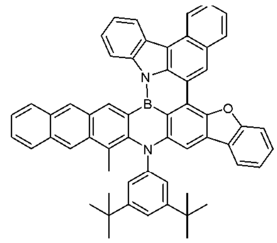 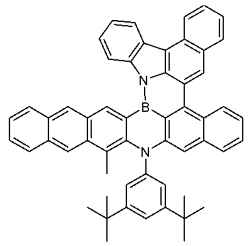

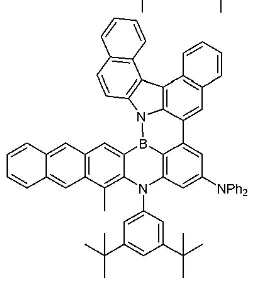 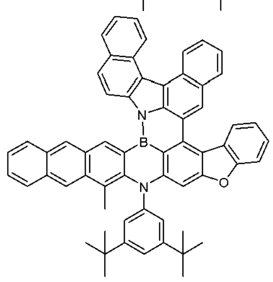 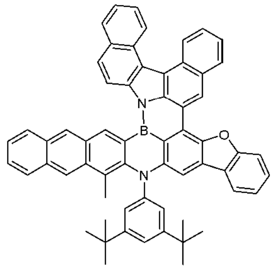 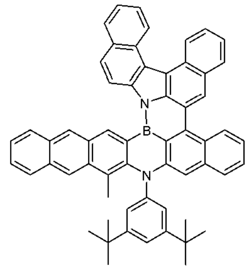

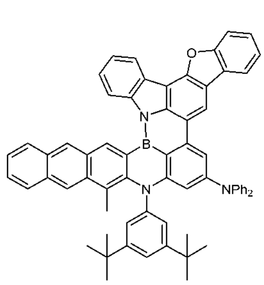 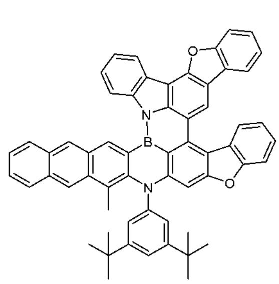 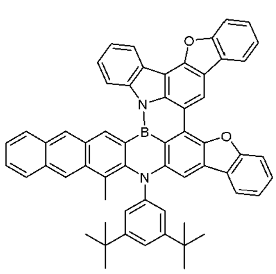 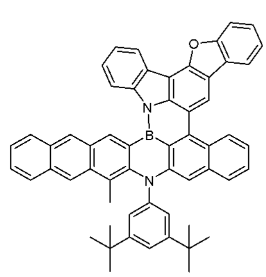

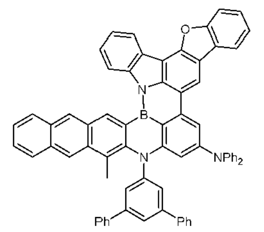
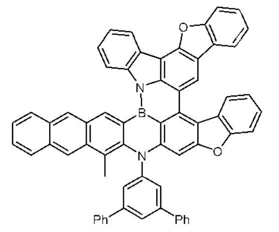
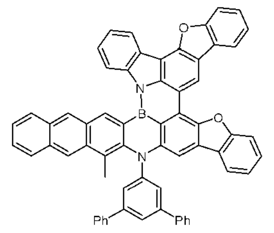
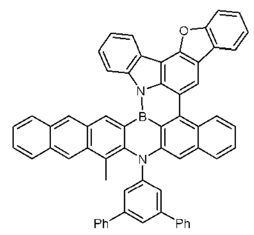

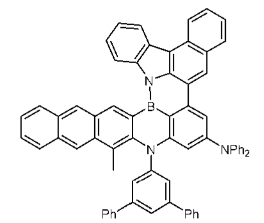
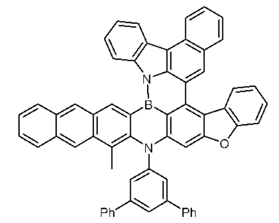
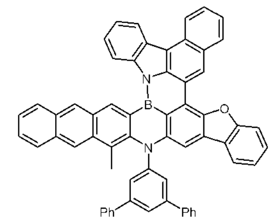
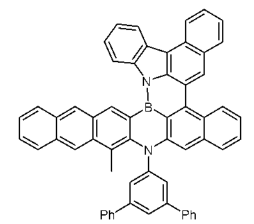

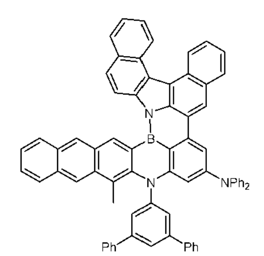
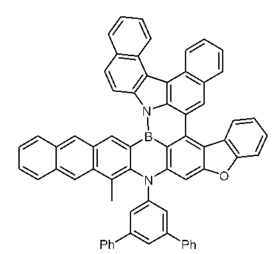
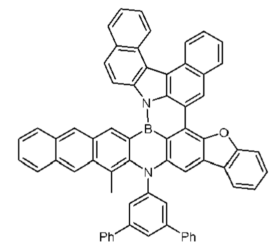
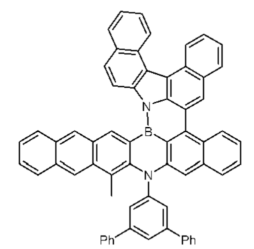

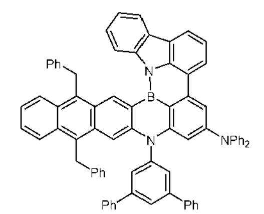
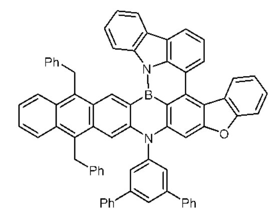
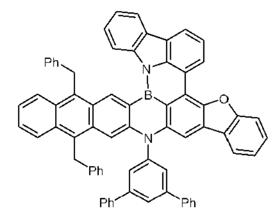
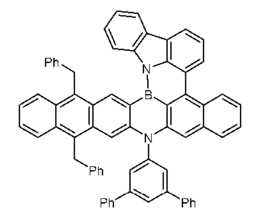

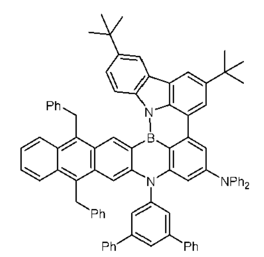
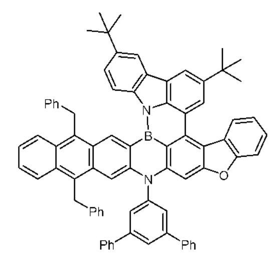
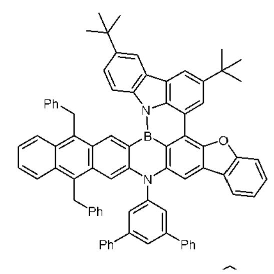
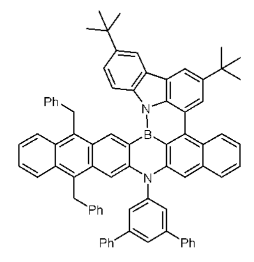

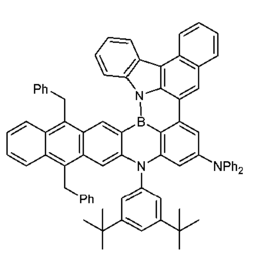
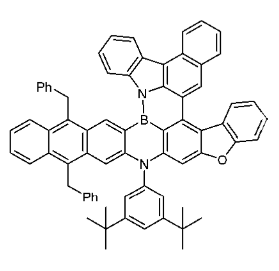
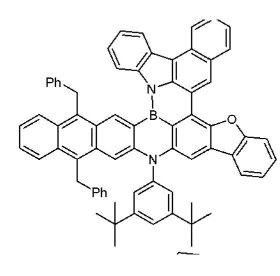
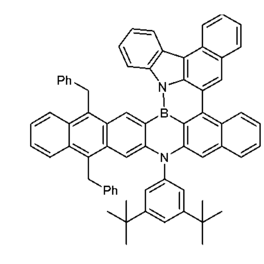

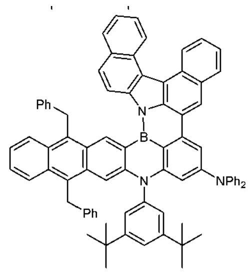 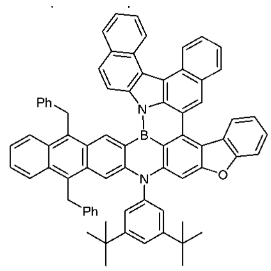 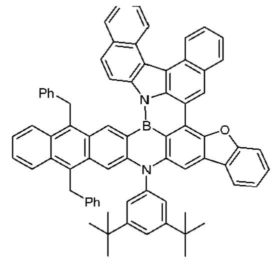 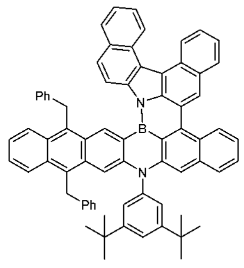

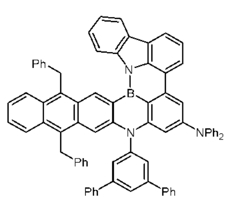 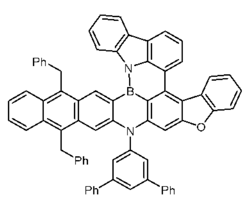 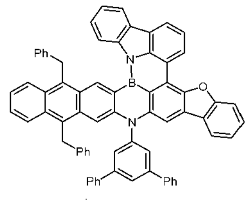 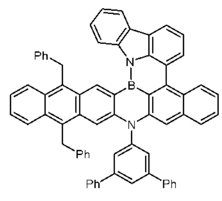

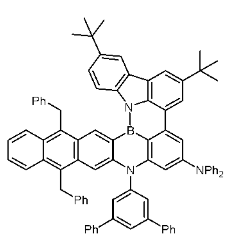 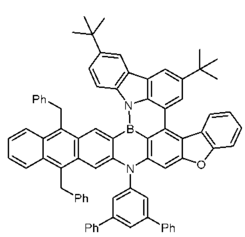 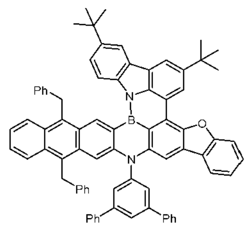 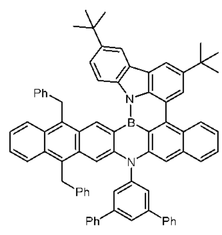

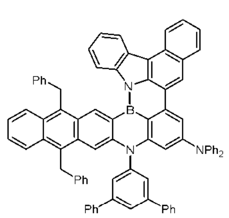 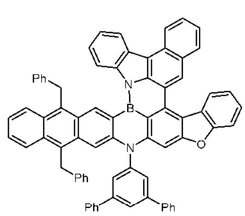 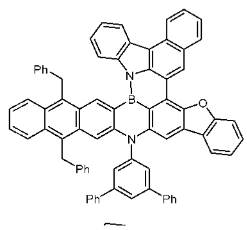 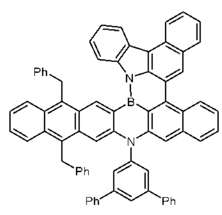

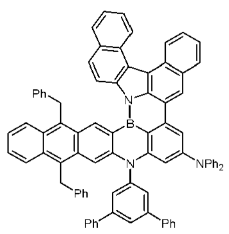 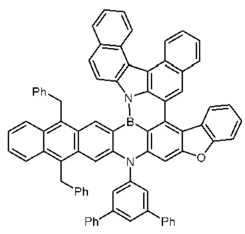 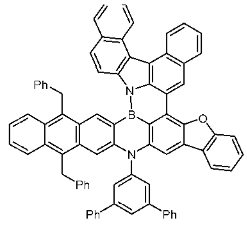 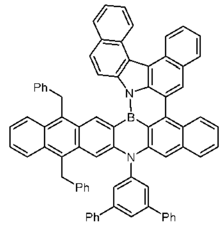

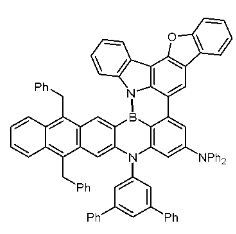 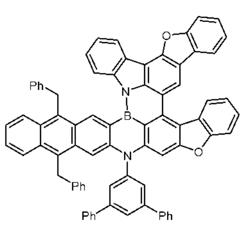 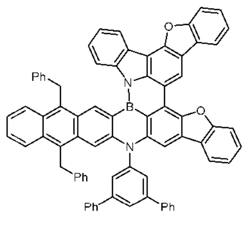 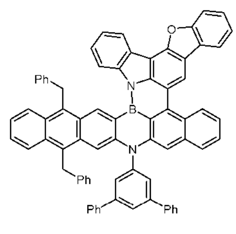

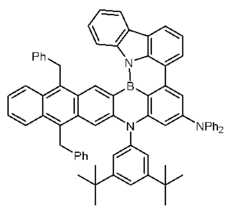
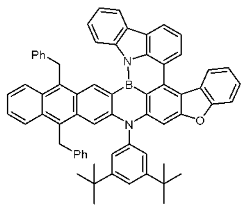
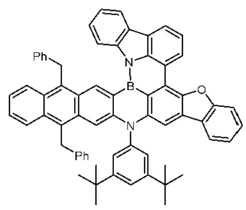
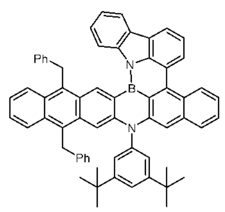

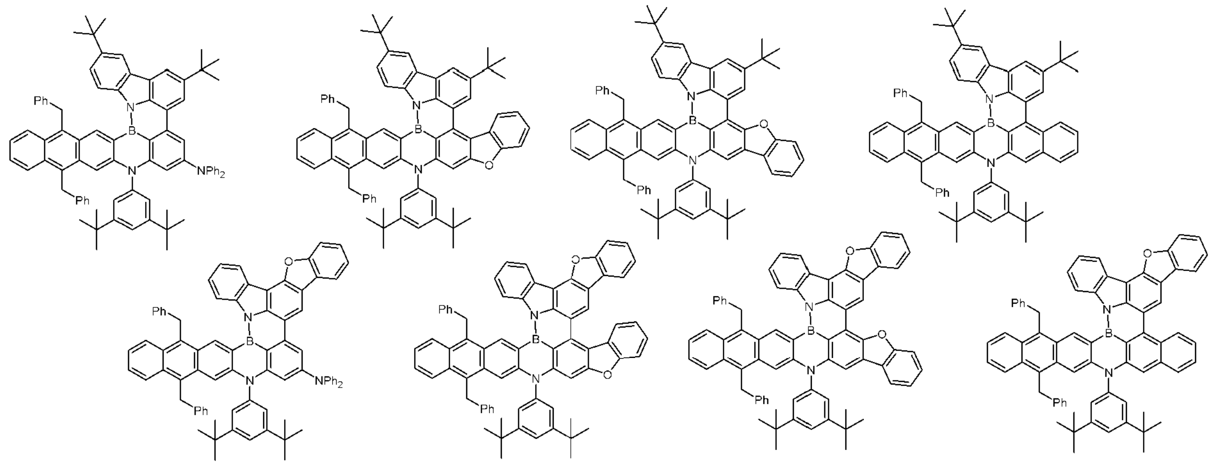

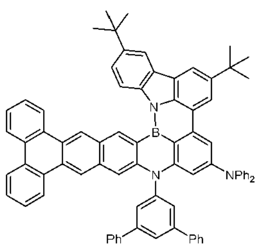
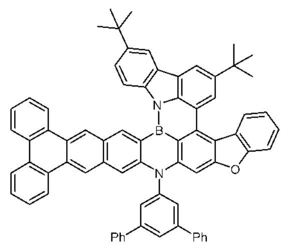
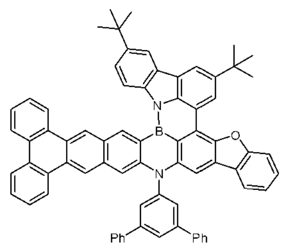
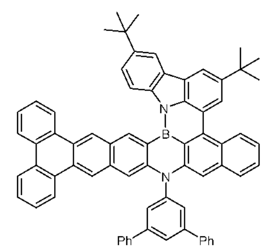

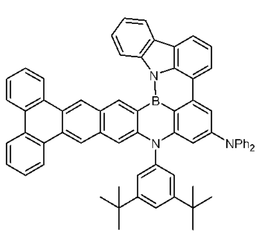
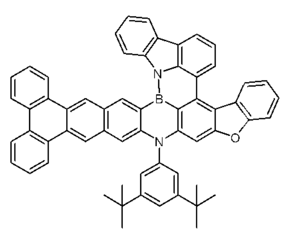
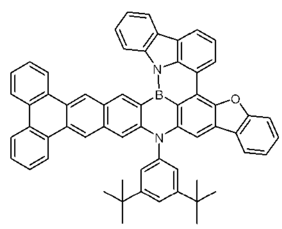
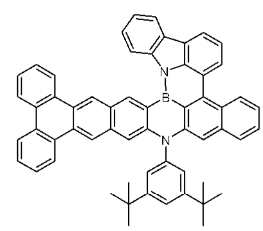

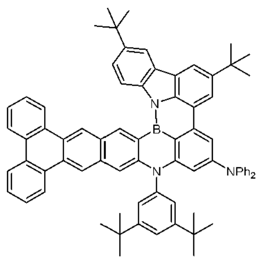
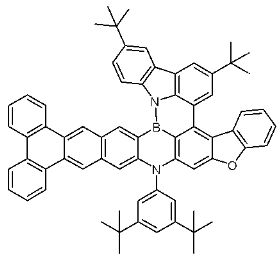
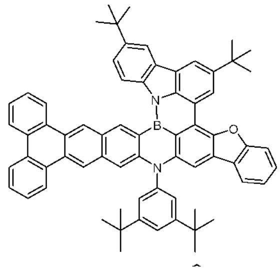
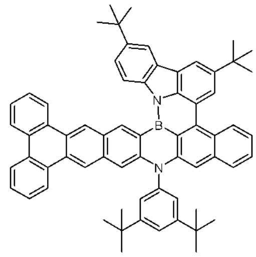

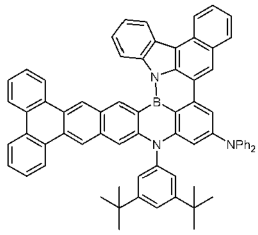
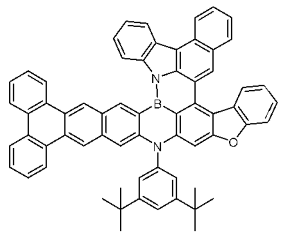
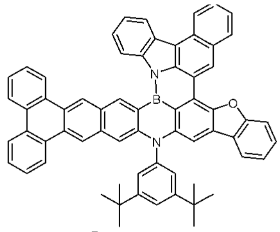
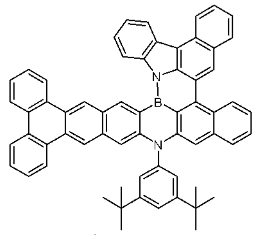

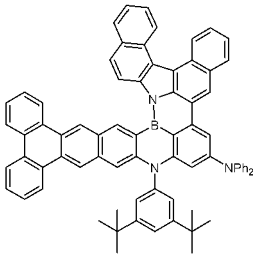
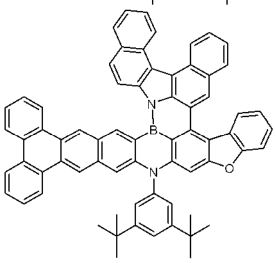
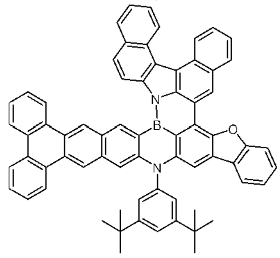
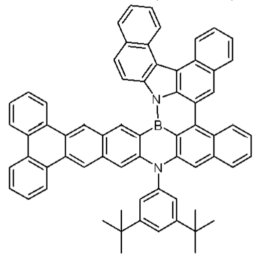

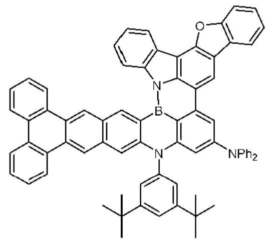
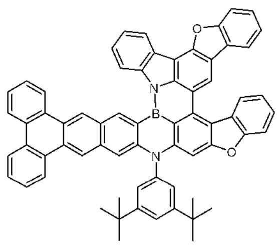
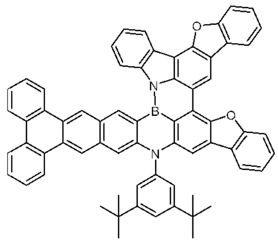
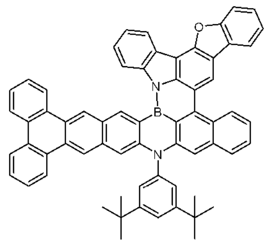

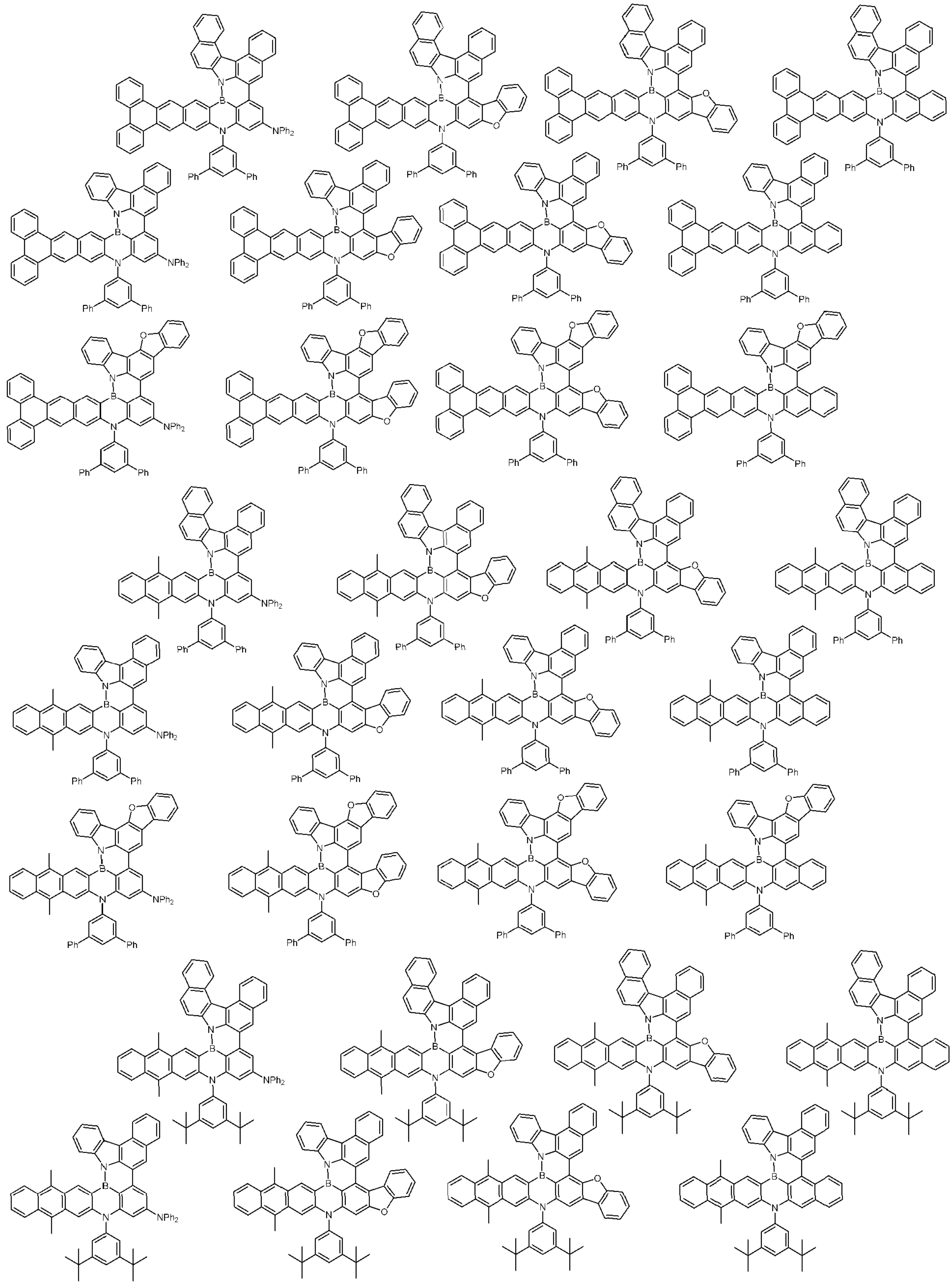

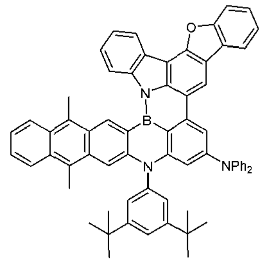 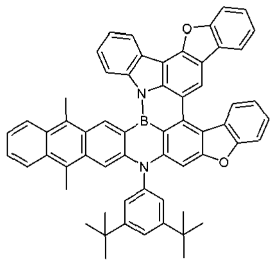 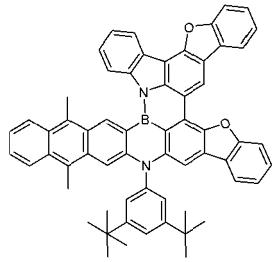 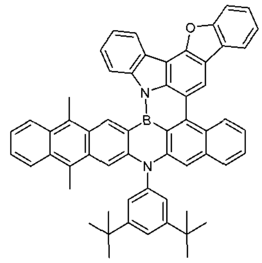

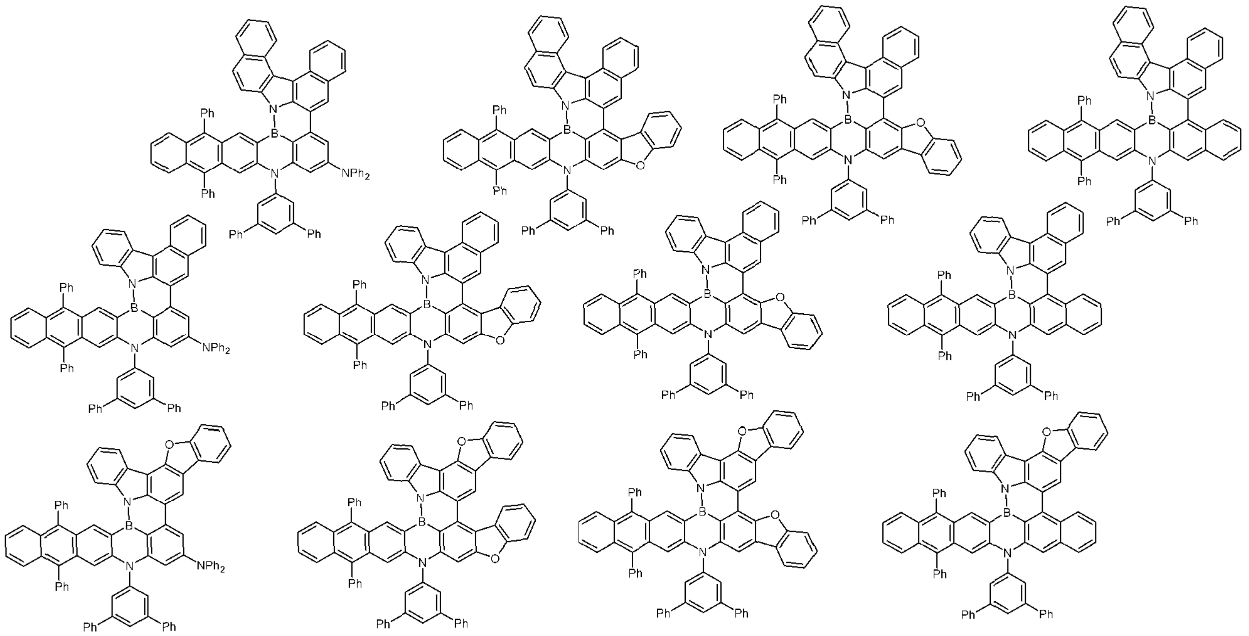

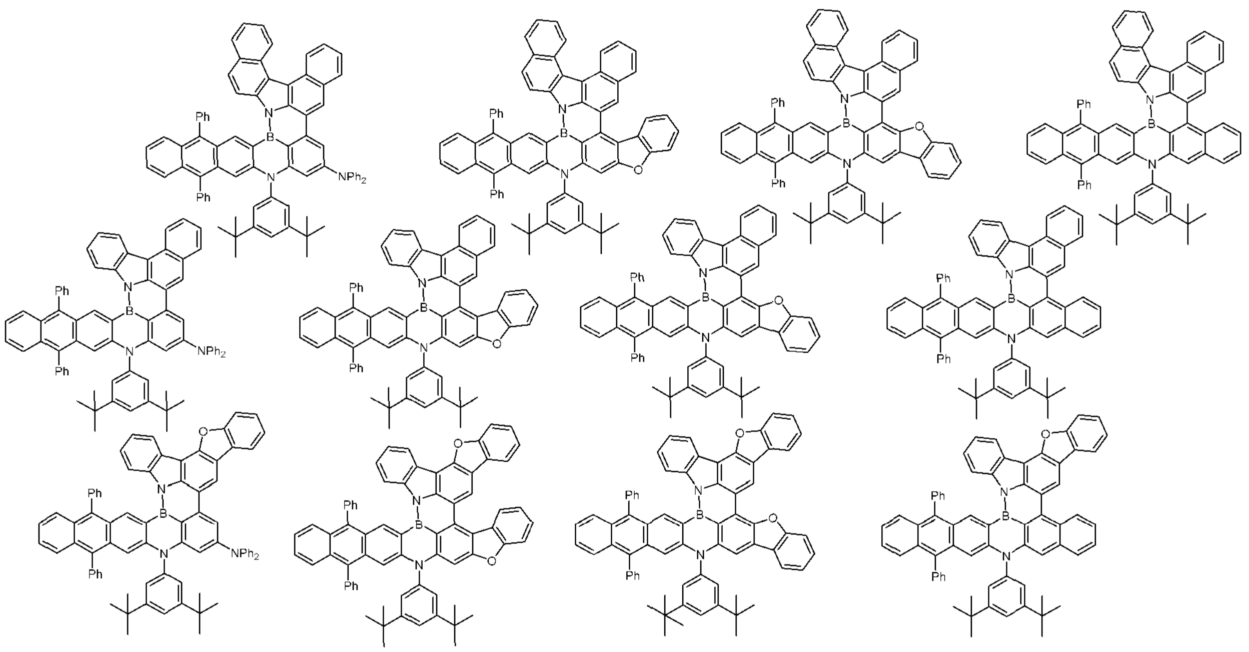

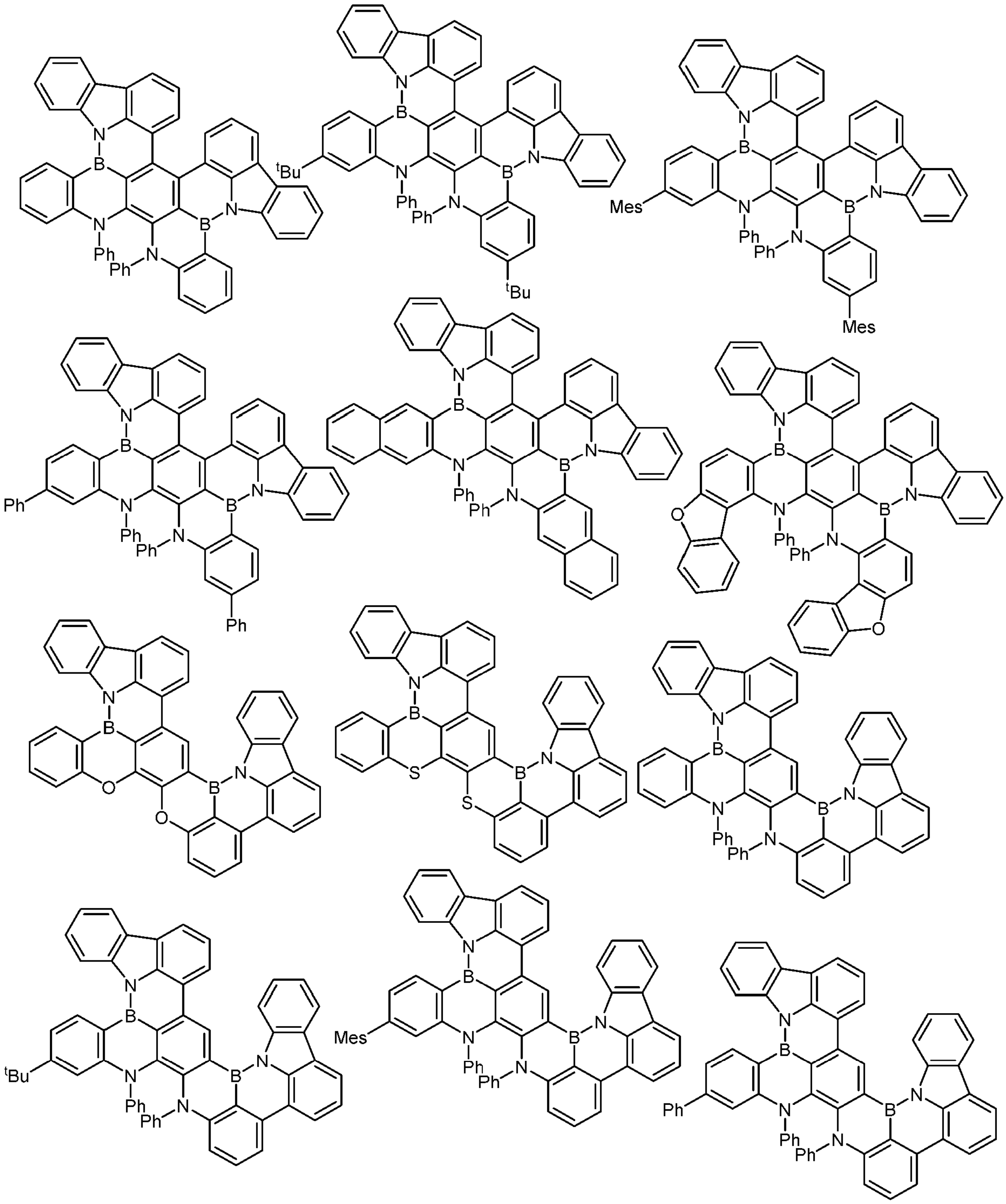

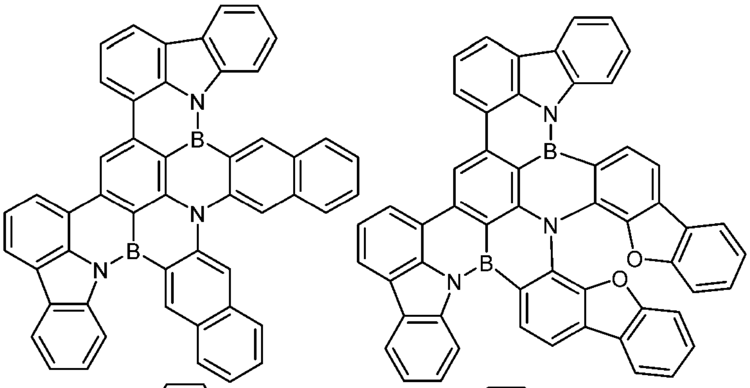

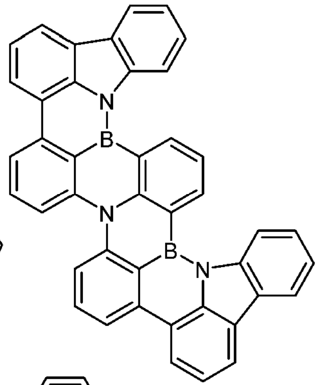

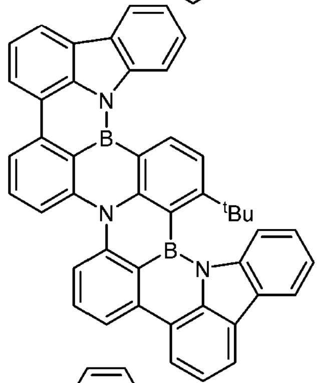

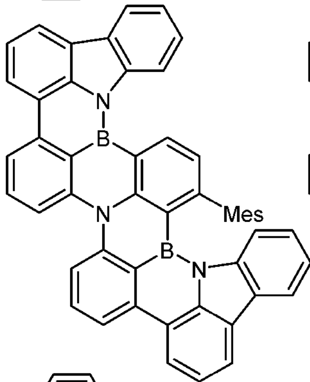

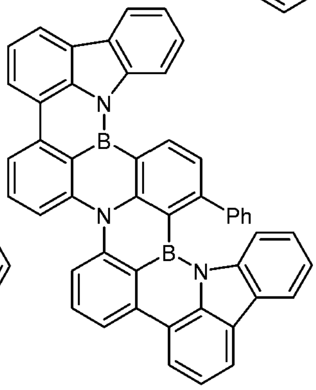

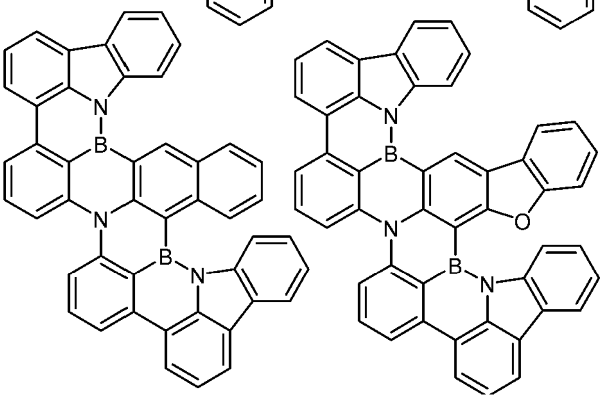

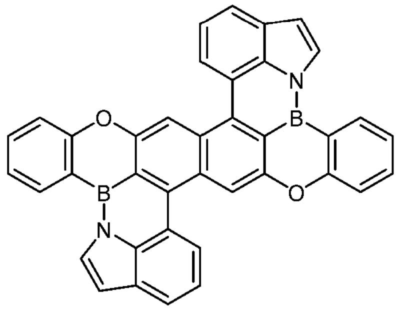

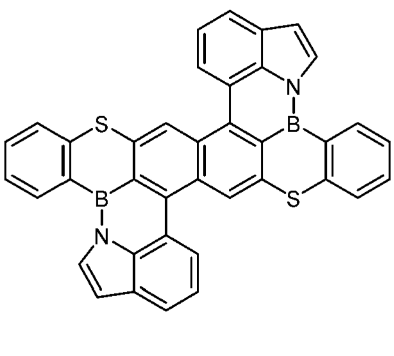

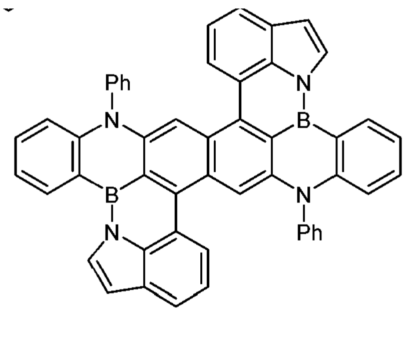

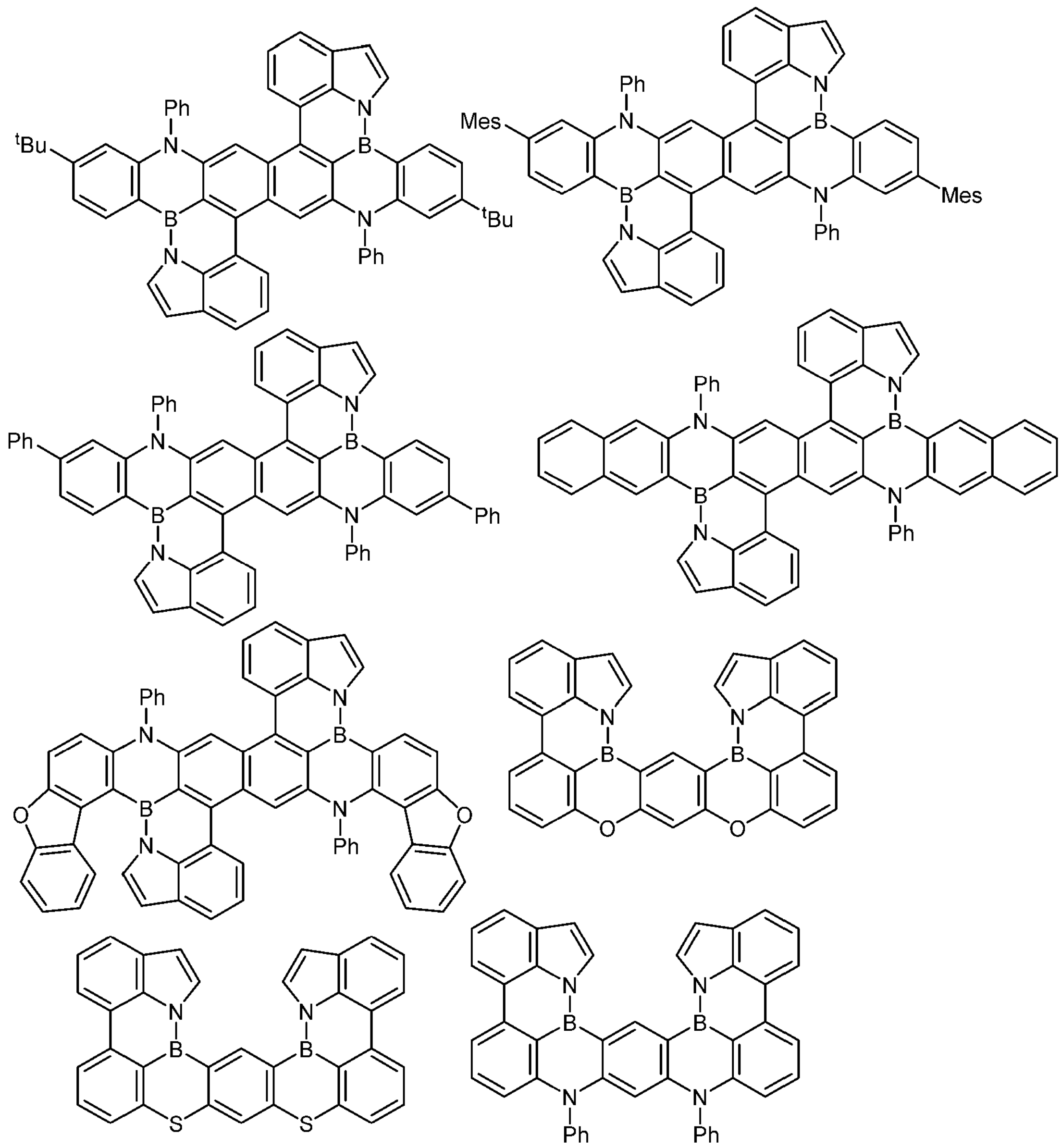

The synthesis of small FWHM emitters $S^B$ comprising or consisting of a structure according to formula BNE-1 can be accomplished via standard reactions and reaction conditions known to the skilled artisan.

Typically, the synthesis comprises transition-metal catalyzed cross coupling reactions and a borylation reaction, all of which are known to the skilled artisan.

For example, WO2020135953 (A1) teaches how to synthesize small FWHM emitters $S^B$ comprising or consisting of a structure according to formula BNE-1. Furthermore, US2018047912 (A1) teaches how to synthesize small FWHM emitters $S^B$ comprising or consisting of a structure according to formula BNE-1, in particular with c and d being 0.

It is understood that the emitters disclosed in US2018047912 (A1) and WO2020135953 (A1) may also be used as small FWHM emitters $S^B$ in the context of the present invention.

In one embodiment of the invention, in at least one, preferably each, light-emitting layer B, at least one, preferably each, small FWHM emitter $S^B$ comprises or consists of a structure according to either formula DABNA-I or formula BNE-1. The person skilled in the art understands this to mean that if more than one small FWHM emitters $S^B$ are present in a light-emitting layer B, they may all comprise or consist of a structure according to formula DABNA-I or all comprise or consist of a structure according to formula BNE-1 or some may comprise or consist of a structure according to formula DABNA-I, while others comprise or consist of a structure according to formula BNE-1.

One approach to design fluorescent emitters relies on the use of fluorescent polycyclic aromatic or heteroaromatic core structures. The latter are, in the context of the present invention, any structures comprising more than one aromatic or heteroaromatic ring, preferably more than two such rings, which are, even more preferably, fused to each other or linked via more than one direct bond or linking atom. In other words, the fluorescent core structures comprise at least

one, preferably only one, rigid conjugated π-system.

The skilled artisan knows how to select a core structure for a fluorescent emitter, for example from US2017077418 (A1). Examples of common core structures of fluorescent emitters are listed below, wherein this does not imply that only these cores may provide small FWHM emitters $S^B$ suitable for the use according to the present invention:

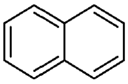 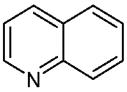 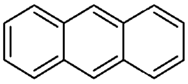 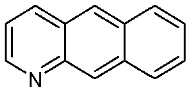 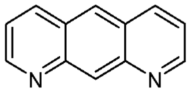

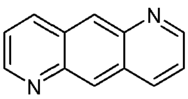 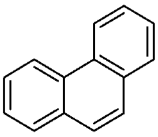 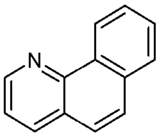 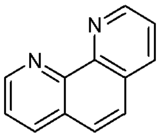 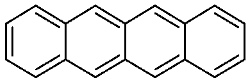

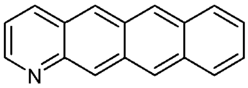 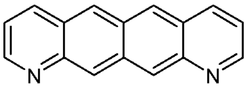 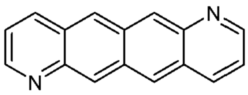 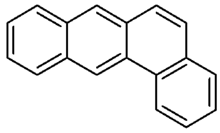

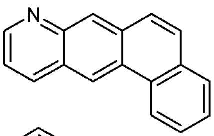 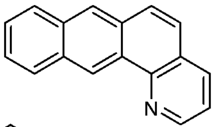 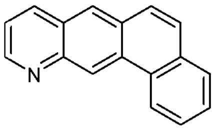 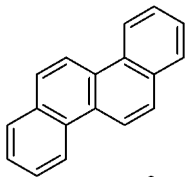

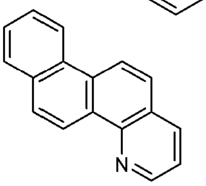 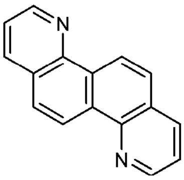 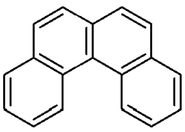 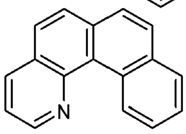 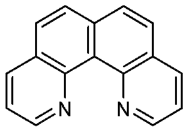

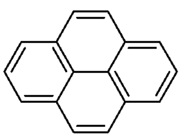 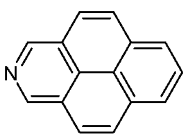 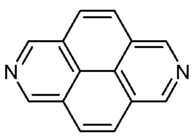 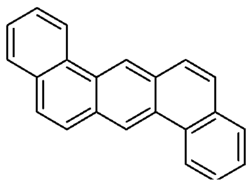

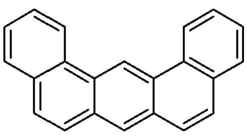 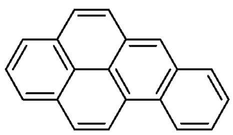 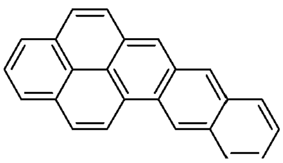 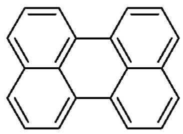

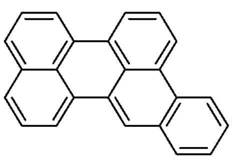 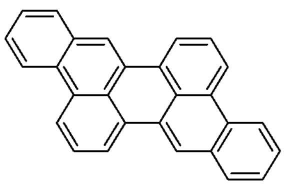 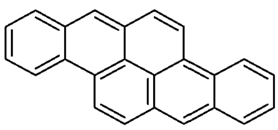 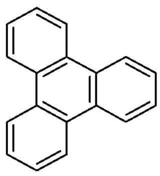

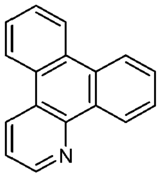
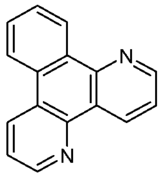
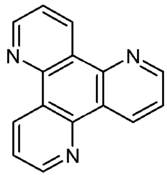
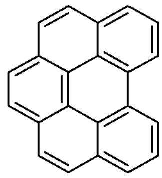
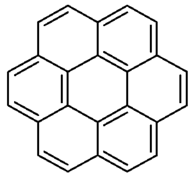

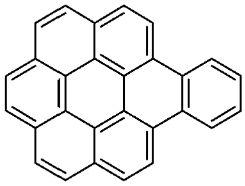
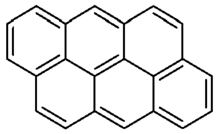
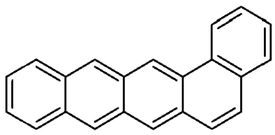
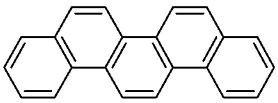

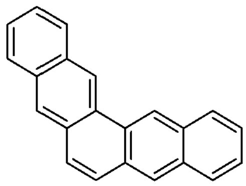
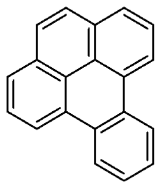
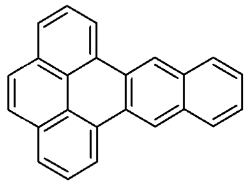
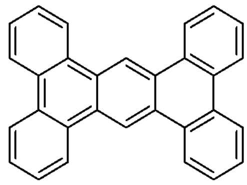

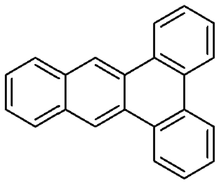
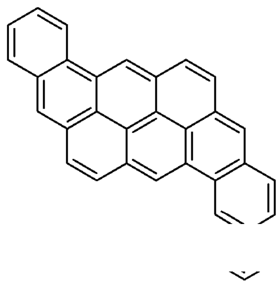
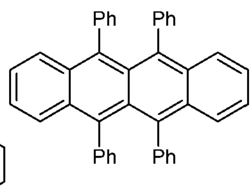
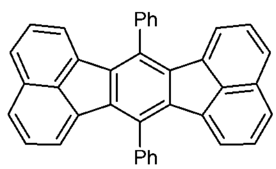

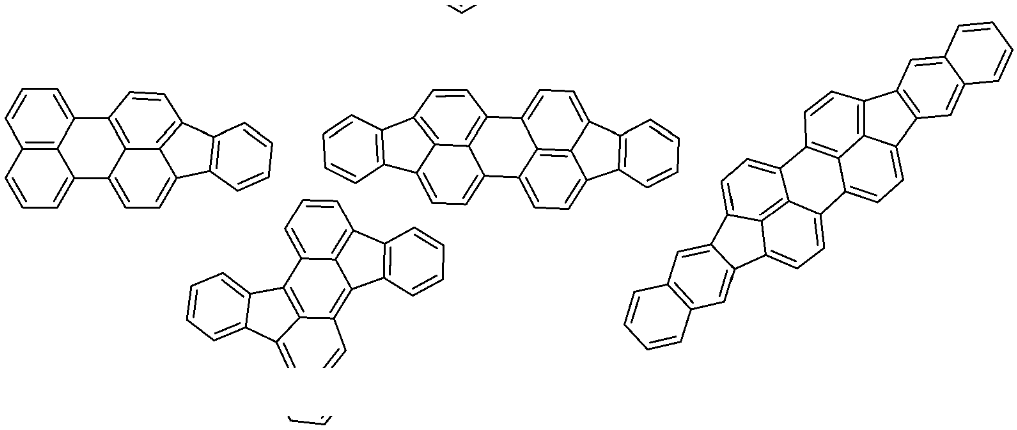

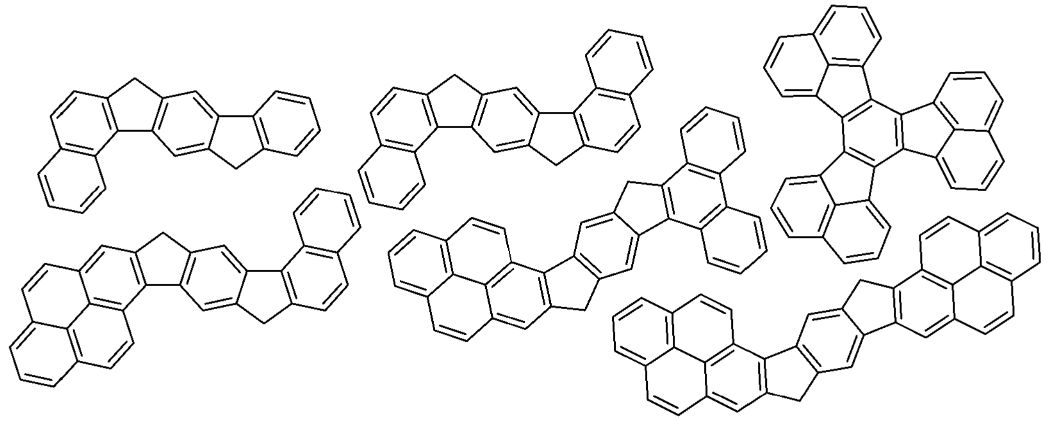

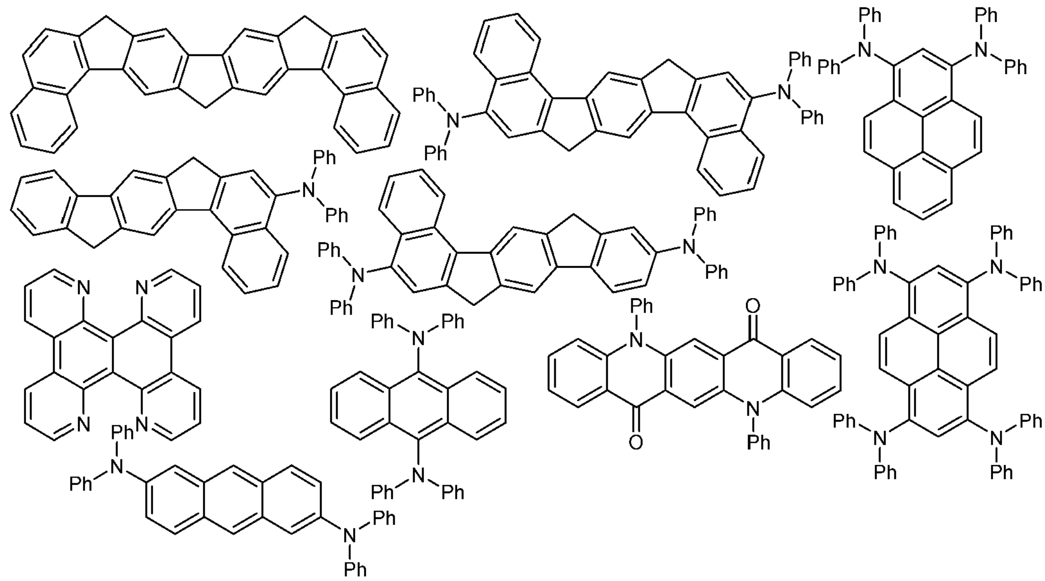

The term fluorescent core structure in this context indicates that any molecule comprising the core may potentially be used as fluorescent emitter. The person skilled in the art knows that the core structure of such a fluorescent emitter may be optionally substituted and which substituents are suitable in this regard, for example from: US2017077418 (A1), M. Zhu. C. Yang, Chemical Society Reviews 2013, 42, 4963, DOI: 10.1039/c3cs35440g; S. Kima, B. Kimb, J. Leea, H. Shina,Y.-Il Parkb, J. Park, Materials Science and Engineering R: Reports 2016, 99, 1, DOI: 10.1016/j.mser.2015.11.001; K.R.J. Thomas, N. Kapoor, M.N.K.P. Bolisetty, J.-H. Jou, Y.-L. Chen, Y.-C. Jou, The Journal of Organic Chemistry 2012, 77(8), 3921, DOI: 10.1021/jo300285v; M. Vanga, R.A. Lalancette, F. Jäkle, Chemistry - A European Journal 2019, 25(43), 10133, DOI: 10.1002/chem.201901231.

Small FWHM emitters $S^B$ for use according to the present invention may be obtained from the aforementioned fluorescent core structures, for example, by attaching sterically demanding substituents to the core that hinder the contact between the fluorescent core and adjacent molecules in the respective layer of an organic electroluminescent device.

In the context of the present invention, a compound, for example a fluorescent emitter is considered to be sterically shielded, when a subsequently defined shielding parameter is equal to or below a certain limit which is also defined in a later subchapter of this text.

It is preferred that the substituents used to sterically shield a fluorescent emitter are not just bulky (i.e. sterically demanding), but also electronically inert, which in the context of the present invention means, that these substituents do not comprise an active atom as defined in a later subchapter of this text. It is understood that this does not imply that only electronically inert (in other words: not active) substituents may be attached to a fluorescent core structure such as the ones shown above. Active substituents may also be attached to the core structure and may be introduced on purpose to tune the photophysical properties of a fluorescent core structure. In this case, it is preferred, that the active atoms introduced via one or more substituents are again shielded by electronically inert (i.e. not active) substituents.

Based on the aforementioned information and common knowledge from the state of the art, the skilled artisan understands how to choose substituents for a fluorescent core structure that may induce steric shielding of the latter and that are electronically inert as stated above. In particular, US2017077418 (A1) discloses substituents suitable as electronically inert (in other words: not active) shielding substituents. Examples of such substituents include linear, branched or cyclic alkyl groups with 3 to 40 carbon atoms, preferably 3 to 20 carbon atoms, more preferably with 4 to 10 carbon atoms, wherein one or more hydrogen atoms may be replaced by a substituent, preferably by deuterium or fluorine. Other examples include alkoxy groups with 3 to 40 carbon atoms, preferably 3 to 20 carbon atoms, more preferably with 4 to 10 carbon atoms, wherein one or more hydrogen atoms may be replaced by a substituent, preferably by deuterium or fluorine. It is understood that these alkyl and alkoxy substituents may be substituted by substituents other than deuterium and fluorine, for example by aryl groups. In this case, it is preferred that the aryl group as substituent comprises 6 to 30 aromatic ring atoms, more preferably 6 to 18 aromatic ring atoms, most preferably 6 aromatic ring atoms, and is preferably not a fused aromatic system such as anthracene, pyrene and the like. Other examples include aryl groups with 6 to 30 aromatic ring atoms, more preferably with 6 to 24 aromatic ring atoms. One or more hydrogen atom in these aryl substituents may be substituted and preferred substituents are for example aryl groups with 6 to 30 carbon atoms and linear, branched or cyclic alkyl groups with 1 to 20 carbon atoms. All substituents may be further substituted. It is understood that all sterically demanding and preferably also electronically inert (in other words: not active) substituents disclosed in US2017077418 (A1) may serve to sterically shield a fluorescent core (such as those described above) to

afford sterically shielded fluorescent emitters suitable as small FWHM emitters $S^B$ for use according to the present invention.

Below, non-limiting examples of substituents are shown that may be used as sterically demanding (i.e. shielding) and electronically inert (i.e. not active) substituents in the context of the present invention (disclosed in US2017077418 (A1)):

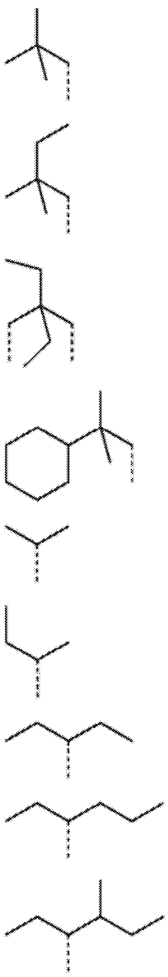

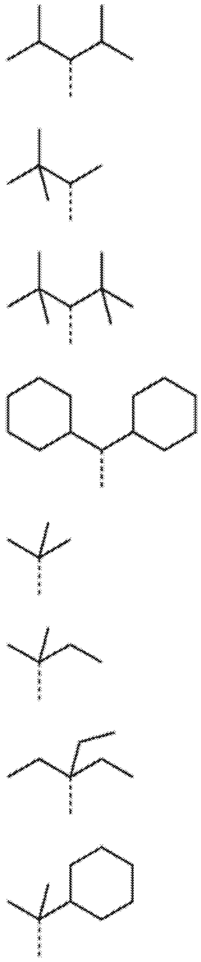

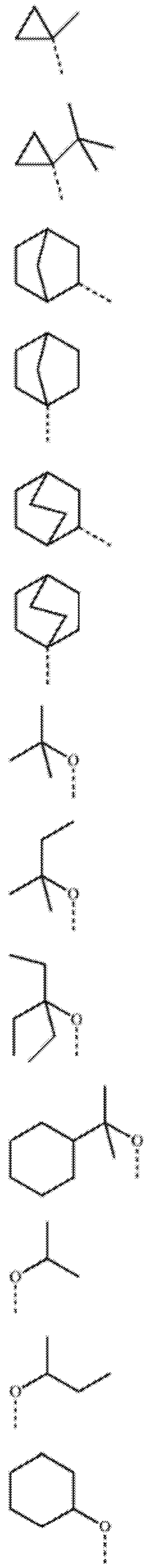

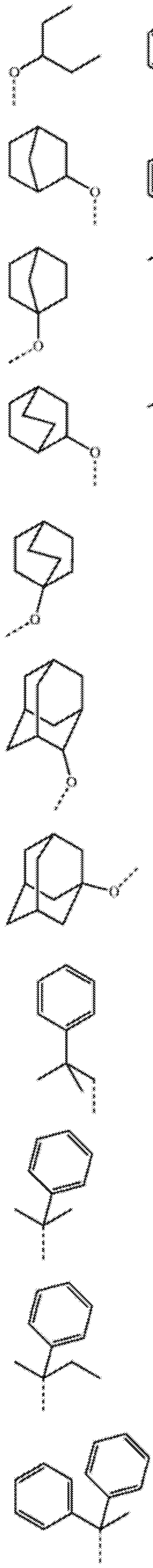

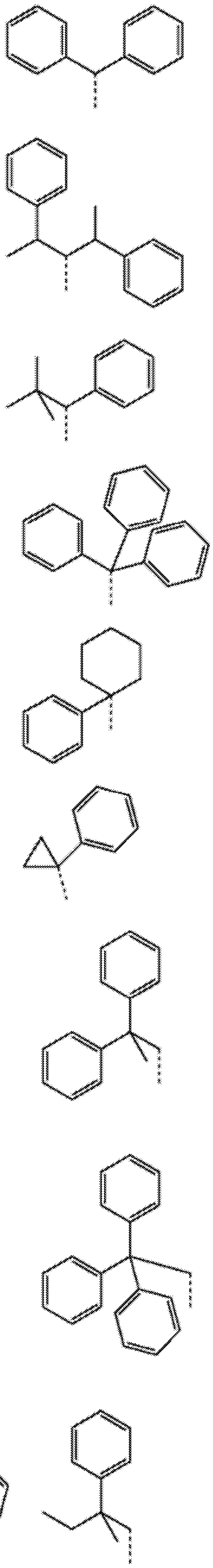

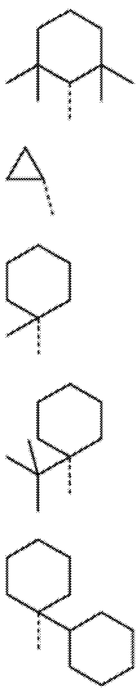

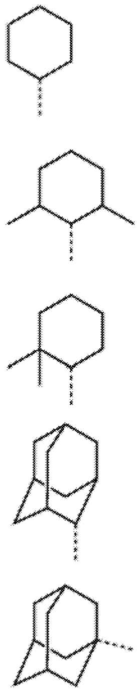

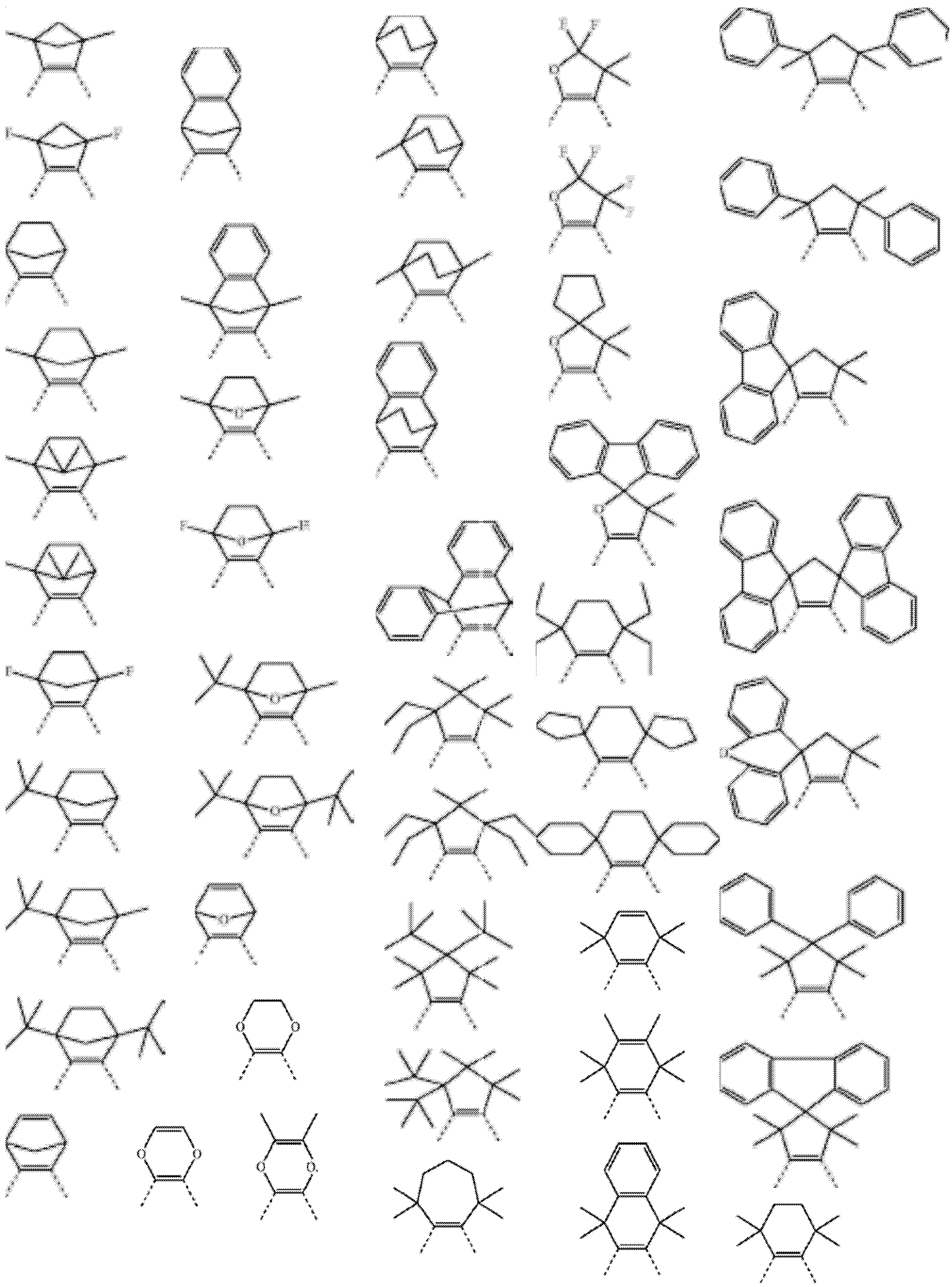

, wherein each dashed line represents a single bond connecting the respective substituent to a core structure, preferably to a fluorescent core structure. As known to the skilled artisan, trialkylsilyl groups are also suitable for use as sterically demanding and electronically inert substituents.

It is also understood that a fluorescent core may not just bear such sterically shielding substituents, but may also be substituted by further, non-shielding substituents that may or may not be active groups in the context of the present invention (see below for a definition).

Below, examples of sterically shielded fluorescent emitters are shown that may be used as small FWHM emitters $S^B$ in the context of the present invention. This does not imply that the present invention is limited to organic electroluminescent devices comprising the shown emitters.

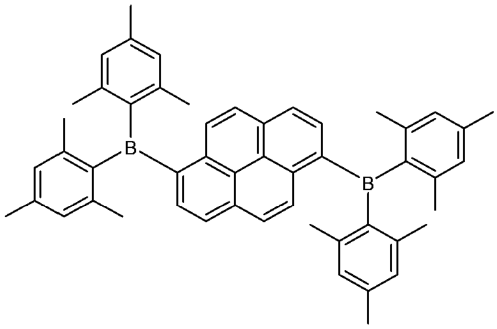 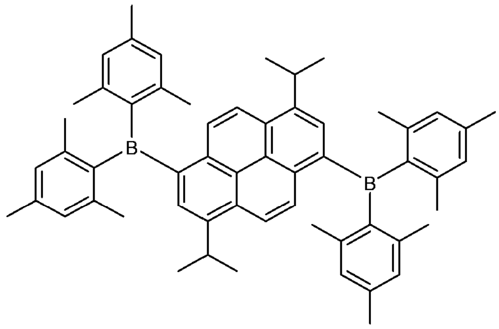

It is understood that sterically shielding substituents (that may or may not be electronically inert as stated above) may be attached to any fluorescent molecules, for example to the aforementioned polycyclic aromatic or heteroaromatic fluorescent cores, the BODIPY-derived structures and the NRCT emitters shown herein and to emitters comprising a structure of formula BNE-1. This may result in sterically shielded fluorescent emitters that may be suitable as small FWHM emitters $S^B$ according to the invention.

In one embodiment of the invention, within the light-emitting layer B, the small FWHM emitter $S^B$ fulfills at least one of the following requirements:

(i) it is a boron (B)-containing emitter, which means that at least one atom within each small FWHM emitter $S^B$ is boron (B); and/or
(ii) it comprises a polycyclic aromatic or heteroaromatic core structure, wherein at least two aromatic rings are fused together (e.g. anthracene, pyrene or aza-derivatives thereof).

In one embodiment of the invention, the small FWHM emitter $S^B$ is a boron (B)-containing emitter, which means that at least one atom within each small FWHM emitter $S^B$ is boron (B).

In one embodiment of the invention, the small FWHM emitter $S^B$ comprises a polycyclic aromatic or heteroaromatic core structure, wherein at least two aromatic rings are fused together (e.g. anthracene, pyrene or aza-derivatives thereof).

In one embodiment of the invention, within the light-emitting layer B, the small FWHM emitter $S^B$ fulfills at least one (or both) of the following requirements:

(i) it is a boron (B)-containing emitter, which means that at least one atom within each small FWHM emitter $S^B$ is boron (B); and/or
(ii) it comprises a pyrene core structure.

In one embodiment of the invention, the small FWHM emitter $S^B$ comprises a pyrene core structure.

In a preferred embodiment of the invention, in the light-emitting layer B, the small FWHM emitter $S^B$ is a boron (B)- and nitrogen (N)-containing emitter, which means that at least one atom within each small FWHM emitter $S^B$ is boron (B) and at least one atom within each small FWHM emitter $S^B$ is nitrogen (N).

In a preferred embodiment of the invention, in the light-emitting layer B, the small FWHM emitter $S^B$ comprises at least one boron atom (B)- that is (directly) covalently bonded to at least one nitrogen atom (N).

In a preferred embodiment of the invention, in the light-emitting layer B, the small FWHM emitter $S^B$ comprises a boron atom (B) that is trivalent, i.e. bonded via three single bonds.

*Steric Shielding*

Determination of the shielding parameter A

The shielding parameter A of a molecule can be determined as exemplarily described in the following for (fluorescent) emitters, such as those mentioned above. It will be understood that the shielding parameter A typically refers to the unit Angstrom ($Å^2$). This does not imply that only such compounds may be sterically shielded in the context of the present invention, nor that a shielding parameter can only be determined for such compounds.

1. Determination of the energy levels of the molecular orbitals

The energy levels of the molecular orbitals may be determined via quantum chemical calculations. For this purpose, in the present case, the Turbomole software package (Turbomole GmbH), version 7.2, may be used. First, a geometry optimization of the ground state of the molecule may be performed using density functional theory (DFT), employing the def2-SV(P) basis set and the BP-86 functional. Subsequently, on the basis of the optimized geometry, a single-point energy calculation for the electronic ground state may be performed employing the B3-LYP functional. From the energy calculation, the highest occupied molecular orbital (HOMO), for example, may be obtained as the highest-energy orbital occupied by two electrons, and the lowest unoccupied molecular orbital (LUMO) as the lowest-energy unoccupied orbital. The energy levels may be obtained in an analogous manner for the other molecular orbitals such as HOMO-1, HOMO-2, ... LUMO+1, LUMO+2 etc.

The method described herein is independent of the software package used. Examples of other frequently utilized programs for this purpose may be "Gaussian09" (Gaussian Inc.) and Q-Chem 4.1 (Q-Chem, Inc.).

2. Charge-exchanging molecular orbitals of the (fluorescent) compound

Charge-exchanging molecular orbitals of the (fluorescent) compound may be considered to be the HOMO and LUMO, and all molecular orbitals that may be separated in energy by 75 meV or less from the HOMO or LUMO.

3. Determination of the active atoms of a molecular orbital

For each charge-exchanging molecular orbital, a determination of which atoms may be active may be conducted. In other words, a generally different set of active atoms may be found for each molecular orbital. There follows a description of how the active atoms of the HOMO may be determined. For all other charge-exchanging molecular orbitals (e.g. HOMO-1, LUMO, LUMO+1, etc.), the active atoms may be determined analogously.

The HOMO may be calculated as described above. To determine the active atoms, the surface on which the orbital has an absolute value of 0.035 ("isosurface with cutoff 0.035") is inspected. For this purpose, in the present case, the Jmol software (http://jmol.sourceforge.net/), version 14.6.4, is used. Atoms around which orbital lobes with values equal to or larger than the cutoff value may be localized may be considered active. Atoms around which no orbital lobes with values equal to or larger than the cutoff value may be localized may be considered inactive.

4. Determination of the active atoms in the (fluorescent) compound

If one atom is active in at least one charge-exchanging molecular orbital, it may be considered to be active in respect of the (fluorescent) compound. Only atoms that may be inactive (non-active) in all charge-exchanging molecular orbitals may be inactive in respect of the (fluorescent) compound.

5. Determination of the shielding parameter A

In a first step, the solvent accessible surface area SASA may be determined for all active atoms according to the method described in B. Lee, F.M. Richards, Journal of Molecular Biology 1971, 55(3), 379, DOI: 10.1016/0022-2836(71) 90324-X. For this purpose, the van-der-Waals surface of the atoms of a molecule may be considered to be impenetrable. The SASA of the entire molecule may be then defined as the area of the surface which may be traced by the center of a hard sphere (also called probe) with radius r (the so-called probe radius) while it may be rolled over all accessible points in space at which its surface may be in direct contact with the van-der-Waals surface of the molecule. The SASA value can also be determined for a subset of the atoms of a molecule. In that case, only the surface traced by the center of the probe at points where the surface of the probe may be in contact with the van-der-Waals surface of the atoms that may be part of the subset may be considered. The Lee-Richards algorithm used to determine the SASA for the present purpose may be part of the program package Free SASA (S. Mitternacht, Free SASA: An open source C library for solvent accessible surface area calculations. F1000Res. 2016; 5:189. Published 2016 Feb 18. doi:10.12688/f1000research.7931.1). The van-der-Waals radii $r_{VDW}$ of the relevant elements may be compiled in the following reference: M. Mantina, A.C. Chamberlin, R. Valero, C.J. Cramer, D.G. Truhlar, The Journal of Physical Chemistry A 2009, 113(19), 5806, DOI: 10.1021/jp8111556. The probe radius r may be set to be 4 Å (r = 4 Å) for all SASA determinations for the present purpose.

In the context of the present invention, the shielding parameter A may be obtained by dividing the solvent accessible surface area of the subset of active atoms (labeled S to distinguish from the SASA of the entire molecule) by the number n of active atoms:

$$A = S/n$$

In the context of the present invention, a compound may be defined as sterically well-shielded if the shielding parameter A has a value below 2 Å$^2$ (A < 2.0 Å$^2$).

In the context of the present invention, a compound may be defined as sterically shielded if the shielding parameter A has a value of 1.0 to 5.0 Å$^2$ (1.0 Å$^2$ ≤ A ≤ 5.0 Å$^2$), preferably 2.0 Å$^2$ to 5.0 Å$^2$ (2.0 Å$^2$ ≤ A ≤ 5.0 Å$^2$).

Below, exemplary (fluorescent) emitters are shown, alongside their shielding parameters A, which were determined as stated above. It will be understood that this does not imply that the present invention is limited to organic electroluminescent devices comprising one of the shown emitters. The depicted emitter compounds are merely non-limiting examples that represent optional embodiments of the invention.

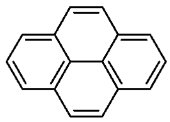

shielding parameter A = 15.5 Å$^2$

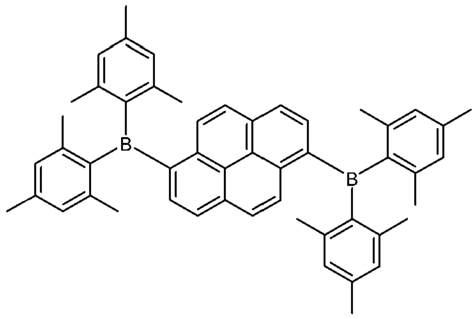

shielding parameter A = 2.3 Å$^2$

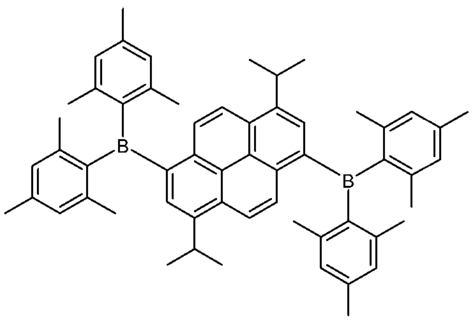

shielding parameter A = 1.7 Å$^2$

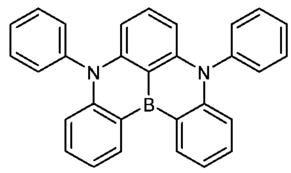

shielding parameter A = 9.3 Å$^2$

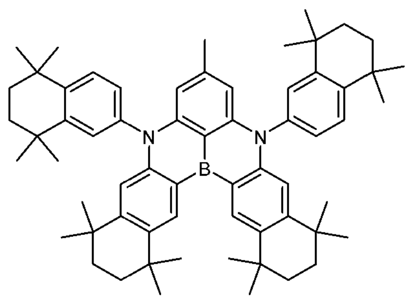

shielding parameter A = 0.1 Å$^2$

In one embodiment of the invention, each small FWHM emitter $S^B$ comprised in an organic electroluminescent device according to the invention exhibits a shielding parameter A equal to or smaller than 5.0 Å$^2$.

In one embodiment, in at least one, preferably each, light-emitting layer B of the organic electroluminescent device according to the present invention, at least one, preferably each, small FWHM emitter $S^B$ exhibits a shielding parameter A equal to or smaller than 5.0 Å$^2$.

In a preferred embodiment of the invention, each small FWHM emitter $S^B$ comprised in an organic electroluminescent device according to the invention exhibits a shielding parameter A equal to or smaller than 2.0 Å$^2$.

In one embodiment, in at least one, preferably each, light-emitting layer B of the organic electroluminescent

device according to the present invention, at least one, preferably each, small FWHM emitter $S^B$ exhibits a shielding parameter A equal to or smaller than 2.0 Å$^2$.

The person skilled in the art understands that not only a fluorescent emitter such as a small FWHM emitter $S^B$ according to the present invention may be sterically shielded by attaching shielding substituents. It is understood that for example also a TADF material $E^B$ in the context of the present invention and also a phosphorescence material $P^B$ in the context of the present invention may be shielded.

*Excited state lifetimes*

A detailed description on how the excited state lifetimes are measured is provided in a following subchapter of this text.

In one embodiment of the invention, in the light-emitting layer B, at least one, preferably each, TADF material $E^B$ in the context of the present invention exhibits a delayed fluorescence lifetime $\bar{\tau}(E^B)$ equal to or shorter than 110 μs, preferably equal to or shorter than 100 μs. In one embodiment of the invention, each TADF material $E^B$ in the context of the present invention exhibits a delayed fluorescence lifetime $\bar{\tau}(E^B)$ equal to or shorter than 110 μs, preferably equal to or shorter than 100 μs.

In one embodiment of the invention, in the light-emitting layer B, at least one, preferably each, TADF material $E^B$ in the context of the present invention exhibits a delayed fluorescence lifetime $\bar{\tau}(E^B)$ equal to or shorter than 75 μs. In one embodiment of the invention, each TADF material $E^B$ in the context of the present invention exhibits a delayed fluorescence lifetime $\bar{\tau}(E^B)$ equal to or shorter than 75 μs.

In one embodiment of the invention, in the light-emitting layer B, at least one, preferably each, TADF material $E^B$ in the context of the present invention exhibits an a delayed fluorescence lifetime $\bar{\tau}(E^B)$ equal to or shorter than 50 μs. In one embodiment of the invention, each TADF material $E^B$ exhibits a delayed fluorescence lifetime $\bar{\tau}(E^B)$ equal to or shorter than 50 μs.

In a preferred embodiment of the invention, in the light-emitting layer B, at least one, preferably each, TADF material $E^B$ in the context of the present invention exhibits a delayed fluorescence lifetime $\bar{\tau}(E^B)$ equal to or shorter than 10 μs. In one embodiment of the invention, each TADF material $E^B$ exhibits a delayed fluorescence lifetime $\bar{\tau}(E^B)$ equal to or shorter than 10 μs.

In an even more preferred embodiment of the invention, in the light-emitting layer B, at least one, preferably each, TADF material $E^B$ in the context of the present invention exhibits a delayed fluorescence lifetime $\bar{\tau}(E^B)$ equal to or shorter than 5 μs. In one embodiment of the invention each TADF material $E^B$ exhibits a delayed fluorescence lifetime $\bar{\tau}(E^B)$ equal to or shorter than 5 μs.

In one embodiment of the invention, in the light-emitting layer B, the phosphorescence material $P^B$ in the context of the present invention exhibits an excited state lifetime $\bar{\tau}(P^B)$ equal to or shorter than 50 μs. In one embodiment of the invention, each phosphorescence material $P^B$ exhibits an excited state lifetime $\bar{\tau}(P^B)$ equal to or shorter than 50 μs.

In a preferred embodiment of the invention, in the light-emitting layer B, the phosphorescence material $P^B$ in the context of the present invention exhibits an excited state lifetime $\bar{\tau}(P^B)$ equal to or shorter than 10 μs. In one embodiment of the invention, each phosphorescence material $P^B$ exhibits an excited state lifetime $\bar{\tau}(P^B)$ equal to or shorter than 10 μs.

In an even more preferred embodiment of the invention, in the light-emitting layer B, the phosphorescence material $P^B$ in the context of the present invention exhibits an excited state lifetime $\bar{\tau}(P^B)$ equal to or shorter than 5 μs. In one embodiment of the invention, the phosphorescence material $P^B$ exhibits an excited state lifetime $\bar{\tau}(P^B)$ equal to or shorter than 5 μs.

In one embodiment of the invention, in an organic electroluminescent device according to the invention, the addition of one or more TADF materials $E^B$ into the light-emitting layer B comprising a phosphorescence material $P^B$, a small FWHM emitters $S^B$ and a host material $H^B$, results in a decreased excited state lifetime of the organic electroluminescent device. In a preferred embodiment of the invention, the aforementioned addition of a TADF material $E^B$ according to the invention decreases the excited state lifetime of the organic electroluminescent device by at least 50%.

*Further definitions and information*

As used throughout, the term "layer" in the context of the present invention preferably refers to a body that bears an extensively planar geometry. It is understood that the same is true for all "sublayers" which a layer may compose.

As used herein, the terms organic electroluminescent device and optoelectronic device and organic light-emitting device may be understood in the broadest sense as any device comprising one or more light-emitting layers B, each as a whole comprising one or more TADF materials, one or more excitation energy transfer components EET-2, one or more small FWHM emitters $S^B$, and optionally one or more host materials $H^B$, for all of which the above-mentioned definitions and preferred embodiments may apply.

In a preferred embodiment of the invention, the organic electroluminescent device emits green light from 510 to

550 nm. In a preferred embodiment of the invention, the organic electroluminescent device has a main emission peak in the range of from 510 to 550 nm. In a preferred embodiment of the invention, the organic electroluminescent device has an emission maximum of the main emission peak in the range of from 510 to 550 nm.

In a particularly preferred embodiment of the invention, the organic electroluminescent device emits green light from 515 to 540 nm. In a particularly preferred embodiment of the invention, the organic electroluminescent device has a main emission peak in the range of from 515 to 540 nm. In a particularly preferred embodiment of the invention, the organic electroluminescent device has an emission maximum of the main emission peak in the range of from 515 to 540 nm.

In a preferred embodiment of the invention, the organic electroluminescent device is a device selected from the group consisting of an organic light-emitting diode (OLED), a light-emitting electrochemical cell (LEC), and a light-emitting transistor.

Particularly preferably, the organic electroluminescent device is an organic light-emitting diode (OLED). Optionally, the organic electroluminescent device as a whole may be intransparent (non-transparent), semi-transparent or (essentially) transparent.

As used throughout the present application, the term "cyclic group" may be understood in the broadest sense as any mono-, bi- or polycyclic moieties.

As used throughout the present application, the terms "ring" and "ring system" may be understood in the broadest sense as any mono-, bi- or polycyclic moieties.

The term "ring atom" refers to any atom which is part of the cyclic core of a ring or a ring structure, and not part of a substituent optionally attached to it.

As used throughout the present application, the term "carbocycle" may be understood in the broadest sense as any cyclic group in which the cyclic core structure comprises only carbon atoms that may of course be substituted with hydrogen or any other substituents defined in the specific embodiments of the invention. It is understood that the term "carbocyclic" as adjective refers to cyclic groups in which the cyclic core structure comprises only carbon atoms that may of course be substituted with hydrogen or any other substituents defined in the specific embodiments of the invention. It is understood that the term "carbocycle" or a "carbocyclic ring system" may refer to both, an aliphatic and an aromatic cyclic group or ring system.

As used throughout the present application, the term "heterocycle" may be understood in the broadest sense as any cyclic group in which the cyclic core structure comprises not just carbon atoms, but also at least one heteroatom. It is understood that the term "heterocyclic" as adjective refers to cyclic groups in which the cyclic core structure comprises not just carbon atoms, but also at least one heteroatom. The heteroatoms may, unless stated otherwise in specific embodiments, at each occurrence be the same or different and be individually selected from the group consisting of N, O, S, and Se. All carbon atoms or heteroatoms comprised in a heterocycle in the context of the invention may of course be substituted with hydrogen or any other substituents defined in the specific embodiments of the invention. It is understood that the term "heterocycle" or a "heterocyclic ring system" may refer to both, an aliphatic and a heteroaromatic cyclic group or ring system.

As used throughout the present application, the term "aromatic ring system" may be understood in the broadest sense as any bi- or polycyclic aromatic moiety.

As used throughout the present application, the term "heteroaromatic ring system" may be understood in the broadest sense as any bi- or polycyclic heteroaromatic moiety.

As used throughout the present application, the term "fused" when referring to aromatic or heteroaromatic ring systems means that the aromatic or hetroaromatic rings that are "fused" share at least one bond that is part of both ring systems. For example naphthalene (or naphthyl when referred to as substituent) or benzothiophene (or benzothiophenyl when referred to as substituent) are considered fused aromatic ring systems in the context of the present invention, in which two benzene rings (for naphthalene) or a thiophene and a benzene (for benzothiophene) share one bond. It is also understood that sharing a bond in this context includes sharing the two atoms that build up the respective bond and that fused aromatic or heteroaromatic ring systems can be understood as one aromatic or heteroaromatic system. Additionally, it is understood, that more than one bond may be shared by the aromatic or heteroaromatic rings building up a fused aromatic or heteroaromatic ring system (e.g. in pyrene). Furthermore, it will be understood that aliphatic ring systems may also be fused and that this has the same meaning as for aromatic or heteroaromatic ring systems, with the exception of course, that fused aliphatic ring systems are not aromatic.

As used throughout the present application, the terms "aryl" and "aromatic" may be understood in the broadest sense as any mono-, bi- or polycyclic aromatic moieties. Herein, unless indicated differently in specific embodiments, an aryl group preferably contains 6 to 60 aromatic ring atoms, and a heteroaryl group preferably contains 5 to 60 aromatic ring atoms, of which at least one is a heteroatom. Notwithstanding, throughout the application the number of aromatic ring atoms (in particular of aromatic ring atoms that are carbon atoms) may be given as subscripted number in the definition of certain substituents. In particular, the heteroaromatic ring includes one to three heteroatoms. Again, the terms "heteroaryl" and "heteroaromatic" may be understood in the broadest sense as any mono-, bior polycyclic hetero-aromatic moieties that include at least one heteroatom. The heteroatoms may at each occurrence be the same or different and be individually

selected from the group consisting of N, O, S, and Se. Accordingly, the term "arylene" refers to a divalent substituent that bears two binding sites to other molecular structures and thereby serving as a linker structure. In case, a group in the exemplary embodiments is defined differently from the definitions given here, for example, the number of aromatic ring atoms or number of heteroatoms differs from the given definition, the definition in the exemplary embodiments is to be applied. According to the invention, a condensed (annulated) aromatic or heteroaromatic polycycle is built of two or more single aromatic or heteroaromatic cycles, which formed the polycycle via a condensation reaction.

In particular, as used throughout the present application the term "aryl group" or "heteroaryl group" comprises groups which can be bound via any position of the aromatic or heteroaromatic group, derived from benzene, naphthalene, anthracene, phenanthrene, pyrene, dihydropyrene, chrysene, perylene, fluoranthene, benzanthracene, benzphenanthrene, tetracene, pentacene, benzpyrene, furan, benzofuran, isobenzofuran, dibenzofuran, thiophene, benzothiophene, isobenzothiophene, dibenzothiophene; selenophene, benzoselenophene, isobenzoselenophene, dibenzoselenophene; pyrrole, indole, isoindole, carbazole, pyridine, quinoline, isoquinoline, acridine, phenanthridine, benzo-5,6-quinoline, benzo-6,7-quinoline, benzo-7,8-quinoline, phenothiazine, phenoxazine, pyrazole, indazole, imidazole, benzimidazole, naphthoimidazole, phenanthroimidazole, pyridoimidazole, pyrazinoimidazole, quinoxalinoimidazole, oxazole, benzoxazole, napthooxazole, anthroxazol, phenanthroxazol, isoxazole, 1,2-thiazole, 1,3-thiazole, benzothiazole, pyridazine, benzopyridazine, pyrimidine, benzopyrimidine, 1,3,5-triazine, quinoxaline, pyrazine, phenazine, naphthyridine, carboline, benzocarboline, phenanthroline, 1,2,3-triazole, 1,2,4-triazole, benzotriazole, 1,2,3-oxadiazole, 1,2,4-oxadiazole, 1,2,5-oxadiazole, 1,2,3,4-tetrazine, purine, pteridine, indolizine and benzothiadiazole or combinations of the abovementioned groups.

In certain embodiments of the invention, adjacent substituents bonded to an aromatic or heteroaromatic ring may together form an additional mono- or polycyclic aliphatic or aromatic or heteroaromatic, carbocyclic or heterocyclic ring system which is fused to the aromatic or heteroaromatic ring to which the substituents are bonded. It is understood that the optionally so formed fused ring system will be larger (meaning it comprises more ring atoms) than the aromatic or heteroaromatic ring to which the adjacent substituents are bonded. In these cases, the "total" amount of ring atoms comprised in the fused ring system is to be understood as the sum of ring atoms comprised in the aromatic or heteroaromatic ring to which the adjacent substituents are bonded and the ring atoms of the additional ring system formed by the adjacent substituents, wherein, however, the carbon atoms that are shared by the ring systems which are fused are counted once and not twice. For example, a benzene ring may have two adjacent substituents that form another benzene ring so that a naphthalene core is built. This naphthalene core then comprises 10 ring atoms as two carbon atoms are shared by the two benzene rings and thus only counted once and not twice. The term "adjacent substituents" in this context refers to substituents attached to the same or to neighboring ring atoms (e.g., of a ring system).

As used throughout the present application, the term "aliphatic" when referring to ring systems may be understood in the broadest sense and means that none of the rings that build up the ring system is an aromatic or heteroaromatic ring. It is understood that such an aliphatic ring system may be fused to one or more aromatic or heteroaromatic rings so that some (but not all) carbon- or heteroatoms comprised in the core structure of the aliphatic ring system are part of an attached aromatic or heteroaromatic ring.

As used above and herein, the term "alkyl group" may be understood in the broadest sense as any linear, branched, or cyclic alkyl substituent. In particular, the term alkyl comprises the substituents methyl (Me), ethyl (Et), n-propyl ($^{n}$Pr), i-propyl ($^{i}$Pr), cyclopropyl, n-butyl ($^{n}$Bu), i-butyl ($^{i}$Bu), s-butyl ($^{s}$Bu), t-butyl ($^{t}$Bu), cyclobutyl, 2-methylbutyl, n-pentyl, s-pentyl, t-pentyl, 2-pentyl, neo-pentyl, cyclopentyl, n-hexyl, s-hexyl, t-hexyl, 2-hexyl, 3-hexyl, neo-hexyl, cyclohexyl, 1-methylcyclopentyl, 2-methylpentyl, n-heptyl, 2-heptyl, 3-heptyl, 4-heptyl, cycloheptyl, 1-methylcyclohexyl, n-octyl, 2-ethylhexyl, cyclooctyl, 1-bicyclo[2,2,2]octyl, 2-bicyclo[2,2,2]-octyl, 2-(2,6-dimethyl)octyl, 3-(3,7-dimethyl)octyl, adamantyl, 2,2,2-trifluorethyl, 1,1-dimethyl-n-hex-1-yl, 1,1-dimethyl-n-hept-1-yl, 1,1-dimethyl-n-oct-1-yl, 1,1-dimethyl-n-dec-1-yl, 1,1-dimethyl-n-dodec-1-yl, 1,1-dimethyl-n-tetradec-1-yl, 1,1-dimethyl-n-hexadec-1-yl, 1,1-dimethyl-n-octadec-1-yl, 1,1-diethyl-n-hex-1-yl, 1,1-diethyl-n-hept-1-yl, 1,1-diethyl-n-oct-1-yl, 1,1-diethyl-n-dec-1-yl, 1,1-diethyl-n-dodec-1-yl, 1,1-diethyl-n-tetradec-1-yl, 1,1-diethyln-n-hexadec-1-yl, 1,1-diethyl-n-octadec-1-yl, 1-(n-propyl)-cyclohex-1-yl, 1-(n-butyl)-cyclohex-1-yl, 1-(n-hexyl)-cyclohex-1-yl, 1-(n-octyl)-cyclohex-1-yl and 1-(n-decyl)-cyclohex-1-yl.

As used above and herein, the term "alkenyl" comprises linear, branched, and cyclic alkenyl substituents. The term alkenyl group exemplarily comprises the substituents ethenyl, propenyl, butenyl, pentenyl, cyclopentenyl, hexenyl, cyclohexenyl, heptenyl, cycloheptenyl, octenyl, cyclooctenyl or cyclooctadienyl.

As used above and herein, the term "alkynyl" comprises linear, branched, and cyclic alkynyl substituents. The term alkynyl group exemplarily comprises ethynyl, propynyl, butynyl, pentynyl, hexynyl, heptynyl or octynyl.

As used above and herein, the term "alkoxy" comprises linear, branched, and cyclic alkoxy substituents. The term alkoxy group exemplarily comprises methoxy, ethoxy, n-propoxy, i-propoxy, n-butoxy, i-butoxy, s-butoxy, t-butoxy and 2-methylbutoxy.

As used above and herein, the term "thioalkoxy" comprises linear, branched, and cyclic thioalkoxy substituents, in which the O of the exemplarily alkoxy groups is replaced by S.

As used above and herein, the terms "halogen" and "halo" may be understood in the broadest sense as being

preferably fluorine, chlorine, bromine or iodine.

All hydrogen atoms (H) comprised in any structure referred to herein may at each occurrence independently of each other, and without this being indicated specifically, be replaced by deuterium (D). The replacement of hydrogen by deuterium is common practice and obvious for the person skilled in the art who also knows how to achieve this synthetically.

It is understood that when a molecular fragment is described as being a substituent or otherwise attached to another moiety, its name may be written as if it were a fragment (e.g. naphthyl, dibenzofuryl) or as if it were the whole molecule (e.g. naphthalene, dibenzofuran). As used herein, these different ways of designating a substituent or attached fragment are considered to be equivalent.

When referring to concentrations or compositions and unless stated otherwise, percentages refer to weight percentages, which has the same meaning as percent by weight or% by weight ((weight/weight), (w/w), wt.%).

Orbital and excited state energies can be determined either by means of experimental methods or by calculations employing quantum-chemical methods, in particular density functional theory calculations. Herein, the energy of the highest occupied molecular orbital $E^{HOMO}$ is determined by methods known to the person skilled in the art from cyclic voltammetry measurements with an accuracy of 0.1 eV.

The energy of the lowest unoccupied molecular orbital $E^{LUMO}$ may be determined by methods known to the person skilled in the art from cyclic voltammetry measurements with an accuracy of 0.1 eV. If $E^{LUMO}$ may be determined by cyclic voltammetry measurements, it will herein be denoted as $E_{CV}^{LUMO}$ . Alternatively, and herein preferably, $E^{LUMO}$ is calculated as $E^{HOMO}$ + $E^{gap}$, wherein the energy of the first excited singlet state S1 (vide infra) is used as $E^{gap}$, unless stated otherwise, for host materials $H^B$, TADF materials $E^B$, and small FWHM emitters $S^B$. This is to say that for host materials $H^B$, TADF materials $E^B$, and small FWHM emitters $S^B$, $E^{gap}$ is determined from the onset of the emission spectrum at room temperature (i.e. approx. 20°C) (steady-state spectrum; for TADF materials $E^B$ a spin-coated film of 10% by weight of $E^B$ in poly(methyl methacrylate), PMMA, is typically used; for small FWHM emitters $S^B$ a spin-coated film of 1-5%, preferably 2% by weight of $S^B$ in PMMA is typically used; for host materials $H^B$ a spin-coated neat film of the respective host material $H^B$ is typically used). For phosphorescence materials $P^B$, $E^{gap}$ is also determined from the onset of the emission spectrum at room temperature (i.e. approx. 20°C) (typically measured from a spin-coated film of 10% by weight of $P^B$ in PMMA).

Absorption spectra are recorded at room temperature (i.e. approximately 20°C). For TADF materials $E^B$, absorption spectra are typically measured from a spin-coated film of 10% by weight of $E^B$ in poly(methyl methacrylate) (PMMA). For small FWHM emitters $S^B$ absorption spectra are typically measured from a spin-coated film of 1-5%, preferably 2% by weight of $S^B$ in PMMA. For host materials $H^B$ absorption spectra are typically measured from a spin-coated neat film of the host material $H^B$. For phosphorescence materials $P^B$, absorption spectra are typically measured from a spin-coated film of 10% by weight of $P^B$ in PMMA. Alternatively, absorption spectra may also be recorded from solutions of the respective molecules, for example in dichloromethane or toluene, wherein the concentration of the solution is typically chosen so that the maximum absorbance preferably is in a range of 0.1 to 0.5.

The onset of an absorption spectrum is determined by computing the intersection of the tangent to the absorption spectrum with the x-axis. The tangent to the absorption spectrum is set at the low-energy side of the absorption band and at the point at half maximum of the maximum intensity of the absorption spectrum.

Unless stated otherwise, the energy of the first (i.e. the lowermost) excited triplet state T1 is determined from the onset the phosphorescence spectrum at 77K (for TADF materials $E^B$ a spin-coated film of 10% by weight of $E^B$ in PMMA is typically used; for small FWHM emitters $S^B$ a spin-coated film of 1-5%, preferably 2% by weight of $S^B$ in PMMA is typically used; for host materials $H^B$, a spin-coated neat film of the respective host material $H^B$ is typically used; for phosphorescence materials $P^B$ a spin-coated film of 10% by weight of $P^B$ in PMMA is typically used and the measurement is typically performed at room temperature (i.e. approximately 20°C). As laid out for instance in EP2690681A1, it is acknowledged that for TADF materials $E^B$ with small $\Delta E_{ST}$ values, intersystem crossing and reverse intersystem crossing may both occur even at low temperatures. In consequence, the emission spectrum at 77K may include emission from both, the S1 and the T1 state. However, as also described in EP2690681A1, the contribution / value of the triplet energy is typically considered dominant.

Unless stated otherwise, the energy of the first (i.e. the lowermost) excited singlet state S1 is determined from the onset the fluorescence spectrum at room temperature (i.e. approx. 20°C) (steady-state spectrum; for TADF materials $E^B$ a spin-coated film of 10% by weight of $E^B$ in PMMA is typically used; for small FWHM emitters $S^B$ a spin-coated film of 1-5%, preferably 2% by weight of $S^B$ in PMMA is typically used; for host materials $H^B$, a spin-coated neat film of the respective host material $H^B$ is typically used; for phosphorescence materials $P^B$ a spin-coated film of 10% by weight of $P^B$ in PMMA is typically used). For phosphorescence materials $P^B$ displaying efficient intersystem crossing however, room temperature emission may be (mostly) phosphorescence and not fluorescence. In this case, the onset of the emission spectrum at room temperature (i.e. approx. 20°C) is used to determine the energy of the first (i.e. the lowermost) excited triplet state T1 as stated above.

The onset of an emission spectrum is determined by computing the intersection of the tangent to the emission spectrum with the x-axis. The tangent to the emission spectrum is set at the high-energy side of the emission band and at the point at half maximum of the maximum intensity of the emission spectrum.

The $\Delta E_{ST}$ value, which corresponds to the energy difference between the first (i.e. the lowermost) excited singlet state (S1) and the first (i.e. the lowermost) excited triplet state (T1), is determined based on the first (i.e. the lowermost) excited singlet state energy and the first (i.e. the lowermost) excited triplet state energy, which were determined as stated above.

As known to the skilled artisan, the full width at half maximum (FWHM) of an emitter (for example a small FWHM emitter $S^B$) is readily determined from the respective emission spectrum (fluorescence spectrum for fluorescent emitters and phosphorescence spectrum for phosphorescent emitters). For small FWHM emitters $S^B$, the fluorescence spectrum is typically used. All reported, FWHM values typically refer to the main emission peak (i.e. the peak with the highest intensity). The means of determining the FWHM (herein preferably reported in electron volts, eV) are part of the common knowledge of those skilled in the art. Given for example that the main emission peak of an emission spectrum reaches its half maximum emission (i.e. 50% of the maximum emission intensity) at the two wavelengths $\lambda_1$ and $\lambda_2$, both obtained in nanometers (nm) from the emission spectrum, the FWHM in electron volts (eV) is commonly (and herein) determined using the following equation:

$$\text{FWHM [eV]} = \left| \frac{1239.84\ [eV \cdot nm]}{\lambda_2\ [nm]} - \frac{1239.84 [eV \cdot nm]}{\lambda_1\ [nm]} \right| .$$

As used herein, if not defined more specifically in a particular context, the designation of the colors of emitted and/or absorbed light is as follows:

| | |
|---|---|
| violet: | wavelength range of >380-420 nm; |
| deep blue: | wavelength range of >420-475 nm; |
| sky blue: | wavelength range of >475-500 nm; |
| green: | wavelength range of >500-560 nm; |
| yellow: | wavelength range of >560-580 nm; |
| orange: | wavelength range of >580-620 nm; |
| red: | wavelength range of >620-800 nm. |

The invention is illustrated by the following examples and the claims.

## Examples

*Cyclic voltammetry*

Cyclic voltammograms of solutions having concentration of $10^{-3}$ mol/l of the organic molecules in dichloromethane or a suitable solvent and a suitable supporting electrolyte (e.g. 0.1 mol/l of tetrabutylammonium hexafluorophosphate) are measured. The measurements are conducted at room temperature (i.e. (approximately) 20 °C) and under nitrogen atmosphere with a three-electrode assembly (working and counter electrodes: Pt wire, reference electrode: Pt wire) and calibrated using $FeCp_2/FeCp_2^+$ as internal standard. HOMO and LUMO data was corrected using ferrocene as internal standard against SCE.

*Density functional theory calculation*

Molecular structures are optimized employing the BP86 functional and the resolution of identity approach (RI). Excitation energies are calculated using the (BP86) optimized structures employing Time-Dependent DFT (TD-DFT) methods. Def2-SVP basis sets and a m4-grid for numerical integration were used. The Turbomole program package was used for all calculations. Orbital and excited state energies are calculated with the B3LYP functional. However, herein, orbital and excited state energies are preferably determined experimentally as stated above. All orbital and excited state energies reported herein (see experimental results) have been determined experimentally.

*Photophysical measurements*

*Sample pretreatment: vacuum-evaporation*

As stated before, photophysical measurements of individual compounds (for example organic molecules or transition metal complexes) that may be comprised in a light-emitting layer B of the organic electroluminescent device according to the present invention (for example host materials $H^B$, TADF materials $E^B$, phosphorescence materials $P^B$ or small FWHM emitters $S^B$) were typically performed using either spin-coated neat films (in case of host materials $H^B$) or spin-coated films of the respective material in poly(methyl methacrylate) (PMMA) (e.g. for TADF materials $E^B$, phosphorescent materials $P^B$, and small FWHM emitters $S^B$). These films were spin coated films and, unless stated differently for specific measurements, the concentration of the materials in the PMMA-films was 10% by weight for TADF materials $E^B$ and for phosphorescent materials $P^B$ or 1-5%, preferably 2% by weight for small FWHM emitters $S^B$. Alternatively, and as stated previously, some photophysical measurements may also be performed from solutions of the respective molecules, for example in dichloromethane or toluene, wherein the concentration of the solution is typically chosen so that the maximum absorbance preferably is in a range of 0.1 to 0.5.

Apparatus: Spin150, SPS euro.

The sample concentration was 1.0 mg/ml, typically dissolved in Toluene/DCM as suitable solvent.
Program: 7- 30 sec. at 2000 U/min. After coating, the films were dried at 70 °C for 1 min.
For the purpose of further studying compositions of certain materials as present in the EML of organic electroluminescent devices (according to the present invention or comparative), the samples for photophysical measurements were produced from the same materials used for device fabrication by vacuum deposition of 50 nm of the respective light-emitting layer B on quartz substrates. Photophysical characterization of the samples are conducted under nitrogen atmosphere.

*Absorption measurements*

A Thermo Scientific Evolution 201 UV-Visible Spectrophotometer is used to determine the wavelength of the absorption maximum of the sample in the wavelength region above 270 nm. This wavelength is used as excitation wavelength for photoluminescence spectral and quantum yield measurements.

*Photoluminescence spectra*

Steady-state emission spectra are recorded using a Horiba Scientific, Modell FluoroMax-4 equipped with a 150 W Xenon-Arc lamp, excitation- and emissions monochromators. The samples are placed in a cuvette and flushed with nitrogen during the measurements.

*Photoluminescence quantum yield measurements*

For photoluminescence quantum yield (PLQY) measurements an integrating sphere, the *Absolute PL Quantum Yield Measurement C9920-03G* system *(Hamamatsu Photonics)* is used. The samples are kept under nitrogen atmosphere throughout the measurement. Quantum yields are determined using the software U6039-05 and given in%. The yield is calculated using the equation:

$$\Phi_{PL} = \frac{n_{photon}, emited}{n_{photon}, absorbed} = \frac{\int \frac{\lambda}{hc}\left[Int_{emitted}^{sample}(\lambda) - Int_{absorbed}^{sample}(\lambda)\right]d\lambda}{\int \frac{\lambda}{hc}\left[Int_{emitted}^{reference}(\lambda) - Int_{absorbed}^{reference}(\lambda)\right]d\lambda}$$

wherein $n_{photon}$ denotes the photon count and Int. is the intensity. For quality assurance, anthracene in ethanol (known concentration) is used as reference.

*TCSPC (Time-correlated single-photon counting)*

Unless stated otherwise in the context of certain embodiments or analyses, excited state population dynamics are determined employing Edinburgh Instruments FS5 Spectrofluoremeters, equipped with an emission monochromator, a temperature stabilized photomultiplier as detector unit and a pulsed LED (310 nm central wavelength, 910 ps pulse width) as excitation source. The samples are placed in a cuvette and flushed with nitrogen during the measurements.

To determine the average decay time $\bar{\tau}$ of a measured transient photoluminescence signal, the data is fitted with a sum of n exponential functions:

$$\sum_{i=1}^{n} A_i \exp\left(-\frac{t}{t_i}\right)$$

wherein n is an integer between 1 and 3. By weighting the specific decay time constants $\tau_i$ with the corresponding amplitudes $A_i$, the excited state lifetime $\bar{\tau}$ is determined:

$$\bar{\tau} = \frac{\sum_{i=1}^{n} A_i \tau_i}{\sum_{i=1}^{n} A_i}$$

The method may be applied for fluorescence and phosphorescence materials to determine the excited state lifetimes. For TADF materials, the full decay dynamics as described below need to be gathered.

*Full decay dynamics*

The full excited state population decay dynamics over several orders of magnitude in time and signal intensity is achieved by carrying out TCSPC measurements in 4 time windows: 200 ns, 1 μs, and 20 μs, and a longer measurement spanning > 80 μs. The measured time curves are then processed in the following way:

- A background correction is applied by determining the average signal level before excitation and subtracting.
- The time axes are aligned by taking the initial rise of the main signal as reference.
- The curves are scaled onto each other using overlapping measurement time regions.
- The processed curves are merged to one curve.

Data analysis is done using mono-exponential or bi-exponential fitting of prompt fluorescence (PF) and delayed fluorescence (DF) decays separately. By weighting the specific decay time constants $\tau_i$ from the fits with the corresponding amplitudes $A_i$, the average lifetime $\bar{\tau}$ for the prompt (i.e. the prompt fluorescence lifetime) and the delayed-fluorescence (i.e. the delayed fluorescence lifetime), respectively, may be determined as follows:

$$\bar{\tau} = \frac{\sum_{i=1}^{n} A_i \tau_i}{\sum_{i=1}^{n} A_i}$$

wherein n is either 1 or 2.

The ratio of delayed and prompt fluorescence (n- value) is calculated by the integration of respective photoluminescence decays in time.

$$\frac{\int I_{DF}(t)dt}{\int I_{PF}(t)dt} = n$$

*Transient photoluminescence measurements with spectral resolution*

In transient photoluminescence (PL) measurements with spectral resolution, PL spectra at defined delay times after pulsed optical excitation are recorded.

An exemplary device for measureing transient PL spectra comprises:

- a pulsed laser (eMOPA, CryLas) with a central wavelength of 355 nm and a pulse width of 1 ns to excite the sample.
- a sample chamber configured to house a sample that can be either evacuated or flushed with nitrogen.
- a spectrograph (SpectraPro HRS) to disperse light emitted from the sample.
- a CCD camera (Princeton Instruments PI-MAX4) for wavelength resolved detection of the dispersed emitted light, with integrated timing generator for synchronization with the pulsed laser.
- a personal computer configured to analyze the signal fom the CCD camera imported therinto.

In the course of the measurement, the sample is placed in the sample chamber and irradiated with the pulsed laser. Emitted light from the sample is taken in a 90 degree direction with respect to the irradiation direction of the laser pulses. It is dispersed by the spectrograph and directed onto the detector (the CCD camera in the exemplary device), thus obtaining a wavelength resolved emission spectrum. The time delay between laser irradiation and detection, and the duration (i.e. the gate time) of detection are controlled by the timing generator.
It should be noted, that transient photolumminescence may be measuered by a device different from the one described in the exemplary device.

*Production and characterization of organic electroluminescence devices*

Via vacuum-deposition methods OLED devices comprising organic molecules according to the invention can be produced. If a layer contains more than one compound, the weight-percentage of one or more compounds is given in%. The total weight-percentage values amount to 100%, thus if a value is not given, the fraction of this compound equals to the difference between the given values and 100%.
The not fully optimized OLEDs are characterized using standard methods and measuring electroluminescence spectra, the external quantum efficiency (in%) in dependency on the intensity, calculated using the light detected by the photodiode, and the current. The FWHM of the devices is determined from the electroluminescence spectra as stated previously for photoluminescence spectra (fluorescence or phosphorescence). The reported FWHM refers to the main emission peak (i.e. the peak with the highest emission intensity). The OLED device lifetime is extracted from the change of the luminance during operation at constant current density. The LT50 value corresponds to the time, where the measured luminance decreased to 50% of the initial luminance, analogously LT80 corresponds to the time point, at which the measured luminance decreased to 80% of the initial luminance, LT97 to the time point, at which the measured luminance decreased to 97% of the initial luminance etc.
Accelerated lifetime measurements are performed (e.g. applying increased current densities). Exemplarily LT80 values at 500 cd/m$^2$ are determined using the following equation:

$$\mathrm{LT80}\left(500\,\frac{cd^2}{m^2}\right) = \mathrm{LT80}(L_0)\left(\frac{L_0}{500\,\frac{cd^2}{m^2}}\right)^{1.6}$$

wherein $L_0$ denotes the initial luminance at the applied current density. The values correspond to the average of several pixels (typically two to eight).

Experimental results

Stack materials

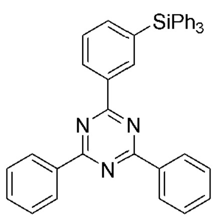

HBM1 (Hole-blocking material)

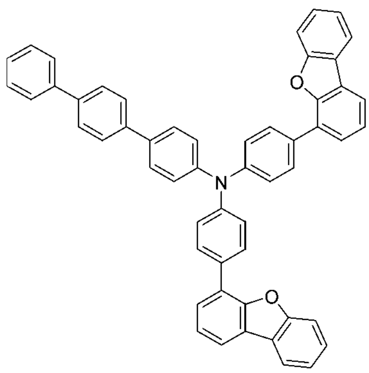

EBM1 (electron-blocking material)

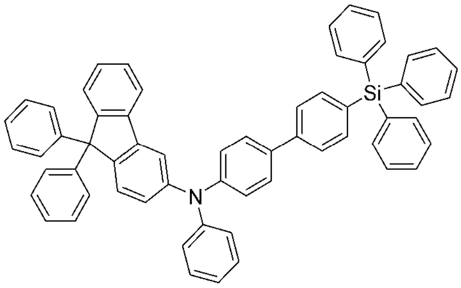

HTL1 (Hole-transport material)

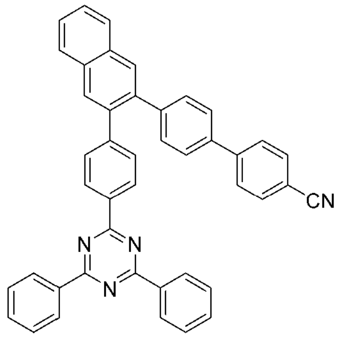

ETL1 (electron-transport material)

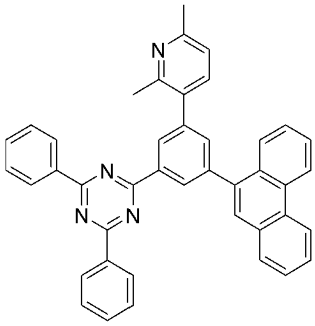

ETL2 (electron-transport material)

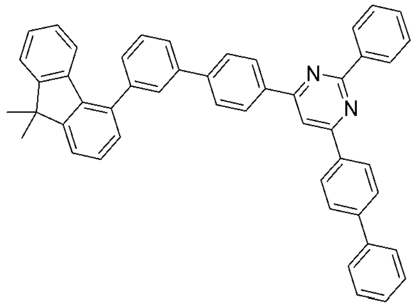

ETL3 (electron-transport material)

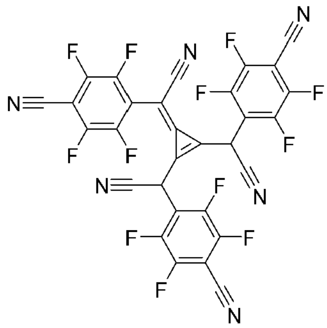

NDP-9 (hole-injection material)

TTA materials

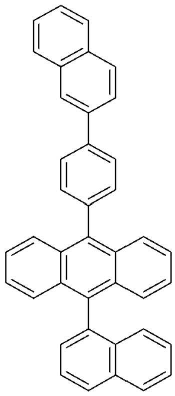

TTA1

**Table 1TTA.** Properties of the TTA materials.

| | Example compound | $E^{HOMO}$ [eV] | $E^{LUMO}$ [eV] | E(S1) [eV] | E(T1) [eV] |
|---|---|---|---|---|---|
| **TTA** | **TTAL[1]** | -5.89 | -2.63 | 3.16 | |
| [1]measured in neat film. | | | | | |

Host materials $H^B$

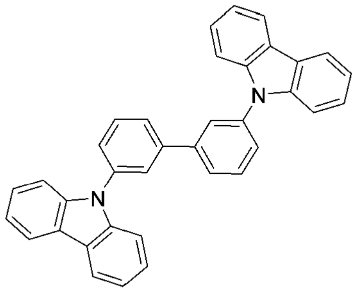

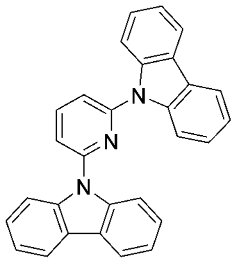

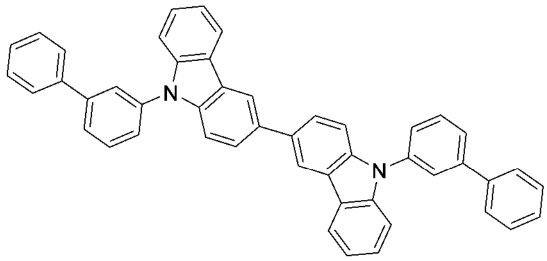

**mCBP = $H^B$-1** **PYD2 = $H^B$-2** **$H^B$-3**

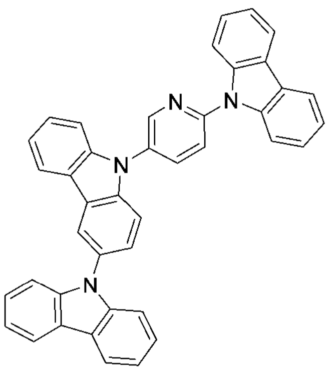

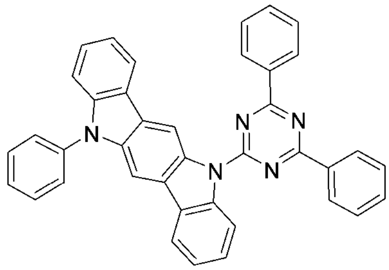

**$H^B$-4** **$H^B$-5**

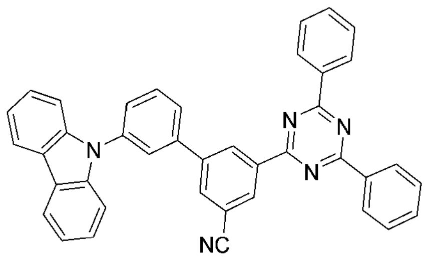

**$H^B$-6**

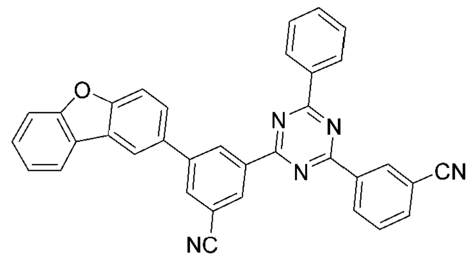

**$H^B$-7**

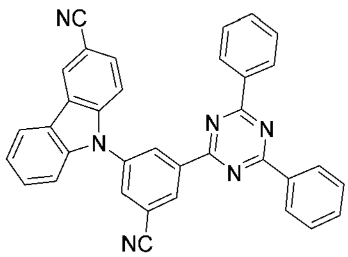

**$H^B$-8**

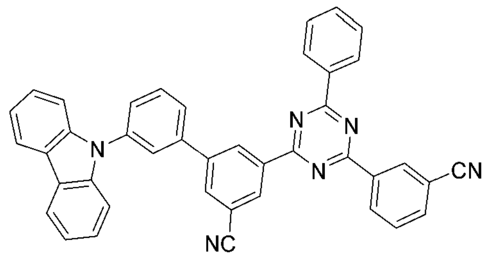

**$H^B$-9**

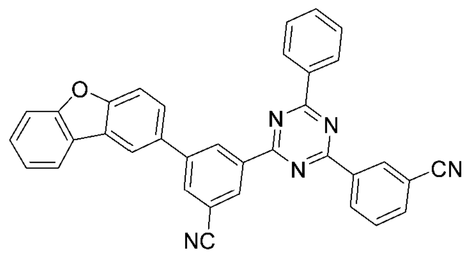

**$H^B$-10**

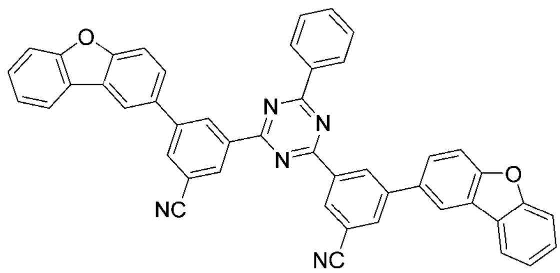

**$H^B$-11**

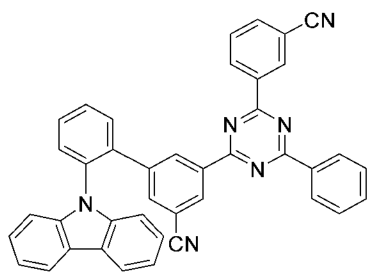

**$H^B$-12**

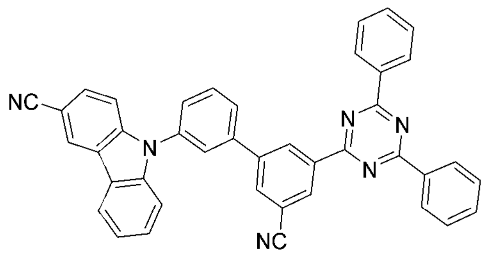

**$H^B$-13**

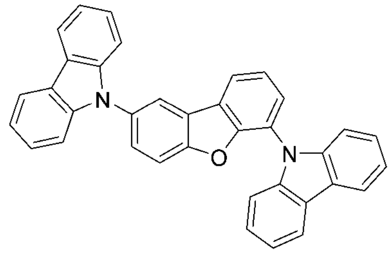

**$H^B$-14**

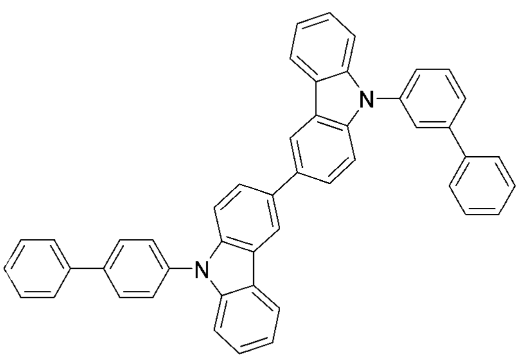

**$H^B$-15**

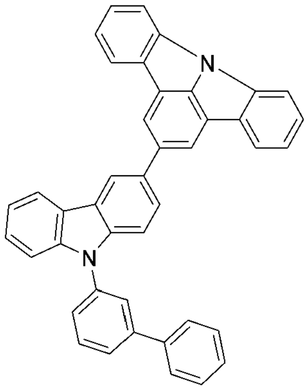

**$H^B$-16**

**Table 1H.** Properties of the host materials.

| | Example compound | $E^{HOMO}$ [eV] | $E^{LUMO}$ [eV] | E(S1) [eV] | E(T1) [eV] |
|---|---|---|---|---|---|
| $H^B$ | **HBM1** | | -2.91 | | 2.94 |
| | **EBM1** | -5.54 | -2.46 | 3.08 | 2.36 |
| | **mCBP** | -6.02 | -2.42 | 3.6 | 2.82 |
| | **PYD2** | -6.08 | -2.55 | 3.53 | 2.81 |
| | **$H^B$-3** | -5.66 | -2.35 | 3.31 | 2.71 |
| | **$H^B$-4** | -5.85 | -2.43 | 3.42 | 2.84 |
| | **$H^B$-5** | -5.91 | -2.89 | 2.79 | |
| | **$H^B$-6** | -5.94 | -2.93 | 3.01 | 2.78 |
| | **$H^B$-7** | | | 3.27 | 2.71 |
| | **$H^B$-8** | | | 2.94 | 2.70 |
| | **$H^B$-9** | -5.97 | -3.10 | 2.88 | 2.77 |
| | **$H^B$-10** | | | 3.15 | 2.75 |
| | **$H^B$-11** | -6.04 | -3.10 | 2.94 | 2.86 |
| | **$H^B$-12** | -6.23 | -3.02 | 3.21 | 2.76 |
| | **$H^B$-13** | -6.23 | -3.12 | 3.21 | 2.76 |
| | **$H^B$-14** | -5.99 | -2.48 | 3.51 | 2.97 |
| | **$H^B$-15** | -5.64 | -2.36 | 3.28 | 2.70 |
| | **$H^B$-16** | -5.68 | -2.55 | 3.13 | 2.81 |

**TADF materials $E^B$**

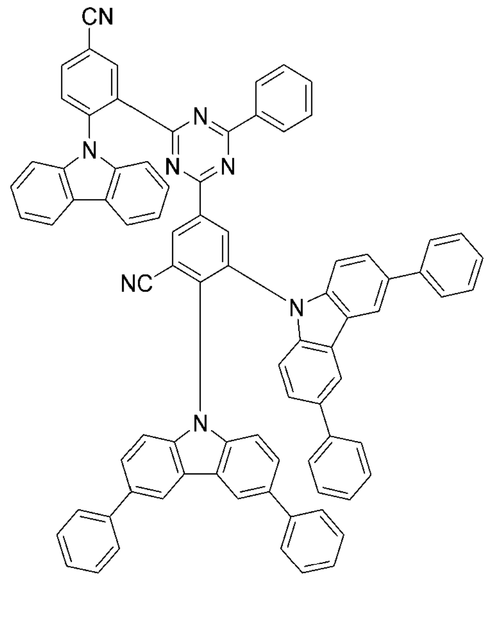

EB-1

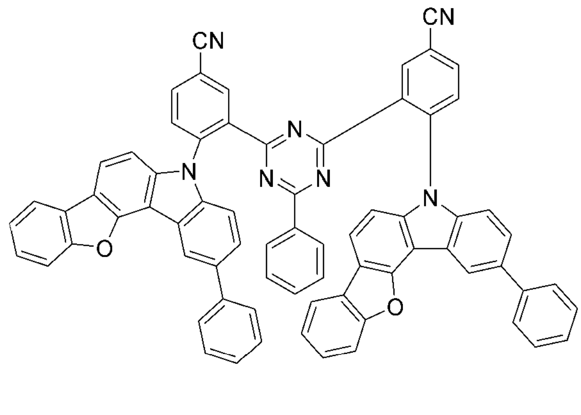

EB-2

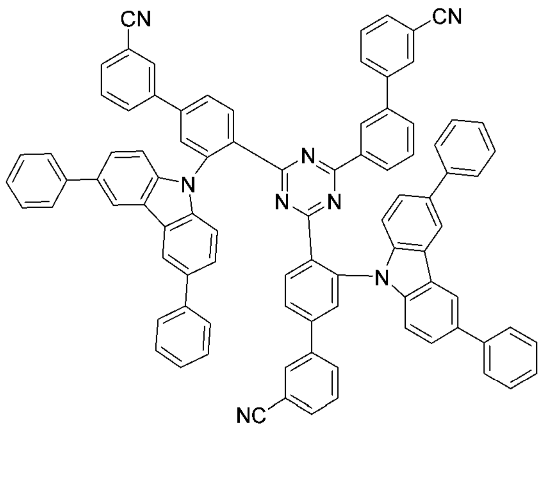

EB-3

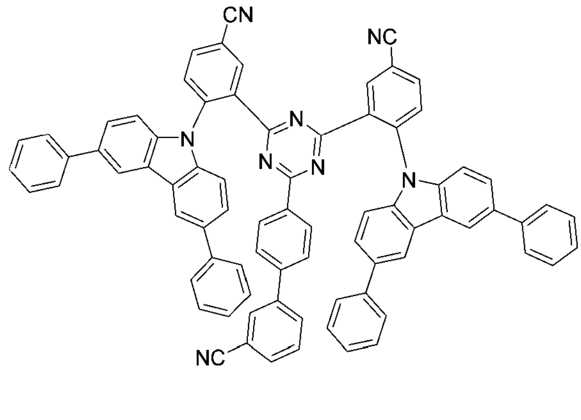

EB-4

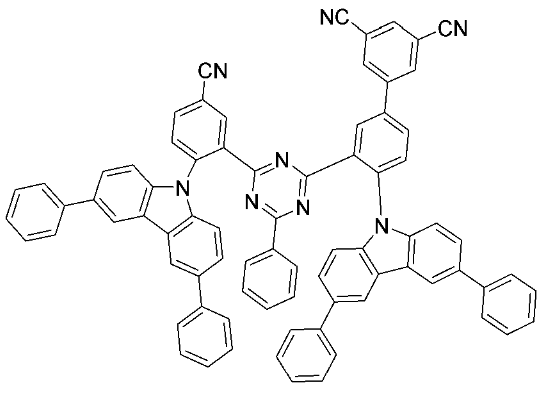

EB-5

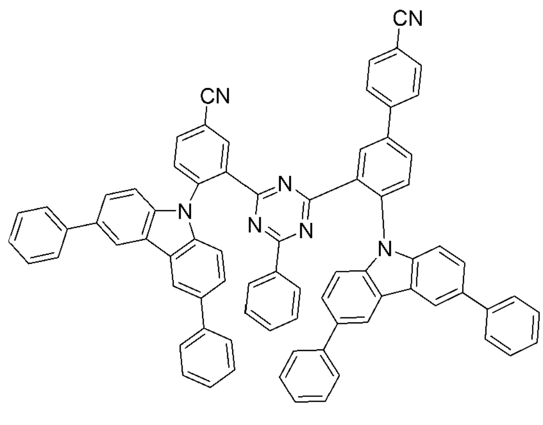

EB-6

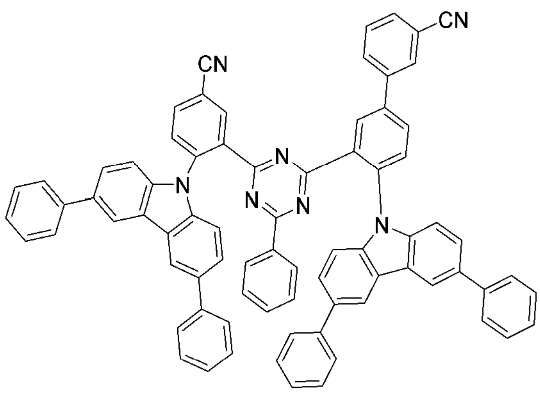

E$^B$-7

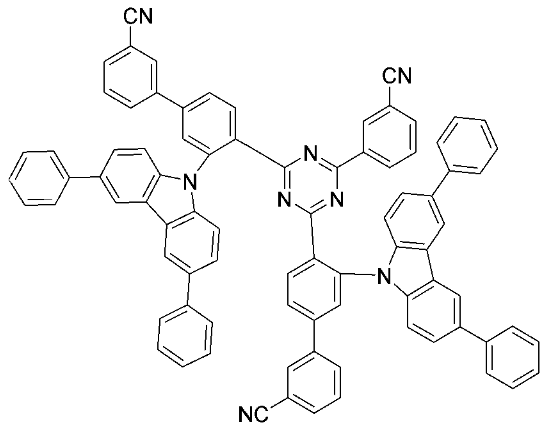

E$^B$-8

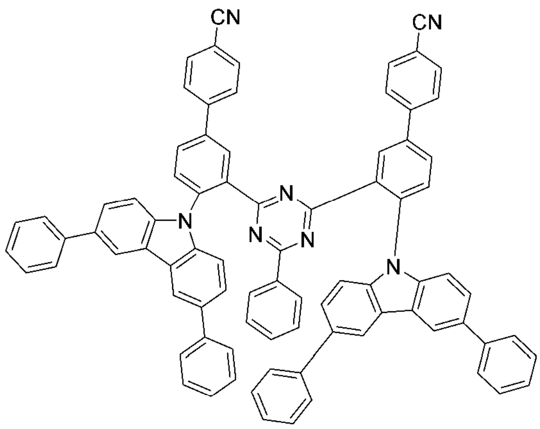

E$^B$-9

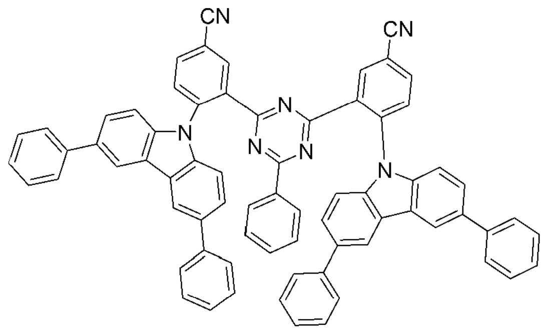

E$^B$-10

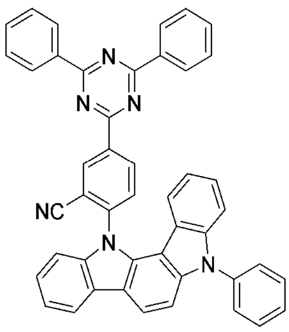

E$^B$-11

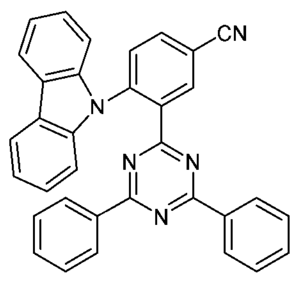

E$^B$-12

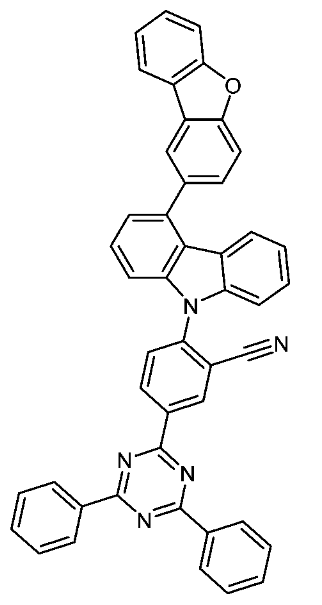

E$^B$-13

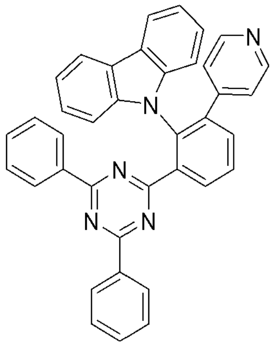

**E^B-14**

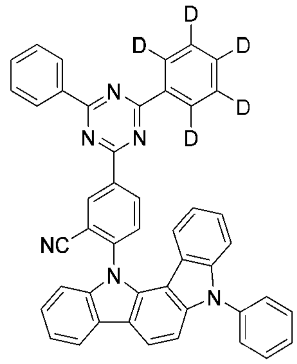

**E^B-15**

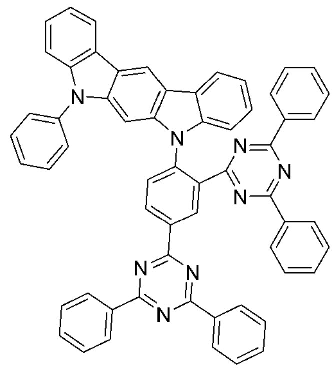

**E^B-16**

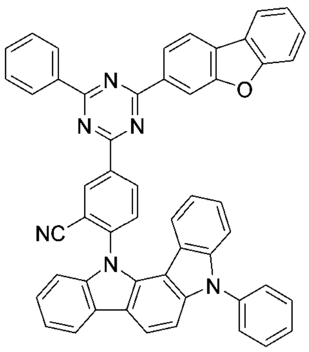

**E^B-17**

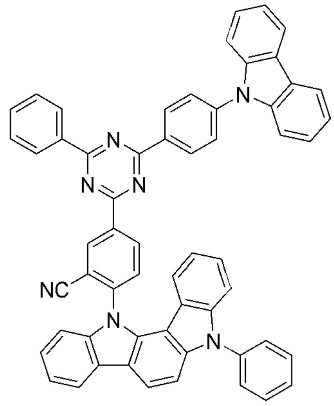

**E^B-18**

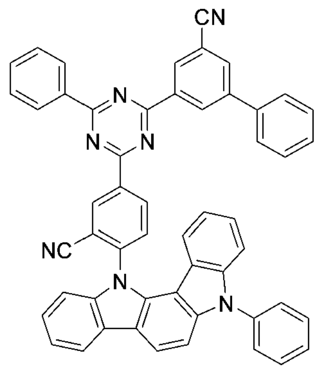

**E^B-19**

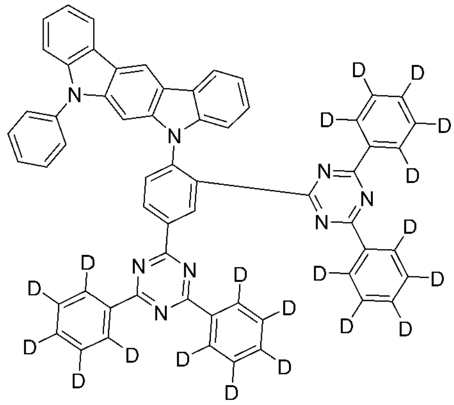

**E^B-20**

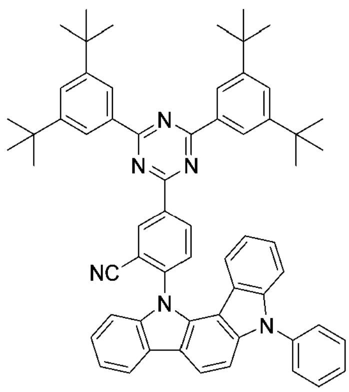

**E^B-21**

**Table 1E.** Properties of the TADF materials $E^B$.

| | Example compound | $E^{HOMO}$ [eV] | $E^{LUMO}$ [eV] | E(S1) [eV] | E(T1) [eV] | $\lambda_{max}^{PMMA}$ [nm] | FWHM [eV] | PLQY [%] |
|---|---|---|---|---|---|---|---|---|
| | **$E^B$-1** | -5.97 | -3.28 | 2.69 | 2.63 | 518 | 0.43 | 61 |
| | **$E^B$-2** | -5.97 | -3.31 | 2.66 | 2.72 | 526 | 0.43 | 43 |
| | **$E^B$-3** | -5.92 | -3.25 | 2.67 | 2.65 | 517 | 0.40 | 73 |
| | **$E^B$-4** | -6.00 | -3.37 | 2.63 | 2.65 | 525 | 0.40 | 54 |
| | **$E^B$-5** | -5.95 | -3.27 | 2.68 | 2.64 | 508 | 0.41 | 72 |
| | **$E^B$-6** | -5.94 | -3.24 | 2.70 | 2.64 | 509 | 0.41 | 74 |
| | **$E^B$-7** | -5.94 | -3.24 | 2.70 | 2.66 | 509 | 0.41 | 71 |
| | **$E^B$-8** | -5.93 | -3.33 | 2.60 | 2.59 | 525 | 0.39 | 71 |
| | **$E^B$-9** | -5.89 | -3.15 | 2.74 | 2.64 | 498 | 0.40 | 81 |
| | **$E^B$-10** | -5.99 | -3.34 | 2.65 | 2.65 | 520 | 0.42 | 54 |
| **$E^B$** | **$E^B$-11** | -5.79 | -3.15 | 2.77 | 2.81 | 514 | 0.50 | 63 |
| | **$E^B$-12** | -6.07 | -3.19 | 2.88 | 2.80 | 477 | 0.42 | 83 |
| | **$E^B$-13** | -6.15 | -3.13 | 3.02 | 2.79 | 454 | 0.44 | 72 |
| | **$E^B$-14** | -6.03 | -3.01 | 3.02 | 2.97 | 459 | 0.45 | 72 |
| | **$E^B$-15** | -5.79 | -3.02 | 2.77 | 2.82 | 511 | 0.49 | 64 |
| | **$E^B$-16** | -5.71 | -3.07 | 2.64 | 2.59 | 517 | 0.38 | 68 |
| | **$E^B$-17** | -5.79 | -3.02 | 2.77 | 2.77 | 523 | 0.51 | 49 |
| | **$E^B$-18** | -5.80 | -3.04 | 2.76 | | 522 | 0.52 | 52 |
| | **$E^B$-19** | -5.80 | -3.14 | 2.67 | | 540 | 0.50 | 38 |
| | **$E^B$-20** | -5.71 | -3.06 | 2.65 | 2.60 | 510 | 0.37 | 69 |
| | **$E^B$-21** | -5.79 | -2.96 | 2.84 | 2.88 | 502 | 0.51 | 66 |

**Phosphorescence materials $P^B$**

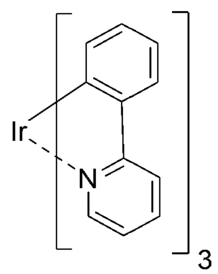

**Ir(ppy)3**

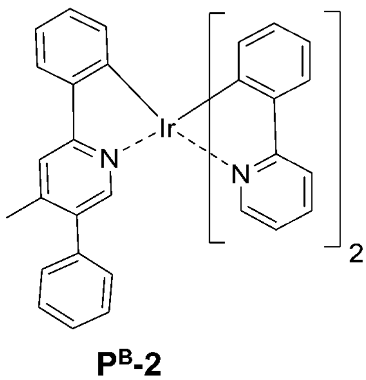

**$P^B$-2**

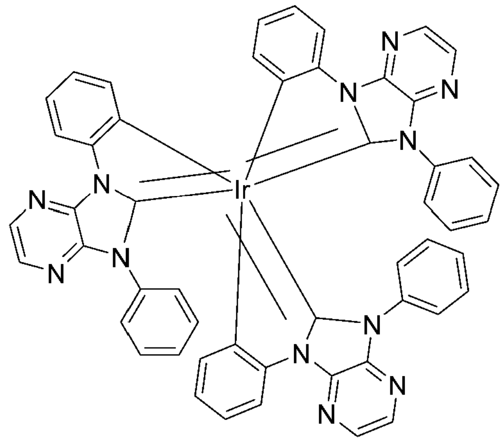

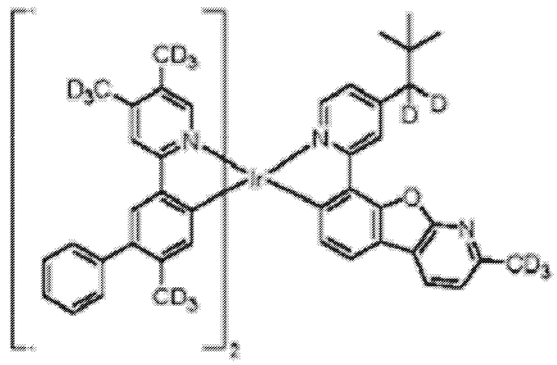

$P^B$-3 $P^B$-4

**Table 1P.** Properties of the materials.

| | Example compound | **HOMO [eV]** | **LUMOcv [eV]** | **$E^{LUMO}$ [eV]** | **E(S1) [eV]** | **E(T1) [eV]** | **$\lambda_{max}^{PMMA}$ [nm]** | **FWHM [eV]** |
|---|---|---|---|---|---|---|---|---|
| $P^B$ | **$Ir(ppy)_3$** | -5.36 | | | | 2.56a | 509 | 0.38 |
| | **$P^B$-2** | -5.33 | -2.32 | | | 2.57[b] | 522 | 0.34 |
| | **$P^B$-3** | -5.80 | -2.67 | | | 2.88[c] | 482 | 0.40 |
| | **$P^B$-4** | -5.24 | | | | | | |

wherein LUMOcv is the energy of the lowest unoccupied molecular orbital, which is determined by Cyclic voltammetry. [a]The emission spectrum was recorded from a solution of $Ir(ppy)_3$ in chloroform. [b]The emission spectrum was recorded from a 0.001 mg/mL solution of $P^B$-2 in dichloromethane. [c]The emission spectrum was recorded from a 0.001 mg/mL solution of $P^B$-3 in toluene.

**Small FWHM emitters $S^B$**

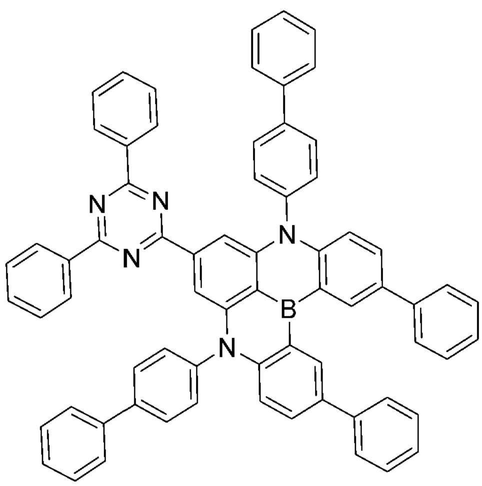

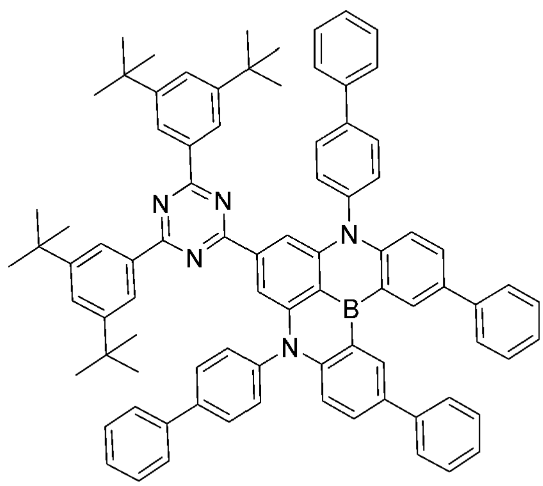

$S^B$-1 $S^B$-2

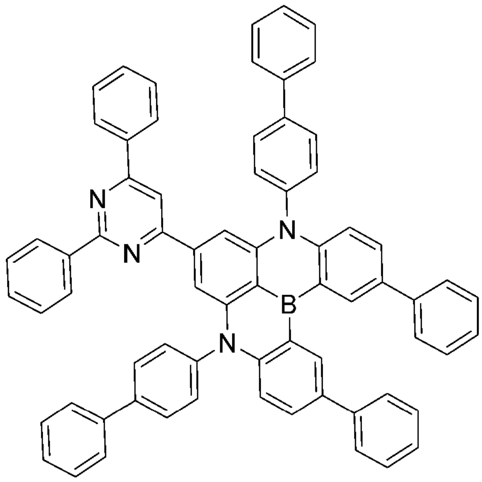

**S^B-3**

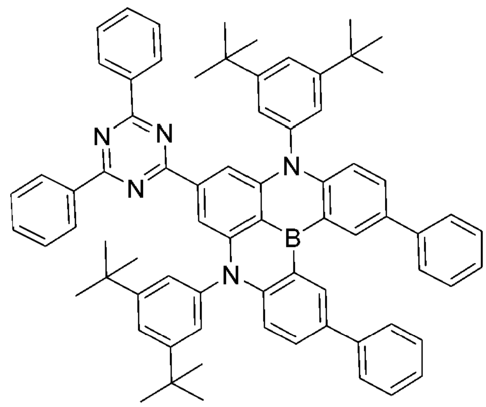

**S^B-4**

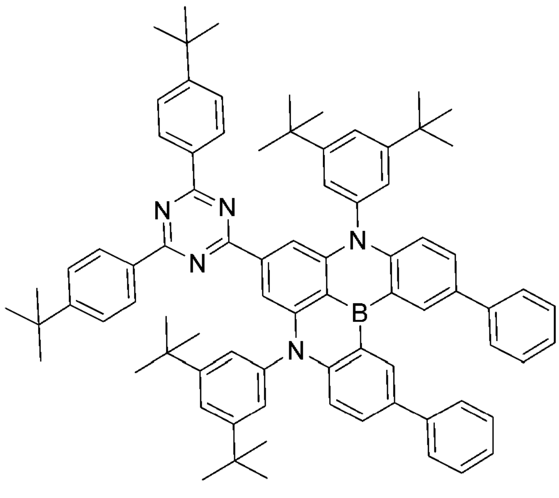

**S^B-5**

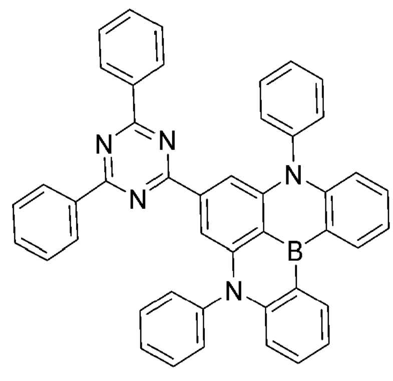

**S^B-6**

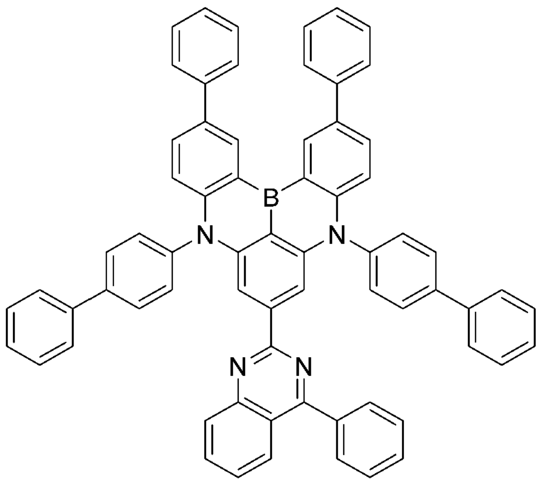

**S^B-7**

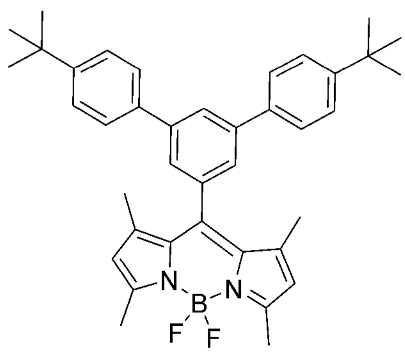

**S^B-8**

**Table 1S.** Properties of the Small FWHM emitters $S^B$.

| | Example compound | $E^{HOMO}$ [eV] | $E^{LUMO}$ [eV] | E(S1) [eV] | E(T1) [eV] | $\lambda_{max}^{PMMA}$ [nm] | FWHM [eV] |
|---|---|---|---|---|---|---|---|
| $S^B$ | $S^B$-1 | -5.54 | -3.10 | 2.44 | 2.12 | 538 | 0.21 |
| | $S^B$-2 | -5.53 | -3.04 | 2.49 | 2.26 | 525 | 0.18 |
| | $S^B$-3 | -5.55 | -3.05 | 2.50 | 2.22 | 520 | 0.18 |
| | $S^B$-4 | -5.48 | -3.05 | 2.43 | 2.25 | 537 | 0.17 |
| | $S^B$-5 | -5.47 | -3.01 | 2.46 | 2.58 | 527 | 0.15 |
| | $S^B$-6 | -5.56 | -3.03 | 2.53 | 2.19 | 518 | 0.22 |
| | $S^B$-7 | -5.48 | -2.97 | 2.53 | 2.23 | 521 | 0.25 |
| | $S^B$-8* | -5.86 | -3.40 | 2.46 | | 517 | 0.10 |

**Table 2.** Setup 1 of exemplary organic electroluminescent devices (OLEDs).

| Layer | Thickness | Material |
|---|---|---|
| **10** | 100 nm | Al |
| **9** | 2 nm | Liq |
| **8** | 10 nm | ETL2:Liq = 50:50 |
| **7** | 10 nm | ETL3 |
| **6 = B** | 60 nm | $H^B$ :<br>$E^B$:<br>EET-2 : $S^B$ |
| **5 = EXL** | X, see Device results 1 | TTA1 : $S^B$ = 99 : 1 |
| **4** | 10 nm - X | EBM1 |
| **3** | 60 nm | NPB |
| **2** | 9 nm | NPB : NDP-9 = 95 : 5 |
| **1** | 50 nm | ITO |
| **substrate** | | glass |

**Results I: Variation of the thickness of the exciton management layer EXL adjacent to the light-emitting layer B (emission layer, 6)**

Composition of the light-emitting layer B of devices D1 - D3 (the percentages refer to weight percent):

| Layer | D1 - D3 |
|---|---|
| **Emission layer (5)** | $H^B$ (66.3%):<br>$E^B$ (30%):<br>EET-2 (3%):<br>$S^B$ (0.7%) |

Setup 1 from Table 2 was used, wherein $H^B$-15 was used as host material $H^B$, $E^B$-16 was used as TADF material $E^B$, $P^B$-2 was used as excitation energy transfer component EET-2 (here exemplarily a phosphorescence material $P^B$), and $S^B$-1 was used as the small FWHM emitter $S^B$.

**Device results I**

| Device | Thickness of layer EXL X [nm] | FWHM [eV] | $\lambda_{max}$ [nm] | CIEx | CIEy | Voltage at 10 mA/cm$^2$ [Volt] | EQE at 1000 cd/m$^2$ [%] | relative lifetime LT95 at 15 mA/m$^2$ |
|---|---|---|---|---|---|---|---|---|
| **D1** | 0 | 0.18 | 533 | 0.33 | 0.64 | 4.1 | 27.4 | 1.00 |
| **D2** | 2 | 0.18 | 533 | 0.33 | 0.64 | 4.2 | 26.9 | 1.12 |
| **D3** | 4 | 0.18 | 533 | 0.33 | 0.64 | 4.5 | 26.9 | 1.31 |

## Claims

1. An organic electroluminescent device comprising a light-emitting layer B comprising:

   (i) a TADF material $E^B$, which has a lowermost excited singlet state energy level $E(S1^E)$ and a lowermost excited triplet state energy level $E(T1^E)$;
   (ii) a small full width at half maximum (FWHM) emitter $S^B$, which has a lowermost excited singlet state energy level $E(S1^S)$ and a lowermost excited triplet state energy level $E(T1^S)$, wherein $S^B$ emits light with an emission maximum between 510 and 550 nm as determinable from the fluorescence spectrum measured at approximately 20 °C from a film of 1-5 % by weight of the small FWHM emitter in poly(methyl methacrylate) (PMMA); and
   (iii) a host material $H^B$, which has a lowermost excited singlet state energy level $E(S1^H)$ and a lowermost excited triplet state energy level $E(T1^H)$; **characterized in that** the organic electroluminescent device comprises an exciton management layer EXL, which is adjacent to the light-emitting layer B, comprising a triplet-triplet-annihilation (TTA) material, and wherein $S^B$ emits light with a full width at half maximum (FWHM) of less than or equal to 0.25 eV as determinable at approximately 20 °C measured from a film of 2% by weight of the small FWHM emitter in poly(methyl methacrylate) (PMMA).

2. The organic electroluminescent device according to claim 1, wherein the exciton management layer EXL has a thickness, which is less than 15 nm.

3. The organic electroluminescent device according to claim 1 or 2, wherein the exciton management layer EXL has a thickness, which is less than 10 nm.

4. The organic electroluminescent device according to one or more of claims 1 to 3, wherein the TTA material comprises a structure represented by formula 4

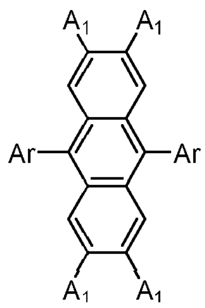

Formula 4

wherein

each Ar is independently selected from the group consisting of $C_6$-$C_{60}$-aryl, which is optionally substituted with one or more residues selected from the group consisting of $C_6$-$C_{60}$-aryl, $C_3$-$C_{57}$-heteroaryl, halogen, and $C_1$-$C_{40}$-(hetero)alkyl; and
$C_3$-$C_{57}$-heteroaryl, which is optionally substituted with one or more residues selected from the group consisting of

$C_6$-$C_{60}$-aryl, $C_3$-$C_{57}$-heteroaryl, halogen, and $C_1$-$C_{40}$-(hetero)alkyl;
and
each $A_1$ is independently selected from the group consisting of consisting of hydrogen;
deuterium;
$C_6$-$C_{60}$-aryl, which is optionally substituted with one or more residues selected from the group consisting of $C_6$-$C_{60}$-aryl, $C_3$-$C_{57}$-heteroaryl, halogen, and $C_1$-$C_{40}$-(hetero)alkyl;
$C_3$-$C_{57}$-heteroaryl, which is optionally substituted with one or more residues selected from the group consisting of $C_6$-$C_{60}$-aryl, $C_3$-$C_{57}$-heteroaryl, halogen, and $C_1$-$C_{40}$-(hetero)alkyl; and
$C_1$-$C_{40}$-(hetero)alkyl, which is optionally substituted with one or more residues selected from the group consisting of $C_6$-$C_{60}$-aryl, $C_3$-$C_{57}$-heteroaryl, halogen, and $C_1$-$C_{40}$-(hetero)alkyl.

**5.** The organic electroluminescent device according to one or more of claims 1 to 4, wherein the adjacent layer EXL comprises at least one additional emitter.

**6.** The organic electroluminescent device according to one or more of claims 1 to 5, wherein the emitter in the adjacent layer and the light-emission layer B are both small full width at half maximum (FWHM) emitters $S^B$, which emit light with a full width at half maximum (FWHM) of less than or equal to 0.25 eV and with an emission maximum between 510 and 550 nm.

**7.** The organic electroluminescent device according to one or more of claims 1 to 6, wherein the light-emitting layer B further comprises:
(iv) an excitation energy transfer component EET-2, which has a lowermost excited singlet state energy level $E(S1^{EET-2})$ and a lowermost excited triplet state energy level $E(T1^{EET-2})$; and which is selected from the group consisting of a TADF material and a phosphorescence material.

**8.** The organic electroluminescent device according to claim 7, wherein EET-2 is a phosphorescence material.

**9.** The organic electroluminescent device according to one or more of claims 1 to 8, wherein the small FWHM emitter $S^B$ fulfills at least one of the following requirements:

(i) it is a boron (B)-containing emitter, which means that at least one atom within each small FWHM emitter $S^B$ is boron (B); and/or
(ii) it comprises a polycyclic aromatic or heteroaromatic core structure, wherein at least two aromatic rings are fused together such as, e.g., anthracene, pyrene or aza-derivatives thereof.

**10.** The organic electroluminescent device according to one or more of claims 1 to 9, wherein each TADF material $E^B$

(i) is **characterized by** exhibiting a $\Delta E_{ST}$ value, which corresponds to the energy difference between the lowermost excited singlet state energy $E(S1^E)$ and the lowermost excited triplet state energy $E(T1^E)$, of less than 0.4 eV; and
(ii) displays a photoluminescence quantum yield (PLQY) of more than 30%.

**11.** The organic electroluminescent device according to one or more of claims 1 to 10, wherein:

$$E(T1^H) > E(T1^E) \qquad (13)$$

$$E(T1^E) > E(S1^S) \qquad (30).$$

**12.** The organic electroluminescent device according to one or more of claims 1 to 11, wherein the exciton management layer EXL is located between the light-emitting layer B and the anode of the organic electroluminescent device.

**13.** A method for generating an organic electroluminescent device according to any of claims 1 to 12, comprising the steps

(i) evaporation of an light-emitting layer B via vacuum-deposition, and
(ii) evaporation of an exciton management layer EXL via vacuum-deposition,

wherein the steps (i) and (ii) are performed subsequent to each other and the order of steps (i) and (ii) can be reversed.

**14.** A method for generating light, comprising the steps of:

(i) providing an organic electroluminescent device according to any of claims 1 to 12 or obtainable from a method of claim 13; and
(ii) applying an electrical current to said organic electroluminescent device.

**15.** The method according to claim 14, wherein the method is for generating light with the emission maximum of the main emission peak being within the wavelength from 510 nm to 550 nm.

**Patentansprüche**

**1.** Organische elektrolumineszente Vorrichtung umfassend eine lichtemittierende Schicht B, umfassend:

(i) ein TADF-Material $E^B$, das ein unterstes angeregtes Singulett-Zustands-Energieniveau $E(S1^E)$ und ein unterstes angeregtes Triplett-Zustands-Energieniveau $E(T1^E)$ aufweist;
(ii) einen Emitter $S^B$ mit kleiner Halbwertsbreite (FWHM), der ein unterstes angeregtes Singulett-Zustands-Energieniveau $E(S1^B)$ und ein unterstes angeregtes Singulett-Zustands-Energieniveau $E(T1^S)$ aufweist, wobei $S^B$ Licht mit einem Emissionsmaximum zwischen 510 und 550 nm emittiert, wie aus dem Fluoreszenzspektrum bestimmbar, gemessen bei etwa 20 °C an einem Film aus 1-5 Gew.-% des Emitters mit geringer FWHM in Poly(methylmethacrylat) (PMMA); und
(iii) ein Wirtsmaterial $H^B$, das ein unterstes angeregtes Singulett-Zustands-Energieniveau $E(S1^H)$ und unterstes angeregtes Singulett-Zustands-Energieniveau $E(T1^H)$ aufweist;

**dadurch gekennzeichnet, dass** die organische elektrolumineszente Vorrichtung eine Exzitonenmanagementschicht EXL umfasst, die an die lichtemittierende Schicht B angrenzt und ein Triplett-Triplett-Annihilations (TTA)-Material umfasst, und wobei $S^B$ Licht mit einer Halbwertsbreite (FWHM) von weniger als oder gleich 0,25 eV emittiert, wie bei etwa 20 °C bestimmbar, gemessen an einem Film von 2 Gew.-% des Emitters mit geringer Halbwertsbreite in Poly(methylmethacrylat) (PMMA).

**2.** Organische elektrolumineszente Vorrichtung nach Anspruch 1, wobei die Exzitonenmanagementschicht EXL eine Dicke von weniger als 15 nm aufweist.

**3.** Organische elektrolumineszente Vorrichtung nach Anspruch 1 oder 2, wobei die Exzitonenmanagementschicht EXL eine Dicke von weniger als 10 nm aufweist.

**4.** Organische elektrolumineszente Vorrichtung nach einem oder mehreren der Ansprüche 1 bis 3, wobei das TTA-Material eine durch Formel 4 dargestellte Struktur aufweist

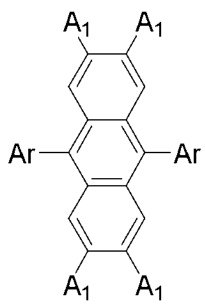

Formel 4

worin

jedes Ar unabhängig voneinander ausgewählt ist aus der Gruppe bestehend aus
$C_6$-$C_{60}$-Aryl, das optional substituiert ist mit einem oder mehreren Resten ausgewählt aus der Gruppe bestehend aus $C_6$-$C_{60}$-Aryl, $C_3$-$C_{57}$-Heteroaryl, Halogen und $C_1$-$C_{40}$-(Hetero)alkyl; und

$C_3$-$C_{57}$-Heteroaryl, das optional substituiert ist mit einem oder mehreren Resten ausgewählt aus der Gruppe bestehend aus $C_6$-$C_{60}$-Aryl, $C_3$-$C_{57}$-Heteroaryl, Halogen und $C_1$-$C_{40}$-(Hetero)alkyl;
und
jedes $A_1$ unabhängig ausgewählt ist aus der Gruppe bestehend aus Wasserstoff;
Deuterium;
$C_6$-$C_{60}$-Aryl, das optional substituiert ist mit einem oder mehreren Resten ausgewählt aus der Gruppe bestehend aus $C_6$-$C_{60}$-Aryl, $C_3$-$C_{57}$-Heteroaryl, Halogen und $C_1$-$C_{40}$-(Hetero)alkyl;
$C_3$-$C_{57}$-Heteroaryl, das optional substituiert ist mit einem oder mehreren Resten ausgewählt aus der Gruppe bestehend aus $C_6$-$C_{60}$-Aryl, $C_3$-$C_{57}$-Heteroaryl, Halogen und $C_1$-$C_{40}$-(Hetero)alkyl; und
$C_1$-$C_{40}$-(Hetero)alkyl, das optional substituiert ist mit einem oder mehreren Resten ausgewählt aus der Gruppe bestehend aus $C_6$-$C_{60}$-Aryl, $C_3$-$C_{57}$-Heteroaryl, Halogen und $C_1$-$C_{40}$-(Hetero)alkyl.

**5.** Organische elektrolumineszente Vorrichtung nach einem oder mehreren der Ansprüche 1 bis 4, wobei die benachbarte Schicht EXL mindestens einen zusätzlichen Emitter umfasst.

**6.** Organische elektrolumineszente Vorrichtung nach einem oder mehreren der Ansprüche 1 bis 5, wobei der Emitter in der benachbarten Schicht und die Lichtemissionsschicht B beide Emitter $S^B$ mit kleiner Halbwertsbreite (FWHM) sind, die Licht mit einer Halbwertsbreite (FWHM) von weniger als oder gleich 0,25 eV und mit einem Emissionsmaximum zwischen 510 und 550 nm emittieren.

**7.** Organische elektrolumineszente Vorrichtung nach einem oder mehreren der Ansprüche 1 bis 6, wobei die lichtemittierende Schicht B ferner umfasst:
(iv) eine Anregungsenergieübertragungskomponente EET-2, die ein unterstes angeregtes Singulett-Zustands-Energieniveau $E(S1^{EET-2})$ und ein unterstes angeregtes Triplett-Zustands-Energieniveau $E(T1^{EET-2})$ aufweist; und die ausgewählt ist aus der Gruppe bestehend aus einem TADF-Material und einem Phosphoreszenzmaterial.

**8.** Organische elektrolumineszente Vorrichtung nach Anspruch 7, wobei EET-2 ein Phosphoreszenzmaterial ist.

**9.** Organische elektrolumineszente Vorrichtung nach einem oder mehreren der Ansprüche 1 bis 8, wobei der Emitter $S^B$ mit kleiner FWHM mindestens eine der folgenden Anforderungen erfüllt:

(i) er ist ein Bor (B)-haltiger Emitter, was bedeutet, dass mindestens ein Atom innerhalb jedes Emitters $S^B$ mit kleiner FWHM Bor (B) ist; und/oder
(ii) er umfasst eine polyzyklische aromatische oder heteroaromatische Kernstruktur, in der mindestens zwei aromatische Ringe miteinander kondensiert sind, wie z.B. Anthracen, Pyren oder deren Aza-Derivate.

**10.** Organische elektrolumineszente Vorrichtung nach einem oder mehreren der Ansprüche 1 bis 9, wobei jedes TADF-Material $E^B$

(i) **dadurch gekennzeichnet ist, dass** es einen $\Delta E_{ST}$-Wert, der der Energiedifferenz zwischen der untersten angeregten Singulett-Zustandsenergie $E(S1^E)$ und der untersten angeregten Triplett-Zustandsenergie $E(T1^E)$ entspricht, von weniger als 0,4 eV aufweist; und
(ii) eine Photolumineszenz-Quantenausbeute (PLQY) von mehr als 30 % aufweist.

**11.** Organische elektrolumineszente Vorrichtung nach einem oder mehreren der Ansprüche 1 bis 10, wobei:

$$E(T1^H) > E(T1^E) \qquad (13)$$

$$E(T1^E) > E(S1^S) \qquad (30).$$

**12.** Organische elektrolumineszente Vorrichtung nach einem oder mehreren der Ansprüche 1 bis 11, wobei die Exzitonenmanagementschicht EXL zwischen der lichtemittierenden Schicht B und der Anode der organischen elektrolumineszenten Vorrichtung angeordnet ist.

**13.** Verfahren zur Herstellung einer organischen elektrolumineszenten Vorrichtung nach einem der Ansprüche 1 bis 12, umfassend die Schritte

(i) Aufdampfen einer lichtemittierenden Schicht B durch Vakuumabscheidung, und
(ii) Aufdampfen einer Exzitonenmanagementschicht EXL durch Vakuumabscheidung,

wobei die Schritte (i) und (ii) nacheinander durchgeführt werden und die Reihenfolge der Schritte (i) und (ii) vertauscht werden kann.

**14.** Verfahren zur Erzeugung von Licht, umfassend die Schritte:

(i) Bereitstellen einer organischen elektrolumineszenten Vorrichtung nach einem der Ansprüche 1 bis 12 oder erhältlich durch ein Verfahren nach Anspruch 13; und
(ii) Anlegen eines elektrischen Stroms an die organische elektrolumineszente Vorrichtung.

**15.** Verfahren nach Anspruch 14, wobei das Verfahren für die Erzeugung von Licht mit dem Emissionsmaximum des Hauptemissionspeaks innerhalb der Wellenlänge von 510 nm bis 550 nm ist.

## Revendications

**1.** Dispositif électroluminescent organique comprenant une couche émettrice de lumière B comprenant :

(i) au moins un matériau TADF $E^B$, qui a un niveau d'énergie d'état singulet excité le plus bas $E(S1^E)$ et un niveau d'énergie d'état triplet excité le plus bas $E(T1^E)$ ;
(ii) un émetteur de faible largeur totale à mi-hauteur maximale (FWHM) $S^B$, qui a un niveau d'énergie d'état singulet excité le plus bas $E(S1^S)$ et un niveau d'énergie d'état triplet excité le plus bas $E(T1^S)$, dans lequel $S^B$ émet de la lumière avec un maximum d'émission compris entre 510 et 550 nm tel que déterminable à partir du spectre de fluorescence mesuré à environ 20 °C à partir d'un film de 1-5 % en poids du faible émetteur FWHM dans du poly(méthacrylate méthyle) (PMMA);
et
(iii) un matériau hôte $H^B$, qui a un niveau d'énergie d'état singulet excité le plus bas $E(S1^H)$ et un niveau d'énergie d'état triplet excité le plus bas $E(T1^H)$ ;

**caractérisé en ce que** le dispositif électroluminescent organique comprend une couche de gestion d'excitons EXL, adjacente à la couche émettrice de lumière B, comprenant un matériau d'annihilation triplet-triplet (TTA), et dans lequel $S^B$ émet de la lumière avec une largeur totale à mi-hauteur maximale (FWHM) inférieure ou égale à 0,25 eV déterminable à environ 20 °C mesurée à partir d'un film de 2 % en poids du faible émetteur FWHM dans du poly(méthacrylate de méthyle) (PMMA).

**2.** Dispositif électroluminescent organique selon la revendication 1, dans lequel la couche de gestion d'excitons EXL a une épaisseur qui est inférieure à 15 nm.

**3.** Dispositif électroluminescent organique selon la revendication 1 ou 2, dans lequel la couche de gestion d'excitons EXL a une épaisseur qui est inférieure à 10 nm.

**4.** Dispositif électroluminescent organique selon l'une ou plusieurs des revendications 1 à 3, dans lequel le matériau TTA comprend une structure représentée par la formule 4

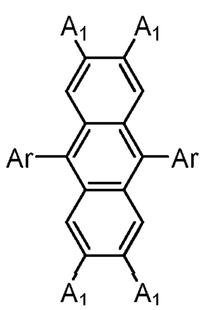

Formule 4

dans laquelle

chaque Ar est indépendamment choisi dans le groupe constitué par aryle en $C_6$-$C_{60}$, qui est éventuellement substitué par un ou plusieurs radicaux choisis dans le groupe constitué par aryle en $C_6$-$C_{60}$, hétéroaryle en $C_3$-$C_{57}$, halogène et (hétéro)alkyle en $C_1$-$C_{40}$ ; et
hétéroaryle en $C_3$-$C_{57}$, qui est éventuellement substitué par un ou plusieurs radicaux choisis dans le groupe constitué par aryle en $C_6$-$C_{60}$, hétéroaryle en $C_3$-$C_{57}$, halogène, et (hétéro)alkyle en $C_1$-$C_{40}$ ;
et
chaque $A_1$ est choisi indépendamment dans le groupe constitué par hydrogène ;
deutérium ;
aryle en $C_6$-$C_{60}$, qui est éventuellement substitué par un ou plusieurs radicaux choisis dans le groupe constitué par aryle en $C_6$-$C_{60}$, hétéroaryle en $C_3$-$C_{57}$, halogène, et (hétéro)alkyle en $C_1$-$C_{40}$ ;
hétéroaryle en $C_3$-$C_{57}$, qui est éventuellement substitué par un ou plusieurs radicaux choisis dans le groupe constitué par aryle en $C_6$-$C_{60}$, hétéroaryle en $C_3$-$C_{57}$, halogène et (hétéro)alkyle en $C_1$-$C_{40}$ ; et
(hétéro)alkyle en $C_1$-$C_{40}$, qui est éventuellement substitué par un ou plusieurs radicaux choisis dans le groupe constitué par aryle en $C_6$-$C_{60}$, hétéroaryle en $C_3$-$C_{57}$, halogène et (hétéro)alkyle en $C_1$-$C_{40}$.

**5.** Dispositif électroluminescent organique selon une ou plusieurs des revendications 1 à 4, dans lequel la couche adjacente EXL comprend au moins un émetteur supplémentaire.

**6.** Dispositif électroluminescent organique selon une ou plusieurs des revendications 1 à 5, dans lequel l'émetteur dans la couche adjacente et la couche d'émission de lumière B sont tous deux des émetteurs $S^B$ de faible largeur totale à mi-hauteur maximale (FWHM), qui émettent de la lumière avec une largeur totale à mi-hauteur maximale (FWHM) inférieure ou égale à 0,25 eV et avec un maximum d'émission compris entre 510 et 550 nm.

**7.** Dispositif électroluminescent organique selon une ou plusieurs des revendications 1 à 6, dans lequel la couche émettrice de lumière B comprend en outre :
(iv) un composant de transfert d'énergie d'excitation EET-2, qui a un niveau d'énergie d'état singulet excité le plus bas $E(S1^{EET-2})$ et un niveau d'énergie d'état triplet excité le plus bas $E(T1^{EET-2})$ ; et qui est choisi dans le groupe constitué par un matériau TADF et un matériau de phosphorescence.

**8.** Dispositif électroluminescent organique selon la revendication 7, dans lequel EET-2 est un matériau de phosphorescence.

**9.** Dispositif électroluminescent organique selon une ou plusieurs des revendications 1 à 8, dans lequel le faible émetteur FWHM $S^B$ remplit au moins l'une des conditions suivantes :

(i) il s'agit d'un émetteur contenant du bore (B), ce qui signifie qu'au moins un atome dans chaque faible émetteur FWHM $S^B$ est le bore (B) ; et/ou
(ii) il comprend une structure de noyau aromatique ou hétéroaromatique polycyclique, dans lequel au moins deux cycles aromatiques sont condensés ensemble, tels que, par exemple, anthracène, pyrène ou leurs dérivés aza.

**10.** Dispositif électroluminescent organique selon l'une ou plusieurs des revendications 1 à 9, dans lequel chaque matériau TADF $E^B$

(i) est **caractérisé en ce qu'**il présente une valeur $\Delta E_{ST}$, qui correspond à la différence d'énergie entre l'énergie d'état singulet excité le plus bas $E(S1^E)$ et l'énergie d'état triplet excité le plus bas $E(T1^E)$, de moins de 0,4 eV ; et
(ii) affiche un rendement quantique de photoluminescence (PLQY) de plus de 30 %.

**11.** Dispositif électroluminescent organique selon une ou plusieurs des revendications 1 à 10, dans lequel :

$$E(T1^H) > E(T1^E) \qquad (13)$$

$$E(T1^E) > E(S1^S) \qquad (30).$$

**12.** Dispositif électroluminescent organique selon une ou plusieurs des revendications 1 à 11, dans lequel la couche de

gestion d'excitons EXL est située entre la couche émettrice de lumière B et l'anode du dispositif électroluminescent organique.

**13.** Procédé de génération d'un dispositif électroluminescent organique selon l'une quelconque des revendications 1 à 12, comprenant les étapes (i) évaporation d'une couche émettrice de lumière B par dépôt sous vide, et (ii) évaporation d'une couche de gestion d'excitons EXL par dépôt sous vide, dans lequel les étapes (i) et (ii) sont réalisées subséquemment l'une à l'autre et l'ordre des étapes (i) et (ii) peut être interverti.

**14.** Procédé pour la génération de lumière, comprenant les étapes de :

(i) fourniture d'un dispositif électroluminescent organique selon l'une quelconque des revendications 1 à 12 ou pouvant être obtenu à partir d'un procédé selon la revendication 13 ; et
(ii) application d'un courant électrique audit dispositif électroluminescent organique.

**15.** Procédé selon la revendication 14, dans lequel le procédé est destiné à générer de la lumière, le maximum d'émission du pic d'émission principal étant compris dans la longueur d'onde de 510 nm à 550 nm.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 2020185616 A1
- US 2006006365 A1
- US 2006208221 A1
- US 2005069729 A1
- EP 1205527 A1
- US 2009302752 A1
- US 20090134784 A1
- US 2009302742 A1
- US 2010187977 A1
- US 2012068170 A1
- US 2012097899 A1
- US 2006121308 A1
- US 2009167166 A1
- US 2007176147 A1
- US 2015322091 A1
- US 2011105778 A1
- US 2011201778 A1
- US 2011121274 A1
- US 2010244009 A1
- US 2009136779 A1
- EP 2182040 A2
- US 2012202997 A1
- US 2019393424 A1
- US 2019393425 A1
- US 2020168819 A1
- US 2020079762 A1
- US 2012292576 A1
- US 2015105564 A1
- US 2015048338 A1
- US 2015141642 A1
- US 2014336379 A1
- US 2014138670 A1
- US 2012241732 A1
- EP 3315581 A1
- EP 3483156 A1
- US 2018053901 A1
- WO 2017005699 A
- US 2020274081 A1
- US 20010019782 A1
- US 20020034656 A1
- US 20030138657 A1
- US 2005123791 A1
- US 20060065890 A1
- US 20060134462 A1
- US 20070034863 A1
- US 20070111026 A1
- US 2007034863 A1
- US 2007138437 A1
- US 20080020237 A1
- US 20080297033 A1
- US 2008210930 A1
- US 20090115322 A1
- US 2009104472 A1
- US 20100244004 A1
- US 2010105902 A1
- US 20110057559 A1
- US 2011215710 A1
- US 2012292601 A1
- US 2013165653 A1
- US 20140246656 A1
- US 20030068526 A1
- US 20050123788 A1
- US 2005260449 A1
- US 20060127696 A1
- US 20060202194 A1
- US 20070087321 A1
- US 20070190359 A1
- US 2007104979 A1
- US 2007224450 A1
- US 20080233410 A1
- US 200805851 A1
- US 20090039776 A1
- US 20090179555 A1
- US 20100090591 A1
- US 20100295032 A1
- US 20030072964 A1
- US 20050244673 A1
- US 20060008670 A1
- US 20060134459 A1
- US 20060251923 A1
- US 20070103060 A1
- US 20070231600 A1
- US 2007104980 A1
- US 2007278936 A1
- US 20080261076 A1
- US 2008161567 A1
- US 20090108737 A1
- US 2009085476 A1
- US 20100148663 A1
- US 2010102716 A1
- US 2010270916 A1
- US 20110204333 A1
- US 2011285275 A1
- US 2013033172 A1
- US 2013334521 A1
- US 2014103305 A1
- US 2003068536 A1
- US 2003085646 A1

- US 2006228581 A1
- US 2006197077 A1
- US 2011114922 A1
- US 2003054198 A1
- EP 2730583 A1
- US 2003017361 A1
- US 2004262576 A1
- WO 2010027583 A1
- US 2019245153 A1
- US 2013119354 A1
- US 2019233451 A1
- EP 3109253 A1
- US 2014058099 A1
- US 2009295275 A1
- US 2012319052 A1
- US 2018069182 A1
- US 2019393419 A1
- US 2020006671 A1
- US 2020098991 A1
- US 2020176684 A1
- US 2020161552 A1
- US 2020227639 A1
- US 2020185635 A1
- EP 3686206 A1
- WO 2020217229 A1
- WO 2020208051 A1
- US 2020328351 A1
- WO 2020135953 A1
- US 2018047912 A1
- US 2017077418 A1
- EP 2690681 A1

**Non-patent literature cited in the description**


- **Y. TAO** ; **C. YANG** ; **J. QUIN**. *Chemical Society Reviews*, 2011, vol. 40, 2943
- **K.S. YOOK** ; **J.Y. LEE**. *The Chemical Record*, 2015, vol. 16 (1), 159
- **T. CHATTERJEE** ; **K.-T. WONG**. *Advanced Optical Materials*, 2018, vol. 7 (1), 1800565
- **Q. WANG** ; **Q.-S. TIAN** ; **Y.-L. ZHANG** ; **X. TANG** ; **L.-S. LIAO**. *Journal of Materials Chemistry C*, 2019, vol. 7, 11329
- **H. TANAKA** ; **K. SHIZU** ; **H. NAKANOTANI** ; **C. ADACHI**. *Chemistry of Materials*, 2013, vol. 25 (18), 3766
- **J. LI** ; **T. NAKAGAWA** ; **J. MACDONALD** ; **Q. ZHANG** ; **H. NOMURA** ; **H. MIYAZAKI** ; **C. ADACHI**. *Advanced Materials*, 2013, vol. 25 (24), 3319
- **K. NASU** ; **T. NAKAGAWA** ; **H. NOMURA** ; **C.-J. LIN** ; **C.-H. CHENG** ; **M.-R. TSENG** ; **T. YASUDAAD** ; **C. ADACHI**. *Chemical Communications*, 2013, vol. 49 (88), 10385
- **Q. ZHANG** ; **B. LI1** ; **S. HUANG** ; **H. NOMURA** ; **H. TANAKA** ; **C. ADACHI**. *Nature Photonics*, 2014, vol. 8 (4), 326
- **B. WEX** ; **B.R. KAAFARANI**. *Journal of Materials Chemistry C*, 2017, vol. 5, 8622
- **Y. IM** ; **M. KIM** ; **Y.J. CHO** ; **J.-A. SEO** ; **K.S. YOOK** ; **J.Y. LEE**. *Chemistry of Materials*, 2017, vol. 29 (5), 1946
- **T.-T. BUI** ; **F. GOUBARD** ; **M. IBRAHIM-OUALI** ; **D. GIGMES** ; **F. DUMUR**. *Beilstein Journal of Organic Chemistry*, 2018, vol. 14, 282
- **X. LIANG** ; **Z.-L. TU** ; **Y.-X. ZHENG**. *Chemistry - A European Journal*, 2019, vol. 25 (22), 5623
- *CHEMICAL ABSTRACTS*, 73183-34-3
- **C.-L. HO** ; **H. LI** ; **W.-Y. WONG**. *Journal of Organometallic Chemistry*, 2014, vol. 751, 261
- **T. FLEETHAM** ; **G. LI** ; **J. LI**. *Advanced Science News*, 2017, vol. 29, 1601861
- **A.R.B.M. YUSOFF** ; **A.J. HUCKABA** ; **M.K. NAZEERUDDIN**. *Topics in Current Chemistry (Z)*, 2017, vol. 375 (39), 1
- **T.-Y. LI** ; **J. WUC** ; **Z.-G. WUA** ; **Y.-X. ZHENG** ; **J.-L. ZUO** ; **Y. PAN**. *Coordination Chemistry Reviews*, 2018, vol. 374, 55
- **T. HATAKEYAMA** ; **K. SHIREN** ; **K. NAKAJIMA** ; **S. NOMURA** ; **S. NAKATSUKA** ; **K. KINOSHITA** ; **J. NI** ; **Y. ONO** ; **T. IKUTA**. *Advanced Materials*, 2016, vol. 28 (14), 2777
- **M. ZHU.** ; **C. YANG**. *Chemical Society Reviews*, 2013, vol. 42, 4963
- **S. KIMA** ; **B. KIMB** ; **J. LEEA** ; **H. SHINA** ; **Y.-Il PARKB** ; **J. PARK**. *Materials Science and Engineering R: Reports*, 2016, vol. 99, 1
- **K.R.J. THOMAS** ; **N. KAPOOR** ; **M.N.K.P. BOLISETTY** ; **J.-H. JOU** ; **Y.-L. CHEN** ; **Y.-C. JOU**. *The Journal of Organic Chemistry*, 2012, vol. 77 (8), 3921
- **M. VANGA** ; **R.A. LALANCETTE** ; **F. JÄKLE**. *Chemistry - A European Journal*, 2019, vol. 25 (43), 10133
- **B. LEE** ; **F.M. RICHARDS**. *Journal of Molecular Biology*, 1971, vol. 55 (3), 379
- **S. MITTERNACHT**. Free SASA: An open source C library for solvent accessible surface area calculations. *F1000Res.*, 18 February 2016, vol. 5, 189
- **M. MANTINA** ; **A.C. CHAMBERLIN** ; **R. VALERO** ; **C.J. CRAMER** ; **D.G. TRUHLAR**. *The Journal of Physical Chemistry A*, 2009, vol. 113 (19), 5806